(19) Europäisches Patentamt
European Patent Office
Office européen des brevets

(11) EP 3 967 699 A1

(12) EUROPEAN PATENT APPLICATION

(43) Date of publication:
**16.03.2022 Bulletin 2022/11**

(21) Application number: **21195091.0**

(22) Date of filing: **06.09.2021**

(51) International Patent Classification (IPC):
***C07F 5/02*** *(2006.01)* ***C09K 11/06*** *(2006.01)*
***H01L 51/00*** *(2006.01)*

(52) Cooperative Patent Classification (CPC):
**C07F 5/027; C09K 11/06; H01L 51/0059; H01L 51/008**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.09.2020 KR 20200118377**

(71) Applicants:
- **Samsung Electronics Co., Ltd.**
  **Suwon-si, Gyeonggi-do 16677 (KR)**
- **Kwangwoon University Industry-Academic Collaboration Foundation**
  **Seoul 01897 (KR)**

(72) Inventors:
- **KIM, Sangmo**
  **16678 Gyeonggi-do (KR)**
- **LEE, Yunmi**
  **16678 Gyeonggi-do (KR)**
- **KIM, Juhyun**
  **16678 Gyeonggi-do (KR)**
- **KIM, Jiwhan**
  **16678 Gyeonggi-do (KR)**
- **MARUYAMA, Yusuke**
  **16678 Gyeonggi-do (KR)**
- **ANDROSOV, Dmitry**
  **16678 Gyeonggi-do (KR)**
- **JEON, Soonok**
  **16678 Gyeonggi-do (KR)**
- **CHOI, Hyeonho**
  **16678 Gyeonggi-do (KR)**
- **LEE, Sangback**
  **16678 Gyeonggi-do (KR)**
- **LEE, Hanseul**
  **16678 Gyeonggi-do (KR)**

(74) Representative: **Elkington and Fife LLP**
**Prospect House**
**8 Pembroke Road**
**Sevenoaks, Kent TN13 1XR (GB)**

# (54) POLYCYCLIC COMPOUND AND ORGANIC LIGHT-EMITTING DEVICE INCLUDING THE SAME

(57) A polycyclic compound represented by Formula 1:

Formula 1

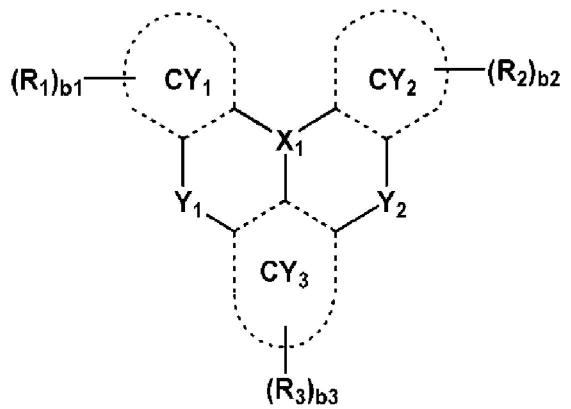

wherein, in Formulae 1, 1-1, and 1-2, ring $CY_1$, ring $CY_2$, and ring $CY_3$ are each independently a $C_5$-$C_{30}$ carbocyclic group or a $C_1$-$C_{30}$ heterocyclic group; $X_1$ is B, N, P, P(=O), P(=S), Al, Ga, As, C($R_4$), Si($R_4$), or Ge($R_4$); $Y_1$ and $Y_2$ are each independently O, S, Se, B($R_5$), N($R_5$), C($R_5$)($R_6$), Si($R_5$)($R_6$), Ge($R_5$)($R_6$), Ga($R_5$), As($R_5$) P(Rs), P(=O)($R_5$), P(=S)($R_5$), or Al($R_5$); and $R_1$, $R_2$, $R_3$, b1, b2, and b3 are as provided herein.

FIG. 1

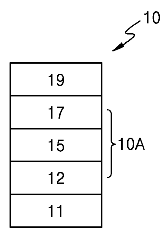


EP 3 967 699 A1

## Description

FIELD OF THE INVENTION

One or more embodiments relate to a polycyclic compound and an organic light-emitting device including the same.

BACKGROUND OF THE INVENTION

Organic light-emitting devices (OLEDs) are self-emission devices that produce full-color images, and also have wide viewing angles, high contrast ratios, short response times, and excellent characteristics in terms of brightness, driving voltage, and response speed, compared to devices in the art.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons then recombine in the emission layer to produce excitons in an excited state. The excitons transition from the excited state to a ground state to thereby generate light.

SUMMARY OF THE INVENTION

One or more embodiments include an organic light-emitting device (OLED) having high efficiency and high color purity.

Additional aspects will be set forth in part in the description which follows and, in part, will be apparent from the description, or may be learned by practice of the presented exemplary embodiments of the disclosure.

An aspect of the present disclosure provides a polycyclic compound represented by Formula 1.

Formula 1

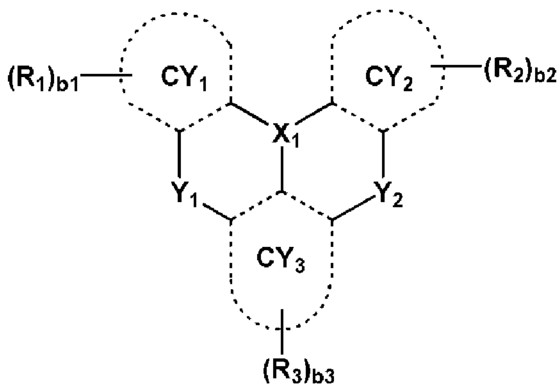

$$*-(L_{11})_{a11}-(A_{11})_{m11}$$ Formula 1-1

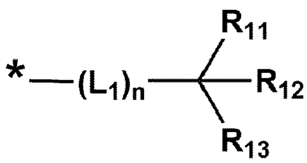

Formula 1-2

In Formulae 1, 1-1, and 1-2,

ring $CY_1$, ring $CY_2$, and ring $CY_3$ are each independently a $C_5$-$C_{30}$ carbocyclic group or a $C_1$-$C_{30}$ heterocyclic group,
$X_1$ is B, N, P, P(O), P(S), Al, Ga, As, $C(R_4)$, $Si(R_4)$, or $Ge(R_4)$,

$Y_1$ and $Y_2$ are each independently O, S, Se, B($R_5$), N($R_5$), C($R_5$)($R_6$), Si($R_5$)($R_6$), Ge($R_5$)($R_6$), Ga($R_5$), As($R_5$) P($R_5$), P(O)($R_5$), P(S)($R_5$), or Al($R_5$),

$R_1$, $R_2$, $R_3$, $R_4$, $R_5$, and $R_6$ are each independently a group represented by Formula 1-1, hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group,-N($Q_1$)($Q_2$), -Si($Q_3$)($Q_4$)($Q_5$), -B($Q_6$)($Q_7$), or -P(=O)($Q_8$)($Q_9$),

at least one of $R_1$ to $R_6$ is a group represented by Formula 1-1,

two adjacent groups of $R_1$ to $R_6$ are optionally bonded to each other to form a substituted or unsubstituted $C_5$-$C_{30}$ carbocyclic group or a substituted or unsubstituted C1-C30 heterocyclic group,

b1 to b3 re each independently an integer of 0 to 10,

when b1 is 2 or more, two or more of $R_1$(s) are identical to or different from each other, when b2 is 2 or more, two or more of $R_2$(s) are identical to or different from each other, when b3 is 2 or more, two or more of $R_3$(s) are identical to or different from each other,

$L_{11}$ is a single bond, a substituted or unsubstituted $C_5$-$C_{30}$ carbocyclic group, or a substituted or unsubstituted $C_1$-$C_{30}$ heterocyclic group,

a11 is an integer from 1 to 3,

$A_{11}$ is a group represented by Formula 1-2,

m11 is an integer from 1 to 5,

$L_1$ is a substituted or unsubstituted $C_1$-$C_{20}$ alkylene group, a substituted or unsubstituted $C_2$-$C_{20}$ alkenylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

n is an integer from 0 to 3, wherein, when n is 0, $L_1$ is not present, and when n is 2 or more, two or more of $L_1$ (s) are identical to or different from each other,

$R_{11}$, $R_{12}$, and $R_{13}$ are each independently hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), or -P(=O)($Q_8$)($Q_9$),

at least one of $R_{11}$, $R_{12}$, and $R_{13}$ is a substituted or unsubstituted $C_6$-$C_{60}$ aryl group,

* and *' each indicates a binding site to a neighboring group, and

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_7$-$C_{60}$ aryl alkyl group, the substituted $C_1$-$C_{60}$ heteroaryl group, the substituted

$C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, the substituted monovalent non-aromatic condensed heteropolycyclic group, the substituted $C_1$-$C_{20}$ alkylene group, the substituted $C_2$-$C_{20}$ alkenylene group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, and the substituted divalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group,

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_6$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-Si(Q_{11})(Q_{12})(Q_{13})$, $-N(Q_{14})(Q_{15})$, $-B(Q_{16})(Q_{17})$, or $-P(=O)(Q_{18})(Q_{19})$,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group, each substituted with at least one of deuterium, -F, -Cl, -Br, -I, $-CD_3$, $-CD_2H$, $-CDH_2$, $- CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-Si(Q_{21})(Q_{22})(Q_{23})$, $-N(Q_{24})(Q_{25})$ $-B(Q_{26})(Q_{27})$, or $-P(=O)(Q_{28})(Q_{29})$, or $-Si(Q_{31})(Q_{32})(Q_{33})$, $-N(Q_{34})(Q_{35})$, $-B(Q_{36})(Q_{37})$, or $-P(=O)(Q_{38})(Q_{39})$,

wherein $Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, or a substituted or unsubstituted monovalent non-aromatic condensed heteropolycyclic group.

Another aspect provides an organic light-emitting device including a first electrode, a second electrode, and an organic layer located between the first electrode and the second electrode and including an emission layer, wherein

the organic layer includes at least one type of the polycyclic compounds.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 shows a schematic cross-sectional view of an organic light-emitting device according to one or more embodiments;
FIG. 2 is a graph of intensity (arbitrary units, a.u.) versus wavelength (nanometers, nm) and shows a light emission curve of light emitted when excited singlet energy and excited triplet energy of the organic light-emitting device manufactured according to Example 1 is converted to a ground state;
FIG. 3 is a graph of intensity (a.u.) versus wavelength (nm) and shows a light emission curve of light emitted when excited singlet energy and excited triplet energy of the organic light-emitting device manufactured according to Comparative Example 1 is converted to a ground state; and
FIG. 4 is a graph of intensity (a.u.) versus wavelength (nm) and shows a light emission curve of light emitted when excited singlet energy and excited triplet energy of the organic light-emitting device manufactured according to Comparative Example 2 is converted to a ground state.

DETAILED DESCRIPTION OF THE EMBODIMENTS

Reference will now be made in detail to exemplary embodiments, examples of which are illustrated in the accompanying drawings, wherein like reference numerals refer to like elements throughout. In this regard, the present embodiments may have different forms and should not be construed as being limited to the descriptions set forth herein. Accordingly, the exemplary embodiments are described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.
The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.
It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.
Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.
It will be understood that when an element is referred to as being "on" another element, it can be directly in contact with the other element or intervening elements may be present therebetween. In contrast, when an element is referred to as being "directly on" another element, there are no intervening elements present.
Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.
"About" or "approximately" as used herein is inclusive of the stated value and means within an acceptable

range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An aspect of the present disclosure provides a polycyclic compound represented by Formula 1:

Formula 1

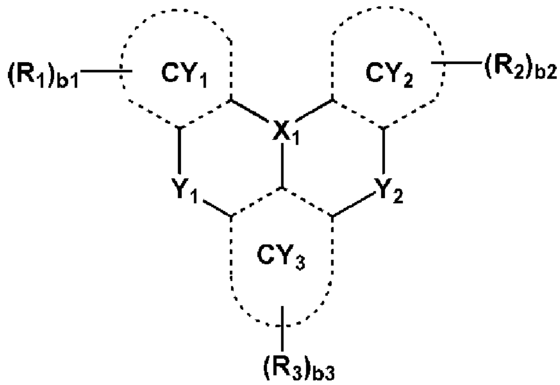

Formula 1-1

$$*-(L_{11})_{a11}-(A_{11})_{m11}$$

Formula 1-2

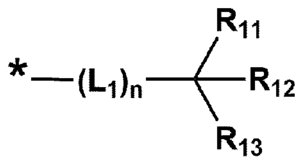

wherein ring $CY_1$, ring $CY_2$, and ring $CY_3$ in Formula 1 are each independently a $C_5$-$C_{30}$ carbocyclic group or a $C_1$-$C_{30}$ heterocyclic group.

In one or more embodiments, ring $CY_1$, ring $CY_2$, and ring $CY_3$ may each independently be:

group A,
group B,
a condensed ring in which two or more of group A are condensed with each other,
a condensed ring in which two or more of group B are condensed with each other, or
a condensed ring in which at least one of group A is condensed with at least one of group B, but embodiments of the present disclosure are not limited thereto:

wherein group A may be a cyclic diene group (for example, cyclopenta-1,3-diene group), an indene group, an azulene group, a benzene group, a naphthalene group, an anthracene group, a phenanthrene group, a tetracene group, a tetraphene group, a pyrene group, a chrysene group, a triphenylene group, or a fluorene group, and wherein group B may be a furan group, a thiophene group, a pyrrole group, borole group, a silole group, a pyrrolidine group, an imidazole group, a triazole group, an oxazole group, an isoxazole group, a thiazole group, an isothiazole group, a pyridine group, a pyrimidine group, a pyridazine group, a triazine group, an indole group, an isoindole group, an indolizine group, a quinoline group, an isoquinoline group, a quinoxaline group, an isoquinoxaline group, a carbazole group, a dibenzofuran group, a dibenzothiophene group, a dibenzosilole group, or a dibenzoborole group.

For example, ring $CY_1$, ring $CY_2$, and ring $CY_3$ may each independently be a benzene group, a naphthalene group, an anthracene group, or a fluorene group.

For example, ring $CY_1$, ring $CY_2$, and ring $CY_3$ may be the same. For example, ring $CY_1$, ring $CY_2$, and ring $CY_3$ may each be a benzene group.

$X_1$ in Formula 1 is B, N, P, P(=O), P(=S), Al, Ga, As, $C(R_4)$, $Si(R_4)$, or $Ge(R_4)$.

In one or more embodiments, $X_1$ may be B, N, P, P(=O), P(=S), or Al, but embodiments of the present disclosure are not limited thereto. For example, $X_1$ may be B.

$Y_1$ and $Y_2$ in Formula 1 are each independently O, S, Se, $B(R_5)$, $N(R_5)$, $C(R_5)(R_6)$, $Si(R_5)(R_6)$, $Ge(R_5)(R_6)$, $Ga(R_5)$, $As(R_5)$ $P(R_5)$, $P(O)(R_5)$, $P(S)(R_5)$, or $Al(R_5)$.

In one or more embodiments, $Y_1$ and $Y_2$ may each independently be O, S, Se, $B(R_5)$, $N(R_5)$, $C(R_5)(R_6)$, or $Si(R_5)(R_6)$. For example, $Y_1$ and $Y_2$ may be identical to each other. For example, $Y_1$ and $Y_2$ may each be $N(R_5)$.

In one or more embodiments, $X_1$ may be:

B, N, P, P(O), P(S), or Al, and
$Y_1$ and $Y_2$ may each independently be O, S, Se, $B(R_5)$, $N(R_5)$, $C(R_5)(R_6)$, or $Si(R_5)(R_6)$.
$L_{11}$ in Formula 1-1 is a single bond, a substituted or unsubstituted $C_5$-$C_{30}$ carbocyclic group, or a substituted or unsubstituted $C_1$-$C_{30}$ heterocyclic group.

In one or more embodiments, $L_{11}$ may be:

a single bond;
a benzene group, an indene group, a naphthalene group, an azulene group, a heptalene group, acenaphthylene group, a fluorene group, a phenalene group, a phenanthrene group, an anthracene group, a fluoranthene group, a triphenylene group, a pyrene group, a chrysene group, a pyridine group, a pyrimidine group, a pyrazine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, a carbazole group, an azacarbazole group, a dibenzofuran group, a dibenzothiophene group, or a dibenzosilole group; or
a benzene group, an indene group, a naphthalene group, an azulene group, a heptalene group, acenaphthylene group, a fluorene group, a phenalene group, a phenanthrene group, an anthracene group, a fluoranthene group, a triphenylene group, a pyrene group, a chrysene group, a pyridine group, a pyrimidine group, a pyrazine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, a carbazole group, an azacarbazole group, a dibenzofuran group, a dibenzothiophene group, or dibenzosilole group, each substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group, but embodiments of the present disclosure are not limited thereto.

For example, $L_{11}$ may be a single bond or a group represented by one of Formulae 3-1 to 3-46:

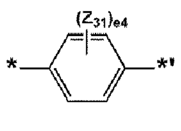
3-1

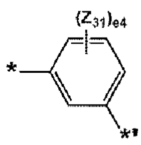
3-2

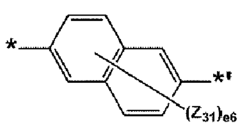
3-3

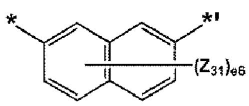
3-4

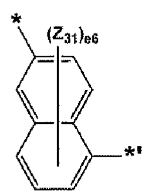
3-5

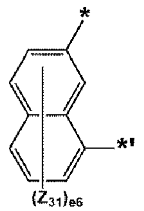 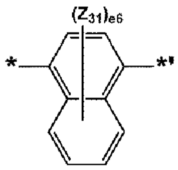 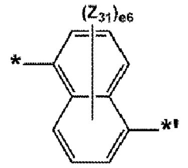 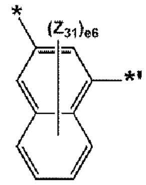 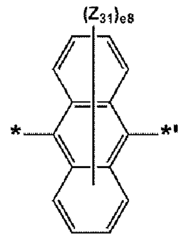

3-6 3-7 3-8 3-9 3-10

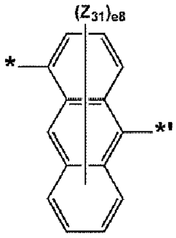 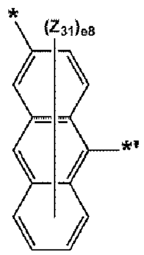 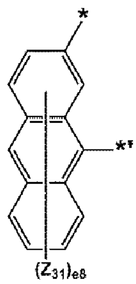 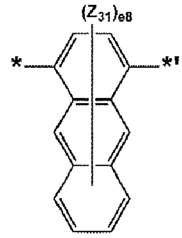 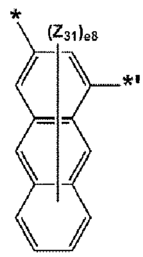

3-11 3-12 3-13 3-14 3-15

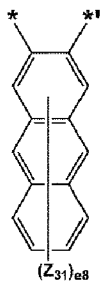 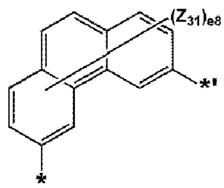 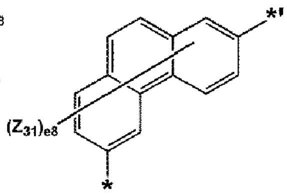 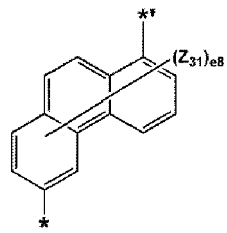 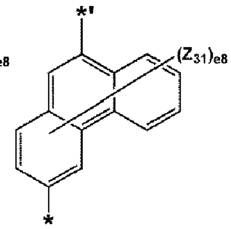

3-16 3-17 3-18 3-19 3-20

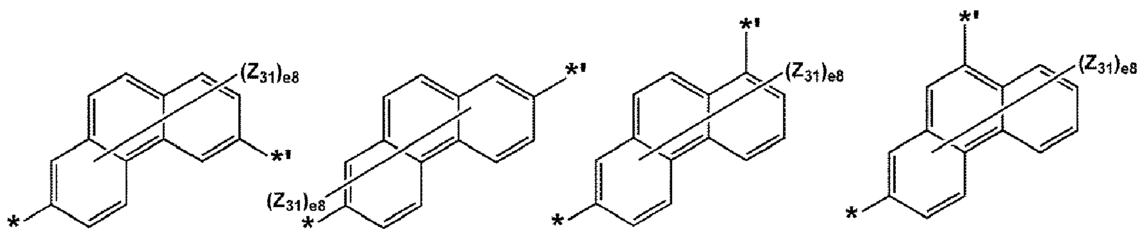

3-21 3-22 3-23 3-24

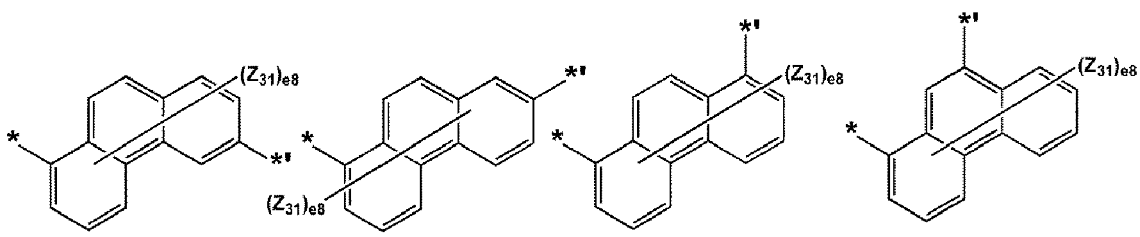

3-25 3-26 3-27 3-28

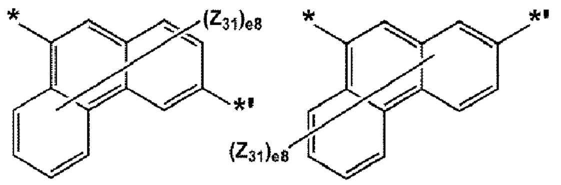 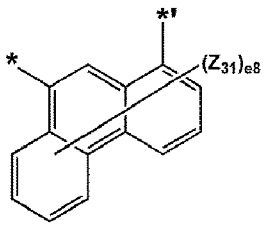 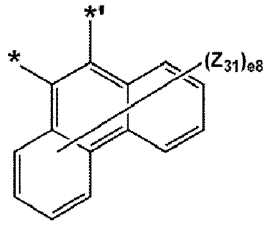

3-29 3-30 3-31 3-32

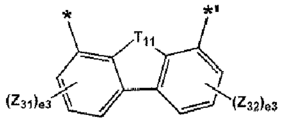 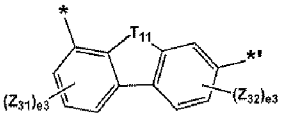 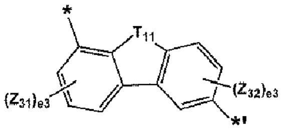 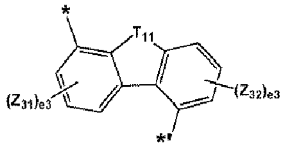

3-33 3-34 3-35 3-36

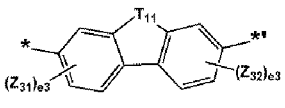 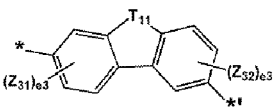 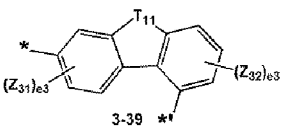 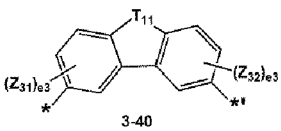

3-37 3-38 3-39 3-40

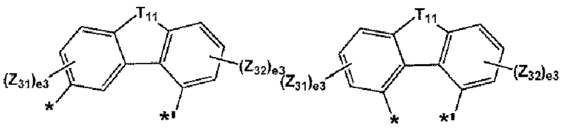 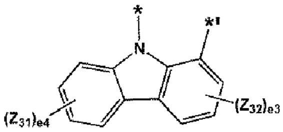 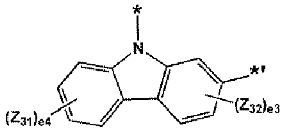

3-41 3-42 3-43 3-44

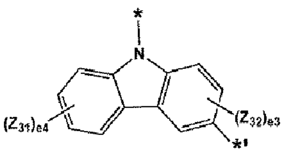 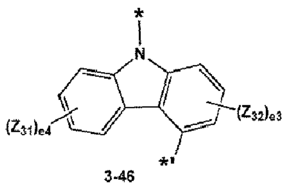

3-45 3-46

wherein, in Formulae 3-1 to 3-46,

$T_{11}$ may be O, S, $Si(Z_{33})(Z_{34})$, $C(Z_{33})(Z_{34})$, or Se,

$Z_{31}$ to $Z_{34}$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, or a $C_1$-$C_{60}$ heteroaryl group,

e3 may be an integer from 1 to 3,

e4 may be an integer from 1 to 4,

e6 may be an integer from 1 to 6,

e8 may be an integer from 1 to 8, and

* and *' each indicate a binding site to a neighboring atom.

a11 in Formula 1-1 indicates the number of $L_{11}$ groups, and is an integer from 1 to 3. For example, when a11 is the integer of 2 or more, two or more of $L_{11}$ groups may be identical to or different from each other.

$A_{11}$ in Formula 1-1 is a group represented by Formula 1-2, and m11 is an integer from 1 to 5. For example, m11 may be 1 or 2.

In one or more embodiments, m11 may be the number of $A_{11}$ groups or the number of groups represented by Formula 1-2 bonding to Formula 1 (in the case where $L_{11}$ is a single bond),and may be 1, 2, 3, or 4. For example, when m11 is 2 or more, two or more of groups represented by Formula 1-2 may be identical to or different from each other.

In one or more embodiments, m11 is 2, and two groups represented by Formula 1-2 may be identical to each other.

$L_1$ in Formula 1-2 is a substituted or unsubstituted $C_1$-$C_{20}$ alkylene group, a substituted or unsubstituted $C_2$-$C_{20}$ alkenylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group.

In one or more embodiments, $L_1$ may be a single bond or group represented by one of Formulae 3-1 to 3-46.

n in Formula 1-2 indicates the number of $L_1$ (s), and is an integer from 0 to 3, wherein, when n is 0, $L_1$ is not present, and when n is 2 or more, two or more of $L_1$ (s) may be identical to or different from each other.

In one or more embodiments, $L_{11}$ and $L_1$ may be identical to or different from each other. For example, one of $L_{11}$ and $L_1$ may be a single bond. For example, $L_{11}$ and $L_1$ may each be a single bond.

$R_1$, $R_2$, $R_3$, $R_4$, $R_5$, and $R_6$ in Formula 1 may each independently be a group represented by Formula 1-1, hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, - $N(Q_1)(Q_2)$, -$Si(Q_3)(Q_4)(Q_5)$, -$B(Q_6)(Q_7)$, or -$P(=O)(Q_8)(Q_9)$.

In one or more embodiments, $R_1$, $R_2$, $R_3$, $R_4$, $R_5$, and $R_6$ may each independently be:

a group represented by Formula 1-1;
hydrogen, deuterium, -F, -Cl, -Br, -I, a hydroxyl group, a cyano group (CN), a nitro group, an amino group, a $C_1$-$C_{60}$ alkyl group, or a $C_1$-$C_{60}$ alkoxy group;
a $C_1$-$C_{60}$ alkyl group or a $C_1$-$C_{60}$ alkoxy group, each substituted with at least one of deuterium, -F, -Cl, -Br, -I, a hydroxyl group, a cyano group (CN), a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group;
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group; or
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group

group, a dibenzofuranyl group, a dibenzothiophenyl group, or a carbazolyl group, each substituted with at least one of deuterium, -F, -Cl, -Br, -I, a hydroxyl group, a cyano group, a nitro group, an amino group, a $C_1$-$C_{60}$ alkyl group, a $C_7$-$C_{60}$ aryl alkyl group, a $C_1$-$C_{60}$ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, but embodiments of the present disclosure are not limited thereto.

For example, $R_1$, $R_2$, $R_3$, $R_4$, $R_5$, and $R_6$ may each independently be:

a group represented by Formula 1-1;

hydrogen, deuterium, -F, -Cl, -Br, -I, a hydroxyl group, a cyano group, a nitro group, an amino group, a methyl group, an ethyl group, a propyl group, an isopropyl group, a butyl group, a sec-butyl group, an isobutyl group, a tert-butyl group, a methoxy group, an ethoxy group, a propoxy group, an isopropoxy group, a butoxy group, a sec-butoxy group, a tert-butoxy group, or an isobutoxy group;

a methyl group, an ethyl group, a propyl group, an isopropyl group, a butyl group, a sec-butyl group, an isobutyl group, a tert-butyl group, a methoxy group, an ethoxy group, a propoxy group, an isopropoxy group, a butoxy group, a sec-butoxy group, a tert-butoxy group, or an isobutoxy group, each substituted with at least one of deuterium, -F, -Cl, -Br, -I, a hydroxyl group, a cyano group (CN), a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group;

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group; or

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, each substituted with at least one of deuterium, -F, -Cl, -Br, -I, a hydroxyl group, a cyano group, a nitro group, an amino group, a methyl group, an ethyl group, a propyl group, an isopropyl group, a butyl group, a sec-butyl group, an isobutyl group, a tert-butyl group, a methoxy group, an ethoxy group, a propoxy group, an isopropoxy group, a butoxy group, a sec-butoxy group, a tert-butoxy group, isobutoxy group, a $C_7$-$C_{60}$ aryl alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl

group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, but embodiments of the present disclosure are not limited thereto.

at least one of $R_1$ to $R_6$ in Formula 1 is a group represented by Formula 1-1.

In one or more embodiments, two or more of $R_1$ to $R_6$ may be a group represented by Formula 1-1. In one or more embodiments, three or more of $R_1$ to $R_6$ may be a group represented by Formula 1-1. In one or more embodiments, four or more of $R_1$ to $R_6$ may be a group represented by Formula 1-1. In one or more embodiments, five or more of $R_1$ to $R_6$ may be a group represented by Formula 1-1. In one or more embodiments, six or more of $R_1$ to $R_6$ may be a group represented by Formula 1-1.

Two neighboring groups of $R_1$ to $R_6$ in Formula 1 may optionally be bonded to each other to form a substituted or unsubstituted $C_5$-$C_{30}$ carbocyclic group or a substituted or unsubstituted $C_1$-$C_{30}$ heterocyclic group.

For example, $R_1$ and $R_2$ in Formula 1 may be bonded to each other to form a $C_5$-$C_{30}$ carbocyclic group or a $C_1$-$C_{30}$ heterocyclic group, each unsubstituted or substituted with at least one $R_{10a}$, in which an atom $X_1$, an atom constituting ring $CY_1$ and an atom constituting ring $CY_2$ are included therein.

$R_{10}$ may be the same as described in connection with $R_1$.

b1 to b3 in Formula 1 are each independently an integer from 0 to 10, wherein, when b1 is 2 or more, two or more of $R_1$(s) are identical to or different from each other, when b2 is 2 or more, two or more of $R_2$(s) are identical to or different from each other, and when b3 is 2 or more, two or more of $R_3$(s) are identical to or different from each other.

$R_{11}$, $R_{12}$, and $R_{13}$ in Formula 1-2 may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, or$-P(=O)(Q_8)(Q_9)$, and at least one of $R_{11}$, $R_{12}$, and $R_{13}$ is a substituted or unsubstituted $C_6$-$C_{60}$ aryl group.

In one or more embodiments, $R_{11}$ to $R_{13}$ may each independently be:

hydrogen, deuterium, -F, -Cl, -Br, -I, a hydroxyl group, a cyano group (CN), a nitro group, an amino group, a $C_1$-$C_{60}$ alkyl group, or a $C_1$-$C_{60}$ alkoxy group;

a $C_1$-$C_{60}$ alkyl group or a $C_1$-$C_{60}$ alkoxy group, each substituted with at least one of deuterium, -F, -Cl, -Br, -I, a hydroxyl group, a cyano group, a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group;

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group; or

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl

group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, each substituted with at least one of deuterium, -F, -Cl, -Br, -I, a hydroxyl group, a cyano group, a nitro group, an amino group, a $C_1$-$C_{60}$ alkyl group, a $C_1$-$C_{60}$ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group.

In one or more embodiments, m11 may be 1 or 2. For example, m11 may be 1.

In one or more embodiments, Formula 1-2 may be represented by one of Formulae 1-2a to 1-2c:

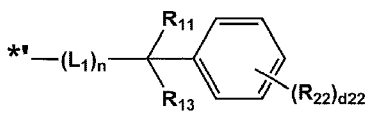

1-2a

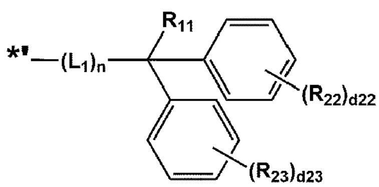

1-2b

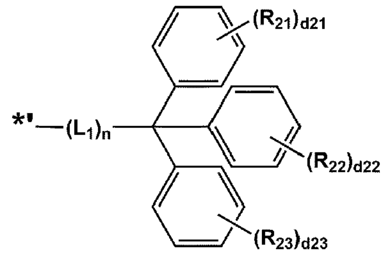

1-2c

wherein, in Formulae 1-2a to 1-2c,

$R_{11}$, $R_{13}$, $L_1$, and n are each the same as described above,
$R_{21}$ to $R_{23}$ may each independently be:

hydrogen, deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-Si(Q_{21})(Q_{22})(Q_{23})$,$-N(Q_{24})(Q_{25})$ $-B(Q_{26})(Q_{27})$, or $-P(=O)(Q_{28})(Q_{29})$, and
d21 to d23 may each independently be an integer from 1 to 5, wherein when d21 is the integer of 2 or more, two or more of $R_{21}$(S) may be identical to or different from each other, when d22 is the integer of 2 or more, two or more of $R_{22}$(s) may be identical to or different from each other, and when d23 is the integer of 2 or more, two or more of $R_{23}$(s) may be identical to or different from each other.

For example, $R_{11}$ and $R_{13}$ in Formulae 1-2a and 1-2b may each independently be:

deuterium, -F, -Cl, -Br, -I, a hydroxyl group, a cyano group, a nitro group, an amino group, a $C_1$-$C_{60}$ alkyl group, or a $C_1$-$C_{60}$ alkoxy group; or
a $C_1$-$C_{60}$ alkyl group or a $C_1$-$C_{60}$ alkoxy group, each substituted with at least one of deuterium, -F, -Cl, -Br, -I, a hydroxyl group, a cyano group (CN), a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group, but embodiments of the present disclosure are not limited thereto.

In one or more embodiments, n in Formulae 1-2a and 1-2b may be 0.

In one or more embodiments, Formula 1 may be represented by Formula 2 below:

Formula 2

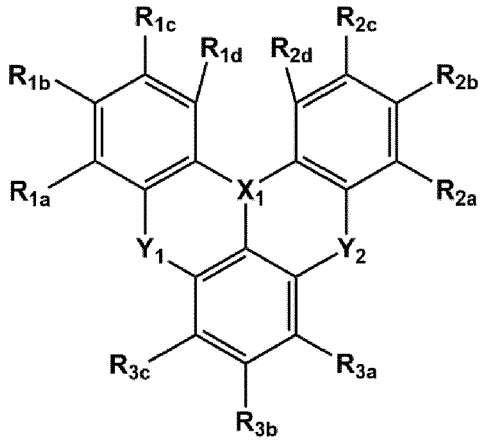

wherein, in Formula 2,

$X_1$, $Y_1$, and $Y_2$ are the same as described above,
$R_{1a}$ to $R_{1d}$ are each the same as described in connection with $R_1$, and $R_{2a}$ to $R_{2d}$ are each the same as described in connection with $R_2$, and $R_{3a}$ to $R_{3c}$ are each the same as described in connection with $R_3$,

(i) one of $R_{1a}$ to $R_{1d}$ may be a group represented by Formula 1-1; one of $R_{2a}$ to $R_{2d}$ may be a group represented by Formula 1-1; one of $R_{3a}$ to $R_{3c}$ may be a group represented by Formula 1-1;
(ii) two of $R_{1a}$ to $R_{1d}$ may each be a group represented by Formula 1-1; two of $R_{2a}$ to $R_{2d}$ may each be a group represented by Formula 1-1; two of $R_{3a}$ to $R_{3c}$ may each be a group represented by Formula 1-1;
(i) three of $R_{1a}$ to $R_{1d}$ may each be a group represented by Formula 1-1; three of $R_{2a}$ to $R_{2d}$ may each be a group represented by Formula 1-1; each of $R_{3a}$ to $R_{3c}$ may be a group represented by Formula 1-1;
(iv) each of $R_{1a}$ to $R_{1d}$ is a group represented by Formula 1-1; or each of $R_{2a}$ to $R_{2d}$ is a group represented by Formula 1-1;
(v) one of $R_{1a}$ to $R_{1d}$ is a group represented by Formula 1-1 and one of $R_{2a}$ to $R_{2d}$ is a group represented by Formula 1-1; one of $R_{1a}$ to $R_{1d}$ is a group represented by Formula 1-1 and one of $R_{3a}$ to $R_{3c}$ is a group represented by Formula 1-1; one of $R_{2a}$ to $R_{2d}$ is a group represented by Formula 1-1 and one of $R_{3a}$ to $R_{3c}$ is a group represented by Formula 1-1;
(vi) two of $R_{1a}$ to $R_{1d}$ may each be a group represented by Formula 1-1 and one of $R_{2a}$ to $R_{2d}$ may each be a group represented by Formula 1-1; two of $R_{1a}$ to $R_{1d}$ may each be a group represented by Formula 1-1 and one of $R_{3a}$ to $R_{3c}$ may be a group represented by Formula 1-1; two of $R_{2a}$ to $R_{2d}$ may each be a group represented by Formula 1-1 and one of $R_{1a}$ to $R_{1d}$ may be a group represented by Formula 1-1; two of $R_{2a}$ to $R_{2d}$ may each be a group represented by Formula 1-1 and one of $R_{3a}$ to $R_{3c}$ may be a group represented by Formula 1-1; two of $R_{3a}$ to $R_{3c}$ may each be a group represented by Formula 1-1 and one of $R_{1a}$ to $R_{1d}$ may be a group represented by Formula 1-1; two of $R_{3a}$ to $R_{3c}$ may each be a group represented by Formula 1-1 and one of $R_{2a}$ to $R_{2d}$ may be a group represented by Formula 1-1; or one of $R_{1a}$ to $R_{1d}$ may be a group represented by Formula 1-1, one of $R_{2a}$ to $R_{2d}$ may be a group represented by Formula 1-1, and one of $R_{3a}$ to $R_{3c}$ may be a group represented by Formula 1-1;
(vii) two of $R_{1a}$ to $R_{1d}$ may each be a group represented by Formula 1-1 and two of $R_{2a}$ to $R_{2d}$ may each be a group represented by Formula 1-1; two of $R_{1a}$ to $R_{1d}$ may each be a group represented by Formula 1-1 and two of $R_{3a}$ to $R_{3c}$ may each be a group represented by Formula 1-1; two of $R_{2a}$ to $R_{2d}$ may each be a group represented by Formula 1-1 and two of $R_{3a}$ to $R_{3c}$ may each be a group represented by Formula 1-1; two of $R_{1a}$ to $R_{1d}$ may each be a group represented by Formula 1-1, one of $R_{2a}$ to $R_{2d}$ may be a group represented by Formula 1-1, and one of $R_{3a}$ to $R_{3c}$ may be a group represented by Formula 1-1; two of $R_{2a}$ to $R_{2d}$ may each be a group represented by Formula 1-1, one of $R_{1a}$ to $R_{1d}$ may be a group represented by Formula 1-1, and one of $R_{3a}$ to $R_{3c}$ may be a group represented by Formula 1-1; two of $R_{3a}$ to $R_{3c}$ may each be a group represented by Formula 1-1, one of $R_{1a}$ to $R_{1d}$ may be a group represented by Formula 1-1, and one of $R_{2a}$ to $R_{2d}$ may be a group represented by Formula 1-1; three of $R_{1a}$ to $R_{1d}$ may each be a group represented by Formula 1-1 and one of $R_{2a}$ to $R_{2d}$ may be a group represented by Formula 1-1; three of $R_{2a}$ to $R_{2d}$ may each be a group

represented by Formula 1-1 and one of $R_{1a}$ to $R_{1d}$ may be a group represented by Formula 1-1; three of $R_{1a}$ to $R_{1d}$ may each be a group represented by Formula 1-1 and one of $R_{3a}$ to $R_{3c}$ may be a group represented by Formula 1-1; three of $R_{2a}$ to $R_{2d}$ may each be a group represented by Formula 1-1 and one of $R_{3a}$ to $R_{3c}$ may be a group represented by Formula 1-1; $R_{3a}$ to $R_{3c}$ may each be a group represented by Formula 1-1 and one of $R_{1a}$ to $R_{1d}$ may be a group represented by Formula 1-1; $R_{3a}$ to $R_{3c}$ may each be a group represented by Formula 1-1 and one of $R_{2a}$ to $R_{2d}$ may be a group represented by Formula 1-1;

(viii) $R_{1a}$ to $R_{1d}$ may each be a group represented by Formula 1-1 and one of $R_{2a}$ to $R_{2d}$ may be a group represented by Formula 1-1; $R_{1a}$ to $R_{1d}$ may each be a group represented by Formula 1-1 and one of $R_{3a}$ to $R_{3c}$ may be a group represented by Formula 1-1; three of $R_{1a}$ to $R_{1d}$ may each be a group represented by Formula 1-1, one of $R_{2a}$ to $R_{2d}$ may be a group represented by Formula 1-1, and one of $R_{3a}$ to $R_{3c}$ may be a group represented by Formula 1-1; three of $R_{1a}$ to $R_{1d}$ may each be a group represented by Formula 1-1 and two of $R_{2a}$ to $R_{2d}$ may each be a group represented by Formula 1-1; three of $R_{1a}$ to $R_{1d}$ may each be a group represented by Formula 1-1 and two of $R_{3a}$ to $R_{3c}$ may each be a group represented by Formula 1-1; two of $R_{1a}$ to $R_{1d}$ may each be a group represented by Formula 1-1 and three of $R_{2a}$ to $R_{2d}$ may each be a group represented by Formula 1-1; two of $R_{1a}$ to $R_{1d}$ may each be a group represented by Formula 1-1, two of $R_{2a}$ to $R_{2d}$ may each be a group represented by Formula 1-1, and one of $R_{3a}$ to $R_{3c}$ may be a group represented by Formula 1-1; two of $R_{1a}$ to $R_{1d}$ may each be a group represented by Formula 1-1; one of $R_{2a}$ to $R_{2d}$ may be a group represented by Formula 1-1, and two of $R_{3a}$ to $R_{3c}$ may each be a group represented by Formula 1-1; two of $R_{1a}$ to $R_{1d}$ may each be a group represented by Formula 1-1 and $R_{3a}$ to $R_{3c}$ may each be a group represented by Formula 1-1; one of $R_{1a}$ to $R_{1d}$ may be a group represented by Formula 1-1 and $R_{2a}$ to $R_{2d}$ may each be a group represented by Formula 1-1; one of $R_{1a}$ to $R_{1d}$ may be a group represented by Formula 1-1, three of $R_{2a}$ to $R_{2d}$ may each be a group represented by Formula 1-1, and one of $R_{3a}$ to $R_{3c}$ may be a group represented by Formula 1-1; one of $R_{1a}$ to $R_{1d}$ may be a group represented by Formula 1-1, two of $R_{2a}$ to $R_{2d}$ may each be a group represented by Formula 1-1, and two of $R_{3a}$ to $R_{3c}$ may each be a group represented by Formula 1-1; one of $R_{1a}$ to $R_{1d}$ may be a group represented by Formula 1-1, one of $R_{2a}$ to $R_{2d}$ may be a group represented by Formula 1-1, and $R_{3a}$ to $R_{3c}$ may each be a group represented by Formula 1-1; $R_{2a}$ to $R_{2d}$ may each be a group represented by Formula 1-1 and one of $R_{3a}$ to $R_{3c}$ may be a group represented by Formula 1-1; three of $R_{2a}$ to $R_{2d}$ may each be a group represented by Formula 1-1 and two of $R_{3a}$ to $R_{3c}$ may each be a group represented by Formula 1-1; two of $R_{2a}$ to $R_{2d}$ may each be a group represented by Formula 1-1 and $R_{3a}$ to $R_{3c}$ may each be a group represented by Formula 1-1; and

(ix) $R_{1a}$ to $R_{1d}$ may each be a group represented by Formula 1-1 and two of $R_{2a}$ to $R_{2d}$ may each be a group represented by Formula 1-1; $R_{1a}$ to $R_{1d}$ may each be a group represented by Formula 1-1, one of $R_{2a}$ to $R_{2d}$ may be a group represented by Formula 1-1, and one of $R_{3a}$ to $R_{3c}$ may be a group represented by Formula 1-1; $R_{1a}$ to $R_{1d}$ may each be a group represented by Formula 1-1 and two of $R_{3a}$ to $R_{3c}$ may each be a group represented by Formula 1-1; three of $R_{1a}$ to $R_{1d}$ may each be a group represented by Formula 1-1 and three of $R_{2a}$ to $R_{2d}$ may each be a group represented by Formula 1-1; three of $R_{1a}$ to $R_{1d}$ may each be a group represented by Formula 1-1, two of $R_{2a}$ to $R_{2d}$ may each be a group represented by Formula 1-1, and one of $R_{3a}$ to $R_{3c}$ may be a group represented by Formula 1-1; three of $R_{1a}$ to $R_{1d}$ may each be a group represented by Formula 1-1, one of $R_{2a}$ to $R_{2d}$ may be a group represented by Formula 1-1, and two of $R_{3a}$ to $R_{3c}$ may each be a group represented by Formula 1-1; three of $R_{1a}$ to $R_{1d}$ may each be a group represented by Formula 1-1 and $R_{3a}$ to $R_{3c}$ may each be a group represented by Formula 1-1; two of $R_{1a}$ to $R_{1d}$ may each be a group represented by Formula 1-1 and $R_{2a}$ to $R_{2d}$ may each be a group represented by Formula 1-1; two of $R_{1a}$ to $R_{1d}$ may each be a group represented by Formula 1-1, three of $R_{2a}$ to $R_{2d}$ may each be a group represented by Formula 1-1, and one of $R_{3a}$ to $R_{3c}$ may be a group represented by Formula 1-1; two of $R_{1a}$ to $R_{1d}$ may each be a group represented by Formula 1-1, two of $R_{2a}$ to $R_{2d}$ may each be a group represented by Formula 1-1, and two of $R_{3a}$ to $R_{3c}$ may each be a group represented by Formula 1-1; two of $R_{1a}$ to $R_{1d}$ may each be a group represented by Formula 1-1, one of $R_{2a}$ to $R_{2d}$ may be a group represented by Formula 1-1, and $R_{3a}$ to $R_{3c}$ may each be a group represented by Formula 1-1; one of $R_{1a}$ to $R_{1d}$ may be a group represented by Formula 1-1, $R_{2a}$ to $R_{2d}$ may each be a group represented by Formula 1-1, and one of $R_{3a}$ to $R_{3c}$ may be a group represented by Formula 1-1; one of $R_{1a}$ to $R_{1d}$ may be a group represented by Formula 1-1, three of $R_{2a}$ to $R_{2d}$ may each be a group represented by Formula 1-1, and two of $R_{3a}$ to $R_{3c}$ may each be a group represented by Formula 1-1; one of $R_{1a}$ to $R_{1d}$ may be a group represented by Formula 1-1, two of $R_{2a}$ to $R_{2d}$ may each be a group represented by Formula 1-1, and $R_{3a}$ to $R_{3c}$ may each be a group represented by Formula 1-1; $R_{2a}$ to $R_{2d}$ may each be a group represented by Formula 1-1 and two of $R_{3a}$ to $R_{3c}$ may each be a group represented by Formula 1-1; three of $R_{2a}$ to $R_{2d}$ may each be a group represented by Formula 1-1 and $R_{3a}$ to $R_{3c}$ may each be a group represented by Formula 1-1.

For example, $R_{1a}$, $R_{1b}$, $R_{1c}$, $R_{1d}$, $R_{2a}$, $R_{2b}$, $R_{2c}$, $R_{2d}$, $R_{3a}$, $R_{3b}$, and $R_{3c}$ in Formula 2 may each independently be:

a group represented by Formula 1-1,

hydrogen, deuterium, -F, -Cl, -Br, -I, a hydroxyl group, a cyano group (CN), a nitro group, an amino group, a methyl group, an ethyl group, a propyl group, an isopropyl group, a butyl group, a sec-butyl group, an isobutyl group, a tert-butyl group, a methoxy group, an ethoxy group, a propoxy group, an isopropoxy group, a butoxy group, a sec-butoxy group, a tert-butoxy group, or an isobutoxy group;

a methyl group, an ethyl group, a propyl group, an isopropyl group, a butyl group, a sec-butyl group, an isobutyl group, a tert-butyl group, a methoxy group, an ethoxy group, a propoxy group, an isopropoxy group, a butoxy group, a sec-butoxy group, a tert-butoxy group, or an isobutoxy group, each substituted with at least one of deuterium, -F, -Cl, -Br, -I, a hydroxyl group, a cyano group (CN), a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group;

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group; or

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, each substituted with at least one of deuterium, -F, -Cl, -Br, -I, a hydroxyl group, a cyano group, a nitro group, an amino group, a methyl group, an ethyl group, a propyl group, an isopropyl group, a butyl group, a sec-butyl group, an isobutyl group, a tert-butyl group, a methoxy group, an ethoxy group, a propoxy group, an isopropoxy group, a butoxy group, a sec-butoxy group, tert-butoxy group, isobutoxy group, a $C_7$-$C_{60}$ aryl alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, but embodiments of the present disclosure are not limited thereto.

For example, from among $R_{1a}$, $R_{1b}$, $R_{1c}$, $R_{1d}$, $R_{2a}$, $R_{2b}$, $R_{2c}$, $R_{2d}$, $R_{3a}$, $R_{3b}$, and $R_{3c}$, a group that is not the group represented by Formula 1-1 may be hydrogen.

In one or more embodiments, the polycyclic compound may be represented by Formula 2A below:

Formula 2A

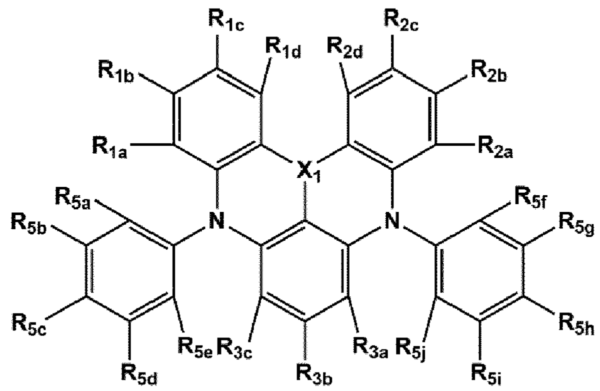

wherein, in Formula 2A,

$X_1$ is the same as described above,
$R_{1a}$ to $R_{1d}$ are each the same as described in connection with $R_1$ as described above, $R_{2a}$ to $R_{2d}$ are each the same as described in connection with $R_2$ as described above, and $R_{3a}$ to $R_{3c}$ are each the same as described in connection with $R_3$ as described above, and $R_{5a}$ to $R_{5j}$ are each the same as described in connection with $R_5$ as described above, and

(i) one of $R_{1a}$ to $R_{1d}$ is a group represented by Formula 1-1; one of $R_{2a}$ to $R_{2d}$ is a group represented by Formula 1-1; one of $R_{3a}$ to $R_{3c}$ is a group represented by Formula 1-1; one of $R_{5a}$ to $R_{5e}$ is a group represented by Formula 1-1; or one of $R_{5f}$ to $R_{5j}$ is a group represented by Formula 1-1;
(ii) two of $R_{1a}$ to $R_{1d}$ are each a group represented by Formula 1-1; two of $R_{2a}$ to $R_{2d}$ are each a group represented by Formula 1-1; two of $R_{3a}$ to $R_{3c}$ are each a group represented by Formula 1-1; two of $R_{5a}$ to Rse are each a group represented by Formula 1-1; or two of $R_{5f}$ to $R_{5j}$ are each a group represented by Formula 1-1;
(iii) three of $R_{1a}$ to $R_{1d}$ are each a group represented by Formula 1-1; three of $R_{2a}$ to $R_{2d}$ are each a group represented by Formula 1-1; each of $R_{3a}$ to $R_{3c}$ is a group represented by Formula 1-1; three of $R_{5a}$ to Rse are each a group represented by Formula 1-1; or three of $R_{5f}$ to $R_{5j}$ are each a group represented by Formula 1-1;
(iv) each of $R_{1a}$ to $R_{1d}$ is a group represented by Formula 1-1; each of $R_{2a}$ to $R_{2d}$ is a group represented by Formula 1-1; four of $R_{5a}$ to Rse are each a group represented by Formula 1-1; or four of $R_{5f}$ to $R_{5j}$ are each a group represented by Formula 1-1;
(v) each of $R_{5a}$ to Rse is a group represented by Formula 1-1 or each of $R_{5f}$ to $R_{5j}$ is a group represented by Formula 1-1;
(vi) one of $R_{1a}$ to $R_{1d}$ is a group represented by Formula 1-1 and one of $R_{2a}$ to $R_{2d}$ is a group represented by Formula 1-1; one of $R_{1a}$ to $R_{1d}$ is a group represented by Formula 1-1 and one of $R_{3a}$ to $R_{3c}$ is a group represented by Formula 1-1; one of $R_{1a}$ to $R_{1d}$ is a group represented by Formula 1-1 and one of $R_{5a}$ to Rse is a group represented by Formula 1-1; one of $R_{1a}$ to $R_{1d}$ is a group represented by Formula 1-1 and one of $R_{5f}$ to $R_{5j}$ is a group represented by Formula 1-1; one of $R_{2a}$ to $R_{2d}$ is a group represented by Formula 1-1 and one of $R_{3a}$ to $R_{3c}$ is a group represented by Formula 1-1; one of $R_{2a}$ to $R_{2d}$ is a group represented by Formula 1-1 and one of $R_{5a}$ to Rse is a group represented by Formula 1-1; one of $R_{2a}$ to $R_{2d}$ is a group represented by Formula 1-1 and one of $R_{5f}$ to $R_{5j}$ is a group represented by Formula 1-1; one of $R_{3a}$ to $R_{3c}$ is a group represented by Formula 1-1 and one of $R_{5a}$ to Rse is a group represented by Formula 1-1; one of $R_{3a}$ to $R_{3c}$ is a group represented by Formula 1-1 and one of $R_{5f}$ to $R_{5j}$ is a group represented by Formula 1-1; one of $R_{5a}$ to Rse is a group represented by Formula 1-1 and one of $R_{5f}$ to $R_{5j}$ is a group represented by Formula 1-1;
(vii) two of $R_{1a}$ to $R_{1d}$ are each a group represented by Formula 1-1 and one of $R_{2a}$ to $R_{2d}$ is a group represented by Formula 1-1; two of $R_{1a}$ to $R_{1d}$ are each a group represented by Formula 1-1 and one of $R_{3a}$ to $R_{3c}$ is a group represented by Formula 1-1; two of $R_{1a}$ to $R_{1d}$ are each a group represented by Formula 1-1 and one of $R_{5a}$ to Rse is a group represented by Formula 1-1; two of $R_{1a}$ to $R_{1d}$ are each a group represented by Formula 1-1 and one of $R_{5f}$ to $R_{5j}$ is a group represented by Formula 1-1; two of $R_{2a}$ to $R_{2d}$ are each a group represented by Formula 1-1 and one of $R_{1a}$ to $R_{1d}$ is a group represented by Formula 1-1; two of $R_{2a}$ to $R_{2d}$ are each a group represented by Formula 1-1 and one of $R_{3a}$ to $R_{3c}$ is a group represented by Formula 1-1; two of $R_{2a}$ to $R_{2d}$ are each a group represented by Formula 1-1 and one of $R_{5a}$ to Rse is a group represented by Formula 1-1; two of $R_{2a}$ to $R_{2d}$ are each a group represented by Formula 1-1 and one of $R_{5f}$ to $R_{5j}$ is a group represented

by Formula 1-1; two of $R_{3a}$ to $R_{3c}$ are each a group represented by Formula 1-1 and one of $R_{1a}$ to $R_{1d}$ is a group represented by Formula 1-1; two of $R_{3a}$ to $R_{3c}$ are each a group represented by Formula 1-1 and one of $R_{2a}$ to $R_{2d}$ is a group represented by Formula 1-1; two of $R_{3a}$ to $R_{3c}$ are each a group represented by Formula 1-1 and one of $R_{5a}$ to Rse is a group represented by Formula 1-1; two of $R_{3a}$ to $R_{3c}$ are each a group represented by Formula 1-1 and one of $R_{5f}$ to $R_{5j}$ is a group represented by Formula 1-1; two of $R_{5a}$ to Rse are each a group represented by Formula 1-1 and one of $R_{1a}$ to $R_{1d}$ is a group represented by Formula 1-1; two of $R_{5a}$ to $R_{5e}$ are each a group represented by Formula 1-1 and one of $R_{2a}$ to $R_{2d}$ is a group represented by Formula 1-1; two of $R_{5a}$ to Rse are each a group represented by Formula 1-1 and one of $R_{3a}$ to $R_{3c}$ is a group represented by Formula 1-1; two of $R_{5a}$ to Rse are each a group represented by Formula 1-1 and one of $R_{5f}$ to $R_{5j}$ is a group represented by Formula 1-1; two of $R_{5f}$ to $R_{5j}$ are each a group represented by Formula 1-1 and one of $R_{1a}$ to $R_{1d}$ is a group represented by Formula 1-1; two of $R_{5f}$ to $R_{5j}$ are each a group represented by Formula 1-1 and one of $R_{2a}$ to $R_{2d}$ is a group represented by Formula 1-1; two of $R_{5f}$ to $R_{5j}$ are each a group represented by Formula 1-1 and one of $R_{3a}$ to $R_{3c}$ is a group represented by Formula 1-1; two of $R_{5f}$ to $R_{5j}$ are each a group represented by Formula 1-1 and one of $R_{5a}$ to Rse is a group represented by Formula 1-1, one of $R_{1a}$ to $R_{1d}$ is a group represented by Formula 1-1, one of $R_{2a}$ to $R_{2d}$ is a group represented by Formula 1-1, and one of $R_{3a}$ to $R_{3c}$ is a group represented by Formula 1-1; one of $R_{1a}$ to $R_{1d}$ is a group represented by Formula 1-1, one of $R_{2a}$ to $R_{2d}$ is a group represented by Formula 1-1, and one of $R_{5a}$ to $R_{5e}$ is a group represented by Formula 1-1; one of $R_{1a}$ to $R_{1d}$ is a group represented by Formula 1-1, one of $R_{2a}$ to $R_{2d}$ is a group represented by Formula 1-1, and one of $R_{5f}$ to $R_{5j}$ is a group represented by Formula 1-1; one of $R_{1a}$ to $R_{1d}$ is a group represented by Formula 1-1, one of $R_{3a}$ to $R_{3c}$ is a group represented by Formula 1-1, and one of $R_{5a}$ to Rse is a group represented by Formula 1-1; one of $R_{1a}$ to $R_{1d}$ is a group represented by Formula 1-1, one of $R_{3a}$ to $R_{3c}$ is a group represented by Formula 1-1, and one of $R_{5f}$ to $R_{5j}$ is a group represented by Formula 1-1; one of $R_{1a}$ to $R_{1d}$ is a group represented by Formula 1-1, one of $R_{5a}$ to Rse is a group represented by Formula 1-1, and one of $R_{5f}$ to $R_{5j}$ is a group represented by Formula 1-1; one of $R_{2a}$ to $R_{2d}$ is a group represented by Formula 1-1, one of $R_{3a}$ to $R_{3c}$ is a group represented by Formula 1-1, and one of $R_{5a}$ to Rse is a group represented by Formula 1-1; one of $R_{2a}$ to $R_{2d}$ is a group represented by Formula 1-1, one of $R_{3a}$ to $R_{3c}$ is a group represented by Formula 1-1, and one of $R_{5f}$ to $R_{5j}$ is a group represented by Formula 1-1; one of $R_{2a}$ to $R_{2d}$ is a group represented by Formula 1-1, one of $R_{5a}$ to $R_{5e}$ is a group represented by Formula 1-1, and one of $R_{5f}$ to $R_{5j}$ is a group represented by Formula 1-1; or one of $R_{3a}$ to $R_{3c}$ is a group represented by Formula 1-1, one of $R_{5a}$ to $R_{5e}$ is a group represented by Formula 1-1, and one of $R_{5f}$ to $R_{5j}$ is a group represented by Formula 1-1;

(viii) two of $R_{1a}$ to $R_{1d}$ are each a group represented by Formula 1-1 and two of $R_{2a}$ to $R_{2d}$ are each a group represented by Formula 1-1; two of $R_{1a}$ to $R_{1d}$ are each a group represented by Formula 1-1 and two of $R_{3a}$ to $R_{3c}$ are each a group represented by Formula 1-1; two of $R_{1a}$ to $R_{1d}$ are each a group represented by Formula 1-1 and two of $R_{5a}$ to Rse are each a group represented by Formula 1-1; two of $R_{1a}$ to $R_{1d}$ are each a group represented by Formula 1-1 and two of $R_{5f}$ to $R_{5j}$ are each a group represented by Formula 1-1; two of $R_{2a}$ to $R_{2d}$ are each a group represented by Formula 1-1 and two of $R_{3a}$ to $R_{3c}$ are each a group represented by Formula 1-1; two of $R_{2a}$ to $R_{2d}$ are each a group represented by Formula 1-1 and two of $R_{5a}$ to $R_{5e}$ are each a group represented by Formula 1-1; two of $R_{2a}$ to $R_{2d}$ are each a group represented by Formula 1-1 and two of $R_{5f}$ to $R_{5j}$ are each a group represented by Formula 1-1; two of $R_{3a}$ to $R_{3c}$ are each a group represented by Formula 1-1 and two of $R_{5a}$ to $R_{5e}$ are each a group represented by Formula 1-1; two of $R_{3a}$ to $R_{3c}$ are each a group represented by Formula 1-1 and two of $R_{5f}$ to $R_{5j}$ are each a group represented by Formula 1-1; two of $R_{5a}$ to $R_{5e}$ are each a group represented by Formula 1-1 and two of $R_{5f}$ to $R_{5j}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and one of $R_{3a}$ to $R_{3c}$ is a group represented by Formula 1-1; two of $R_{1a}$ to $R_{1d}$ are each a group represented by Formula 1-1, one of $R_{2a}$ to $R_{2d}$ is a group represented by Formula 1-1, and one of $R_{5a}$ to $R_{5e}$ is a group represented by Formula 1-1; two of $R_{1a}$ to $R_{1d}$ are each a group represented by Formula 1-1, one of $R_{2a}$ to $R_{2d}$ is a group represented by Formula 1-1, and one of $R_{5f}$ to $R_{5j}$ is a group represented by Formula 1-1; two of $R_{1a}$ to $R_{1d}$ are each a group represented by Formula 1-1, one of $R_{3a}$ to $R_{3c}$ is a group represented by Formula 1-1, and one of $R_{5a}$ to $R_{5e}$ is a group represented by Formula 1-1; two of $R_{1a}$ to $R_{1d}$ are each a group represented by Formula 1-1, one of $R_{3a}$ to $R_{3c}$ is a group represented by Formula 1-1, and one of $R_{5f}$ to $R_{5j}$ is a group represented by Formula 1-1; two of $R_{1a}$ to $R_{1d}$ are each a group represented by Formula 1-1, one of $R_{5a}$ to $R_{5e}$ is a group represented by Formula 1-1, and one of $R_{5f}$ to $R_{5j}$ is a group represented by Formula 1-1; two of $R_{2a}$ to $R_{2d}$ are each a group represented by Formula 1-1, one of $R_{1a}$ to $R_{1d}$ is a group represented by Formula 1-1, and one of $R_{3a}$ to $R_{3c}$ is a group represented by Formula 1-1; two of $R_{2a}$ to $R_{2d}$ are each a group represented by Formula 1-1, one of $R_{1a}$ to $R_{1d}$ is a group represented by Formula 1-1, and one of $R_{5a}$ to $R_{5e}$ is a group represented by Formula 1-1; two of $R_{2a}$ to $R_{2d}$ are each a group represented by Formula 1-1, one of $R_{1a}$ to $R_{1d}$ is a group represented by Formula 1-1, and one of $R_{5f}$ to $R_{5j}$ is a group represented by Formula 1-1; two of $R_{2a}$ to $R_{2d}$ are each a group represented by Formula 1-1, one of $R_{3a}$ to $R_{3c}$ is a group

represented by Formula 1-1, and one of $R_{5a}$ to $R_{5e}$ is a group represented by Formula 1-1; two of $R_{2a}$ to $R_{2d}$ are each a group represented by Formula 1-1, one of $R_{3a}$ to $R_{3c}$ is a group represented by Formula 1-1, and one of $R_{5f}$ to $R_{5j}$ is a group represented by Formula 1-1; two of $R_{2a}$ to $R_{2d}$ are each a group represented by Formula 1-1, one of $R_{5a}$ to $R_{5e}$ is a group represented by Formula 1-1, and one of $R_{5f}$ to $R_{5j}$ is a group represented by Formula 1-1; two of $R_{3a}$ to $R_{3c}$ are each a group represented by Formula 1-1, one of $R_{1a}$ to $R_{1d}$ is a group represented by Formula 1-1, and one of $R_{2a}$ to $R_{2d}$ is a group represented by Formula 1-1; two of $R_{3a}$ to $R_{3c}$ are each a group represented by Formula 1-1, one of $R_{1a}$ to $R_{1d}$ is a group represented by Formula 1-1, and one of $R_{5a}$ to $R_{5e}$ is a group represented by Formula 1-1; two of $R_{3a}$ to $R_{3c}$ are each a group represented by Formula 1-1, one of $R_{1a}$ to $R_{1d}$ is a group represented by Formula 1-1, and one of $R_{5f}$ to $R_{5j}$ is a group represented by Formula 1-1; two of $R_{3a}$ to $R_{3c}$ are each a group represented by Formula 1-1, one of $R_{2a}$ to $R_{2d}$ is a group represented by Formula 1-1, and one of $R_{5a}$ to $R_{5e}$ is a group represented by Formula 1-1; two of $R_{3a}$ to $R_{3c}$ are each a group represented by Formula 1-1, one of $R_{2a}$ to $R_{2d}$ is a group represented by Formula 1-1, and one of $R_{5f}$ to $R_{5j}$ is a group represented by Formula 1-1; two of $R_{3a}$ to $R_{3c}$ are each a group represented by Formula 1-1, one of $R_{5a}$ to $R_{5e}$ is a group represented by Formula 1-1, and one of $R_{5f}$ to $R_{5j}$ is a group represented by Formula 1-1; two of $R_{5a}$ to $R_{5e}$ are each a group represented by Formula 1-1, one of $R_{1a}$ to $R_{1d}$ is a group represented by Formula 1-1, and one of $R_{2a}$ to $R_{2d}$ is a group represented by Formula 1-1; two of $R_{5a}$ to Rse are each a group represented by Formula 1-1, one of $R_{1a}$ to $R_{1d}$ is a group represented by Formula 1-1, and one of $R_{3a}$ to $R_{3c}$ is a group represented by Formula 1-1; two of $R_{5a}$ to Rse are each a group represented by Formula 1-1, one of $R_{1a}$ to $R_{1d}$ is a group represented by Formula 1-1, and one of $R_{5f}$ to $R_{5j}$ is a group represented by Formula 1-1; two of $R_{5a}$ to $R_{5e}$ are each a group represented by Formula 1-1, one of $R_{2a}$ to $R_{2d}$ is a group represented by Formula 1-1, and one of $R_{3a}$ to $R_{3c}$ is a group represented by Formula 1-1; two of $R_{5a}$ to $R_{5e}$ are each a group represented by Formula 1-1, one of $R_{2a}$ to $R_{2d}$ is a group represented by Formula 1-1, and one of $R_{5f}$ to $R_{5j}$ is a group represented by Formula 1-1; two of $R_{5a}$ to $R_{5e}$ are each a group represented by Formula 1-1, one of $R_{3a}$ to $R_{3c}$ is a group represented by Formula 1-1, and one of $R_{5f}$ to $R_{5j}$ is a group represented by Formula 1-1; two of $R_{5f}$ to $R_{5j}$ are each a group represented by Formula 1-1, one of $R_{1a}$ to $R_{1d}$ is a group represented by Formula 1-1, and one of $R_{2a}$ to $R_{2d}$ is a group represented by Formula 1-1; two of $R_{5f}$ to $R_{5j}$ are each a group represented by Formula 1-1, one of $R_{1a}$ to $R_{1d}$ is a group represented by Formula 1-1, and one of $R_{3a}$ to $R_{3c}$ is a group represented by Formula 1-1; two of $R_{5f}$ to $R_{5j}$ are each a group represented by Formula 1-1, one of $R_{1a}$ to $R_{1d}$ is a group represented by Formula 1-1, and one of $R_{5a}$ to $R_{5e}$ is a group represented by Formula 1-1; two of $R_{5f}$ to $R_{5j}$ are each a group represented by Formula 1-1, one of $R_{2a}$ to $R_{2d}$ is a group represented by Formula 1-1, and one of $R_{3a}$ to $R_{3c}$ is a group represented by Formula 1-1; two of $R_{5f}$ to $R_{5j}$ are each a group represented by Formula 1-1, one of $R_{2a}$ to $R_{2d}$ is a group represented by Formula 1-1, and one of $R_{5a}$ to $R_{5e}$ is a group represented by Formula 1-1; two of $R_{5f}$ to $R_{5j}$ are each a group represented by Formula 1-1, one of $R_{3a}$ to $R_{3c}$ is a group represented by Formula 1-1, and one of $R_{5a}$ to $R_{5e}$ is a group represented by Formula 1-1; three of $R_{1a}$ to $R_{1d}$ are each a group represented by Formula 1-1, and one of $R_{2a}$ to $R_{2d}$ is a group represented by Formula 1-1; three of $R_{1a}$ to $R_{1d}$ are each a group represented by Formula 1-1, and one of $R_{5a}$ to $R_{5e}$ is a group represented by Formula 1-1; three of $R_{1a}$ to $R_{1d}$ are each a group represented by Formula 1-1, and one of $R_{5f}$ to $R_{5j}$ is a group represented by Formula 1-1; three of $R_{2a}$ to $R_{2d}$ are each a group represented by Formula 1-1 and one of $R_{1a}$ to $R_{1d}$ is a group represented by Formula 1-1; three of $R_{2a}$ to $R_{2d}$ are each a group represented by Formula 1-1 and one of $R_{5a}$ to $R_{5e}$ is a group represented by Formula 1-1; three of $R_{2a}$ to $R_{2d}$ are each a group represented by Formula 1-1 and one of $R_{5f}$ to $R_{5j}$ is a group represented by Formula 1-1; three of $R_{1a}$ to $R_{1d}$ are each a group represented by Formula 1-1 and one of $R_{3a}$ to $R_{3c}$ is a group represented by Formula 1-1; three of $R_{2a}$ to $R_{2d}$ are each a group represented by Formula 1-1 and one of $R_{3a}$ to $R_{3c}$ is a group represented by Formula 1-1; $R_{3a}$ to $R_{3c}$ are each a group represented by Formula 1-1 and one of $R_{1a}$ to $R_{1d}$ is a group represented by Formula 1-1; $R_{3a}$ to $R_{3c}$ are each a group represented by Formula 1-1 and one of $R_{5a}$ to $R_{5e}$ is a group represented by Formula 1-1; $R_{3a}$ to $R_{3c}$ are each a group represented by Formula 1-1 and one of $R_{5f}$ to $R_{5j}$ is a group represented by Formula 1-1; $R_{3a}$ to $R_{3c}$ are each a group represented by Formula 1-1 and one of $R_{2a}$ to $R_{2d}$ is a group represented by Formula 1-1, three of $R_{5a}$ to $R_{5d}$ are each a group represented by Formula 1-1, and one of $R_{1a}$ to $R_{1d}$ is a group represented by Formula 1-1; three of $R_{5a}$ to $R_{5d}$ are each a group represented by Formula 1-1, and one of $R_{2a}$ to $R_{2d}$ is a group represented by Formula 1-1; three of $R_{5a}$ to $R_{5d}$ are each a group represented by Formula 1-1, and one of $R_{3a}$ to $R_{3c}$ is a group represented by Formula 1-1; or three of $R_{5a}$ to $R_{5d}$ are each a group represented by Formula 1-1, and one of $R_{5f}$ to $R_{5j}$ is a group represented by Formula 1-1;

(ix) $R_{1a}$ to $R_{1d}$ are each a group represented by Formula 1-1 and one of $R_{2a}$ to $R_{2d}$ is a group represented by Formula 1-1; $R_{1a}$ to $R_{1d}$ are each a group represented by Formula 1-1 and one of $R_{3a}$ to $R_{3c}$ is a group represented by Formula 1-1; $R_{1a}$ to $R_{1d}$ are each a group represented by Formula 1-1 and one of $R_{5a}$ to $R_{5e}$ is a group represented by Formula 1-1; $R_{1a}$ to $R_{1d}$ are each a group represented by Formula 1-1 and one of $R_{5f}$ to $R_{5j}$ is a group represented by Formula 1-1; three of $R_{1a}$ to $R_{1d}$ are each a group represented by Formula 1-1, one of

$R_{2a}$ to $R_{2d}$ is a group represented by Formula 1-1, and one of $R_{3a}$ to $R_{3c}$ is a group represented by Formula 1-1; three of $R_{1a}$ to $R_{1d}$ are each a group represented by Formula 1-1, one of $R_{2a}$ to $R_{2d}$ is a group represented by Formula 1-1, and one of $R_{5a}$ to $R_{5e}$ is a group represented by Formula 1-1; three of $R_{1a}$ to $R_{1d}$ are each a group represented by Formula 1-1, one of $R_{2a}$ to $R_{2d}$ is a group represented by Formula 1-1, and one of $R_{5f}$ to $R_{5j}$ is a group represented by Formula 1-1; three of $R_{1a}$ to $R_{1d}$ are each a group represented by Formula 1-1, one of $R_{3a}$ to $R_{3c}$ is a group represented by Formula 1-1, and one of $R_{5a}$ to $R_{5e}$ is a group represented by Formula 1-1; three of $R_{1a}$ to $R_{1d}$ are each a group represented by Formula 1-1, one of $R_{3a}$ to $R_{3c}$ is a group represented by Formula 1-1, and one of $R_{5a}$ to $R_{5e}$ is a group represented by Formula 1-1; three of $R_{1a}$ to $R_{1d}$ are each a group represented by Formula 1-1, one of $R_{5a}$ to $R_{5e}$ is a group represented by Formula 1-1, and one of $R_{5f}$ to $R_{5j}$ is a group represented by Formula 1-1; three of $R_{1a}$ to $R_{1d}$ are each a group represented by Formula 1-1 and two of $R_{2a}$ to $R_{2d}$ are each a group represented by Formula 1-1; three of $R_{1a}$ to $R_{1d}$ are each a group represented by Formula 1-1 and two of $R_{3a}$ to $R_{3c}$ are each a group represented by Formula 1-1; three of $R_{1a}$ to $R_{1d}$ are each a group represented by Formula 1-1 and two of $R_{5a}$ to $R_{5e}$ are each a group represented by Formula 1-1; three of $R_{1a}$ to $R_{1d}$ are each a group represented by Formula 1-1 and two of $R_{5f}$ to $R_{5j}$ are each a group represented by Formula 1-1; two of $R_{1a}$ to $R_{1d}$ are each a group represented by Formula 1-1 and three of $R_{2a}$ to $R_{2d}$ are each a group represented by Formula 1-1; two of $R_{1a}$ to $R_{1d}$ are each a group represented by Formula 1-1, two of $R_{2a}$ to $R_{2d}$ are each a group represented by Formula 1-1, and one of $R_{3a}$ to $R_{3c}$ is a group represented by Formula 1-1; two of $R_{1a}$ to $R_{1d}$ are each a group represented by Formula 1-1, two of $R_{2a}$ to $R_{2d}$ are each a group represented by Formula 1-1, and one of $R_{5a}$ to $R_{5e}$ is a group represented by Formula 1-1; two of $R_{1a}$ to $R_{1d}$ are each a group represented by Formula 1-1, two of $R_{2a}$ to $R_{2d}$ are each a group represented by Formula 1-1, and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, and two of $R_{3a}$ to $R_{3c}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and two of $R_{5a}$ to $R_{5e}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and two of $R_{5f}$ to $R_{5j}$ are each a group represented by Formula 1-1; two of $R_{1a}$ to $R_{1d}$ are each a group represented by Formula 1-1 and $R_{3a}$ to $R_{3c}$ are each a group represented by Formula 1-1; two of $R_{1a}$ to $R_{1d}$ are each a group represented by Formula 1-1 and three of $R_{5a}$ to $R_{5e}$ are each a group represented by Formula 1-1; two of $R_{1a}$ to $R_{1d}$ are each a group represented by Formula 1-1 and three of $R_{5f}$ to $R_{5j}$ are each a group represented by Formula 1-1; one of $R_{1a}$ to $R_{1d}$ is a group represented by Formula 1-1 and $R_{2a}$ to $R_{2d}$ are each a group represented by Formula 1-1; one of $R_{1a}$ to $R_{1d}$ is a group represented by Formula 1-1 and four of $R_{5a}$ to $R_{5e}$ are each a group represented by Formula 1-1; one of $R_{1a}$ to $R_{1d}$ is a group represented by Formula 1-1 and four of $R_{5f}$ to $R_{5j}$ are each a group represented by Formula 1-1; one of $R_{1a}$ to $R_{1d}$ is a group represented by Formula 1-1, three of $R_{2a}$ to $R_{2d}$ are each a group represented by Formula 1-1, and one of $R_{3a}$ to $R_{3c}$ is a group represented by Formula 1-1; one of $R_{1a}$ to $R_{1d}$ is a group represented by Formula 1-1, three of $R_{2a}$ to $R_{2d}$ are each a group represented by Formula 1-1, and one of $R_{5a}$ to $R_{5e}$ is a group represented by Formula 1-1; one of $R_{1a}$ to $R_{1d}$ is a group represented by Formula 1-1, three of $R_{2a}$ to $R_{2d}$ are each a group represented by Formula 1-1, and one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, and two of $R_{3a}$ to $R_{3c}$ are each a group represented by Formula 1-1; one of $R_{1a}$ to $R_{1d}$ is a group represented by Formula 1-1, two of $R_{2a}$ to $R_{2d}$ are each a group represented by Formula 1-1, and two of $R_{5a}$ to $R_{5e}$ are each a group represented by Formula 1-1; one of $R_{1a}$ to $R_{1d}$ is a group represented by Formula 1-1, two of $R_{2a}$ to $R_{2d}$ are each a group represented by Formula 1-1, and two of $R_{5f}$ to $R_{35j}$ are each a group represented by Formula 1-1; one of $R_{1a}$ to $R_{1d}$ is a group represented by Formula 1-1, one of $R_{2a}$ to $R_{2d}$ is a group represented by Formula 1-1, and $R_{3a}$ to $R_{3c}$ are each a group represented by Formula 1-1; one of $R_{1a}$ to $R_{1d}$ is a group represented by Formula 1-1, one of $R_{2a}$ to $R_{2d}$ is a group represented by Formula 1-1, and three of $R_{5a}$ to $R_{5e}$ are each a group represented by Formula 1-1; one of $R_{1a}$ to $R_{1d}$ is a group represented by Formula 1-1, one of $R_{2a}$ to $R_{2d}$ is a group represented by Formula 1-1, and three of $R_{5f}$ to $R_{5j}$ are each a group represented by Formula 1-1; $R_{2a}$ to $R_{2d}$ are each a group represented by Formula 1-1 and one of $R_{3a}$ to $R_{3c}$ is a group represented by Formula 1-1; $R_{2a}$ to $R_{2d}$ are each a group represented by Formula 1-1 and one of $R_{5a}$ to $R_{5e}$ is a group represented by Formula 1-1; $R_{2a}$ to $R_{2d}$ are each a group represented by Formula 1-1 and one of $R_{5f}$ to $R_{5j}$ is a group represented by Formula 1-1; three of $R_{2a}$ to $R_{2d}$ are each a group represented by Formula 1-1, and two of $R_{3a}$ to $R_{3c}$ are each a group represented by Formula 1-1; three of $R_{2a}$ to $R_{2d}$ are each a group represented by Formula 1-1, one of $R_{3a}$ to $R_{3c}$ is a group represented by Formula 1-1, and one of $R_{5a}$ to $R_{5e}$ is a group represented by Formula 1-1; three of $R_{2a}$ to $R_{2d}$ are each a group represented by Formula 1-1, one of $R_{3a}$ to $R_{3c}$ is a group represented by Formula 1-1, and one of $R_{5f}$ to $R_{5j}$ is a group represented by Formula 1-1; three of $R_{2a}$ to $R_{2d}$ are each a group represented by Formula 1-1, one of $R_{5a}$ to $R_{5e}$ is a group represented by Formula 1-1, and one of $R_{5f}$ to $R_{5j}$ is a group represented by Formula 1-1; three of $R_{2a}$ to $R_{2d}$

are each a group represented by Formula 1-1, and two of $R_{5a}$ to $R_{5e}$ are each a group represented by Formula 1-1; three of $R_{2a}$ to $R_{2d}$ are each a group represented by Formula 1-1, and two of $R_{5f}$ to $R_{5j}$ are each a group represented by Formula 1-1; two of $R_{2a}$ to $R_{2d}$ are each a group represented by Formula 1-1 and $R_{3a}$ to $R_{3c}$ are each a group represented by Formula 1-1; two of $R_{2a}$ to $R_{2d}$ are each a group represented by Formula 1-1, two of $R_{3a}$ to $R_{3c}$ are each a group represented by Formula 1-1 and one of $R_{5a}$ to $R_{5e}$ is a group represented by Formula 1-1; two of $R_{2a}$ to $R_{2d}$ are each a group represented by Formula 1-1, two of $R_{3a}$ to $R_{3c}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, one of $R_{3a}$ to $R_{3c}$ is a group represented by Formula 1-1 and two of $R_{5a}$ to $R_{5e}$ are each a group represented by Formula 1-1; two of $R_{2a}$ to $R_{2d}$ are each a group represented by Formula 1-1, one of $R_{3a}$ to $R_{3c}$ is a group represented by Formula 1-1 and two of $R_{5f}$ to $R_{5j}$ are each a group represented by Formula 1-1; two of $R_{2a}$ to $R_{2d}$ are each a group represented by Formula 1-1, one of $R_{3a}$ to $R_{3c}$ is a group represented by Formula 1-1, one of $R_{5a}$ to $R_{5e}$ is a group represented by Formula 1-1 and one of $R_{5f}$ to $R_{5j}$ is a group represented by Formula 1-1; two of $R_{2a}$ to $R_{2d}$ are each a group represented by Formula 1-1 and three of $R_{5a}$ to Rse are each a group represented by Formula 1-1; two of $R_{2a}$ to $R_{2d}$ are each a group represented by Formula 1-1, two of $R_{5a}$ to $R_{5e}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, one of $R_{5a}$ to Rse is a group represented by Formula 1-1 and two of $R_{5f}$ to $R_{5j}$ are each a group represented by Formula 1-1; two of $R_{2a}$ to $R_{2d}$ are each a group represented by Formula 1-1 and three of $R_{5f}$ to $R_{5j}$ are each a group represented by Formula 1-1; one of $R_{2a}$ to $R_{2d}$ is a group represented by Formula 1-1, three of $R_{3a}$ to $R_{3c}$ are each a group represented by Formula 1-1 and one of $R_{5a}$ to Rse is a group represented by Formula 1-1; one of $R_{2a}$ to $R_{2d}$ is a group represented by Formula 1-1, three of $R_{3a}$ to $R_{3c}$ are each a group represented by Formula 1-1 and one of $R_{5f}$ to $R_{5j}$ are each a group represented by Formula 1-1; one of $R_{2a}$ to $R_{2d}$ is a group represented by Formula 1-1, two of $R_{3a}$ to $R_{3c}$ are each a group represented by Formula 1-1 and two of $R_{5a}$ to Rse are each a group represented by Formula 1-1; one of $R_{2a}$ to $R_{2d}$ is a group represented by Formula 1-1, two of $R_{3a}$ to $R_{3c}$ are each a group represented by Formula 1-1 and two of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1 and three of $R_{5a}$ to Rse are each a group represented by Formula 1-1; one of $R_{2a}$ to $R_{2d}$ is a group represented by Formula 1-1, one of $R_{3a}$ to $R_{3c}$ is a group represented by Formula 1-1 and three of $R_{5f}$ to $R_{5j}$ are each a group represented by Formula 1-1; one of $R_{2a}$ to $R_{2d}$ is a group represented by Formula 1-1 and four of $R_{5a}$ to Rse are each a group represented by Formula 1-1; one of $R_{2a}$ to $R_{2d}$ is a group represented by Formula 1-1 and four of $R_{5f}$ to $R_{5j}$ are each a group represented by Formula 1-1; one of $R_{2a}$ to $R_{2d}$ is a group represented by Formula 1-1, three of $R_{5a}$ to Rse are each a group represented by Formula 1-1 and one of $R_{5f}$ to $R_{5j}$ is a group represented by Formula 1-1; one of $R_{2a}$ to $R_{2d}$ is a group represented by Formula 1-1, two of $R_{5a}$ to Rse are each a group represented by Formula 1-1 and two of $R_{5f}$ to $R_{5j}$ are each a group represented by Formula 1-1; one of $R_{2a}$ to $R_{2d}$ is a group represented by Formula 1-1, one of $R_{5a}$ to Rse is a group represented by Formula 1-1 and three of $R_{5f}$ to $R_{5j}$ are each a group represented by Formula 1-1; $R_{3a}$ to $R_{3c}$ are each a group represented by Formula 1-1 and two of $R_{5a}$ to Rse are each a group represented by Formula 1-1; $R_{3a}$ to $R_{3c}$ are each a group represented by Formula 1-1 and two of $R_{5f}$ to $R_{5j}$ are each a group represented by Formula 1-1; $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula 1-1; two of $R_{3a}$ to $R_{3c}$ are each a group represented by Formula 1-1 and three of $R_{5a}$ to Rse are each a group represented by Formula 1-1; two of $R_{3a}$ to $R_{3c}$ are each a group represented by Formula 1-1 and three of $R_{5f}$ to $R_{5j}$ are each a group represented by Formula 1-1; two of $R_{3a}$ to $R_{3c}$ are each a group represented by Formula 1-1, two of $R_{5a}$ to Rse are each a group represented by Formula 1-1, one of $R_{5f}$ to $R_{5j}$ is a group represented by Formula 1-1; two of $R_{3a}$ to $R_{3c}$ are each a group represented by Formula 1-1, one of $R_{5a}$ to Rse is a group represented by Formula 1-1, two of $R_{5f}$ to $R_{5j}$ are each a group represented by Formula 1-1; one of $R_{3a}$ to $R_{3c}$ is a group represented by Formula 1-1, four of $R_{5a}$ to Rse are each a group represented by Formula 1-1; one of $R_{3a}$ to $R_{3c}$ is a group represented by Formula 1-1, four of $R_{5f}$ to $R_{5j}$ are each a group represented by Formula 1-1; one of $R_{3a}$ to $R_{3c}$ is a group represented by Formula 1-1, three of $R_{5a}$ to Rse are each a group represented by Formula 1-1 and one of $R_{5f}$ to $R_{5j}$ is a group represented by Formula 1-1; one of $R_{3a}$ to $R_{3c}$ is a group represented by Formula 1-1, two of $R_{5a}$ to Rse are each a group represented by Formula 1-1 and two of $R_{5f}$ to $R_{5j}$ are each a group represented by Formula 1-1; one of $R_{3a}$ to $R_{3c}$ is a group represented by Formula 1-1, one of $R_{5a}$ to Rse is a group represented by Formula 1-1 and three of $R_{5f}$ to $R_{5j}$ are each a group represented by Formula 1-1; $R_{5a}$ to Rse are each a group represented by Formula 1-1; $R_{5f}$ to $R_{5j}$ are each a group represented by Formula 1-1; four of $R_{5a}$ to Rse are each a group represented by Formula 1-1 and one of $R_{5f}$ to $R_{5j}$ is a group represented by Formula 1-1; three of $R_{5a}$ to Rse are each a group represented by Formula 1-1 and two of $R_{5f}$ to $R_{5j}$ are each a group represented by Formula 1-1; two of $R_{5a}$ to Rse are each a group represented by Formula 1-1 and three of $R_{5f}$ to $R_{5j}$ are each a group represented by Formula 1-1; one of $R_{5a}$ to Rse is a group represented

by Formula 1-1 and four of $R_{5f}$ to $R_{5j}$ are each a group represented by Formula 1-1;, or

(x) $R_{1a}$ to $R_{1d}$ are each a group represented by Formula 1-1 and two of $R_{2a}$ to $R_{2d}$ are each a group represented by Formula 1-1; $R_{1a}$ to $R_{1d}$ are each a group represented by Formula 1-1, one of $R_{2a}$ to $R_{2d}$ is a group represented by Formula 1-1, and one of $R_{3a}$ to $R_{3c}$ is a group represented by Formula 1-1; $R_{1a}$ to $R_{1d}$ are each a group represented by Formula 1-1 and two of $R_{3a}$ to $R_{3c}$ are each a group represented by Formula 1-1; $R_{1a}$ to $R_{1d}$ are each a group represented by Formula 1-1 and two of $R_{5a}$ to Rse are each a group represented by Formula 1-1; $R_{1a}$ to $R_{1d}$ are each a group represented by Formula 1-1 and two of $R_{5f}$ to $R_{5j}$ are each a group represented by Formula 1-1; $R_{1a}$ to $R_{1d}$ are each a group represented by Formula 1-1 one of $R_{2a}$ to $R_{2d}$ is a group represented by Formula 1-1 and one of $R_{5a}$ to Rse is a group represented by Formula 1-1; $R_{1a}$ to $R_{1d}$ are each a group represented by Formula 1-1, one of $R_{2a}$ to $R_{2d}$ is a group represented by Formula 1-1 and one of $R_{5f}$ to $R_{5j}$ is a group represented by Formula 1-1; $R_{1a}$ to $R_{1d}$ are each a group represented by Formula 1-1, one of $R_{3a}$ to $R_{3c}$ is a group represented by Formula 1-1 and one of $R_{5a}$ to Rse is a group represented by Formula 1-1; $R_{1a}$ to $R_{1d}$ are each a group represented by Formula 1-1, one of $R_{3a}$ to $R_{3c}$ is a group represented by Formula 1-1 and one of $R_{5f}$ to $R_{5j}$ is a group represented by Formula 1-1; $R_{1a}$ to $R_{1d}$ are each a group represented by Formula 1-1, one of $R_{5a}$ to Rse is a group represented by Formula 1-1 and one of $R_{5f}$ to $R_{5j}$ is a group represented by Formula 1-1; three of $R_{1a}$ to $R_{1d}$ are each a group represented by Formula 1-1 and three of $R_{2a}$ to $R_{2d}$ are each a group represented by Formula 1-1; three of $R_{1a}$ to $R_{1d}$ are each a group represented by Formula 1-1, two of $R_{2a}$ to $R_{2d}$ are each a group represented by Formula 1-1, and one of $R_{3a}$ to $R_{3c}$ is a group represented by Formula 1-1; three of $R_{1a}$ to $R_{1d}$ are each a group represented by Formula 1-1, two of $R_{2a}$ to $R_{2d}$ are each a group represented by Formula 1-1, and one of $R_{5a}$ to Rse is a group represented by Formula 1-1; three of $R_{1a}$ to $R_{1d}$ are each a group represented by Formula 1-1, two of $R_{2a}$ to $R_{2d}$ are each a group represented by Formula 1-1, and one of $R_{5f}$ to $R_{5j}$ is a group represented by Formula 1-1; three of $R_{1a}$ to $R_{1d}$ are each a group represented by Formula 1-1, one of $R_{2a}$ to $R_{2d}$ is a group represented by Formula 1-1, and two of $R_{3a}$ to $R_{3c}$ are each a group represented by Formula 1-1; three of $R_{1a}$ to $R_{1d}$ are each a group represented by Formula 1-1, one of $R_{2a}$ to $R_{2d}$ is a group represented by Formula 1-1, and two of $R_{5a}$ to Rse are each a group represented by Formula 1-1; three of $R_{1a}$ to $R_{1d}$ are each a group represented by Formula 1-1, one of $R_{2a}$ to $R_{2d}$ is a group represented by Formula 1-1, and two of $R_{5f}$ to $R_{5j}$ are each a group represented by Formula 1-1; three of $R_{1a}$ to $R_{1d}$ are each a group represented by Formula 1-1, one of $R_{2a}$ to $R_{2d}$ is a group represented by Formula 1-1, one of $R_{5a}$ to Rse is a group represented by Formula 1-1 and one of $R_{5f}$ to $R_{5j}$ is a group represented by Formula 1-1; three of $R_{1a}$ to $R_{1d}$ are each a group represented by Formula 1-1 and $R_{3a}$ to $R_{3c}$ are each a group represented by Formula 1-1; three of $R_{1a}$ to $R_{1d}$ are each a group represented by Formula 1-1 and two of $R_{3a}$ to $R_{3c}$ are each a group represented by Formula 1-1 and one of $R_{5a}$ to Rse is a group represented by Formula 1-1; three of $R_{1a}$ to $R_{1d}$ are each a group represented by Formula 1-1 and two of $R_{3a}$ to $R_{3c}$ are each a group represented by Formula 1-1 and one of $R_{5f}$ to $R_{5j}$ is a group represented by Formula 1-1; three of $R_{1a}$ to $R_{1d}$ are each a group represented by Formula 1-1, one of $R_{3a}$ to $R_{3c}$ is a group represented by Formula 1-1 and two of $R_{5a}$ to Rse are each a group represented by Formula 1-1; three of $R_{1a}$ to $R_{1d}$ are each a group represented by Formula 1-1, one of $R_{3a}$ to $R_{3c}$ is a group represented by Formula 1-1 and two of $R_{5f}$ to $R_{5j}$ are each a group represented by Formula 1-1; three of $R_{1a}$ to $R_{1d}$ are each a group represented by Formula 1-1, one of $R_{3a}$ to $R_{3c}$ is a group represented by Formula 1-1, one of $R_{5a}$ to Rse is a group represented by Formula 1-1 and one of $R_{5f}$ to $R_{5j}$ is a group represented by Formula 1-1; two of $R_{1a}$ to $R_{1d}$ are each a group represented by Formula 1-1 and $R_{2a}$ to $R_{2d}$ are each a group represented by Formula 1-1; two of $R_{1a}$ to $R_{1d}$ are each a group represented by Formula 1-1, three of $R_{2a}$ to $R_{2d}$ are each a group represented by Formula 1-1, and one of $R_{3a}$ to $R_{3c}$ is a group represented by Formula 1-1; two of $R_{1a}$ to $R_{1d}$ are each a group represented by Formula 1-1, three of $R_{2a}$ to $R_{2d}$ are each a group represented by Formula 1-1, and one of $R_{5a}$ to Rse is a group represented by Formula 1-1; two of $R_{1a}$ to $R_{1d}$ are each a group represented by Formula 1-1, three of $R_{2a}$ to $R_{2d}$ are each a group represented by Formula 1-1, and one of $R_{5f}$ to $R_{5j}$ is a group represented by Formula 1-1; two of $R_{1a}$ to $R_{1d}$ are each a group represented by Formula 1-1, two of $R_{2a}$ to $R_{2d}$ are each a group represented by Formula 1-1, and two of $R_{3a}$ to $R_{3c}$ are each a group represented by Formula 1-1; two of $R_{1a}$ to $R_{1d}$ are each a group represented by Formula 1-1, two of $R_{2a}$ to $R_{2d}$ are each a group represented by Formula 1-1, one of $R_{3a}$ to $R_{3c}$ is a group represented by Formula 1-1 and one of $R_{5a}$ to Rse is a group represented by Formula 1-1; two of $R_{1a}$ to $R_{1d}$ are each a group represented by Formula 1-1, two of $R_{2a}$ to $R_{2d}$ are each a group represented by Formula 1-1, one of $R_{3a}$ to $R_{3c}$ is a group represented by Formula 1-1 and one of $R_{5f}$ to $R_{5j}$ is a group represented by Formula 1-1; two of $R_{1a}$ to $R_{1d}$ are each a group represented by Formula 1-1, two of $R_{2a}$ to $R_{2d}$ are each a group represented by Formula 1-1, one of $R_{5a}$ to Rse is a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, and $R_{3a}$ to $R_{3c}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and $R_{3a}$ to $R_{3c}$ are each a group represented by Formula 1-1; two of $R_{1a}$ to $R_{1d}$ are each a group represented

by Formula 1-1, one of $R_{2a}$ to $R_{2d}$ is a group represented by Formula 1-1, two of $R_{3a}$ to $R_{3c}$ are each a group represented by Formula 1-1 and one of $R_{5a}$ to Rse is a group represented by Formula 1-1; two of $R_{1a}$ to $R_{1d}$ are each a group represented by Formula 1-1, one of $R_{2a}$ to $R_{2d}$ is a group represented by Formula 1-1, two of $R_{3a}$ to $R_{3c}$ are each a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{3a}$ to $R_{3c}$ is a group represented by Formula 1-1 and two of $R_{5a}$ to Rse are each a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{3a}$ to $R_{3c}$ is a group represented by Formula 1-1 and two of $R_{5f}$ to $R_{5j}$ are each a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{3a}$ to $R_{3c}$ is a group represented by Formula 1-1, one of $R_{5a}$ to $R_{5e}$ is a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, and three of $R_{5a}$ to Rse are each a group represented by Formula 1-1; two of $R_{1a}$ to $R_{1d}$ are each a group represented by Formula 1-1, one of $R_{2a}$ to $R_{2d}$ is a group represented by Formula 1-1, two of $R_{5a}$ to Rse are each a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{5a}$ to Rse is a group represented by Formula 1-1 and two of $R_{5f}$ to $R_{5j}$ are each a group represented by Formula 1-1; two of $R_{1a}$ to $R_{1d}$ are each a group represented by Formula 1-1, one of $R_{2a}$ to $R_{2d}$ is a group represented by Formula 1-1 and three of $R_{5f}$ to $R_{5j}$ are each a group represented by Formula 1-1; one of $R_{1a}$ to $R_{1d}$ is a group represented by Formula 1-1, $R_{2a}$ to $R_{2d}$ are each a group represented by Formula 1-1, and one of $R_{3a}$ to $R_{3c}$ is a group represented by Formula 1-1; one of $R_{1a}$ to $R_{1d}$ is a group represented by Formula 1-1, $R_{2a}$ to $R_{2d}$ are each a group represented by Formula 1-1, and one of $R_{5a}$ to Rse is a group represented by Formula 1-1; one of $R_{1a}$ to $R_{1d}$ is a group represented by Formula 1-1, $R_{2a}$ to $R_{2d}$ are each a group represented by Formula 1-1, and one of $R_{5f}$ to $R_{5j}$ is a group represented by Formula 1-1; one of $R_{1a}$ to $R_{1d}$ is a group represented by Formula 1-1, three of $R_{2a}$ to $R_{2d}$ are each a group represented by Formula 1-1, and two of $R_{3a}$ to $R_{3c}$ are each a group represented by Formula 1-1; one of $R_{1a}$ to $R_{1d}$ is a group represented by Formula 1-1, three of $R_{2a}$ to $R_{2d}$ are each a group represented by Formula 1-1, one of $R_{3a}$ to $R_{3c}$ is a group represented by Formula 1-1 and one of $R_{5a}$ to Rse is a group represented by Formula 1-1; one of $R_{1a}$ to $R_{1d}$ is a group represented by Formula 1-1, three of $R_{2a}$ to $R_{2d}$ are each a group represented by Formula 1-1, one of $R_{3a}$ to $R_{3c}$ is a group represented by Formula 1-1 and one of $R_{5f}$ to $R_{5j}$ is a group represented by Formula 1-1; one of $R_{1a}$ to $R_{1d}$ is a group represented by Formula 1-1, three of $R_{2a}$ to $R_{2d}$ are each a group represented by Formula 1-1, two of $R_{5a}$ to Rse are each a group represented by Formula 1-1; one of $R_{1a}$ to $R_{1d}$ is a group represented by Formula 1-1, three of $R_{2a}$ to $R_{2d}$ are each a group represented by Formula 1-1, one of $R_{5a}$ to Rse is a group represented by Formula 1-1 and one of $R_{5f}$ to $R_{5j}$ is a group represented by Formula 1-1; one of $R_{1a}$ to $R_{1d}$ is a group represented by Formula 1-1, three of $R_{2a}$ to $R_{2d}$ are each a group represented by Formula 1-1 and two of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, and $R_{3a}$ to $R_{3c}$ are each a group represented by Formula 1-1; one of $R_{1a}$ to $R_{1d}$ is a group represented by Formula 1-1, two of $R_{2a}$ to $R_{2d}$ are each a group represented by Formula 1-1, two of $R_{3a}$ to $R_{3c}$ are each a group represented by Formula 1-1, one of $R_{5a}$ to Rse is a group represented by Formula 1-1; one of $R_{1a}$ to $R_{1d}$ is a group represented by Formula 1-1, two of $R_{2a}$ to $R_{2d}$ are each a group represented by Formula 1-1, two of $R_{3a}$ to $R_{3c}$ are each a group represented by Formula 1-1, one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{3a}$ to $R_{3c}$ is a group represented by Formula 1-1, two of $R_{5a}$ to Rse are each a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{3a}$ to $R_{3c}$ is a group represented by Formula 1-1, one of $R_{5a}$ to Rse is a group represented by Formula 1-1 and one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{3a}$ to $R_{3c}$ is a group represented by Formula 1-1 and two of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, and three of $R_{5a}$ to Rse are each a group represented by Formula 1-1; one of $R_{1a}$ to $R_{1d}$ is a group represented by Formula 1-1, two of $R_{2a}$ to $R_{2d}$ are each a group represented by Formula 1-1, two of $R_{5a}$ to Rse are each a group represented by Formula 1-1 and one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{5a}$ to Rse is a group represented by Formula 1-1 and two of $R_{5f}$ to $R_{5j}$ are each a group represented by Formula 1-1; one of $R_{1a}$ to $R_{1d}$ is a group represented by Formula 1-1, two of $R_{2a}$ to $R_{2d}$ are each a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{2a}$ to

$R_{2d}$ is a group represented by Formula 1-1, $R_{3a}$ to $R_{3c}$ are each a group represented by Formula 1-1 and one of $R_{5a}$ to Rse is a group represented by Formula 1-1; one of $R_{1a}$ to $R_{1d}$ is a group represented by Formula 1-1, one of $R_{2a}$ to $R_{2d}$ are each a group represented by Formula 1-1, $R_{3a}$ to $R_{3c}$ are each a group represented by Formula 1-1 and one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, two of $R_{3a}$ to $R_{3c}$ are each a group represented by Formula 1-1 and two of $R_{5a}$ to Rse are each a group represented by Formula 1-1; one of $R_{1a}$ to $R_{1d}$ is a group represented by Formula 1-1, one of $R_{2a}$ to $R_{2d}$ is a group represented by Formula 1-1, two of $R_{3a}$ to $R_{3c}$ are each a group represented by Formula 1-1 and two of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1, two of $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1 and three of $R_{5a}$ to $R_{5e}$ are each a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1, two of $R_{5a}$ to $R_{5e}$ are each a group represented by Formula 1-1 and one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1, one of $R_{5a}$ to $R_{5e}$ is a group represented by Formula 1-1 and two of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1 and four of $R_{5a}$ to $R_{5e}$ are each a group represented by Formula 1-1; one of $R_{1a}$ to $R_{1d}$ is a group represented by Formula 1-1, one of $R_{2a}$ to $R_{2d}$ is a group represented by Formula 1-1, three of $R_{5a}$ to $R_{5e}$ are each a group represented by Formula 1-1, one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, two of $R_{5a}$ to Rse are each a group represented by Formula 1-1, two of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1, one of $R_{5a}$ to Rse is a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1 and four of $R_{5f}$ to $R_{5j}$ are each a group represented by Formula 1-1; one of $R_{1a}$ to $R_{1d}$ is a group represented by Formula 1-1, $R_{3a}$ to $R_{3c}$ are each a group represented by Formula 1-1, two of $R_{5a}$ to $R_{5e}$ are each a group represented by Formula 1-1; one of $R_{1a}$ to $R_{1d}$ is a group represented by Formula 1-1, $R_{3a}$ to $R_{3c}$ are each a group represented by Formula 1-1, one of $R_{5a}$ to $R_{5e}$ is a group represented by Formula 1-1 and one of $R_5$f to $R_{5j}$ is a group represented by Formula 1-1; one of $R_{1a}$ to $R_{1d}$ is a group represented by Formula 1-1, $R_{3a}$ to $R_{3c}$ are each a group represented by Formula 1-1 and two of $R_{5f}$ to $R_{5j}$ are each a group represented by Formula 1-1; one of $R_{1a}$ to $R_{1d}$ is a group represented by Formula 1-1, two of $R_{3a}$ to $R_{3c}$ are each a group represented by Formula 1-1 and three of $R_{5a}$ to $R_{5e}$ are each a group represented by Formula 1-1; one of $R_{1a}$ to $R_{1d}$ is a group represented by Formula 1-1, two of $R_{3a}$ to $R_{3c}$ are each a group represented by Formula 1-1, two of $R_{5a}$ to $R_{5e}$ are each a group represented by Formula 1-1 and one of $R_{5f}$ to $R_{5j}$ is a group represented by Formula 1-1; one of $R_{1a}$ to $R_{1d}$ is a group represented by Formula 1-1, two of $R_{3a}$ to $R_{3c}$ are each a group represented by Formula 1-1, one of $R_{5a}$ to $R_{5e}$ is a group represented by Formula 1-1 and two of $R_5$f to $R_{5j}$ are each a group represented by Formula 1-1; one of $R_{1a}$ to $R_{1d}$ is a group represented by Formula 1-1, two of $R_{3a}$ to $R_{3c}$ are each a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1 and four of $R_{5a}$ to $R_{5e}$ are each a group represented by Formula 1-1; one of $R_{1a}$ to $R_{1d}$ is a group represented by Formula 1-1, one of $R_{3a}$ to $R_{3c}$ is a group represented by Formula 1-1, three of $R_{5a}$ to $R_{5e}$ are each a group represented by Formula 1-1 and one of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1, two of $R_{5a}$ to $R_{5e}$ are each a group represented by Formula 1-1 and two of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1, one of $R_{5a}$ to $R_{5e}$ is a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1 and four of $R_{5f}$ to $R_{5j}$ are each a group represented by Formula 1-1; one of $R_{1a}$ to $R_{1d}$ is a group represented by Formula 1-1 and $R_{5a}$ to $R_{5e}$ are each a group represented by Formula 1-1; one of $R_{1a}$ to $R_{1d}$ is a group represented by Formula 1-1, four of $R_{5a}$ to $R_{5e}$ are each a group represented by Formula 1-1 and one of $R_{5f}$ to $R_{5j}$ is a group represented by Formula 1-1; one of $R_{1a}$ to $R_{1d}$ is a group represented by Formula 1-1, three of $R_{5a}$ to $R_{5e}$ are each a group represented by Formula

1-1 and two of $R_{5f}$ to $R_{5j}$ are each a group represented by Formula 1-1; one of $R_{1a}$ to $R_{1d}$ is a group represented by Formula 1-1, two of $R_{5a}$ to $R_{5e}$ are each a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{5a}$ to $R_{5e}$ is a group represented by Formula 1-1 and four of $R_{5f}$ to $R_{5j}$ are each a group represented by Formula 1-1; one of $R_{1a}$ to $R_{1d}$ is a group represented by Formula 1-1 and $R_{5f}$ to $R_{5j}$ are each a group represented by Formula 1-1; $R_{2a}$ to $R_{2d}$ are each a group represented by Formula 1-1 and two of $R_{3a}$ to $R_{3c}$ are each a group represented by Formula 1-1; $R_{2a}$ to $R_{2d}$ are each a group represented by Formula 1-1, one of $R_{3a}$ to $R_{3c}$ are each a group represented by Formula 1-1 and one of $R_{5a}$ to $R_{5e}$ is a group represented by Formula 1-1; $R_{2a}$ to $R_{2d}$ are each a group represented by Formula 1-1, one of $R_{3a}$ to $R_{3c}$ are each a group represented by Formula 1-1 and one of $R_{5f}$ to $R_{5j}$ is a group represented by Formula 1-1; $R_{2a}$ to $R_{2d}$ are each a group represented by Formula 1-1 and two of $R_{5a}$ to $R_{5e}$ are each a group represented by Formula 1-1; $R_{2a}$ to $R_{2d}$ are each a group represented by Formula 1-1, one of $R_{5a}$ to $R_{5e}$ is a group represented by Formula 1-1 and one of $R_{5f}$ to $R_{5j}$ is a group represented by Formula 1-1; $R_{2a}$ to $R_{2d}$ are each a group represented by Formula 1-1 and two of $R_{5f}$ to $R_{5j}$ are each a group represented by Formula 1-1; three of $R_{2a}$ to $R_{2d}$ are each a group represented by Formula 1-1 and $R_{3a}$ to $R_{3c}$ are each a group represented by Formula 1-1; three of $R_{2a}$ to $R_{2d}$ are each a group represented by Formula 1-1, two of $R_{3a}$ to $R_{3c}$ are each a group represented by Formula 1-1 and one of $R_{5a}$ to $R_{5e}$ is a group represented by Formula 1-1; three of $R_{2a}$ to $R_{2d}$ are each a group represented by Formula 1-1, two of $R_{3a}$ to $R_{3c}$ are each a group represented by Formula 1-1 and one of $R_5$f to $R_{5j}$ is a group represented by Formula 1-1; three of $R_{2a}$ to $R_{2d}$ are each a group represented by Formula 1-1, one of $R_{3a}$ to $R_{3c}$ is a group represented by Formula 1-1 and two of $R_{5a}$ to $R_{5e}$ are each a group represented by Formula 1-1; three of $R_{2a}$ to $R_{2d}$ are each a group represented by Formula 1-1, one of $R_{3a}$ to $R_{3c}$ is a group represented by Formula 1-1, one of $R_{5a}$ to $R_{5e}$ is a group represented by Formula 1-1 and one of $R_{5f}$ to $R_{5j}$ is a group represented by Formula 1-1; three of $R_{2a}$ to $R_{2d}$ are each a group represented by Formula 1-1, one of $R_{3a}$ to $R_{3c}$ is a group represented by Formula 1-1 and two of $R_{5f}$ to $R_{5j}$ are each a group represented by Formula 1-1; three of $R_{2a}$ to $R_{2d}$ are each a group represented by Formula 1-1 and three of $R_{5a}$ to $R_{5e}$ are each a group represented by Formula 1-1; three of $R_{2a}$ to $R_{2d}$ are each a group represented by Formula 1-1, two of $R_{5a}$ to $R_{5e}$ are each a group represented by Formula 1-1 and one of $R_{5f}$ to $R_{5j}$ is a group represented by Formula 1-1; three of $R_{2a}$ to $R_{2d}$ are each a group represented by Formula 1-1, one of $R_{5a}$ to $R_{5e}$ is a group represented by Formula 1-1 and two of $R_{5f}$ to $R_{5j}$ are each a group represented by Formula 1-1; three of $R_{2a}$ to $R_{2d}$ are each a group represented by Formula 1-1 and three of $R_{5f}$ to $R_{5j}$ are each a group represented by Formula 1-1; two of $R_{2a}$ to $R_{2d}$ are each a group represented by Formula 1-1, $R_{3a}$ to $R_{3c}$ are each a group represented by Formula 1-1 and one of $R_{5a}$ to $R_{5e}$ is a group represented by Formula 1-1; two of $R_{2a}$ to $R_{2d}$ are each a group represented by Formula 1-1, $R_{3a}$ to $R_{3c}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, two of $R_{3a}$ to $R_{3c}$ are each a group represented by Formula 1-1 and two of $R_{5a}$ to $R_{5e}$ are each a group represented by Formula 1-1; two of $R_{2a}$ to $R_{2d}$ are each a group represented by Formula 1-1, two of $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula 1-1; two of $R_{2a}$ to $R_{2d}$ are each a group represented by Formula 1-1, two of $R_{3a}$ to $R_{3c}$ are each a group represented by Formula 1-1 and two of $R_5$f to $R_{5j}$ are each a group represented by Formula 1-1; two of $R_{2a}$ to $R_{2d}$ are each a group represented by Formula 1-1, one of $R_{3a}$ to $R_{3c}$ is a group represented by Formula 1-1 and three of $R_{5a}$ to $R_{5e}$ are each a group represented by Formula 1-1; two of $R_{2a}$ to $R_{2d}$ are each a group represented by Formula 1-1, one of $R_{3a}$ to $R_{3c}$ is a group represented by Formula 1-1, two of $R_{5a}$ to $R_{5e}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, one of $R_{3a}$ to $R_{3c}$ is a group represented by Formula 1-1, one of $R_{5a}$ to $R_{5e}$ is a group represented by Formula 1-1 and two of $R_5$f to $R_{5j}$ are each a group represented by Formula 1-1; two of $R_{2a}$ to $R_{2d}$ are each a group represented by Formula 1-1, one of $R_{3a}$ to $R_{3c}$ is a group represented by Formula 1-1 and three of $R_{5f}$ to $R_{5j}$ are each a group represented by Formula 1-1; two of $R_{2a}$ to $R_{2d}$ are each a group represented by Formula 1-1 and four of $R_{5a}$ to $R_{5e}$ are each a group represented by Formula 1-1; two of $R_{2a}$ to $R_{2d}$ are each a group represented by Formula 1-1, three of $R_{5a}$ to Rse are each a group represented by Formula 1-1 and one of $R_{5f}$ to $R_{5j}$ is a group represented by Formula 1-1; two of $R_{2a}$ to $R_{2d}$ are each a group represented by Formula 1-1, two of $R_{5a}$ to $R_{5e}$ are each a group represented by Formula 1-1 and two of $R_{5f}$ to $R_{5j}$ are each a group represented by Formula 1-1; two of $R_{2a}$ to $R_{2d}$ are each a group represented by Formula 1-1, one of $R_{5a}$ to $R_{5e}$ is a group represented by Formula 1-1 and three of $R_{5f}$ to $R_{5j}$ are each a group represented by Formula 1-1; two of $R_{2a}$ to $R_{2d}$ are each a group represented by Formula 1-1 and four of $R_{5f}$ to $R_{5j}$ are each a group represented by Formula 1-1; one of $R_{2a}$ to $R_{2d}$ is a group represented by Formula 1-1, $R_{3a}$ to $R_{3c}$ are each a group represented by Formula 1-1 and two of $R_{5a}$ to $R_{5e}$ are each a group represented by Formula 1-1; one of $R_{2a}$ to $R_{2d}$ is a group represented by Formula 1-1, $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula 1-1; one of $R_{2a}$

to $R_{2d}$ is a group represented by Formula 1-1, $R_{3a}$ to $R_{3c}$ are each a group represented by Formula 1-1 and two of $R_{5f}$ to $R_{5j}$ are each a group represented by Formula 1-1; one of $R_{2a}$ to $R_{2d}$ is a group represented by Formula 1-1, two of $R_{3a}$ to $R_{3c}$ are each a group represented by Formula 1-1 and three of $R_{5a}$ to $R_{5e}$ are each a group represented by Formula 1-1; one of $R_{2a}$ to $R_{2d}$ is a group represented by Formula 1-1, two of $R_{3a}$ to $R_{3c}$ are each a group represented by Formula 1-1, two of $R_{5a}$ to $R_{5e}$ are each a group represented by Formula 1-1 and one of $R_{5f}$ to $R_{5j}$ is each a group represented by Formula 1-1; one of $R_{2a}$ to $R_{2d}$ is a group represented by Formula 1-1, two of $R_{3a}$ to $R_{3c}$ are each a group represented by Formula 1-1, one of $R_{5a}$ to $R_{5e}$ is a group represented by Formula 1-1 and two of $R_{5f}$ to $R_{5j}$ are each a group represented by Formula 1-1; one of $R_{2a}$ to $R_{2d}$ is a group represented by Formula 1-1, two of $R_{3a}$ to $R_{3c}$ are each a group represented by Formula 1-1 and three of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1 and four of $R_{5a}$ to $R_{5e}$ are each a group represented by Formula 1-1; one of $R_{2a}$ to $R_{2d}$ is a group represented by Formula 1-1, one of $R_{3a}$ to $R_{3c}$ is a group represented by Formula 1-1, three of $R_{5a}$ to $R_{5e}$ are each a group represented by Formula 1-1 and one of $R_{5f}$ to $R_{5j}$ is a group represented by Formula 1-1; one of $R_{2a}$ to $R_{2d}$ is a group represented by Formula 1-1, one of $R_{3a}$ to $R_{3c}$ is a group represented by Formula 1-1, two of $R_{5a}$ to $R_{5e}$ are each a group represented by Formula 1-1 and two of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1, one of $R_{5a}$ to Rse is a group represented by Formula 1-1 and three of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1 and four of $R_5$f to $R_{5j}$ are each a group represented by Formula 1-1; one of $R_{2a}$ to $R_{2d}$ is a group represented by Formula 1-1, and $R_{5a}$ to $R_{5e}$ are each a group represented by Formula 1-1; one of $R_{2a}$ to $R_{2d}$ is a group represented by Formula 1-1, and $R_{5f}$ to $R_{5j}$ are each a group represented by Formula 1-1; $R_{3a}$ to $R_{3c}$ are each a group represented by Formula 1-1 and three of $R_{5a}$ to Rse are each a group represented by Formula 1-1; $R_{3a}$ to $R_{3c}$ are each a group represented by Formula 1-1, two of $R_{5a}$ to $R_{5e}$ are each a group represented by Formula 1-1 and one of $R_{5f}$ to $R_{5j}$ is a group represented by Formula 1-1; $R_{3a}$ to $R_{3c}$ are each a group represented by Formula 1-1, one of $R_{5a}$ to $R_{5e}$ is a group represented by Formula 1-1 and two of $R_{5f}$ to $R_{5j}$ are each a group represented by Formula 1-1; $R_{3a}$ to $R_{3c}$ are each a group represented by Formula 1-1 and three of $R_{5f}$ to $R_{5j}$ are each a group represented by Formula 1-1; two of $R_{3a}$ to $R_{3c}$ are each a group represented by Formula 1-1 and four of $R_{5a}$ to Rse are each a group represented by Formula 1-1; two of $R_{3a}$ to $R_{3c}$ are each a group represented by Formula 1-1, three of $R_{5a}$ to Rse are each a group represented by Formula 1-1 and one of $R_{5f}$ to $R_{5j}$ is a group represented by Formula 1-1; two of $R_{3a}$ to $R_{3c}$ are each a group represented by Formula 1-1, two of $R_{5a}$ to Rse are each a group represented by Formula 1-1 and two of $R_{5f}$ to $R_{5j}$ are each a group represented by Formula 1-1; two of $R_{3a}$ to $R_{3c}$ are each a group represented by Formula 1-1, one of $R_{5a}$ to $R_{5e}$ is a group represented by Formula 1-1 and three of $R_{5f}$ to $R_{5j}$ are each a group represented by Formula 1-1; two of $R_{3a}$ to $R_{3c}$ are each a group represented by Formula 1-1 and four of $R_{5f}$ to $R_{5j}$ are each a group represented by Formula 1-1; one of $R_{3a}$ to $R_{3c}$ is a group represented by Formula 1-1 and $R_{5a}$ to Rse are each a group represented by Formula 1-1; one of $R_{3a}$ to $R_{3c}$ is a group represented by Formula 1-1 and $R_{5f}$ to $R_{5j}$ are each a group represented by Formula 1-1; $R_{5a}$ to Rse are each a group represented by Formula 1-1 and one of $R_{5f}$ to $R_{5j}$ is a group represented by Formula 1-1; four of $R_{5a}$ to $R_{5e}$ are each a group represented by Formula 1-1 and two of $R_{5f}$ to $R_{5j}$ are each a group represented by Formula 1-1; three of $R_{5a}$ to $R_{5e}$ are each a group represented by Formula 1-1 and three of $R_{5f}$ to $R_{5j}$ are each a group represented by Formula 1-1; two of $R_{5a}$ to $R_{5e}$ are each a group represented by Formula 1-1 and four of $R_{5f}$ to $R_{5j}$ are each a group represented by Formula 1-1; or one of $R_{5a}$ to $R_{5e}$ is a group represented by Formula 1-1 and $R_{5f}$ to $R_{5j}$ are each a group represented by Formula 1-1.

In one or more embodiments, the polycyclic compound represented by Formula 1 may be represented by one of Compounds 1 to 107:

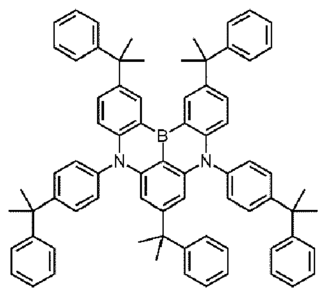

1

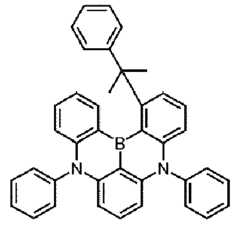

2

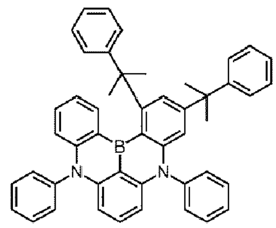

3

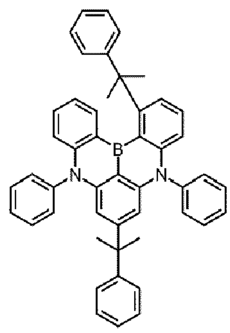

4

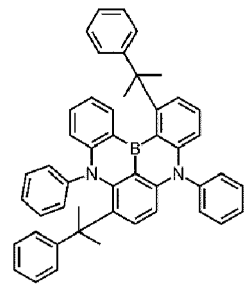

5

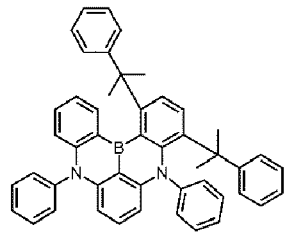

6

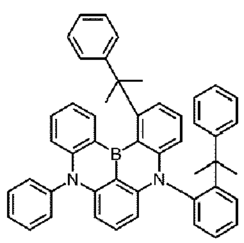

7

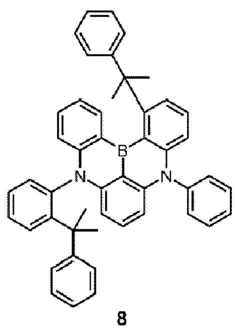

8

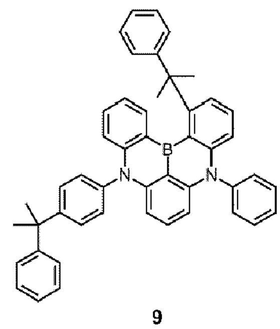

9

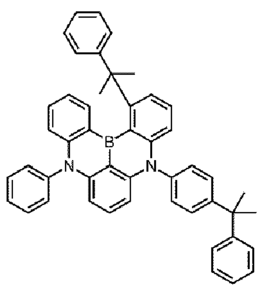

10

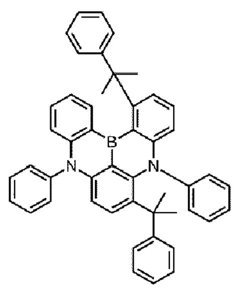

11

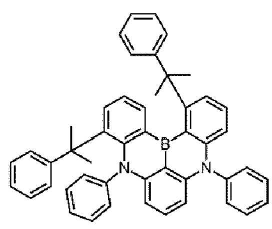

12

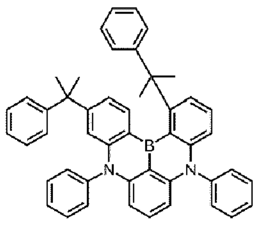

13

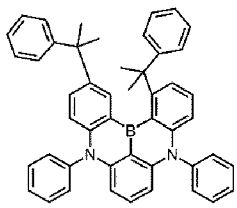

14

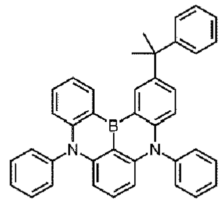

15

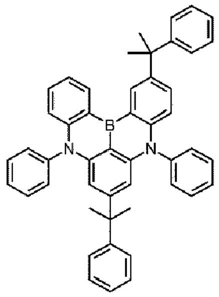

16

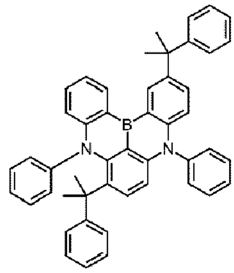

17

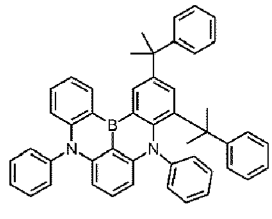

18

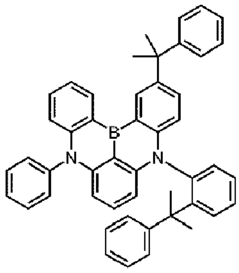

19

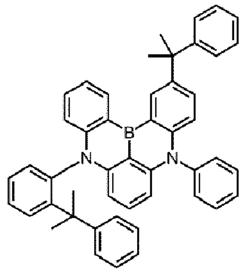

20

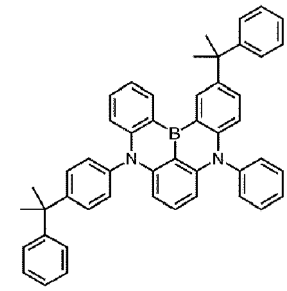

21

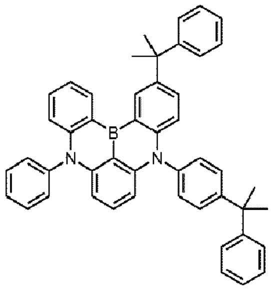

22

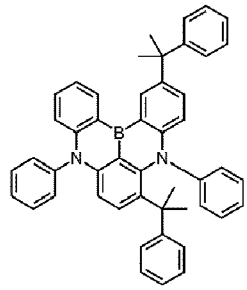

23

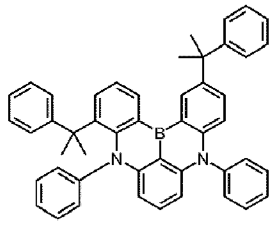

24

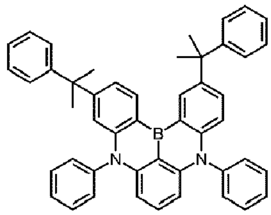

25

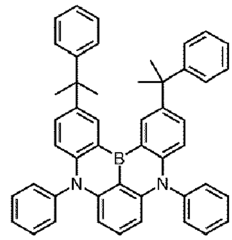

26

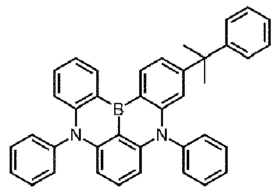

27

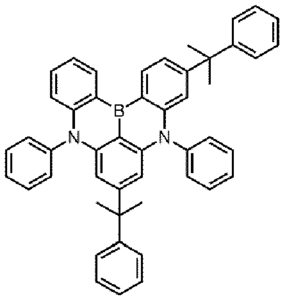

28

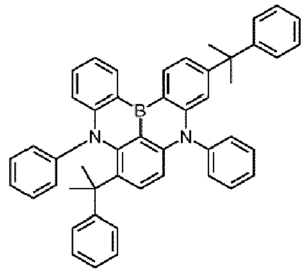

29

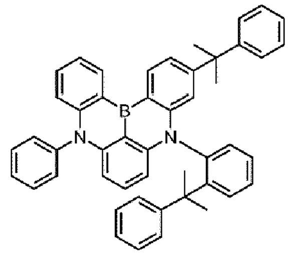

30

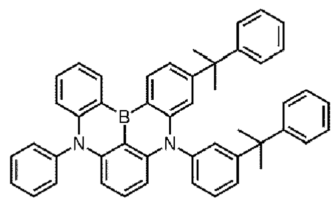

31

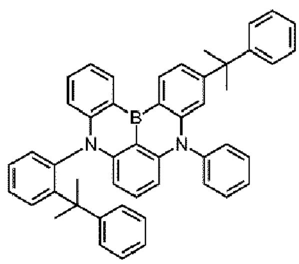

32

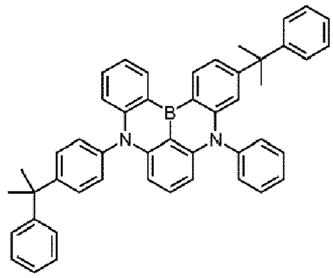

33

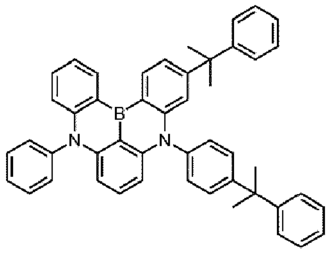

34

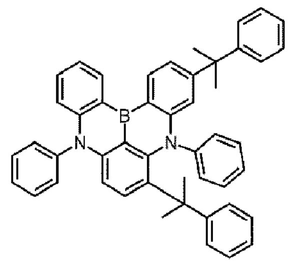

35

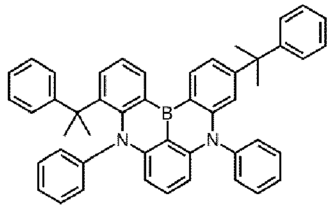

36

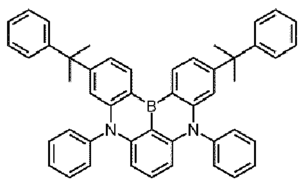

37

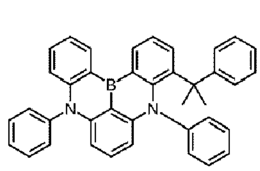

38

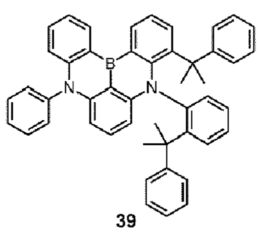

39

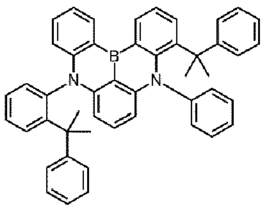

40

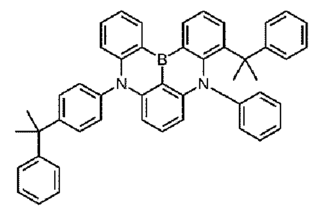

41

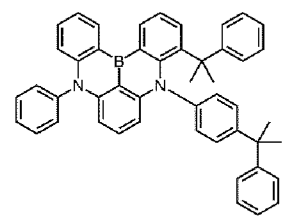

42

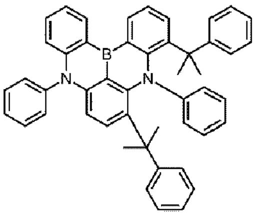

43

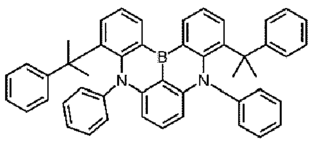

44

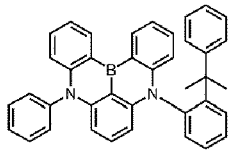

45

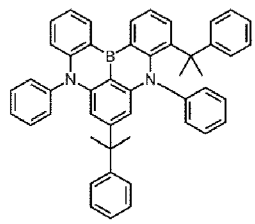

46

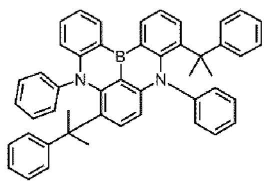

47

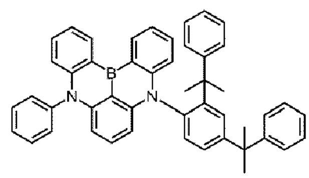

48

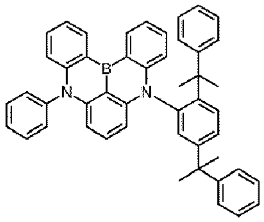

49

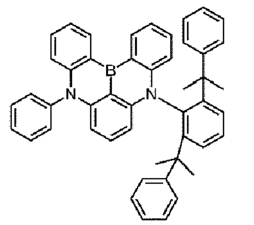

50

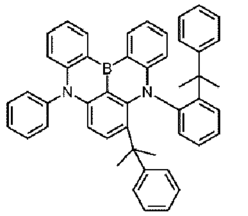

51

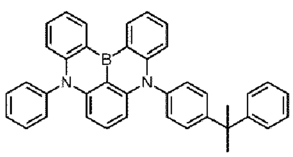

52

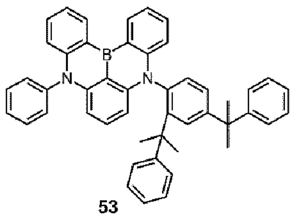

53

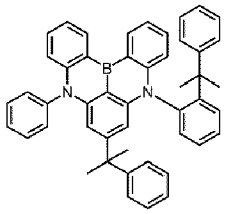

54

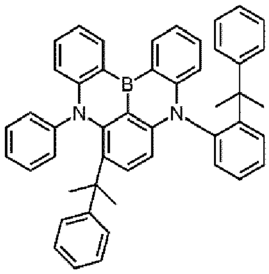

55

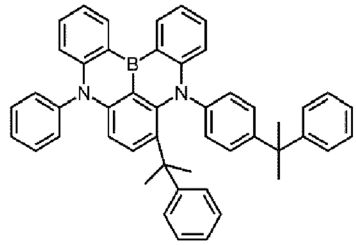

56

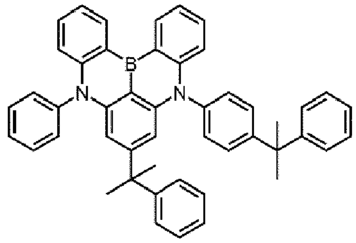

57

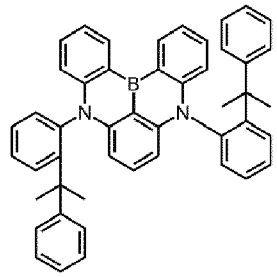

58

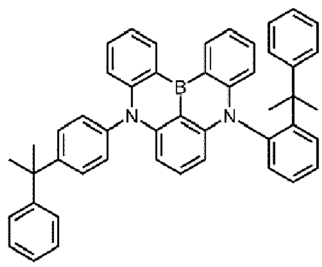

59

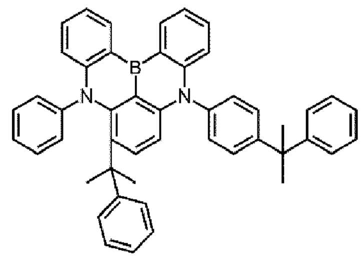

60

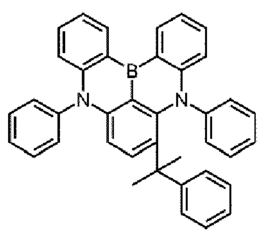

61

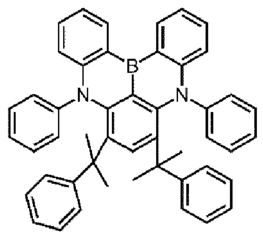

62

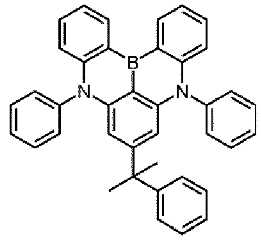

63

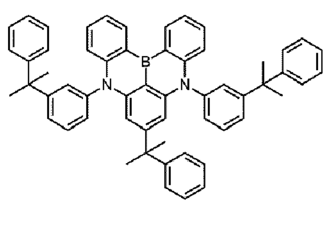

64

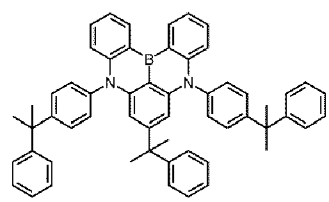

65

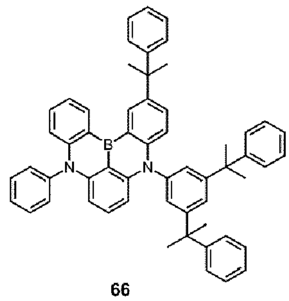

66

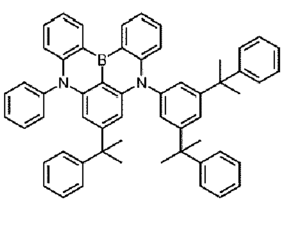

67

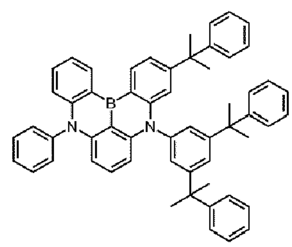

68

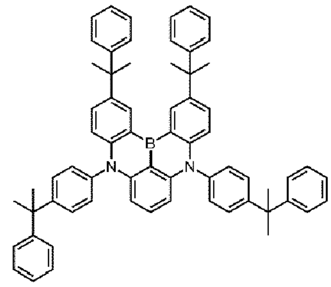

69

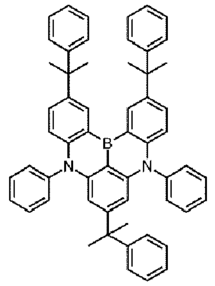

70

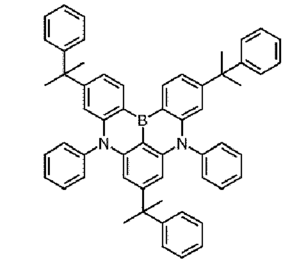

71

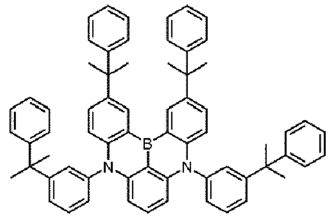

72

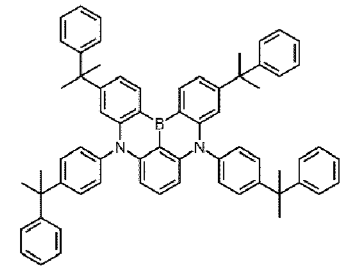

73

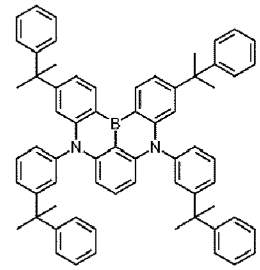

74

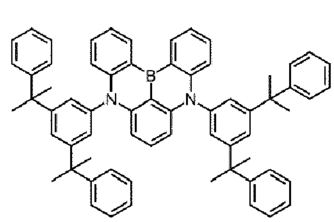

75

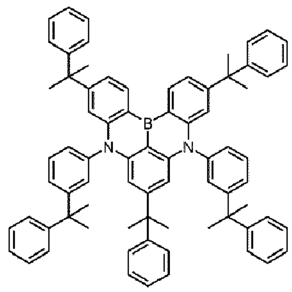

76

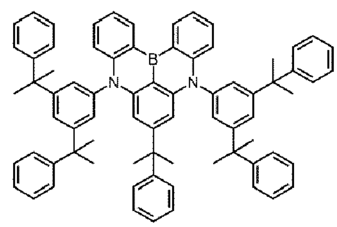

77

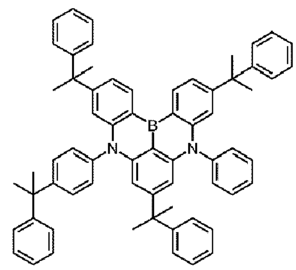

78

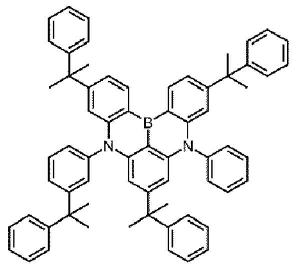

79

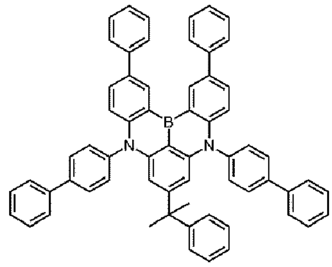

80

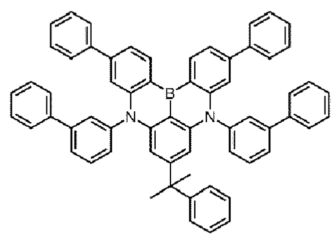

81

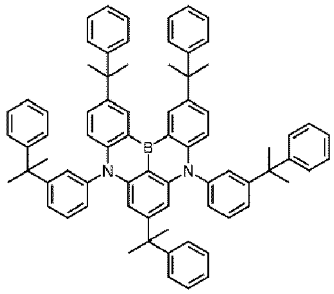

**82**

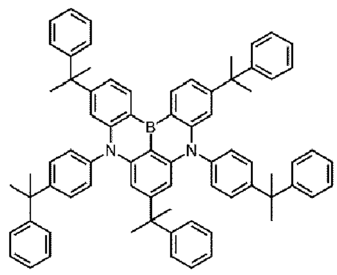

**83**

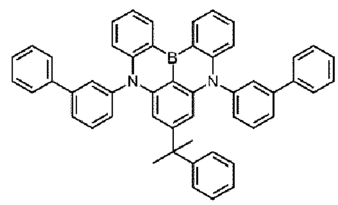

**84**

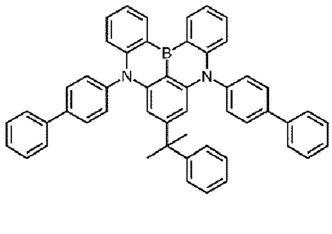

**85**

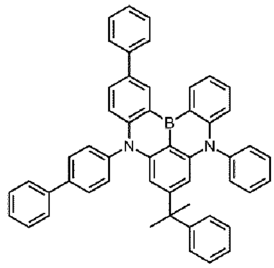

**86**

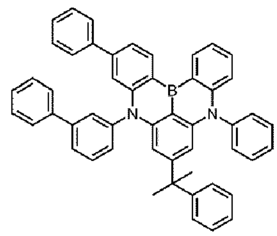

**87**

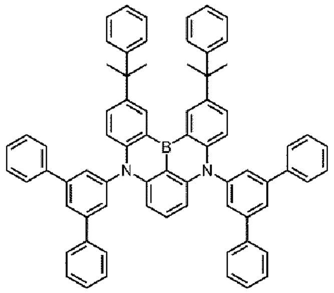

**88**

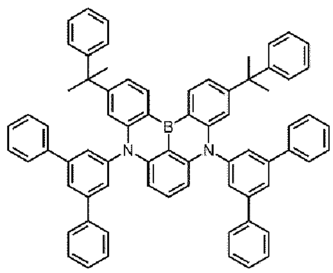

**89**

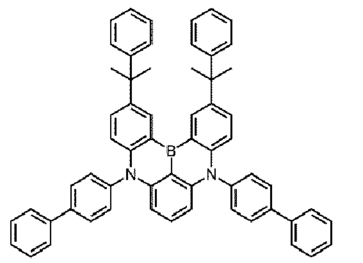

**90**

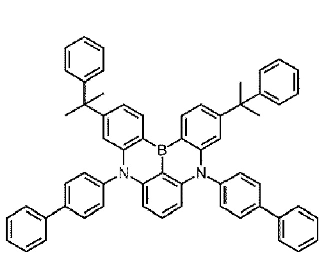

**91**

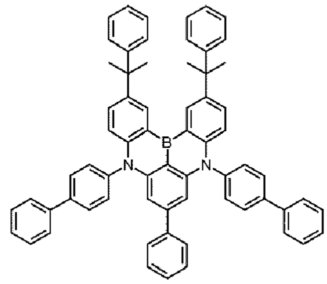

**92**

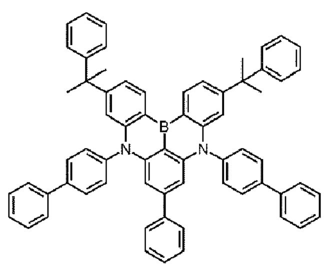

**93**

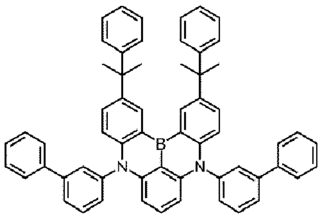

94

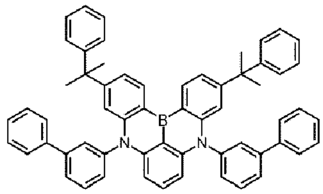

95

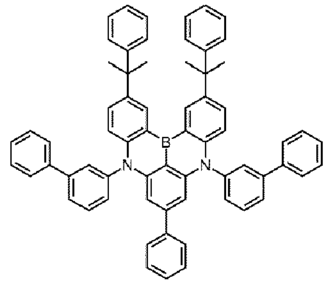

96

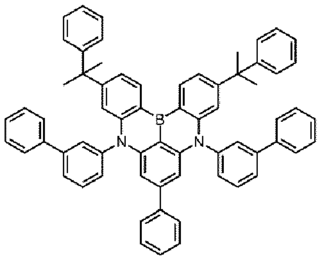

97

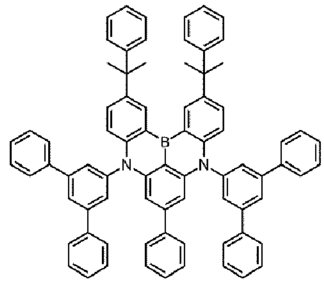

98

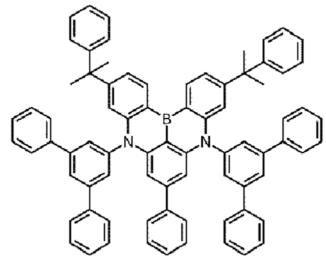

99

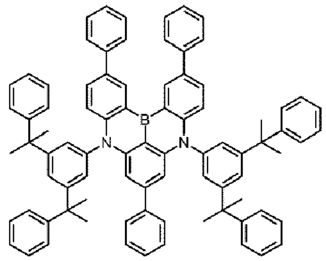

100

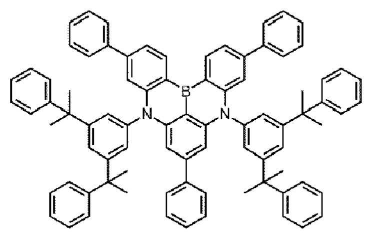

101

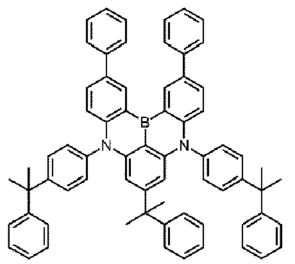

102

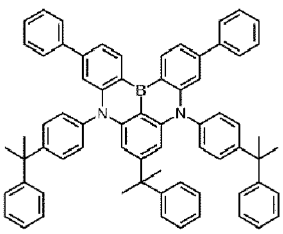

103

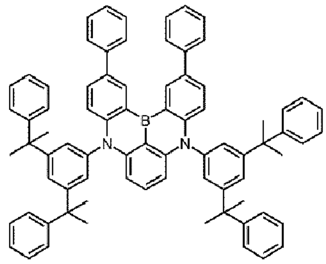

104

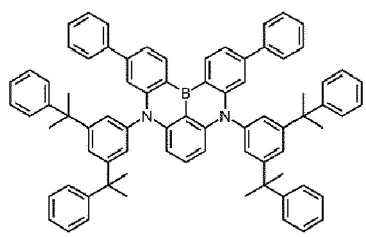

105

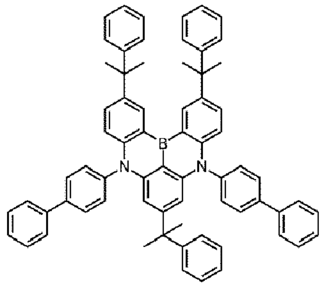

106

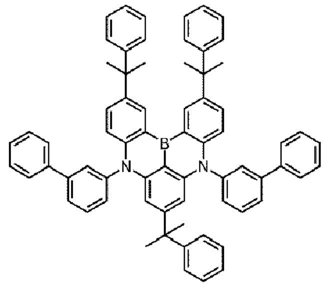

107

Since the condensed ring core of the polycyclic compound represented by Formula 1 is substituted with at least one group represented by Formula 1-1, an organic light-emitting device including the polycyclic compound may have high luminescence efficiency and high color purity at the same time.

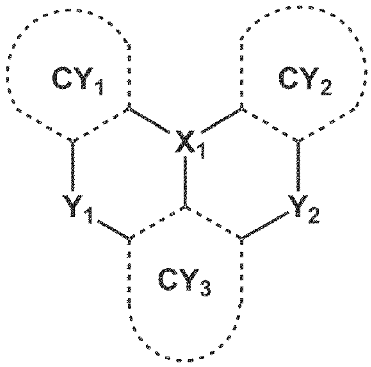

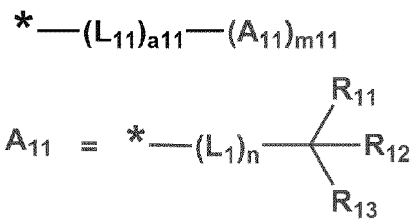

**Core** **Substituent**

In the related art, a bulky alkyl group having a non-conjugated structure was introduced into the condensed ring core in order to improve efficiency among the luminescence characteristics of the core. However, as the energy difference between excited $S_1$ and excited $T_1$ increases and the energy overlap range decreases, the frequency of occurrence of reverse intersystem crossing decreases, and as a result, the efficiency decreases.

However, in the case of the compound represented by Formula 1, an arylalkyl group represented by Formula 1-1 wherein A is represented by Formula 1-2 and at least one of $R_{11}$ to $R_{13}$ is a substituted or unsubstituted $C_6$-$C_{60}$ aryl group, is introduced to a condensed ring core of the related art. Accordingly, the energy difference between excited $S_1$ and excited $T_1$ decreases and the energy overlap range increases, and thus, the reverse intersystem crossing from $T_1$ to $S_1$ easily occurs, and thus, the efficiency increases.

The highest occupied molecular orbital (HOMO) energy level, lowest unoccupied molecular orbital (LUMO) energy level, $S_1$ energy level, and $T_1$ energy level (in electron volts, eV) of some of the polycyclic compounds represented by Formula 1 were evaluated using the Gaussian 09 program with the molecular structure optimization obtained by B3LYP-based density functional theory (DFT), and results thereof are shown in Table 1.

Table 1

| Compound No. | HOMO (eV) | LUMO (eV) | $S_1$ (eV) | $T_1$ (eV) |
|---|---|---|---|---|
| Compound 1 | -4.605 | -1.032 | 3.042 | 2.576 |
| Compound 2 | -4.904 | -1.234 | 3.146 | 2.660 |
| Compound 3 | -4.873 | -1.247 | 3.109 | 2.617 |
| Compound 4 | -4.799 | -1.191 | 3.087 | 2.609 |
| Compound 5 | -4.701 | -1.059 | 3.107 | 2.634 |
| Compound 6 | -4.673 | -1.070 | 3.075 | 2.594 |

From Table 1, it is confirmed that the polycyclic compound represented by Formula 1 has such electric characteristics that are suitable for use as a light-emitting dopant for an electronic device, for example, an organic light-emitting device.

Synthesis method of the polycyclic compound represented by Formula 1 may be recognized by those skilled in the art with reference to the following Synthesis Examples.

The polycyclic compound represented by Formula 1 is suitable for use in an organic layer of an organic light-emitting device, for example, for use as a dopant in an emission layer of the organic layer. Thus, another aspect provides an organic light-emitting device that includes: a first electrode; a second electrode; and an organic layer that is located between the first electrode and the second electrode and includes an emission layer, wherein the organic layer includes at least one polycyclic compound represented by Formula 1.

In one or more embodiments, the polycyclic compound may be included in the emission layer.

In one or more embodiments, the emission layer may further include a host, and the polycyclic compound may

be a light-emitting dopant. In this regard, the amount of host in the emission layer may be greater than the amount of the polycyclic compound.

In one or more embodiments, the emission layer may further include a host and a light-emitting dopant, and the polycyclic compound may be a sensitizer. In this regard, the amount of host in the emission layer may be greater than the total amount of the light-emitting dopant and the sensitizer. The host will be described in detail.

The organic light-emitting device includes an organic layer including the polycyclic compound represented by Formula 1 as described above. Accordingly, such an organic light-emitting device may have low driving voltage, high efficiency, high power, high quantum efficiency, long lifespan, a low roll-off ratio, and excellent color purity.

A polycyclic compound represented by Formula 1 may be used between a pair of electrodes in an organic light-emitting device. In one or more embodiments, polycyclic compound represented by Formula 1 may be included in the emission layer. In this regard, the polycyclic compound acts as a light-emitting dopant or a sensitizer, and the emission layer may further include a host (that is, the amount of polycyclic compound represented by Formula 1 may be smaller than the amount of the host). The emission layer may emit blue light, for example, blue light having the maximum emission wavelength of 450 nm or more (for example, 450 nm or more and 500 nm or less).

The expression "(an organic layer) includes at least one polycyclic compound" as used herein may include a case in which "(an organic layer) includes identical polycyclic compounds represented by Formula 1" and a case in which "(an organic layer) includes two or more different polycyclic compounds represented by Formula 1".

For example, the organic layer may include, as the polycyclic compound, only Compound 1. In this embodiment, Compound 1 may be included in the emission layer of the organic light-emitting device. In one or more embodiments, the organic layer may include, as the polycyclic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer may further include a hole transport region between the first electrode and the emission layer and an electron transport region between the emission layer and the second electrode, and the hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "organic layer" used herein refers to a single layer and/or a plurality of layers between the first electrode and the second electrode of the organic light-emitting device. The "organic layer" may include, in addition to an organic compound, an organometallic complex including metal.

The term "sensitizer" refers to a compound that is included in an organic layer (for example, an emission layer) and may deliver excitation energy to a light-emitting dopant compound.

OLED system

The organic light-emitting device according to one or more embodiments may include an emission layer including a host and a light-emitting dopant. The amount of the host in the emission layer may be greater than the amount of the light-emitting dopant.

The host may include one or more compounds that is a fluorescent host or a phosphorescent host which will be described later. When the host includes two or more mixed hosts, the mixed host may form an exciplex host.

The host will be described in detail later.

The light-emitting dopant may include the polycyclic compound represented by Formula 1.

An organic light-emitting device according to another embodiment of the present disclosure may include an emission layer including a host, a sensitizer, and a light-emitting dopant. The amount of the host in the emission layer may be greater than the total amount of the light-emitting dopant and the sensitizer.

The host will be described in detail later.

At least one of the sensitizer and the light-emitting dopant may include the polycyclic compound represented by Formula 1.

In one or more embodiments, the sensitizer may include the polycyclic compound represented by Formula 1. In one or more embodiments, the sensitizer may include a compound having an energy relationship suitable to transfer the excited singlet energy and/or excited triplet energy to the light-emitting dopant, in relation to the light-emitting dopant.

In one or more embodiments, the sensitizer may include the polycyclic compound represented by Formula 1, and the light-emitting dopant may be a phosphorescent dopant.

The singlet excitons and triplet excitons of the polycyclic compound may be respectively delivered to the excited

singlet and triplet energy levels of the phosphorescent dopant through Forster Resonance Energy Transfer (FRET) and a Dexter Energy Transfer (DET) mechanism, and the triplet excitons of the phosphorescent dopant exhibit phosphorescent emission.

In one or more embodiments, the sensitizer may include the polycyclic compound represented by Formula 1, and the light-emitting dopant may include a thermally activate delayed fluorescence (TADF) compound.

The singlet excitons and triplet excitons of the polycyclic compound may be respectively delivered to the excited singlet and excited triplet energy levels of the TADF compound through a FRET mechanism and a DET mechanism, and triplet excitons in the TADF compound may be converted to singlet excitons by reverse inter system crossing (RISC), and accumulated singlet excitons may be sequentially transitioned to a ground state, exhibiting fluorescence.

In one or more embodiments, the sensitizer includes the polycyclic compound represented by Formula 1, wherein the polycyclic compound may be a TADF compound, and the light-emitting dopant may include a phosphorescent dopant or a TADF compound.

In the TADF polycyclic compound, triplet excitons within the polycyclic compound are converted into singlet excitons by RISC, and at the same time, energy transfer to the light-emitting dopant by FRET and DET mechanisms may occur.

Without wishing to be bound to theory, since the sensitizer contains the polycyclic compound represented by Formula 1, the triplet-triplet annihilation of the triplet excitons may be suppressed and the luminescence efficiency of the light-emitting dopant may be improved.

In one or more embodiments, the light-emitting dopant includes the polycyclic compound represented by Formula 1, and the sensitizer may include a TADF compound or an organometallic compound. However, embodiments of the present disclosure are not limited thereto. Any compound that can transmit excitons to a polycyclic compound may be included.

The excitons formed in the sensitizer are transferred to a light-emitting dopant compound through a DET mechanism or a FRET mechanism, and the excitons energy transferred to the light-emitting dopant compound may be transitioned to a ground state, emitting light.

In this regard, the excitons of the sensitizer may be formed by the FRET mechanism from the host compound, or by the delivery of excitons generated from the host by the DET mechanism.

In one or more embodiments, the sensitizer may be a TADF compound.

In addition, the sensitizer may satisfy Equation 1:

Equation 1

$$\Delta E_{ST} \leq 0.3 \text{ eV}$$

In this regard, $\Delta E_{ST}$ refers to the energy difference between the lowest excited singlet ($S_1$) and the lowest excited triplet ($T_1$).

The TADF compound includes singlet excitons and triplet excitons, and energy of triplet excitons can be transferred to singlet excitons by RISC, and the singlet excitons accumulated in the singlet of the sensitizer may be energy-transitioned to the polycyclic compound by FRET and/or DET.

In one or more embodiments, the sensitizer may be an organometallic compound. In one or more embodiments, the sensitizer may be an organometallic compound including Pt as a central metal, but embodiments of the present disclosure are not limited thereto.

The organometallic compound includes singlet excitons and triplet excitons, and in the case of triplet excitons, energy can be transferred to the excited triplet energy of the polycyclic compound by the DET mechanism.

The organometallic compound may satisfy Equation 1 above, and when Equation 1 is satisfied, excitons may be delivered to the excited singlet and excited triplet energy levels of the polycyclic compound by a mechanism similar to the mechanism applied to the TADF compound, that is, the FRET and/or DET mechanism.

In one or more embodiments, the excited singlet energy level and the excited triplet energy level of the sensitizer may be lower than the excited singlet energy and excited triplet energy of the host. Therefore, excited singlet and triplet energy transfer from the host to the sensitizer may easily occur.

In one or more embodiments, the sensitizer and the light-emitting dopant may each independently have the polycyclic compound represented by Formula 1.

As a result, energy transfer between the sensitizer and the light-emitting dopant is facilitated by FRET and DET mechanisms, and it is easy to manufacture a high-efficiency organic light-emitting device by suppressing triplet-triplet annihilation.

In general, it is known that since triplet excitons stay long in an excited state, they influence the decrease in the lifespan of organic light-emitting devices. However, according to the present disclosure, due to the use of the polycyclic

compound, the time during which the sensitizer stays in the triplet excitons is reduced, and thus, the lifespan of an organic light-emitting device including the same may be prolonged.

In one or more embodiments, the polycyclic compound is a material capable of emitting fluorescent light. An emission layer emitting the fluorescent light is clearly distinguished from an emission layer of the related art that emits phosphorescent light.

In one or more embodiments, the polycyclic compound may emit TADF light.

The excited singlet and excited triplet energy levels of the polycyclic compound may be lower than the excited singlet and excited triplet energy levels of the host compound described later. Accordingly, singlet excitons and/or triplet excitons are easily transitioned from the host compound to the polycyclic compound.

The polycyclic compound may receive singlet excitons and/or triplet excitons from the sensitizer.

In one or more embodiments, when the sensitizer is a TADF compound, the excited singlet energy level of the polycyclic compound is lower than the excited singlet energy level of the sensitizer, and the polycyclic compound may receive singlet excitons from the excited singlet of the sensitizer by the FRET and/or DET mechanism.

In one or more embodiments, when the sensitizer is an organometallic compound, the excited triplet energy level of the polycyclic compound is lower than the excited triplet level of the sensitizer, and the polycyclic compound may receive triplet excitons from the sensitizer by DET mechanism.

When the sensitizer is a TADF compound or an organometallic compound, the polycyclic compound may further receive singlet excitons and/or triplet excitons from the host, and the triplet excitons received from the host may be transitioned to singlet energy of the polycyclic compound by RISC.

Due to this mechanism, triplet-triplet annihilation may be suppressed by reducing the time during which excitons stay in the excited triplet energy of the polycyclic compound, and high-efficiency fluorescent light emission is realized through the transition of multiple singlet excitons to the ground state.

The amount of the sensitizer in the emission layer may be from about 5 wt% to about 50 wt% on the basis of weight of the emission layer. Within these ranges, it is possible to achieve effective energy transfer in the emission layer, and accordingly, an organic light-emitting device having high efficiency and long lifespan can be obtained.

In one or more embodiments, the host, the polycyclic compound, and the sensitizer may satisfy Equation 2:

Equation 2

$$[T_1(H)/S_1(H)] \geq [T_1(S)/S_1(S)] \geq [T_1(PC)/S_1(PC)]$$

wherein, in Equation 2,

$T_1(H)$ is a lowest excited triplet energy level of the host;
$S_1(H)$ is a lowest excited singlet energy level of the host;
$T_1(PC)$ is a lowest excited triplet energy level of the polycyclic compound;
$S_1(PC)$ is a lowest excited singlet energy level of the polycyclic compound;
$T_1(S)$ is a lowest excited triplet energy level of the sensitizer; and
$S_1(S)$ is a lowest excited singlet energy level of the sensitizer.

When the host, the polycyclic compound, and the sensitizer further satisfy Equation 2, triplet excitons may be effectively transferred from the host to the polycyclic compound, thereby obtaining an organic light-emitting device with improved efficiency.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

Description of FIG. 1

FIG. 1 is a schematic cross-sectional view of an organic light-emitting device 10 according to one or more embodiments. Hereinafter, the structure of an organic light-emitting device according to an exemplary embodiment of the present disclosure and an exemplary method of manufacturing an organic light-emitting device according to one or more embodiments of the present disclosure will be described in connection with FIG. 1.

The organic light-emitting device 10 of FIG. 1 includes a first electrode 11, a second electrode 19 facing the first electrode 11, and an organic layer 10A located between the first electrode 11 and the second electrode 19.

The organic layer 10A includes an emission layer 15, a hole transport region 12 may be located between the first electrode 11 and the emission layer 15, and an electron transport region 17 may be located between the emission

layer 15 and the second electrodes 19.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

First electrode 11

In one or more embodiments, the first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 10A is located on the first electrode 11.

The organic layer 10A may include a hole transport region 12, an emission layer 15, and an electron transport region 17.

Hole transport region 12

The hole transport region 12 may be located between the first electrode 11 and the emission layer 15 of the organic light-emitting device 10.

The hole transport region 12 may have a single-layered structure or a multi-layered structure.

For example, the hole transport region 12 may have a hole injection layer, a hole transport layer, a hole injection layer/hole transport layer structure, a hole injection layer/first hole transport layer/second hole transport layer structure, a hole transport layer/middle layer structure, a hole injection layer/hole transport layer/middle layer structure, a hole transport layer/electron blocking layer structure, or a hole injection layer/hole transport layer/electron blocking layer structure, but embodiments of the present disclosure are not limited thereto.

The hole transport region 12 may include any compound having hole transport properties.

For example, the hole transport region 12 may include an amine compound.

In one or more embodiments, the hole transport region 1 may include at least one amine compound represented by one Formula 201 to Formula 205, but embodiments of the present disclosure are not limited thereto:

Formula 201

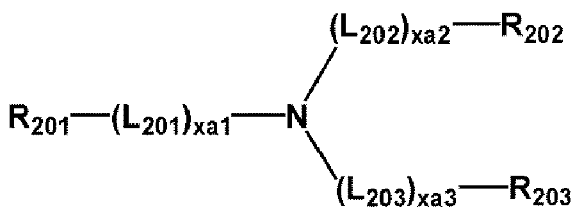

Formula 202

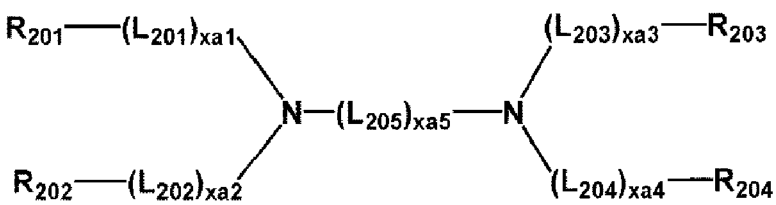

Formula 203

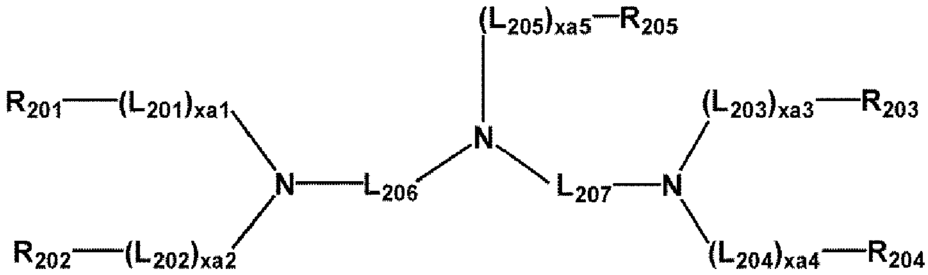

Formula 204

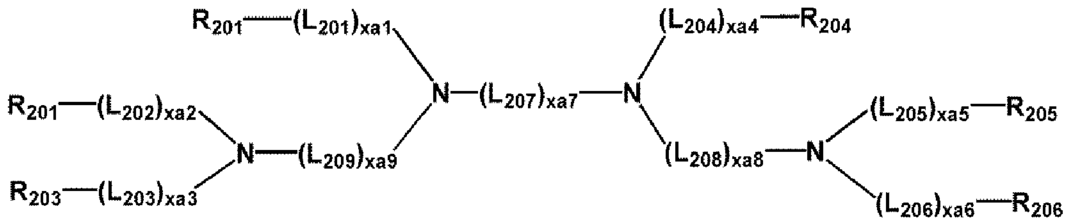

Formula 205

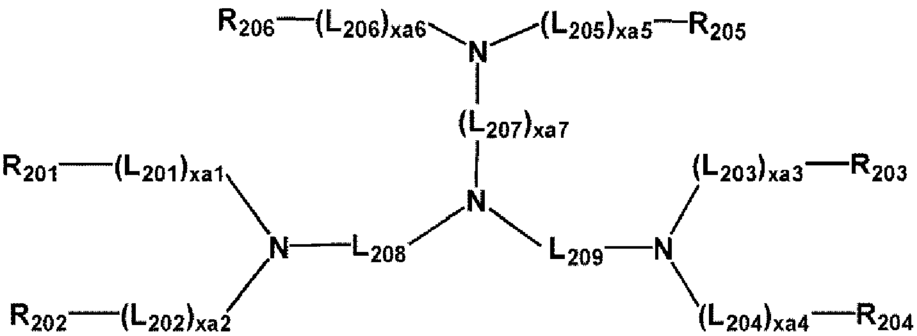

wherein, in Formulae 201 to 205,

$L_{201}$ to $L_{209}$ may each independently *-be O-*', *-S-*', a substituted or unsubstituted $C_5$-$C_{60}$ carbocyclic group, or a substituted or unsubstituted $C_1$-$C_{60}$ heterocyclic group,
xa1 to xa9 may each independently be an integer from 0 to 5, and
$R_{201}$ to $R_{206}$ may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, or a substituted or unsubstituted monovalent non-aromatic condensed heteropolycyclic group, wherein two adjacent groups of $R_{201}$ to $R_{206}$ may optionally be linked to each other via a single bond, a dimethyl-methylene group, or a diphenyl-methylene group.

For example, in one or more embodiments,

$L_{201}$ to $L_{209}$ may each independently be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene

group, a perylene group, a pentacene group, a hexacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group, each unsubstituted or substituted with deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a quaterphenyl group, or -Si($Q_{11}$)($Q_{12}$)($Q_{13}$),

xa1 to xa9 may each independently be 0, 1, or 2,

$R_{201}$ to $R_{206}$ may each independently be a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an indeno carbazolyl group, an indolocarbazolyl group, a benzofurocarbazolyl group, or a benzothienocarbazolyl group, each unsubstituted or substituted with at least one of deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si($Q_{31}$)($Q_{32}$)($Q_{33}$), or -N($Q_{31}$)($Q_{32}$), or

$Q_{11}$ to $Q_{13}$ and $Q_{31}$ to $Q_{33}$ may each independently be a $C_1$-$C_{10}$ alkyl group, a $C_1$-$C_{10}$ alkoxy group, a phenyl group, a biphenyl group, a terphenyl group, or a naphthyl group.

In one or more embodiments, the amine compound of the hole transport region 12 may include a carbazole-containing amine compound.

In one or more embodiments, the hole transport region 12 may include a carbazole-containing amine compound and a carbazole-free amine compound.

The carbazole-containing amine compound may be , for example, a compound represented by Formula 201 including a carbazole group and further including at least one of a dibenzofuran group, a dibenzothiophene group, a fluorene group, a spiro-bifluorene group, an indenocarbazole group, an indolocarbazole group, a benzofurocarbazole group, or a benzothienocarbazole group.

The carbazole-free amine compound may be, for example, a compound represented by Formula 201 that does not include a carbazole group and that includes at least one of a dibenzofuran group, a dibenzothiophene group, a fluorene group, a spiro-bifluorene group, an indenocarbazole group, an indolocarbazole group, a benzofurocarbazole group, or a benzothienocarbazole group.

In one or more embodiments, the hole transport region 12 may include at least one compound represented by Formulae 201 or 202.

In one or more embodiments, the hole transport region 12 may include at least one of the compounds represented by Formulae 201-1, 202-1 and 201-2, but embodiments of the present disclosure are not limited thereto:

Formula 201-1

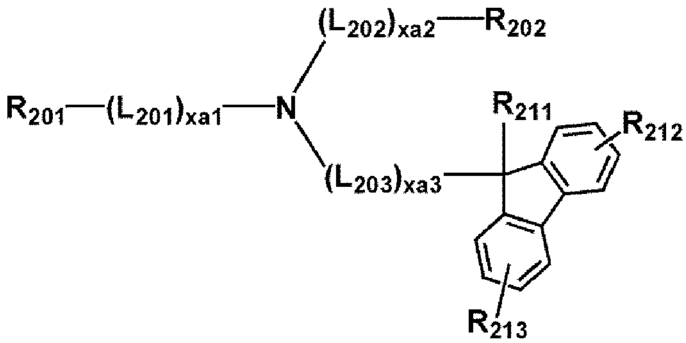

Formula 202-1

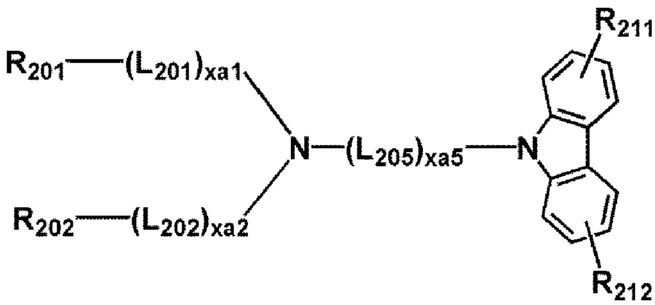

Formula 201-2

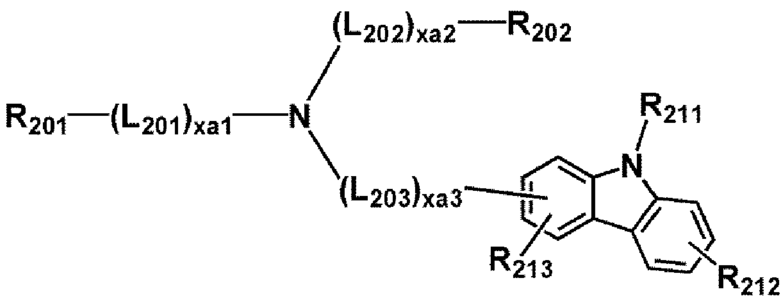

In Formulae 201-1, 202-1, and 201-2, $L_{201}$ to $L_{203}$, $L_{205}$, xa1 to xa3, xa5, $R_{201}$ and $R_{202}$ are the same as described herein, and $R_{211}$ to $R_{213}$ are each independently hydrogen, deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a dimethylfluorenyl group, a diphenylfluorenyl group, a triphenylenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, or a pyridinyl group.

For example, the hole transport region 12 may include at least one of Compounds HT1 to HT39, but embodiments of the present disclosure are not limited thereto.

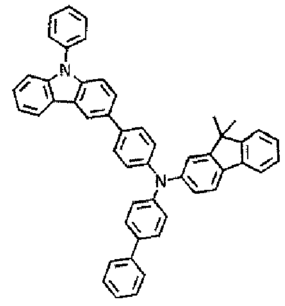

HT1

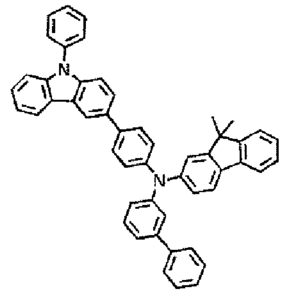

HT2

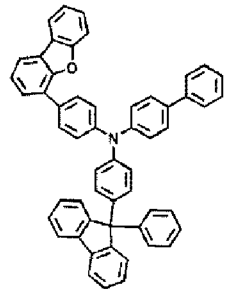

HT3

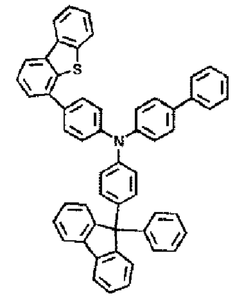

HT4

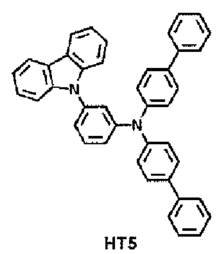

HT5

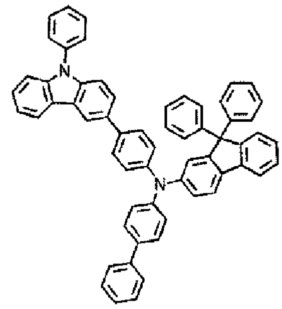

HT6

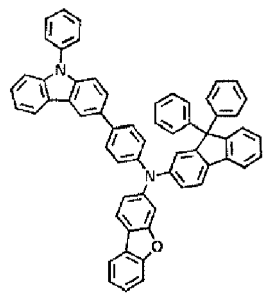

HT7

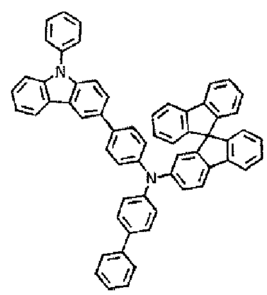

HT8

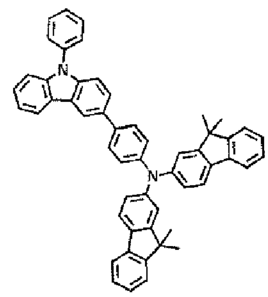

HT9

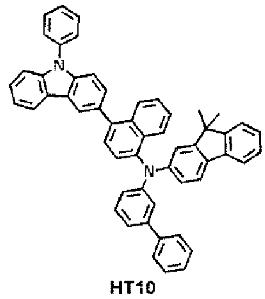

HT10

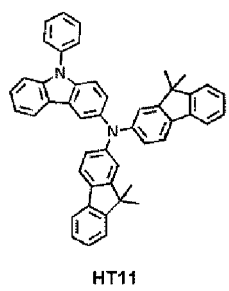

HT11

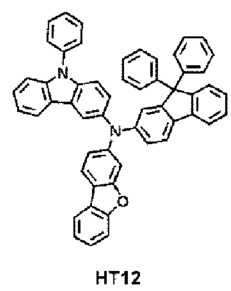

HT12

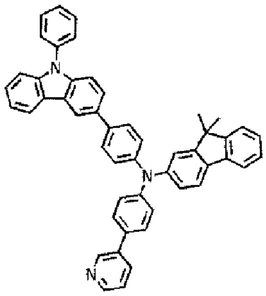
HT13

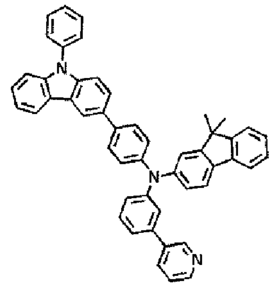
HT14

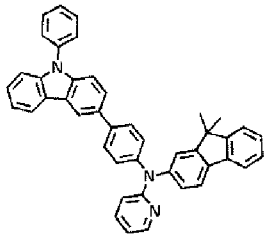
HT15

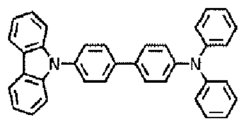
HT16

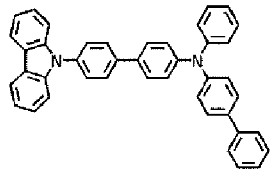
HT17

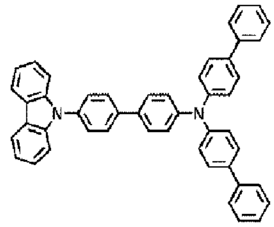
HT18

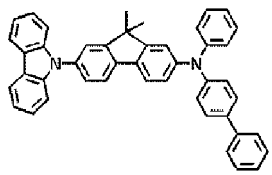
HT19

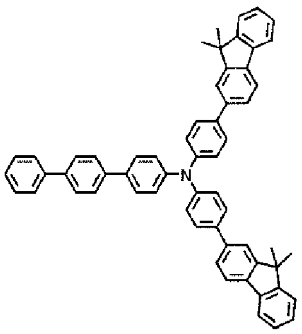
HT20

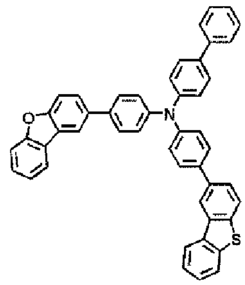
HT21

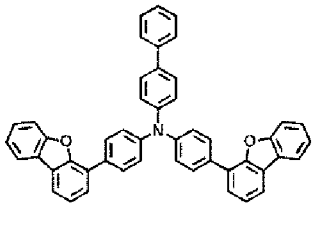
HT22

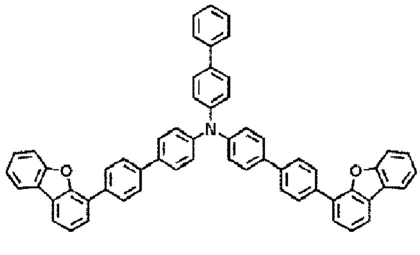
HT23

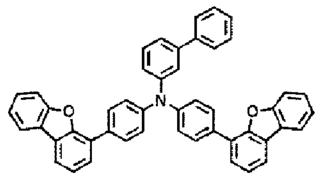
HT24

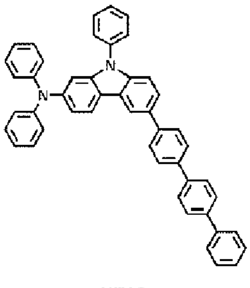
HT25

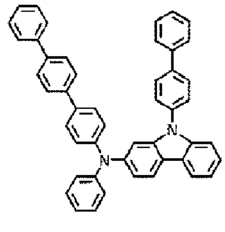
HT26

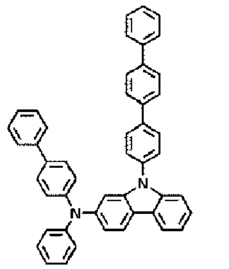
HT27

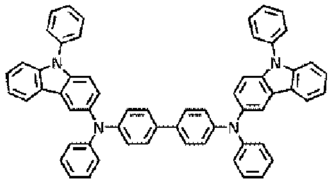

HT28

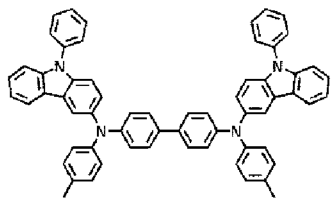

HT29

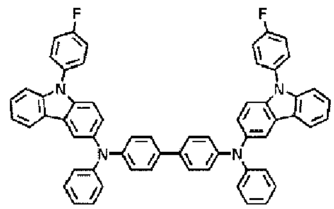

HT30

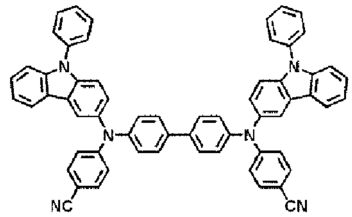

HT31

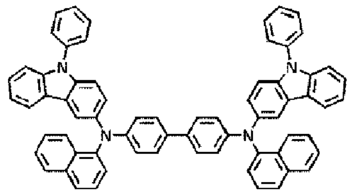

HT32

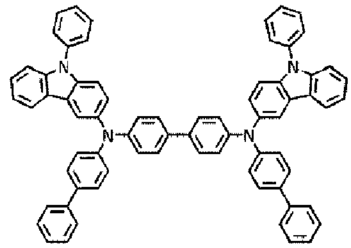

HT33

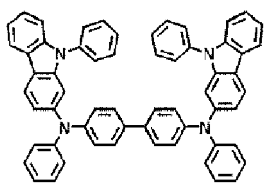

HT34

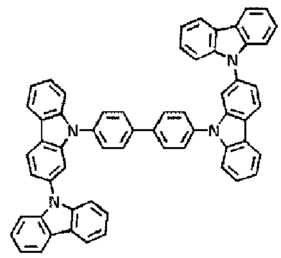

HT35

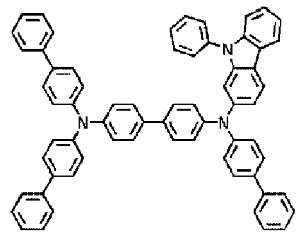

HT36

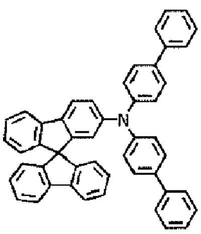

HT37

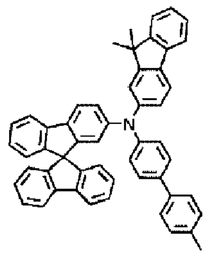

HT38

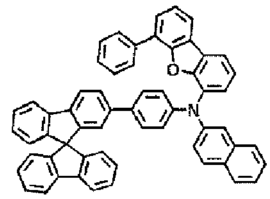

HT39

In one or more embodiments, hole transport region 12 of the organic light-emitting device 10 may further include a p-dopant. When the hole transport region 12 further includes a p-dopant, the hole transport region 12 may have a matrix, for example, at least one of compounds represented by Formulae 201 to 205, and a p-dopant included in the matrix. The p-dopant may be uniformly or non-uniformly doped in the hole transport region 12.

In one or more embodiments, the LUMO energy level of the p-dopant may be -3.5 electron volts (eV) or less.

The p-dopant may include at least one of a quinone derivative, a metal oxide, or a cyano group-containing compound, but embodiments of the present disclosure are not limited thereto.

In one or more embodiments, the p-dopant may include at least one of:

a quinone derivative, such as tetracyanoquinodimethane (TCNQ),2,3,5,6-tetrafluoro-7,7,8,8-tetracyanoquinodimethane (F4-TCNQ), or F6-TCNNQ;

a metal oxide, such as tungsten oxide or molybdenum oxide;

1,4,5,8,9,12-hexaazatriphenylene-hexacarbonitrile (HAT-CN); or

a compound represented by Formula 221 below, but embodiments of the present disclosure are not limited thereto:

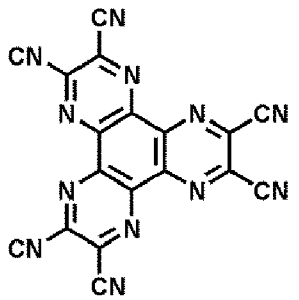

HAT-CN

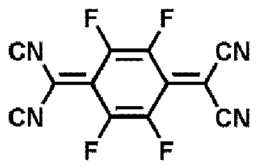

F4-TCNQ

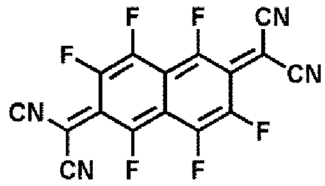

F6-TCNNQ

Formula 221

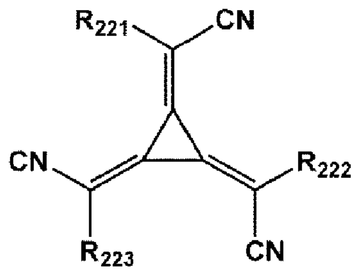

In Formula 221,

$R_{221}$ to $R_{223}$ may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group, and at least one of $R_{221}$ to $R_{223}$ may have at least one substituent that is a cyano group, -F, -Cl, -Br, -I, a $C_1$-$C_{20}$ alkyl group substituted with -F, a $C_1$-$C_{20}$ alkyl group substituted with -Cl, a $C_1$-$C_{20}$ alkyl group substituted with -Br, or a $C_1$-$C_{20}$ alkyl group substituted with -I.

The hole transport region 12 may have a thickness of about 100 Å to about 10000 Å, for example, about 400 Å to about 2000 Å, and the emission layer 15 may have a thickness of about 100 Å to about 3000 Å, for example, about 300 Å to about 1000 Å. When the thickness of each of the hole transport region 12 and the emission layer 15 is within these ranges described above, satisfactory hole transportation characteristics and/or luminescent characteristics may be obtained without a substantial increase in driving voltage.

Emission layer 15

The emission layer may further include a host, and the light-emitting dopant may include the polycyclic compound represented by Formula 1. The host may include no metal atoms.

In one or more embodiments, the host may include one kind of host. When the host includes one host, the one host may be a bipolar host, an electron transport host, or a hole transport host, which will be described later.

In one or more embodiments, the host may include a mixture of two or more different hosts. For example, the host may be a mixture of an electron transport host and a hole transport host, a mixture of two types of electron transport hosts different from each other, or a mixture of two types of hole transport hosts different from each other. The electron transport host and the hole transport host may be understood by referring to the related description to be presented later.

In one or more embodiments, the host may include an electron transport host including at least one electron transport moiety and a hole transport host that is free of an electron transport moiety.

The electron transport moiety used herein may be a cyano group, a π electron-deficient nitrogen-containing cyclic group, or a group represented by one of the following Formulae:

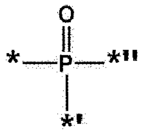 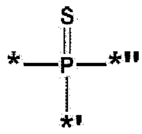 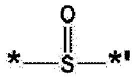 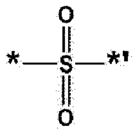

In the formulae, *, *', and *" are each binding sites to neighboring atoms.

In one or more embodiments, the electron transport host of the emission layer may include at least one of a cyano group and a π electron-deficient nitrogen-containing cyclic group.

In one or more embodiments, the electron transport host in the emission layer may include at least one cyano group.

In one or more embodiments, the electron transport host in the emission layer may include at least one cyano group and at least one π electron deficient nitrogen-containing cyclic group.

In one or more embodiments, the host may include an electron transport host and a hole transport host, wherein the electron transport host may include at least one π electron-deficient nitrogen-free cyclic group and at least one electron transport moiety, and the hole transport host may include at least one π electron-deficient nitrogen-free cyclic group and may not include an electron transport moiety.

The term "π electron-deficient nitrogen-containing cyclic group" used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group; or a condensed cyclic group in which two or more π electron- deficient nitrogen-containing cyclic groups are condensed with each other.

Meanwhile, the π electron-deficient nitrogen-free cyclic group may be a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed cyclic group of two or more π electron-deficient nitrogen-free cyclic groups, but embodiments of the present disclosure are not limited thereto.

In one or more embodiments, the electron transport host may be a compound represented by Formula E-1, and the hole transport host may be a compound represented by Formula H-1, but embodiments of the present disclosure are not limited thereto:

Formula E-1 $[Ar_{301}]_{xb11}-[(L_{301})_{xb1}-R_{301}]_{xb21}$

wherein, in Formula E-1,

$Ar_{301}$ may be a substituted or unsubstituted $C_5$-$C_{60}$ carbocyclic group or a substituted or unsubstituted $C_1$-$C_{60}$ heterocyclic group,
xb11 may be 1, 2, or 3,
$L_{301}$ may each independently be a single bond, a group represented by one of the following formula, a substituted or unsubstituted $C_5$-$C_{60}$ carbocyclic group, or a substituted or unsubstituted $C_1$-$C_{60}$ heterocyclic group, and *, *' and *" in the following formulae are each a binding site to a neighboring atom,

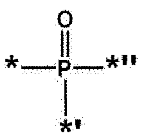 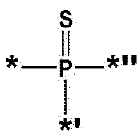 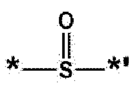 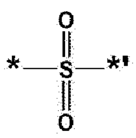

xb1 may be an integer from 1 to 5,

$R_{301}$ may be hydrogen, deuterium, -F, -Cl, -Br, -I, a hydroxyl group, a cyano group, a nitro group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-Si(Q_{301})(Q_{302})(Q_{303})$, $-N(Q_{301})(Q_{302})$, $-B(Q_{301})(Q_{302})$, $-C(=O)(Q_{301})$, $-S(=O)_2(Q_{301})$, $-S(=O)(Q_{301})$, $-P(=O)(Q_{301})(Q_{302})$, or $-P(=S)(Q_{301})(Q_{302})$,

xb21 may be an integer from 1 to 5,

$Q_{301}$ to $Q_{303}$ may each independently be a $C_1$-$C_{10}$ alkyl group, a $C_1$-$C_{10}$ alkoxy group, a phenyl group, a biphenyl group, a terphenyl group, or a naphthyl group, and

at least one of Condition 1 to Condition 3 may be satisfied:

Condition 1

$Ar_{301}$, $L_{301}$, and $R_{301}$ in Formula E-1 may each independently include a π electron-deficient nitrogen-containing cyclic group

Condition 2

$L_{301}$ in Formula E-1 is a group represented by one of the following groups:

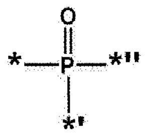
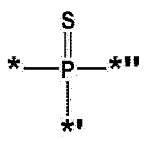
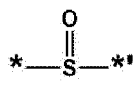
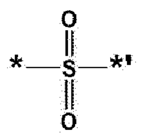

Condition 3

$R_{301}$ in Formula E-1 may be a cyano group, $-S(=O)_2(Q_{301})$, $-S(=O)(Q_{301})$, - $P(=O)(Q_{301})(Q_{302})$, or $-P(=S)(Q_{301})(Q_{302})$,

Formula H-1 $Ar_{401}$-$(L_{401})_{xd1}$-$(Ar_{402})_{xd11}$

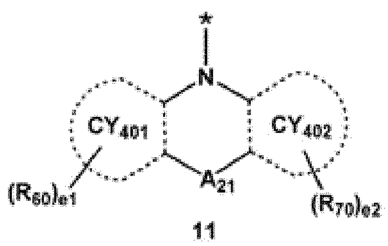

11

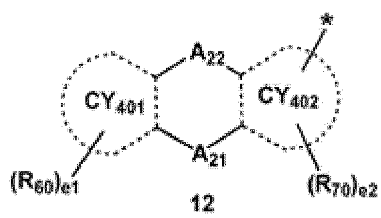

12

wherein, in Formulae H-1, 11, and 12,

$L_{401}$ may be:

a single bond; or

a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group, each unsubstituted or substituted with at least one of deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a quaterphenyl group, or - $Si(Q_{401})(Q_{402})(Q_{403})$;

xd1 may be an integer from 1 to 10, wherein when xd1 is 2 or more, two or more of $L_{401}$(s) may be identical to or different from each other,

$Ar_{401}$ may be a group represented by one of Formulae 11 or 12,

$Ar_{402}$ may be:

a group represented by one of Formula 11 or 12, a phenyl group, a naphthyl group, a fluorenyl group, a carbazolyl group, a dibenzofuranyl group, a dibenzothiophenyl group, a biphenyl group, a terphenyl group, or a triphenylenyl group; or

a phenyl group, a naphthyl group, a fluorenyl group, a carbazolyl group, a dibenzofuranyl group, a dibenzothiophenyl group, a biphenyl group, a terphenyl group, and a triphenylenyl group, each substituted with at least one of deuterium, a hydroxyl group, an amino group, an amidino group, a hydrazine group, a hydrazone group, a carboxylic acid or a salt thereof, a sulfonic acid or a salt thereof, a phosphoric acid or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, a dibenzothiophenyl group, a biphenyl group, a terphenyl group, or a triphenylenyl group;

$CY_{401}$ and $CY_{402}$ may each independently be a benzene group, a naphthalene group, a fluorene group, a carbazole group, a benzocarbazole group, an indolocarbazole group, a dibenzofuran group, a dibenzothiophene group, a dibenzosilole group, a benzonaphthofuran group, a benzonaphthothiophene group, or a benzonaphthosilole group,

xd11 may be an integer from 1 to 10, wherein when xd11 is 2 or more, two or more of $Ar_{402}$(s) may be identical to or different from each other,

$A_{21}$ may be a single bond, O, S, $N(R_{51})$, $C(R_{51})(R_{52})$, or $Si(R_{51})(R_{52})$,
$A_{22}$ may be a single bond, O, S, $N(R_{53})$, $C(R_{53})(R_{54})$, or $Si(R_{53})(R_{54})$,
at least one of $A_{21}$ and $A_{22}$ in Formula 12 may not be a single bond,
$R_{51}$ to $R_{54}$, $R_{60}$, and $R_{70}$ may each independently be:

hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a C1-$C_{20}$ alkyl group, or a $C_1$-$C_{20}$ alkoxy group;

a $C_1$-$C_{20}$ alkyl group and a $C_1$-$C_{20}$ alkoxy group, each substituted with at least one of deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, or a dibenzothiophenyl group;

a $\pi$ electron-deficient nitrogen-free cyclic group (for example, a phenyl group, a naphthyl group, a fluorenyl group, a carbazolyl group, a dibenzofuranyl group, a dibenzothiophenyl group, a biphenyl group, a terphenyl group, or a triphenylenyl group);

a $\pi$ electron-deficient nitrogen-free cyclic group (for example, a phenyl group, a naphthyl group, a fluorenyl group, a carbazolyl group, a dibenzofuranyl group, a dibenzothiophenyl group, a biphenyl group, a terphenyl group, and a triphenylenyl group), each substituted with at least one of deuterium, a hydroxyl group, an amino group, an amidino group, a hydrazine group, a hydrazone group, a carboxylic acid or a salt thereof, a sulfonic acid or a salt thereof, a phosphoric acid or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, a dibenzothiophenyl group, or a biphenyl group; or

$$-Si(Q_{404})(Q_{405})(Q_{406}),$$

e1 and e2 may each independently be an integer from 0 to 10,

$Q_{401}$ to $Q_{406}$ may each independently be hydrogen, deuterium, a hydroxyl group, an amino group, an amidino group, a hydrazine group, a hydrazone group, a carboxylic acid or a salt thereof, a sulfonic acid or a salt thereof, a phosphoric acid or a salt thereof, a phenyl group, a naphthyl group, a fluorenyl group, a carbazolyl group, a dibenzofuranyl group, a dibenzothiophenyl group, a biphenyl group, a terphenyl group, or a triphenylenyl group, and

* indicates a binding site to an adjacent atom.

In one or more embodiments, at least one of $A_{21}$ and $A_{22}$ in Formula 12 is not a single bond.

In one or more embodiments, $Ar_{301}$ and $L_{301}$ in Formula E-1 may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one of deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, - $Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or - $P(=O)(Q_{31})(Q_{32})$,

at least one of $L_{301}$(s) in the number of xb1 may each independently be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one of deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, - $C(=O)(Q_{31})$, $-S(=O)_2(Q_{31})$, or $-P(=0)(Q_{31})(Q_{32})$, and

$R_{301}$ may be hydrogen, deuterium, -F, -Cl, -Br, -I, a hydroxyl group, a cyano group, a nitro group, an amidino group, a hydrazine group, a hydrazone group, a C1-$C_{20}$ alkyl group, a $C_1$-$C_{20}$ alkoxy group, a phenyl group, a biphenyl group, a terphenyl group, a quaterphenyl group, a naphthyl group, a cyano-containing phenyl group, a cyano-containing biphenyl group, a cyano-containing terphenyl group, a cyano-containing quaterphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group,

a phenyltriazinyl group, a diphenyltriazinyl group, a biphenyltriazinyl group, a di(biphenyl)triazinyl group, -$Si(Q_{31})(Q_{32})(Q_{33})$, -$N(Q_{31})(Q_{32})$, -$B(Q_{31})(Q_{32})$, -$C(=O)(Q_{31})$, -$S(=O)_2(Q_{31})$, or - $P(=O)(Q_{31})(Q_{32})$,
wherein $Q_{31}$ to $Q_{33}$ may each independently be a $C_1$-$C_{10}$ alkyl group, a $C_1$-$C_{10}$ alkoxy group, a phenyl group, a biphenyl group, a terphenyl group, or a naphthyl group, but are not limited thereto.

In one or more embodiments,

$Ar_{301}$ may be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, or a dibenzothiophene group, each unsubstituted or substituted with at least one of deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, - $Si(Q_{31})(Q_{32})(Q_{33})$, -$N(Q_{31})(Q_{32})$, -$B(Q_{31})(Q_{32})$, -$C(=O)(Q_{31})$, -$S(=O)_2(Q_{31})$, or - $P(=O)(Q_{31})(Q_{32})$; and
$L_{301}$ may be a group represented by one of Formulae 5-1 to 5-3 or Formulae 6-1 to 6-33:

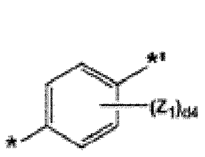
5-1
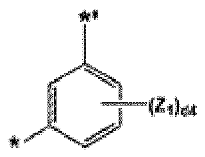
5-2
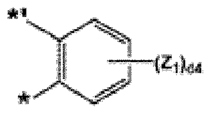
5-3

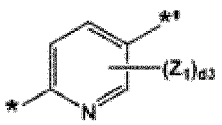
6-1
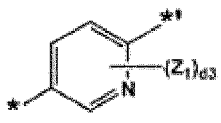
6-2
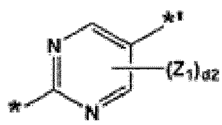
6-3
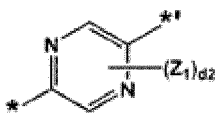
6-4

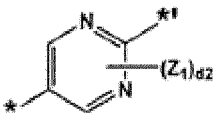
6-5
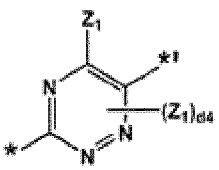
6-6
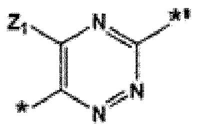
6-7
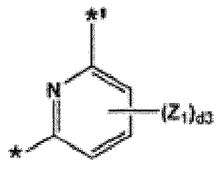
6-8

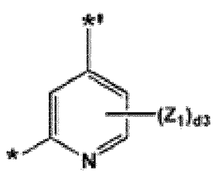
6-9
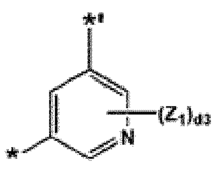
6-10
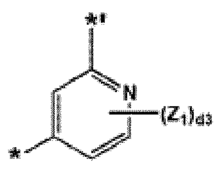
6-11
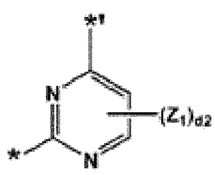
6-12

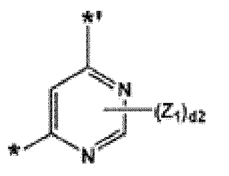
6-13
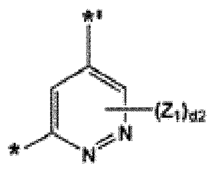
6-14
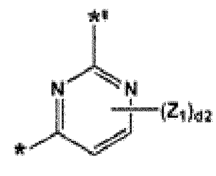
6-15
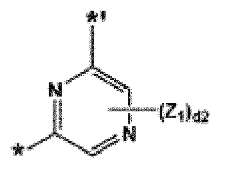
6-16

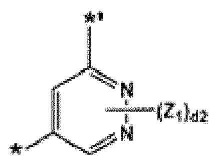
6-17
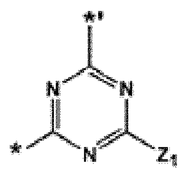
6-18
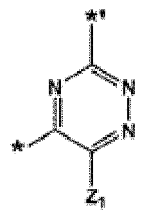
6-19
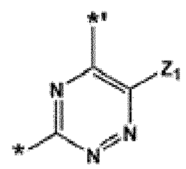
6-20

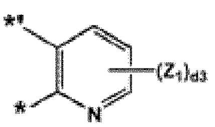
6-21
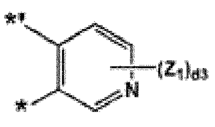
6-22
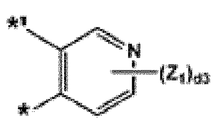
6-23
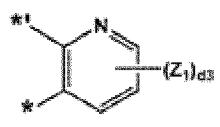
6-24

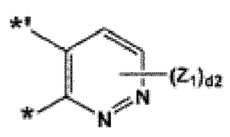
6-25
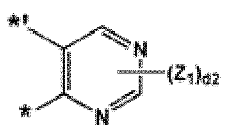
6-26
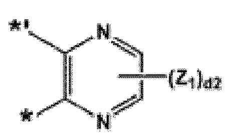
6-27
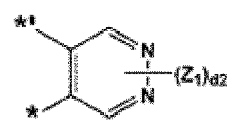
6-28

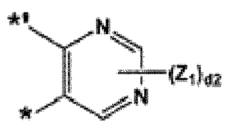
6-29
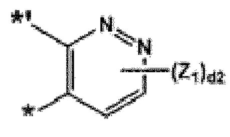
6-30
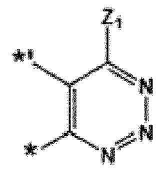
6-31
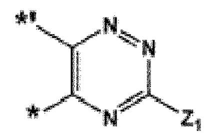
6-32

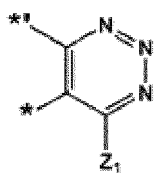
6-33

wherein, in Formulae 5-1 to 5-3 and 6-1 to 6-33,

$Z_1$ may be hydrogen, deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$,

$-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$,
d4 may be 0, 1, 2, 3, or 4,
d3 may be 0, 1, 2, or 3,
d2 may be 0, 1, or 2,
* and *' each indicate a binding site to a neighboring atom, and
$Q_{31}$ to $Q_{33}$ are the same as described above.

In one or more embodiments, $L_{301}$ may be a group represented by one of Formulae 5-2, 5-3 or 6-8 to 6-33.

In one or more embodiments, $R_{301}$ may be a cyano group or a group represented by one of Formula 7-1 to 7-18, and at least one of $Ar_{402}$(s) in the number of xd11 may be a group represented by one of Formulae 7-1 to 7-18, but embodiments of the present disclosure are not limited thereto:

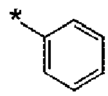
7-1
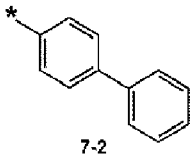
7-2
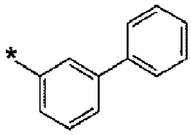
7-3
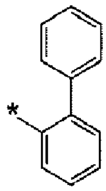
7-4
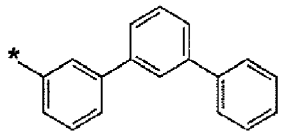
7-5

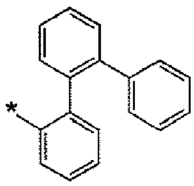
7-6
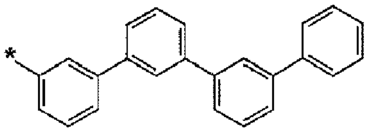
7-7
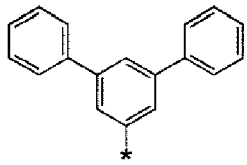
7-8
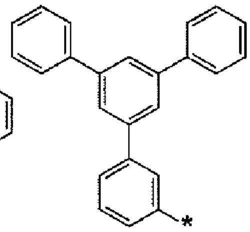
7-9

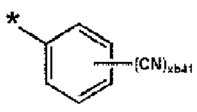
7-10
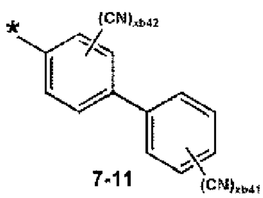
7-11
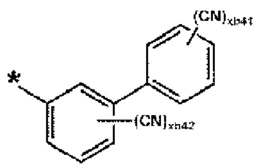
7-12
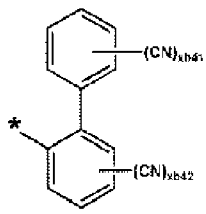
7-13

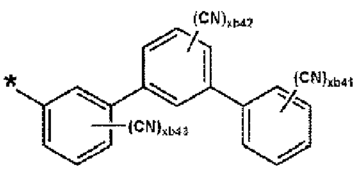
7-14
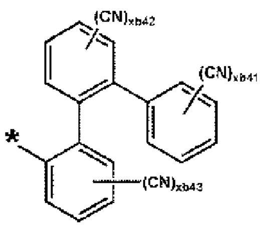
7-15
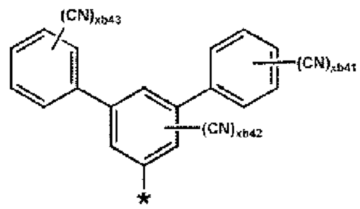
7-16

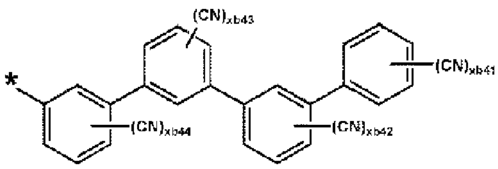

7-17

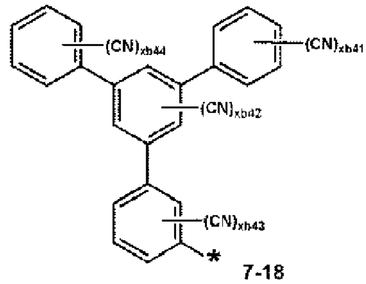

7-18

wherein, in Formulae 7-1 to 7-18,

xb41 to xb44 may each independently be 0, 1, or 2,
xb41 in Formula 7-10 may not be 0,
the sum of xb41 and xb42 in Formulae 7-11 to 7-13 may not be 0,
the sum of xb41, xb42, and xb43 in Formulae 7-14 to 7-16 may not be 0,
the sum of xb41, xb42, xb43, and xb44 in Formulae 7-17 and 7-18 may not be 0, and
* indicates a binding site to a neighboring atom.

In one or more embodiments, at least one of the following conditions is satisfied:

xb41 in Formula 7-10 is not 0,
the sum of xb41 and xb42 in Formulae 7-11 to 7-13 is not 0, the sum of xb41, xb42, and xb43 in Formulae 7-14 to 7-16 is not 0, or
the sum of xb41, xb42, xb43, and xb44 in Formulae 7-17 and 7-18 is not 0.

Two or more $Ar_{301}$(s) in Formula E-1 may be identical to or different from each other, two or more $L_{301}$(s) may be identical to or different from each other, two or more $L_{401}$(s) in Formula H-1 may be identical to or different from each other, and two or more $Ar_{402}$(s) in Formula H-1 may be identical to or different from each other.

In one or more embodiments, the electron transport host includes i) at least one of a cyano group, a pyrimidine group, a pyrazine group, and a triazine group and ii) a triphenylene group, and the hole transport host may include a carbazole group.

In one or more embodiments, the electron transport host may include at least one cyano group.

The electron transport host may be, for example, a compound of Group HE1 to HE7, but embodiments of the present disclosure are not limited thereto:

## Group HE1

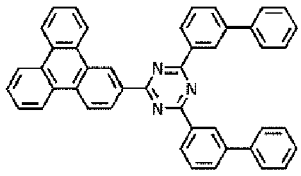

H-E1

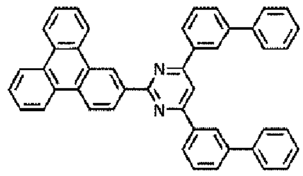

H-E2

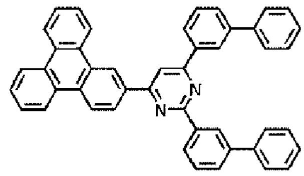

H-E3

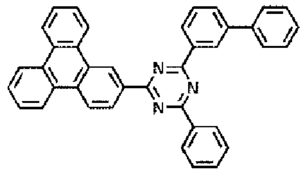

H-E4

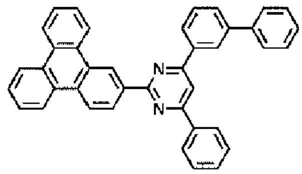

H-E5

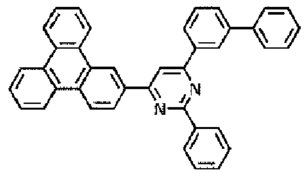

H-E6

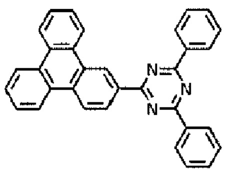

H-E7

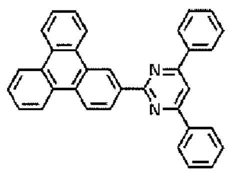

H-E8

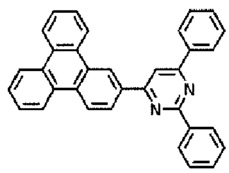

H-E9

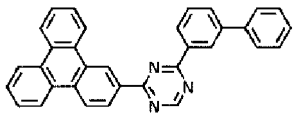

H-E10

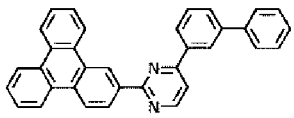

H-E11

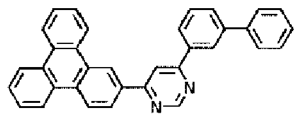

H-E12

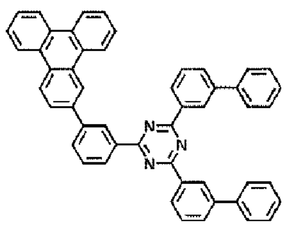

H-E13

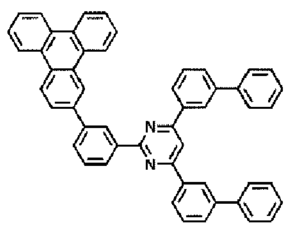

H-E14

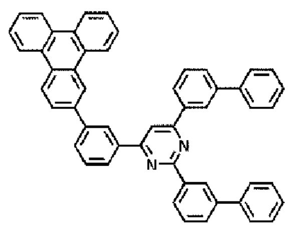

H-E15

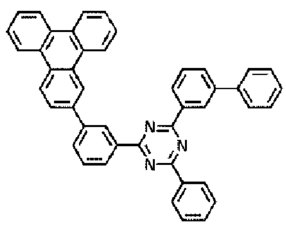

H-E16

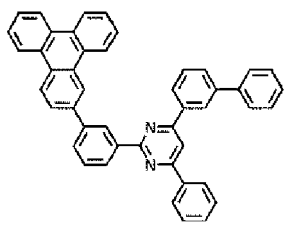

H-E17

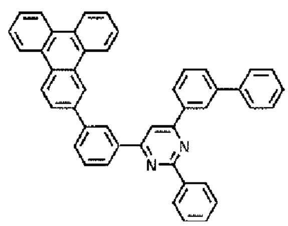

H-E18

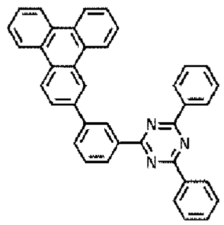

H-E19

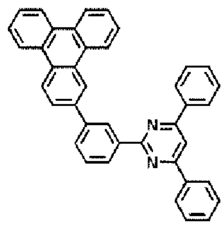

H-E20

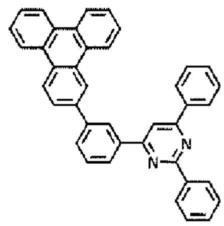

H-E21

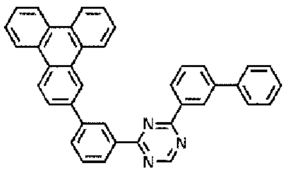

H-E22

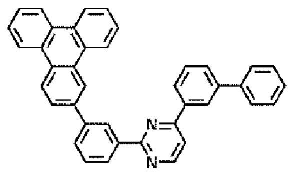

H-E23

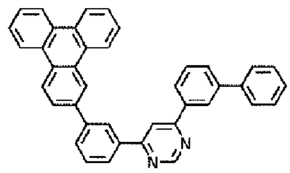

H-E24

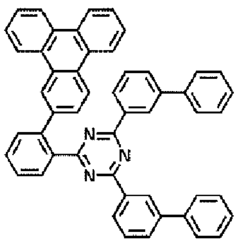

H-E25

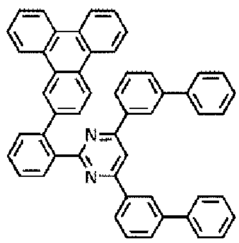

H-E26

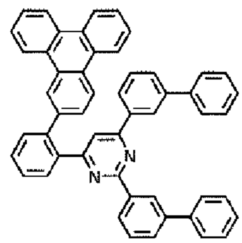

H-E27

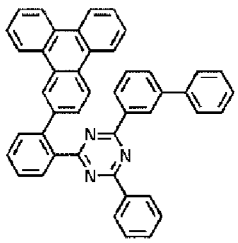

H-E28

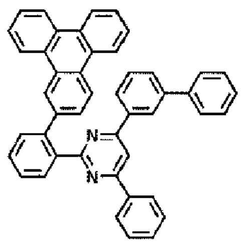

H-E29

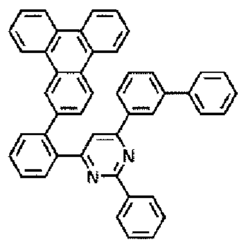

H-E30

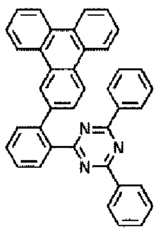

H-E31

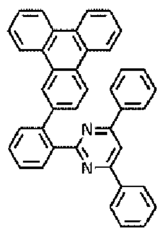

H-E32

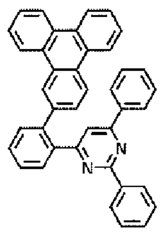

H-E33

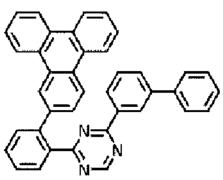

H-E34

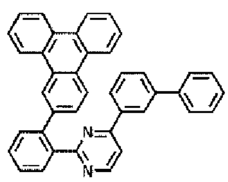

H-E35

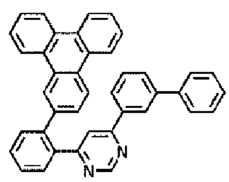

H-E36

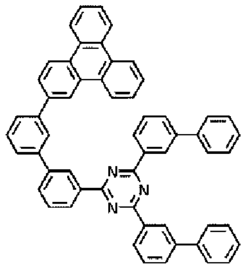

H-E37

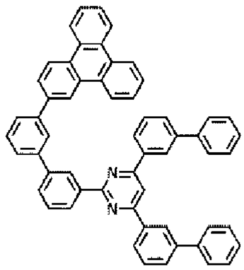

H-E38

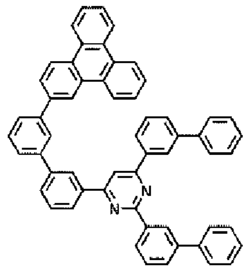

H-E39

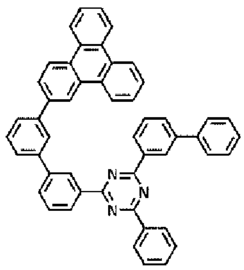

H-E40

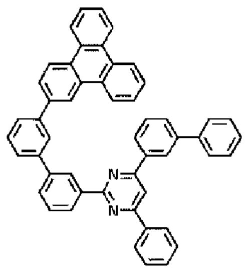

H-E41

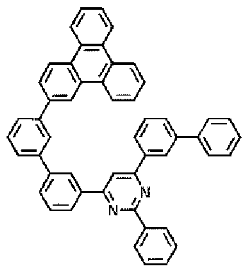

H-E42

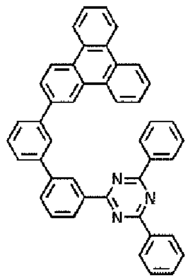

H-E43

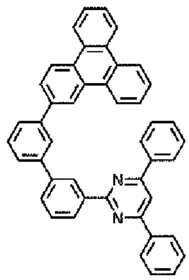

H-E44

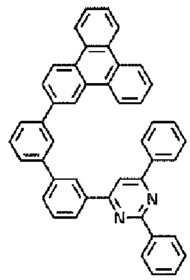

H-E45

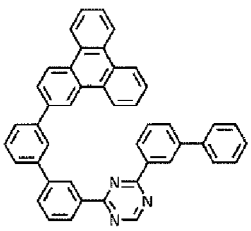

H-E46

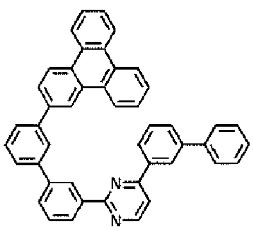

H-E47

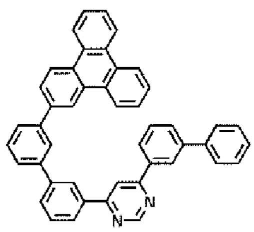

H-E48

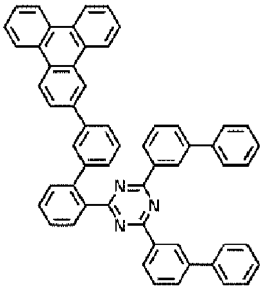

H-E49

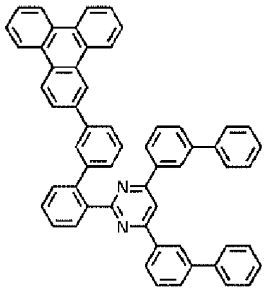

H-E50

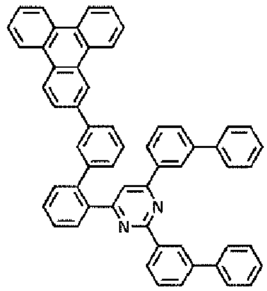

H-E51

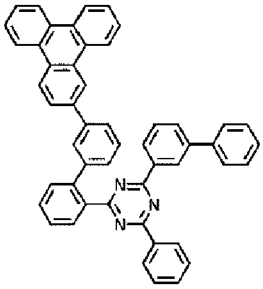

H-E52

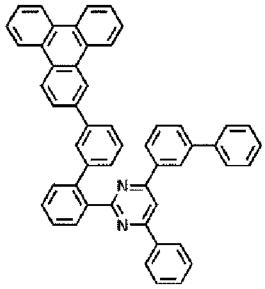

H-E53

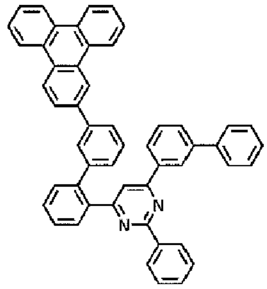

H-E54

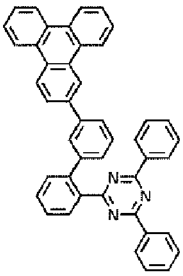

H-E55

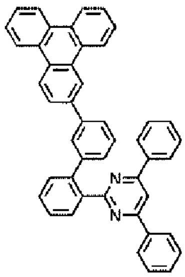

H-E56

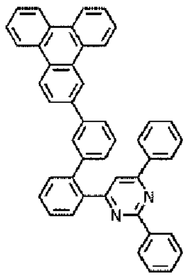

H-E57

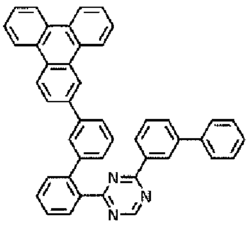

H-E58

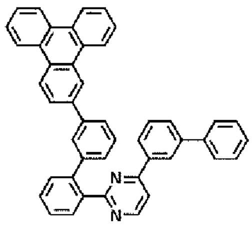

H-E59

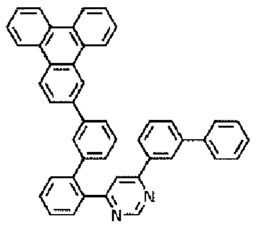

H-E60

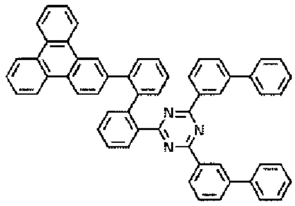

H-E61

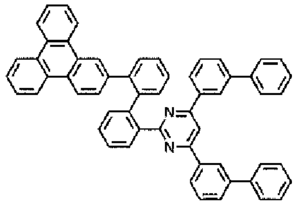

H-E62

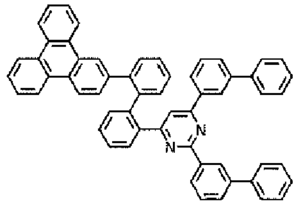

H-E63

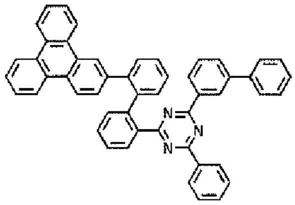

H-E64

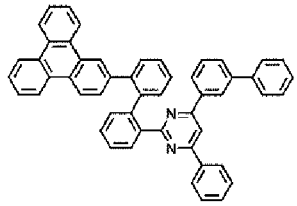

H-E65

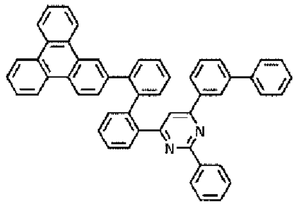

H-E66

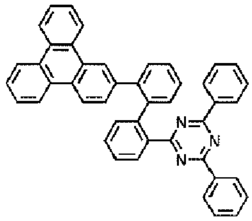

H-E67

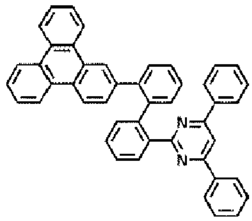

H-E68

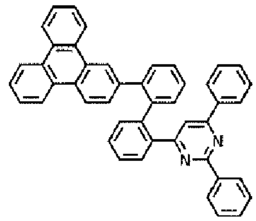

H-E69

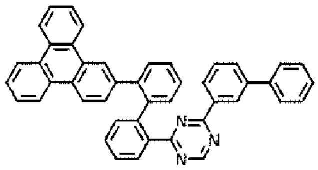

H-E70

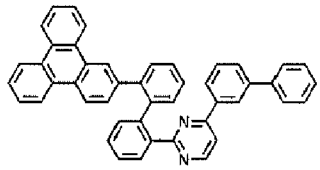

H-E71

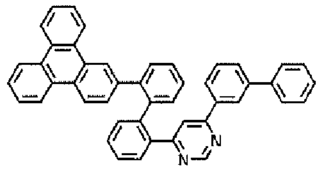

H-E72

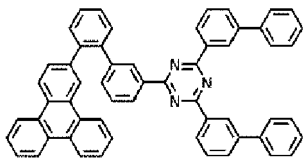

H-E73

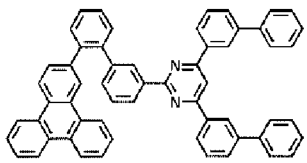

H-E74

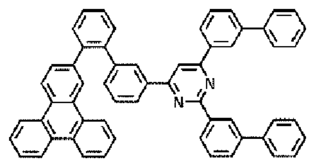

H-E75

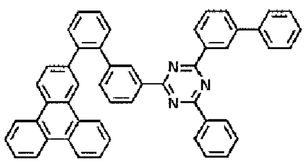

H-E76

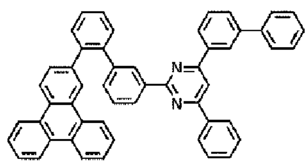

H-E77

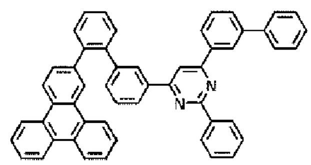

H-E78

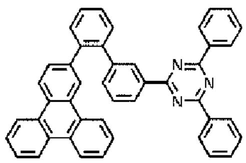

H-E79

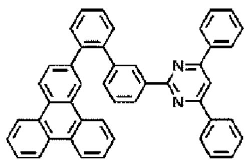

H-E80

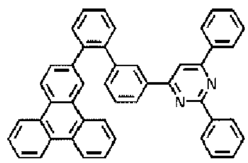

H-E81

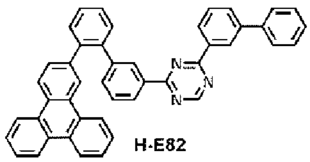

H-E82

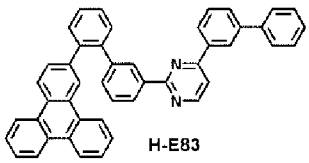

H-E83

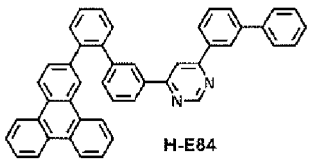

H-E84

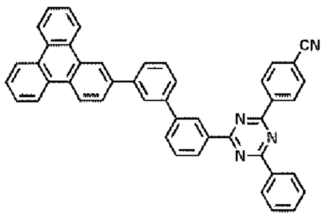

H-E(1)

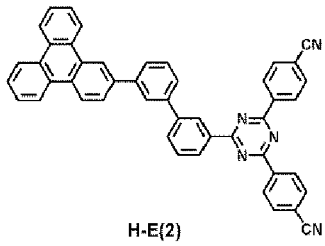

H-E(2)

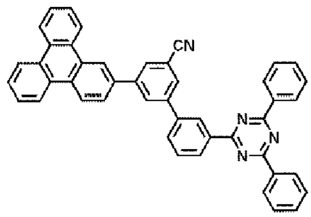

H-E(3)

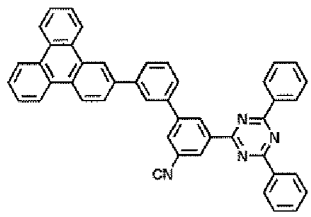

H-E(4)

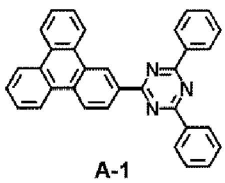

A-1

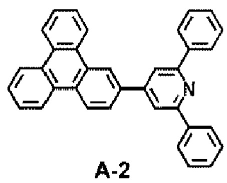

A-2

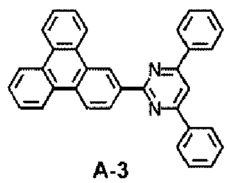

A-3

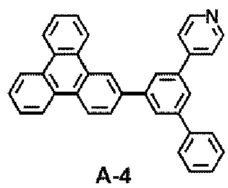

A-4

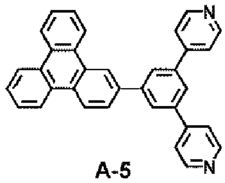

A-5

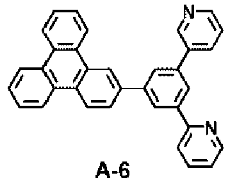

A-6

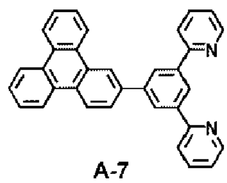

A-7

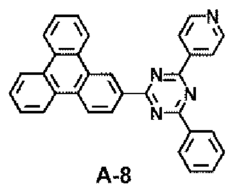

A-8

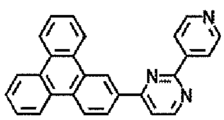

A-9

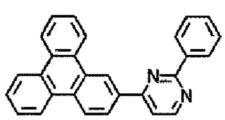

A-10

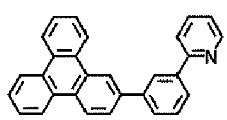

A-11

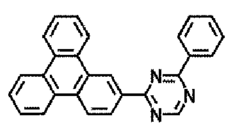

A-12

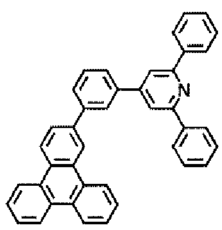

A-13

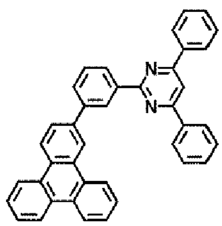

A-14

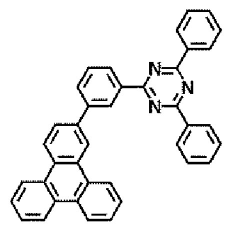

A-15

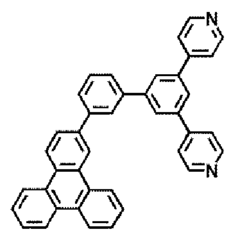

A-16

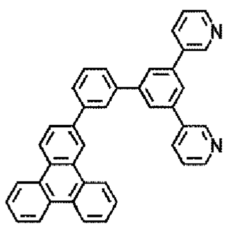

A-17

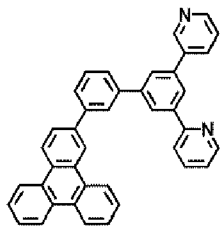

A-18

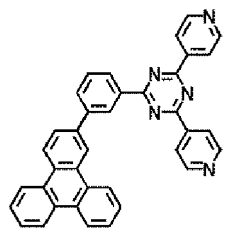

A-19

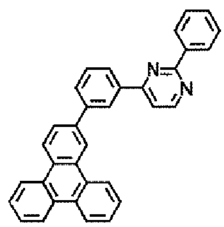

A-20

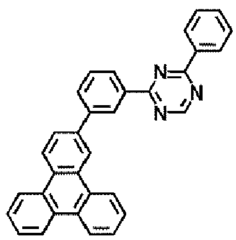

A-21

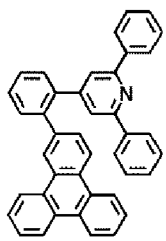

A-22

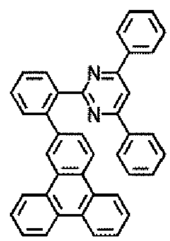

A-23

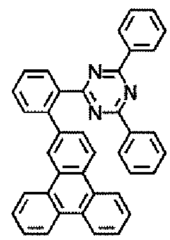

A-24

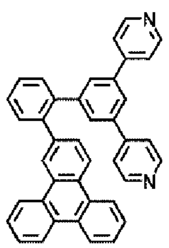

A-25

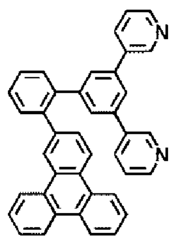

A-26

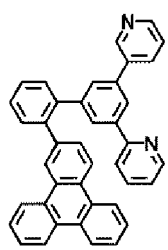

A-27

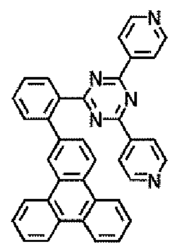

A-28

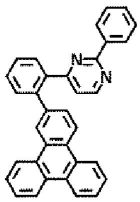
A-29

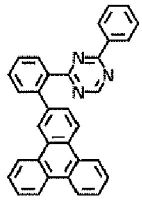
A-30

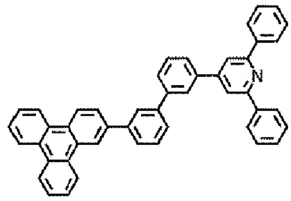
A-31

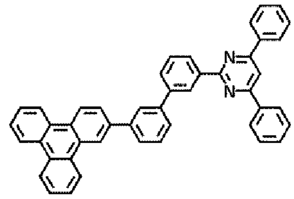
A-32

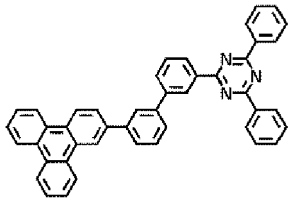
A-33

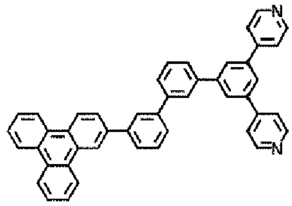
A-34

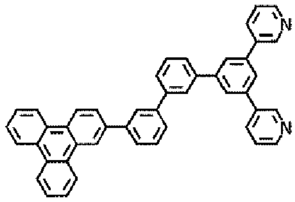
A-35

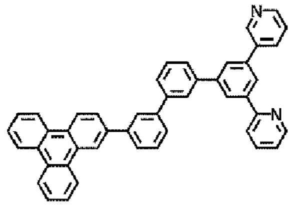
A-36

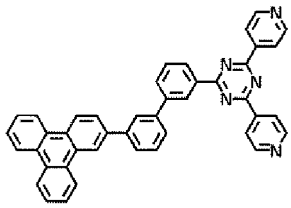
A-37

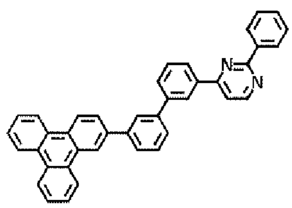
A-38

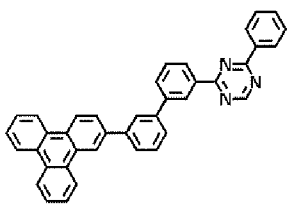
A-39

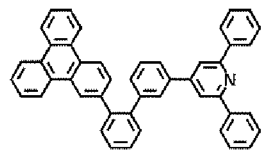
A-40

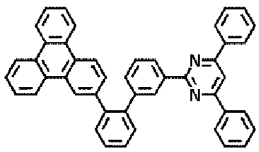
A-41

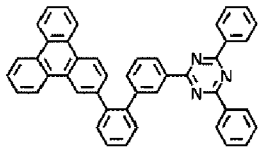
A-42

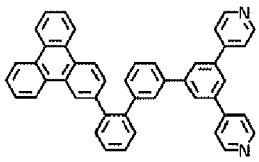
A-43

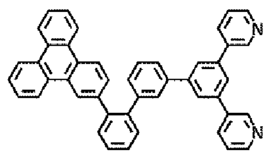
A-44

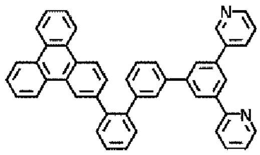
A-45

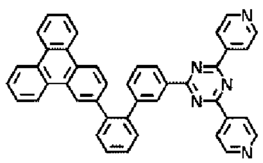
A-46

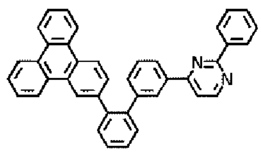
A-47

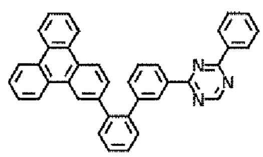
A-48

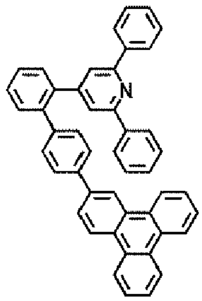

**A-49**

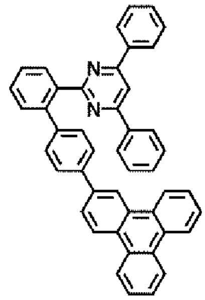

**A-50**

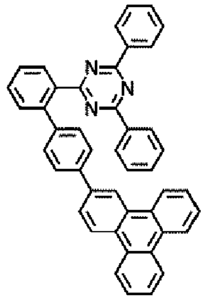

**A-51**

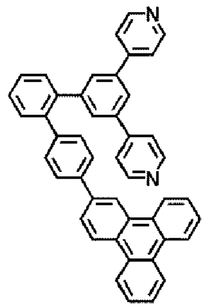

**A-52**

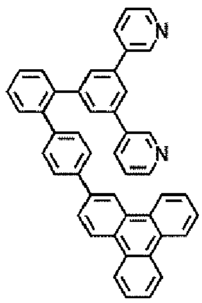

**A-53**

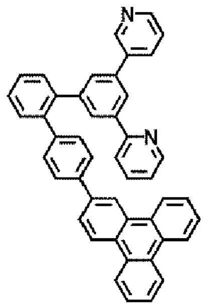

**A-54**

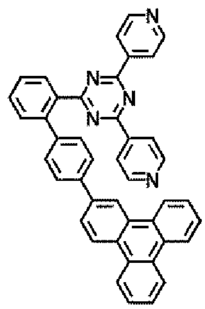

**A-55**

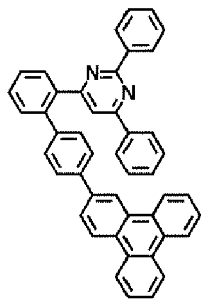

**A-56**

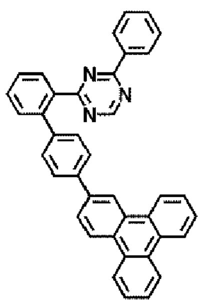

**A-57**

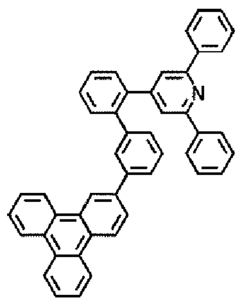

**A-58**

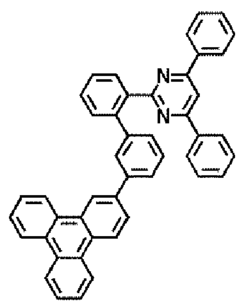

**A-59**

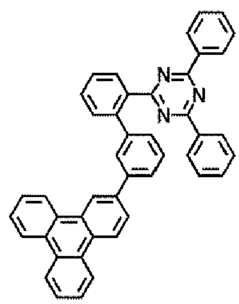

**A-60**

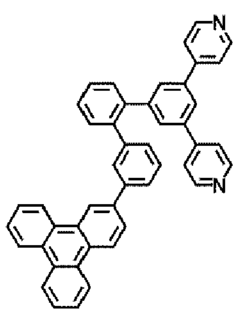

**A-61**

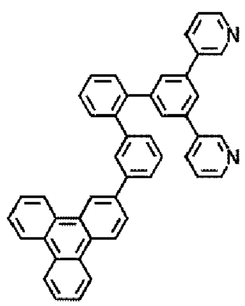

**A-62**

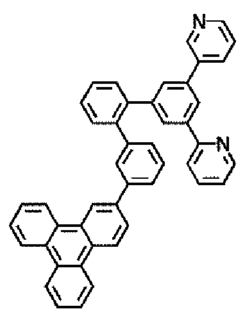

**A-63**

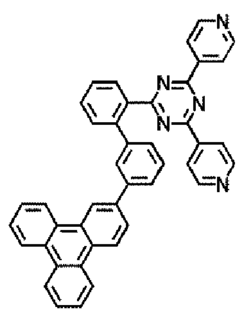

**A-64**

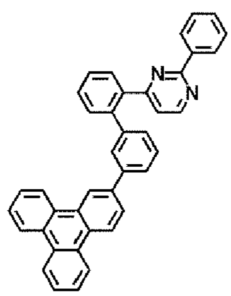
A-65

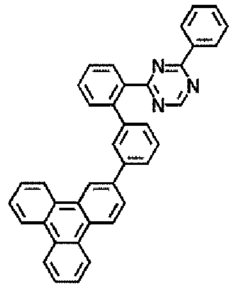
A-66

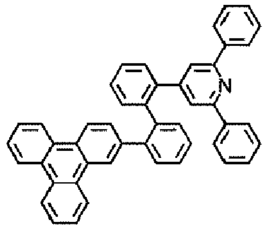
A-67

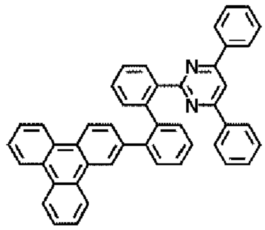
A-68

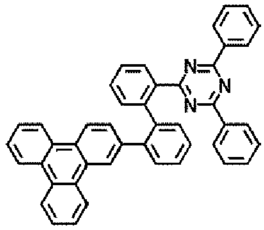
A-69

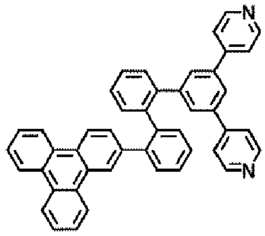
A-70

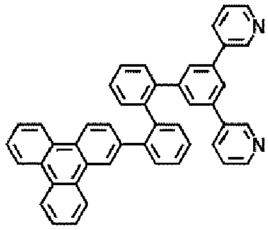
A-71

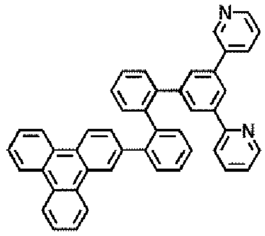
A-72

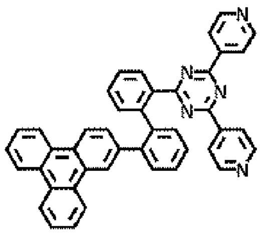
A-73

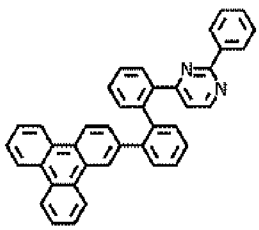
A-74

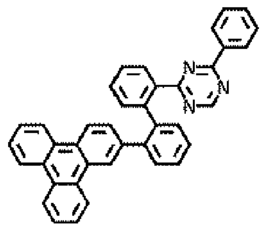
A-75

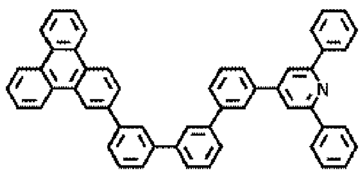
A-76

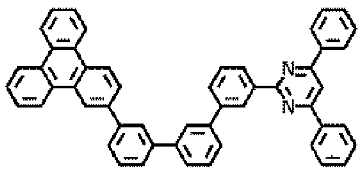
A-77

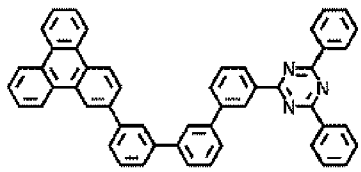
A-78

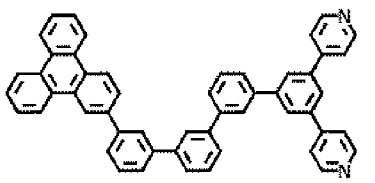
A-79

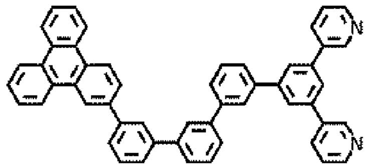
A-80

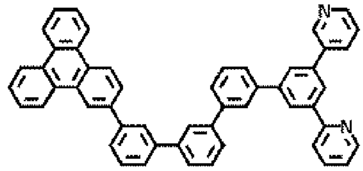
A-81

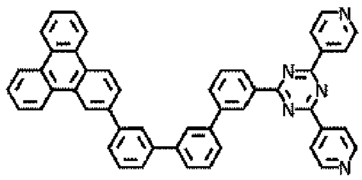
A-82

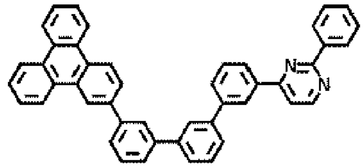
A-83

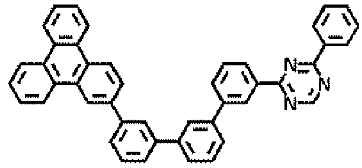
A-84

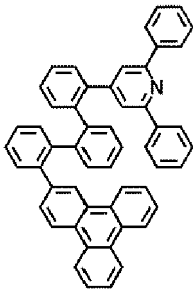

**A-85**

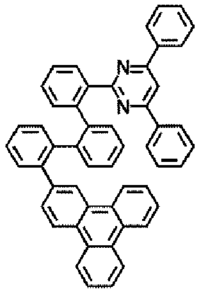

**A-86**

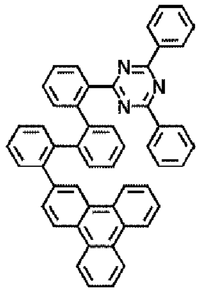

**A-87**

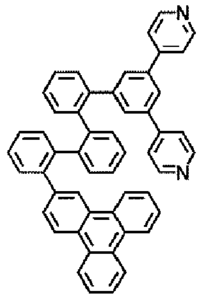

**A-88**

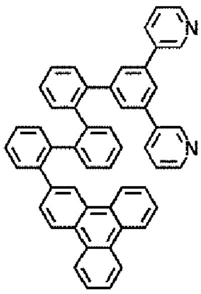

**A-89**

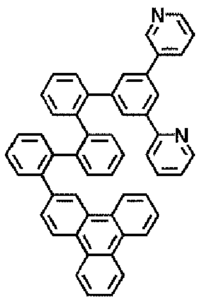

**A-90**

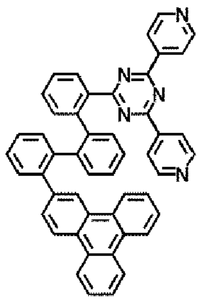

**A-91**

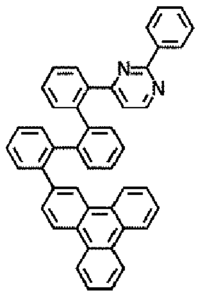

**A-92**

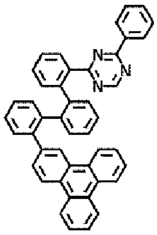

**A-93**

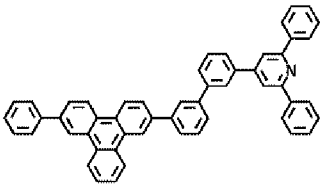

**A-94**

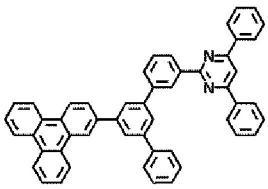

**A-95**

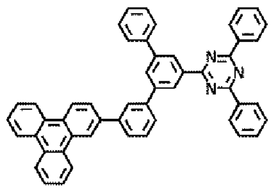

**A-96**

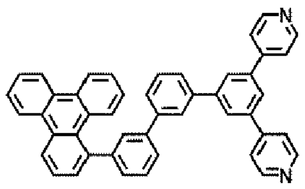
A-97

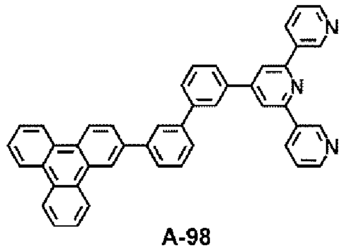
A-98

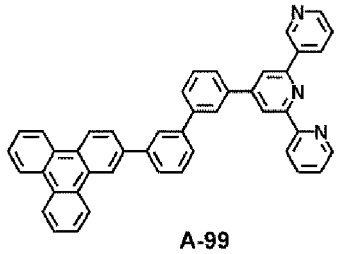
A-99

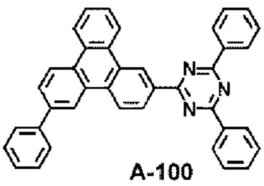
A-100

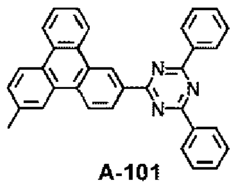
A-101

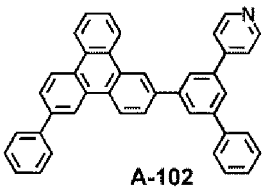
A-102

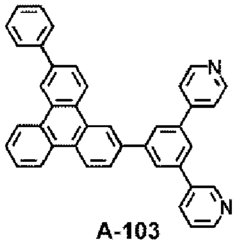
A-103

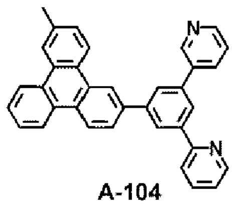
A-104

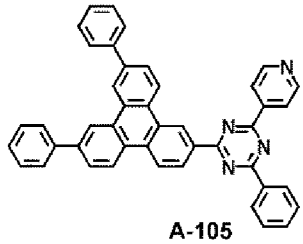
A-105

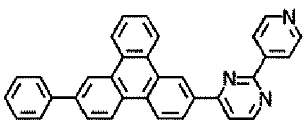
A-106

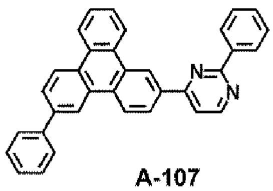
A-107

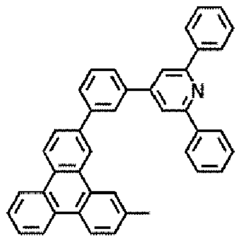
A-108

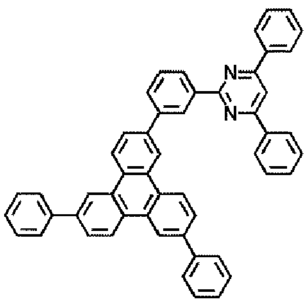
A-109

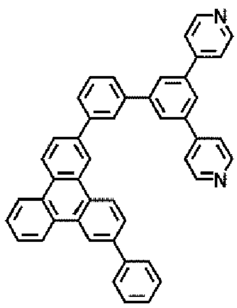
A-110

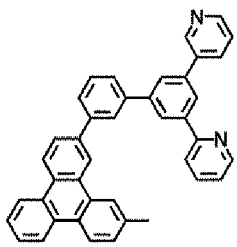
A-111

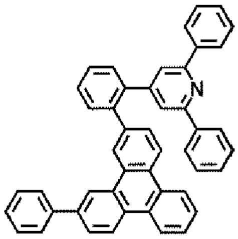

A-112

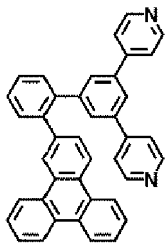

A-113

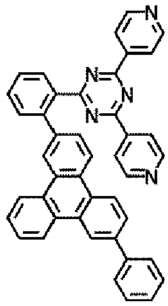

A-114

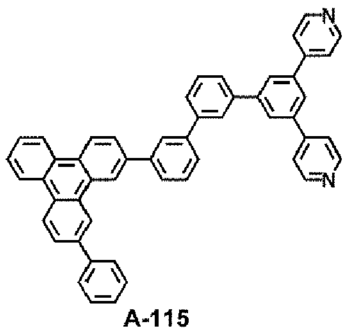

A-115

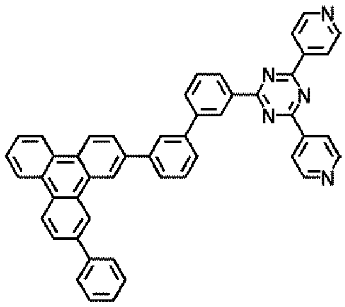

A-116

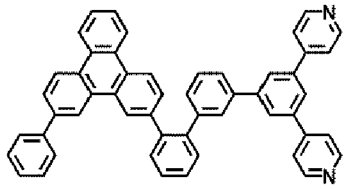

A-117

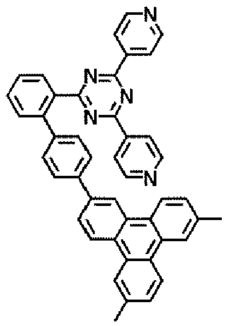

A-118

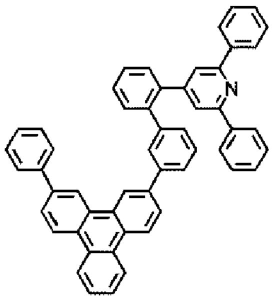

A-119

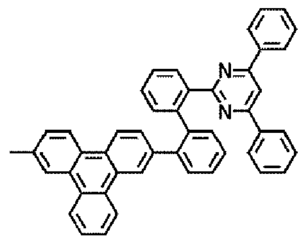

A-120

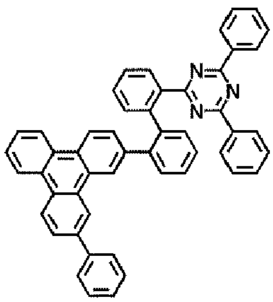

A-121

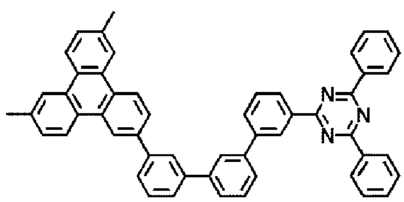

A-122

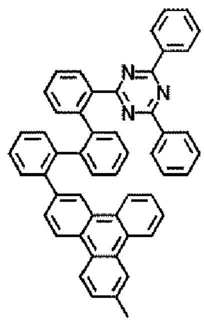

A-123

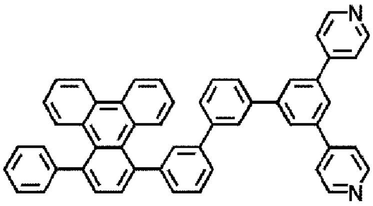

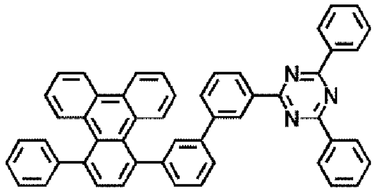

**A-124** **A-125**

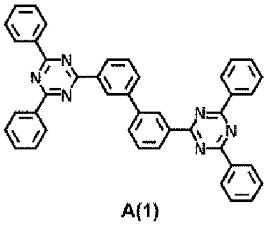

A(1)

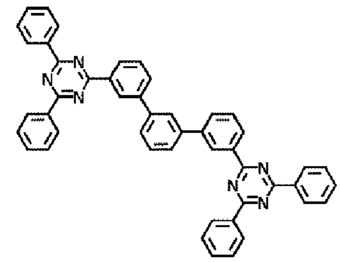

A(2)

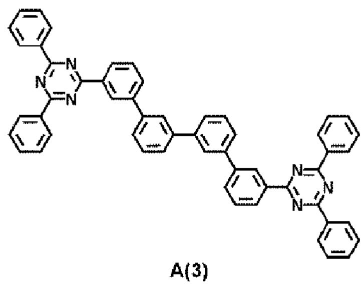

A(3)

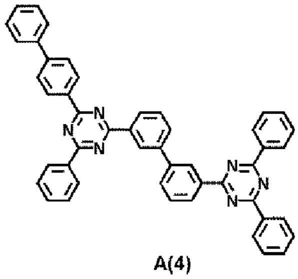

A(4)

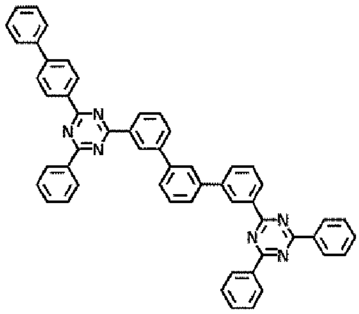

A(5)

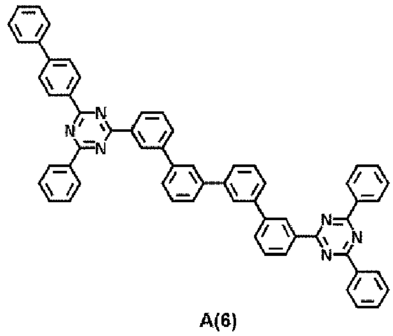

A(6)

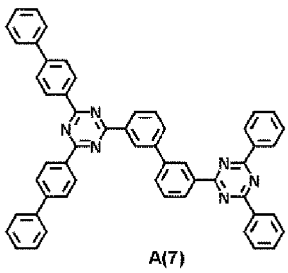

A(7)

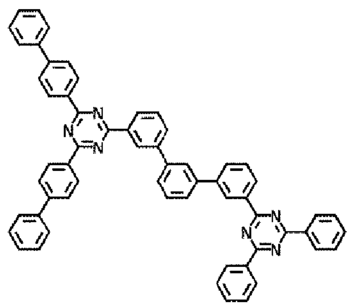

A(8)

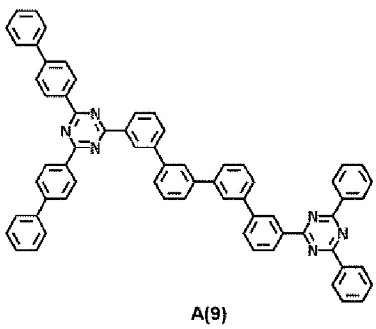

A(9)

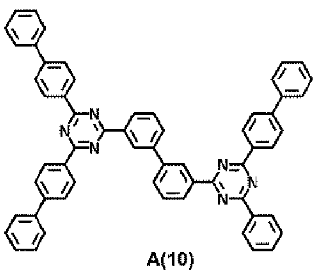

A(10)

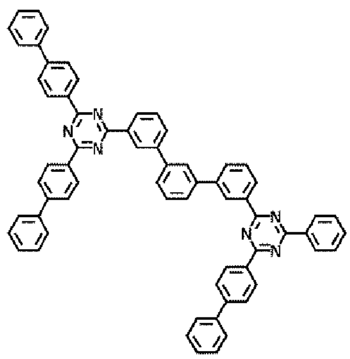

A(11)

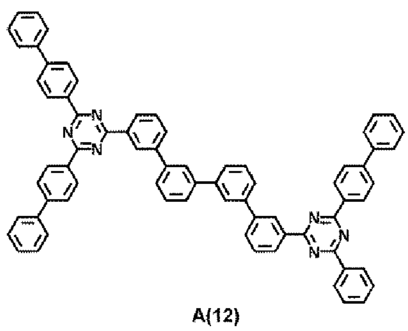

A(12)

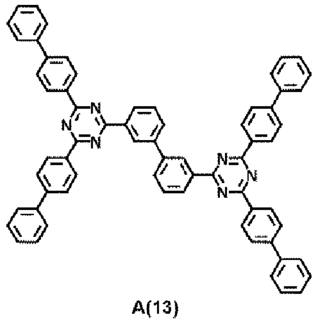

A(13)

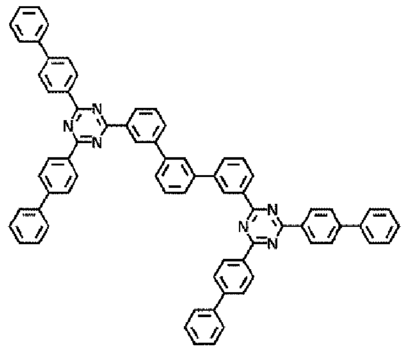

A(14)

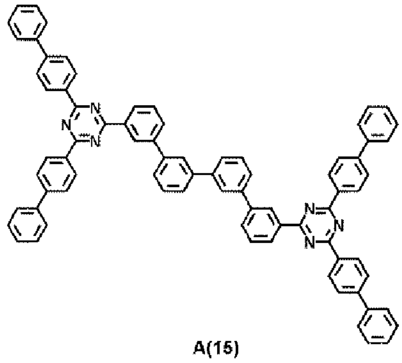

A(15)

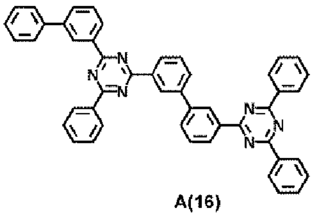

A(16)

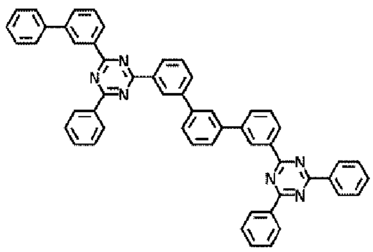

A(17)

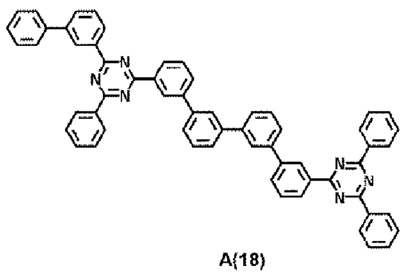

A(18)

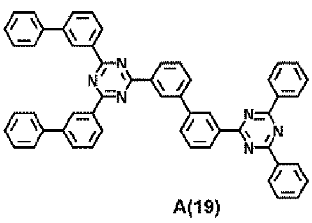

A(19)

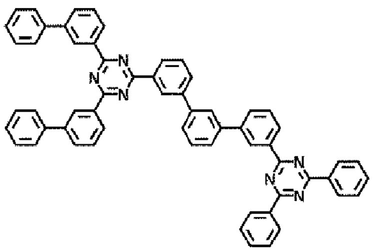

A(20)

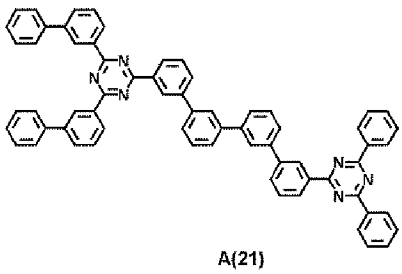

A(21)

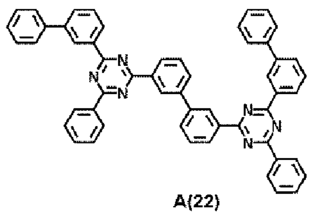

A(22)

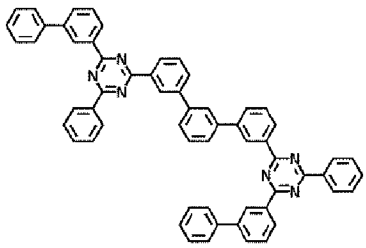

A(23)

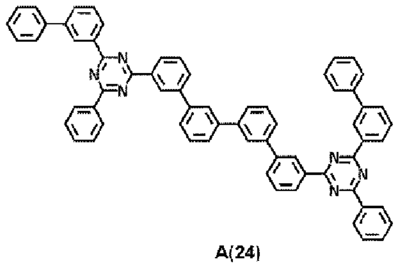

A(24)

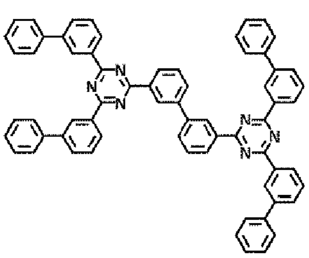

A(25)

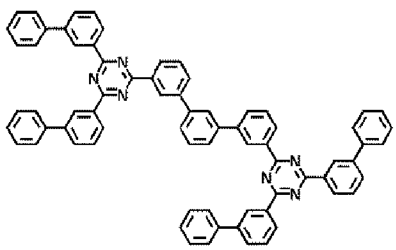

A(26)

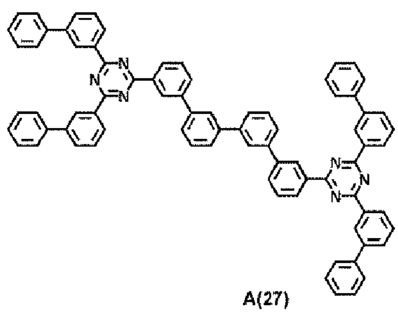

A(27)

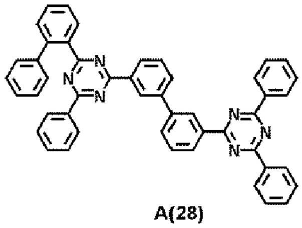

A(28)

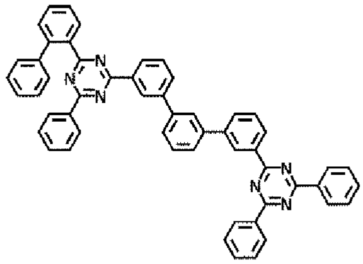

A(29)

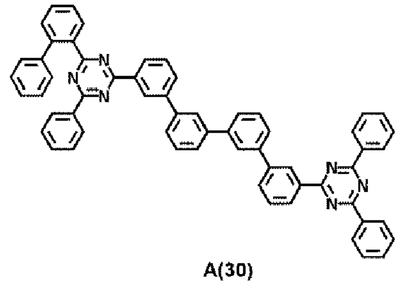

A(30)

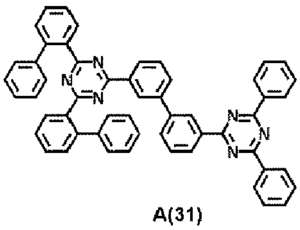

A(31)

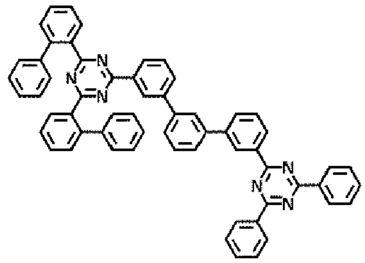

A(32)

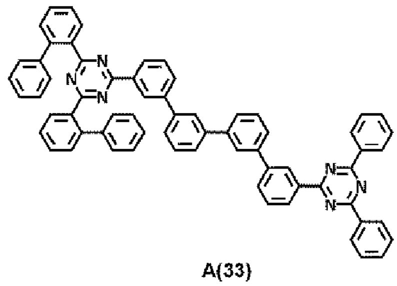

A(33)

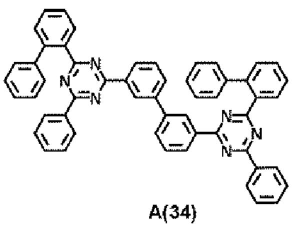

A(34)

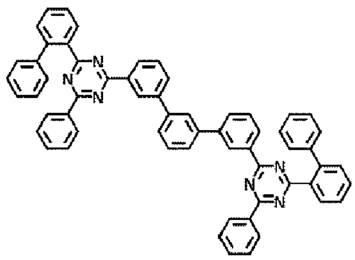

A(35)

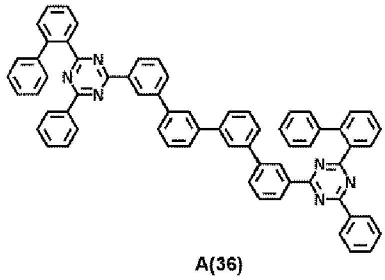

A(36)

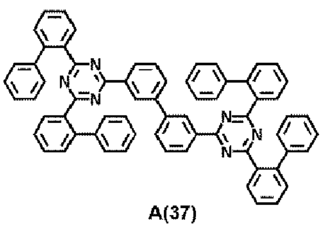

A(37)

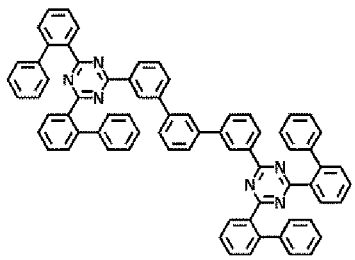

A(38)

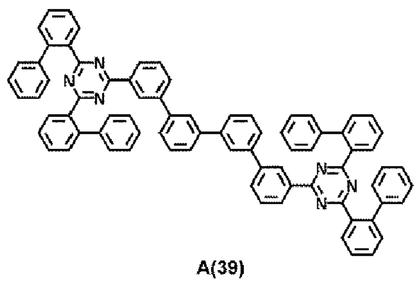

A(39)

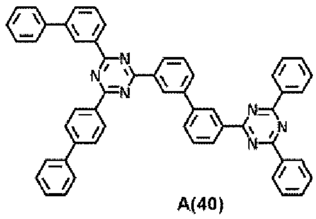

A(40)

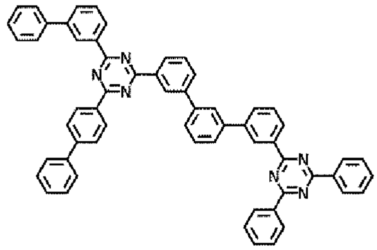

A(41)

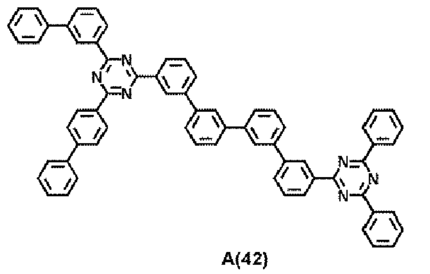

A(42)

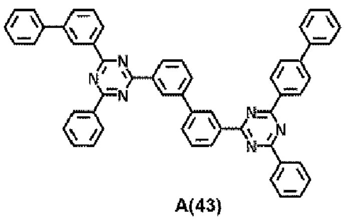

A(43)

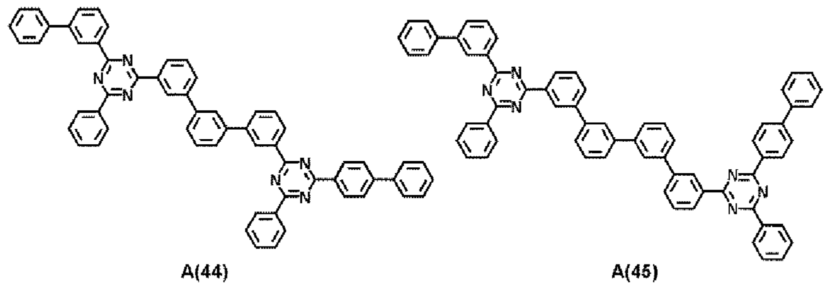

A(44)

A(45)

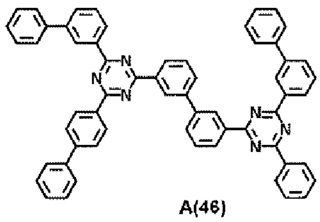

A(46)

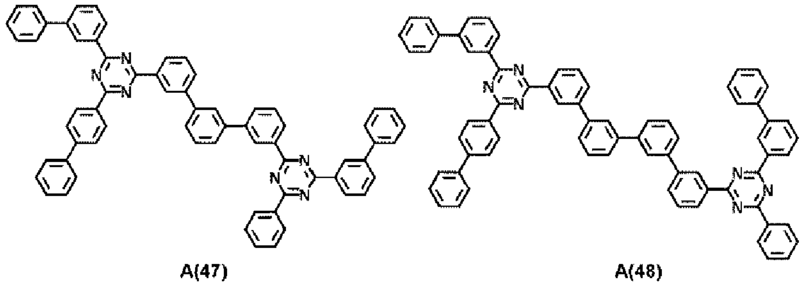

A(47)

A(48)

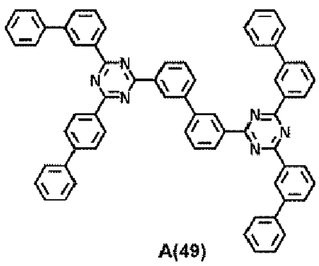

A(49)

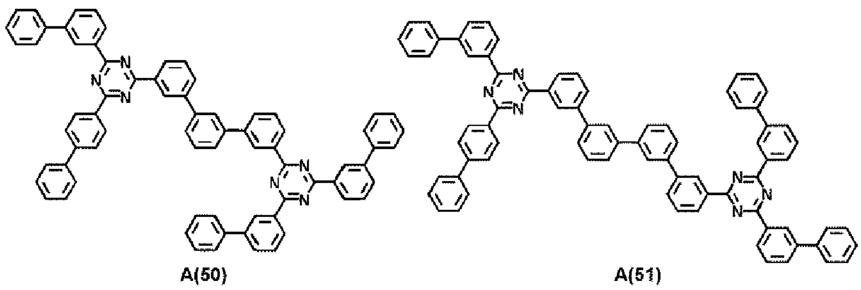

A(50)

A(51)

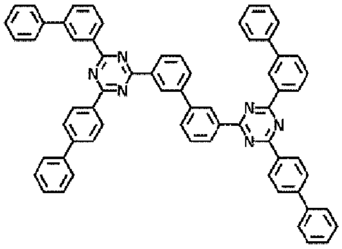

A(52)

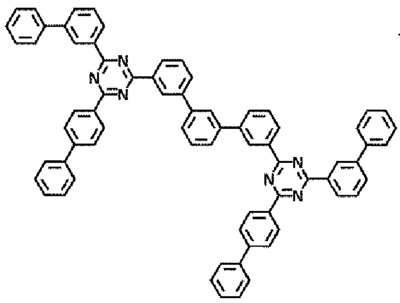

A(53)

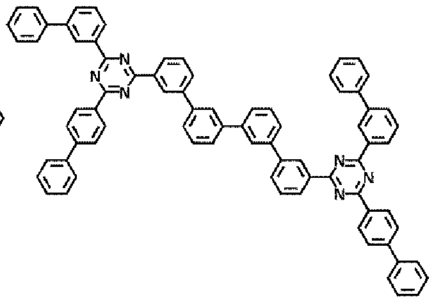

A(54)

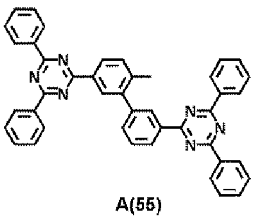

A(55)

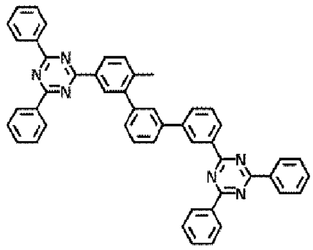

A(56)

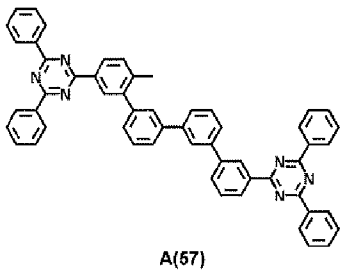

A(57)

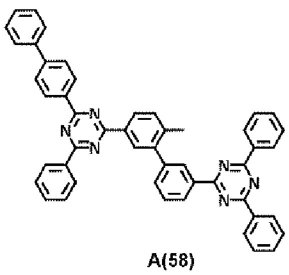

A(58)

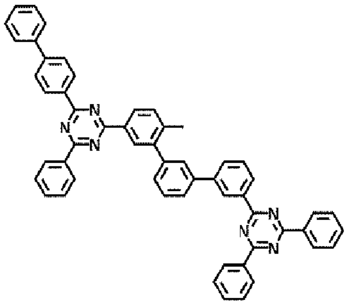

A(59)

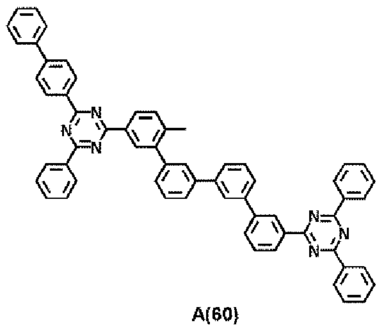

A(60)

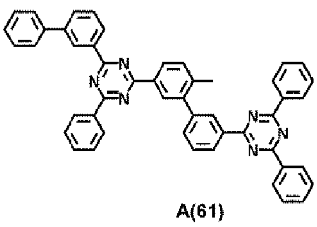

A(61)

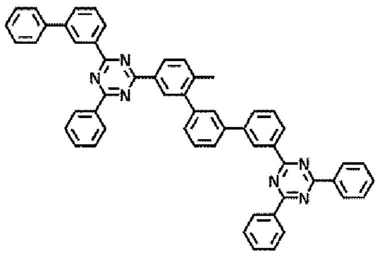

A(62)

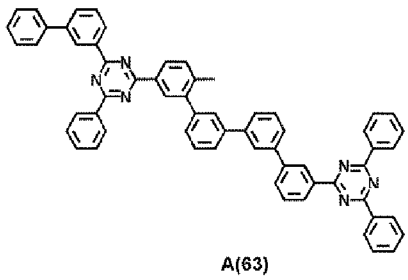

A(63)

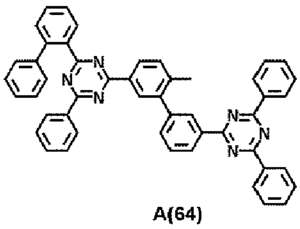

A(64)

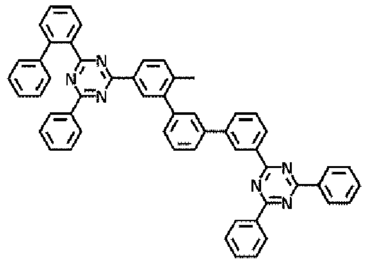

A(65)

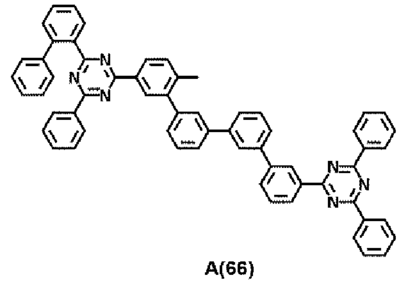

A(66)

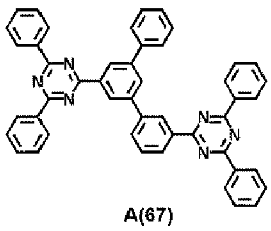

A(67)

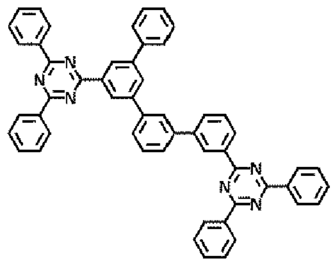

A(68)

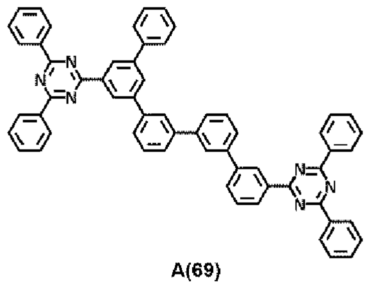

A(69)

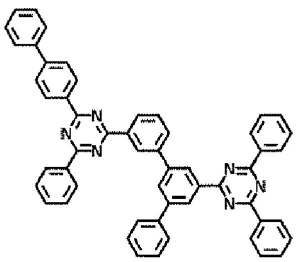

A(70)

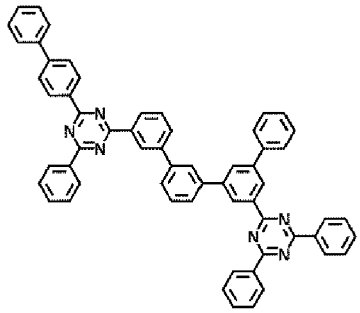

A(71)

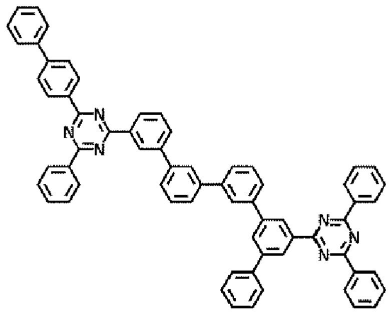

A(72)

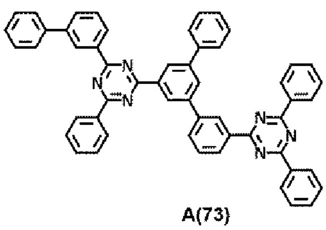

A(73)

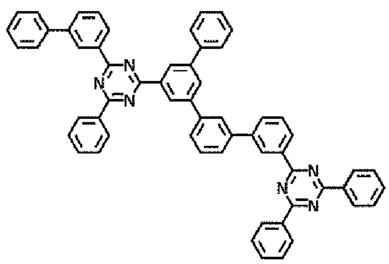

A(74)

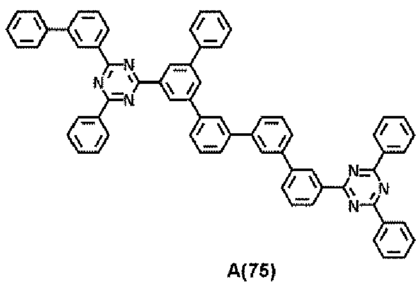

A(75)

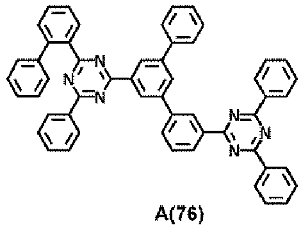

A(76)

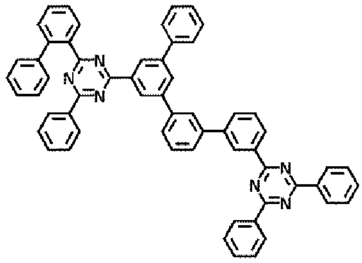

A(77)

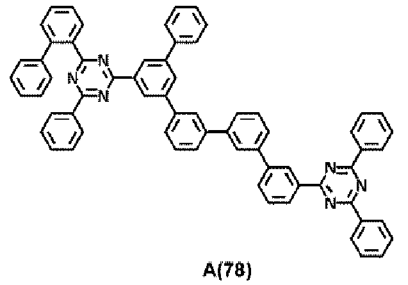

A(78)

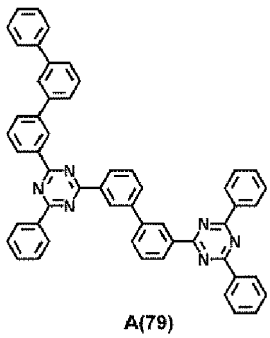

A(79)

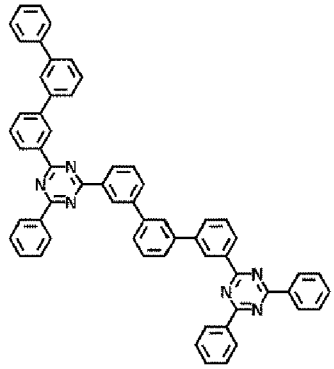

A(80)

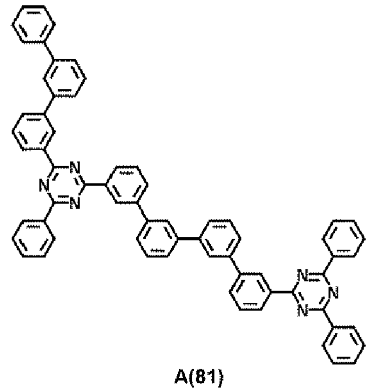

A(81)

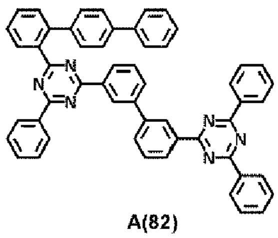

A(82)

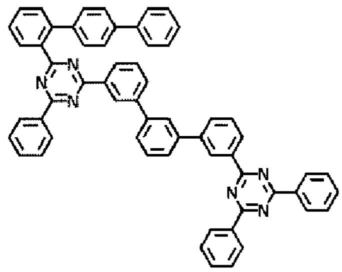

A(83)

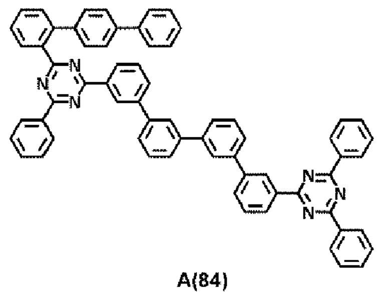

A(84)

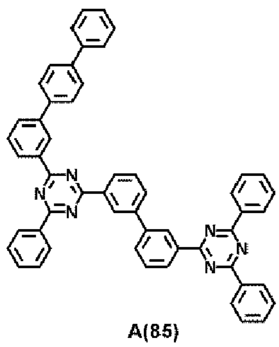

A(85)

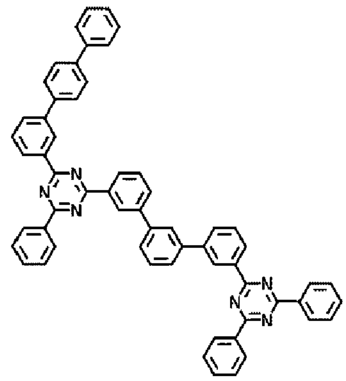

A(86)

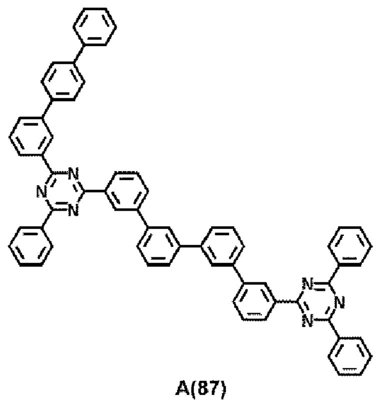

A(87)

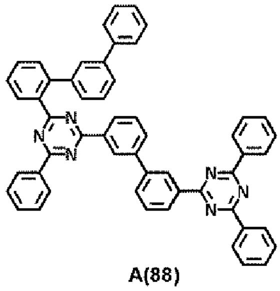
A(88)

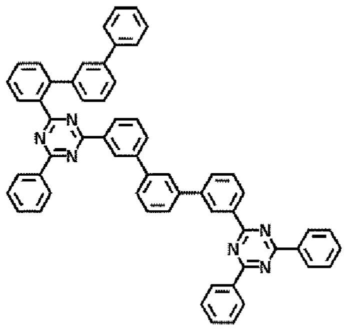
A(89)

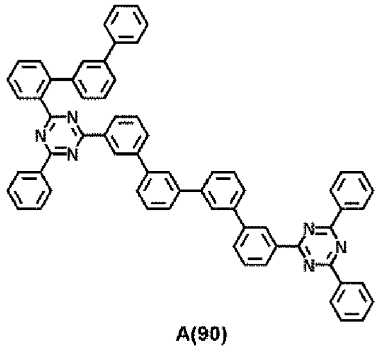
A(90)

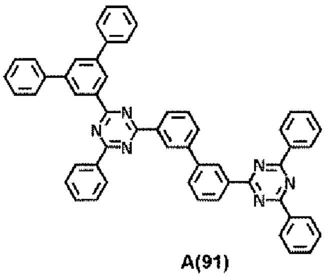
A(91)

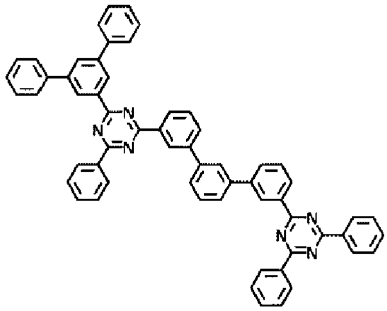
A(92)

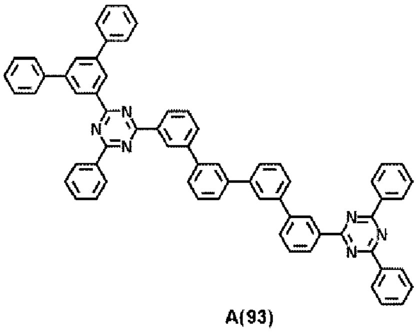
A(93)

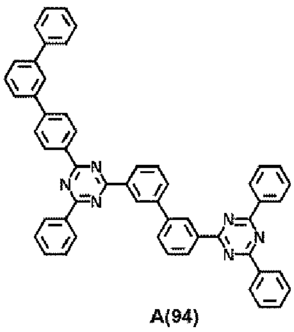
A(94)

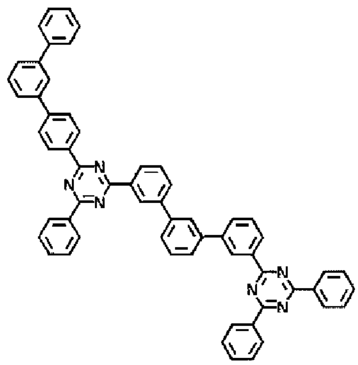
A(95)

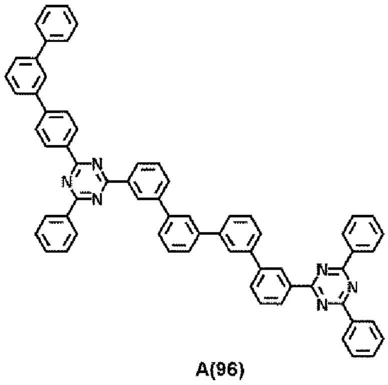
A(96)

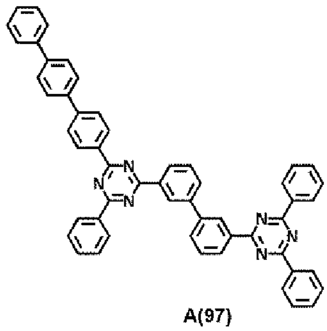
A(97)

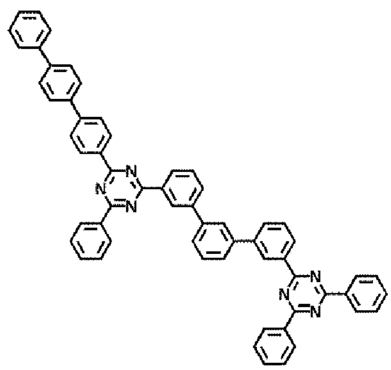
A(98)

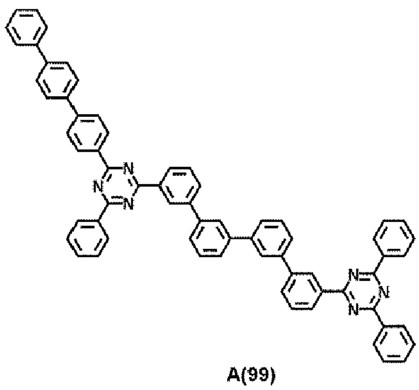
A(99)

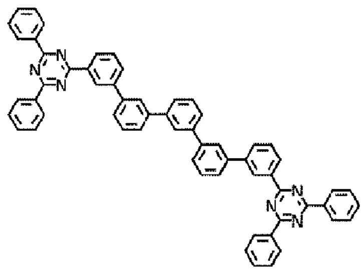
A(100)

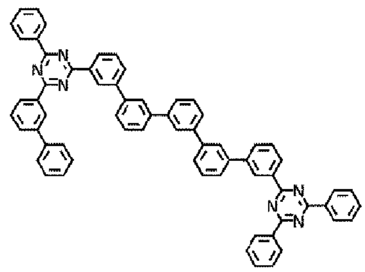
A(101)

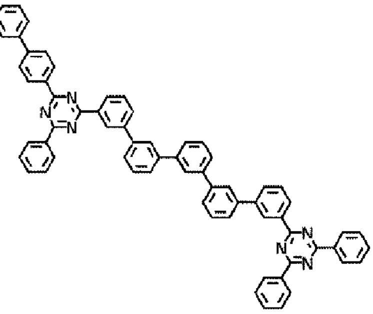
A(102)

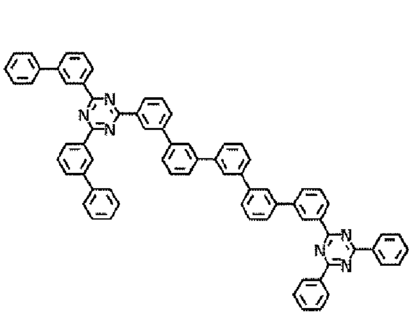
A(103)

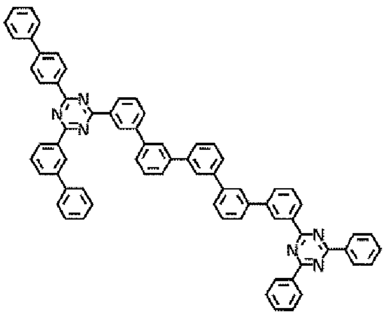
A(104)

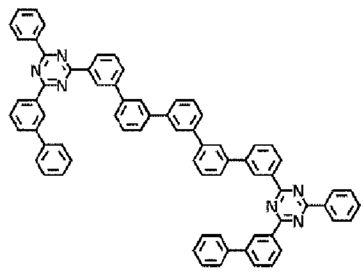
A(105)

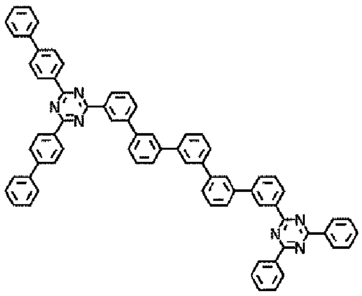
A(106)

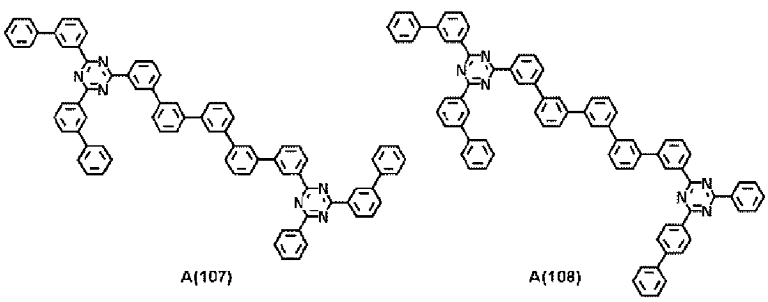
A(107)

A(108)

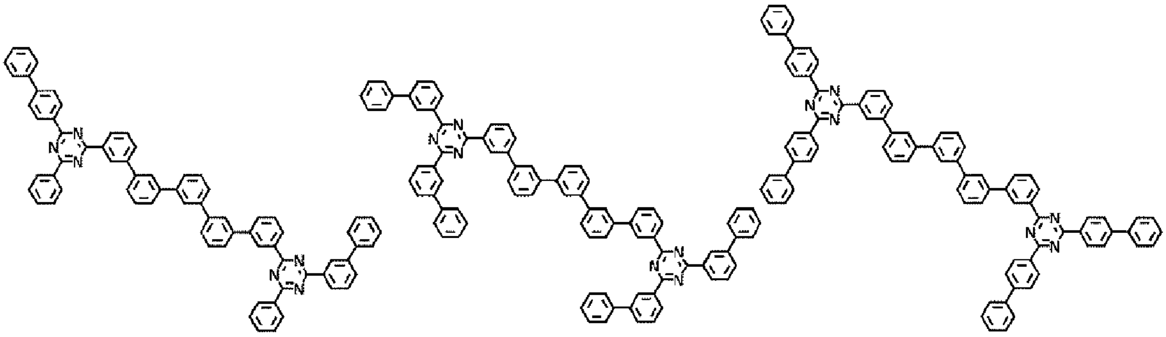
A(109)

A(110)

A(111)

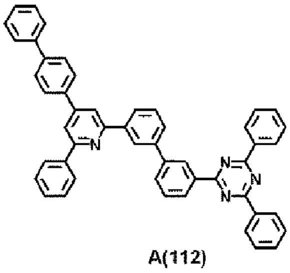
A(112)

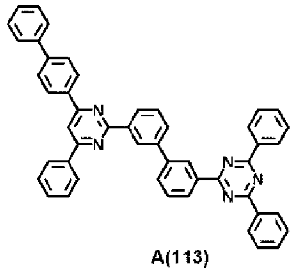
A(113)

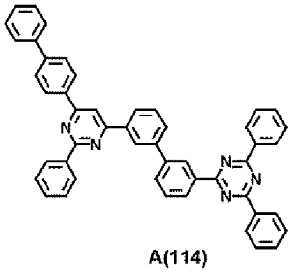
A(114)

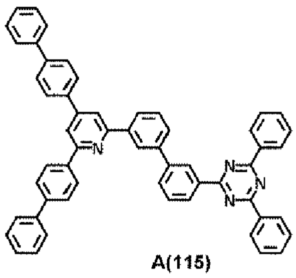
A(115)

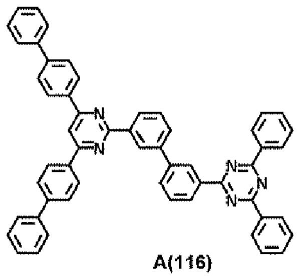
A(116)

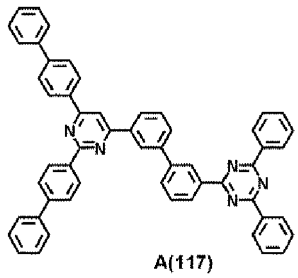
A(117)

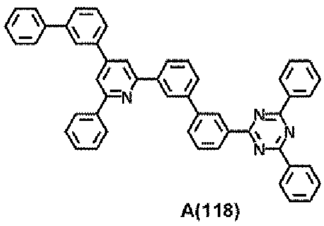
A(118)

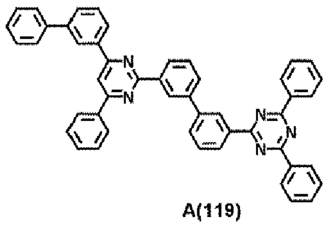
A(119)

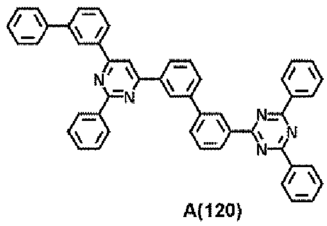
A(120)

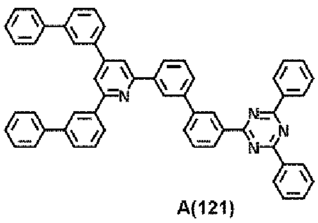
A(121)

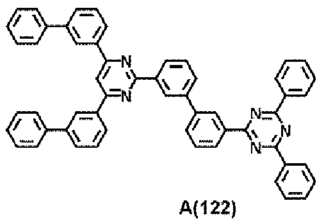
A(122)

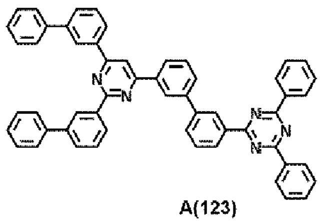
A(123)

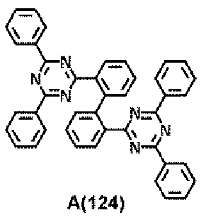
A(124)

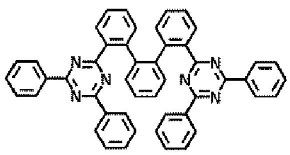
A(125)

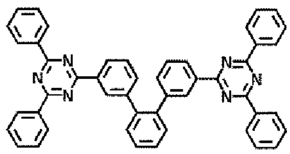
A(126)

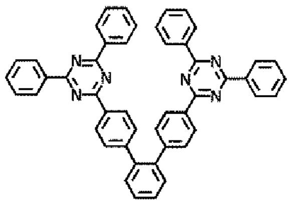
A(127)

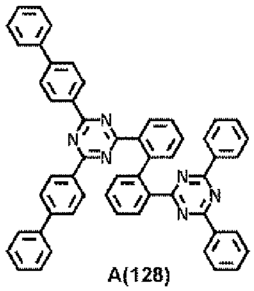

A(128)

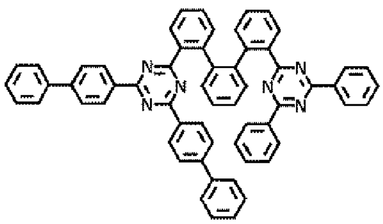

A(129)

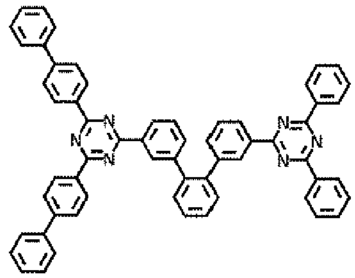

A(130)

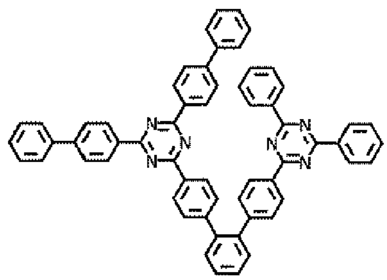

A(131)

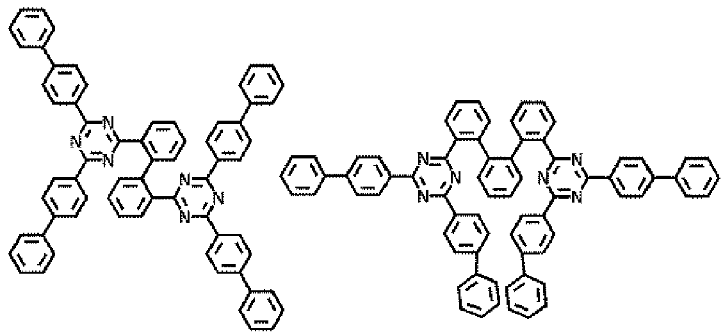

A(132)

A(133)

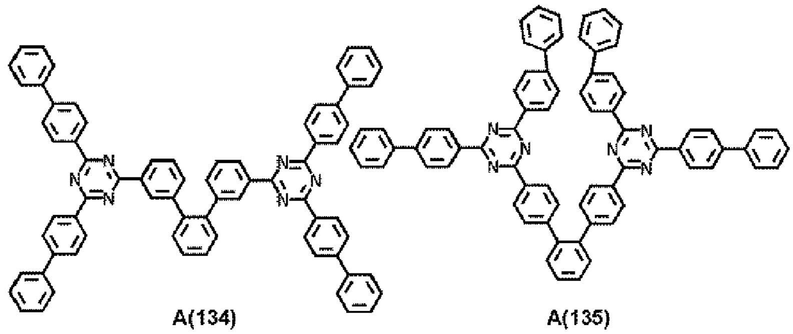

A(134)

A(135)

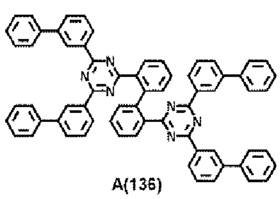

A(136)

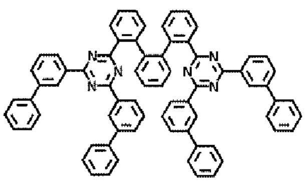

A(137)

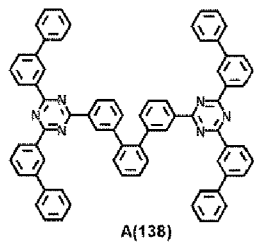

A(138)

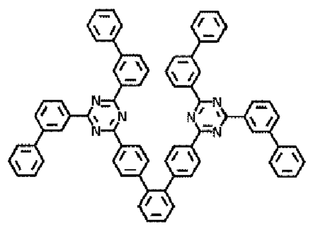

A(139)

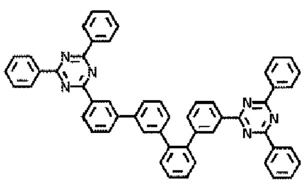

A(140)

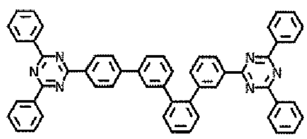

A(141)

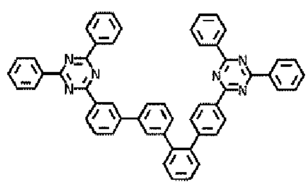

A(142)

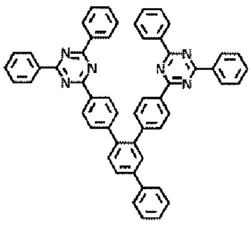

A(143)

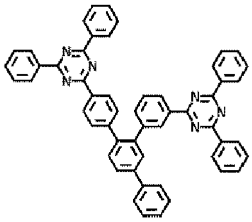

A(144)

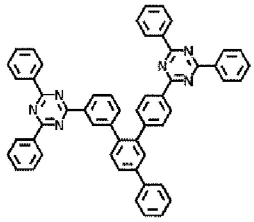

A(145)

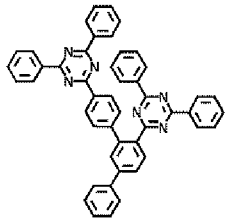

A(146)

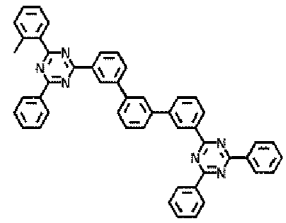

A(147)

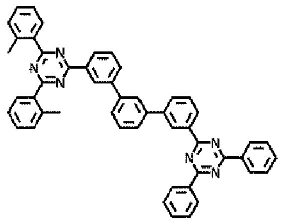

A(148)

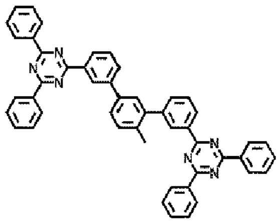

A(149)

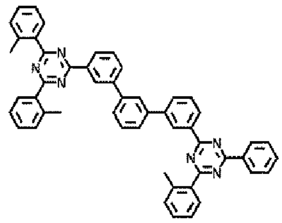

A(150)

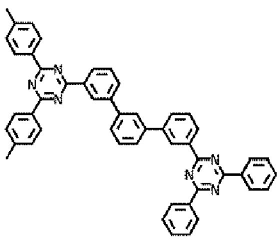

A(151)

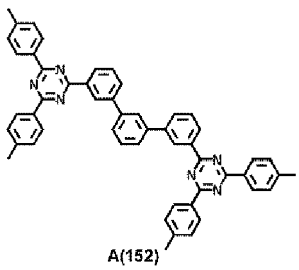

A(152)

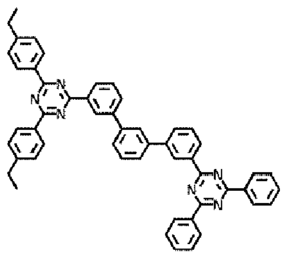

A(153)

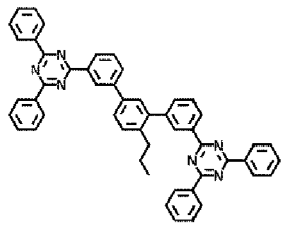

A(154)

Group HE2

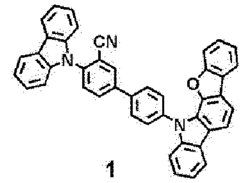
1

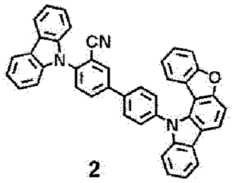
2

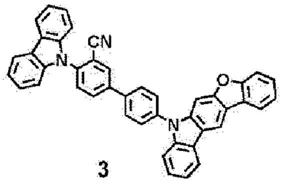
3

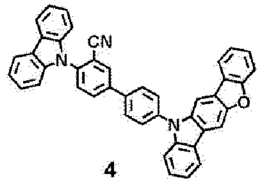
4

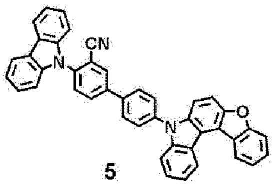
5

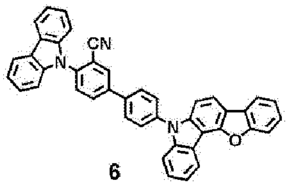
6

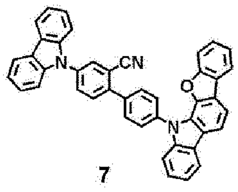
7

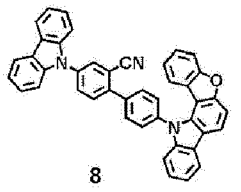
8

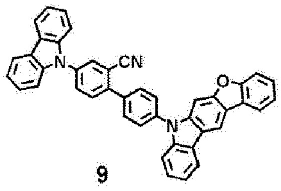
9

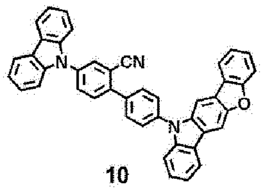
10

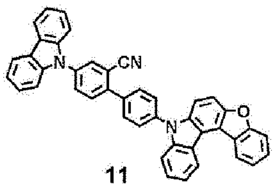
11

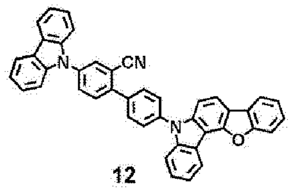
12

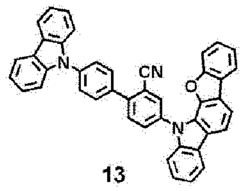
13

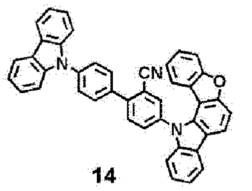
14

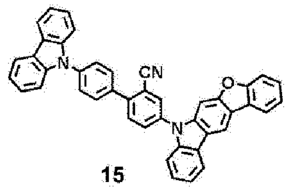
15

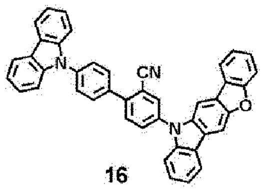
16

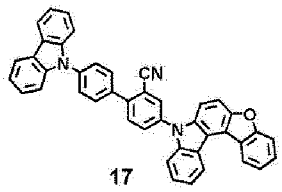
17

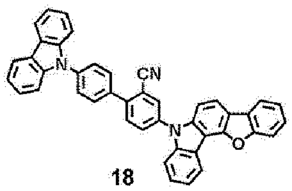
18

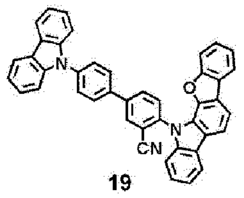
19

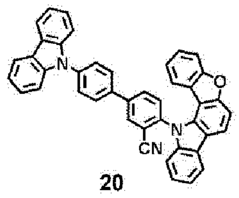
20

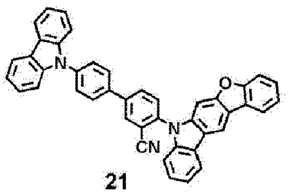
21

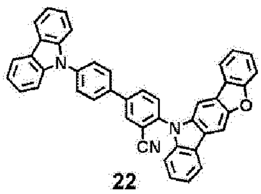
22

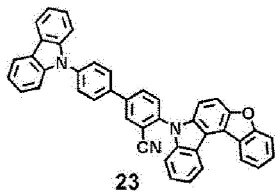
23

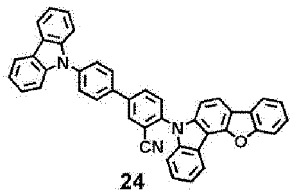
24

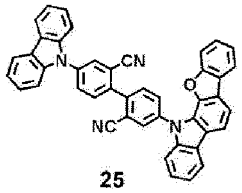

25

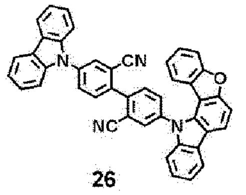

26

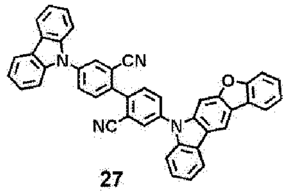

27

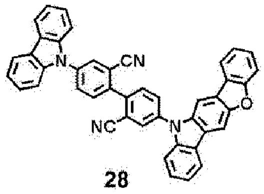

28

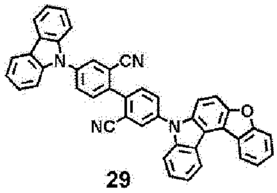

29

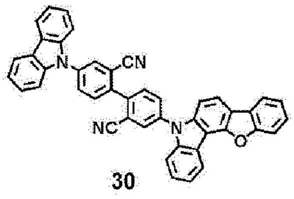

30

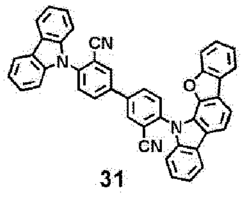

31

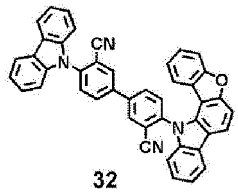

32

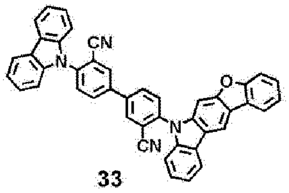

33

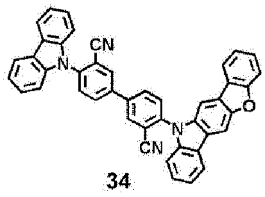

34

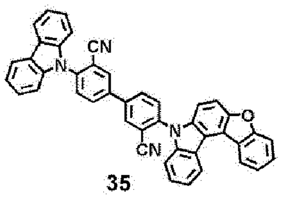

35

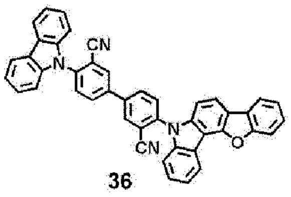

36

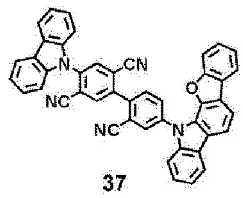

37

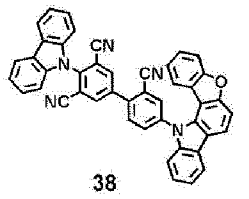

38

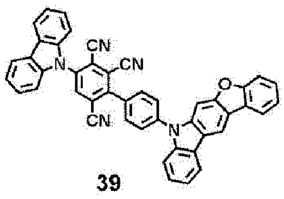

39

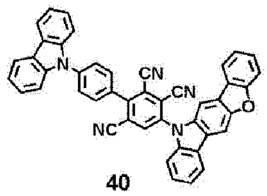

40

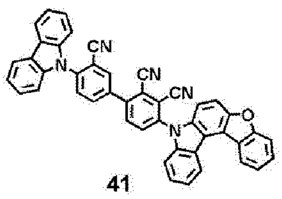

41

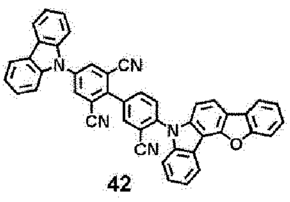

42

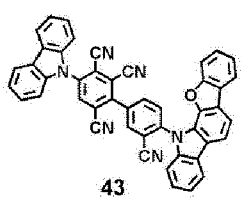

43

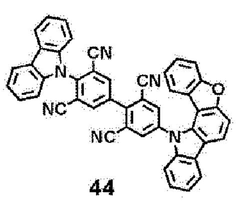

44

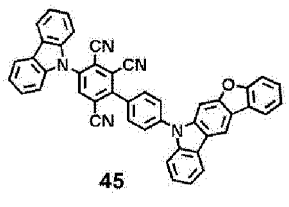

45

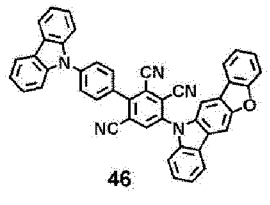

46

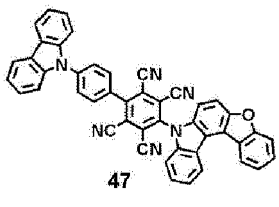

47

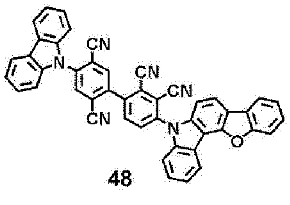

48

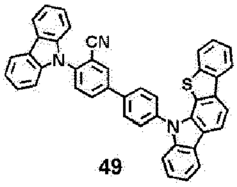
49

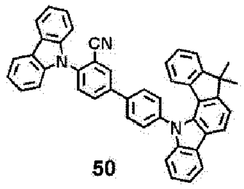
50

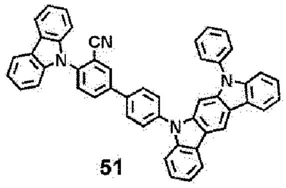
51

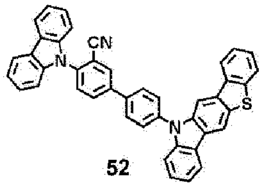
52

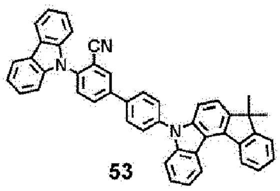
53

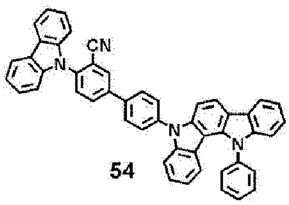
54

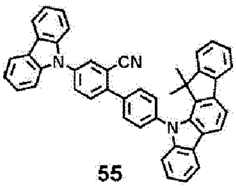
55

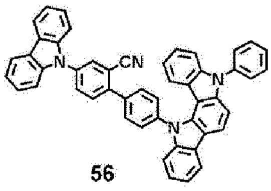
56

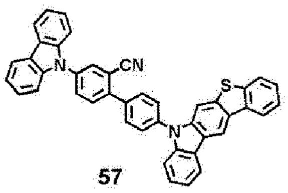
57

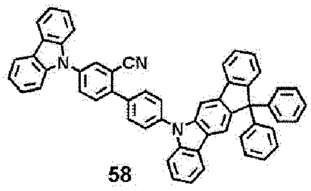
58

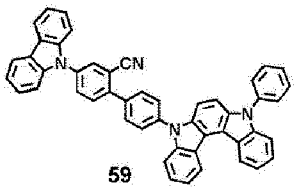
59

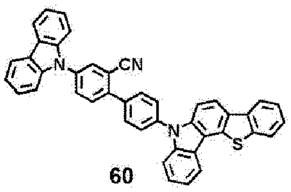
60

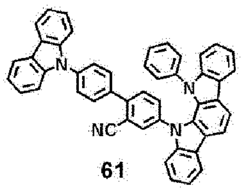
61

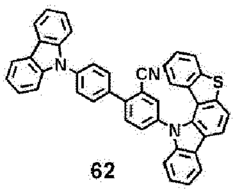
62

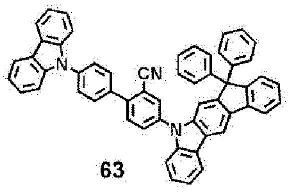
63

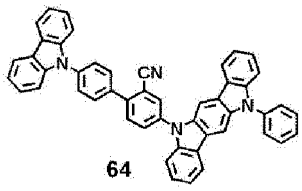
64

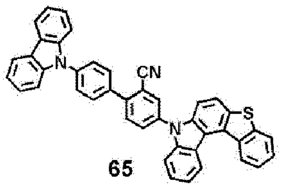
65

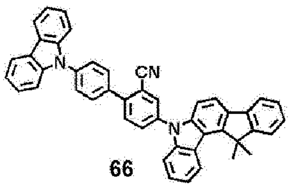
66

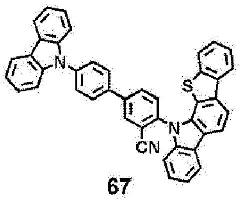
67

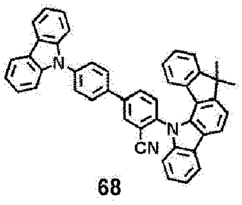
68

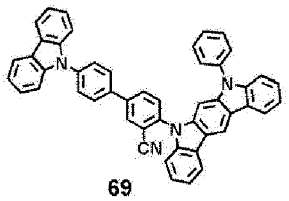
69

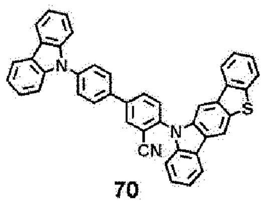
70

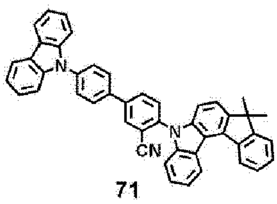
71

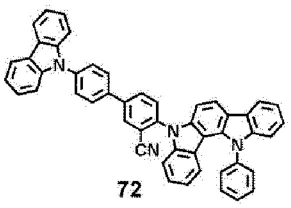
72

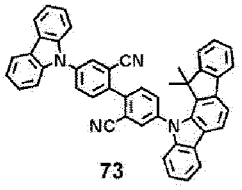
73
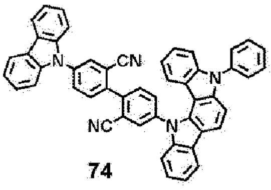
74
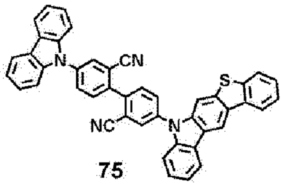
75
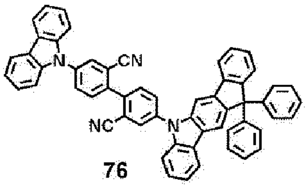
76

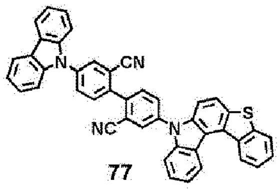
77
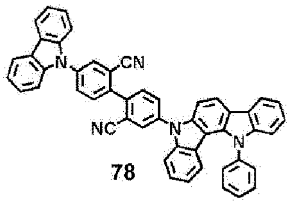
78
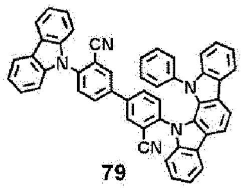
79
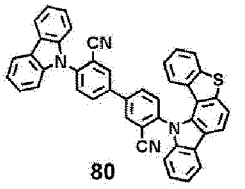
80

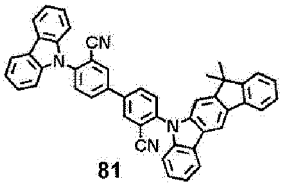
81
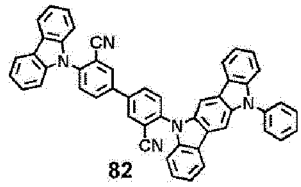
82
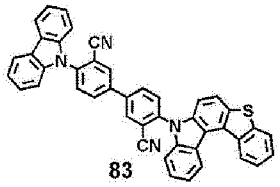
83
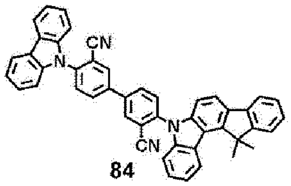
84

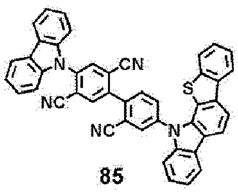
85
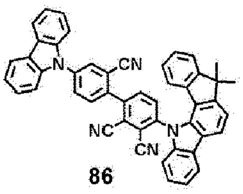
86
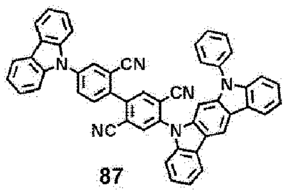
87
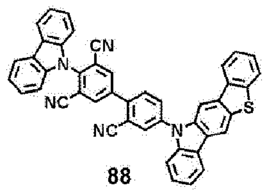
88

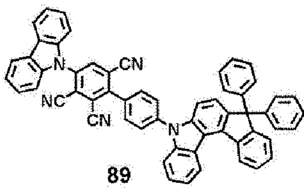
89
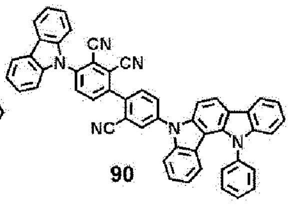
90
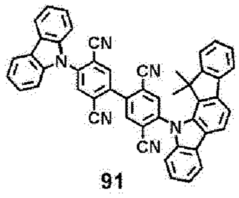
91
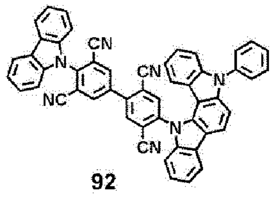
92

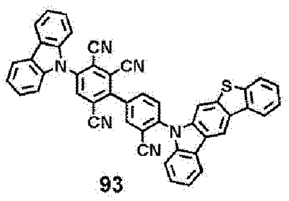
93
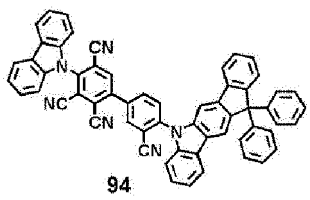
94
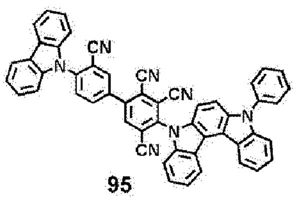
95
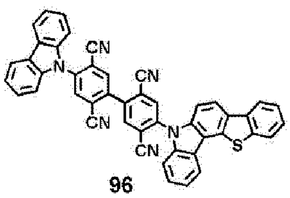
96

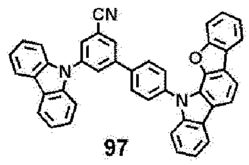
97
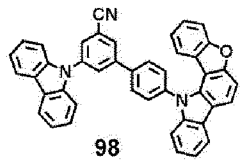
98
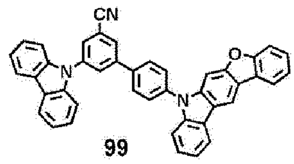
99
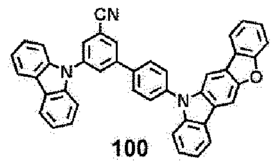
100

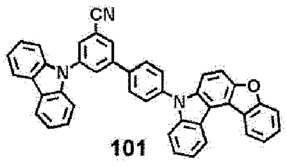
101
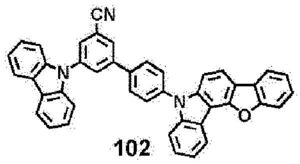
102
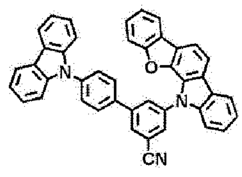
103
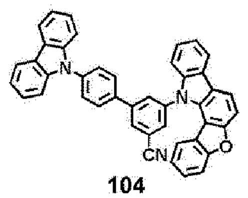
104

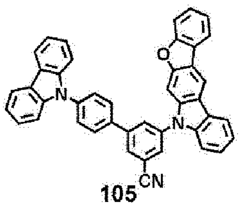
105
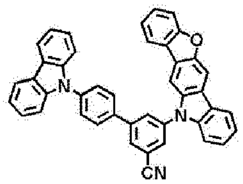
106
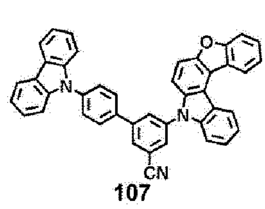
107
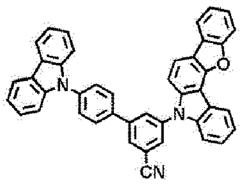
108

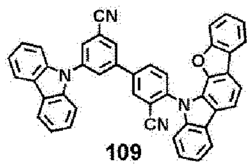
109
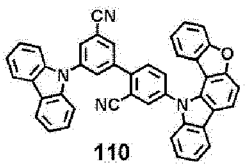
110
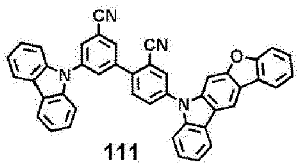
111
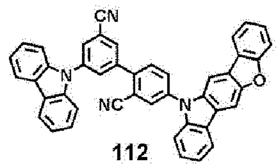
112

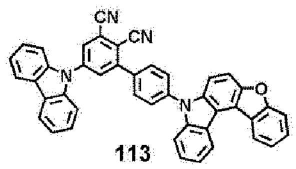
113
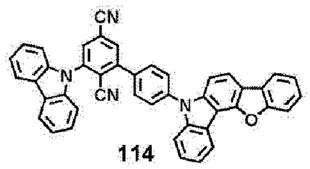
114
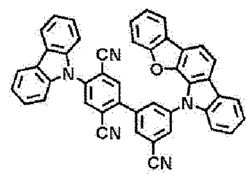
115
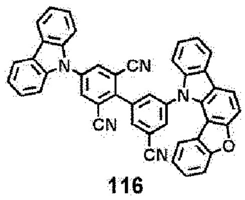
116

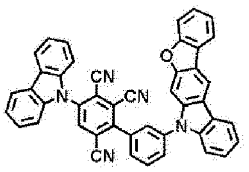
117
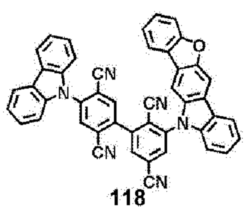
118
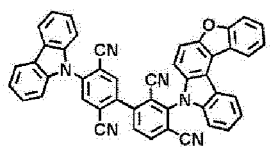
119
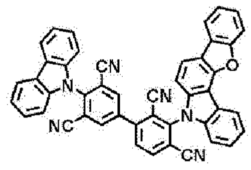
120

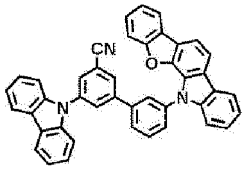
121

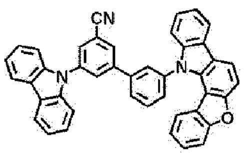
122

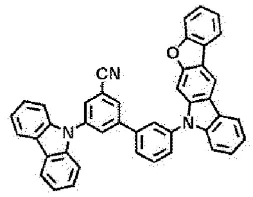
123

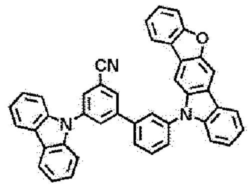
124

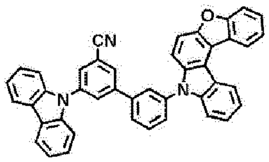
125

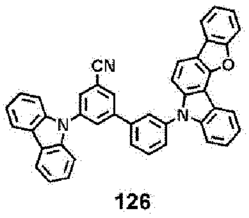
126

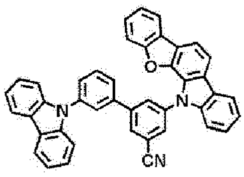
127

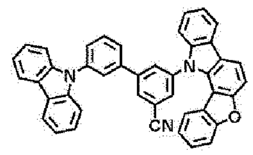
128

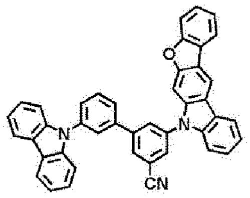
129

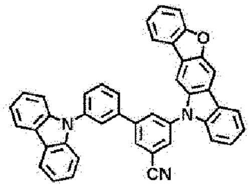
130

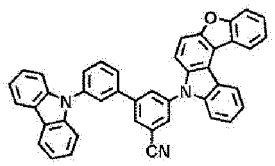
131

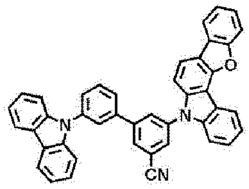
132

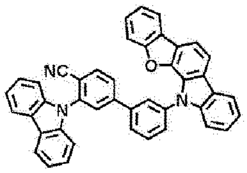
133

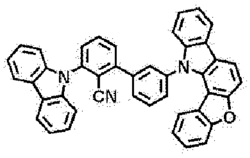
134

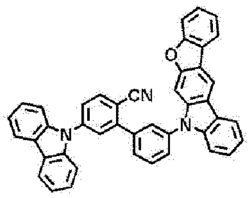
135

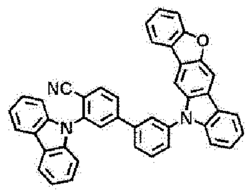
136

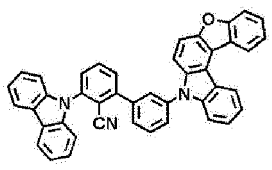
137

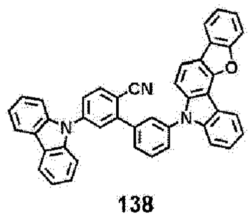
138

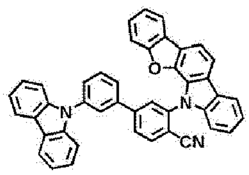
139

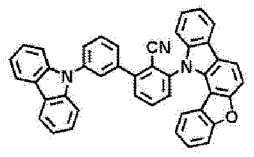
140

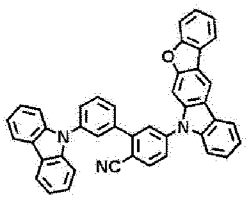
141

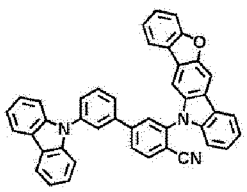
142

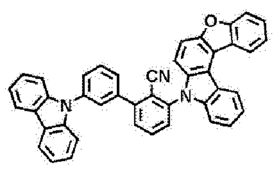
143

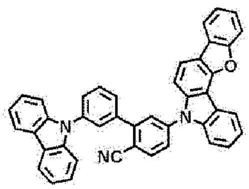
144

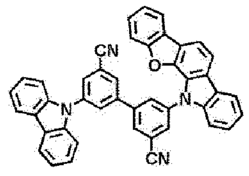
145

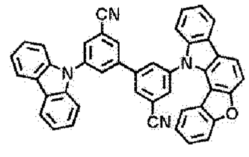
146

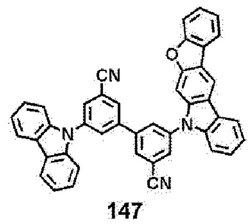
147

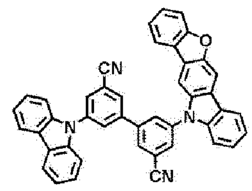
148

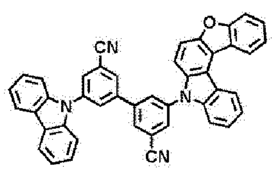
149

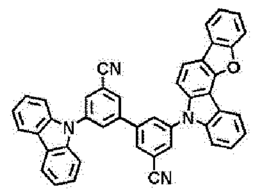
150

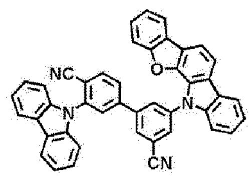
151

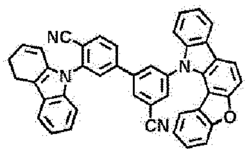
152

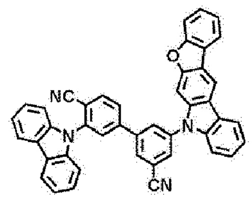
153

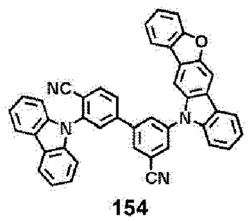
154

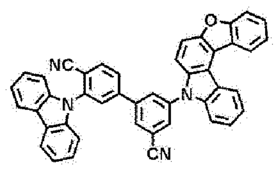
155

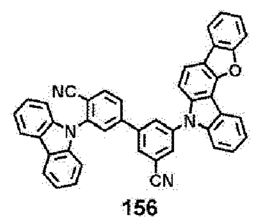
156

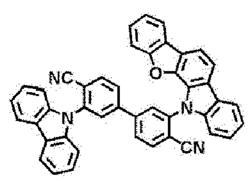
157

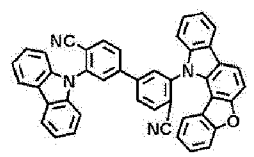
158

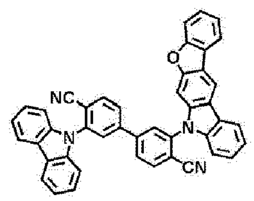
159

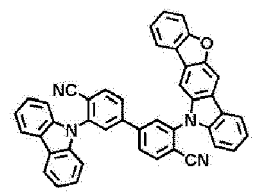
160

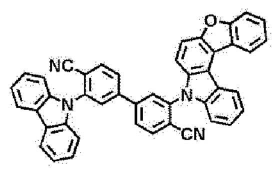
161

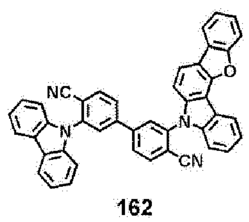
162

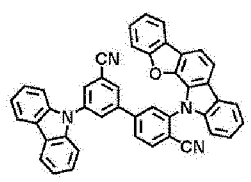
163

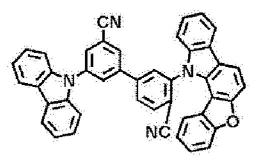
164

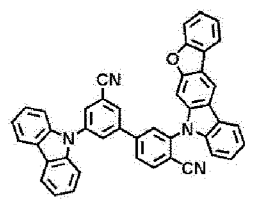
165

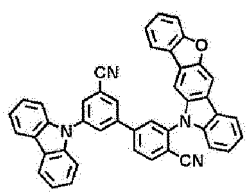
166

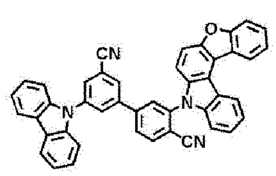
167

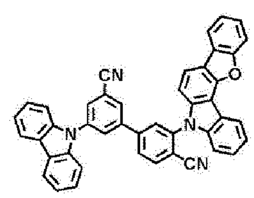
168

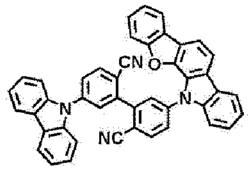
169

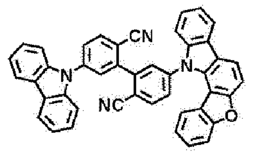
170

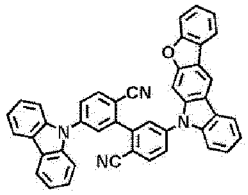
171

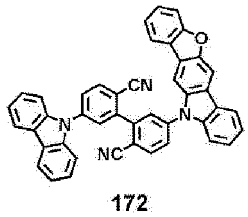
172

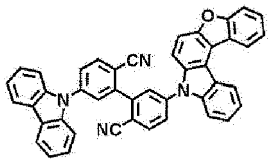
173

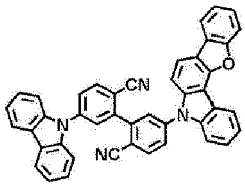
174

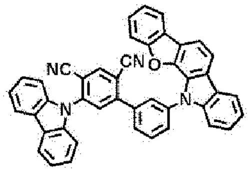
175

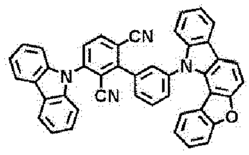
176

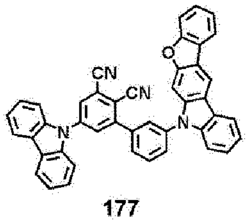
177

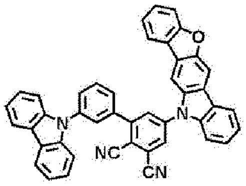
178

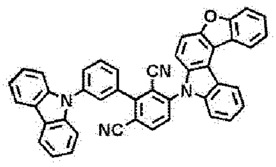
179

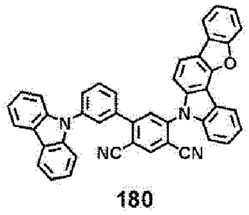
180

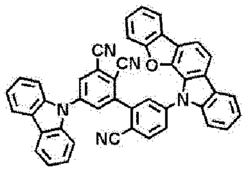
181

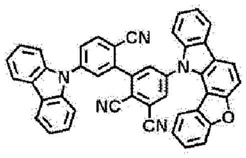
182

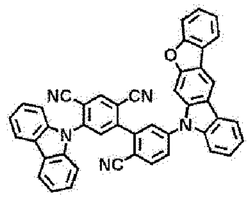
183

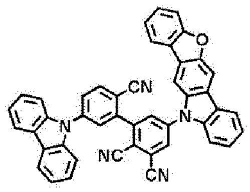
184

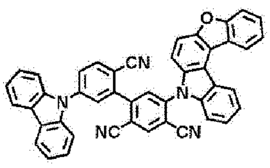
185

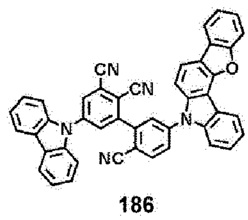
186

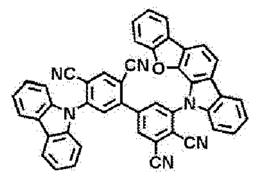
187

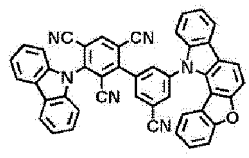
188

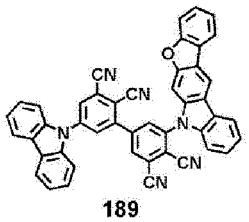
189

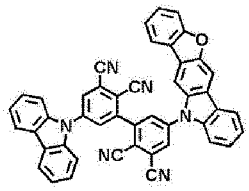
190

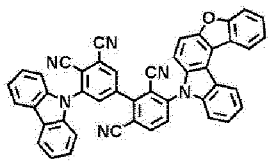
191

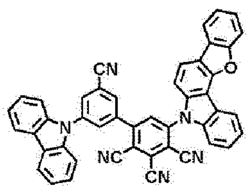
192

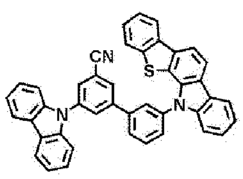
193

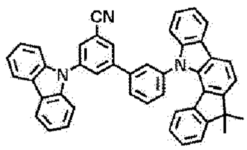
194

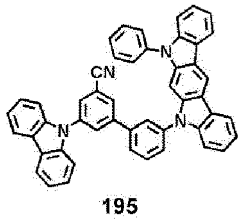
195

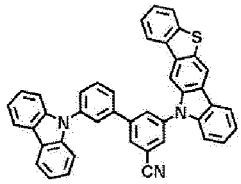
196

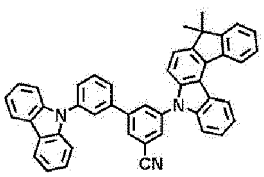
197

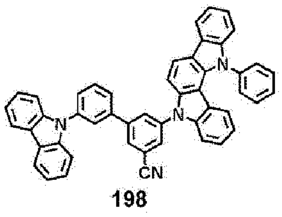
198

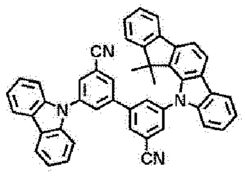
199

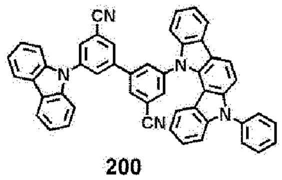
200

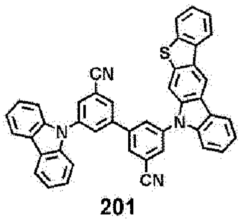
201

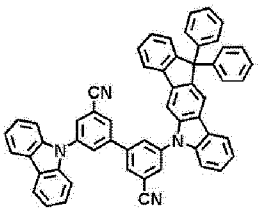
202

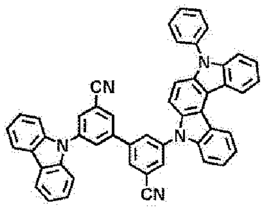
203

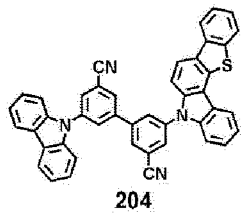
204

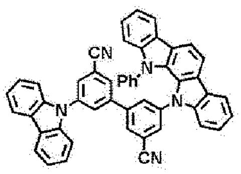
205

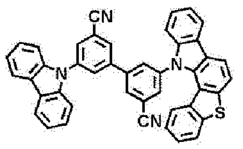
206

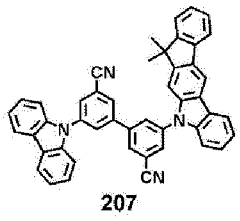
207

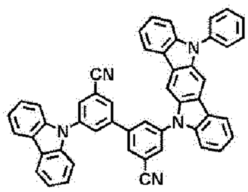
208

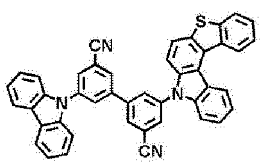
209

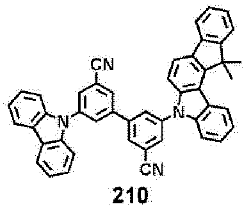
210

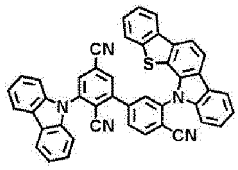
211

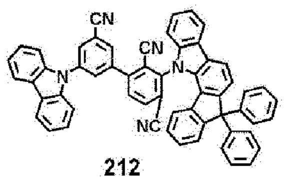
212

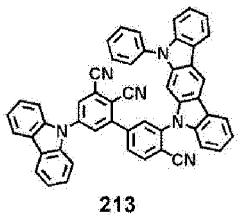
213

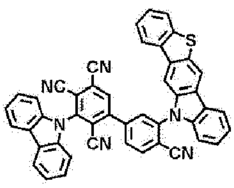
214

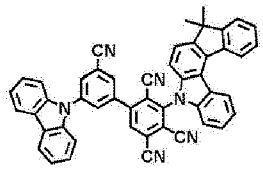
215

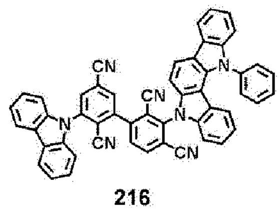
216

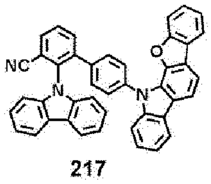
217

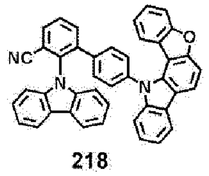
218

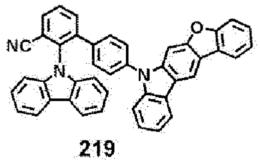
219

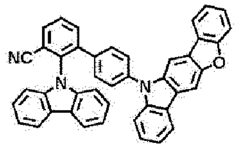
220

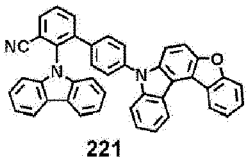
221

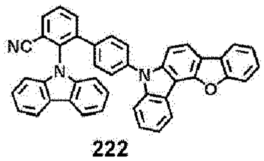
222

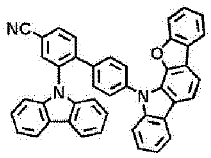
223

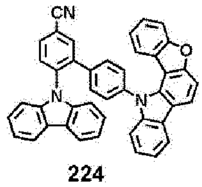
224

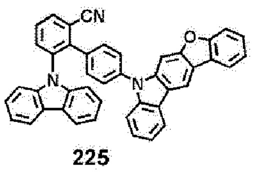
225

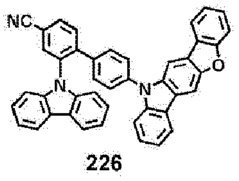
226

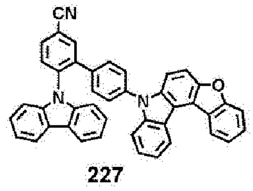
227

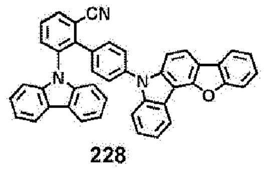
228

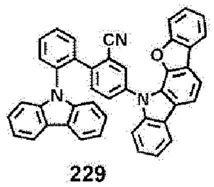
229

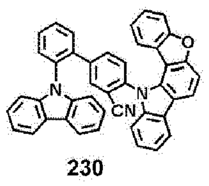
230

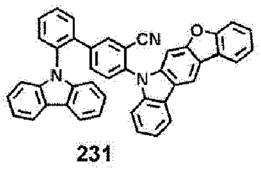
231

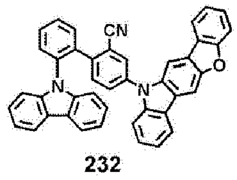
232

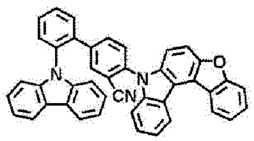
233

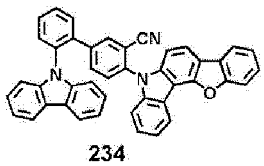
234

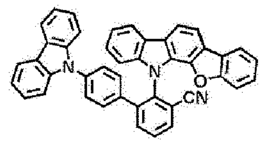
235

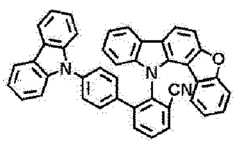
236

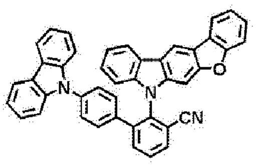
237

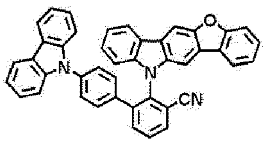
238

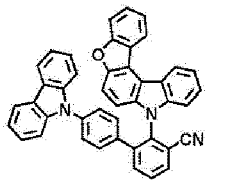
239

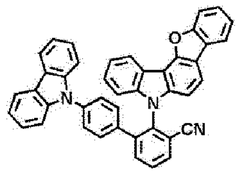
240

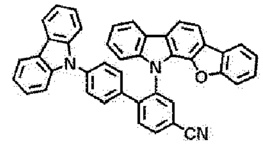
241

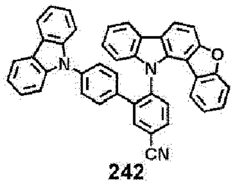
242

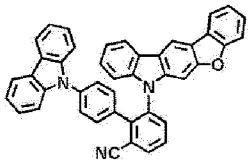
243

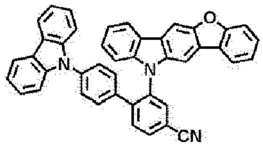
244

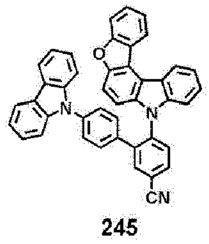
245

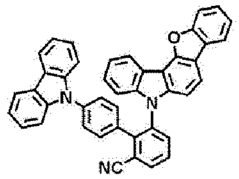
246

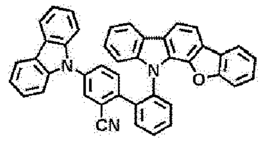
247

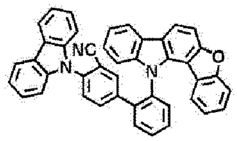
248

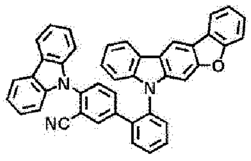
249

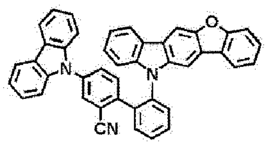
250

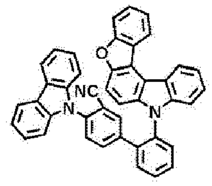
251

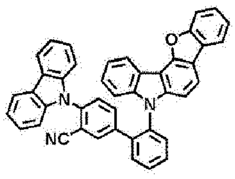
252

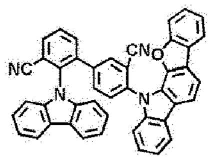
253

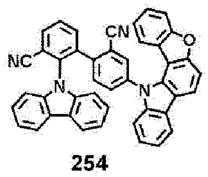
254

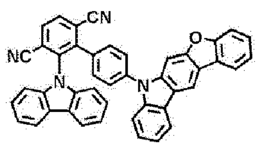
255

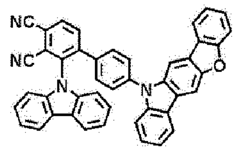
256

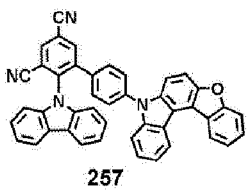
257

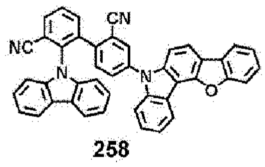
258

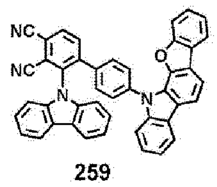
259

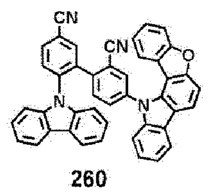
260

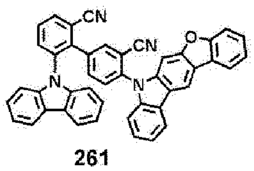
261

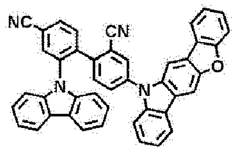
262

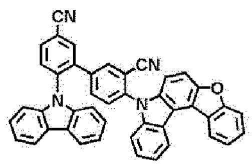
263

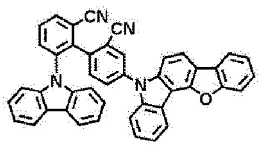
264

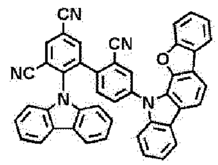
265
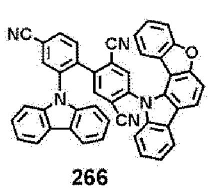
266
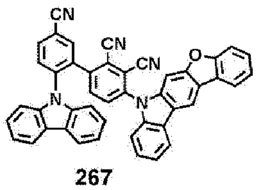
267
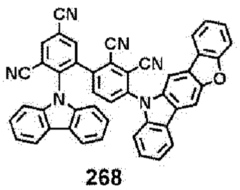
268

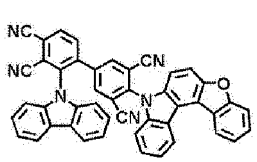
269
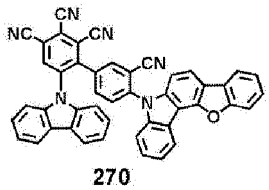
270
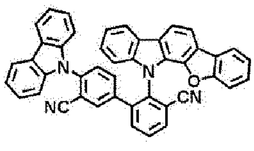
271
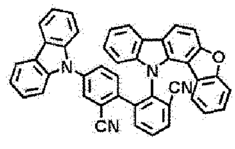
272

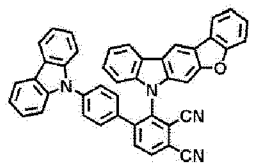
273
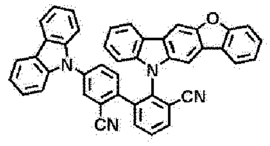
274
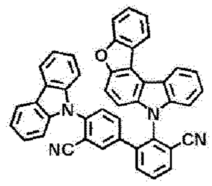
275
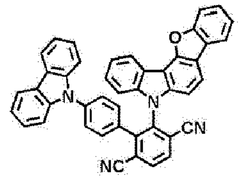
276

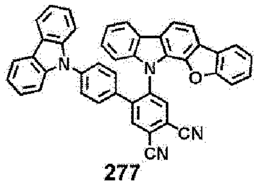
277
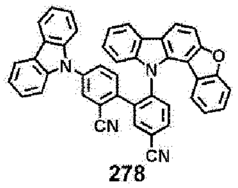
278
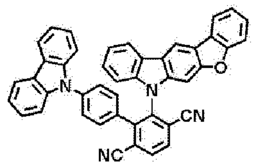
279
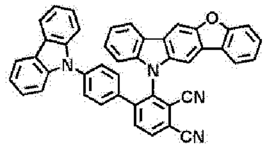
280

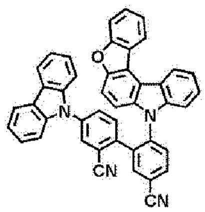
281
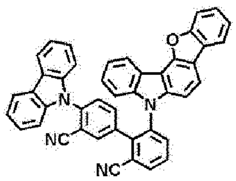
282
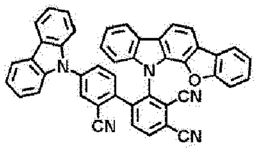
283
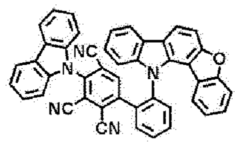
284

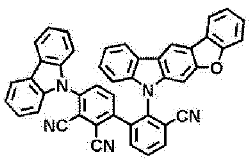
285
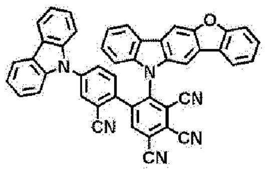
286
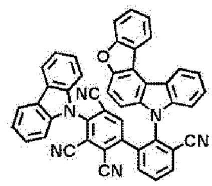
287
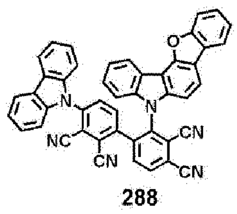
288

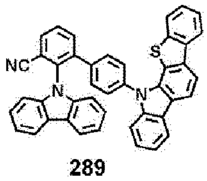
289

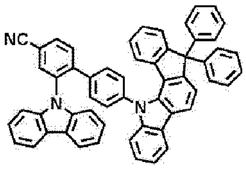
290

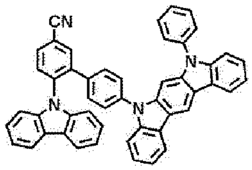
291

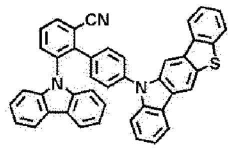
292

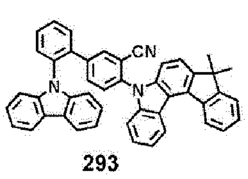
293

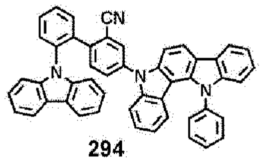
294

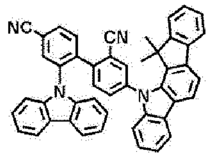
295

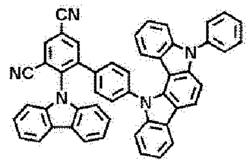
296

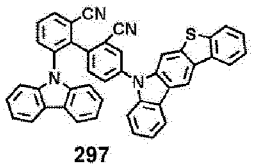
297

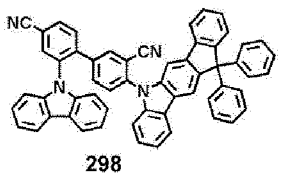
298

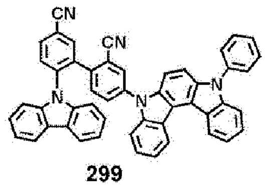
299

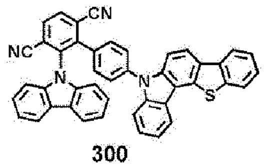
300

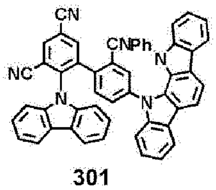
301

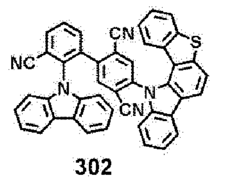
302

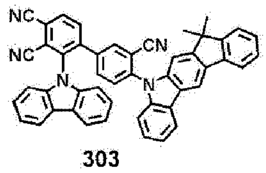
303

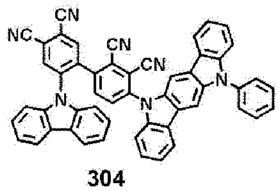
304

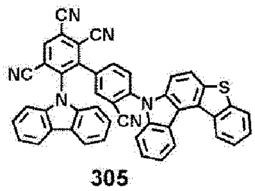
305

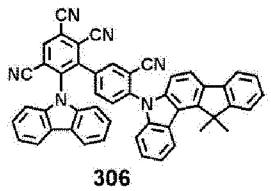
306

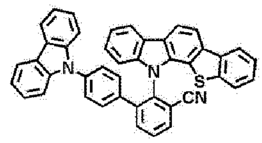
307

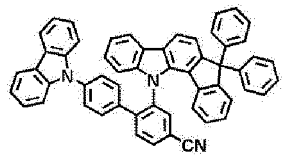
308

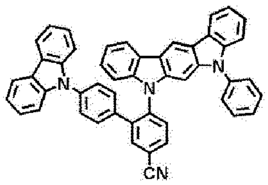
309

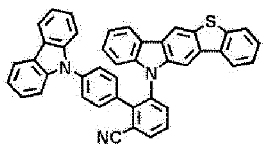
310

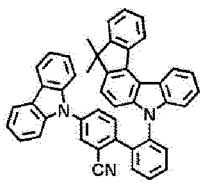
311

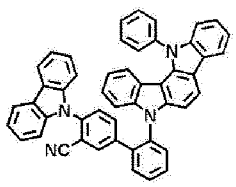
312

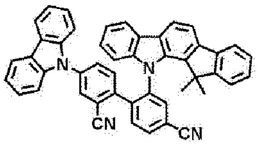
313

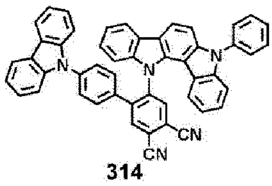
314

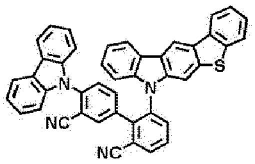
315

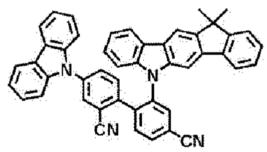
316

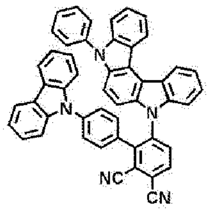
317

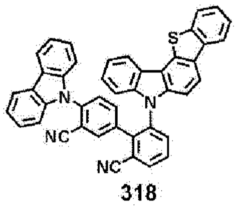
318

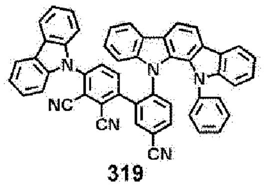
319

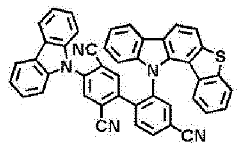
320

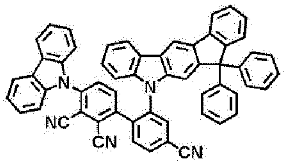
321

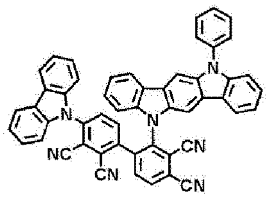
322

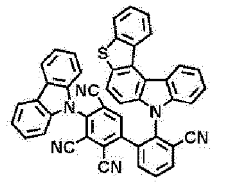
323

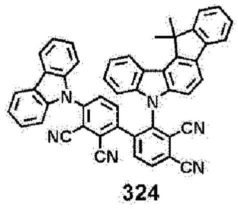
324

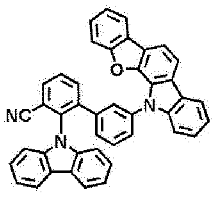
325

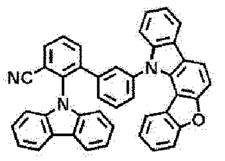
326

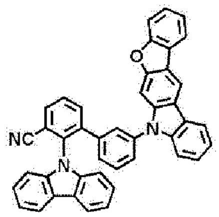
327

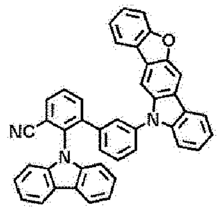
328

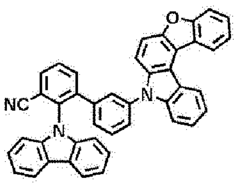
329

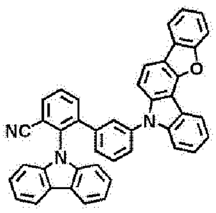
330

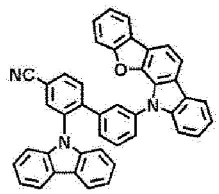
331

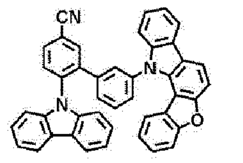
332

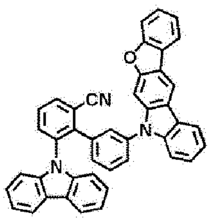
333

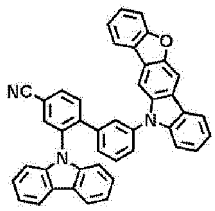
334

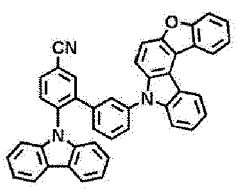
335

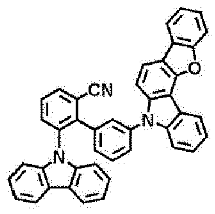
336

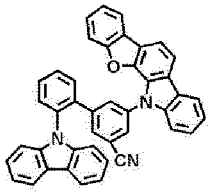
337

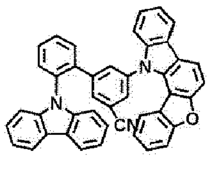
338

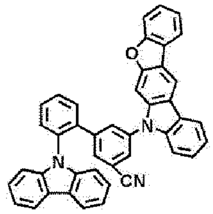
339

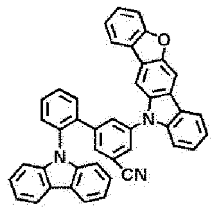
340

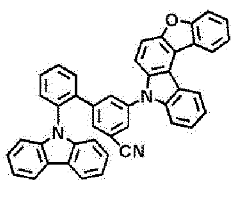
341

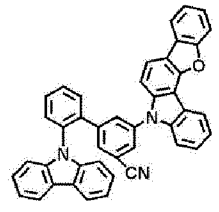
342

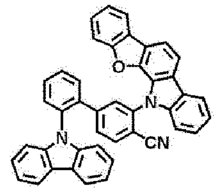
343

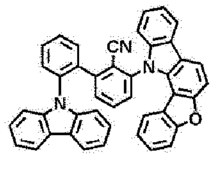
344

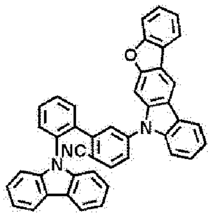
345

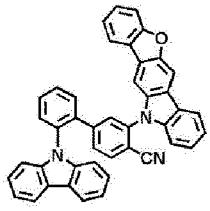
346

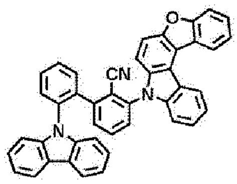
347

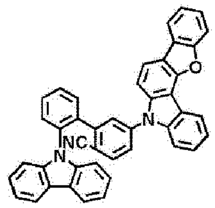
348

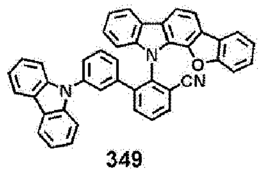
349

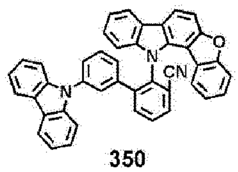
350

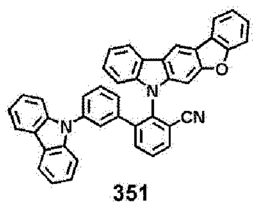
351

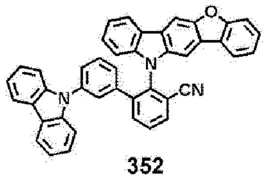
352

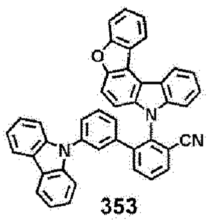
353

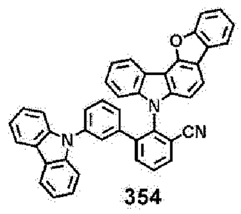
354

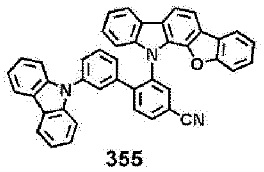
355

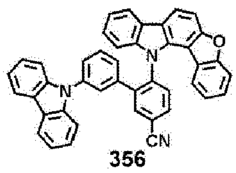
356

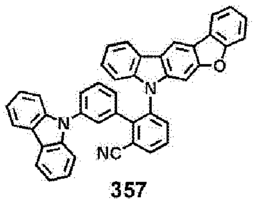
357

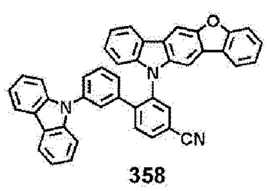
358

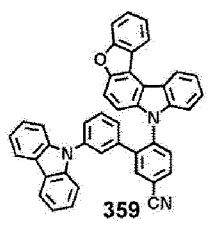
359

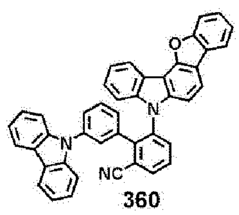
360

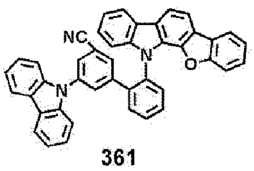
361
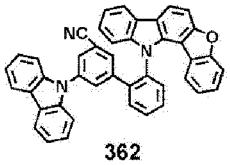
362
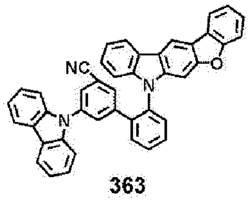
363
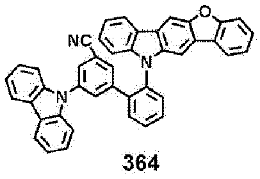
364

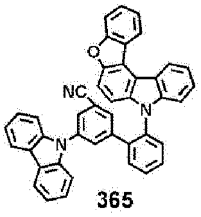
365
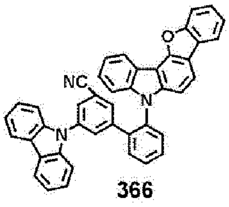
366
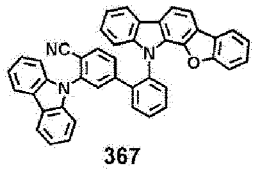
367
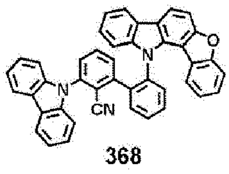
368

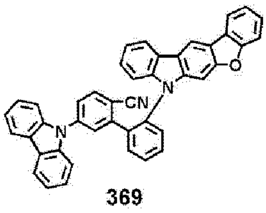
369
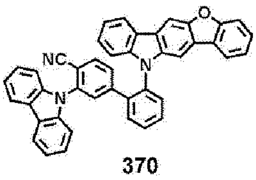
370
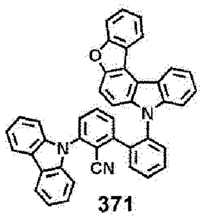
371
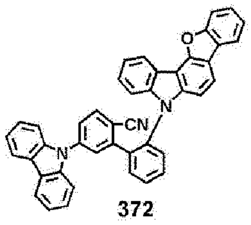
372

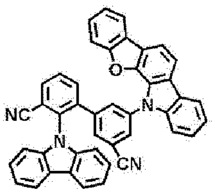
373
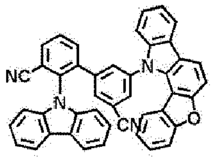
374
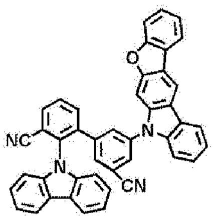
375
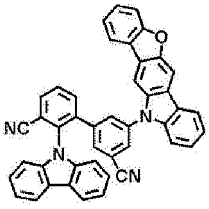
376

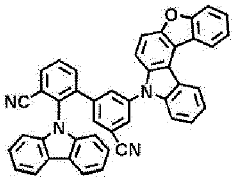
377
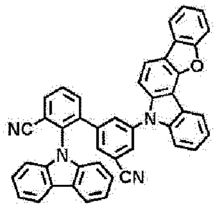
378
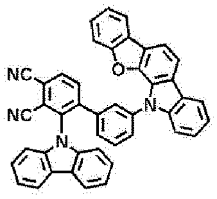
379
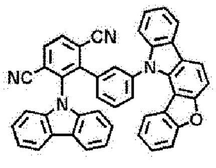
380

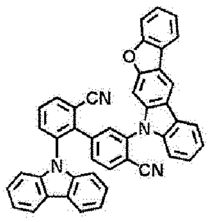
381
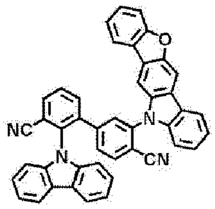
382
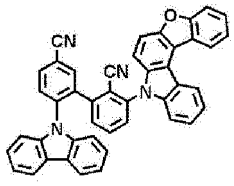
383
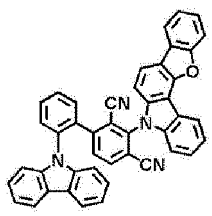
384

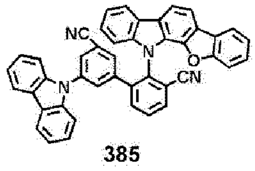
385

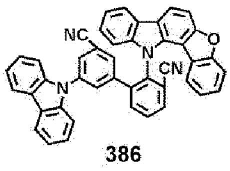
386

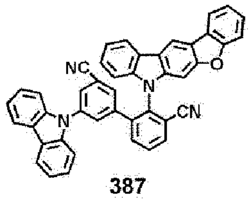
387

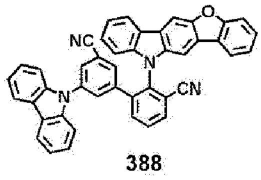
388

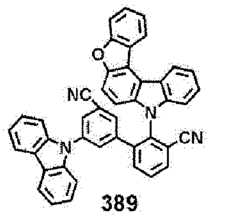
389

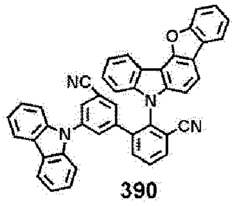
390

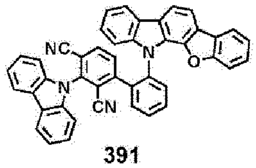
391

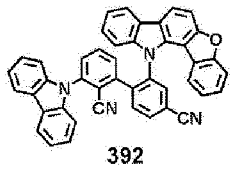
392

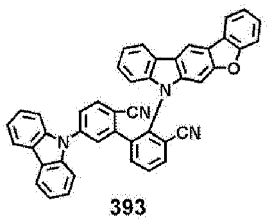
393

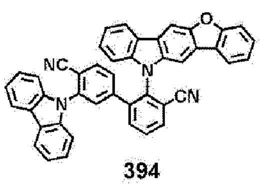
394

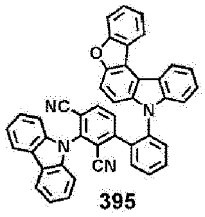
395

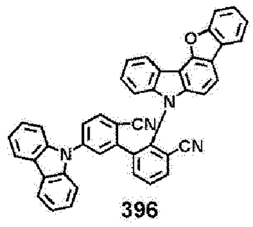
396

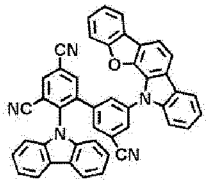
397

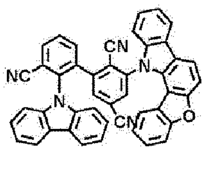
398

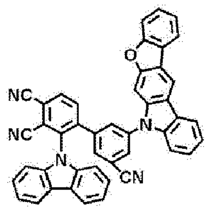
399

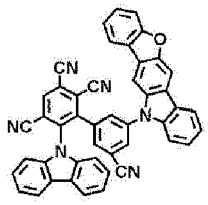
400

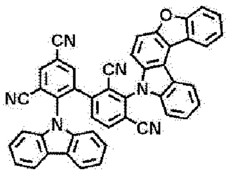
401

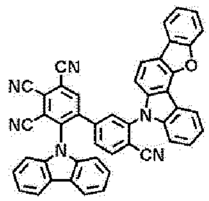
402

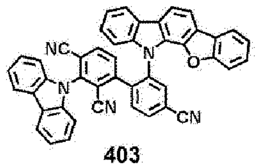
403

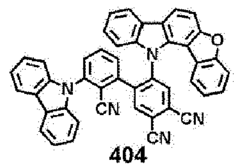
404

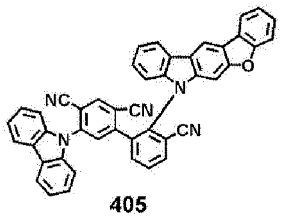
405

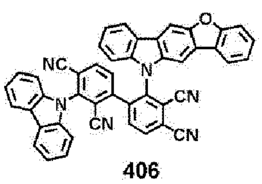
406

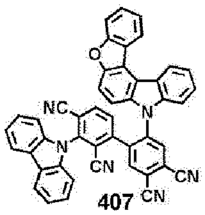
407

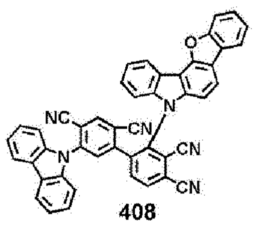
408

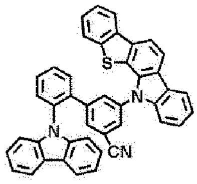
409

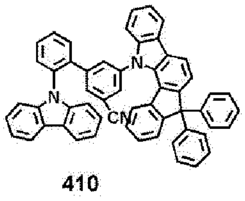
410

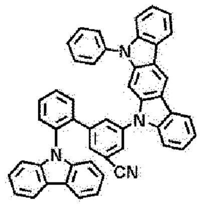
411

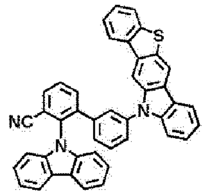
412

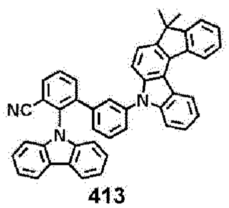
413

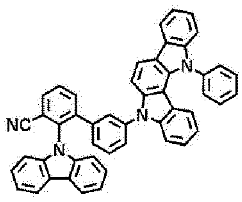
414

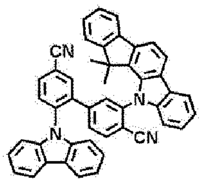
415

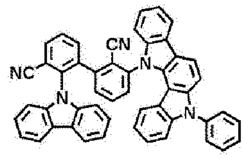
416

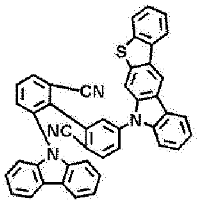
417

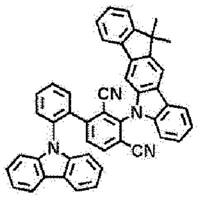
418

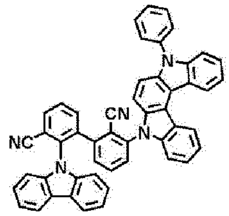
419

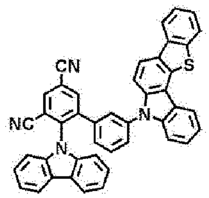
420

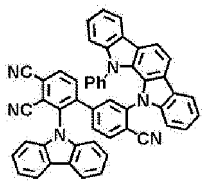
421

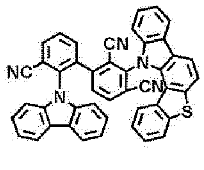
422

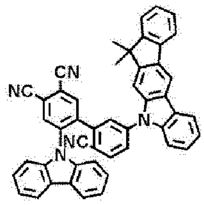
423

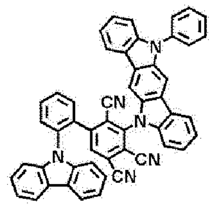
424

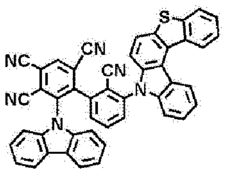
425

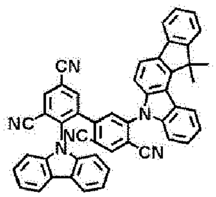
426

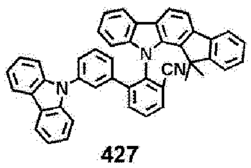
427

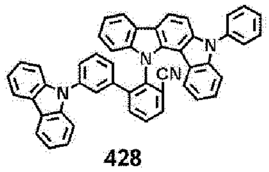
428

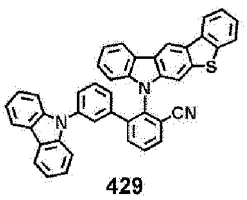
429

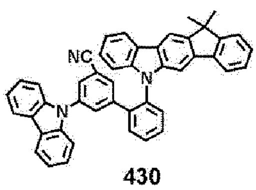
430

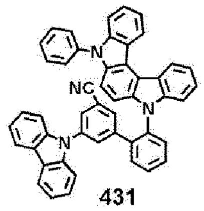
431

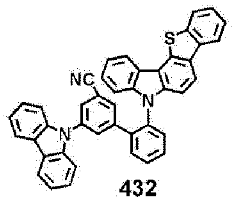
432

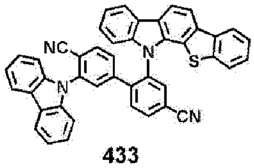
433

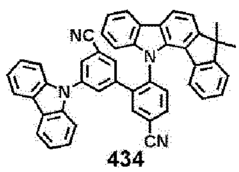
434

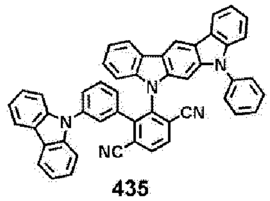
435

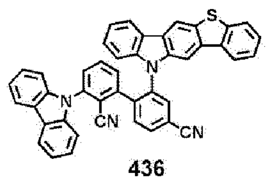
436

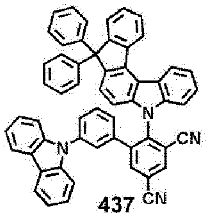
437

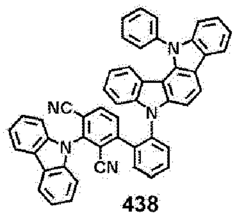
438

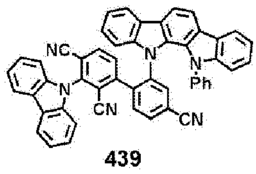
439

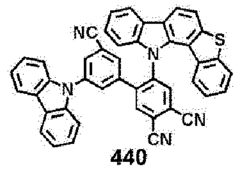
440

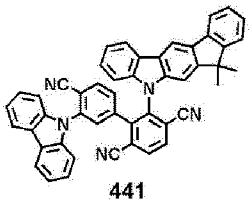
441

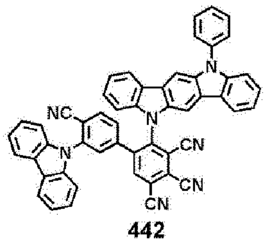
442

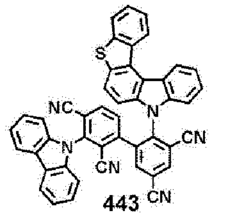
443

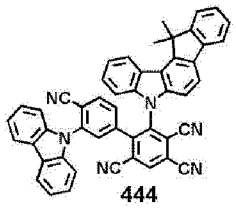
444

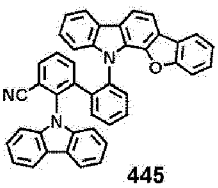
445

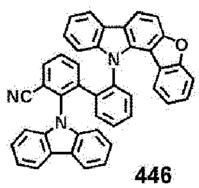
446

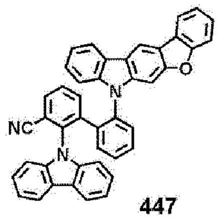
447

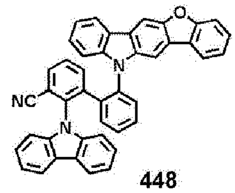
448

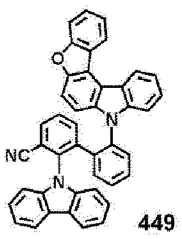
449

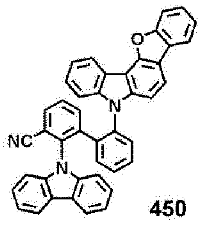
450

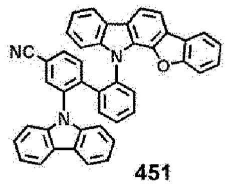
451

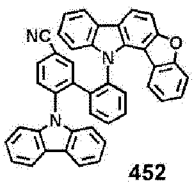
452

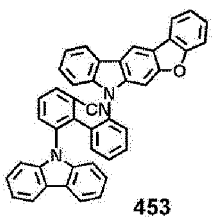
453

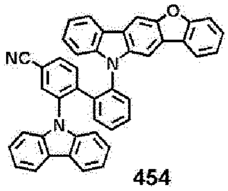
454

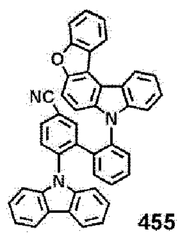
455

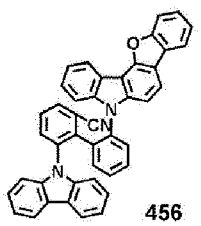
456

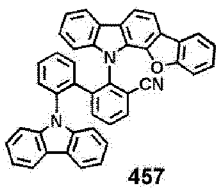 457
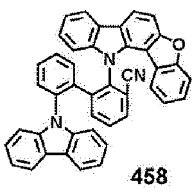 458
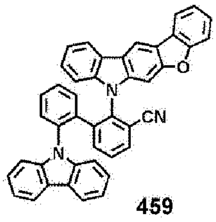 459
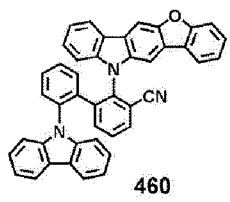 460

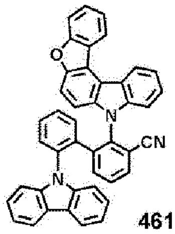 461
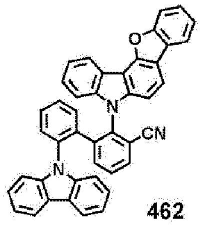 462
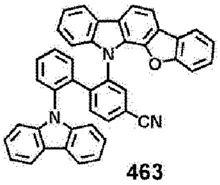 463
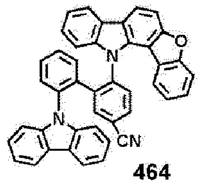 464

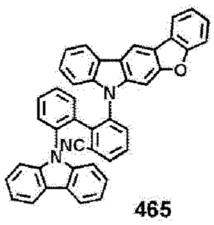 465
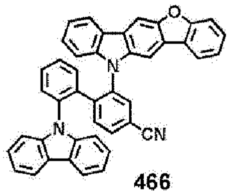 466
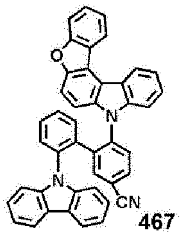 467
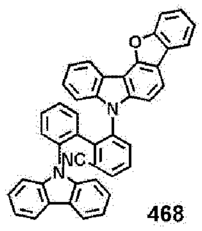 468

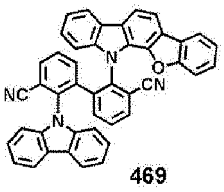 469
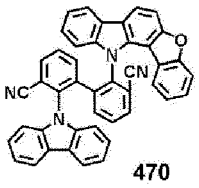 470
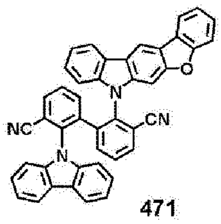 471
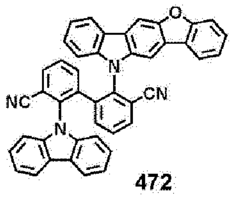 472

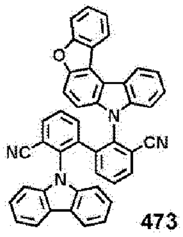 473
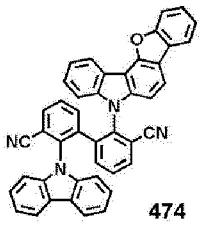 474
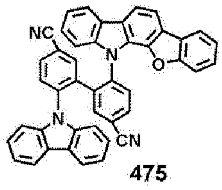 475
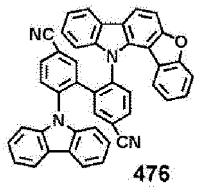 476

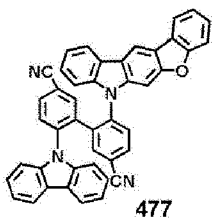 477
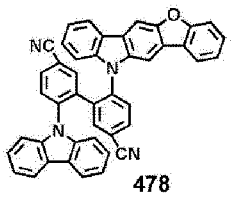 478
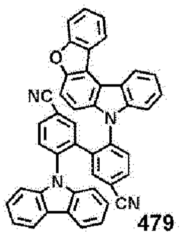 479
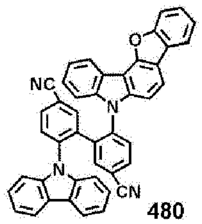 480

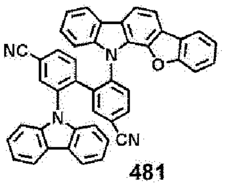
481
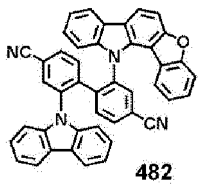
482
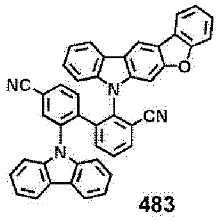
483
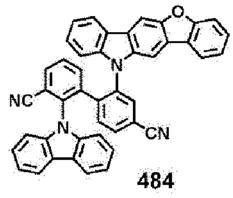
484
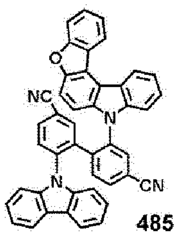
485
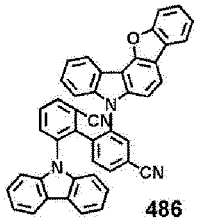
486
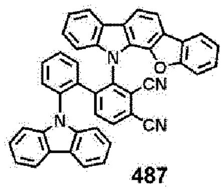
487
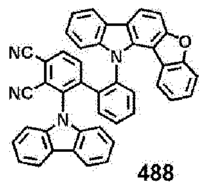
488
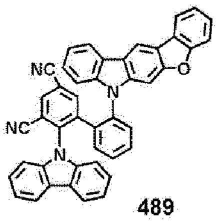
489
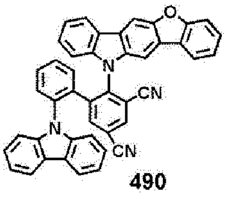
490
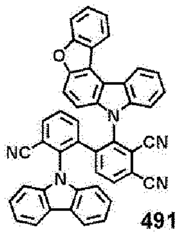
491
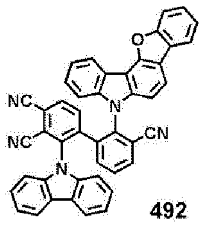
492
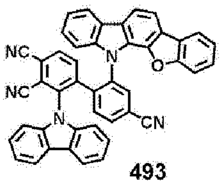
493
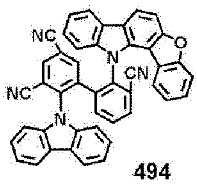
494
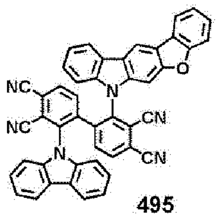
495
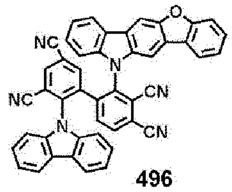
496
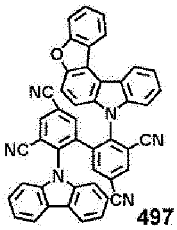
497
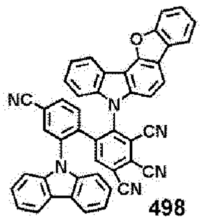
498
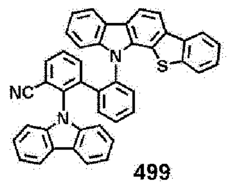
499
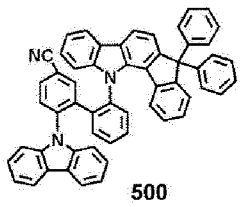
500
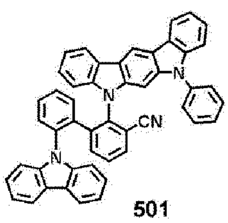
501
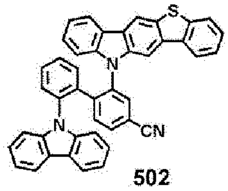
502
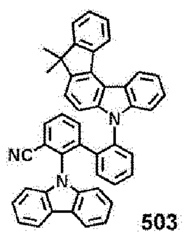
503
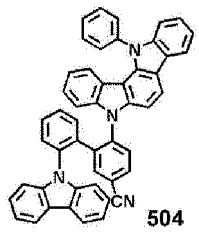
504

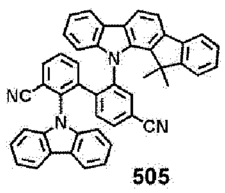
505

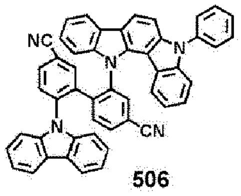
506

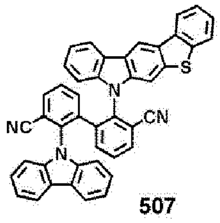
507

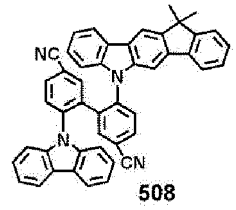
508

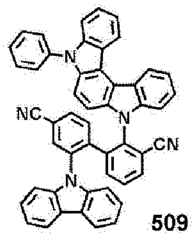
509

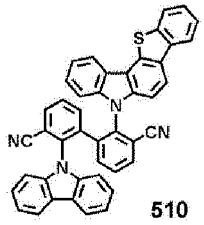
510

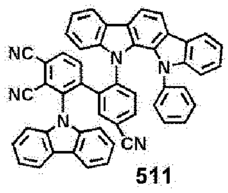
511

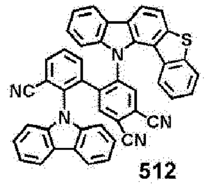
512

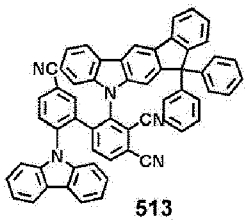
513

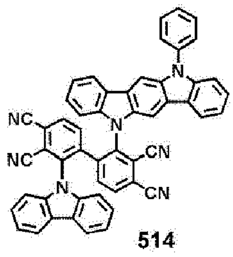
514

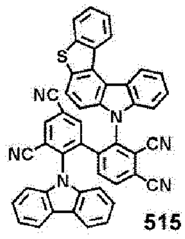
515

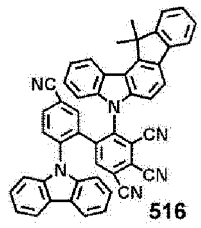
516

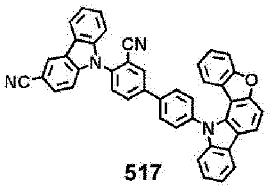
517

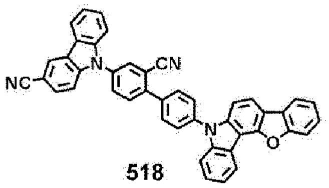
518

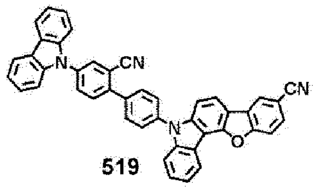
519

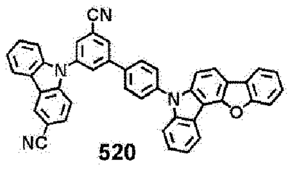
520

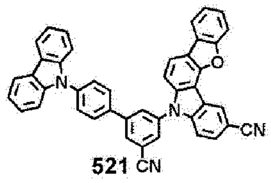
521

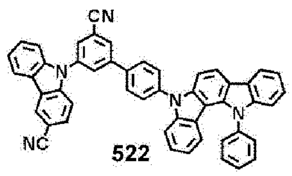
522

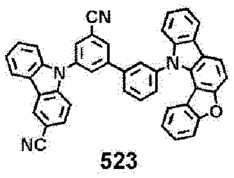
523

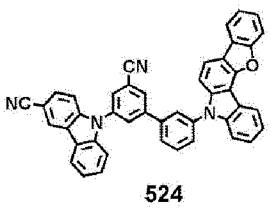
524

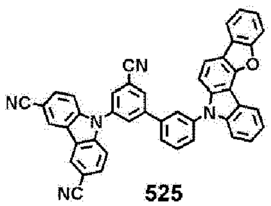
525

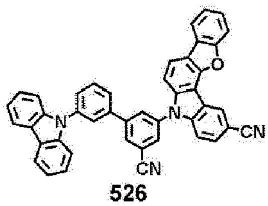
526

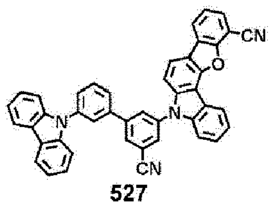
527

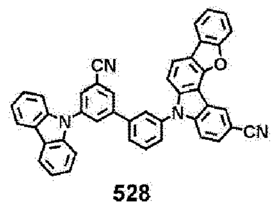
528

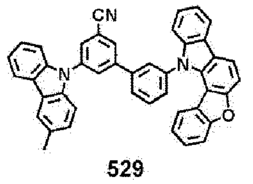
529

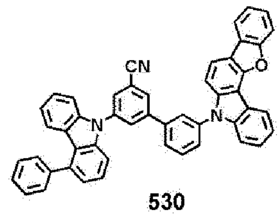
530

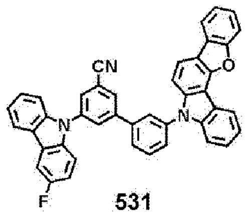
531

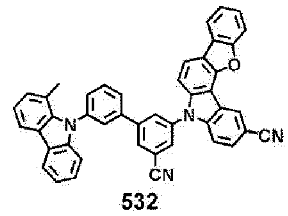
532

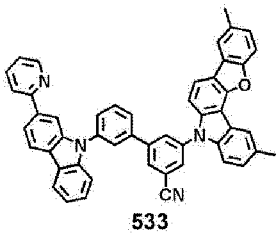
533

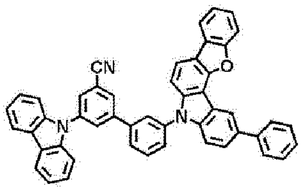
534

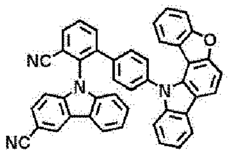
535

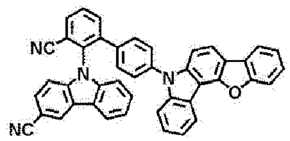
536

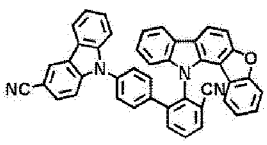
537

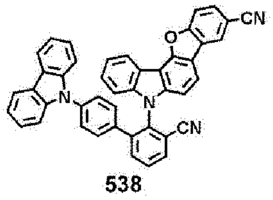
538

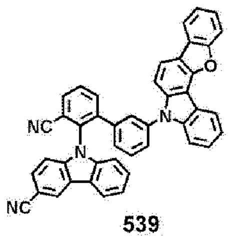
539

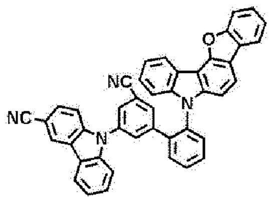
540

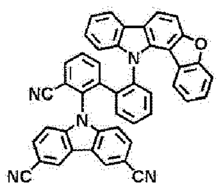
541

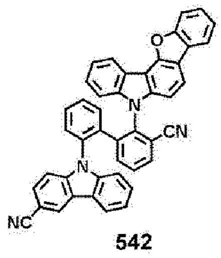
542

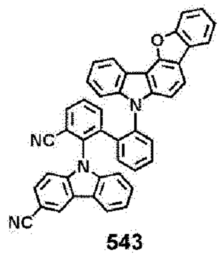
543

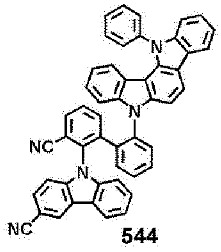
544

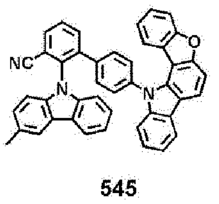
545

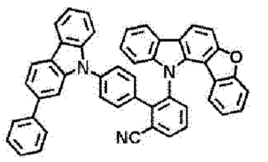
546

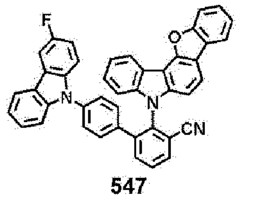
547

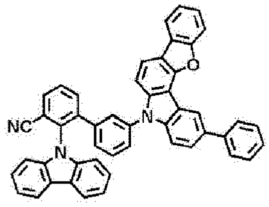
548

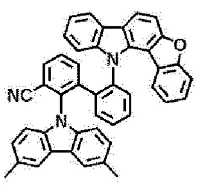
549

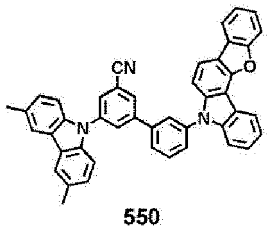
550

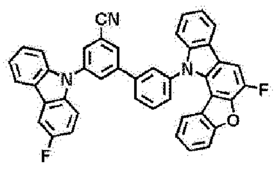
551

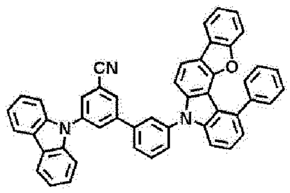
552

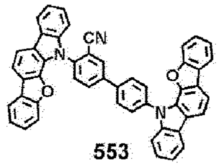
553
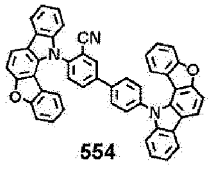
554
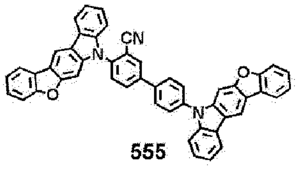
555
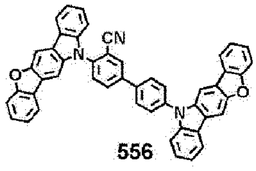
556

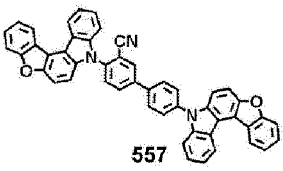
557
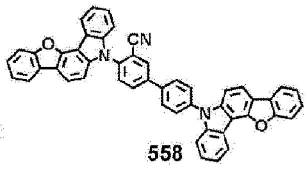
558
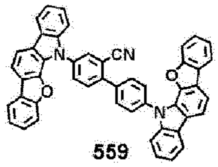
559
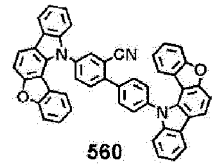
560

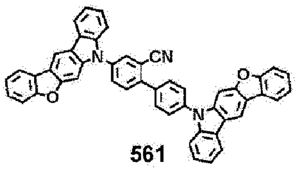
561
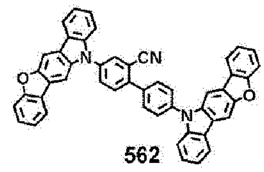
562
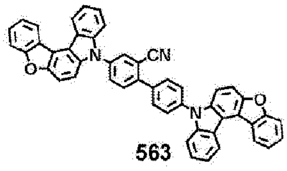
563
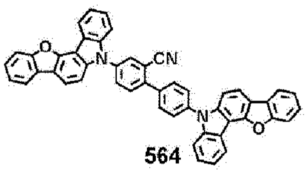
564

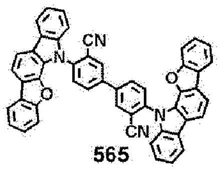
565
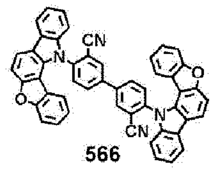
566
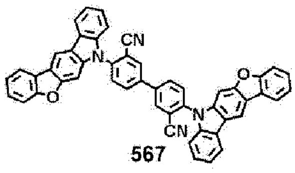
567
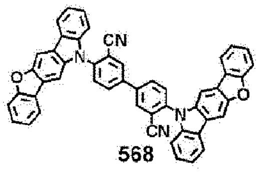
568

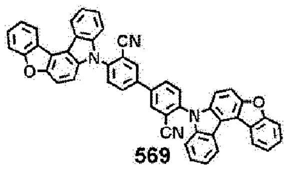
569
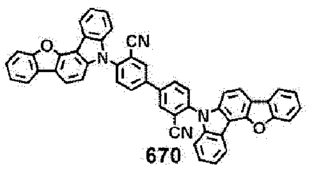
670
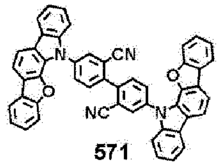
571
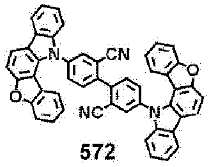
572

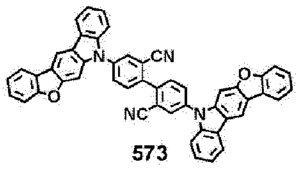
573
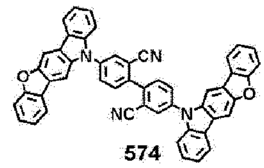
574
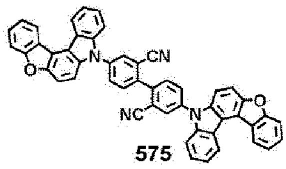
575
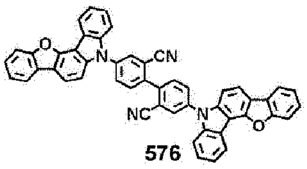
576

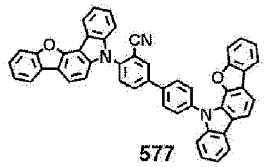
577
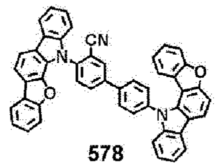
578
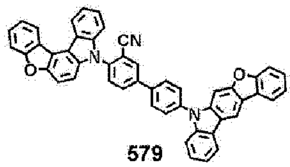
579
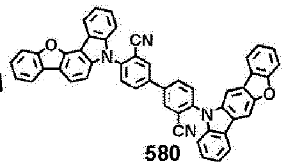
580

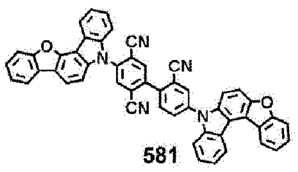
581
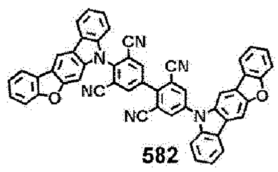
582
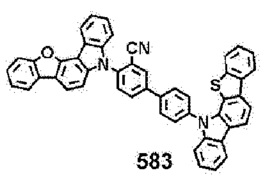
583
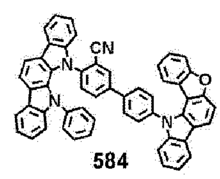
584

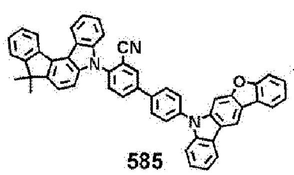
585
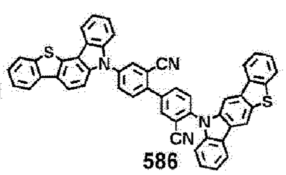
586
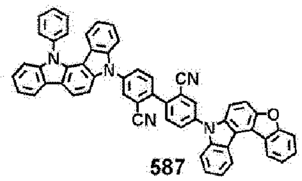
587
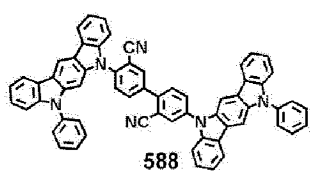
588

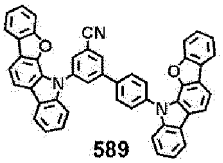
589

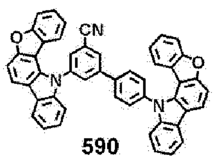
590

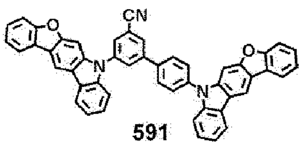
591

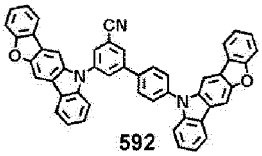
592

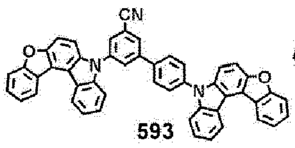
593

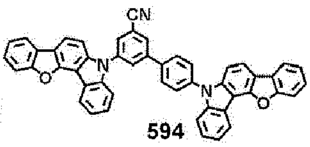
594

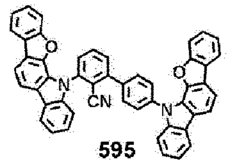
595

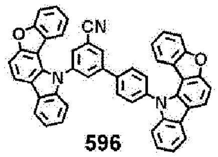
596

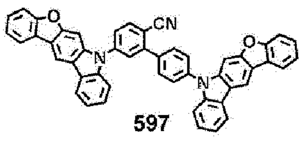
597

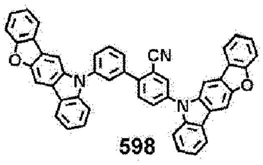
598

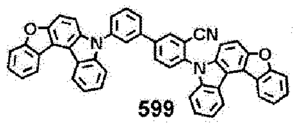
599

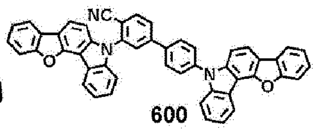
600

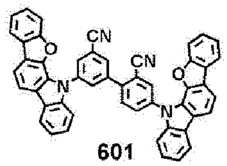
601

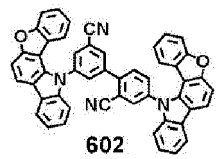
602

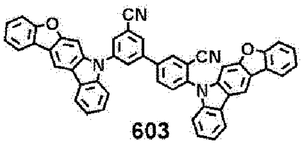
603

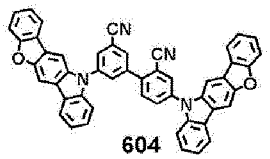
604

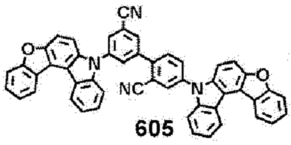
605

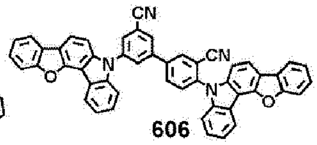
606

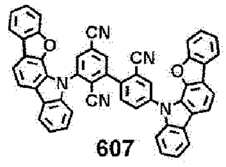
607

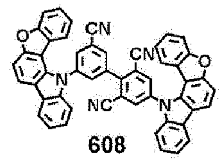
608

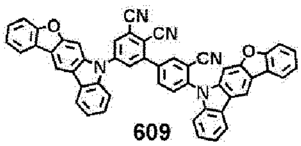
609

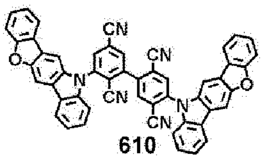
610

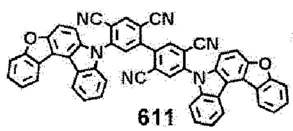
611

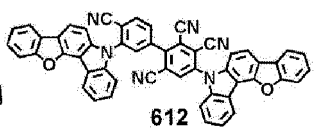
612

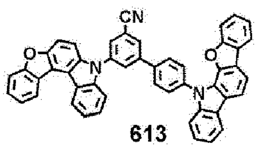
613

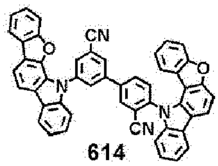
614

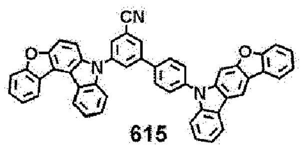
615

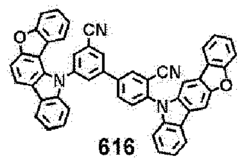
616

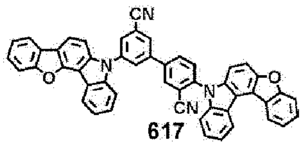
617

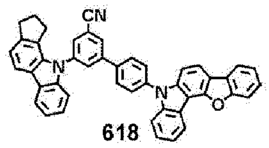
618

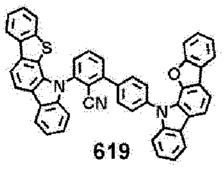
619

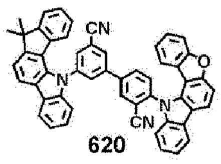
620

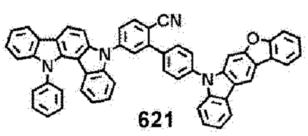
621

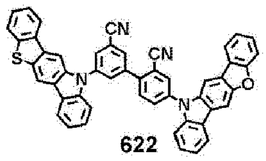
622

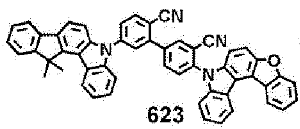
623

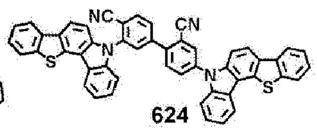
624

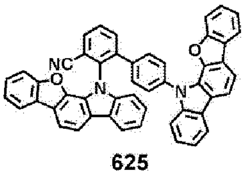
625
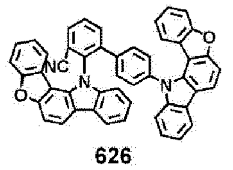
626
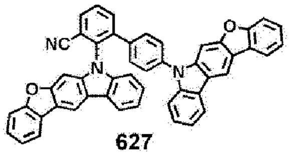
627
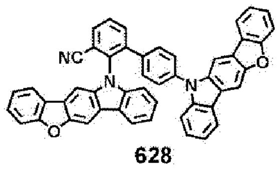
628

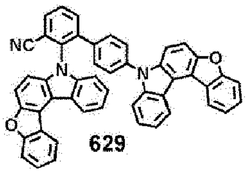
629
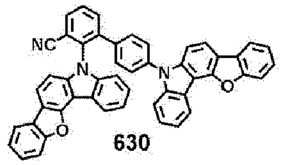
630
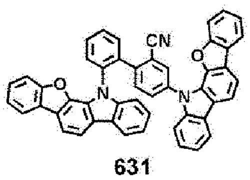
631
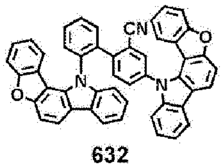
632

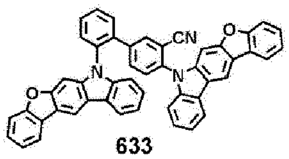
633
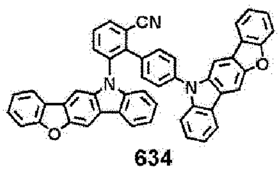
634
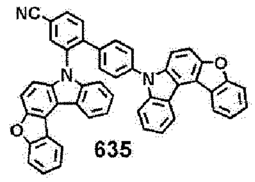
635
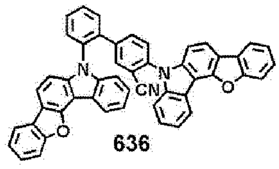
636

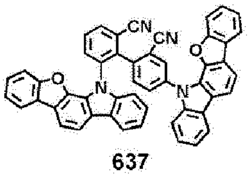
637
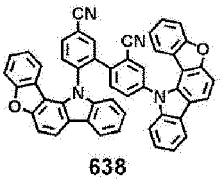
638
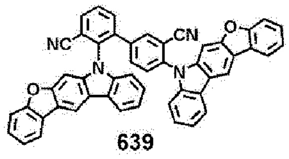
639
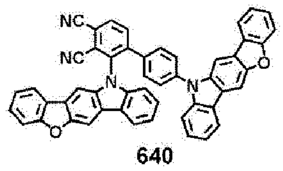
640

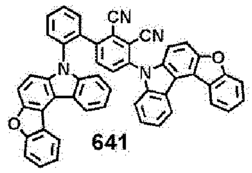
641
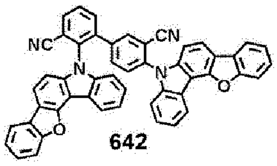
642
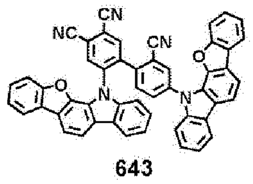
643
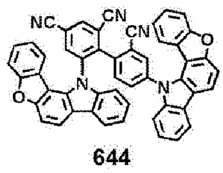
644

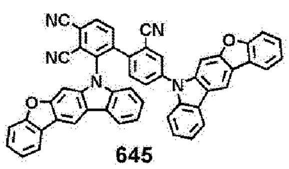
645
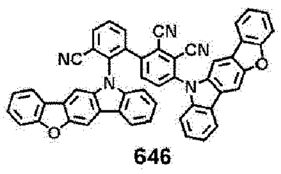
646
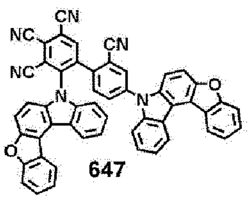
647
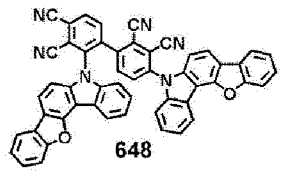
648

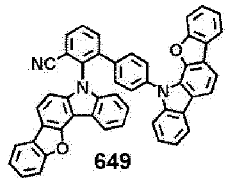
649

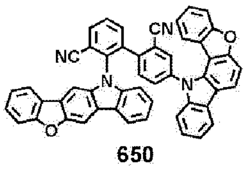
650

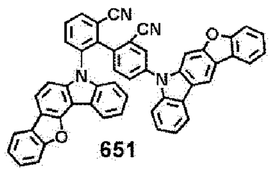
651

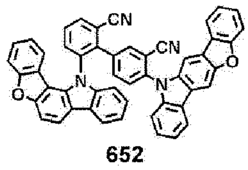
652

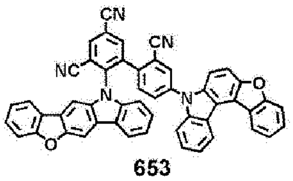
653

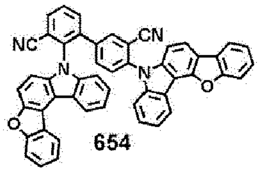
654

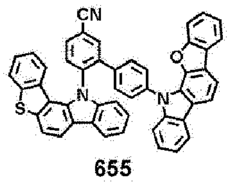
655

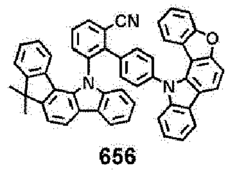
656

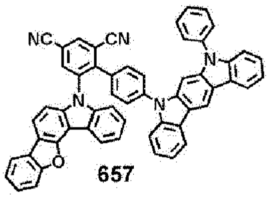
657

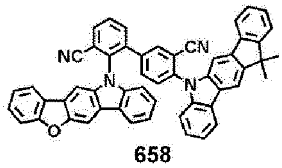
658

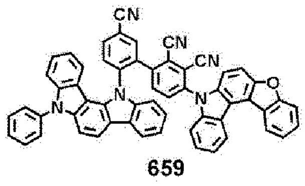
659

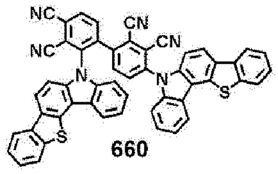
660

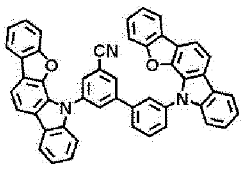
661

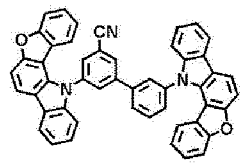
662

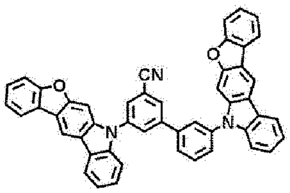
663

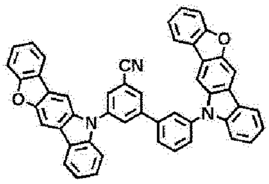
664

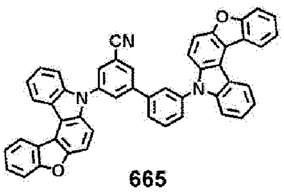
665

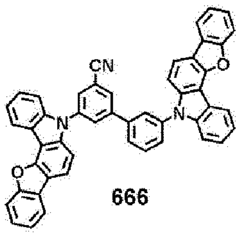
666

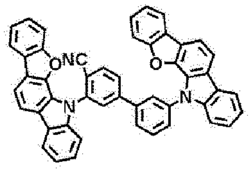
667

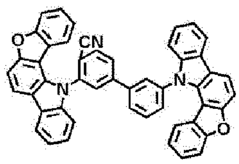
668

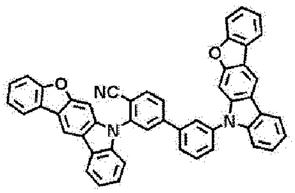
669

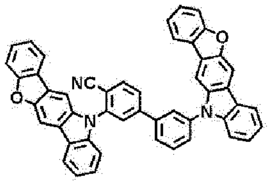
670

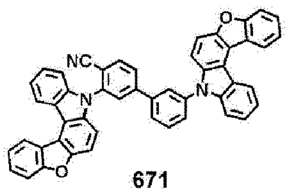
671

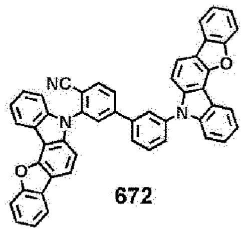
672

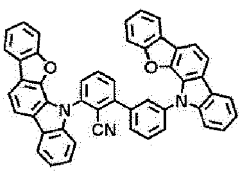
673
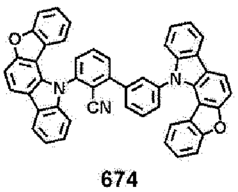
674
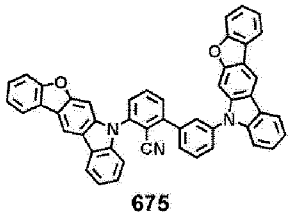
675
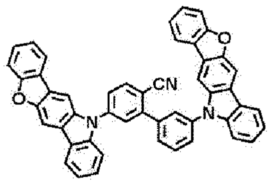
676

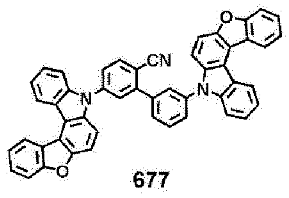
677
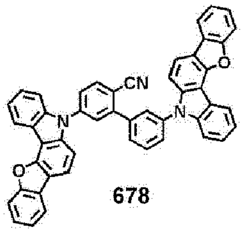
678
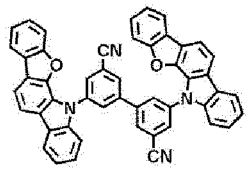
679
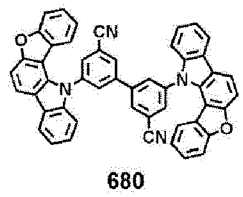
680

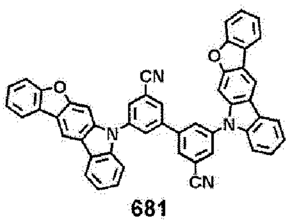
681
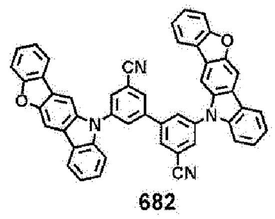
682
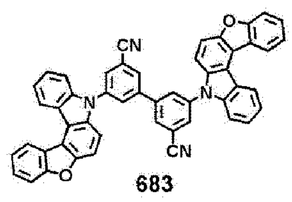
683
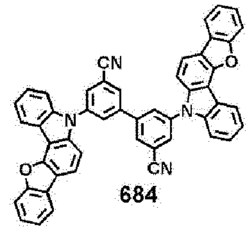
684

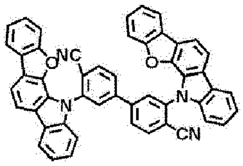
685
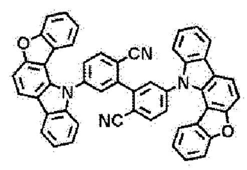
686
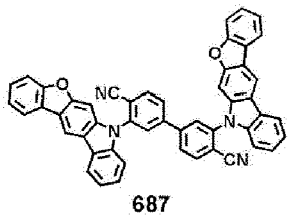
687
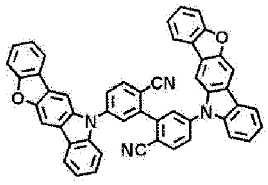
688

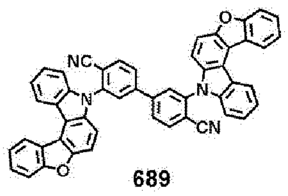
689
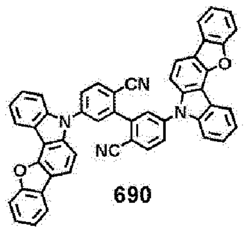
690
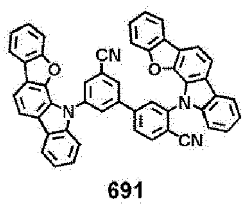
691
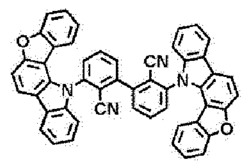
692

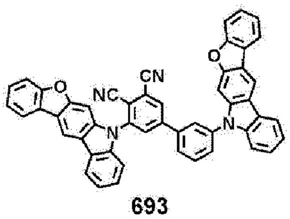
693
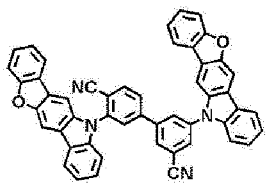
694
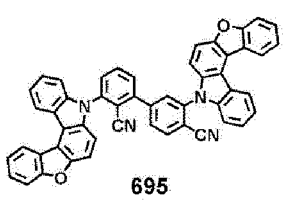
695
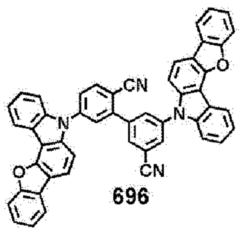
696

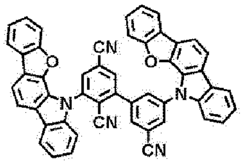
697
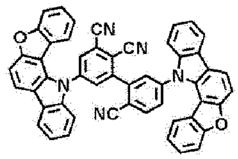
698
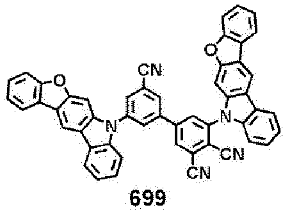
699
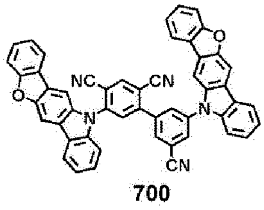
700

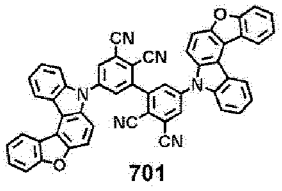
701
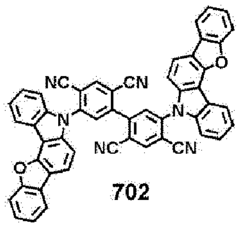
702
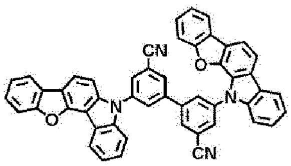
703
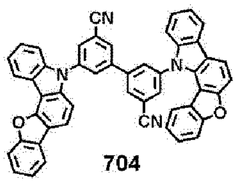
704

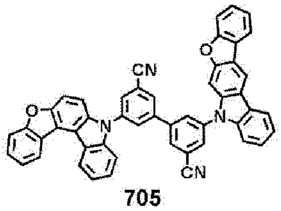
705
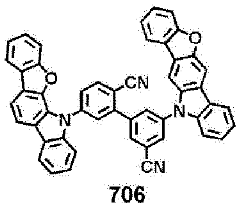
706
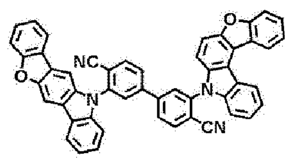
707
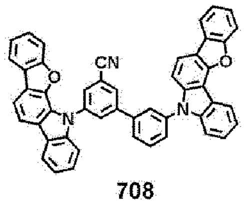
708

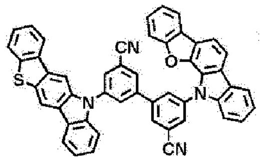
709
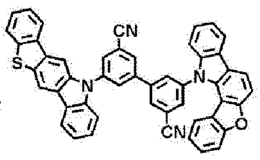
710
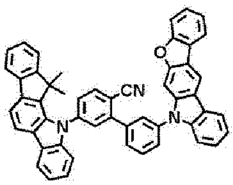
711
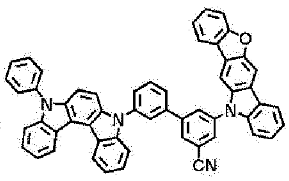
712

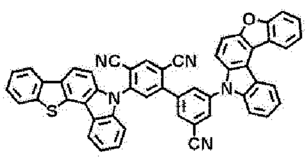
713
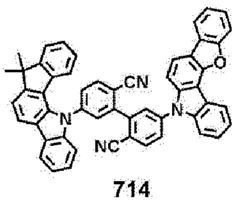
714
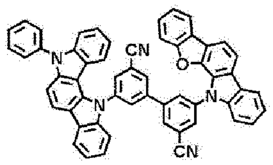
715
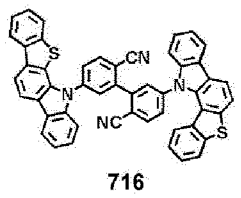
716

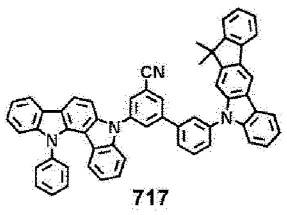
717
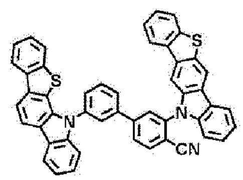
718
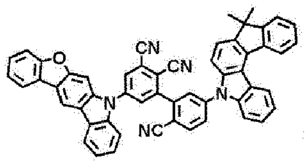
719
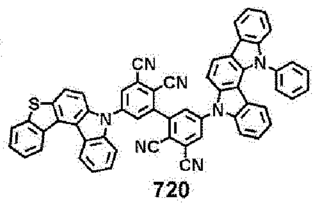
720

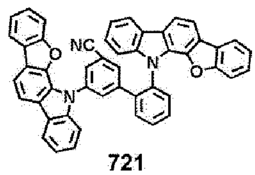
**721**

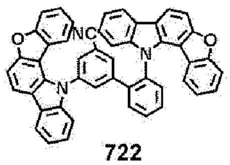
**722**

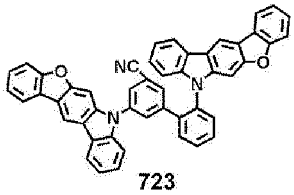
**723**

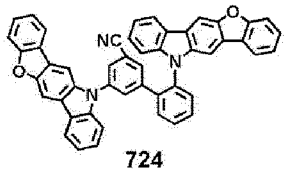
**724**

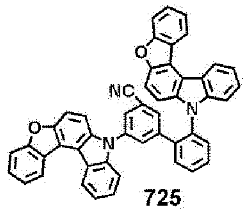
**725**

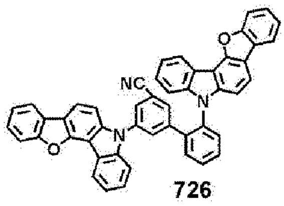
**726**

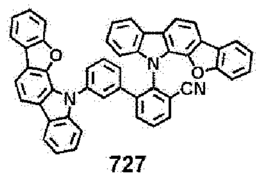
**727**

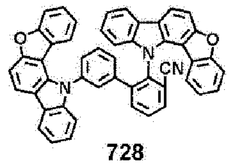
**728**

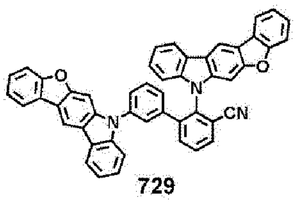
**729**

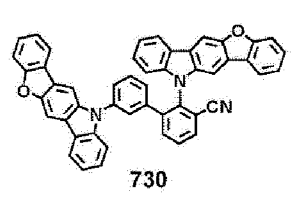
**730**

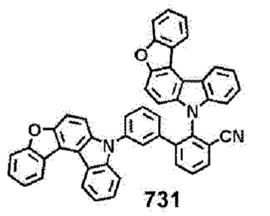
**731**

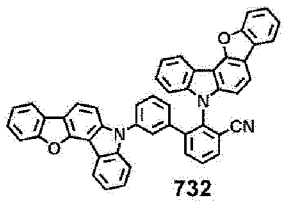
**732**

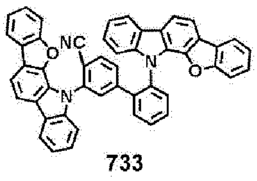
**733**

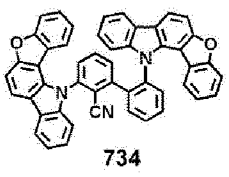
**734**

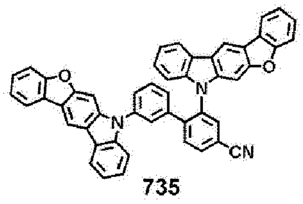
**735**

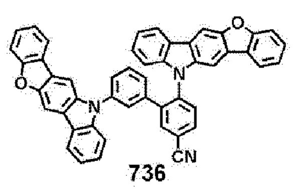
**736**

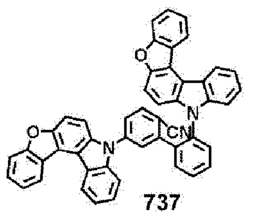
**737**

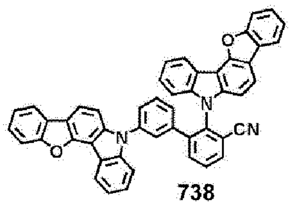
**738**

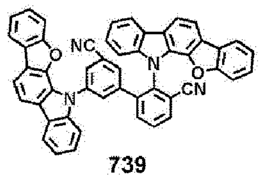
**739**

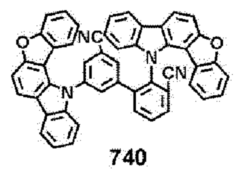
**740**

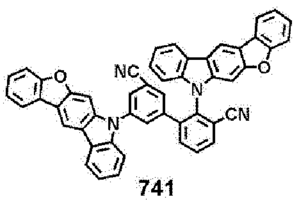
**741**

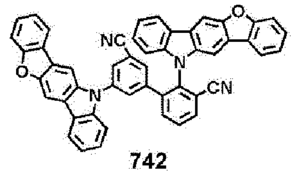
**742**

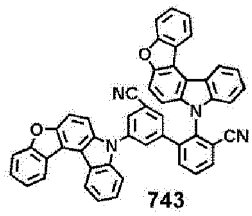
**743**

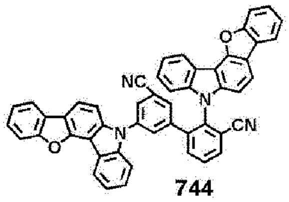
**744**

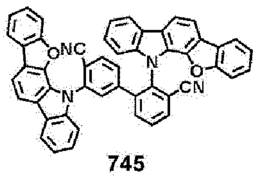
745
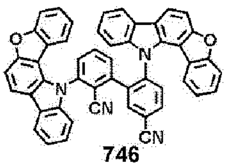
746
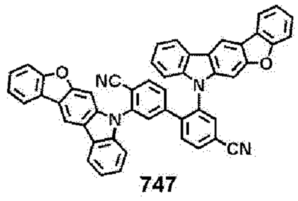
747
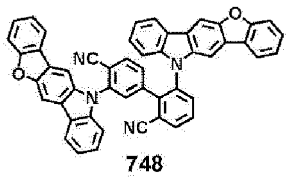
748
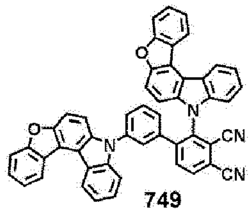
749
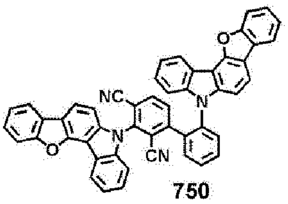
750
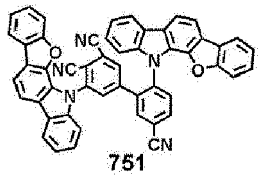
751
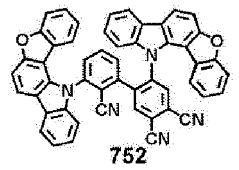
752
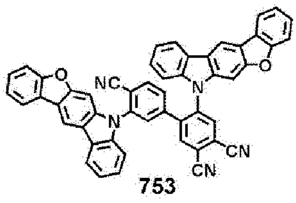
753
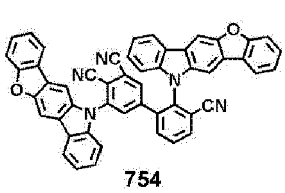
754
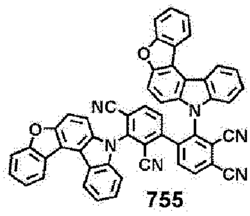
755
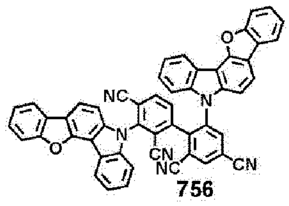
756
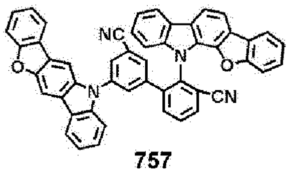
757
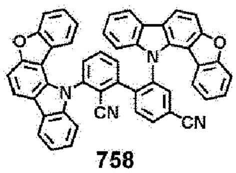
758
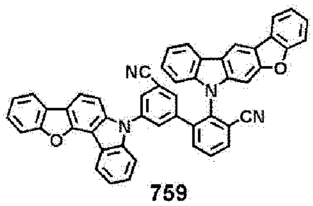
759
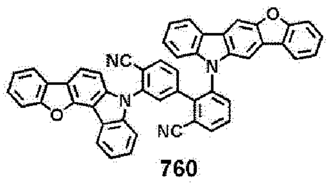
760
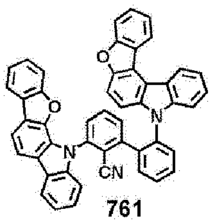
761
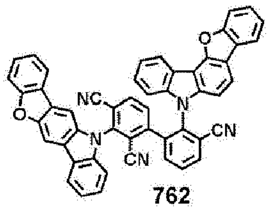
762
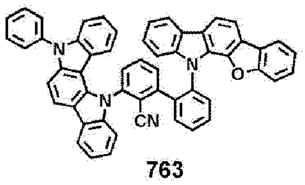
763
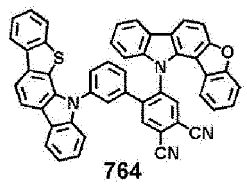
764
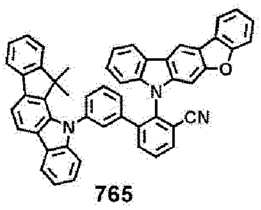
765
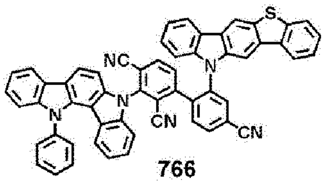
766
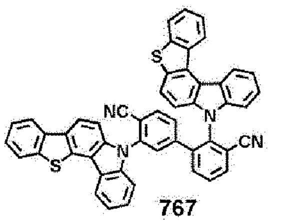
767
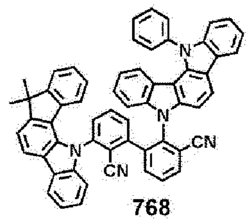
768

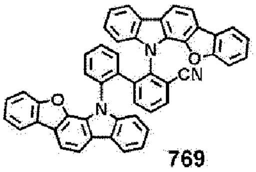
769

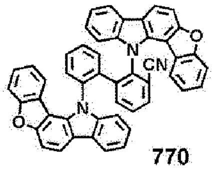
770

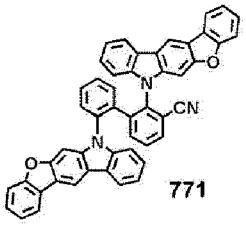
771

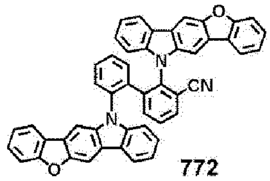
772

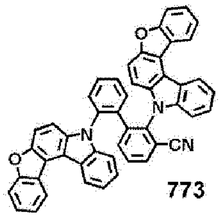
773

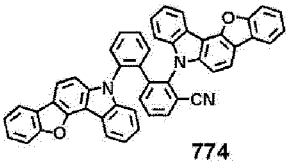
774

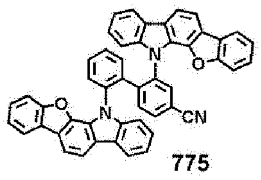
775

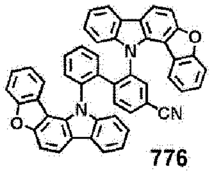
776

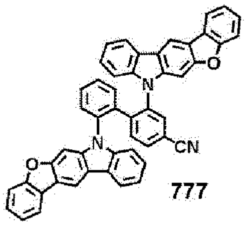
777

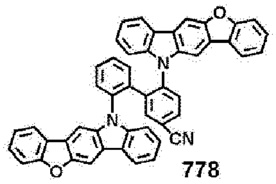
778

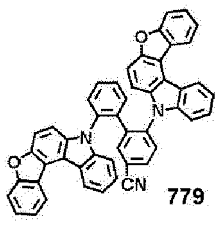
779

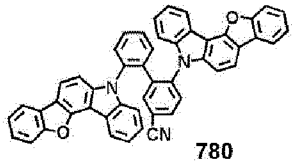
780

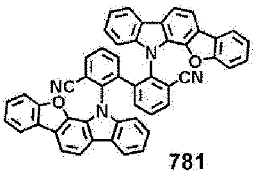
781

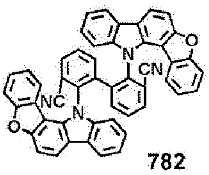
782

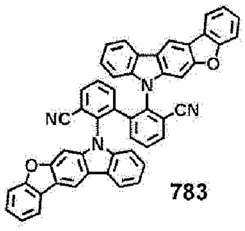
783

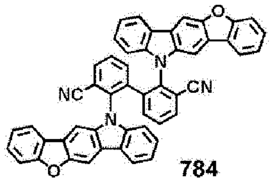
784

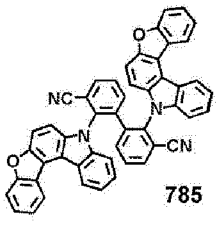
785

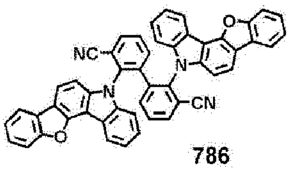
786

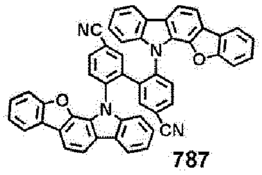
787

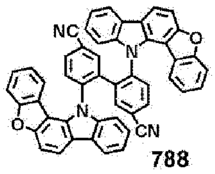
788

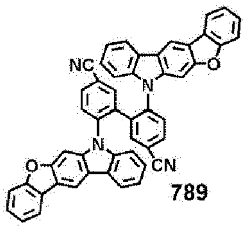
789

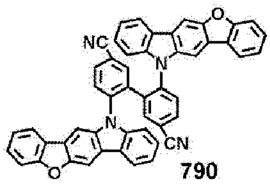
790

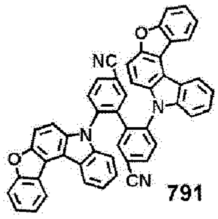
791

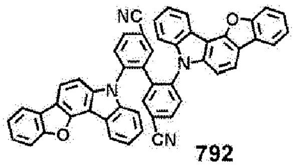
792

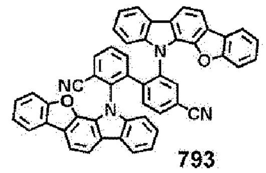
793
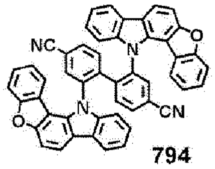
794
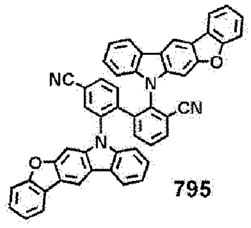
795
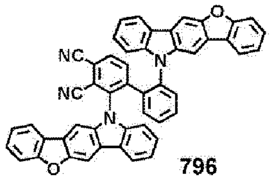
796

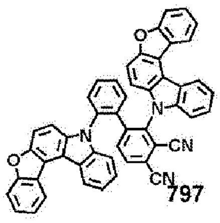
797
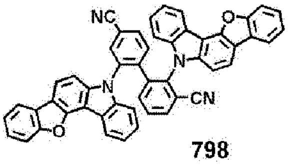
798
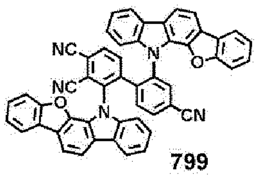
799
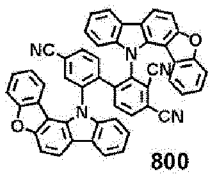
800

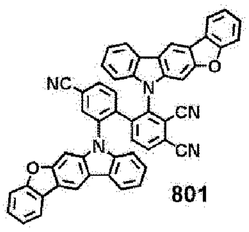
801
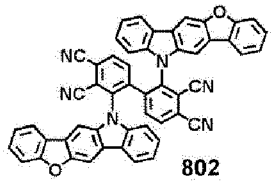
802
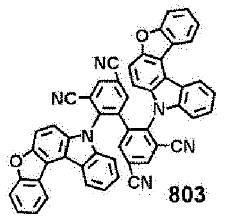
803
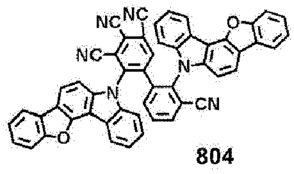
804

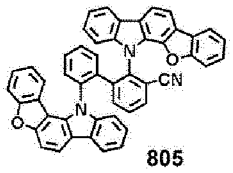
805
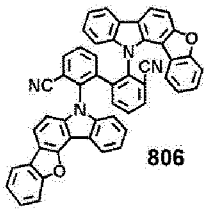
806
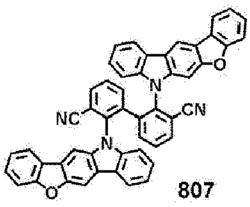
807
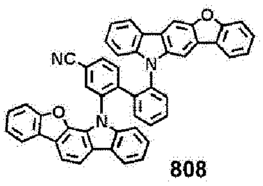
808

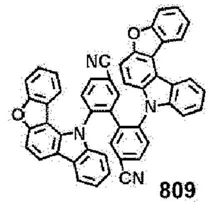
809
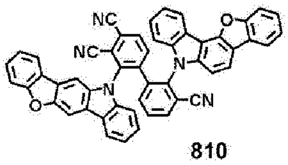
810
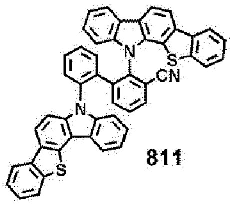
811
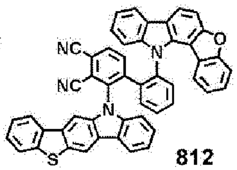
812

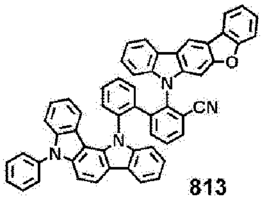
813
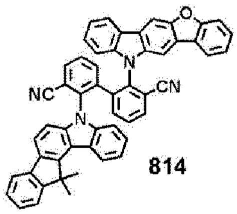
814
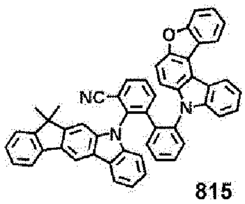
815
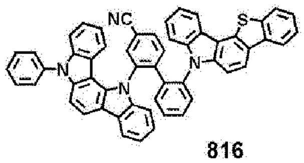
816

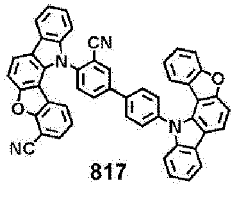
817

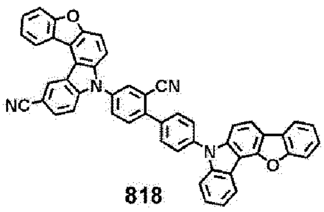
818

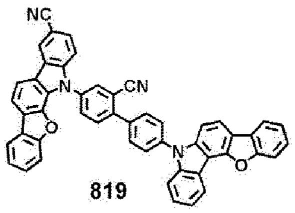
819

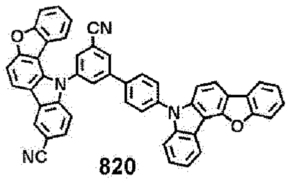
820

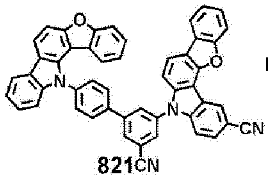
821

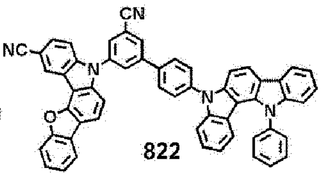
822

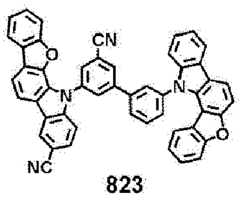
823

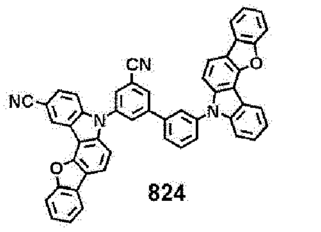
824

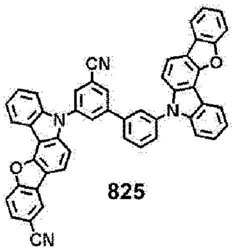
825

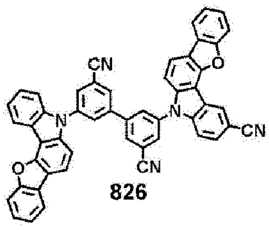
826

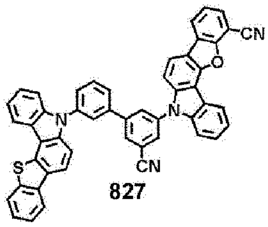
827

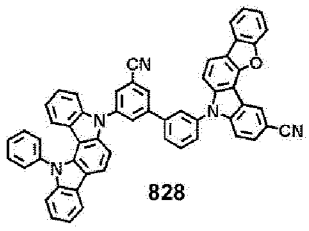
828

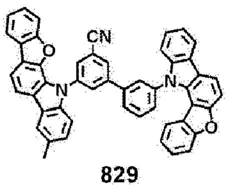
829

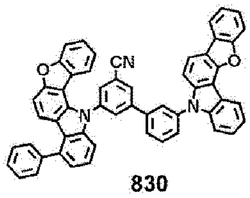
830

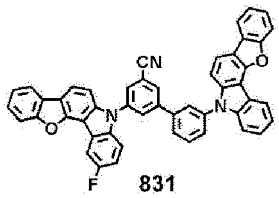
831

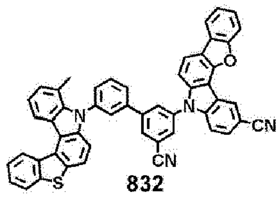
832

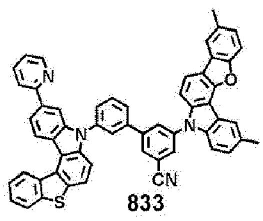
833

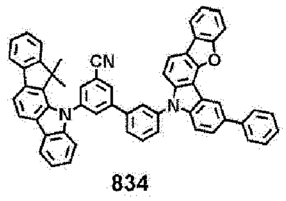
834

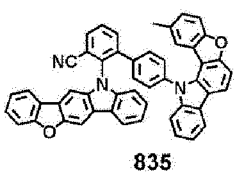
835

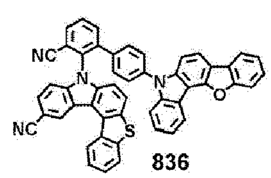
836

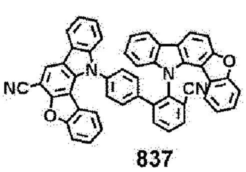
837

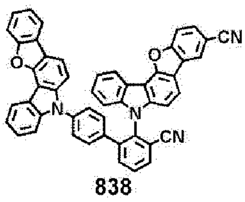
838

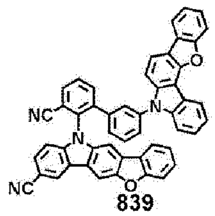
839

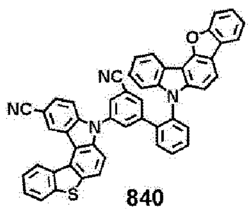
840

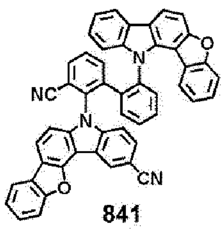
841
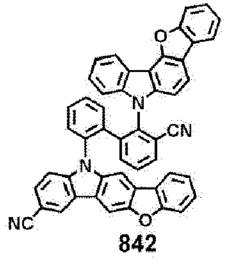
842
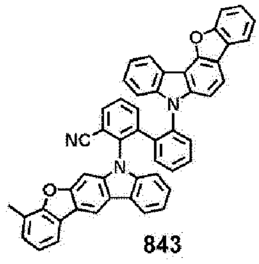
843
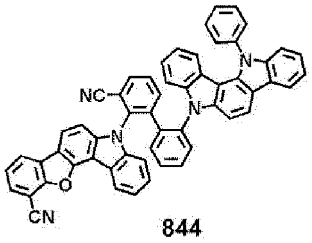
844
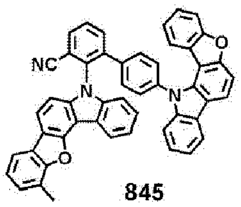
845
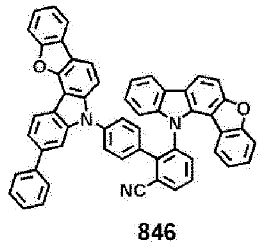
846
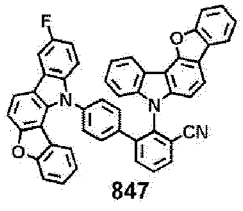
847
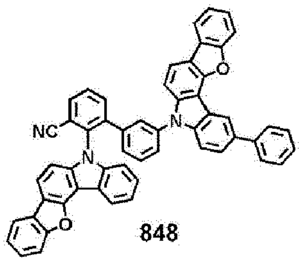
848
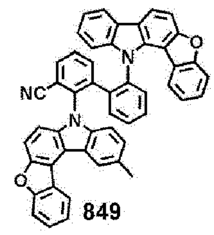
849
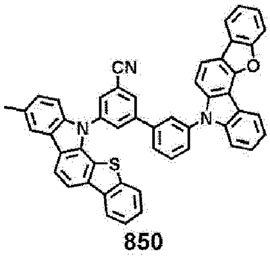
850
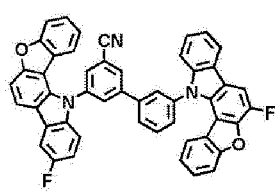
851
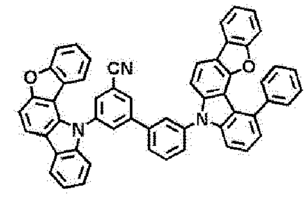
852

Group HE3

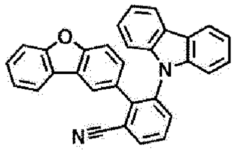
1

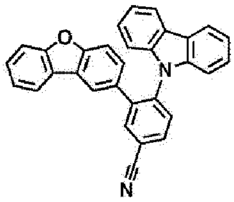
2

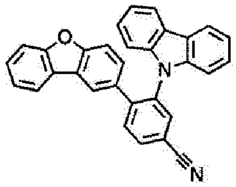
3

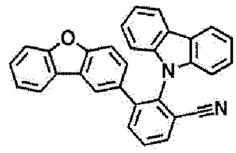
4

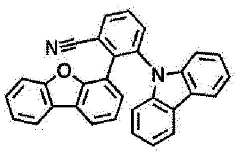
5

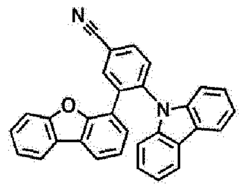
6

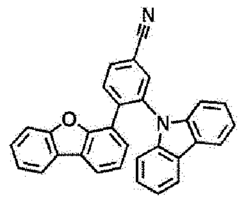
7

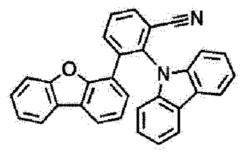
8

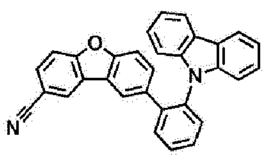
9

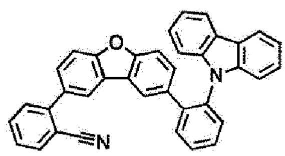
10

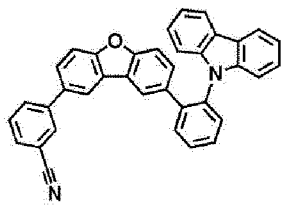
11

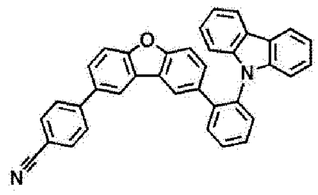
12

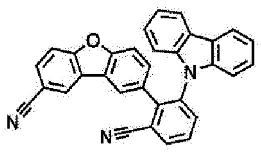
13

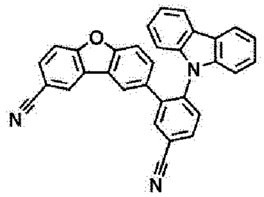
14

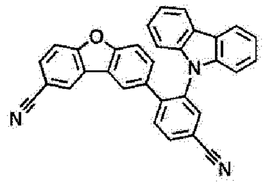
15

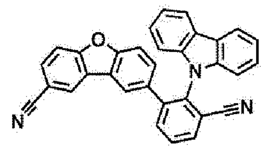
16

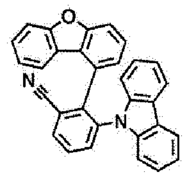
17

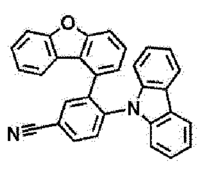
18

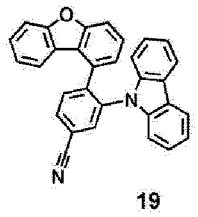
19

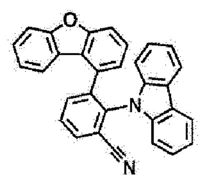
20

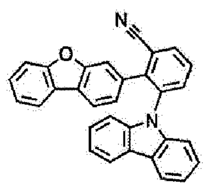
21

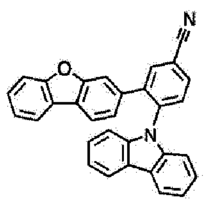
22

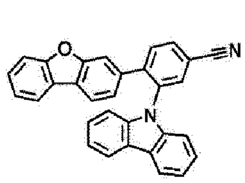
23

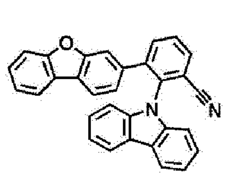
24

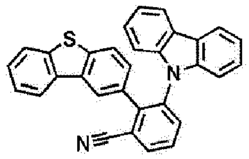
25

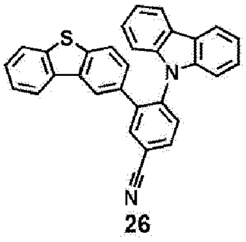
26

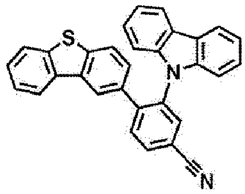
27

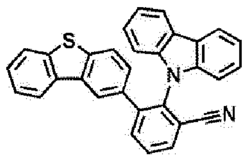
28

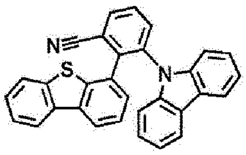
29

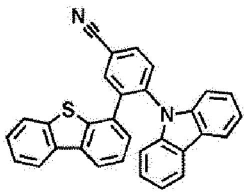
30

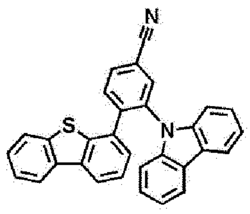
31

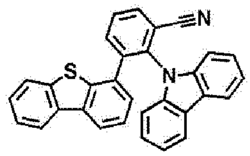
32

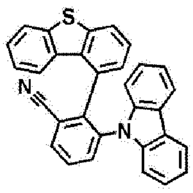
33

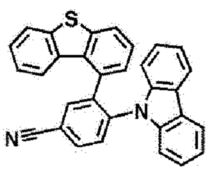
34

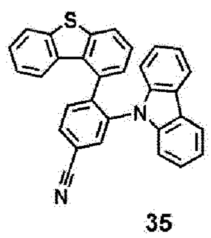
35

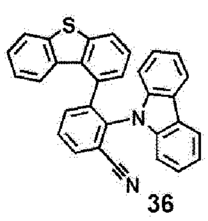
36

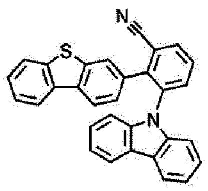
37

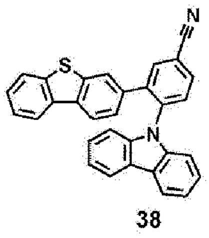
38

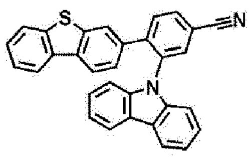
39

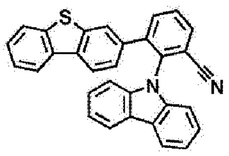
40

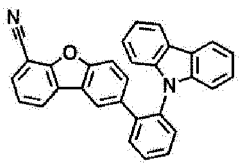
41

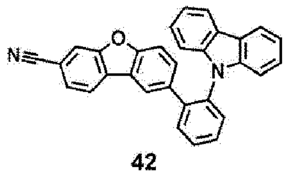
42

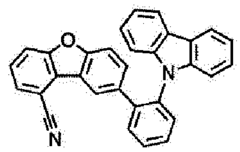
43

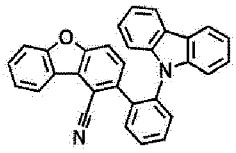
44

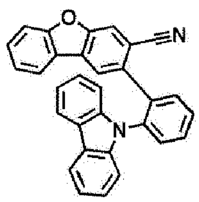

45

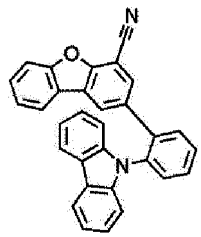

46

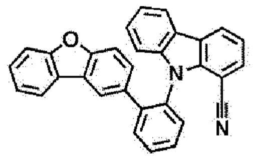

47

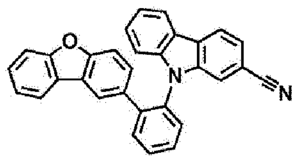

48

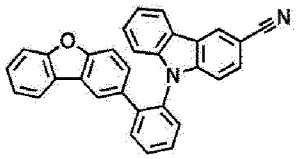

49

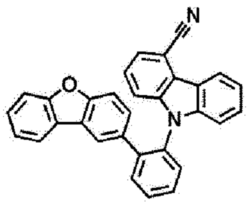

50

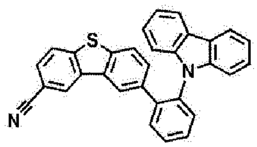

51

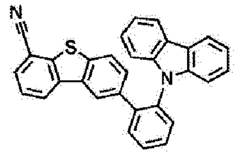

52

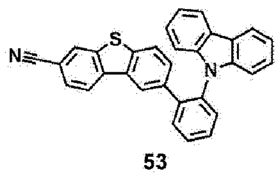

53

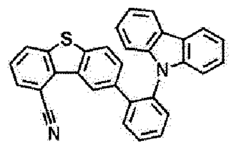

54

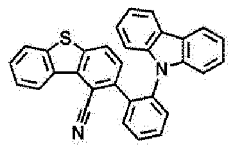

55

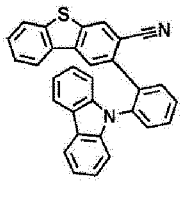

56

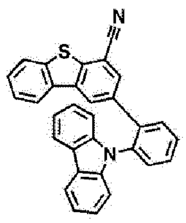

57

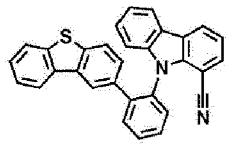

58

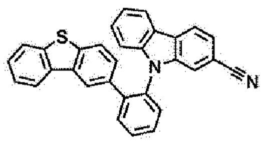

59

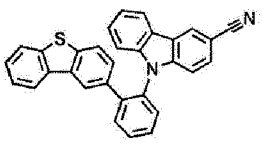

60

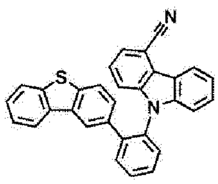

61

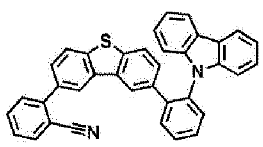

62

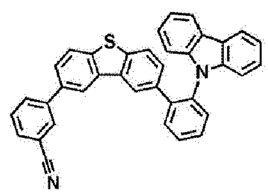

63

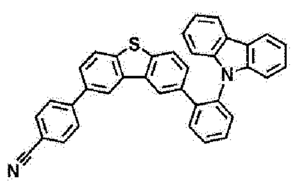

64

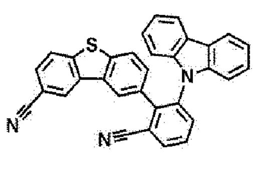

65

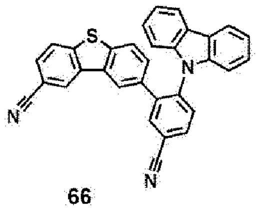

66

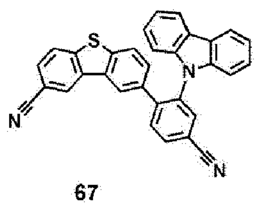

67

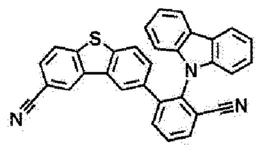

68

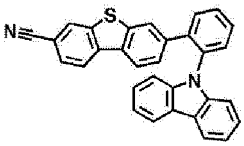

69

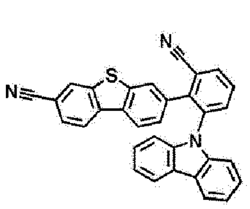

70

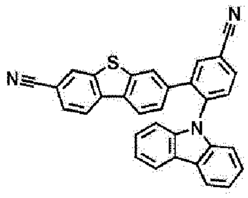

71

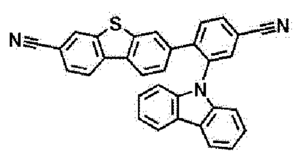

72

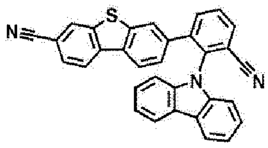

73

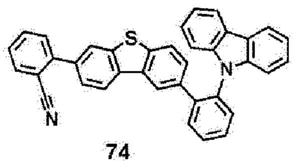

74

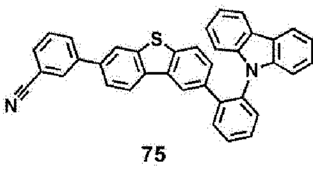

75

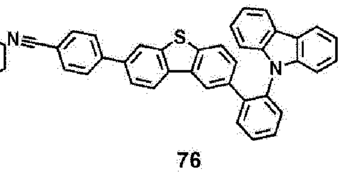

76

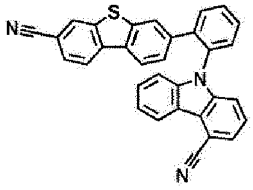

77

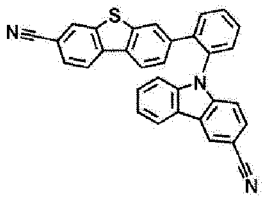

78

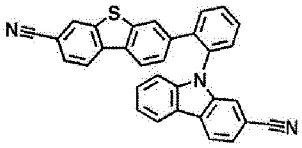

79

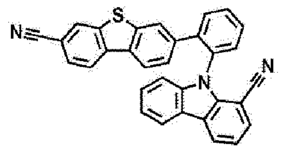

80

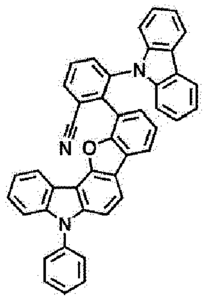

81

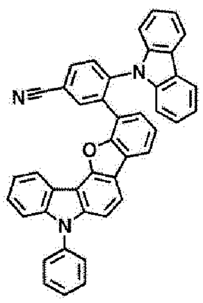

82

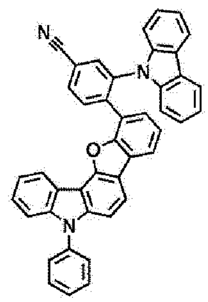

83

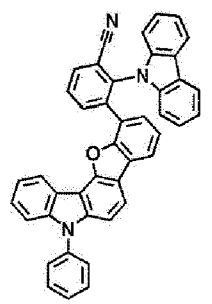

84

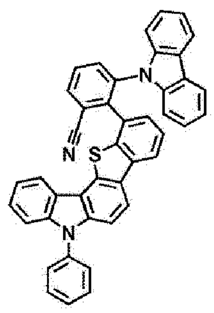

85

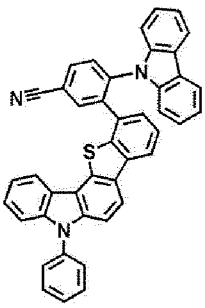

86

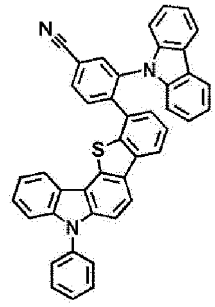

87

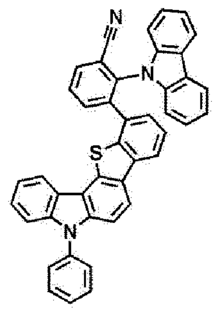

88

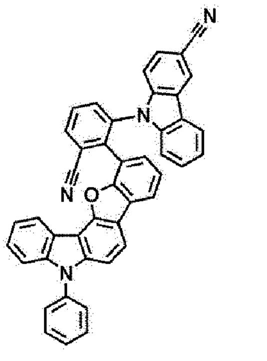

89

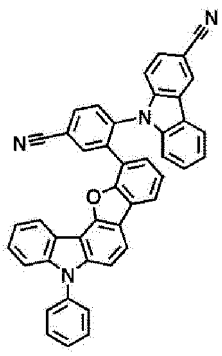

90

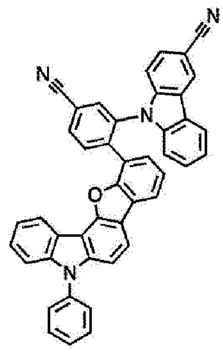

91

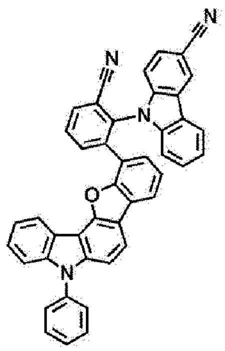

92

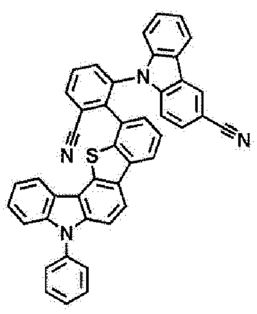

93

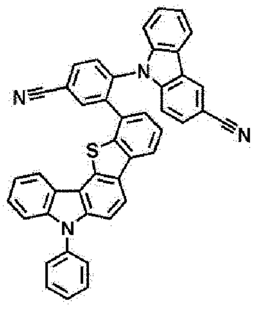

94

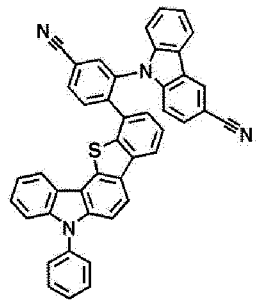

95

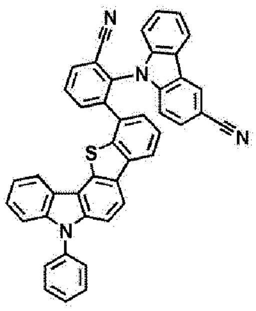

96

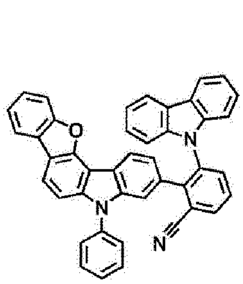

97

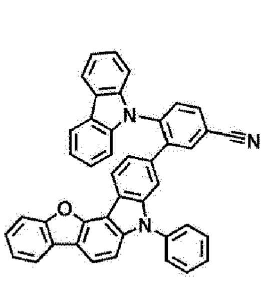

98

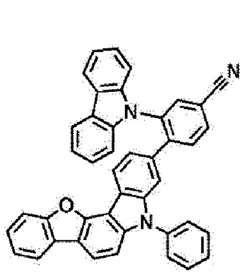

99

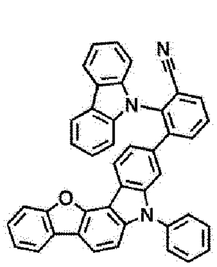

100

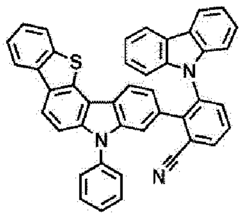
**101**

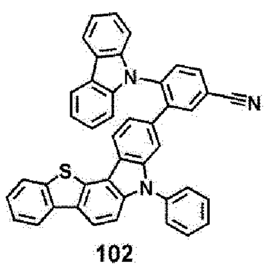
**102**

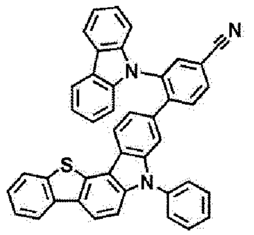
**103**

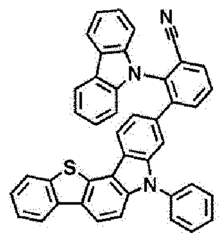
**104**

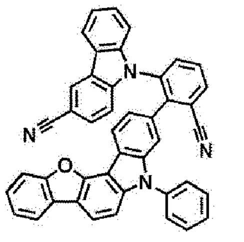
**105**

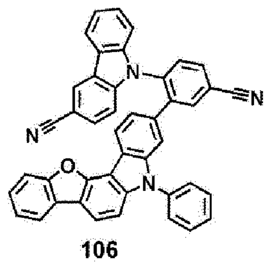
**106**

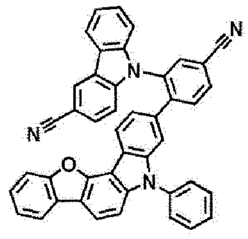
**107**

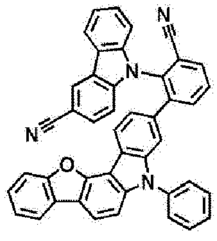
**108**

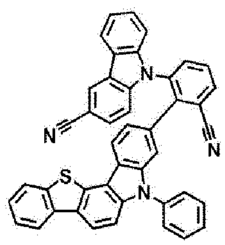
**109**

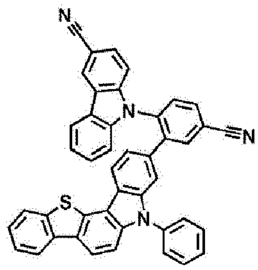
**110**

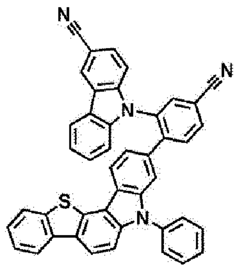
**111**

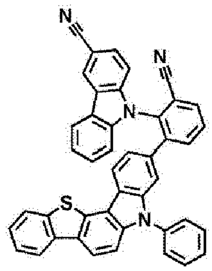
**112**

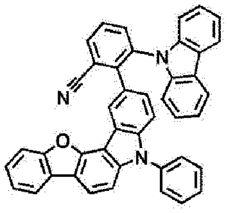
**113**

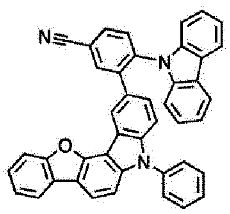
**114**

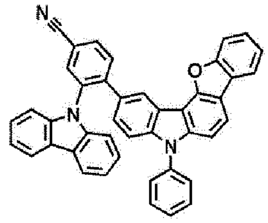
**115**

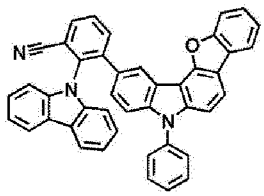
**116**

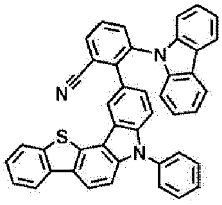

117

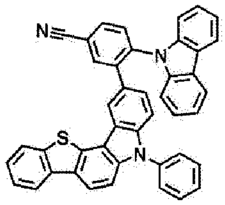

118

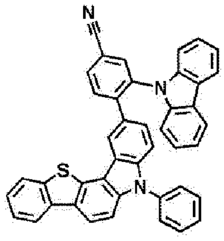

119

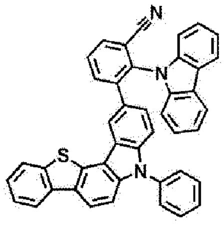

120

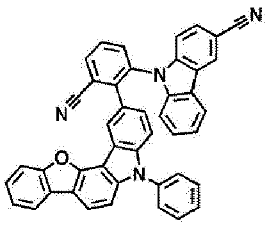

121

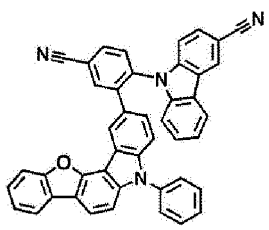

122

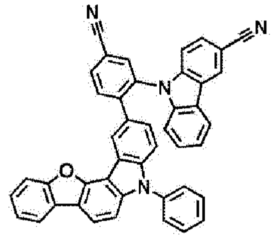

123

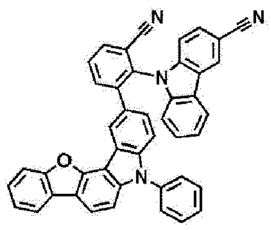

124

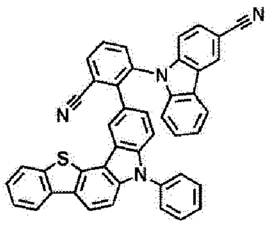

125

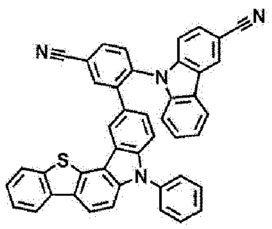

126

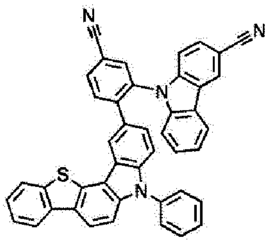

127

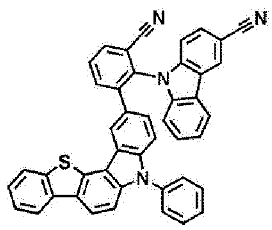

128

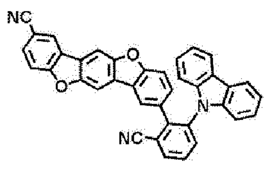

129

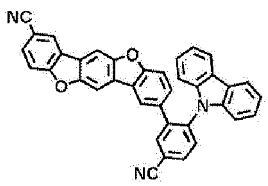

130

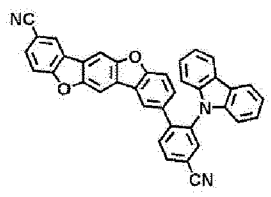

131

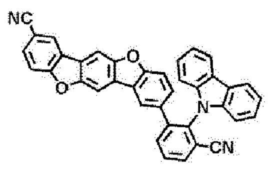

132

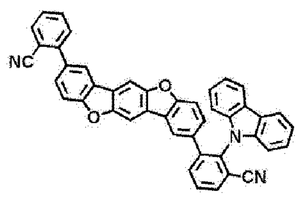

133

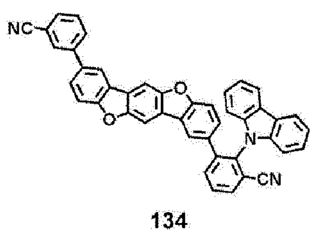

134

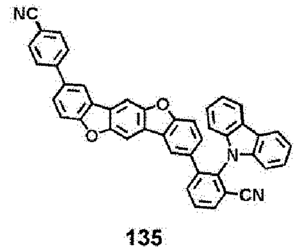

135

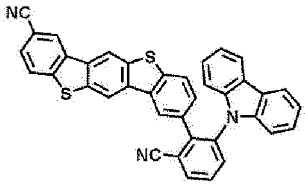
136

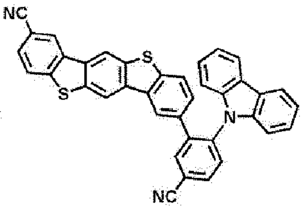
137

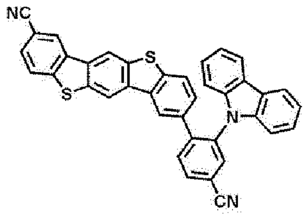
138

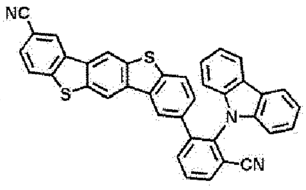
139

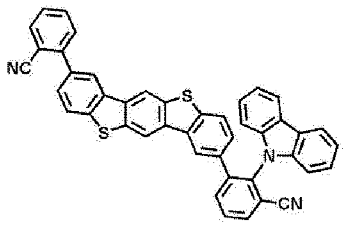
140

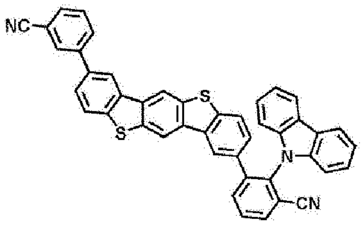
141

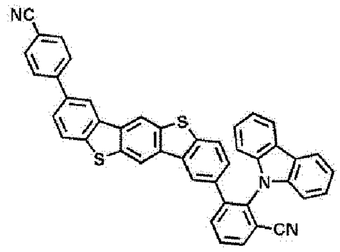
142

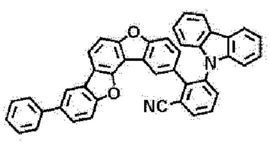
143

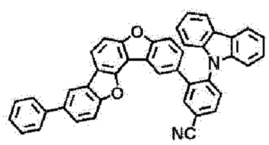
144

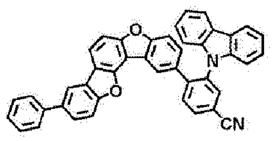
145

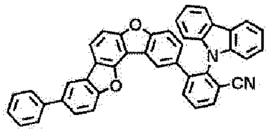
146

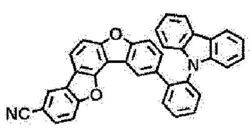
147

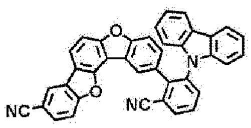
148

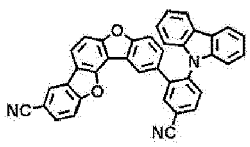
149

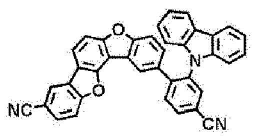
150

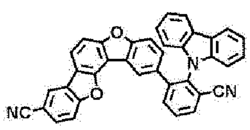
151

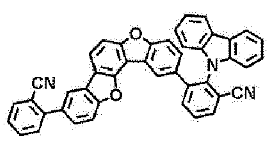
152

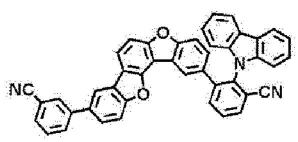
153

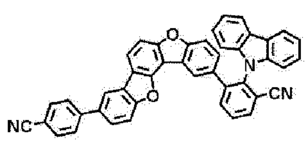
154

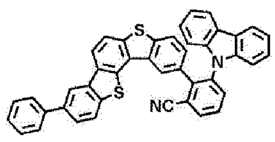

155

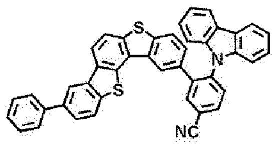

156

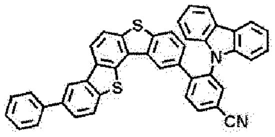

157

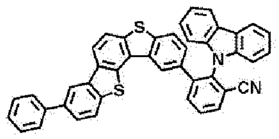

158

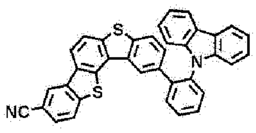

159

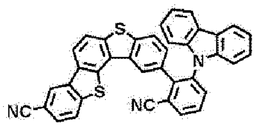

160

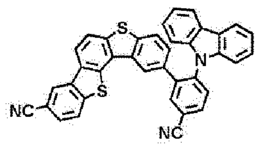

161

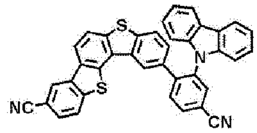

162

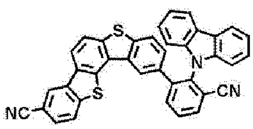

163

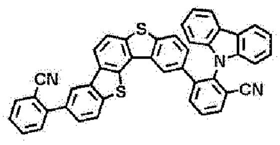

164

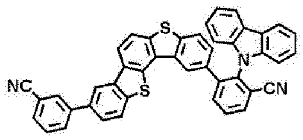

165

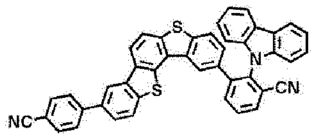

166

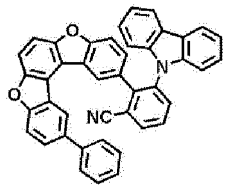

167

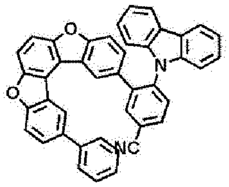

168

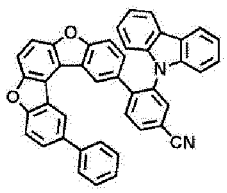

169

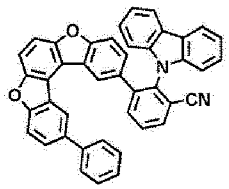

170

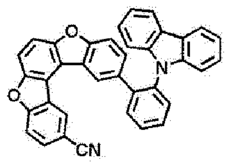

171

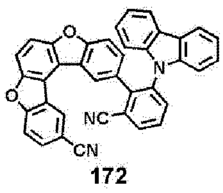

172

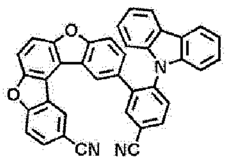

173

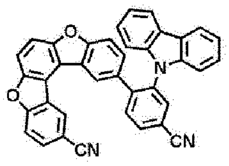

174

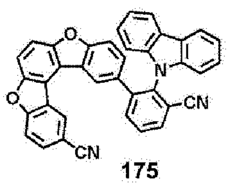

175

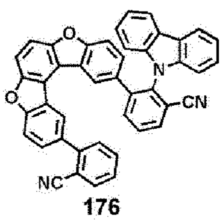

176

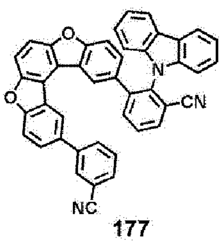

177

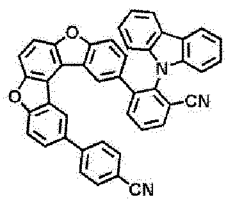

178

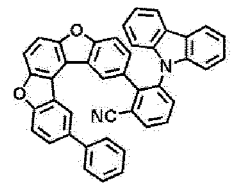
179
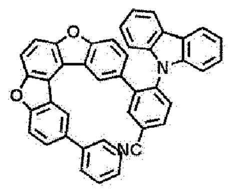
180
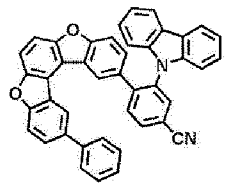
181
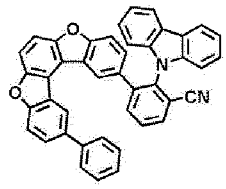
182

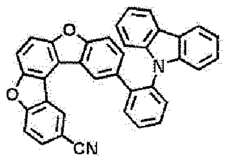
183
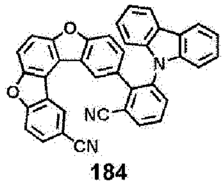
184
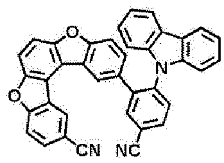
185
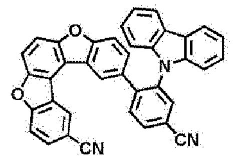
186

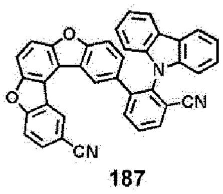
187
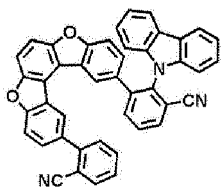
188
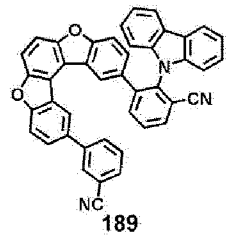
189
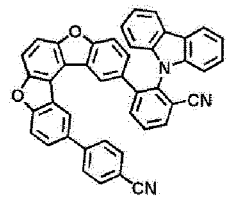
190

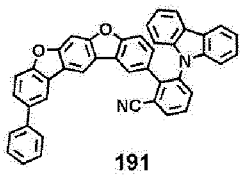
191
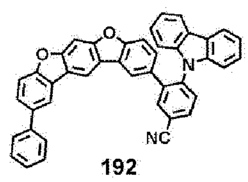
192
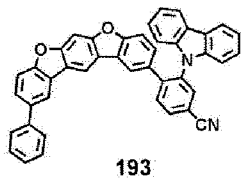
193
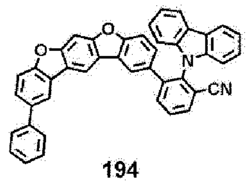
194

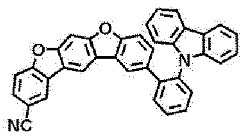
195
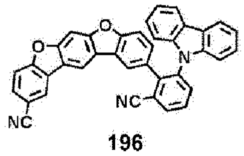
196
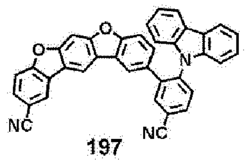
197
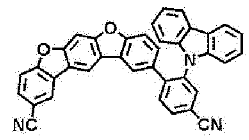
198

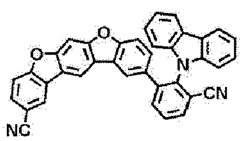
199
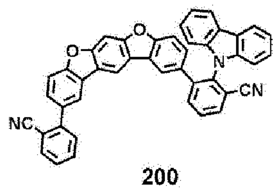
200
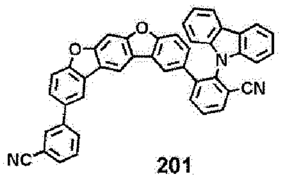
201
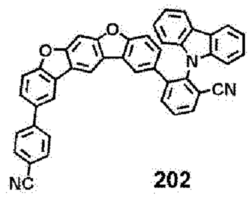
202

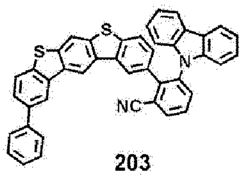
203
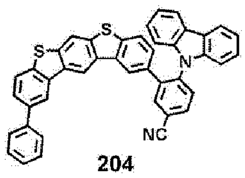
204
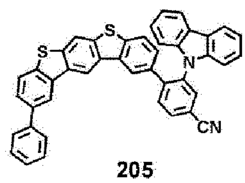
205
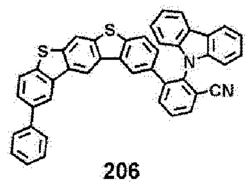
206

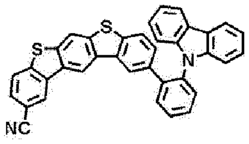
207

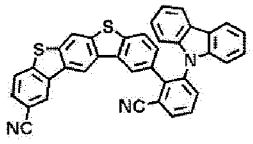
208

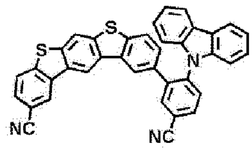
209

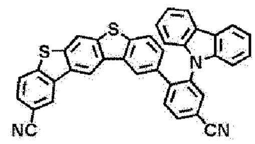
210

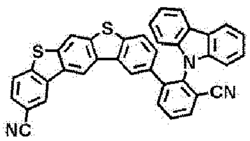
211

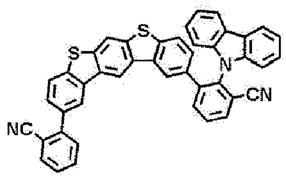
212

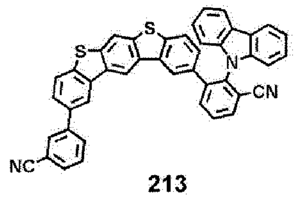
213

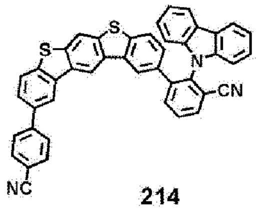
214

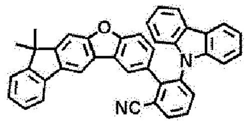
215

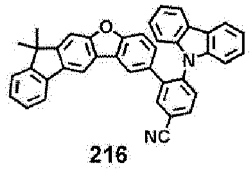
216

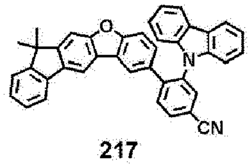
217

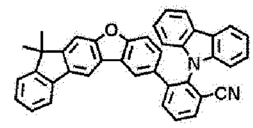
218

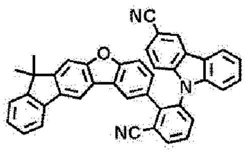
219

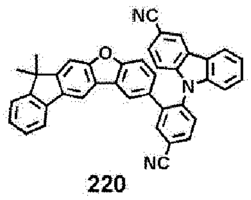
220

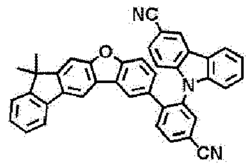
221

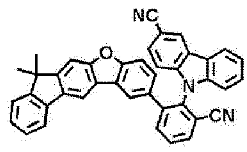
222

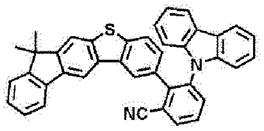
223

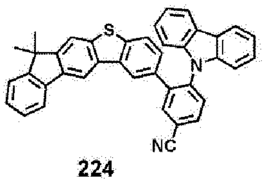
224

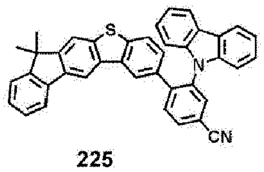
225

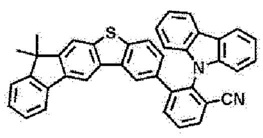
226

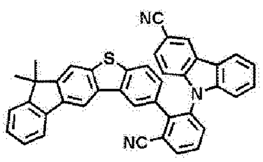
227

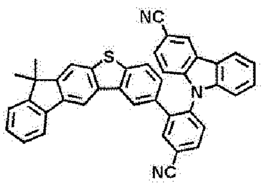
228

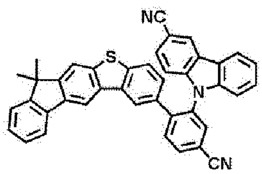
229

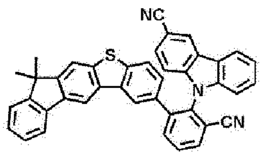
230

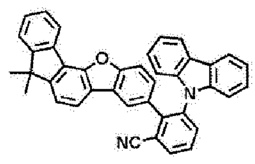
231

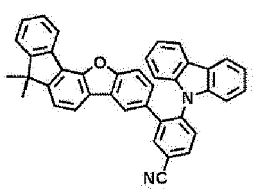
232

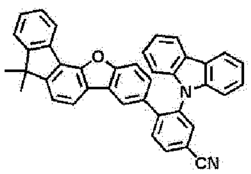
233

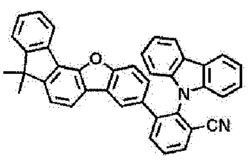
234

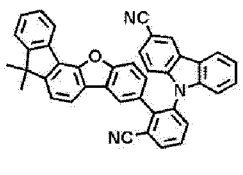
235

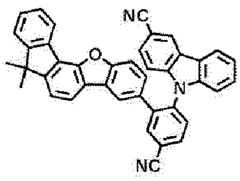
236

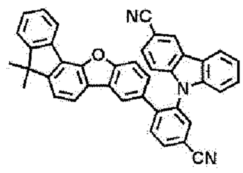
237

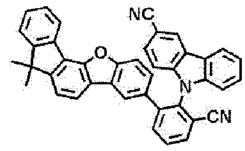
238

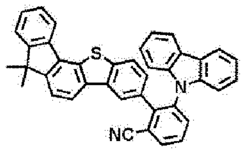
239

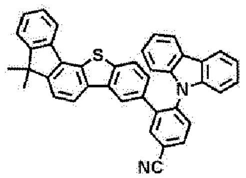
240

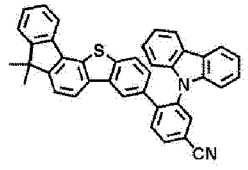
241

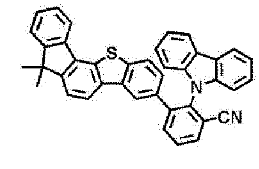
242

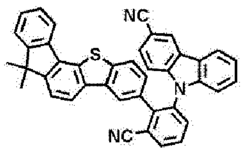
243

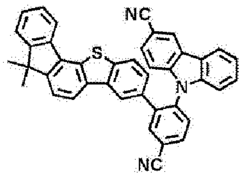
244

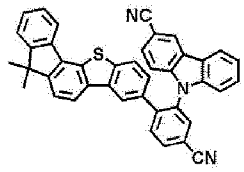
245

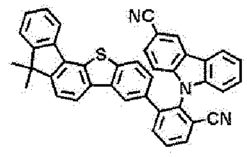
246

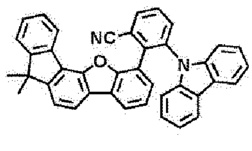
247

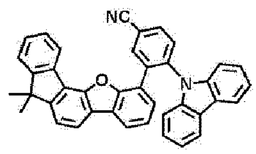
248

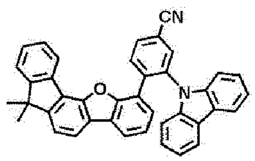
249

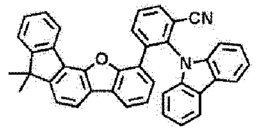
250

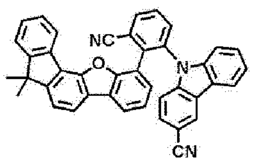
251

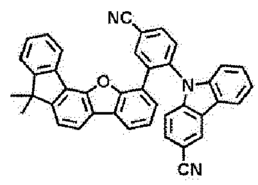
252

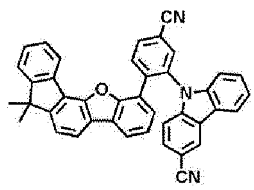
253

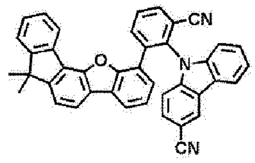
254

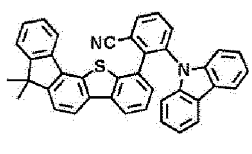
255

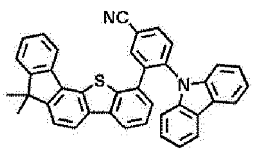
256

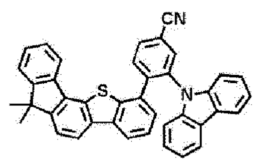
257

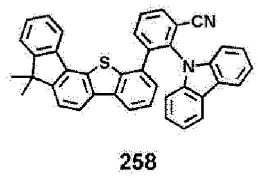
258

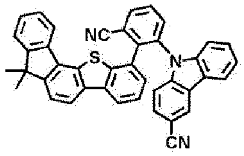

259

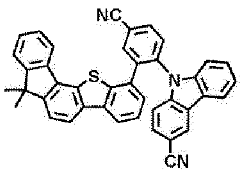

260

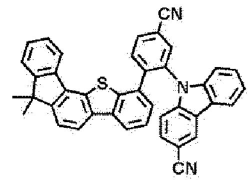

261

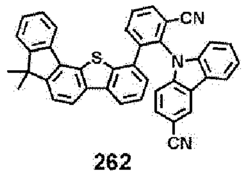

262

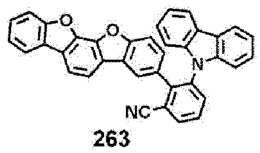

263

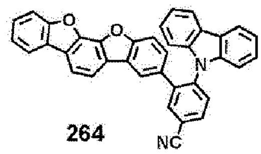

264

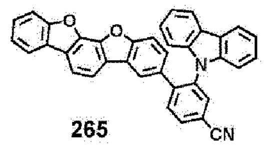

265

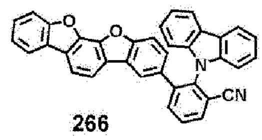

266

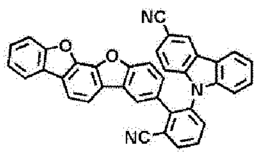

267

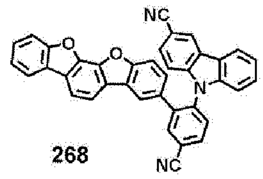

268

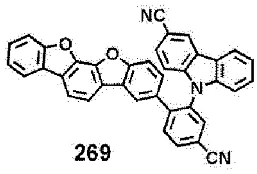

269

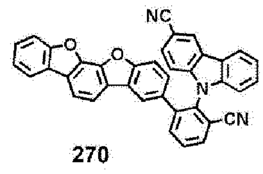

270

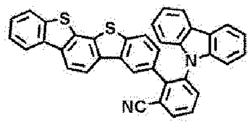

271

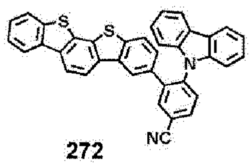

272

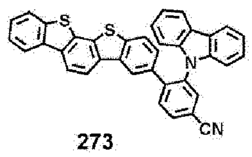

273

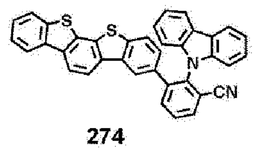

274

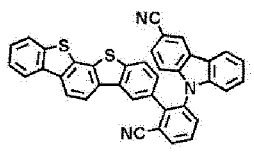

275

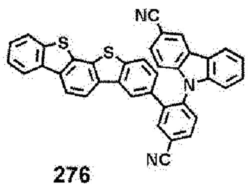

276

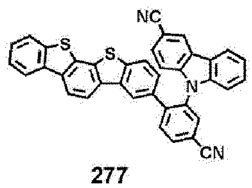

277

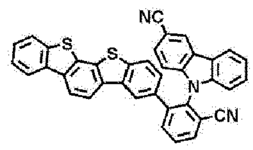

278

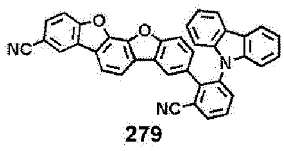

279

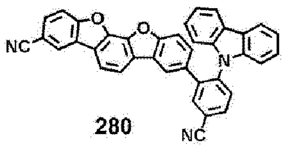

280

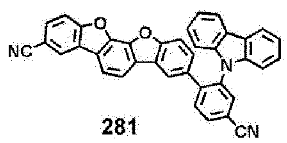

281

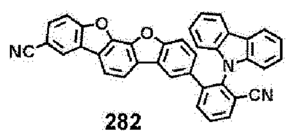

282

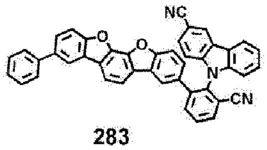
283

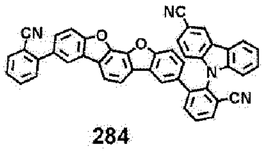
284

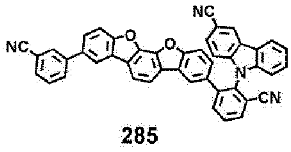
285

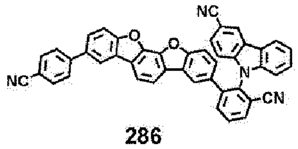
286

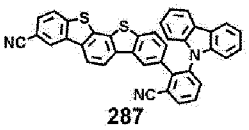
287

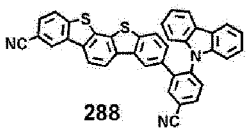
288

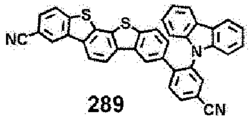
289

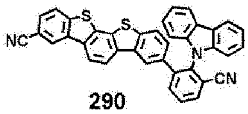
290

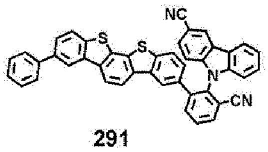
291

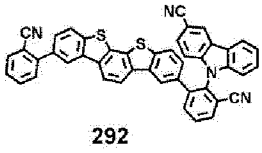
292

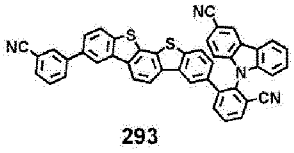
293

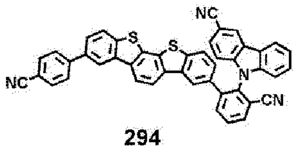
294

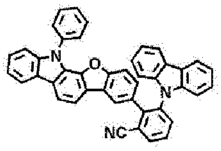
295

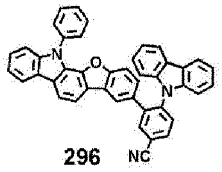
296

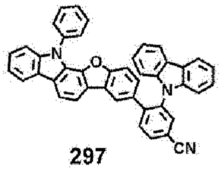
297

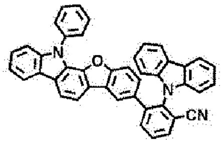
298

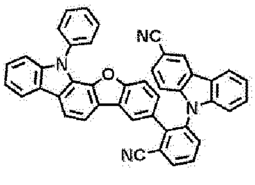
299

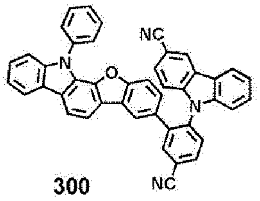
300

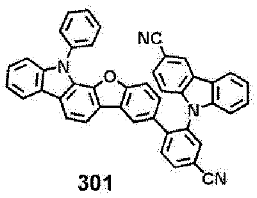
301

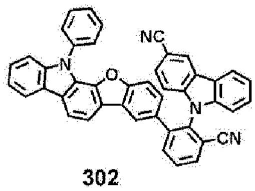
302

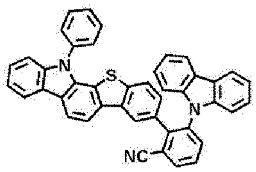
303

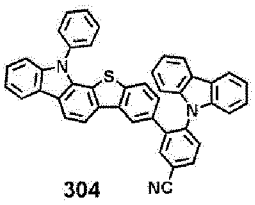
304

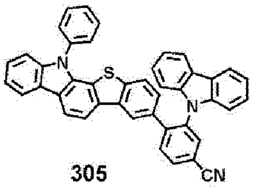
305

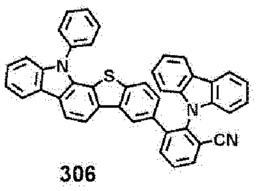
306

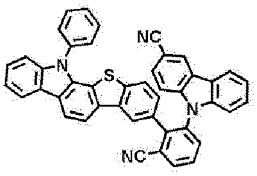
307

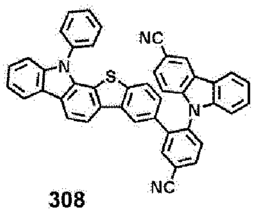
308

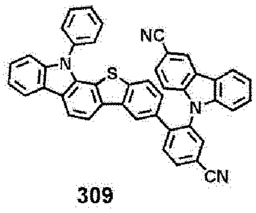
309

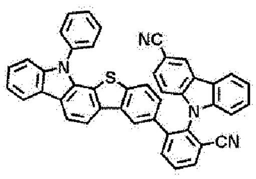
310

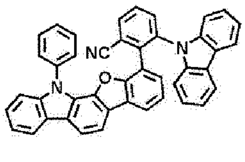
311

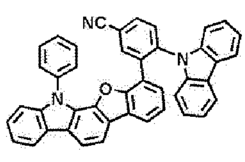
312

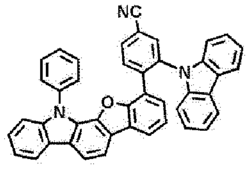
313

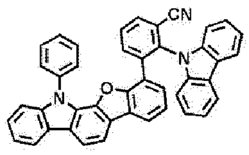
314

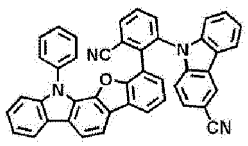
315

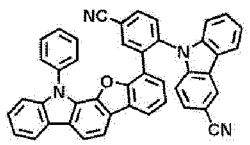
316

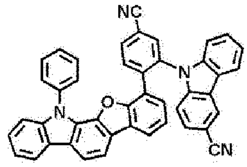
317

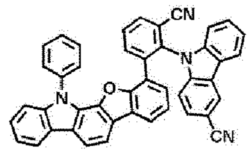
318

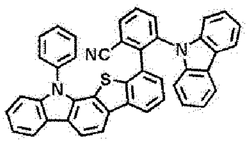
319

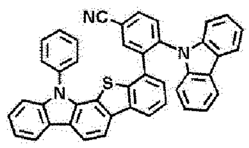
320

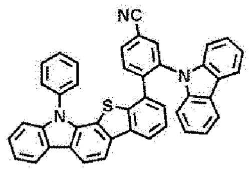
321

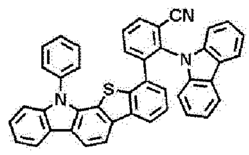
322

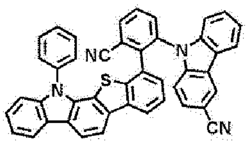
323

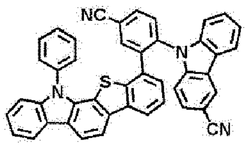
324

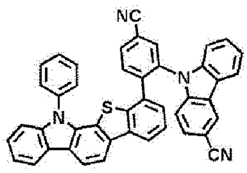
325

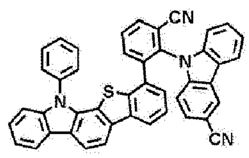
326

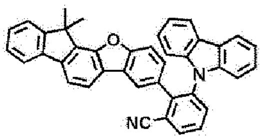
327

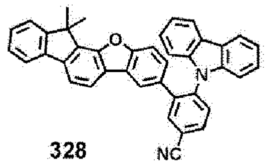
328

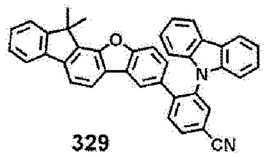
329

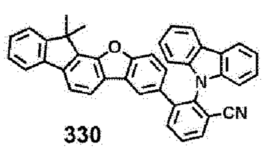
330

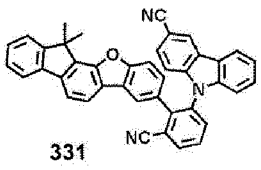
331

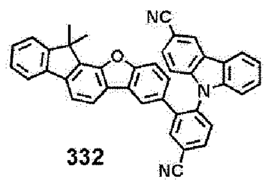
332

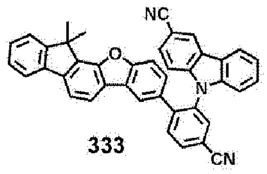
333

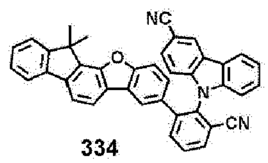
334

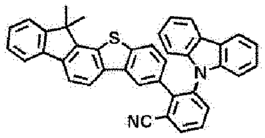
335

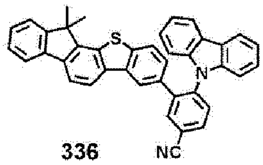
336

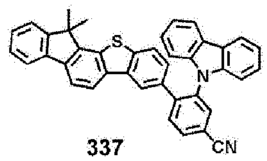
337

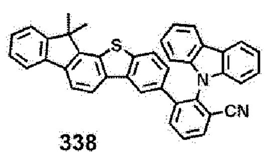
338

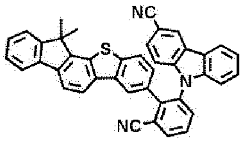
339
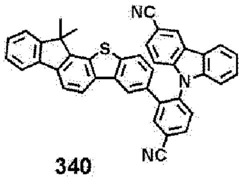
340
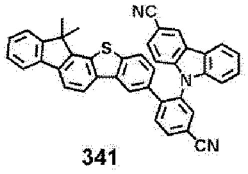
341
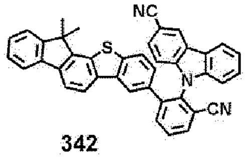
342

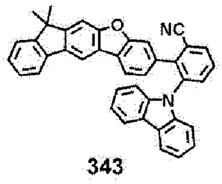
343
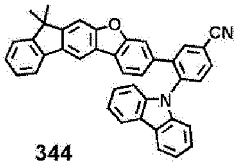
344
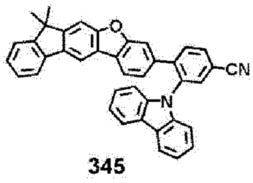
345
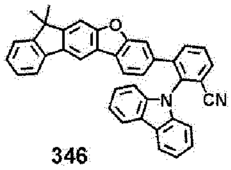
346

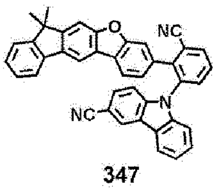
347
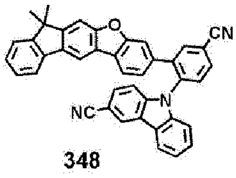
348
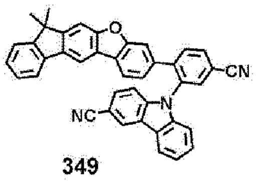
349
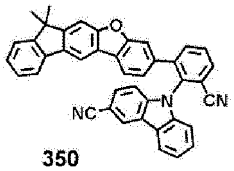
350

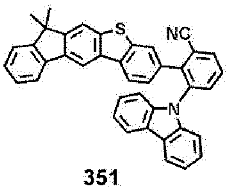
351
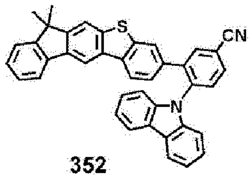
352
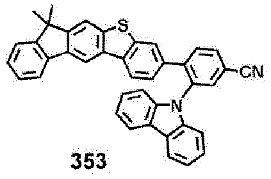
353
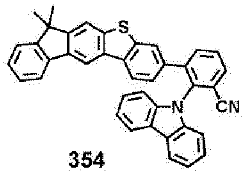
354

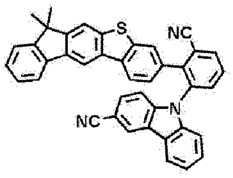
355
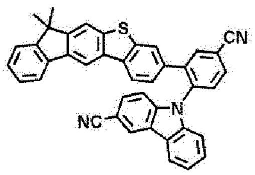
356
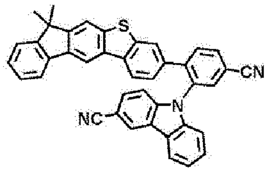
357
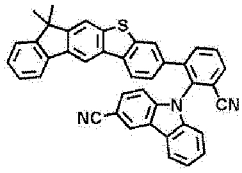
358

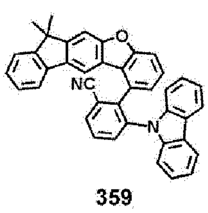
359
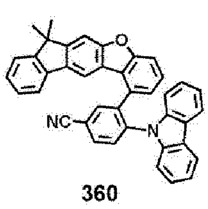
360
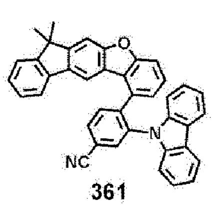
361
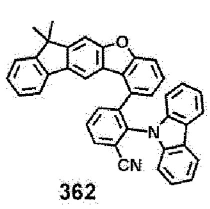
362

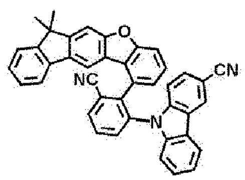
363

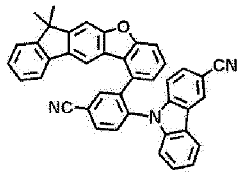
364

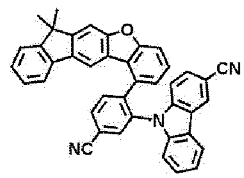
365

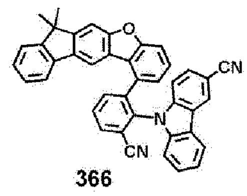
366

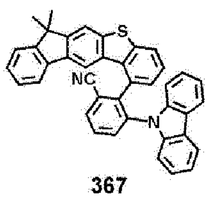
367

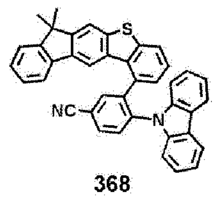
368

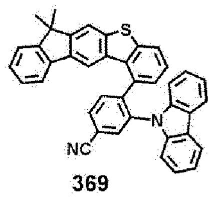
369

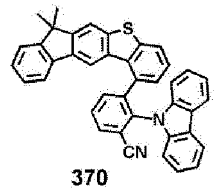
370

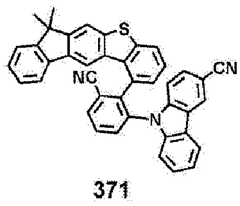
371

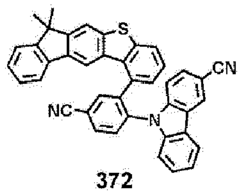
372

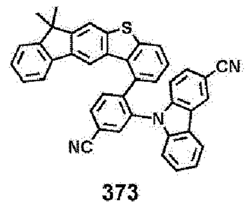
373

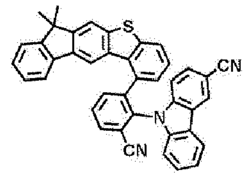
374

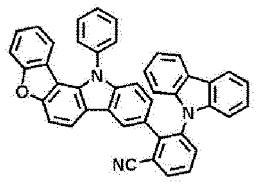
375

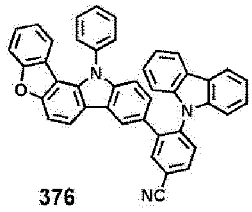
376

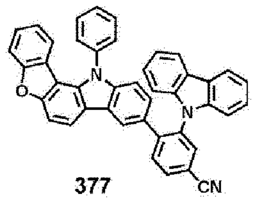
377

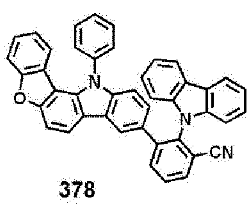
378

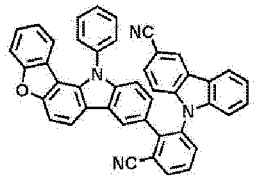
379

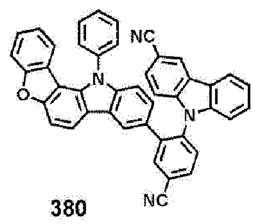
380

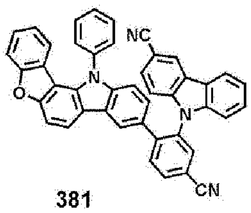
381

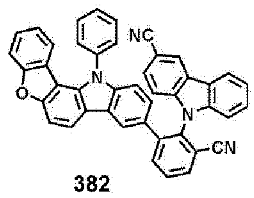
382

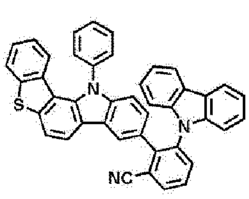
383

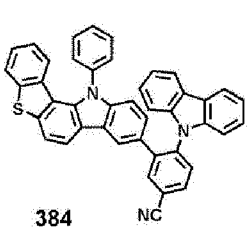
384

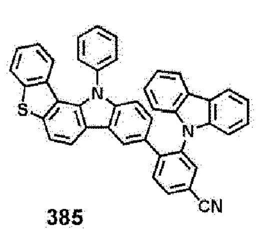
385

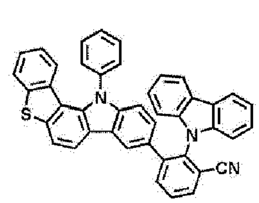
386

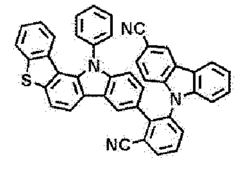
387

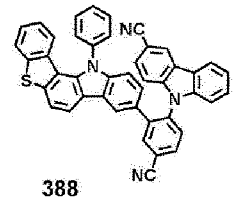
388

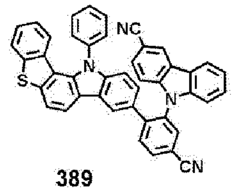
389

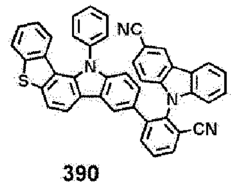
390

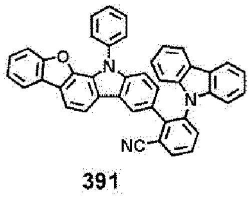
391

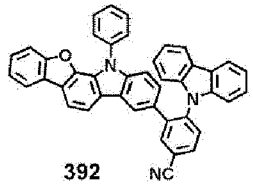
392

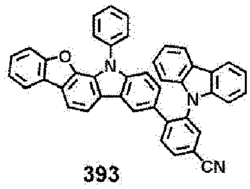
393

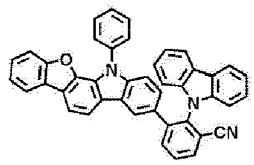
394

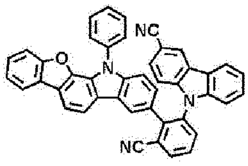
395

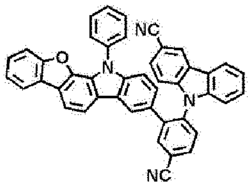
396

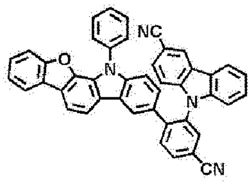
397

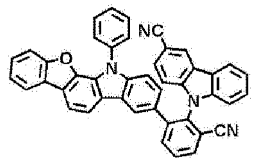
398

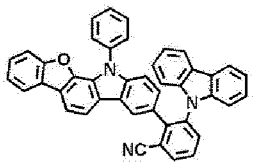
399

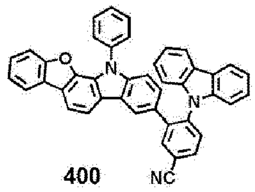
400

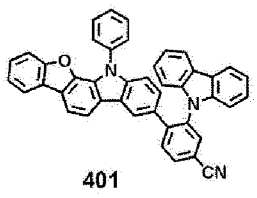
401

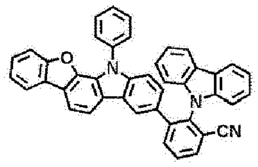
402

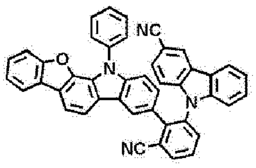
403

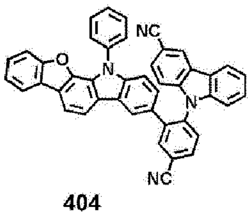
404

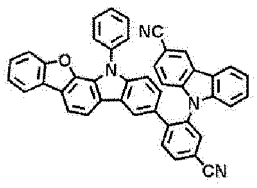
405

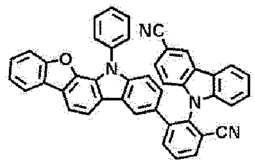
406

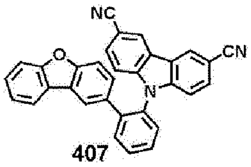
407

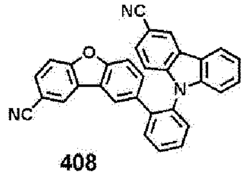
408

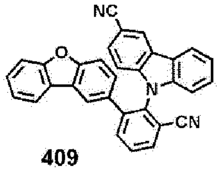
409

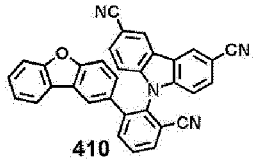
410

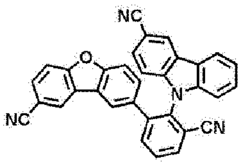
411

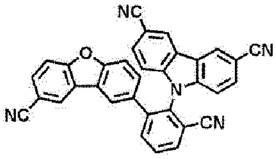
412

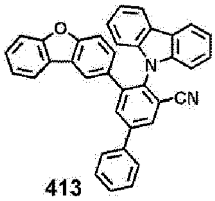
413

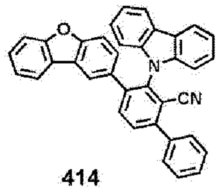
414

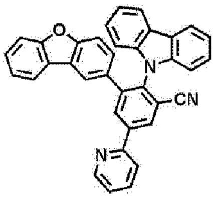
415

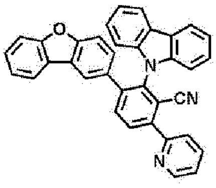
416

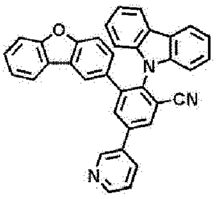
417

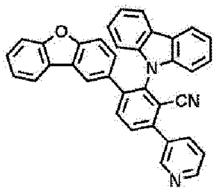
418

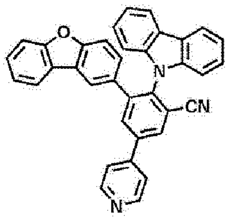
419

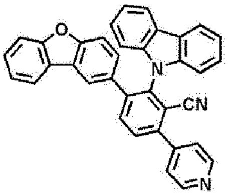
420

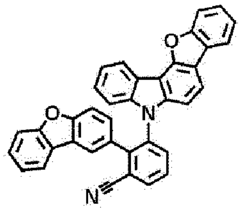

421

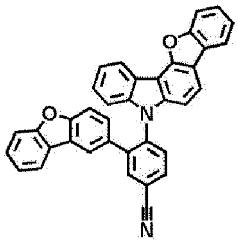

422

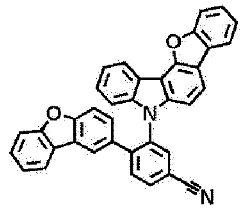

423

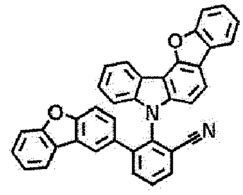

424

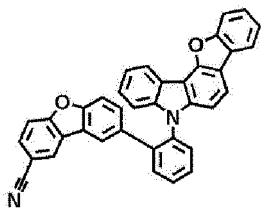

425

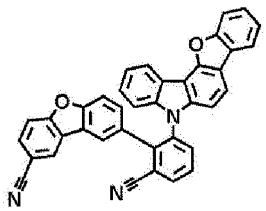

426

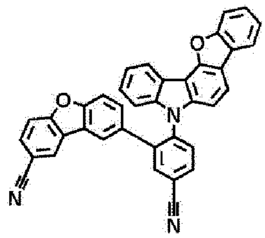

427

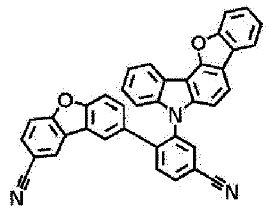

428

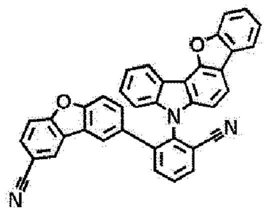

429

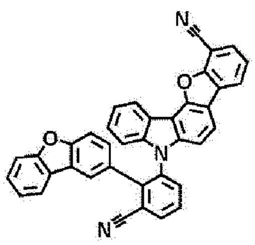

430

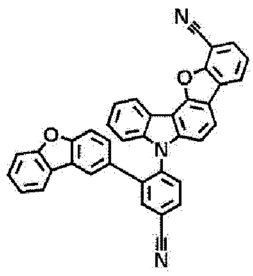

431

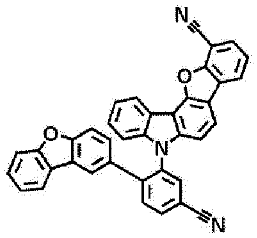

432

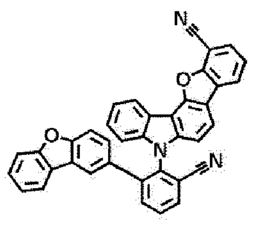
433

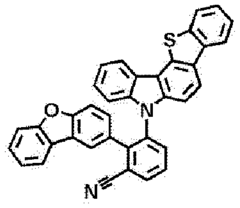
434

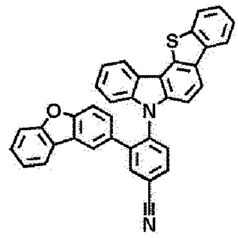
435

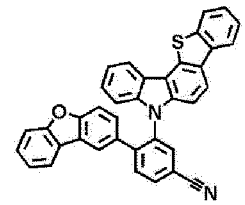
436

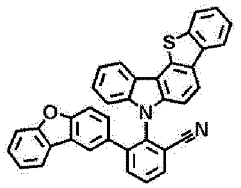
437

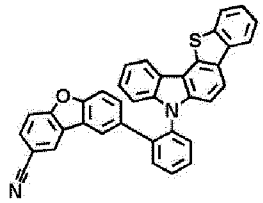
438

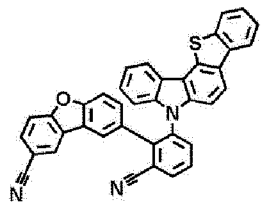
439

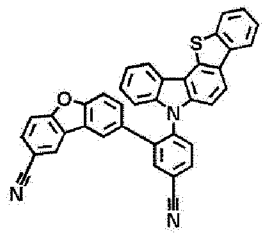
440

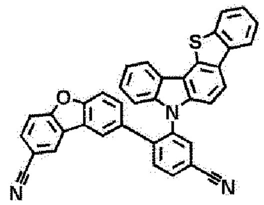
441

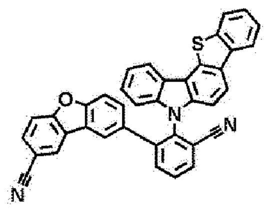
442

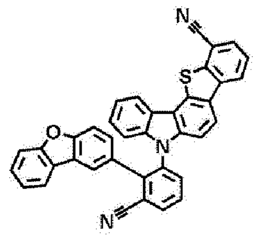
443

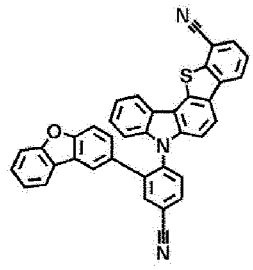
444

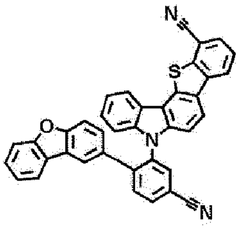
445

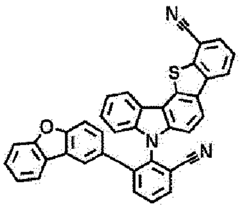
446

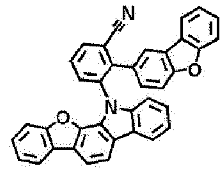
447

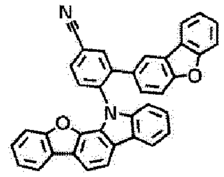
448

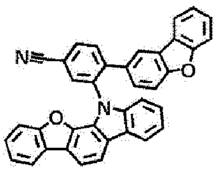
449

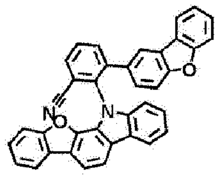
450

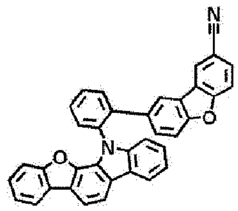
451

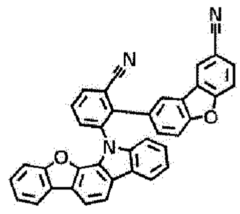
452

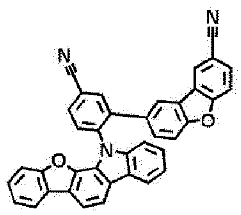
453

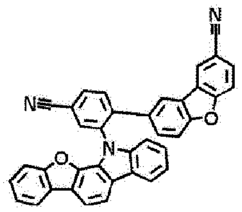
454

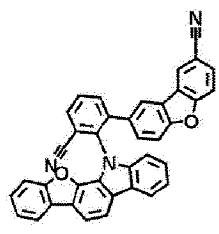
455

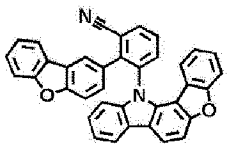
456

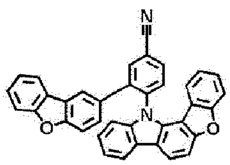
457

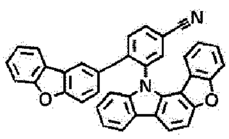
458

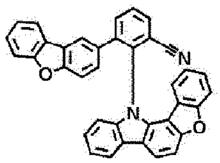
459

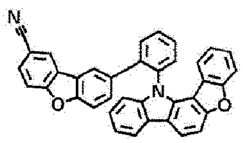
460

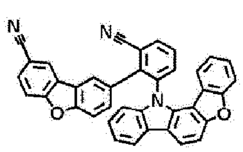
461

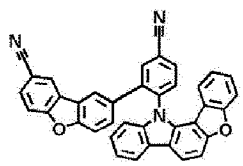
462

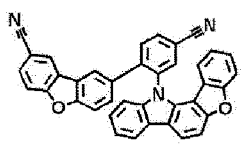
463

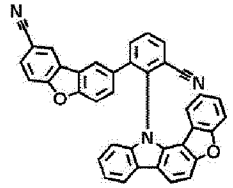
464

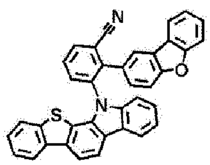
465

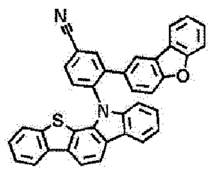
466

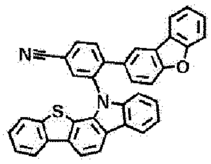
467

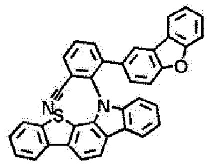
468

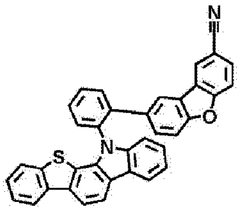

469

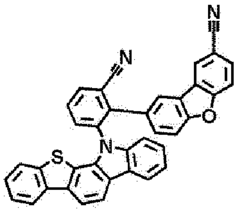

470

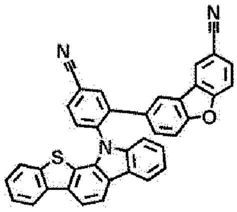

471

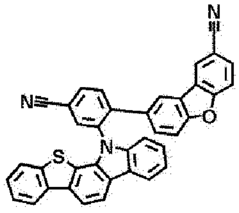

472

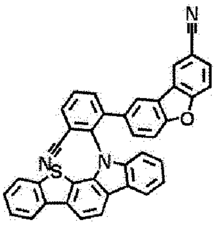

473

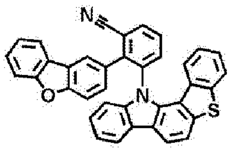

474

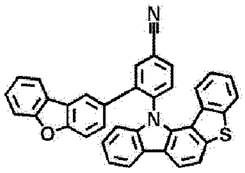

475

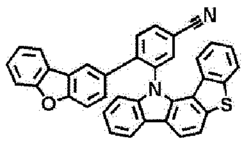

476

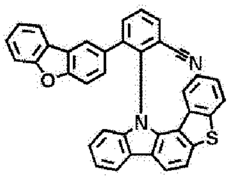

477

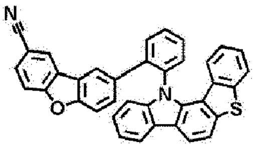

478

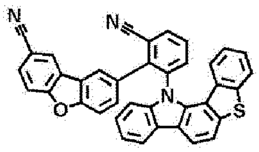

479

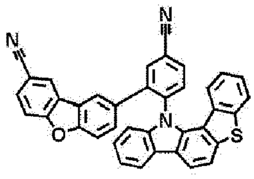

480

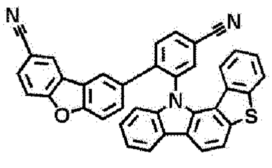

481

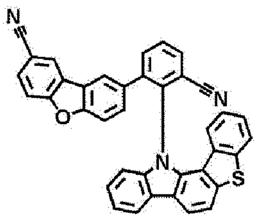

482

Group HE4

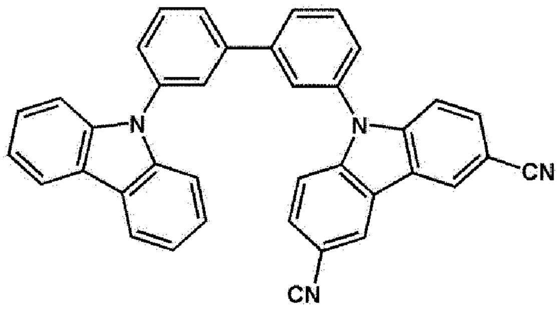

1

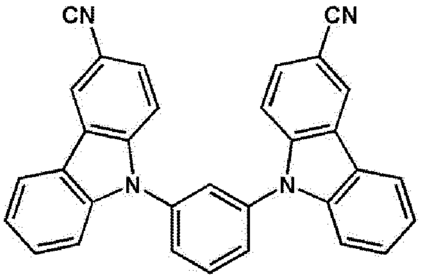

2

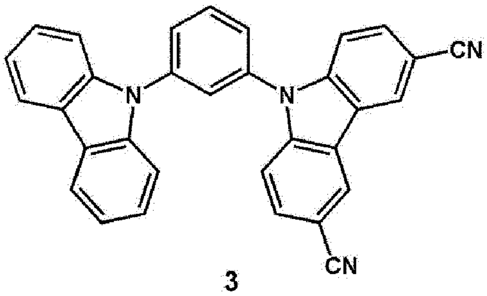

3

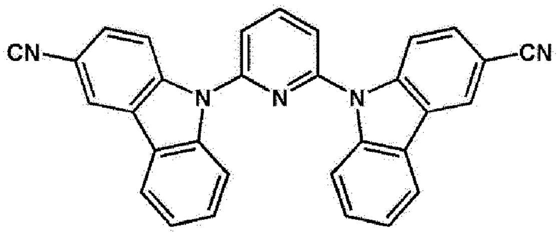

4

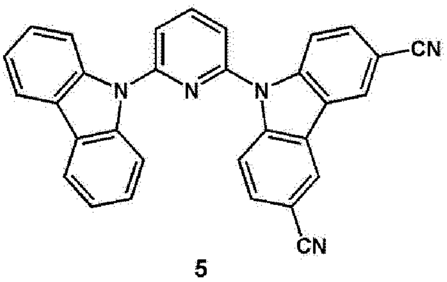

5

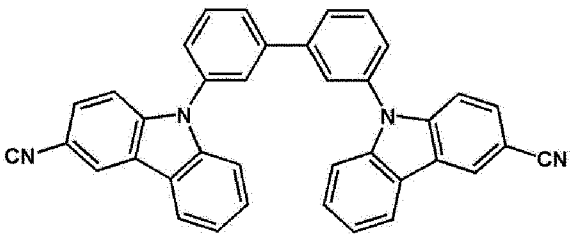

6

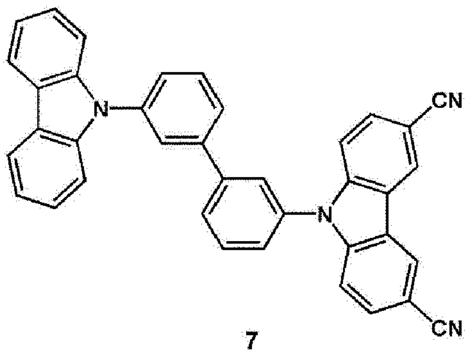

7

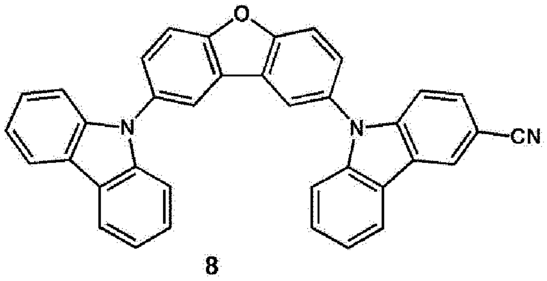

8

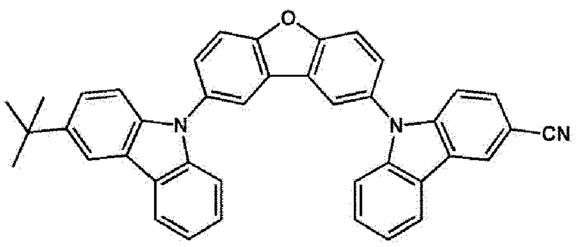

9

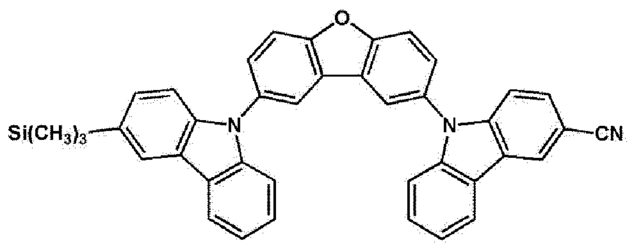

10

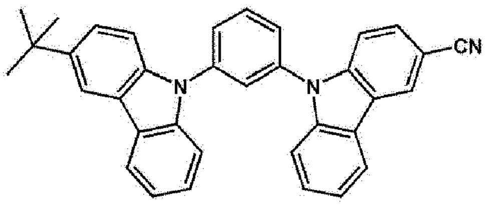

11

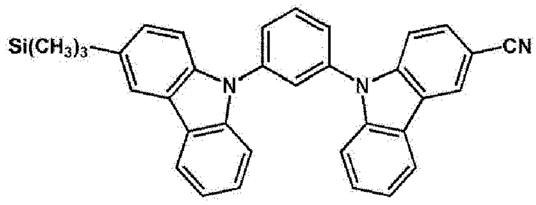

12

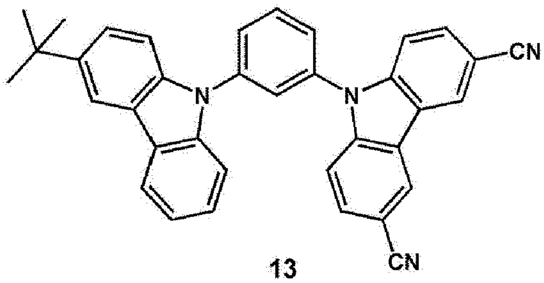

13

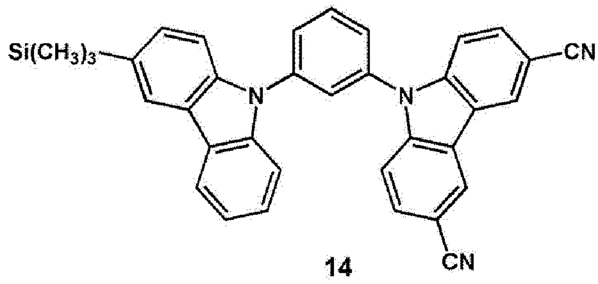

14

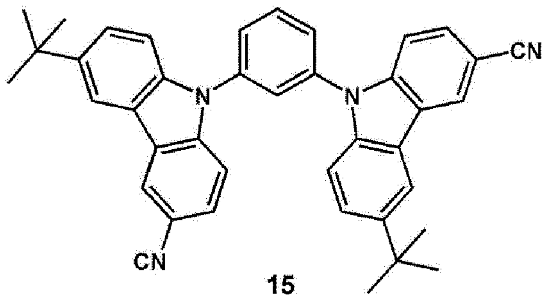

15

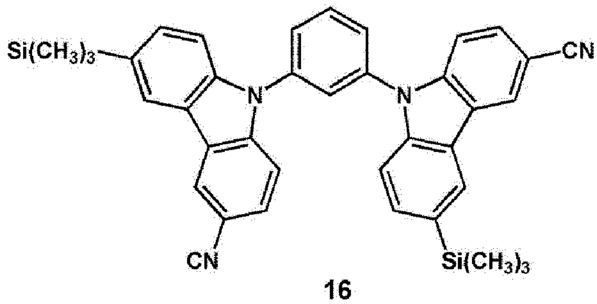

16

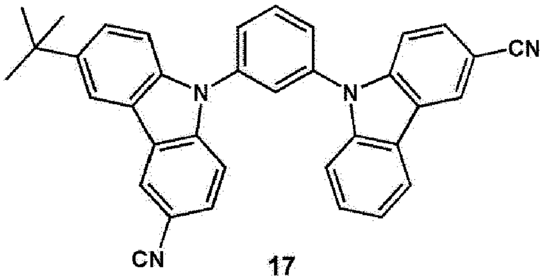

17

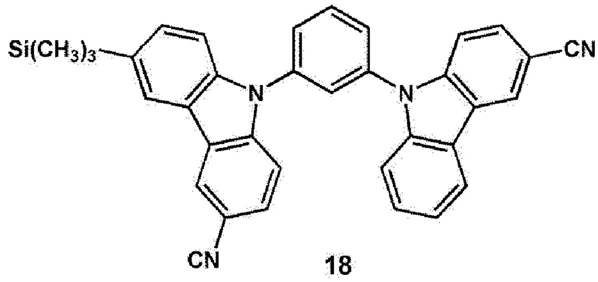

18

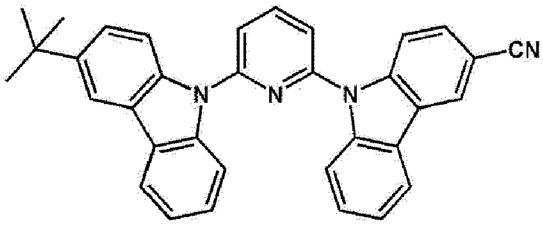

19

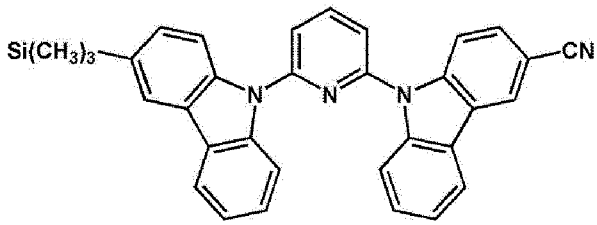

20

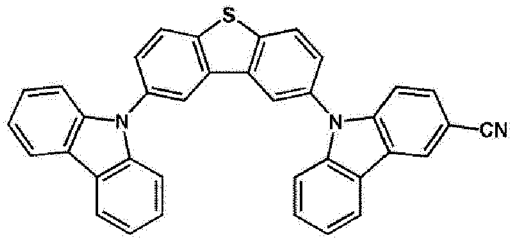

21

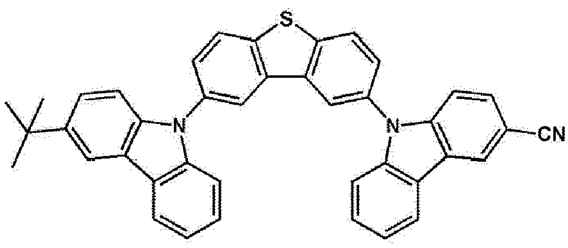

22

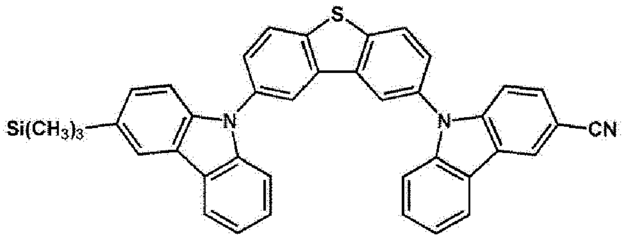

23

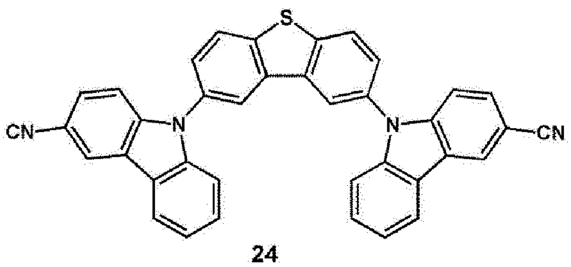

24

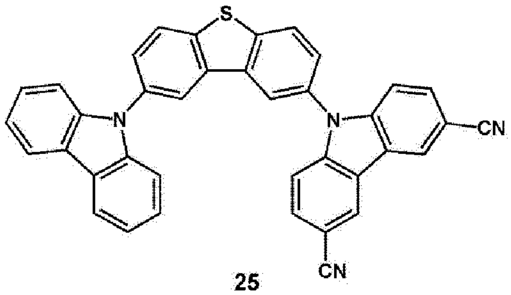

25

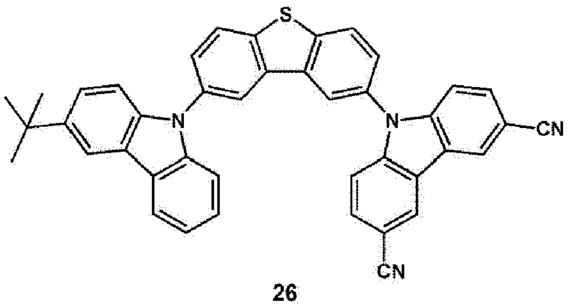

26

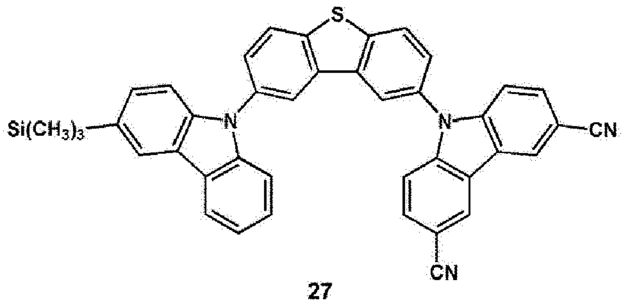

27

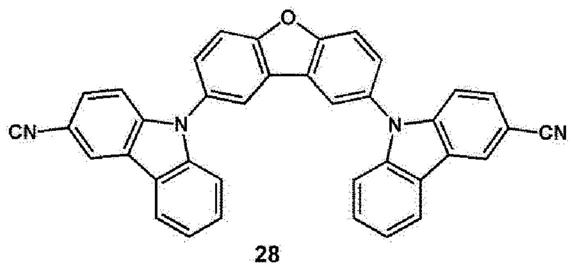

28

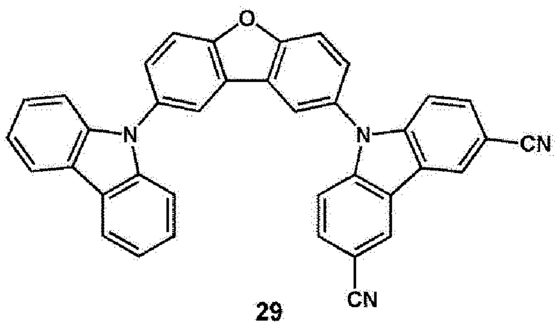

29

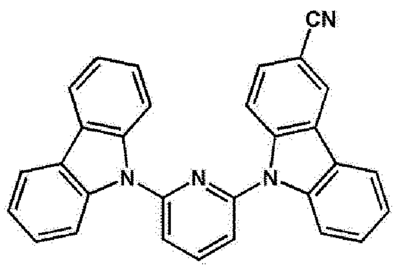

30

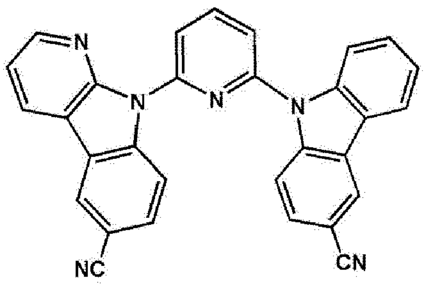

31

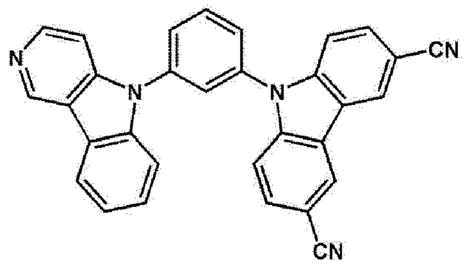

32

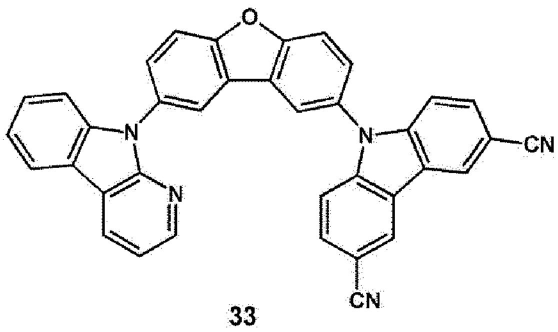

33

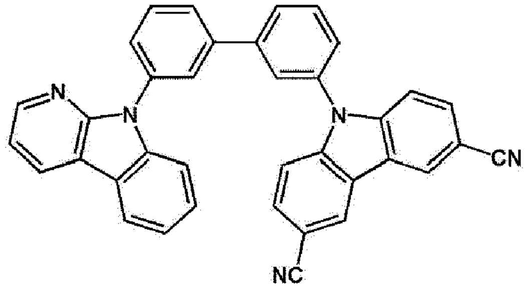

34

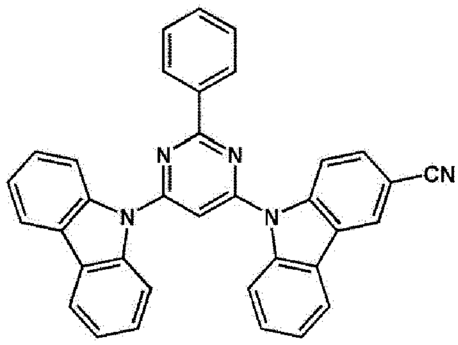

35

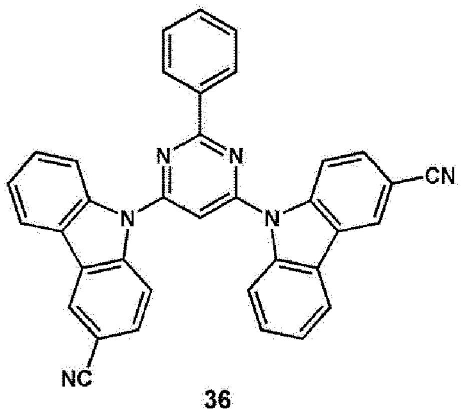

36

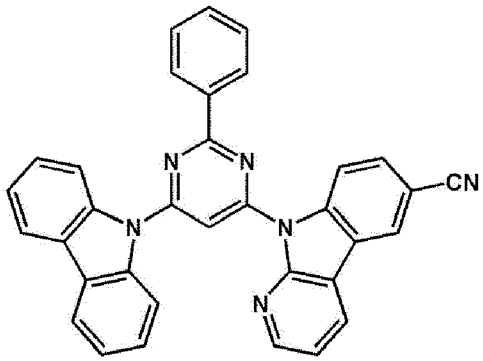

37

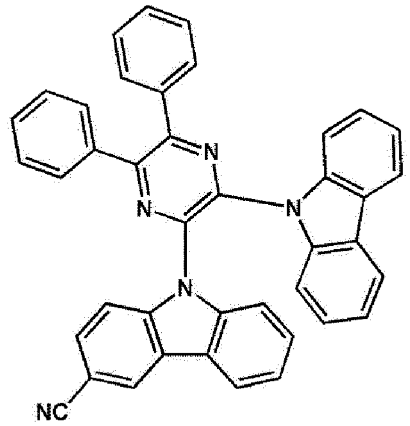

38

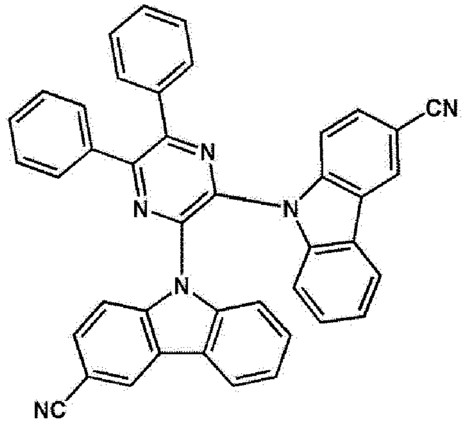

39

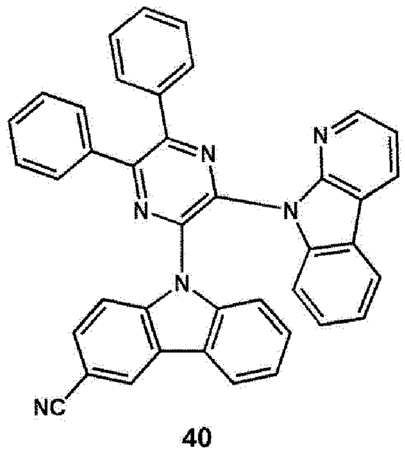

40

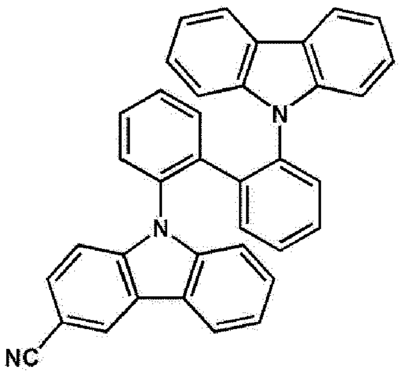
41

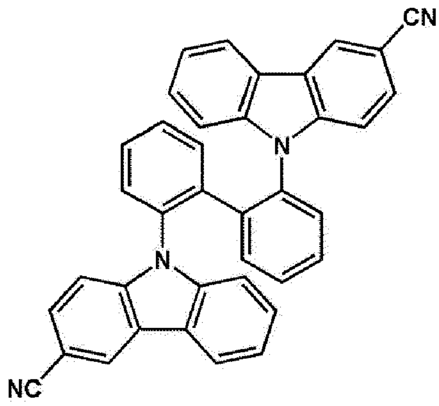
42

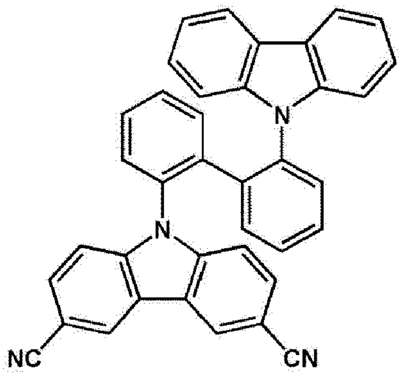
43

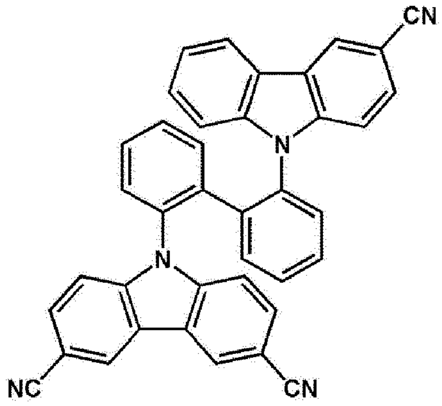
44

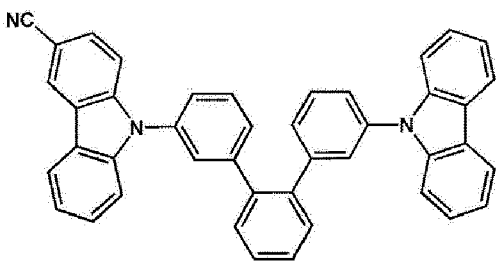
45

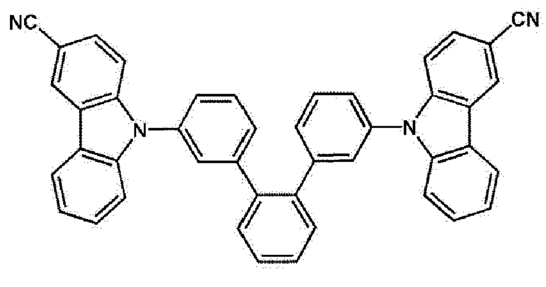
46

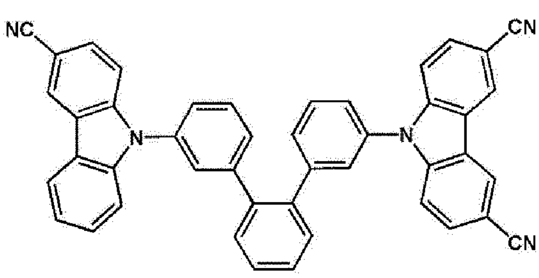
47

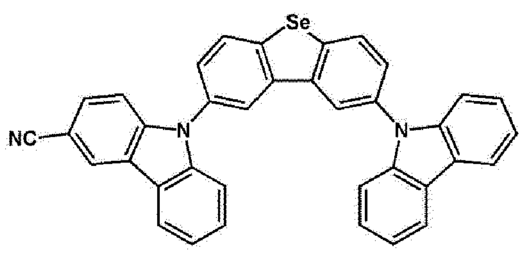
48

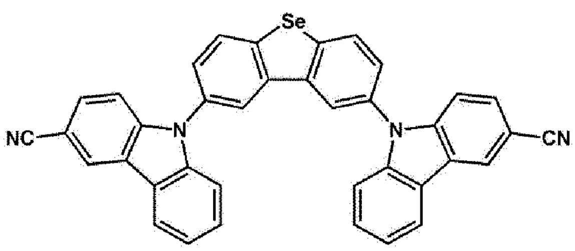

49

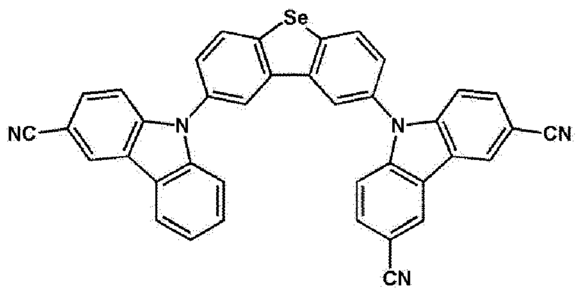

50

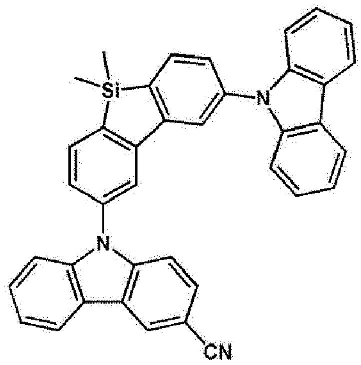

51

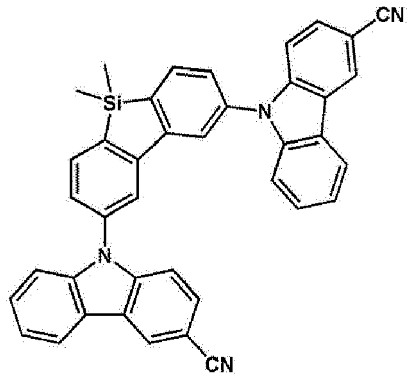

52

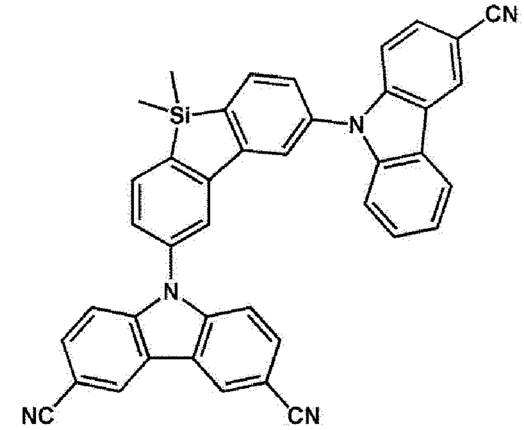

**53**

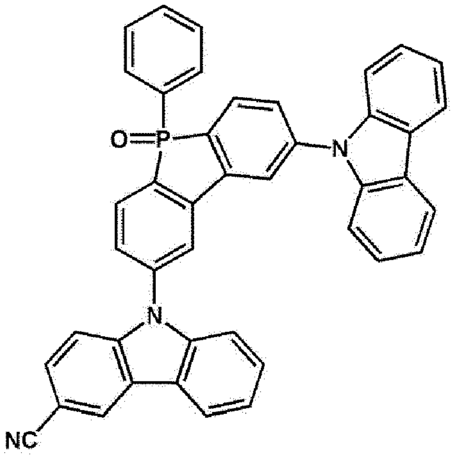

**54**

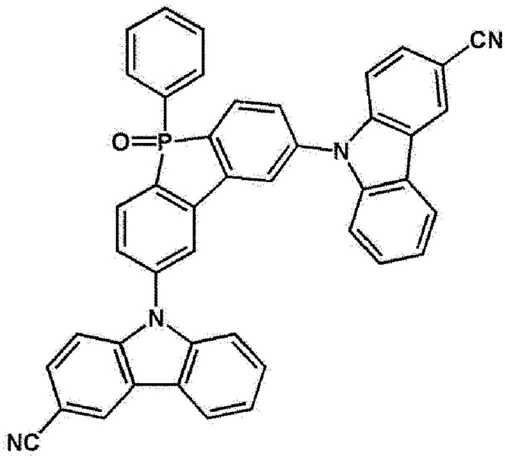

**55**

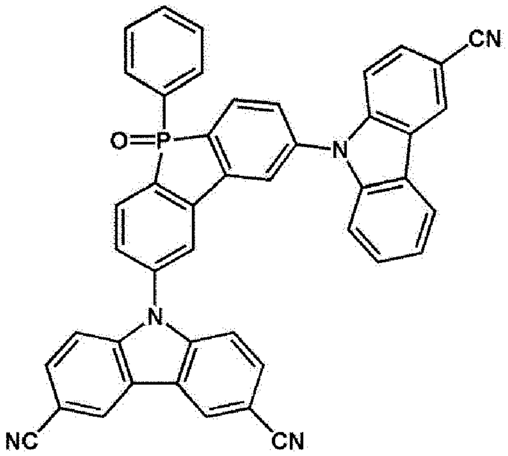

**56**

## Group HE5

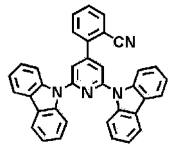
1

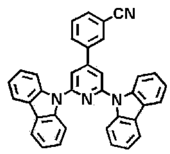
2

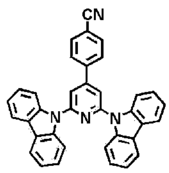
3

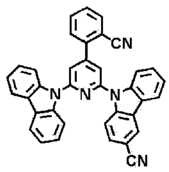
4

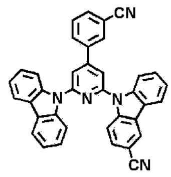
5

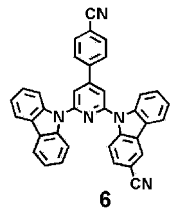
6

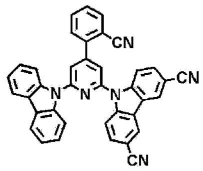
7

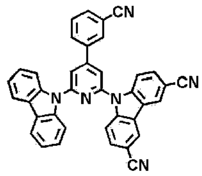
8

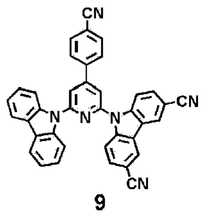
9

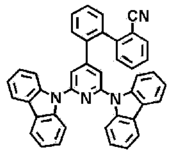
10

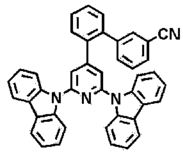
11

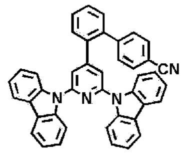
12

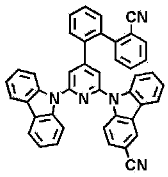
13

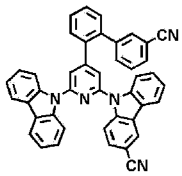
14

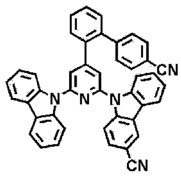
15

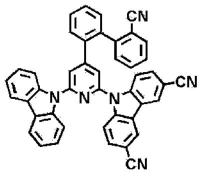
16

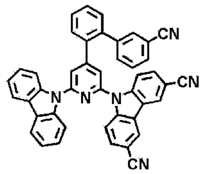
17

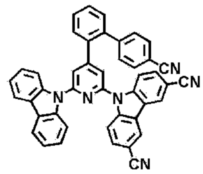
18

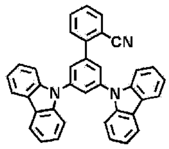
19

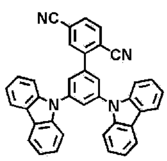
20

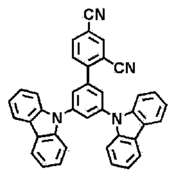
21

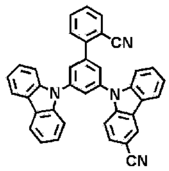
22

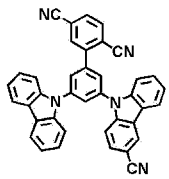
23

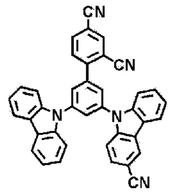
24

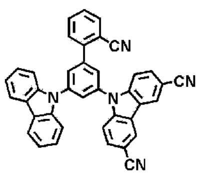
25

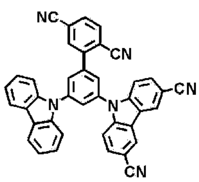
26

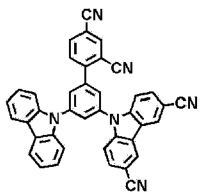
27

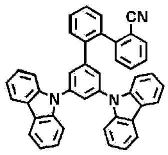
28

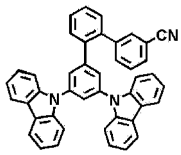
29

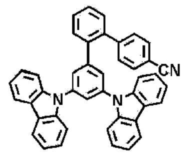
30

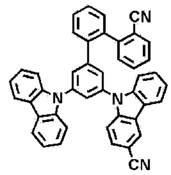
31

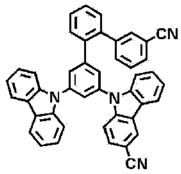
32

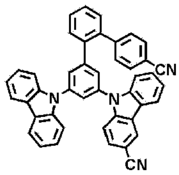
33

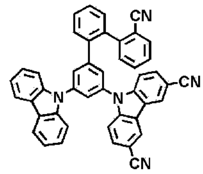
34

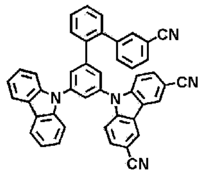
35

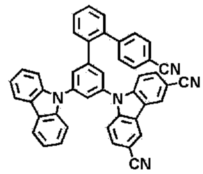
36

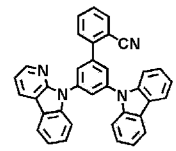
37
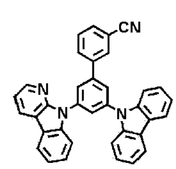
38
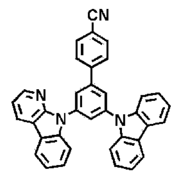
39
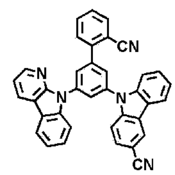
40
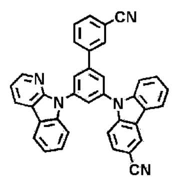
41
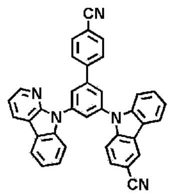
42
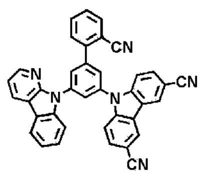
43
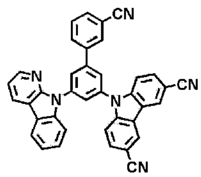
44
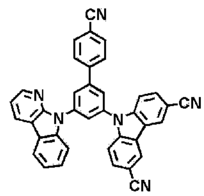
45
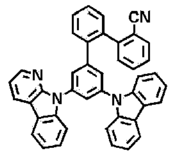
46
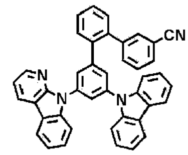
47
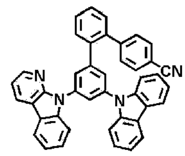
48
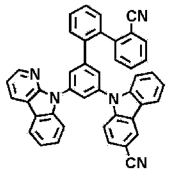
49
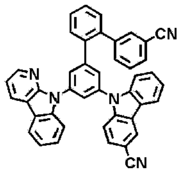
50
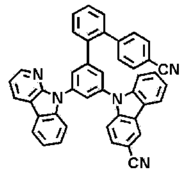
51
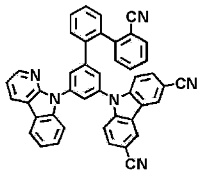
52
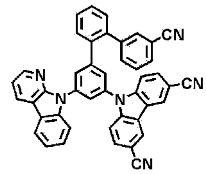
53
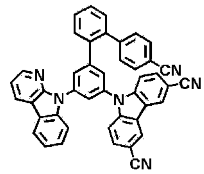
54
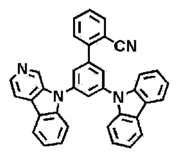
55
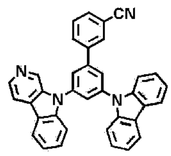
56
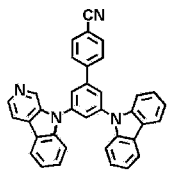
57
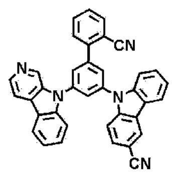
58
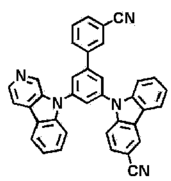
59
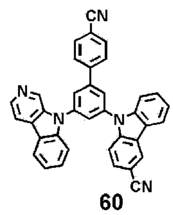
60
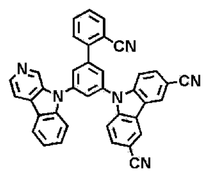
61
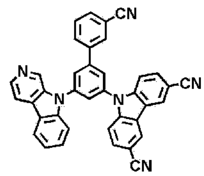
62
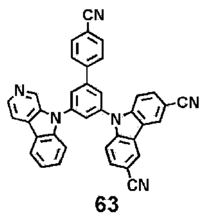
63
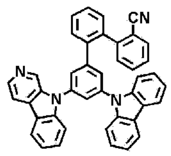
64
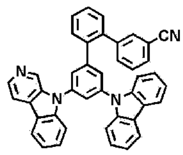
65
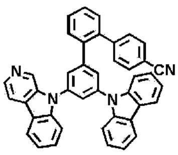
66
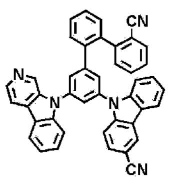
67
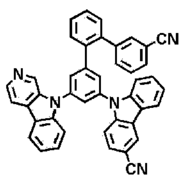
68
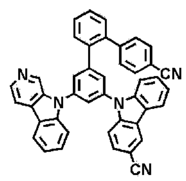
69
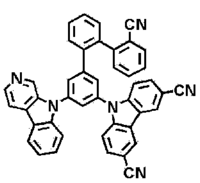
70
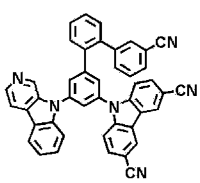
71
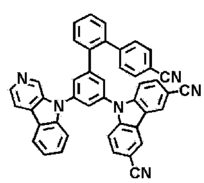
72

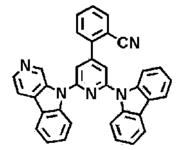
73
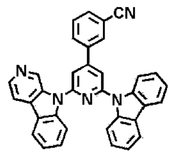
74
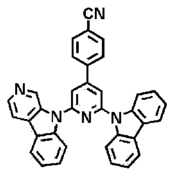
75
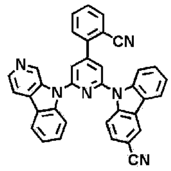
76
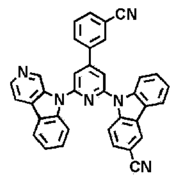
77
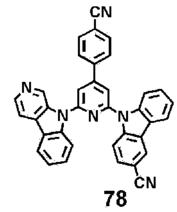
78

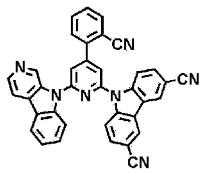
79
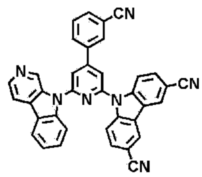
80
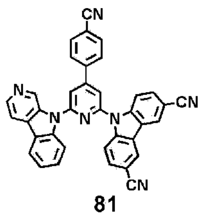
81
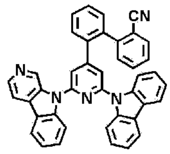
82
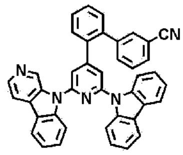
83
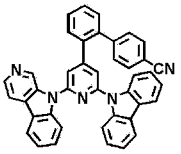
84

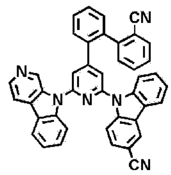
85
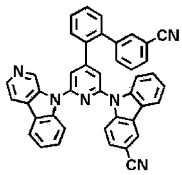
86
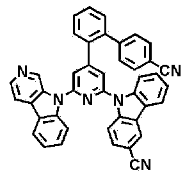
87
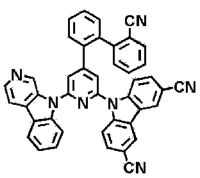
88
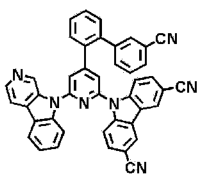
89
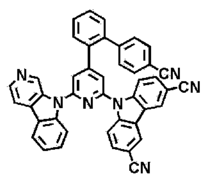
90

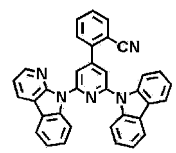
91
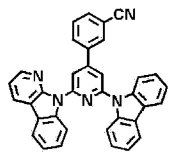
92
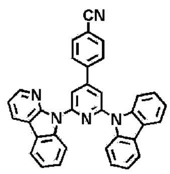
93
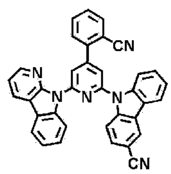
94
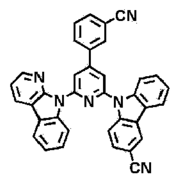
95
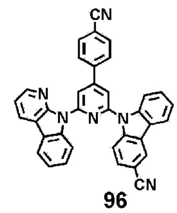
96

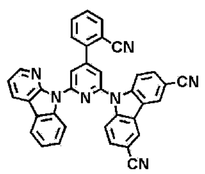
97
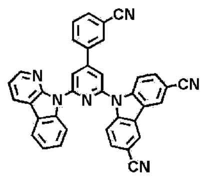
98
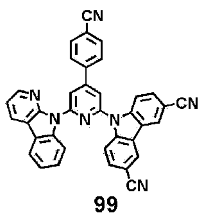
99
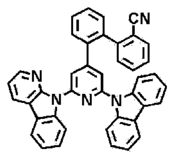
100
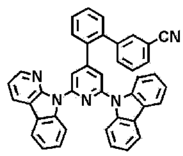
101
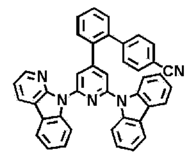
102

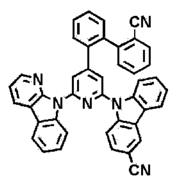
103
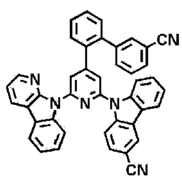
104
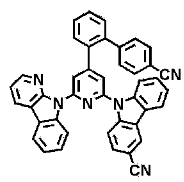
105
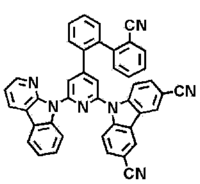
106
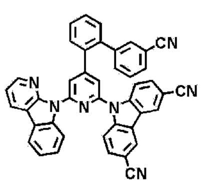
107
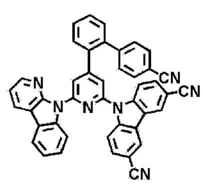
108

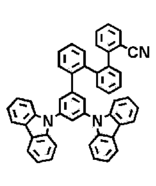
109

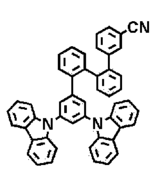
110

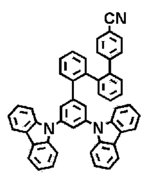
111

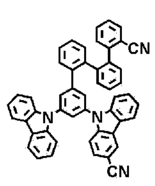
112

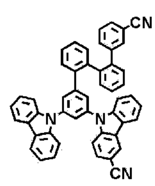
113

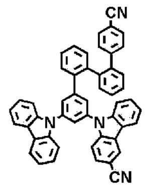
114

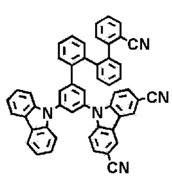
115

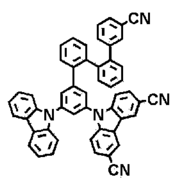
116

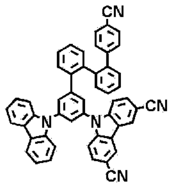
117

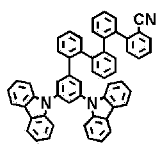
118

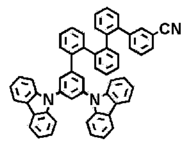
119

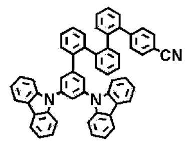
120

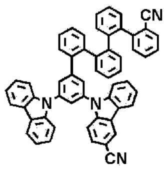
121

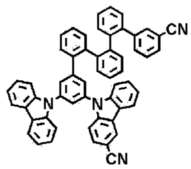
122

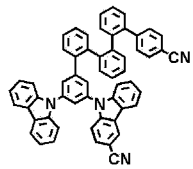
123

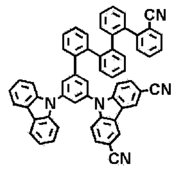
124

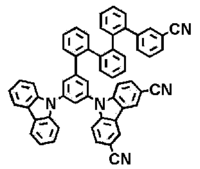
125

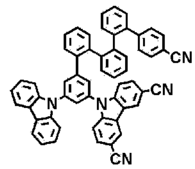
126

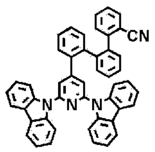
127

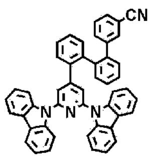
128

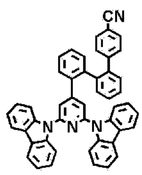
129

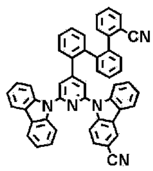
130

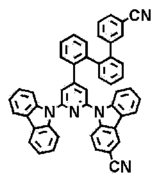
131

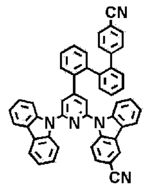
132

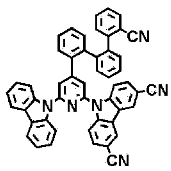
133

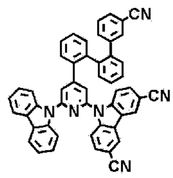
134

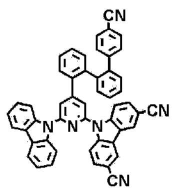
135

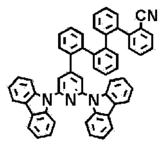
136

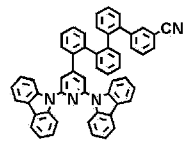
137

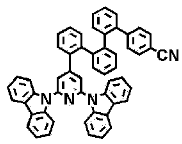
138

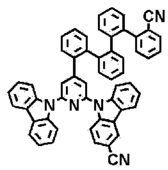
139

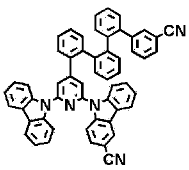
140

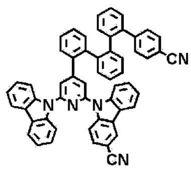
141

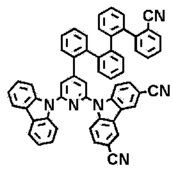
142

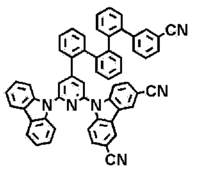
143

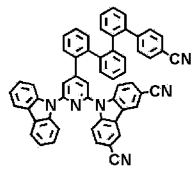
144

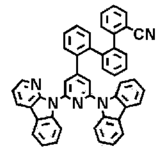

145

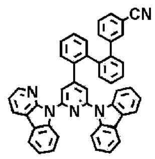

146

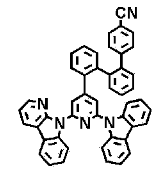

147

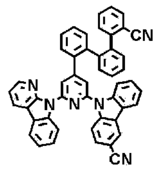

148

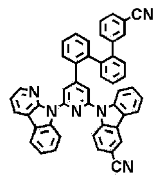

149

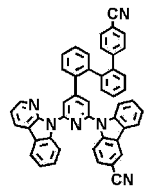

150

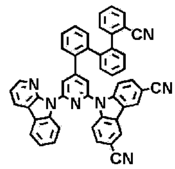

151

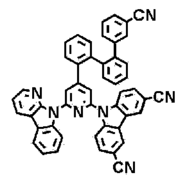

152

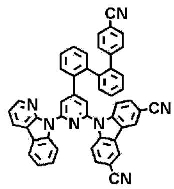

153

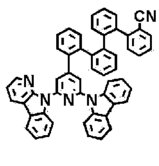

154

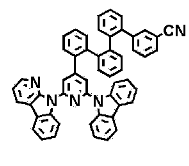

155

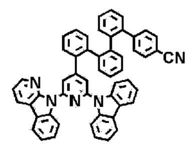

156

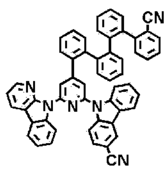

157

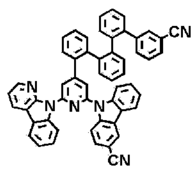

158

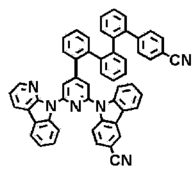

159

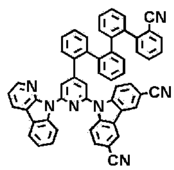

160

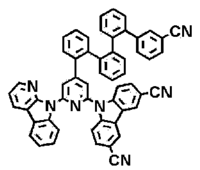

161

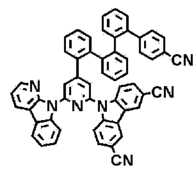

162

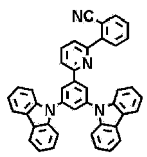

163

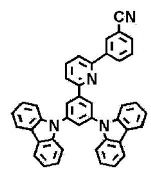

164

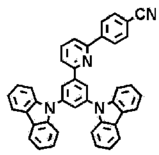

165

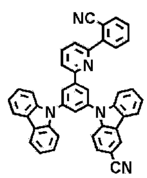

166

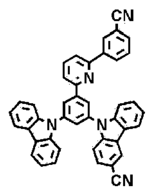

167

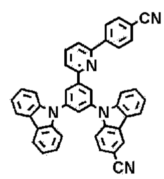

168

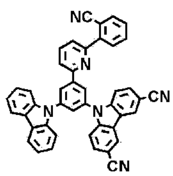

169

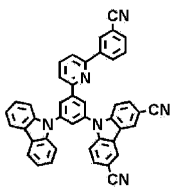

170

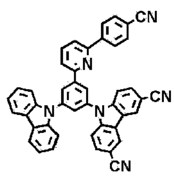

171

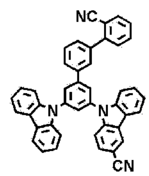

172

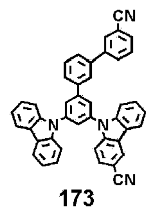

173

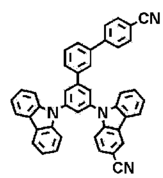

174

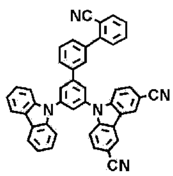

175

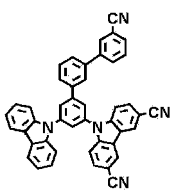

176

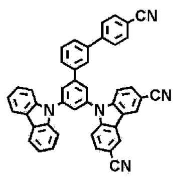

177

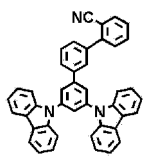

178

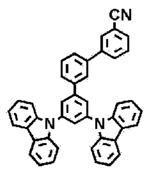

179

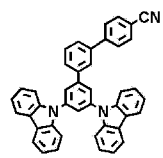

180

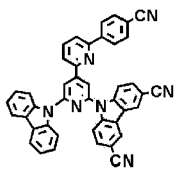
181

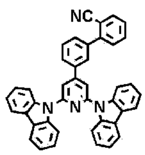
182

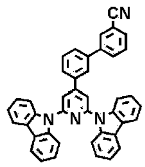
183

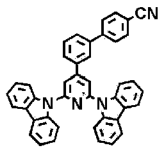
184

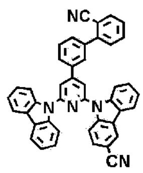
185

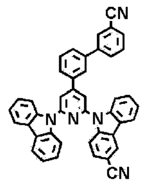
186

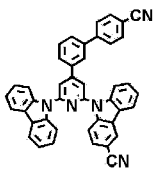
187

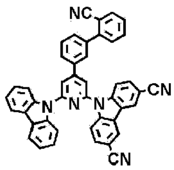
188

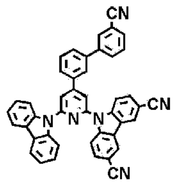
189

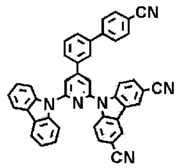
190

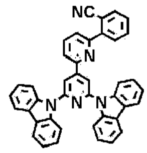
191

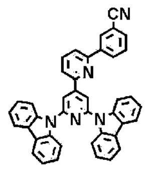
192

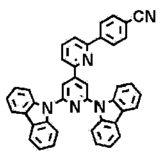
193

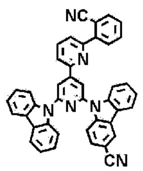
194

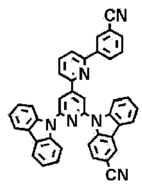
195

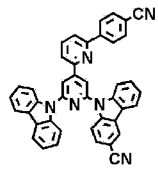
196

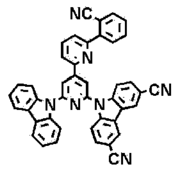
197

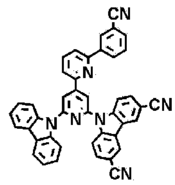
198

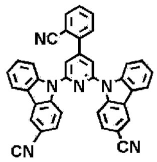
199

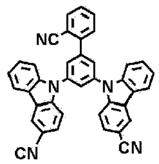
200

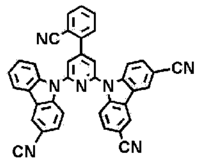
201

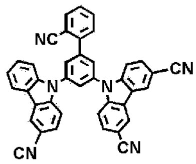
202

Group HE6

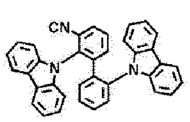
1
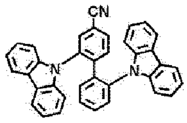
2
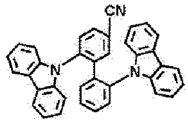
3
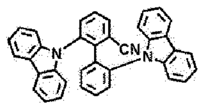
4
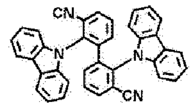
5

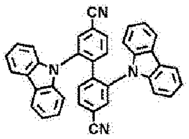
6
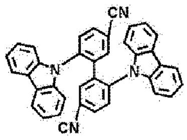
7
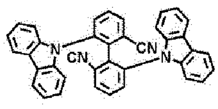
8
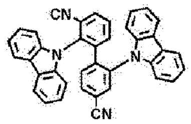
9
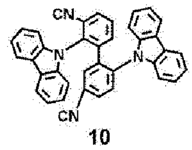
10

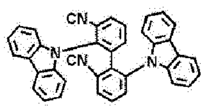
11
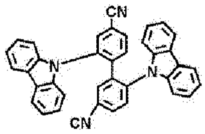
12
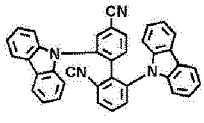
13
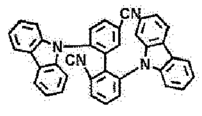
14
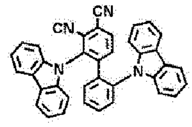
15

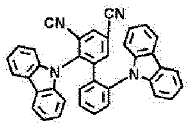
16
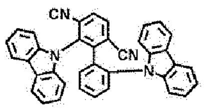
17
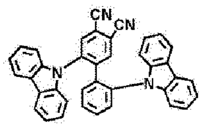
18
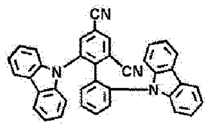
19
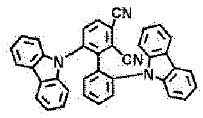
20

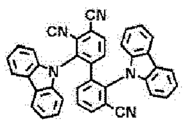
21
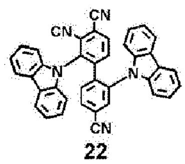
22
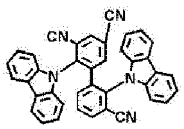
23
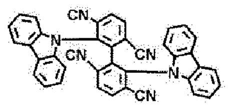
24
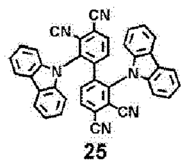
25

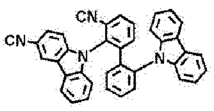
26
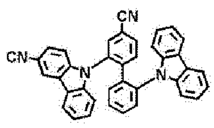
27
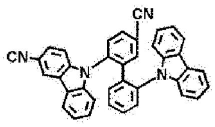
28
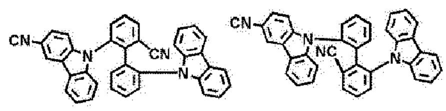
29
30

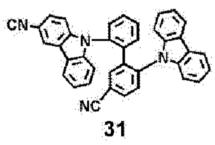
31
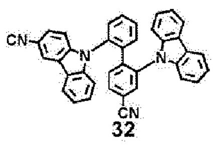
32
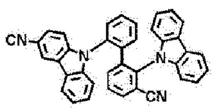
33
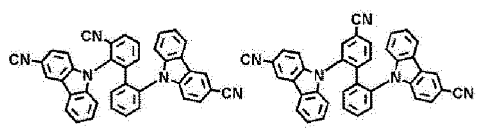
34
35

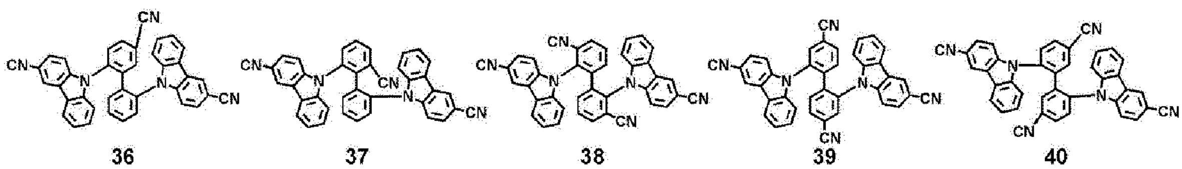
36
37
38
39
40

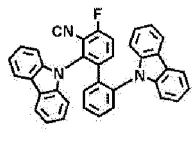
41
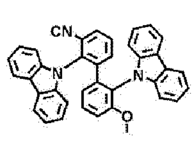
42
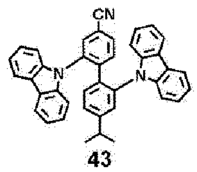
43
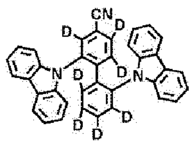
44
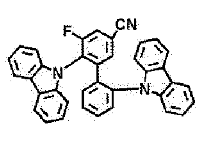
45

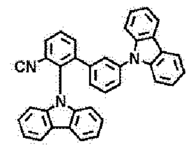
46
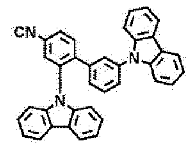
47
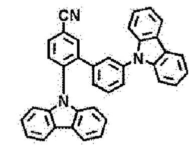
48
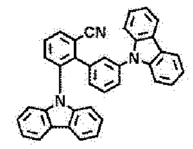
49
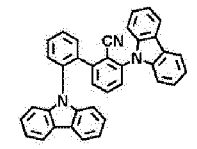
50

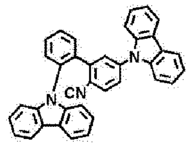
51
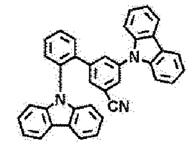
52
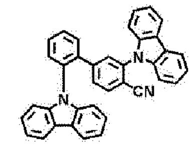
53
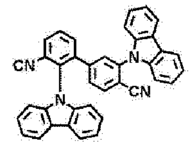
54
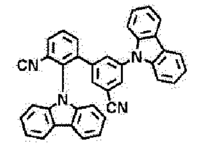
55

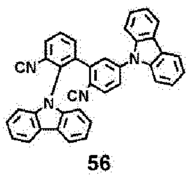
56
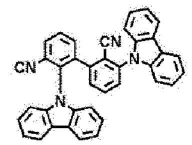
57
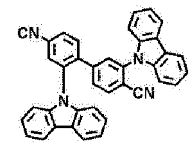
58
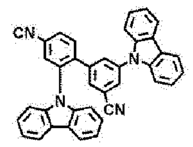
59
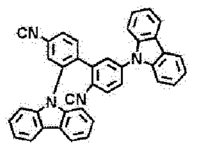
60

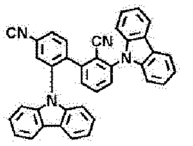
61
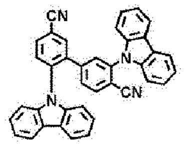
62
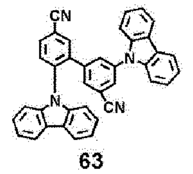
63
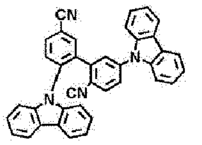
64
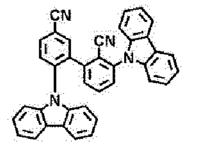
65

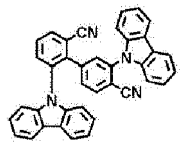
66
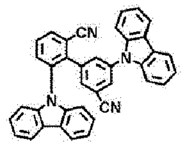
67
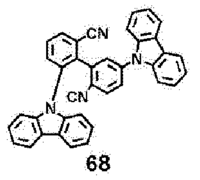
68
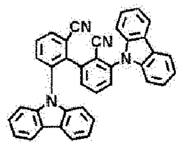
69
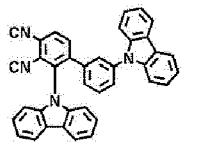
70

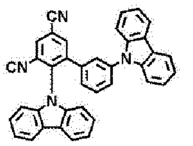
71
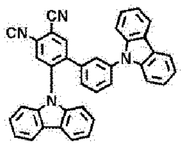
72
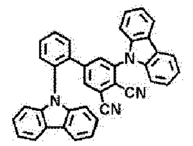
73
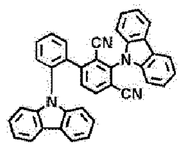
74
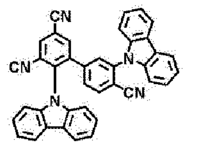
75

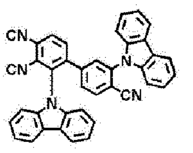
76
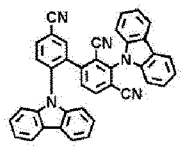
77
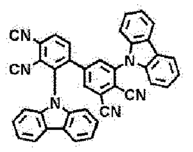
78
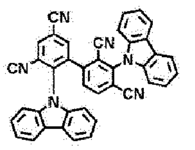
79
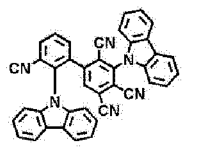
80

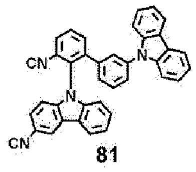
81
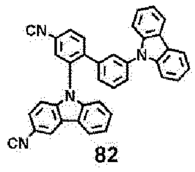
82
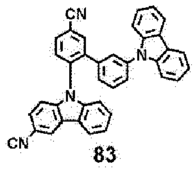
83
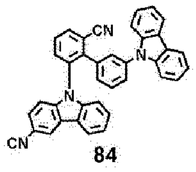
84
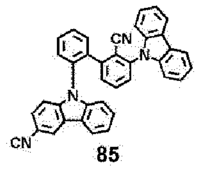
85
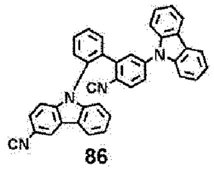
86
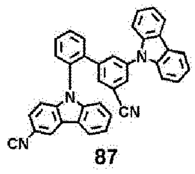
87
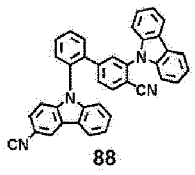
88
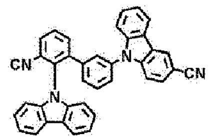
89
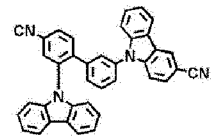
90
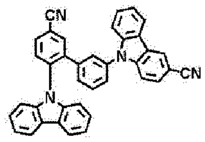
91
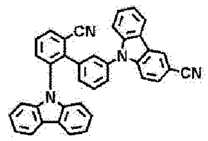
92
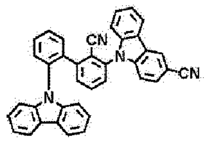
93
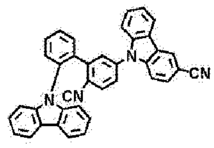
94
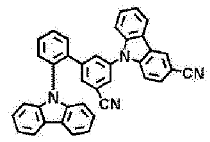
95
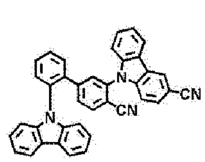
96
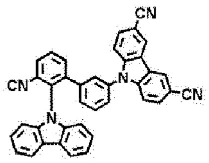
97
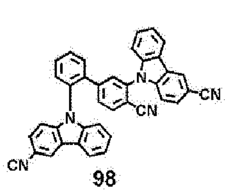
98
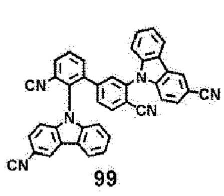
99
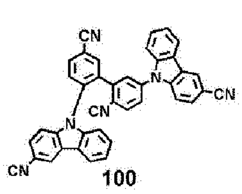
100
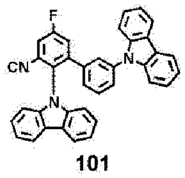
101
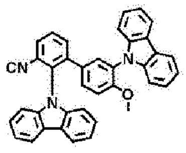
102
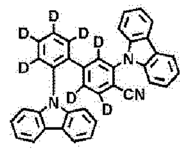
103
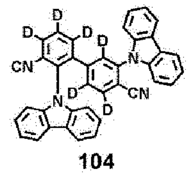
104
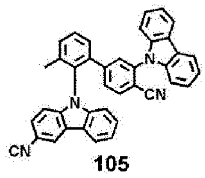
105
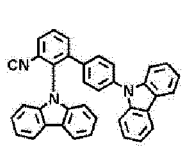
106
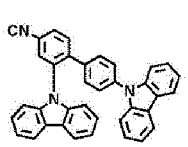
107
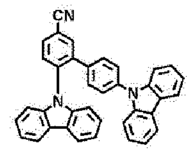
108
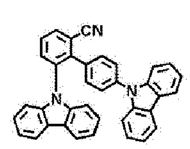
109
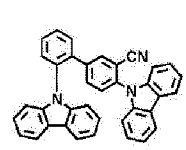
110
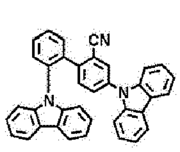
111
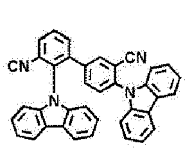
112
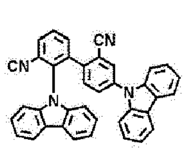
113
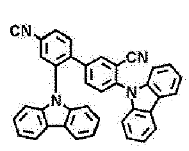
114
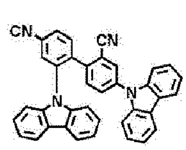
115
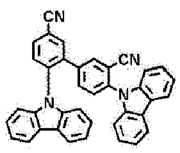
116
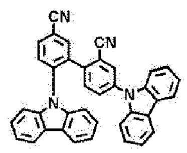
117
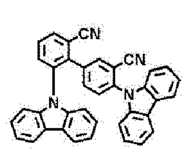
118
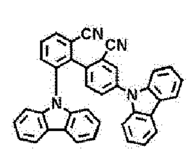
119
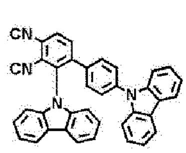
120

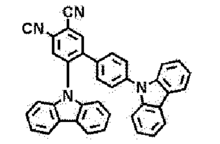
121
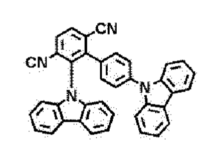
122
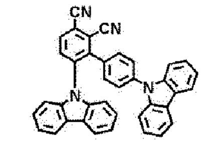
123
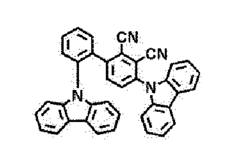
124
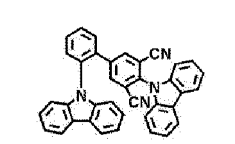
125

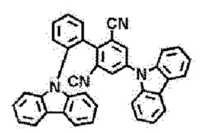
126
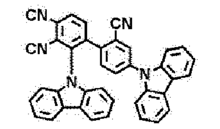
127
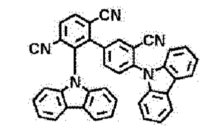
128
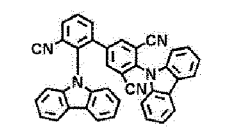
129
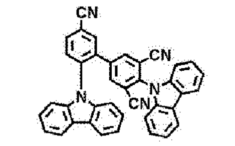
130

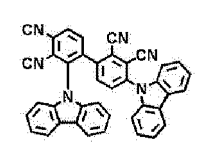
131
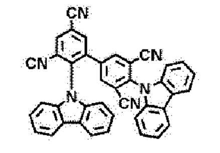
132
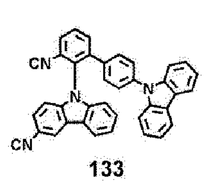
133
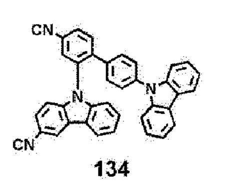
134
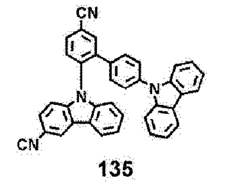
135

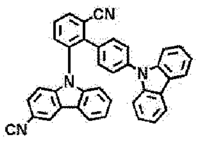
136
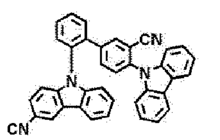
137
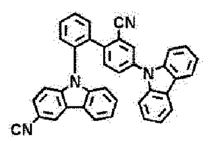
138
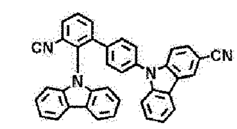
139
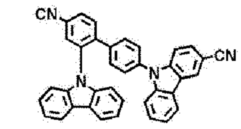
140

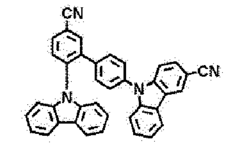
141
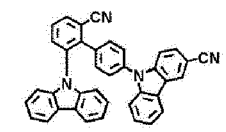
142
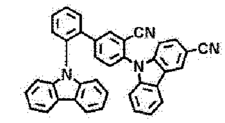
143
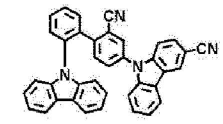
144
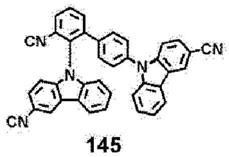
145

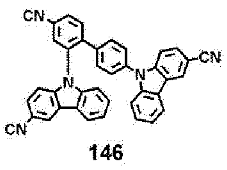
146
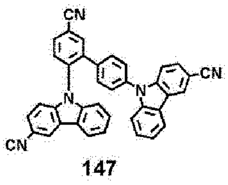
147
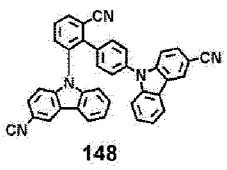
148
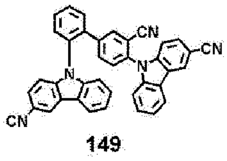
149
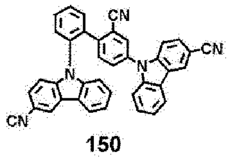
150

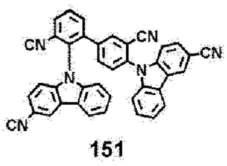
151
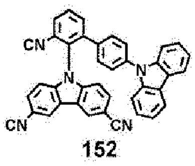
152
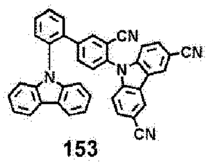
153
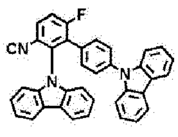
154
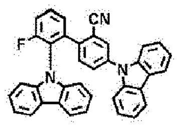
155

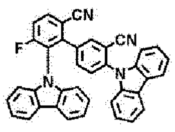
156
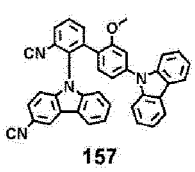
157
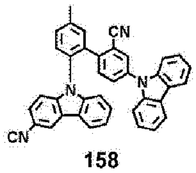
158
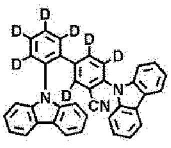
159
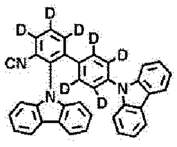
160

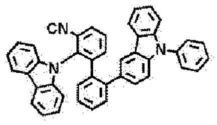
161
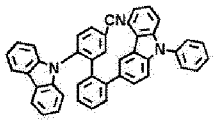
162
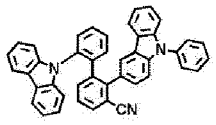
163
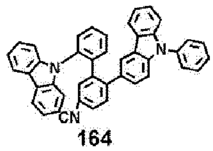
164
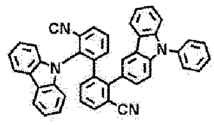
165

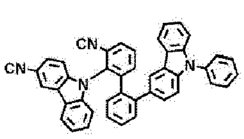
166
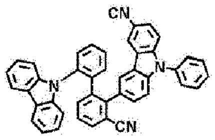
167
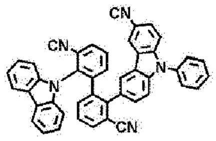
168
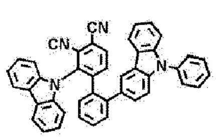
169
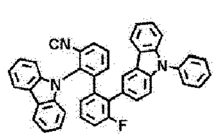
170

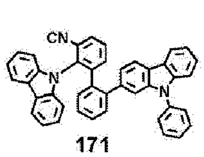
171
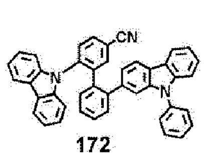
172
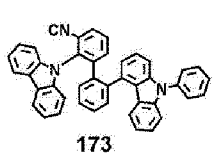
173
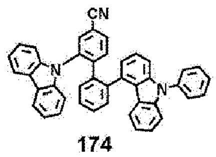
174
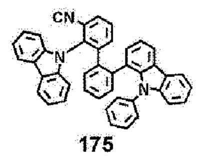
175

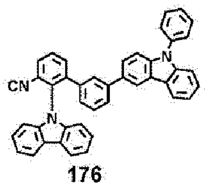
176
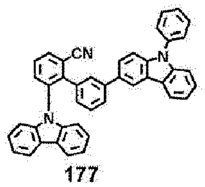
177
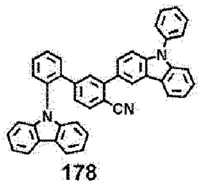
178
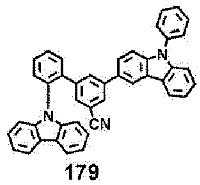
179
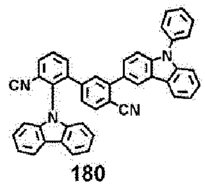
180

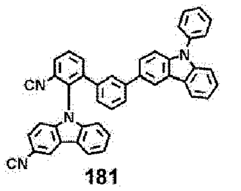
181
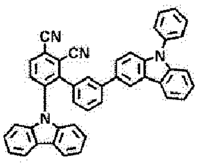
182
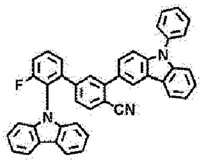
183
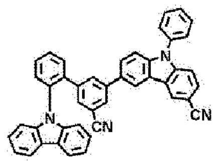
184
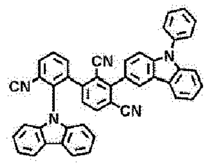
185

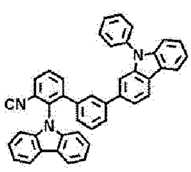
186
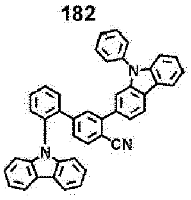
187
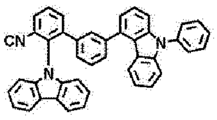
188
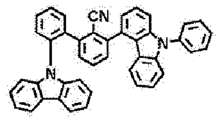
189
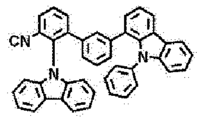
190

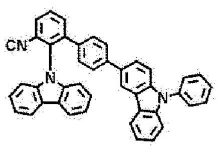
191
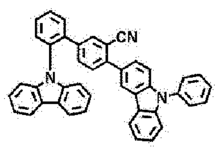
192
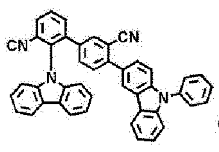
193
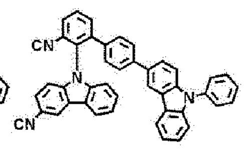
194
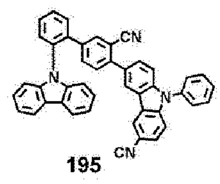
195

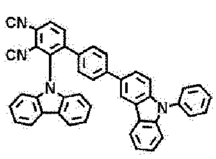
196
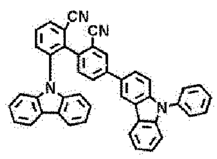
197
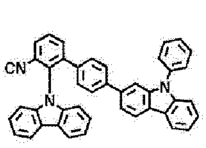
198
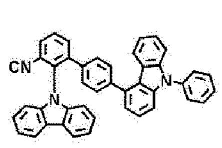
199
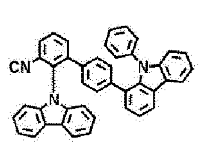
200

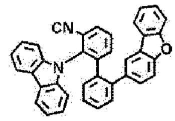
201
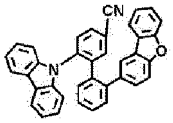
202
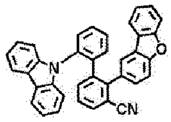
203
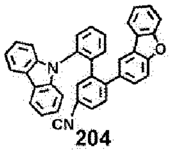
204
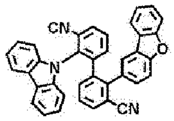
205

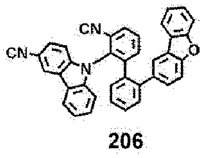
206
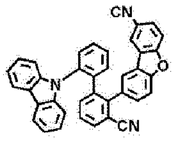
207
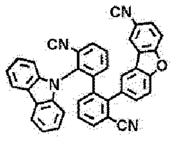
208
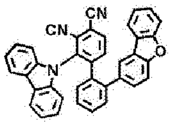
209
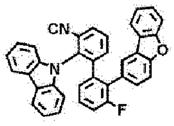
210

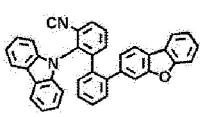
211
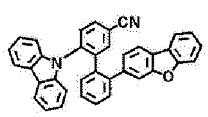
212
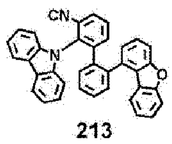
213
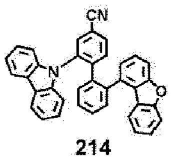
214
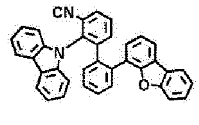
215

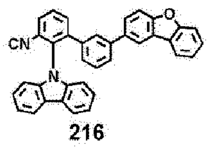
216
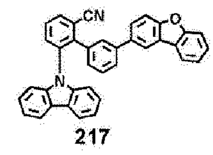
217
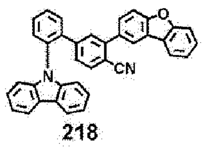
218
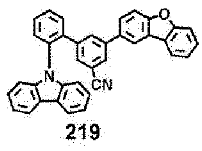
219
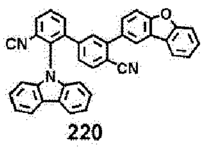
220

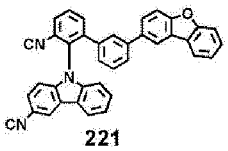
221
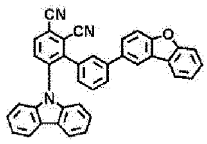
222
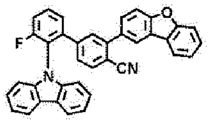
223
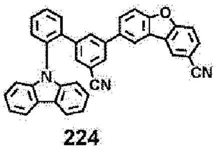
224
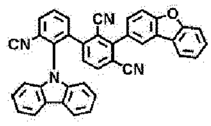
225

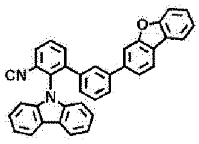
226
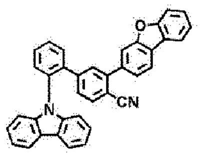
227
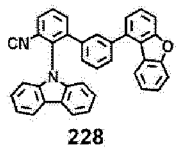
228
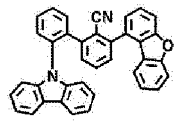
229
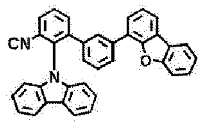
230

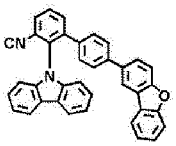
231
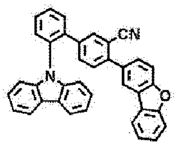
232
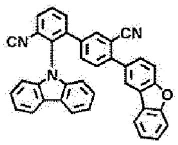
233
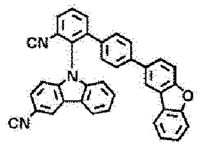
234
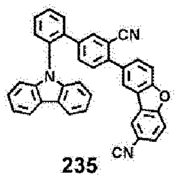
235

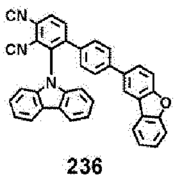
236
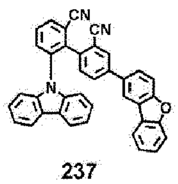
237
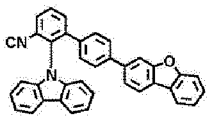
238
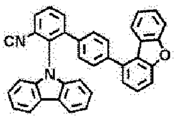
239
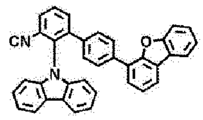
240

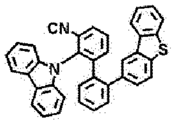
241

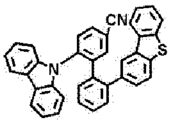
242

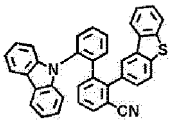
243

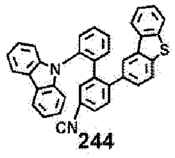
244

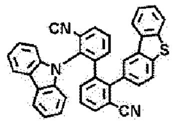
245

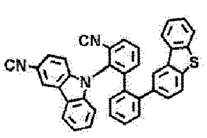
246

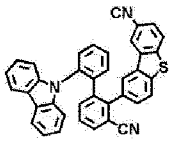
247

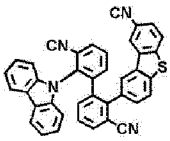
248

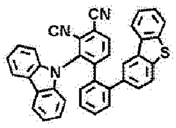
249

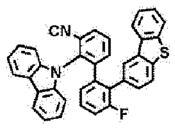
250

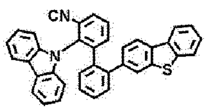
251

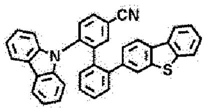
252

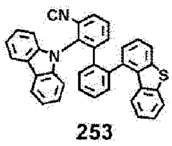
253

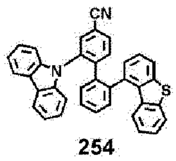
254

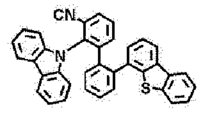
255

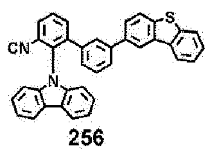
256

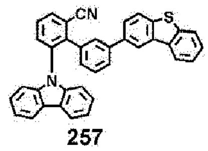
257

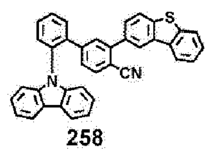
258

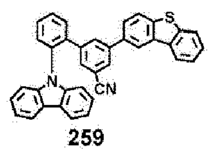
259

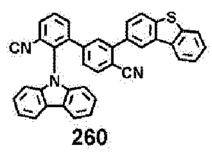
260

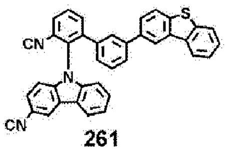
261

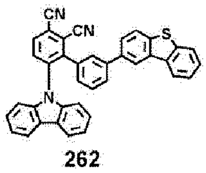
262

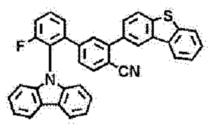
263

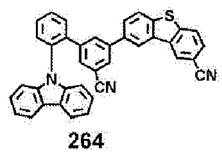
264

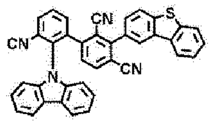
265

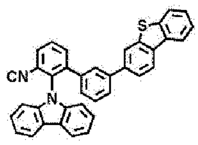
266

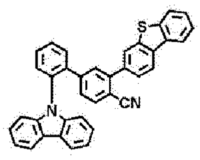
267

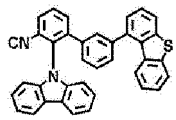
268

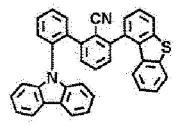
269

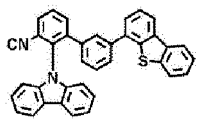
270

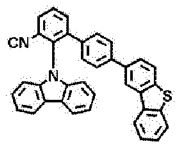
271

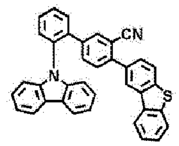
272

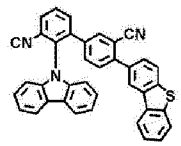
273

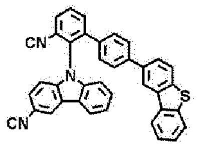
274

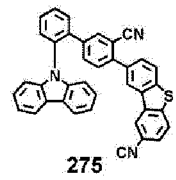
275

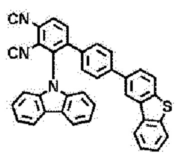
276

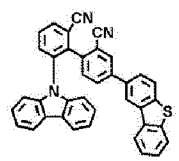
277

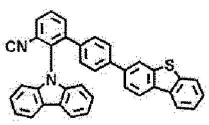
278

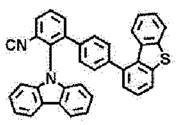
279

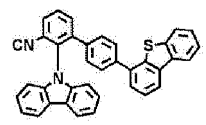
280

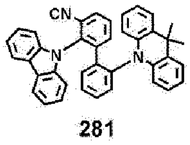
281

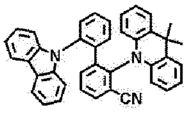
282

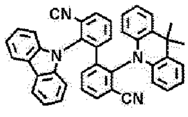
283

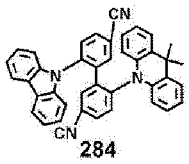
284

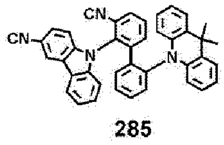
285

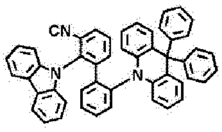
286

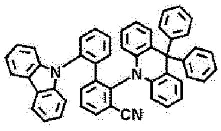
287

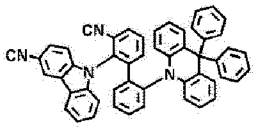
288

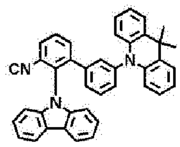
289

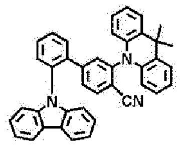
290

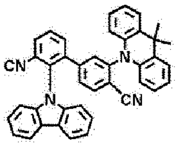
291

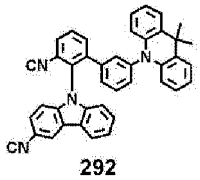
292

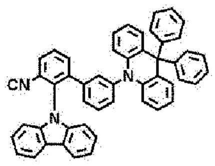
293

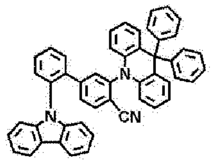
294

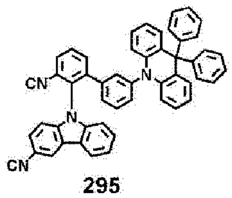
295

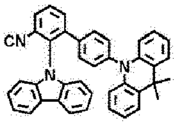
296

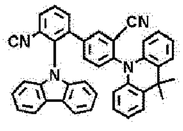
297

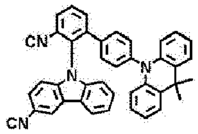
298

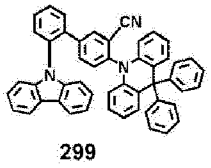
299

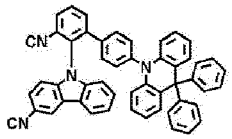
300

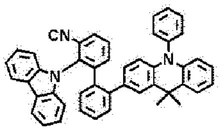
301

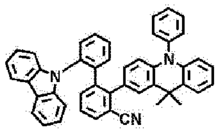
302

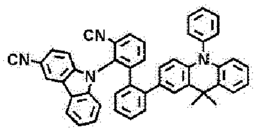
303

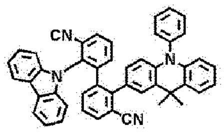
304

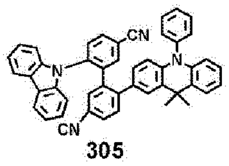
305

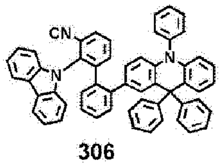
306

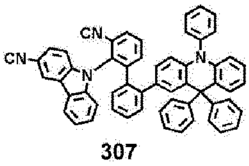
307

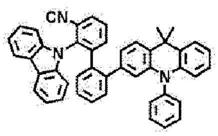
308

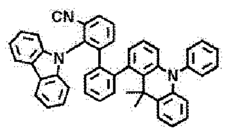
309

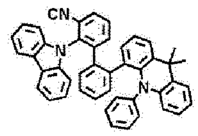
310

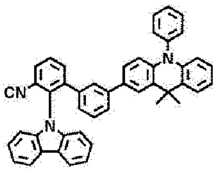
311

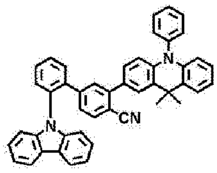
312

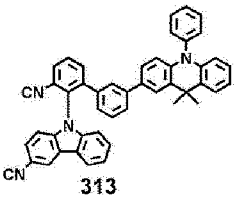
313

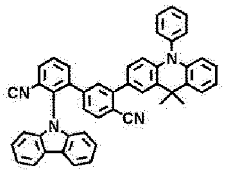
314

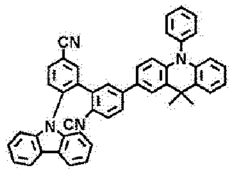
315

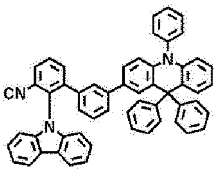
316

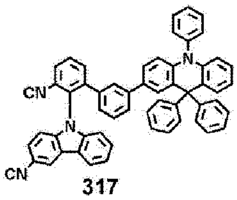
317

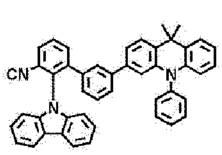
318

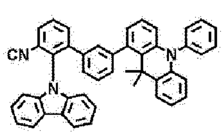
319

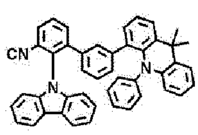
320

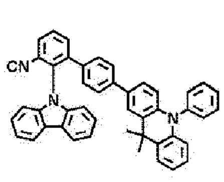
321

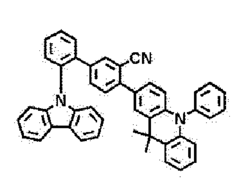
322

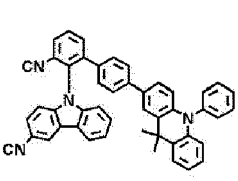
323

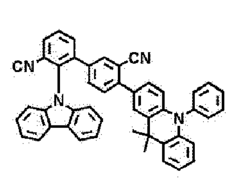
324

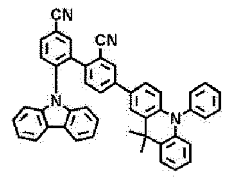
325

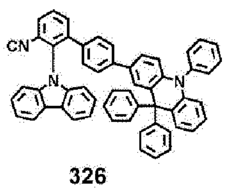
326

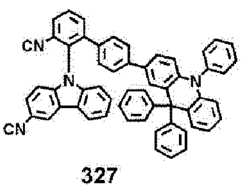
327

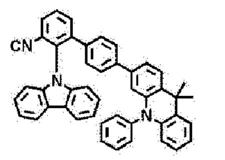
328

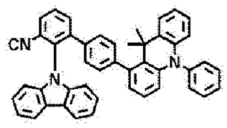
329

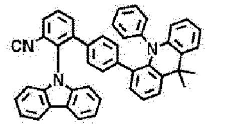
330

Group HE7

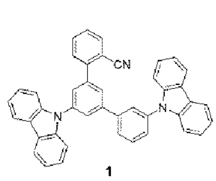
1

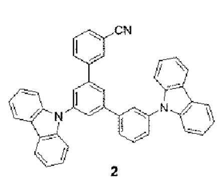
2

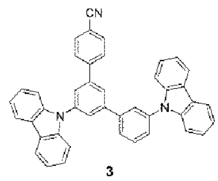
3

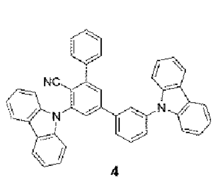
4

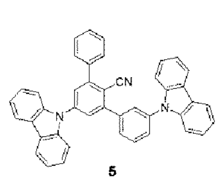
5

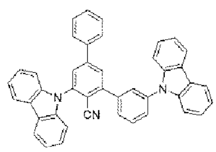
6

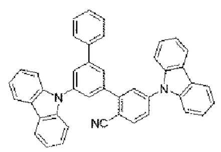
7

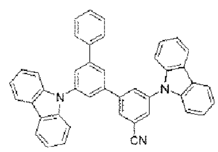
8

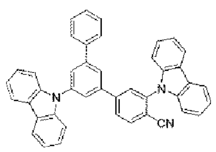
9

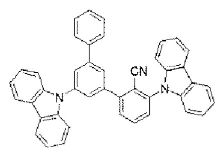
10

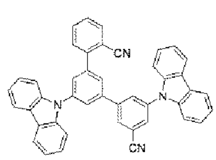
11

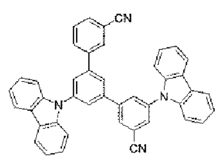
12

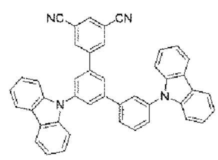
13

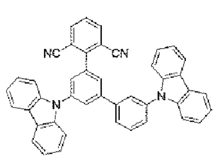
14

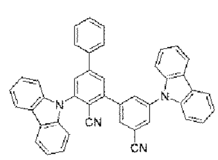
15

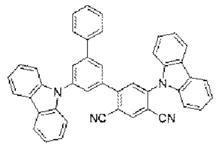
16

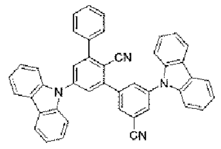
17

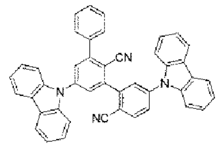
18

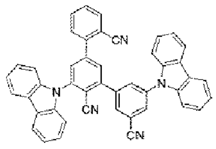
19

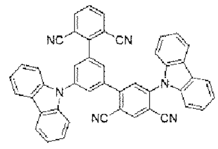
20

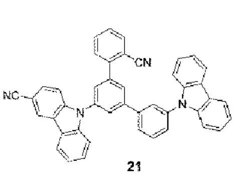
21
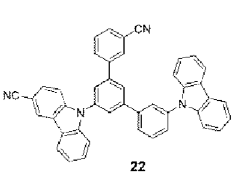
22
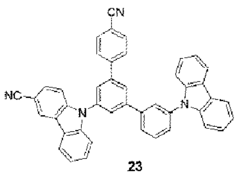
23
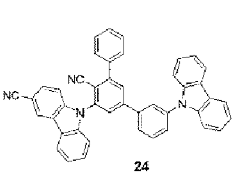
24
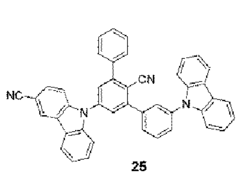
25

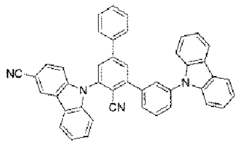
26
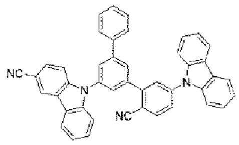
27
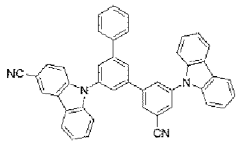
28
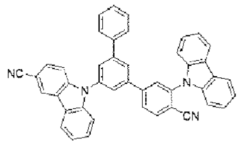
29
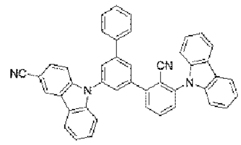
30

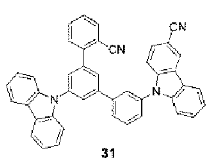
31
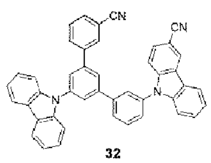
32
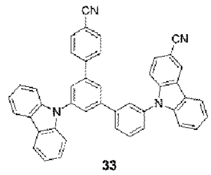
33
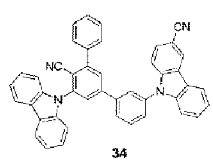
34
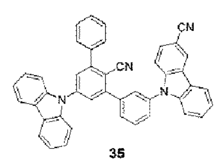
35

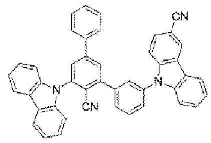
36
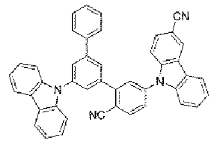
37
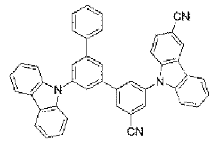
38
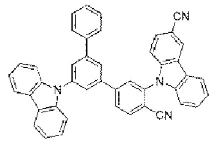
39
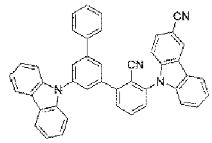
40

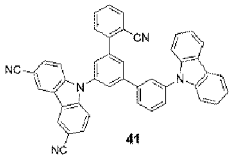
41
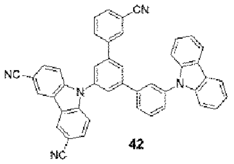
42
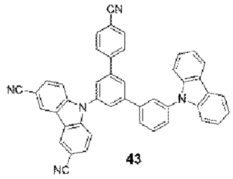
43
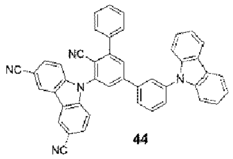
44
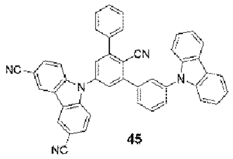
45

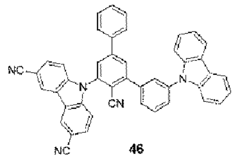
46
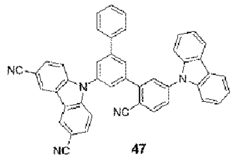
47
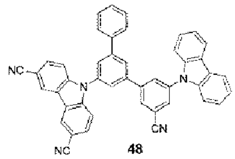
48
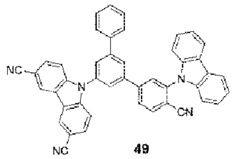
49
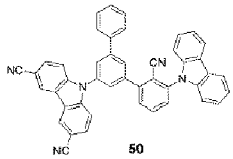
50

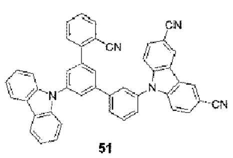
51
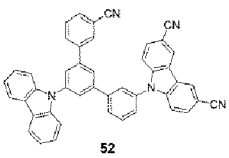
52
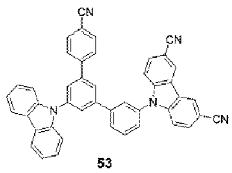
53
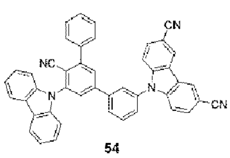
54
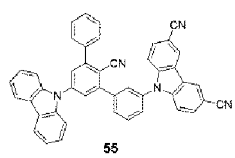
55

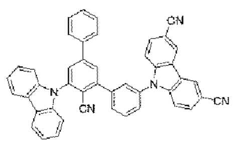
56
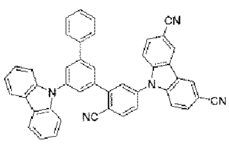
57
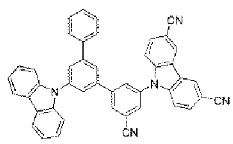
58
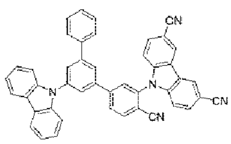
59
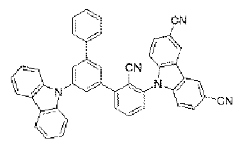
60

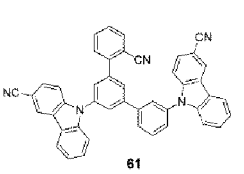
61
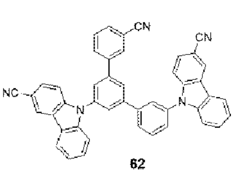
62
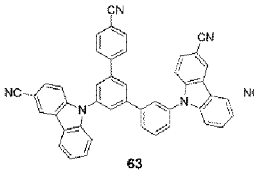
63
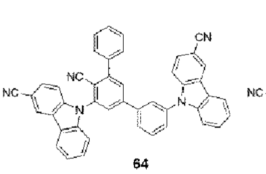
64
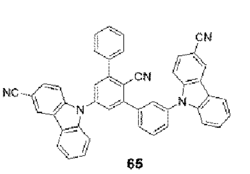
65

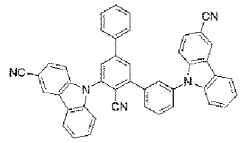
66
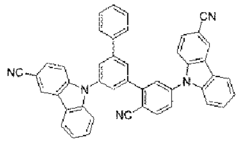
67
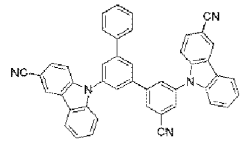
68
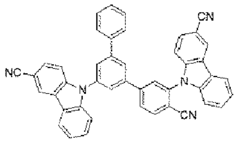
69
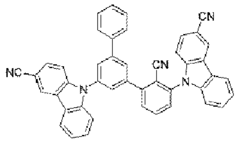
70

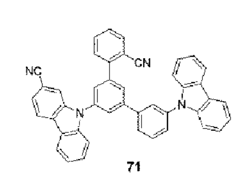
71
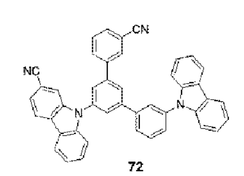
72
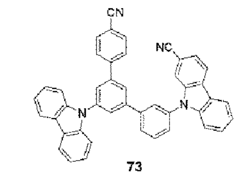
73
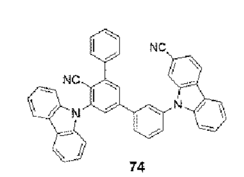
74
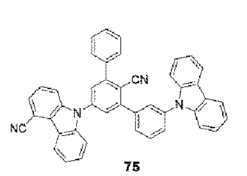
75

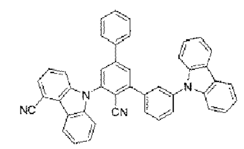
76
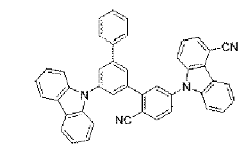
77
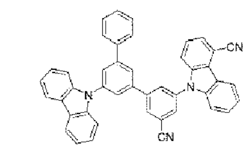
78
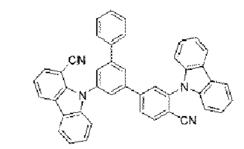
79
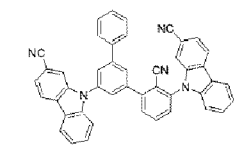
80

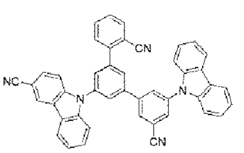
81
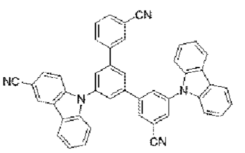
82
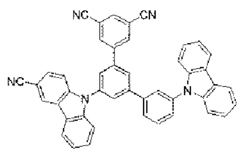
83
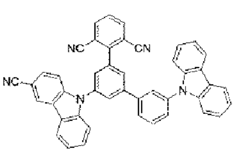
84
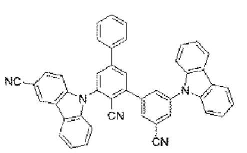
85

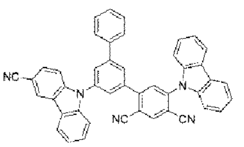
86
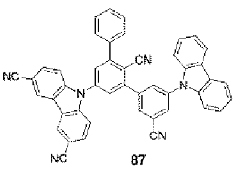
87
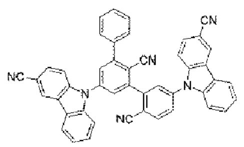
88
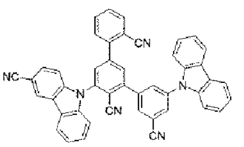
89
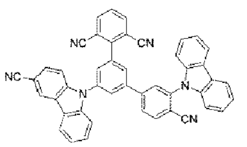
90

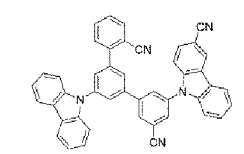
91
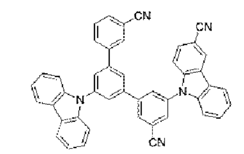
92
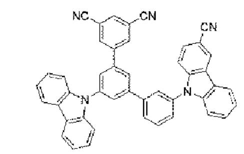
93
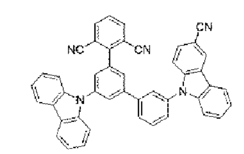
94
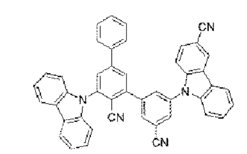
95

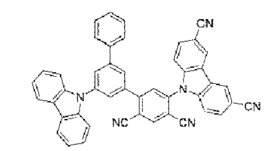
96
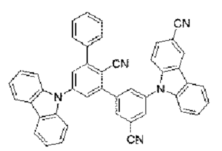
97
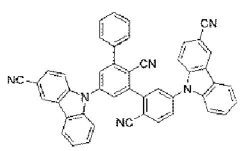
98
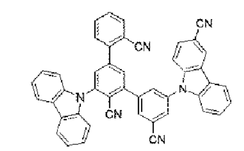
99
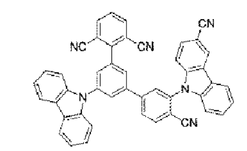
100

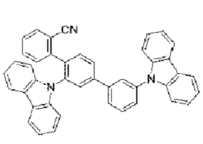
101

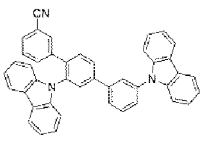
102

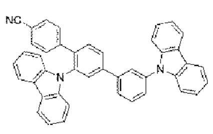
103

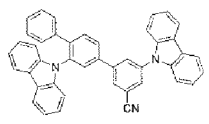
104

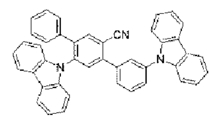
105

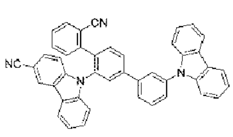
106

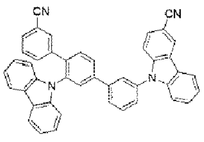
107

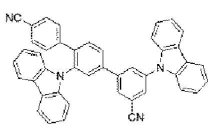
108

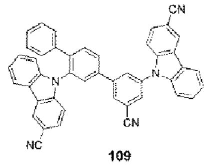
109

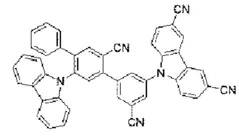
110

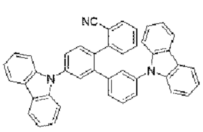
111

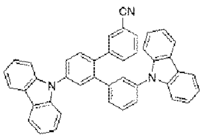
112

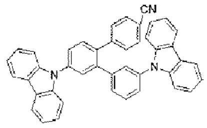
113

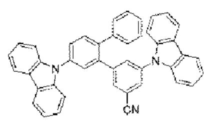
114

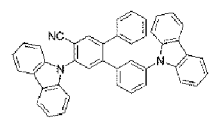
115

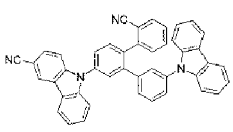
116

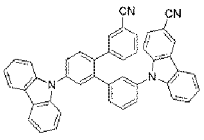
117

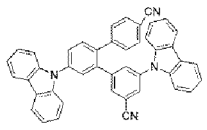
118

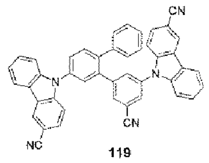
119

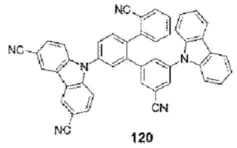
120

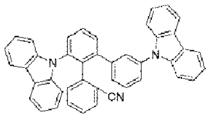
121

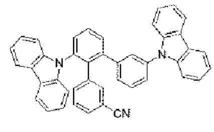
122

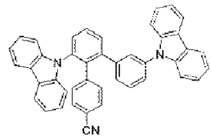
123

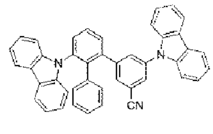
124

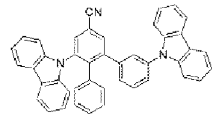
125

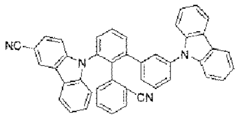
126

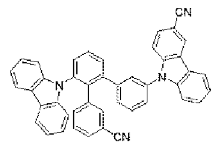
127

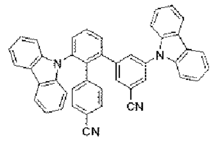
128

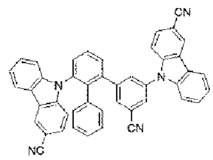
129

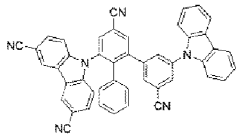
130

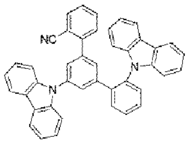
131

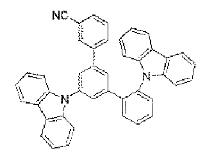
132

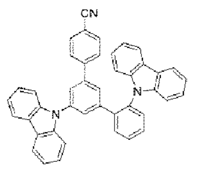
133

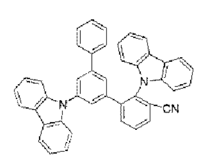
134

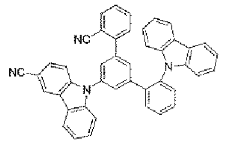
135

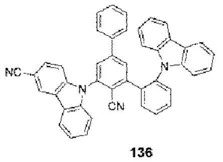
136

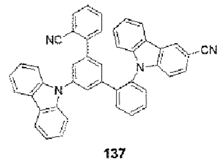
137

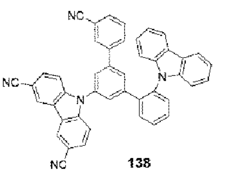
138

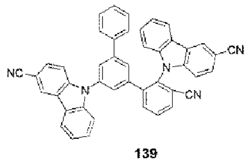
139

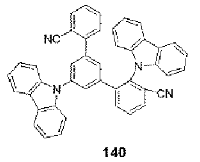
140

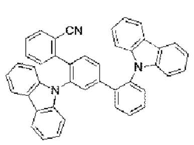
141

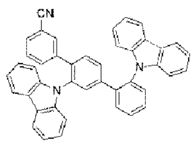
142

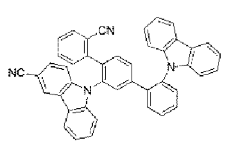
143

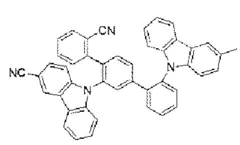
144

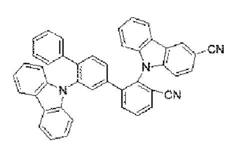
145

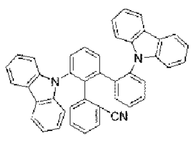
146

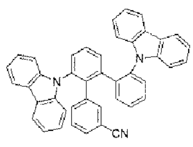
147

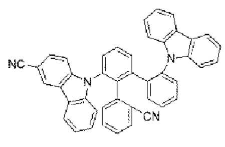
148

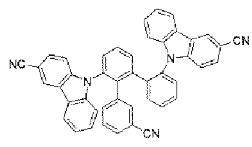
149

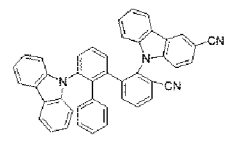
150

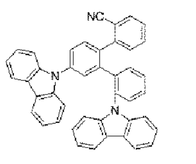
151

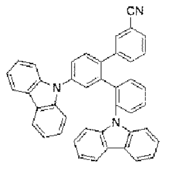
152

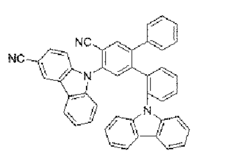
153

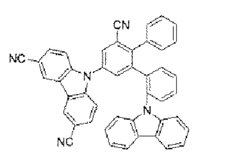
154

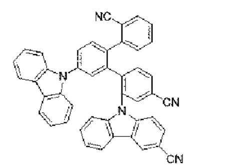
155

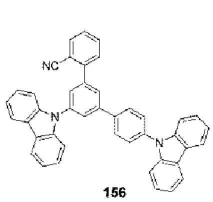
156

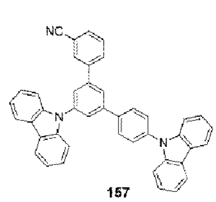
157

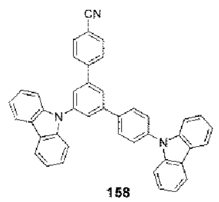
158

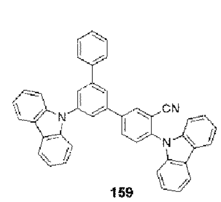
159

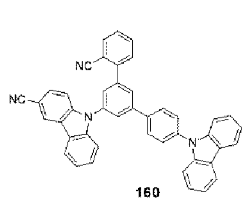
160

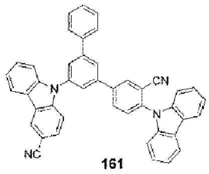
161

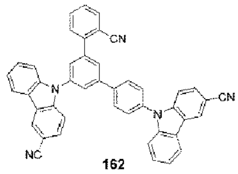
162

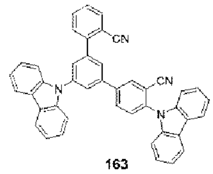
163

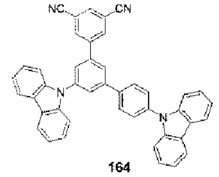
164

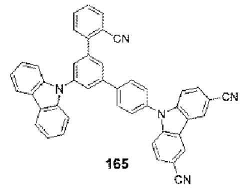
165

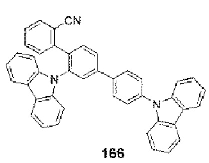
166

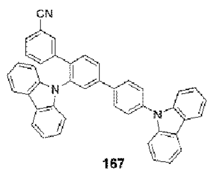
167

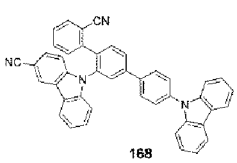
168

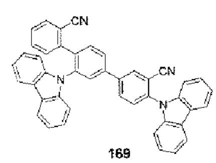
169

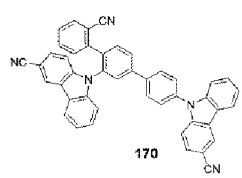
170

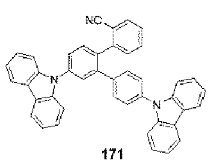
171

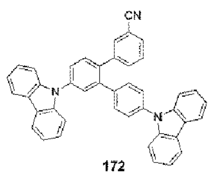
172

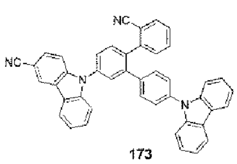
173

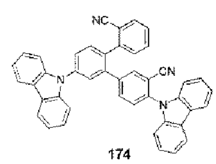
174

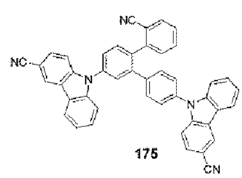
175

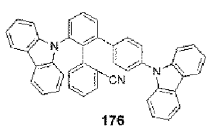
176

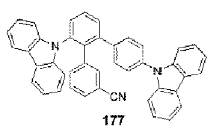
177

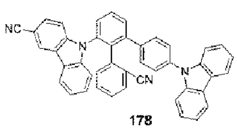
178

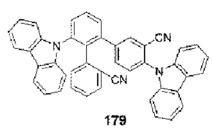
179

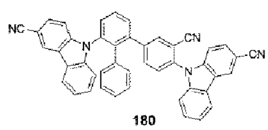
180

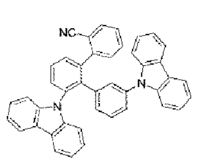
181

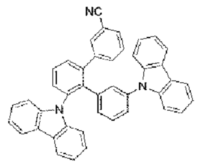
182

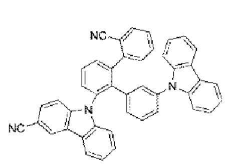
183

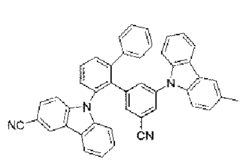
184

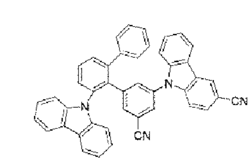
185

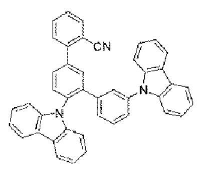
186

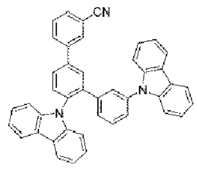
187

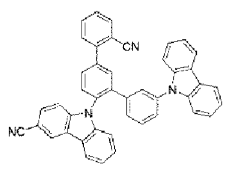
188

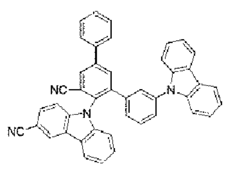
189

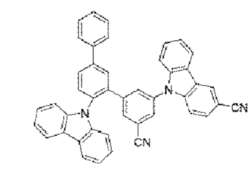
190

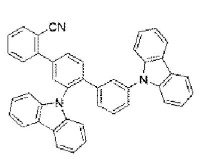
191

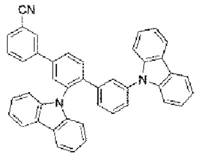
192

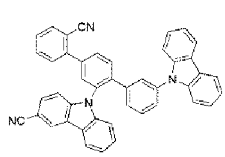
193

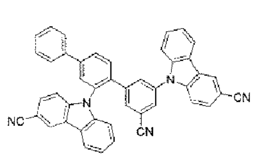
194

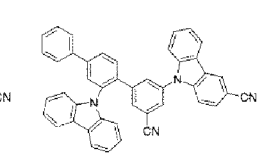
195

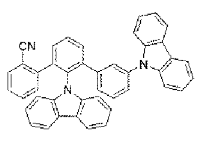
196

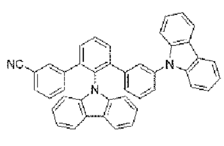
197

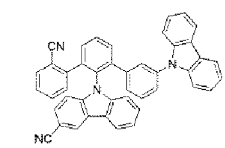
198

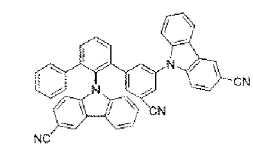
199

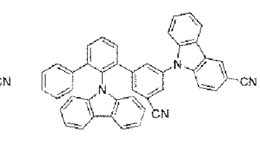
200

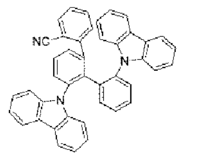
201

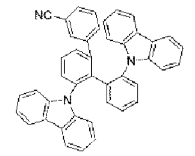
202

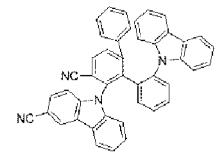
203

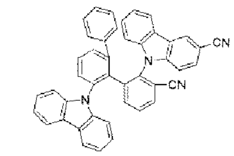
204

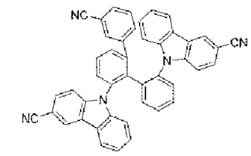
205

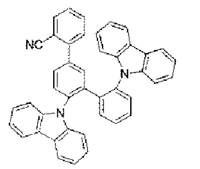
206

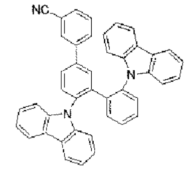
207

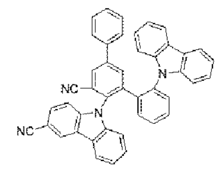
208

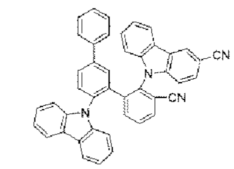
209

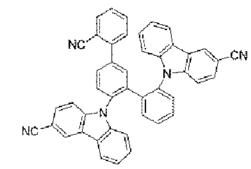
210

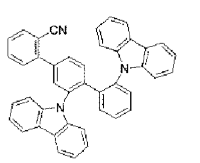
211

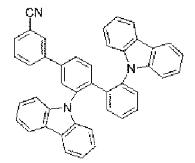
212

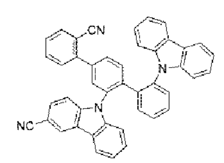
213

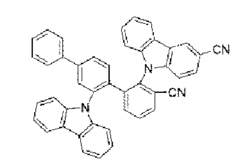
214

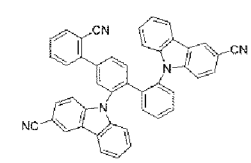
215

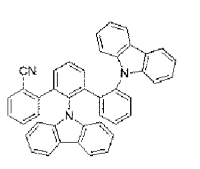
216

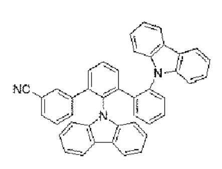
217

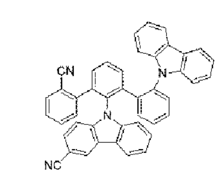
218

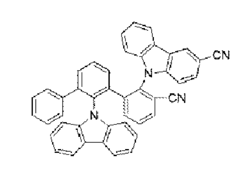
219

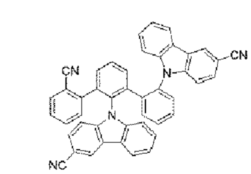
220

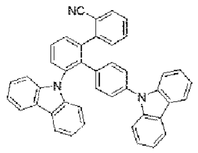
221
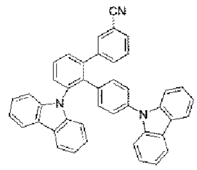
222
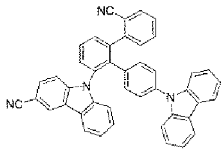
223
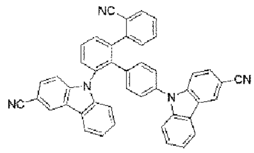
224
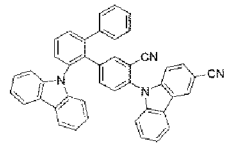
225

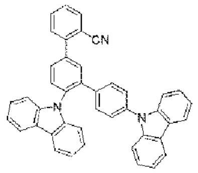
226
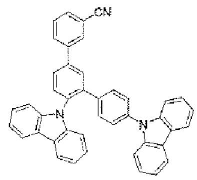
227
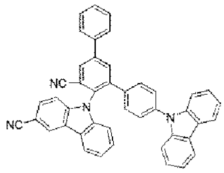
228
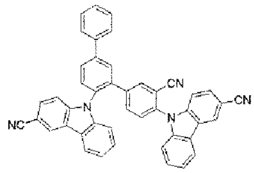
229
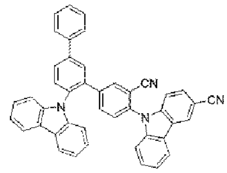
230

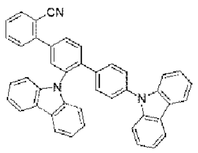
231
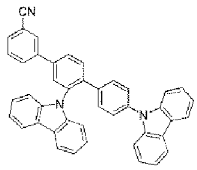
232
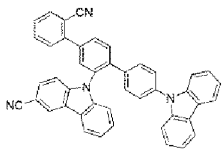
233
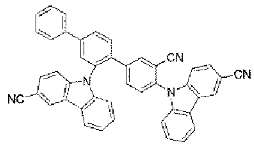
234
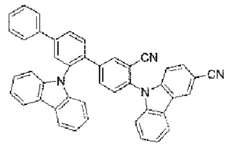
235

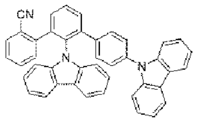
236
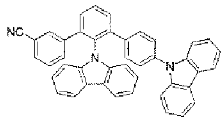
237
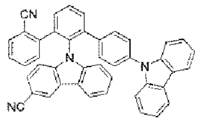
238
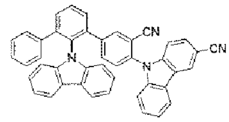
239
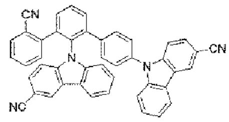
240

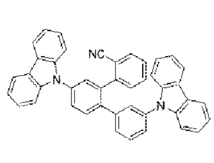
241

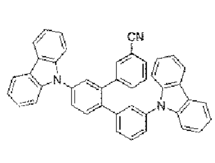
242

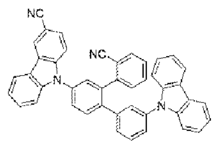
243

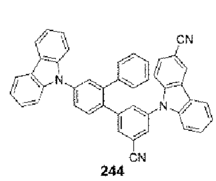
244

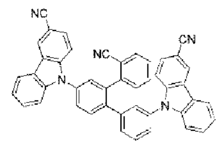
245

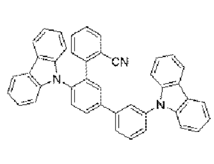
246

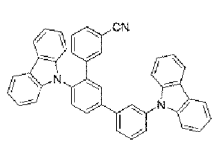
247

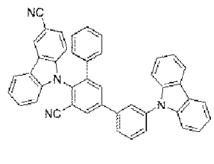
248

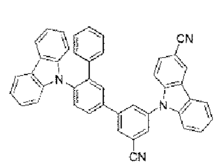
249

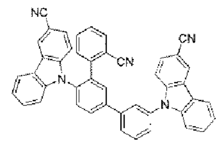
250

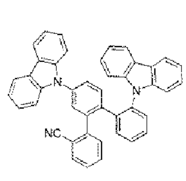
251

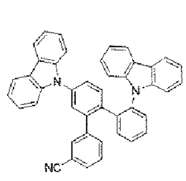
252

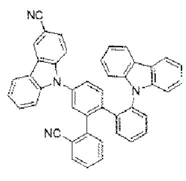
253

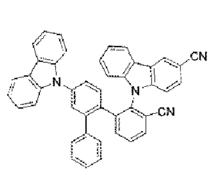
254

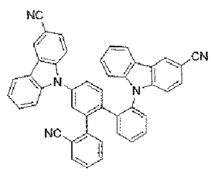
255

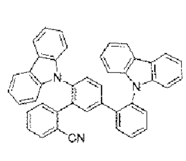
256

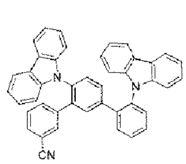
257

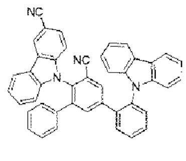
258

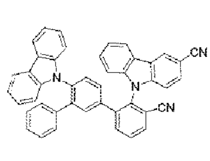
259

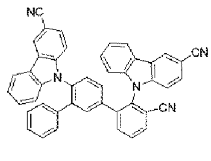
260

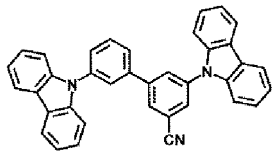
261

In one or more embodiments, the hole transport host may be one of Compounds H-H1 to H-H104, but embodiments of the present disclosure are not limited thereto:

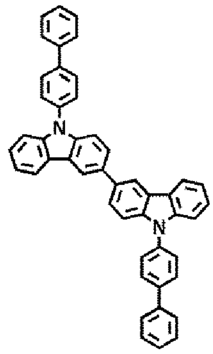
H-H1

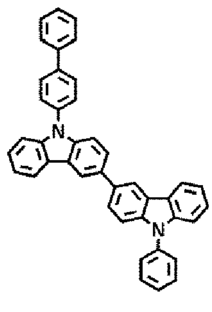
H-H2

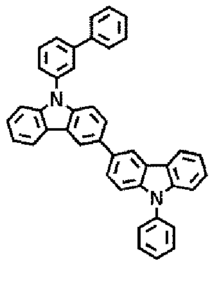
H-H3

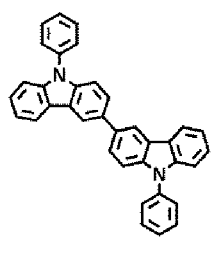
H-H4

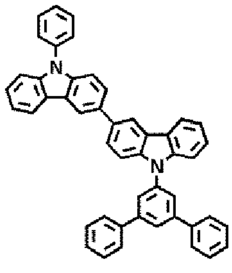

**H-H5**

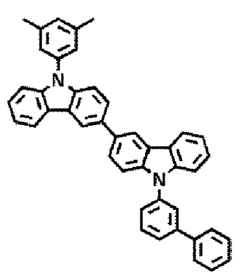

**H-H6**

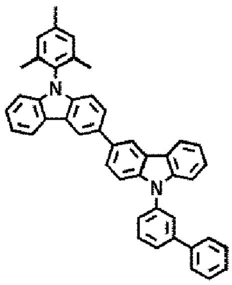

**H-H7**

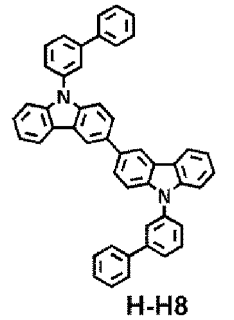

**H-H8**

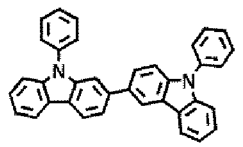

**H-H9**

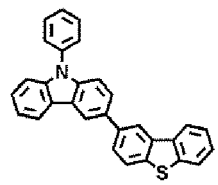

**H-H10**

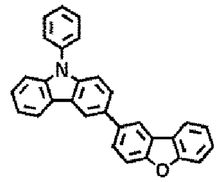

**H-H11**

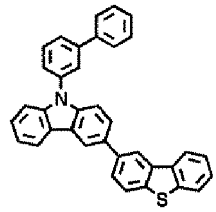

**H-H12**

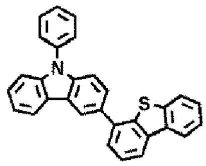

**H-H13**

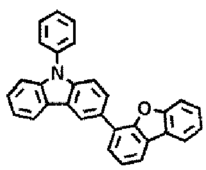

**H-H14**

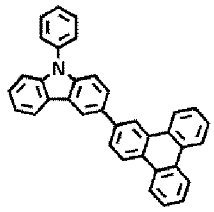

**H-H15**

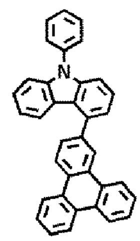

**H-H16**

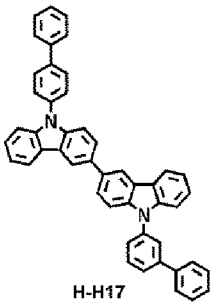

H-H17

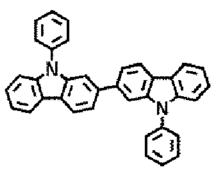

H-H18

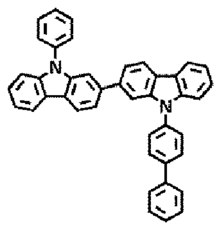

H-H19

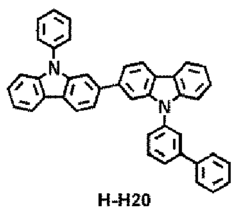

H-H20

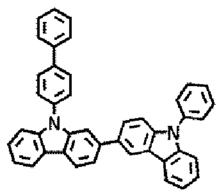

H-H21

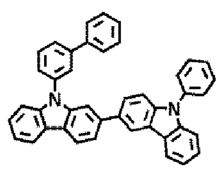

H-H22

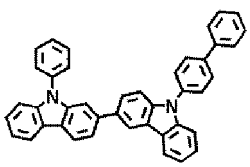

H-H23

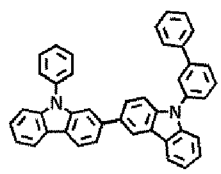

H-H24

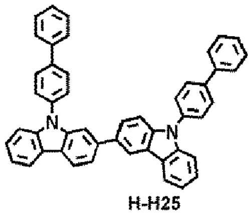
H-H25

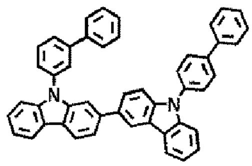
H-H26

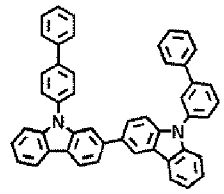
H-H27

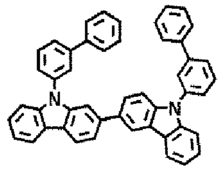
H-H28

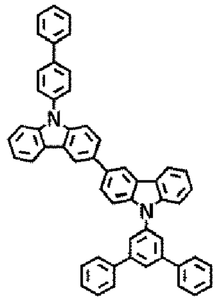
H-H29

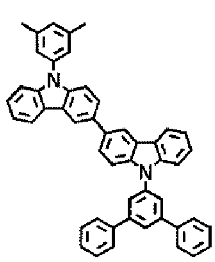
H-H30

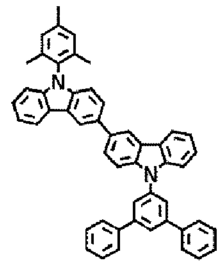
H-H31

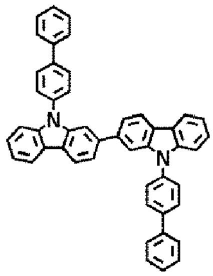
H-H32

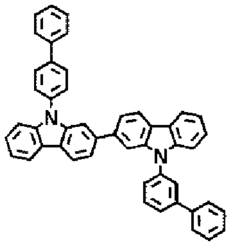
H-H33

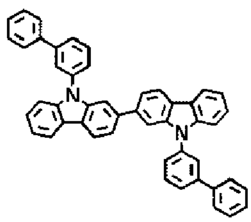
H-H34

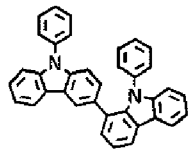
H-H35

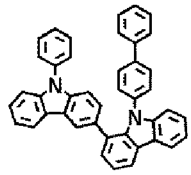
H-H36

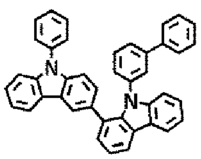
H-H37

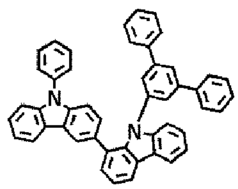
H-H38

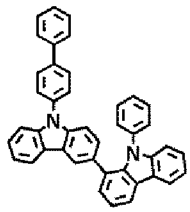
H-H39

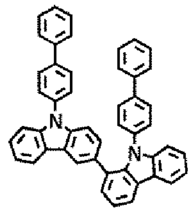
H-H40

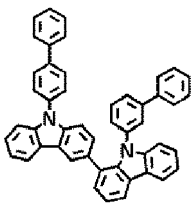
H-H41

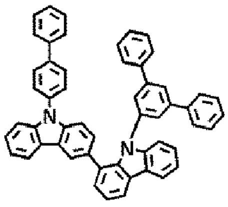
H-H42

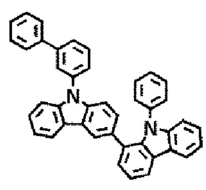
H-H43

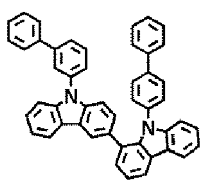
H-H44

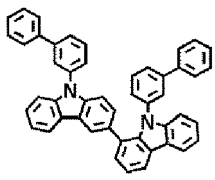
H-H45

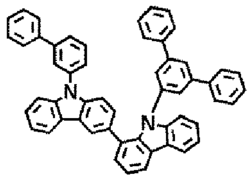
H-H46

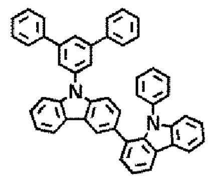
H-H47

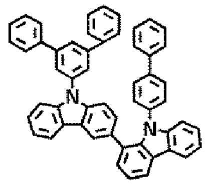
H-H48

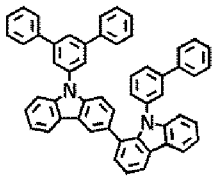
H-H49

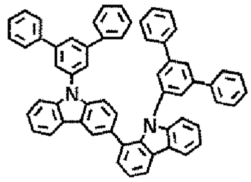
H-H50

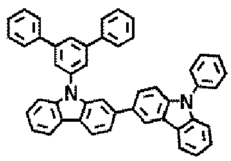
H-H51

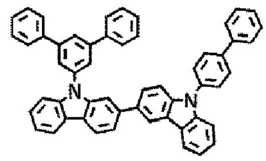
H-H52

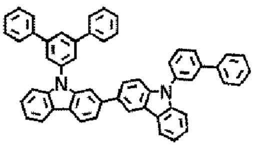
H-H53

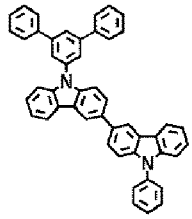
H-H54

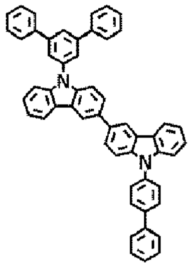
H-H55

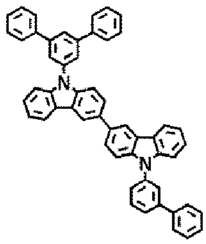
H-H56

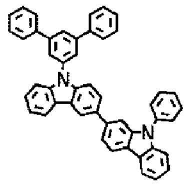
H-H57

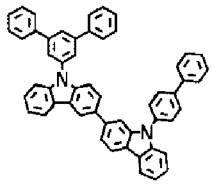
H-H58

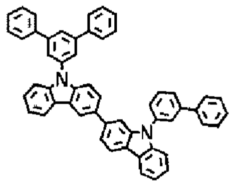
H-H59

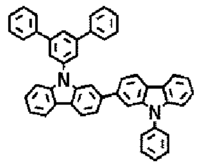
H-H60

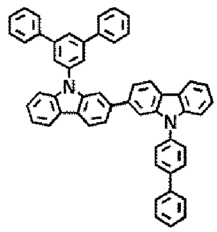
H-H61

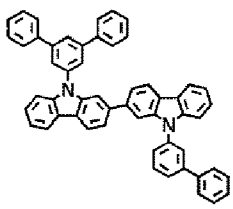
H-H62

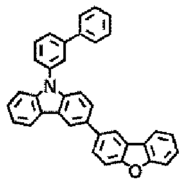
H-H63

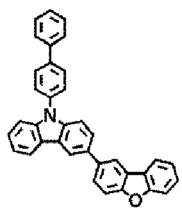
H-H64

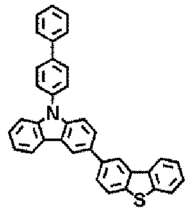
H-H65

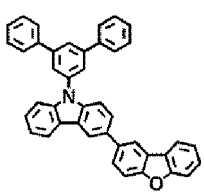
H-H66

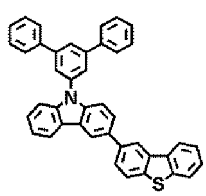
H-H67

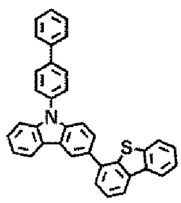
H-H68

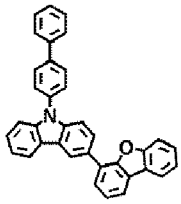
H-H69

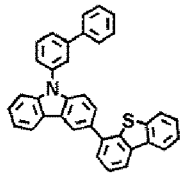
H-H70

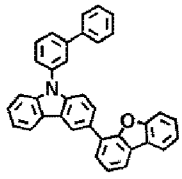
H-H71

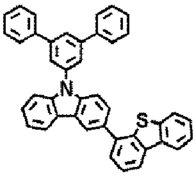
H-H72

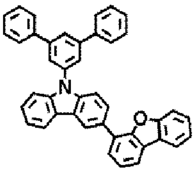
H-H73

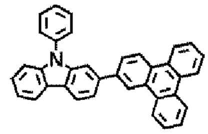
H-H74

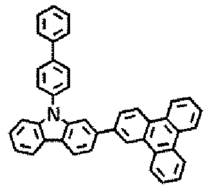
H-H75

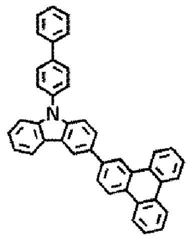
H-H76

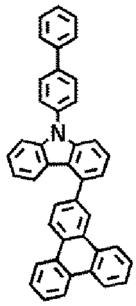
H-H77

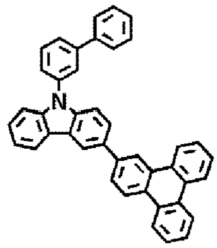
H-H78

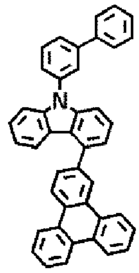
H-H79

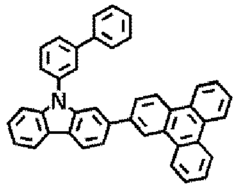
H-H80

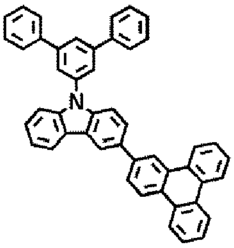
H-H81

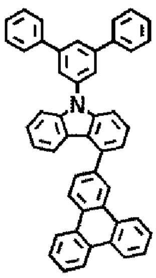
H-H82

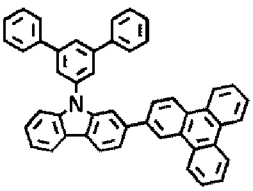
H-H83

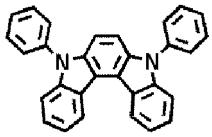
H-H84

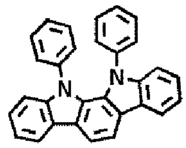
H-H85

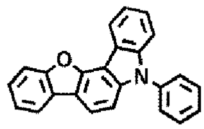
H-H86

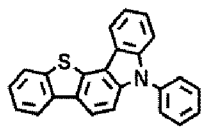
H-H87

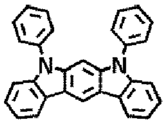

H-H88

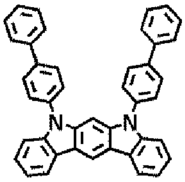

H-H89

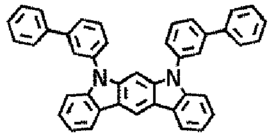

H-H90

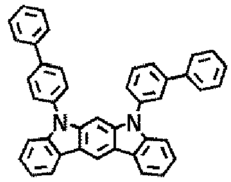

H-H91

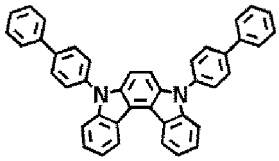

H-H92

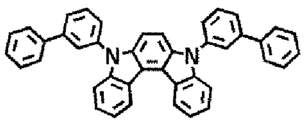

H-H93

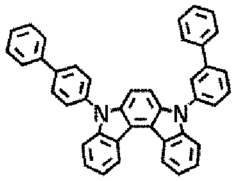

H-H94

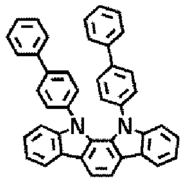

H-H95

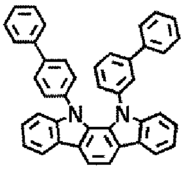

H-H96

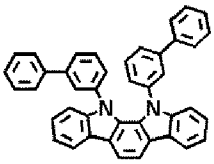

H-H97

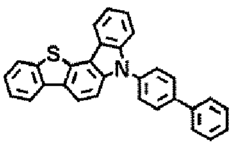

H-H98

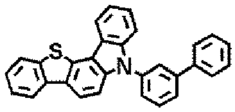

H-H99

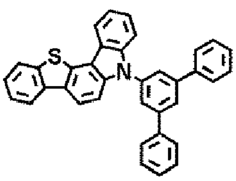

H-H100

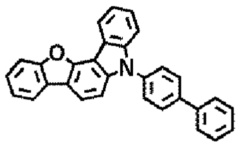

H-H101

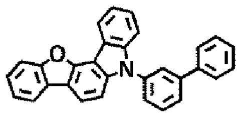

H-H102

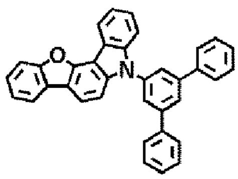

H-H103

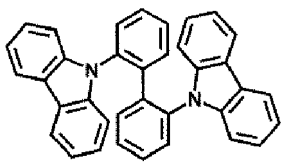

H-H104

In one or more embodiments, the bipolar host may be from Group HEH1, but embodiments of the present disclosure are not limited thereto:

## Group HEH1

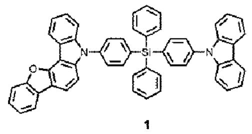
1
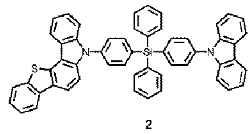
2
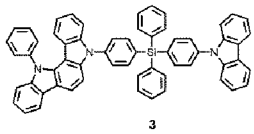
3
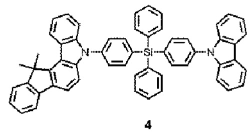
4
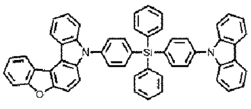
5
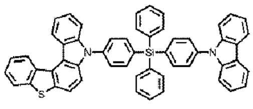
6
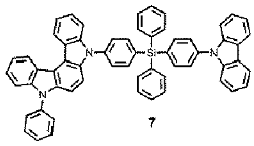
7
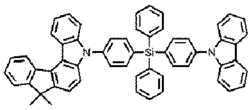
8
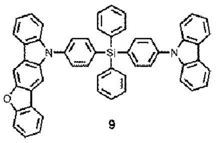
9
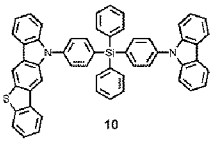
10
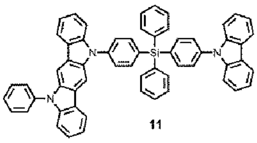
11
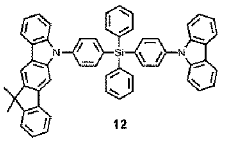
12
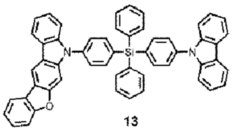
13
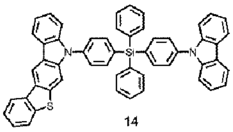
14
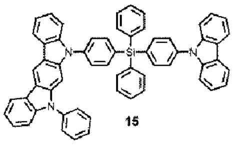
15
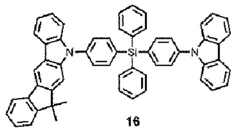
16
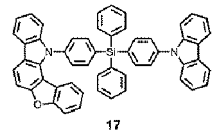
17
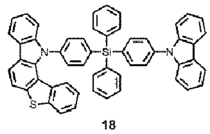
18
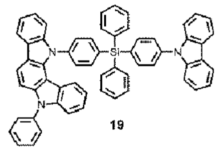
19
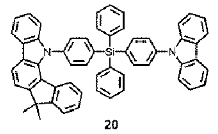
20
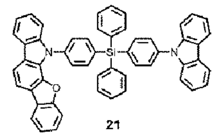
21
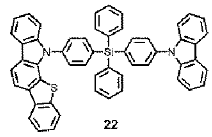
22
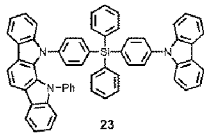
23
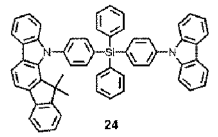
24
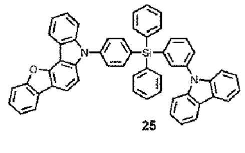
25
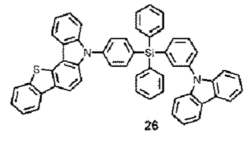
26
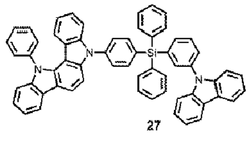
27
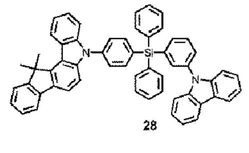
28
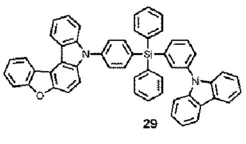
29
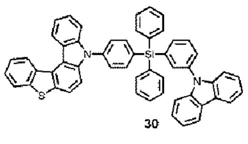
30
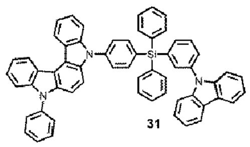
31
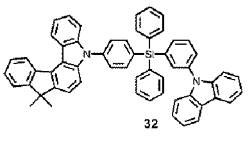
32

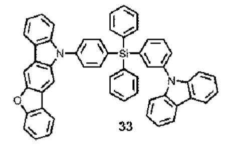
33
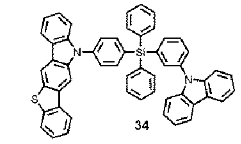
34
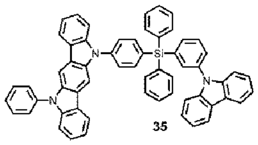
35
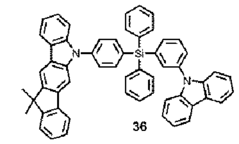
36

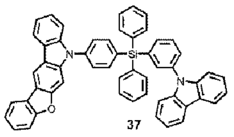
37
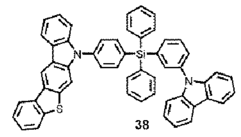
38
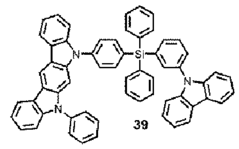
39
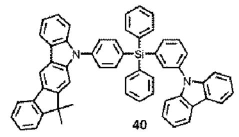
40

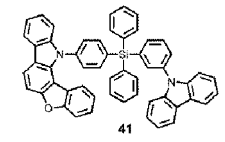
41
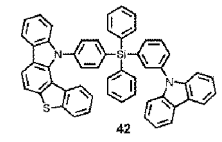
42
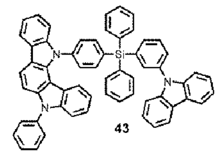
43
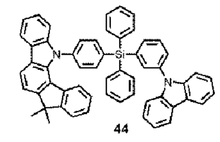
44

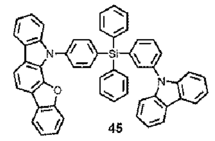
45
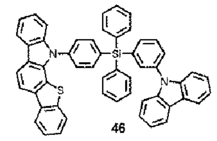
46
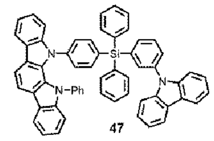
47
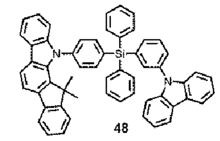
48

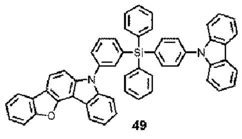
49
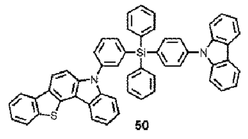
50
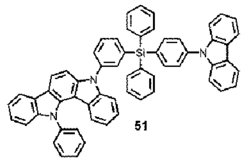
51
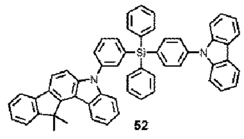
52

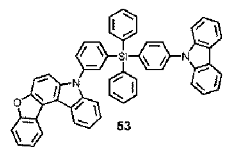
53
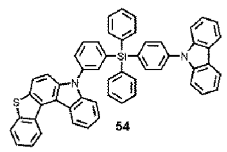
54
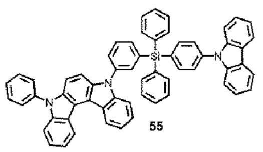
55
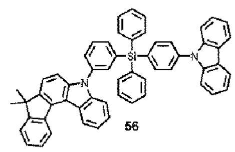
56

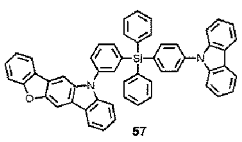
57
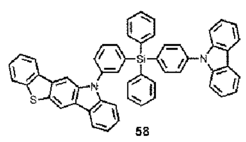
58
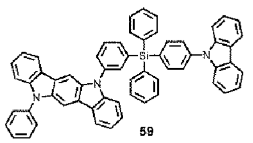
59
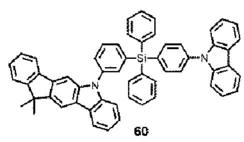
60

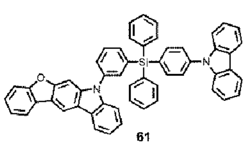
61
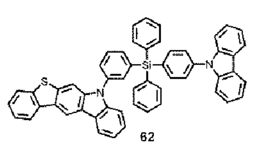
62
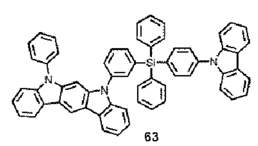
63
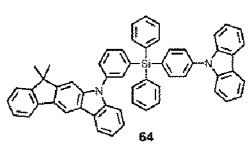
64

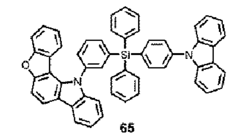
65
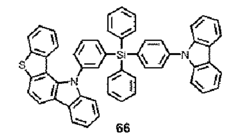
66
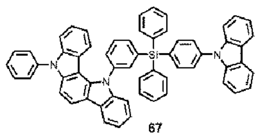
67
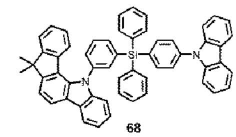
68

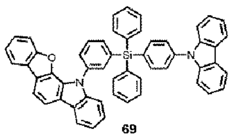
69
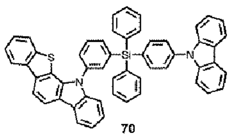
70
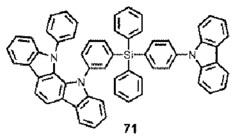
71
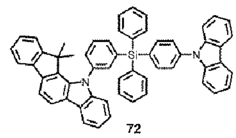
72

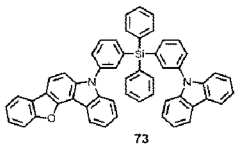
73
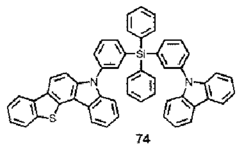
74
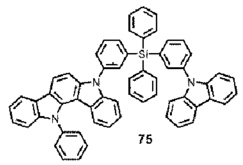
75
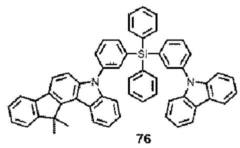
76

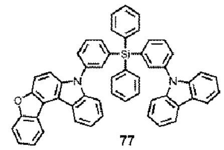
77
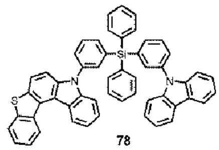
78
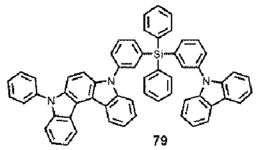
79
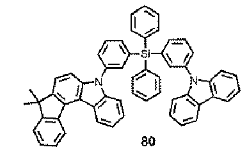
80

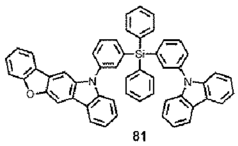
81
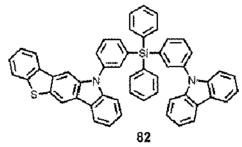
82
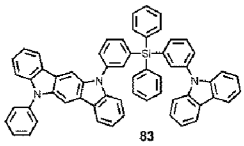
83
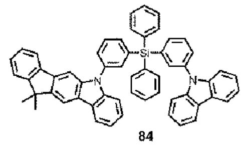
84

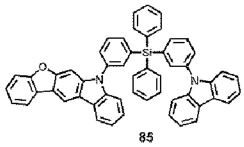
85
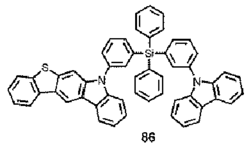
86
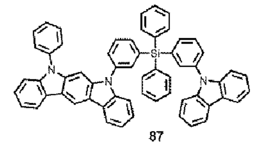
87
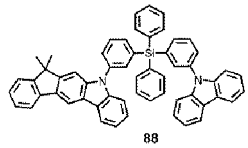
88

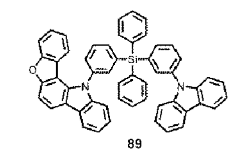
89
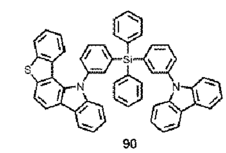
90
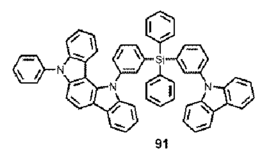
91
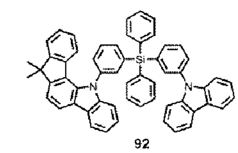
92

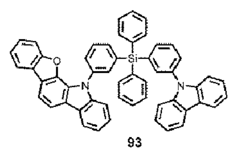
93
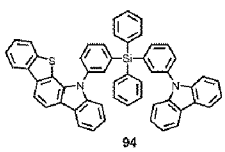
94
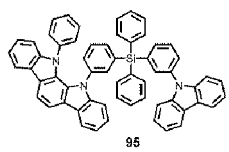
95
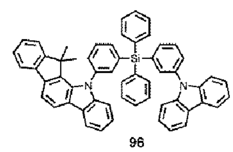
96

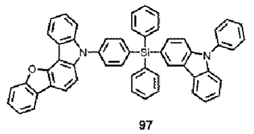
97
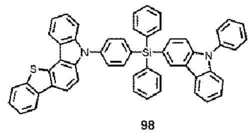
98
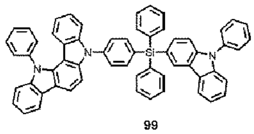
99
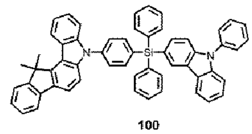
100

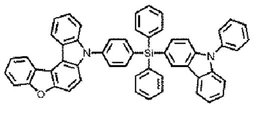
101
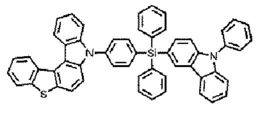
102
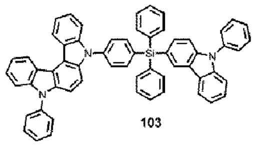
103
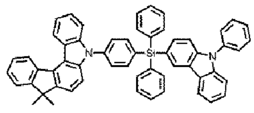
104

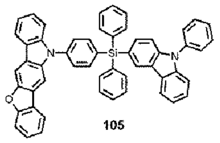
105
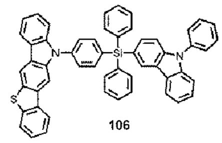
106
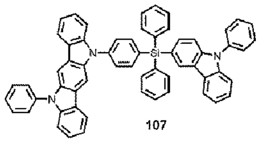
107
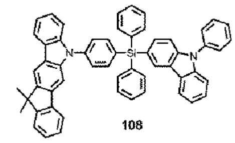
108

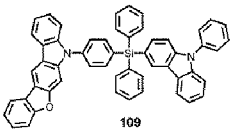
109
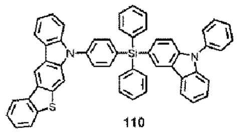
110
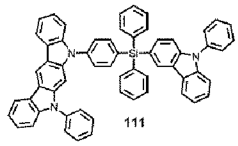
111
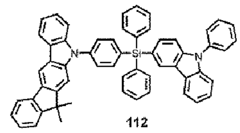
112

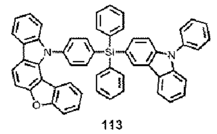
113
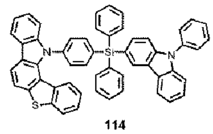
114
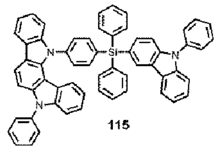
115
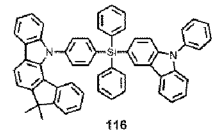
116

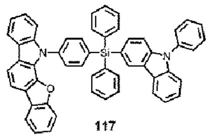
117
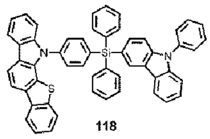
118
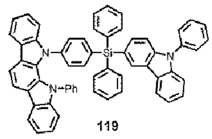
119
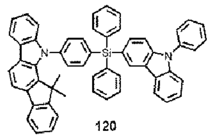
120

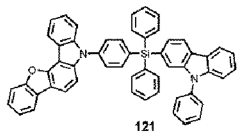
121
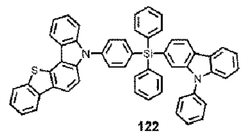
122
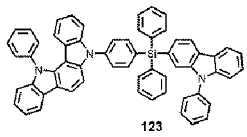
123
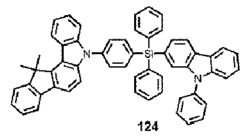
124

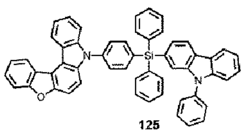
125
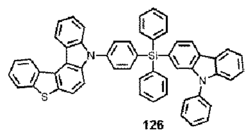
126
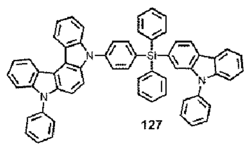
127
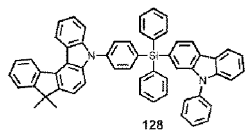
128

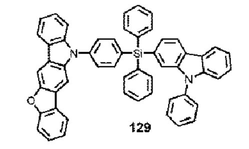
129
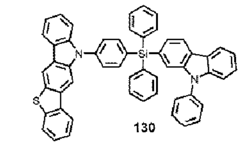
130
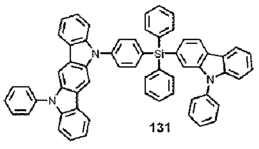
131
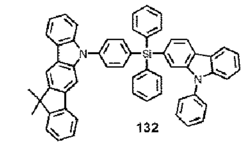
132
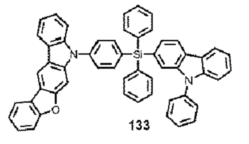
133
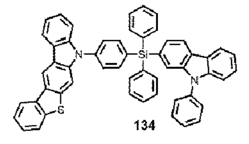
134
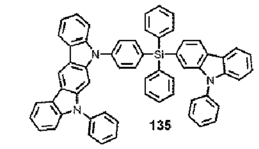
135
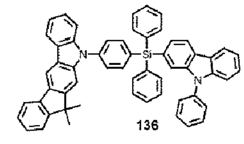
136
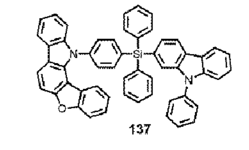
137
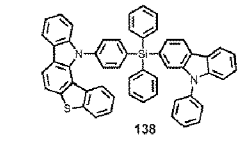
138
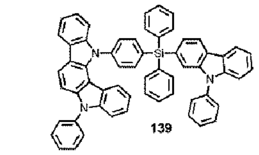
139
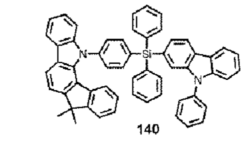
140
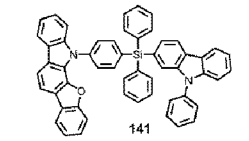
141
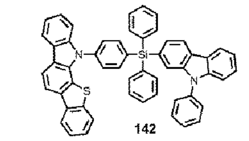
142
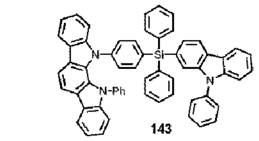
143
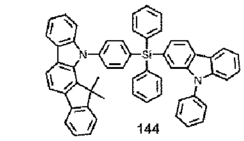
144
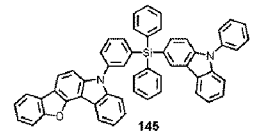
145
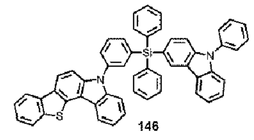
146
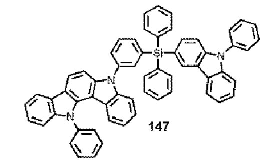
147
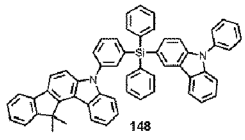
148
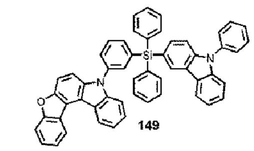
149
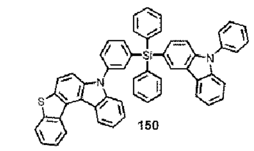
150
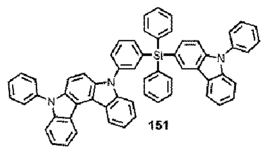
151
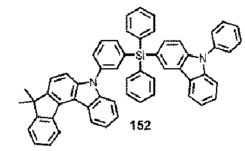
152
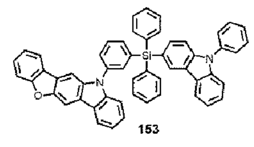
153
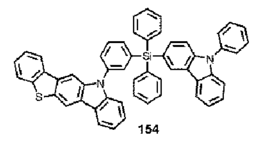
154
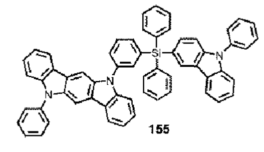
155
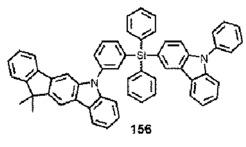
156
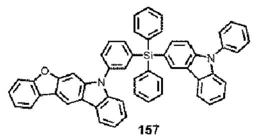
157
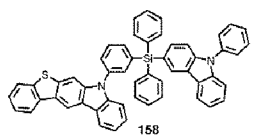
158
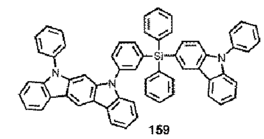
159
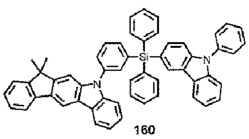
160

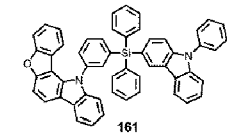
161
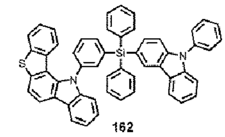
162
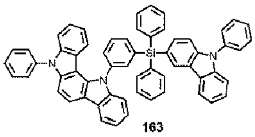
163
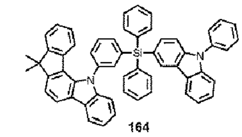
164
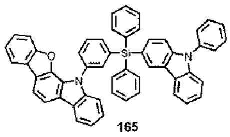
165
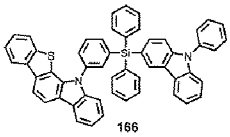
166
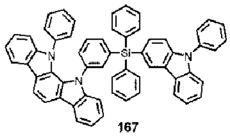
167
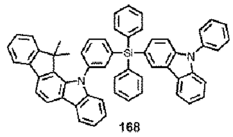
168
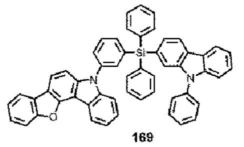
169
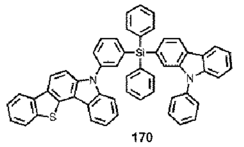
170
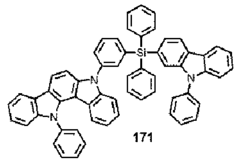
171
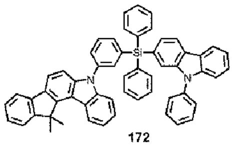
172
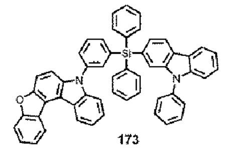
173
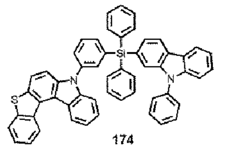
174
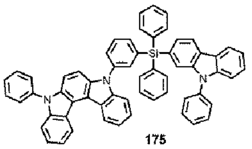
175
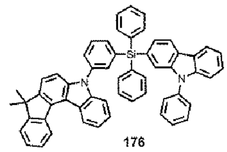
176
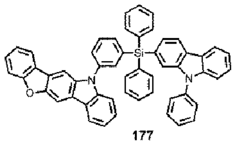
177
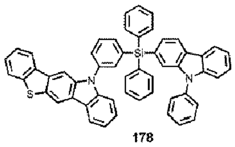
178
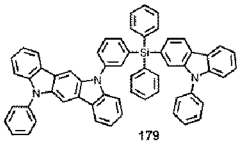
179
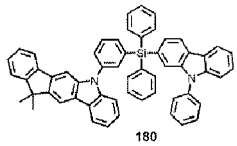
180
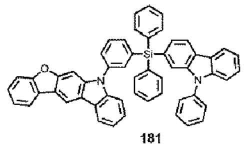
181
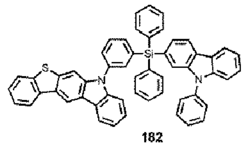
182
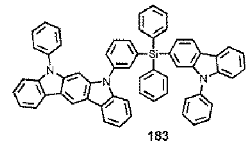
183
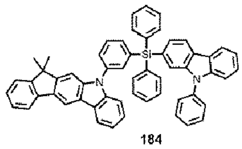
184
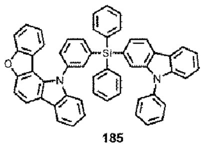
185
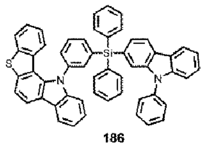
186
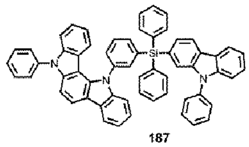
187
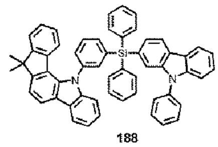
188
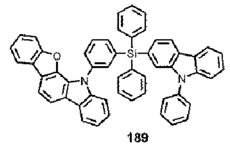
189
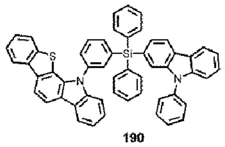
190
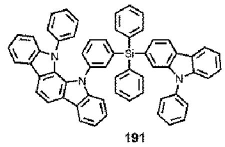
191
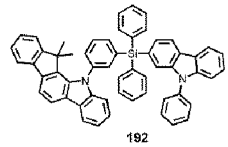
192

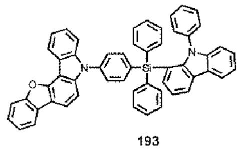

193

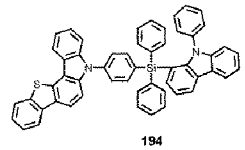

194

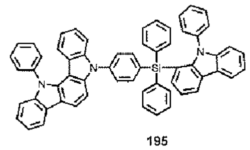

195

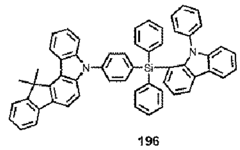

196

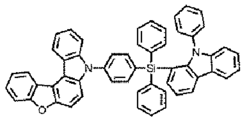

197

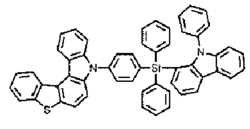

198

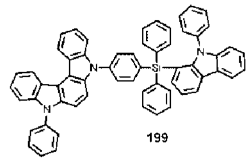

199

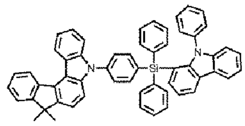

200

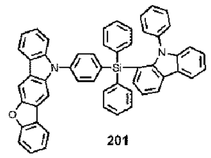

201

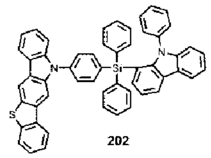

202

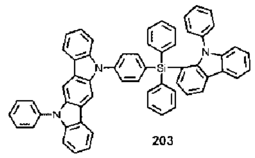

203

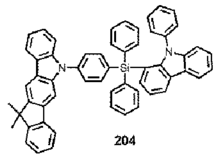

204

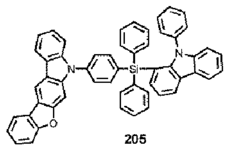

205

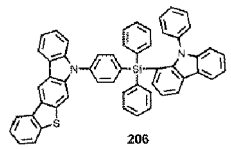

206

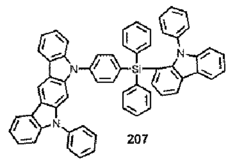

207

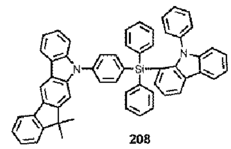

208

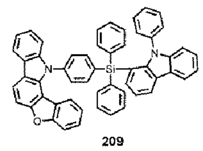

209

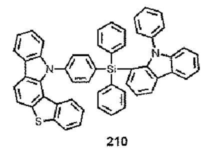

210

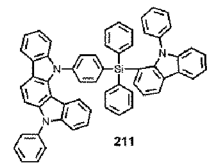

211

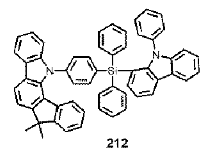

212

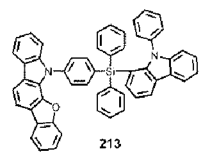

213

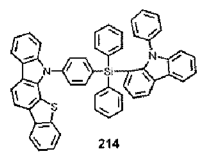

214

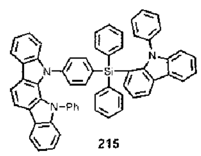

215

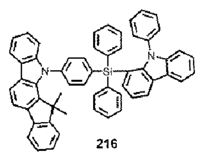

216

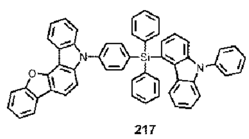

217

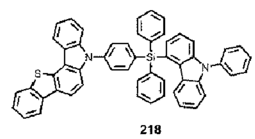

218

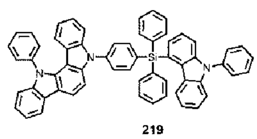

219

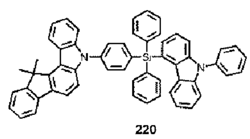

220

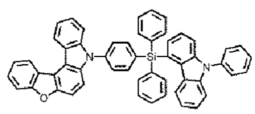

221

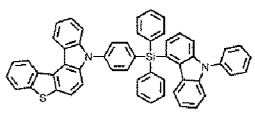

222

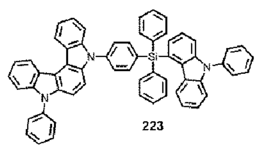

223

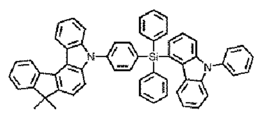

224

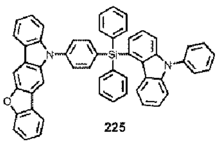
225

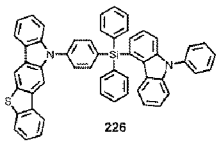
226

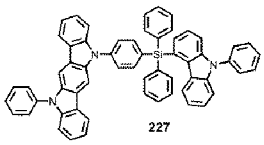
227

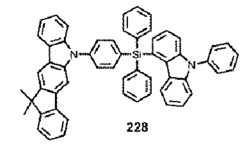
228

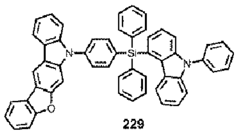
229

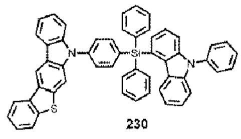
230

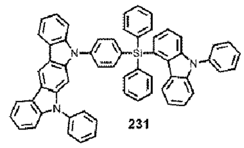
231

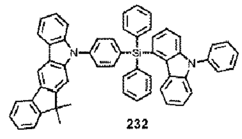
232

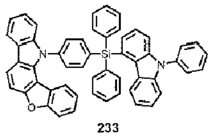
233

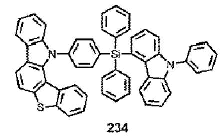
234

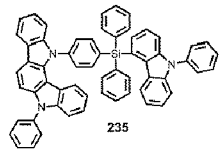
235

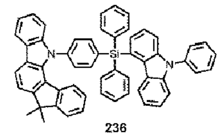
236

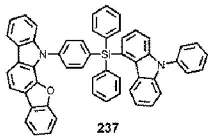
237

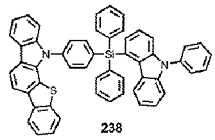
238

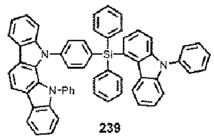
239

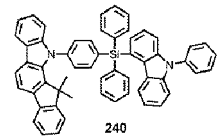
240

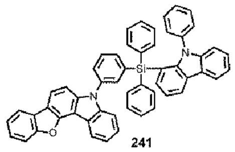
241

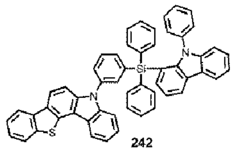
242

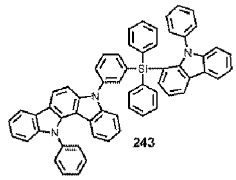
243

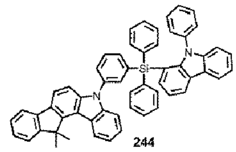
244

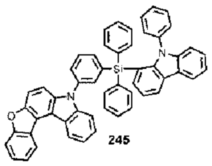
245

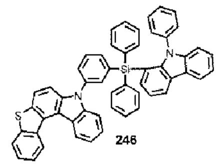
246

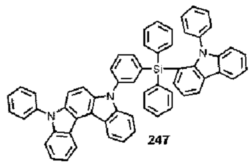
247

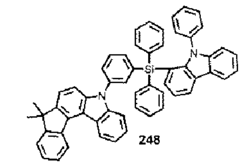
248

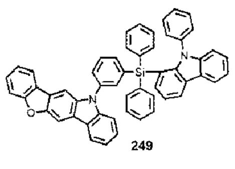
249

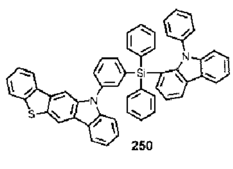
250

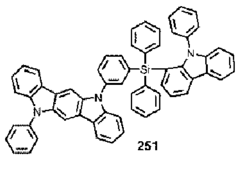
251

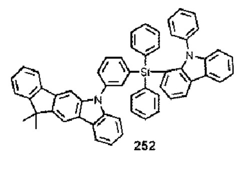
252

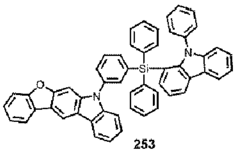
253

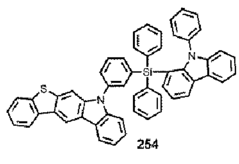
254

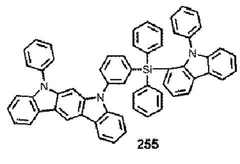
255

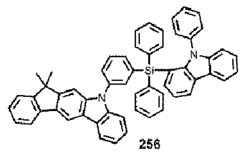
256

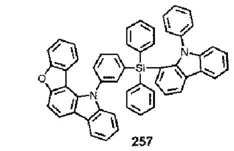
257
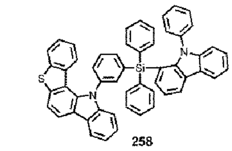
258
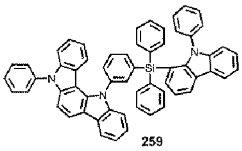
259
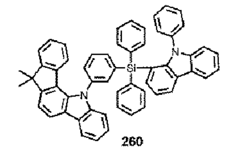
260

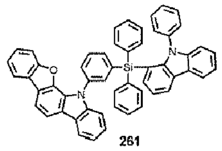
261
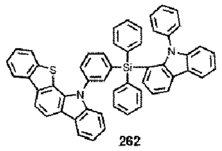
262
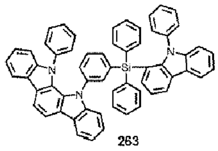
263
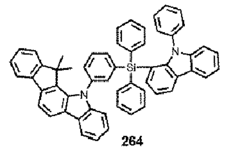
264

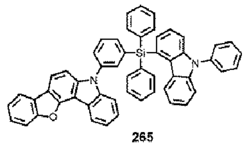
265
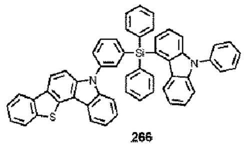
266
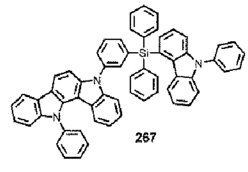
267
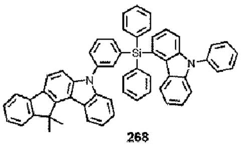
268

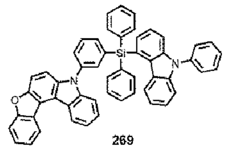
269
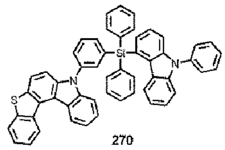
270
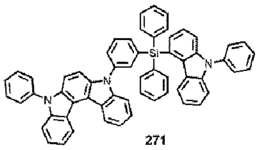
271
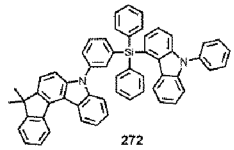
272

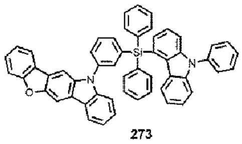
273
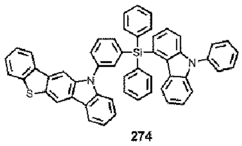
274
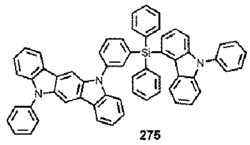
275
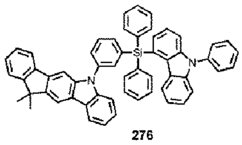
276

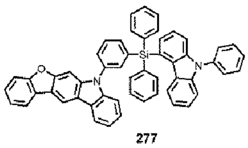
277
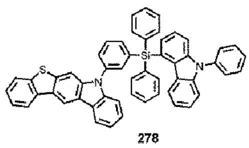
278
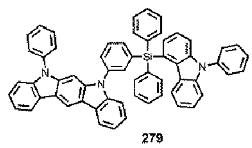
279
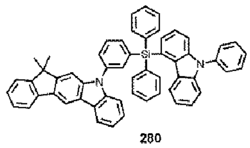
280

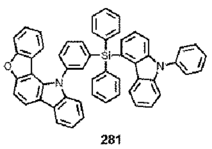
281
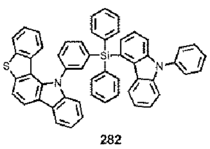
282
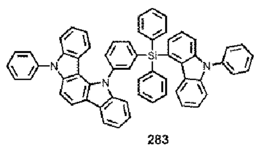
283
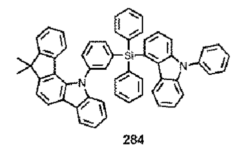
284

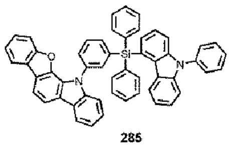
285
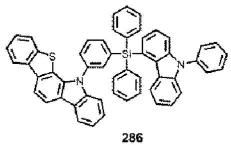
286
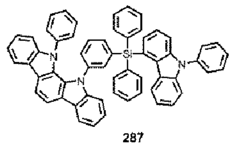
287
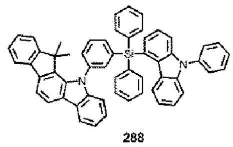
288

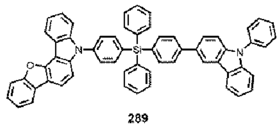
289

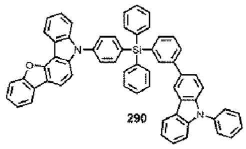
290

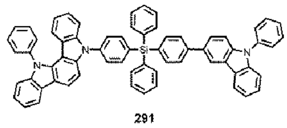
291

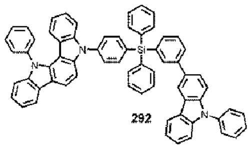
292

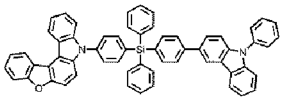
293

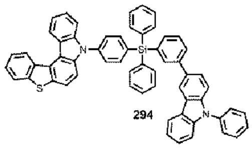
294

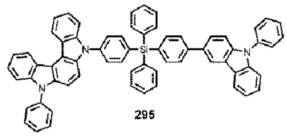
295

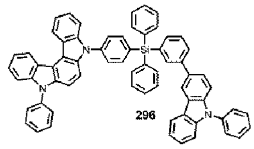
296

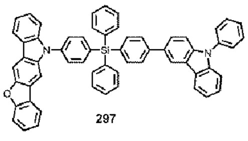
297

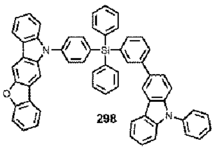
298

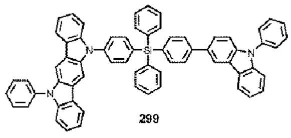
299

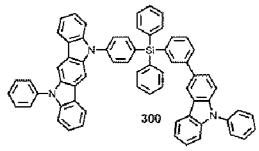
300

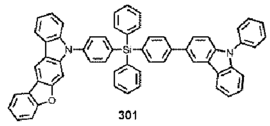
301

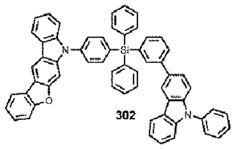
302

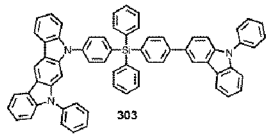
303

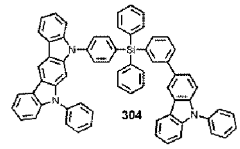
304

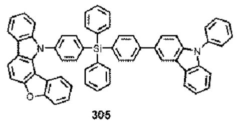
305

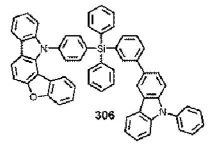
306

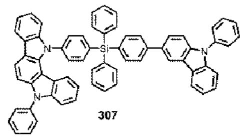
307

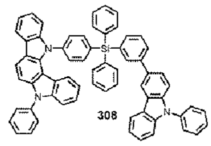
308

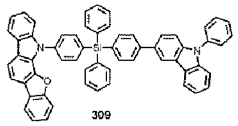
309

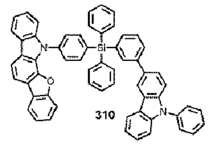
310

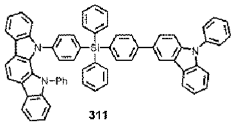
311

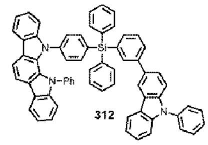
312

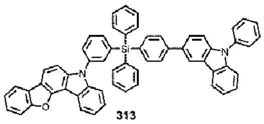
313

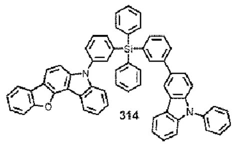
314

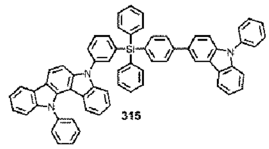
315

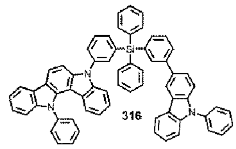
316

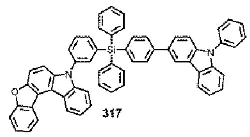
317

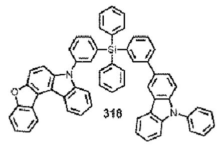
318

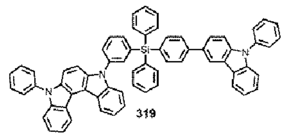
319

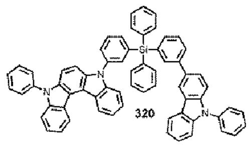
320

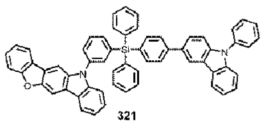
321
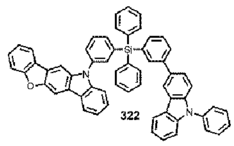
322
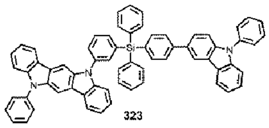
323
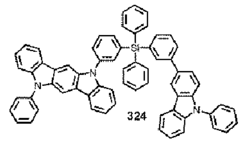
324

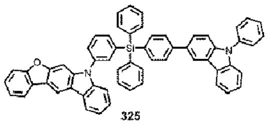
325
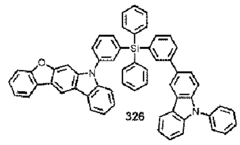
326
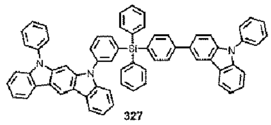
327
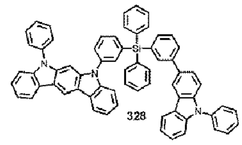
328

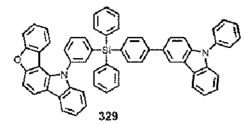
329
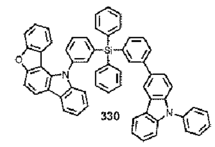
330
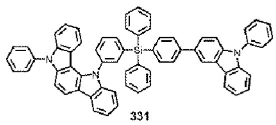
331
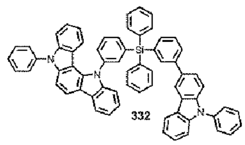
332

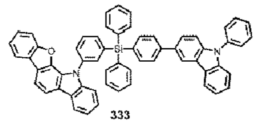
333
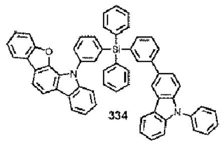
334
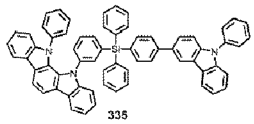
335
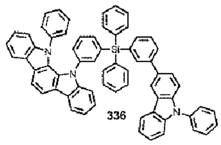
336

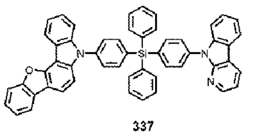
337
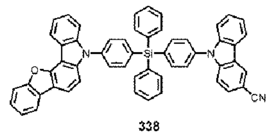
338
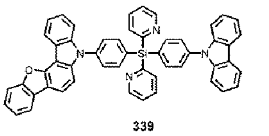
339
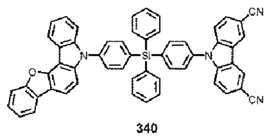
340

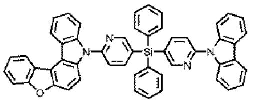
341
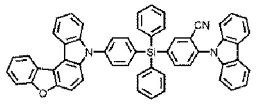
342
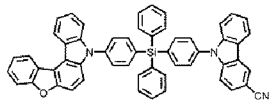
343
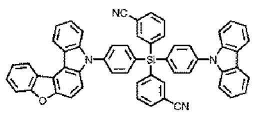
344

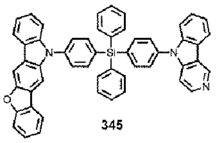
345
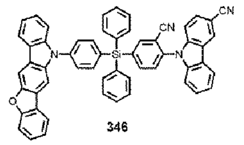
346
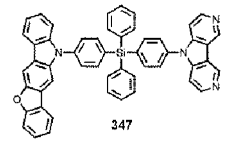
347
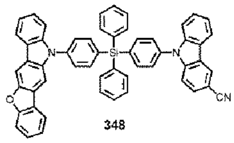
348

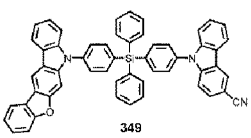
349
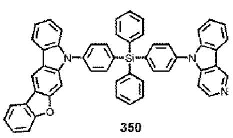
350
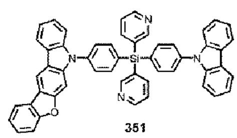
351
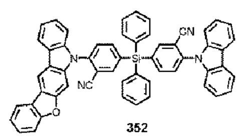
352

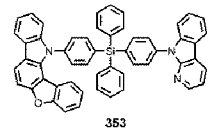
353

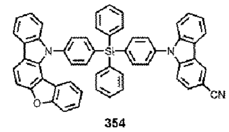
354

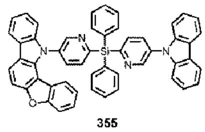
355

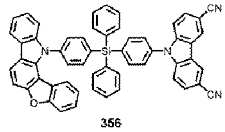
356

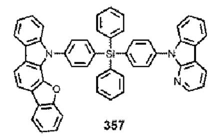
357

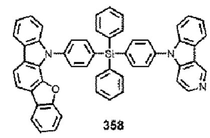
358

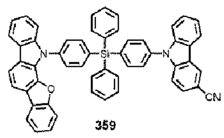
359

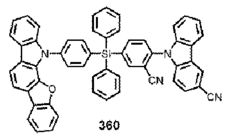
360

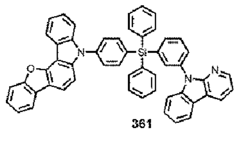
361

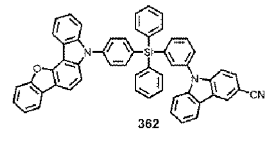
362

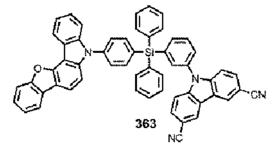
363

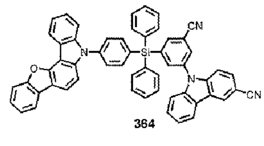
364

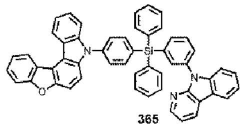
365

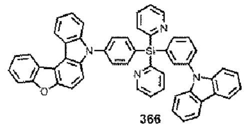
366

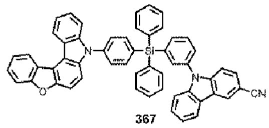
367

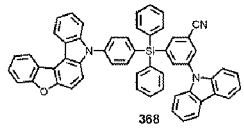
368

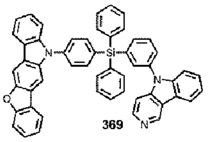
369

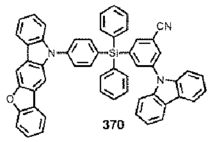
370

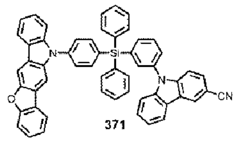
371

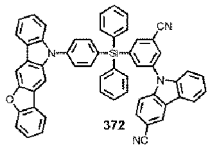
372

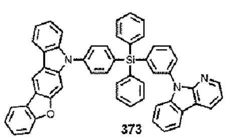
373

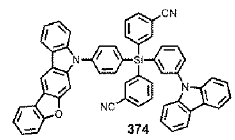
374

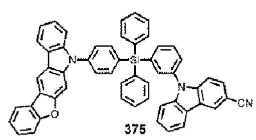
375

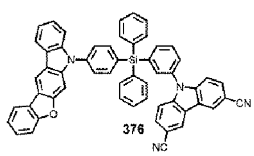
376

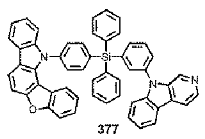
377

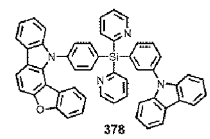
378

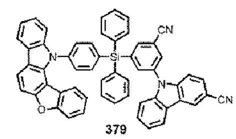
379

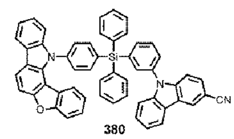
380

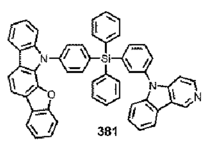
381

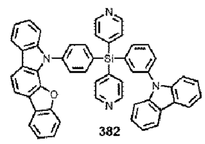
382

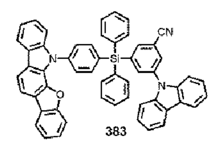
383

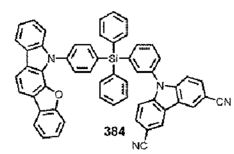
384

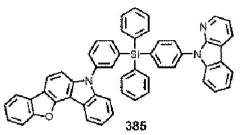
385
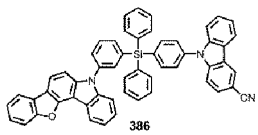
386
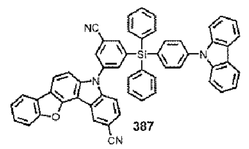
387
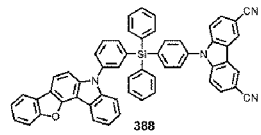
388
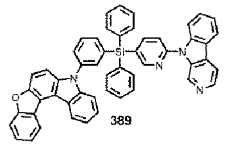
389
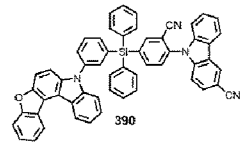
390
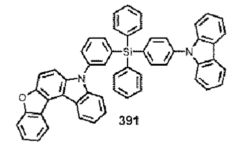
391
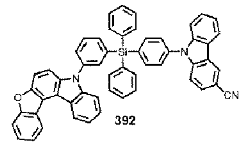
392
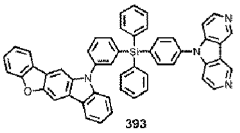
393
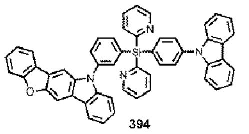
394
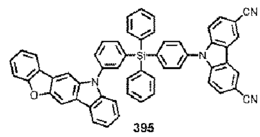
395
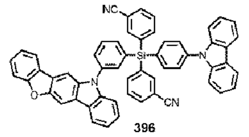
396
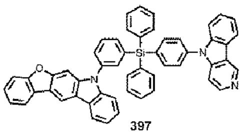
397
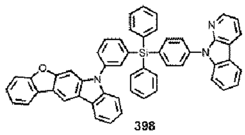
398
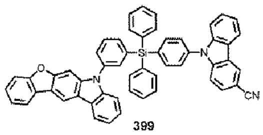
399
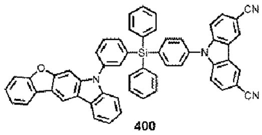
400
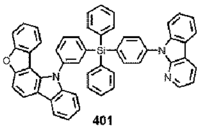
401
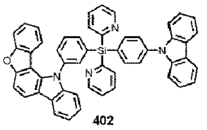
402
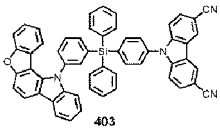
403
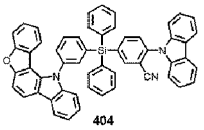
404
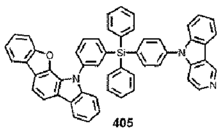
405
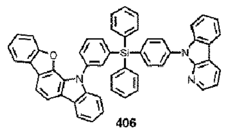
406
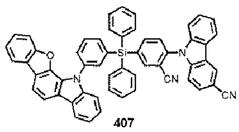
407
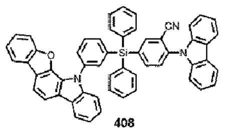
408
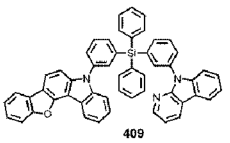
409
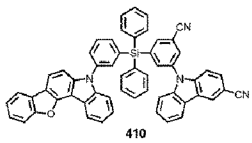
410
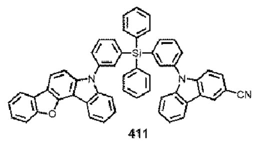
411
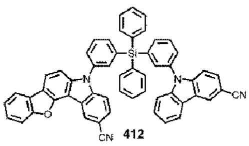
412
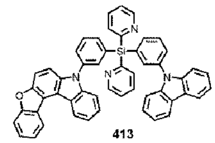
413
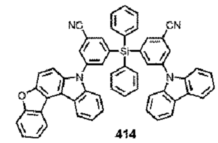
414
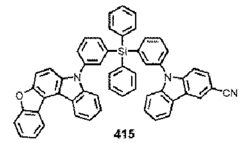
415
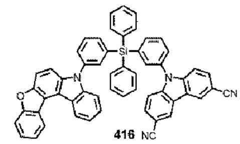
416

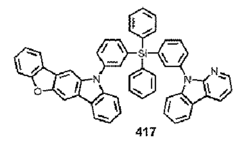
417
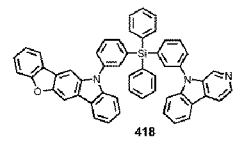
418
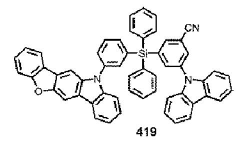
419
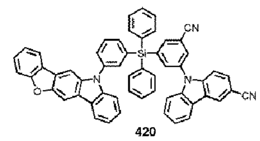
420

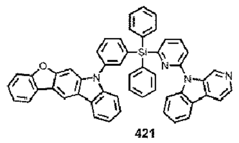
421
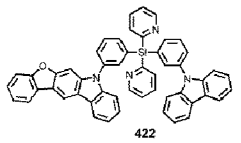
422
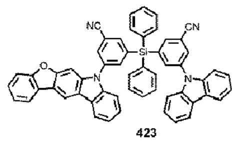
423
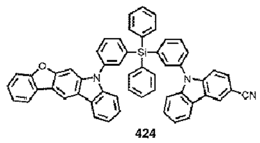
424

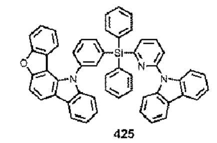
425
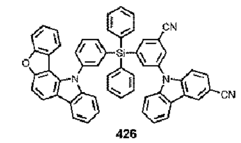
426
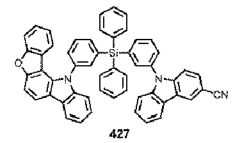
427
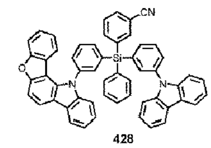
428

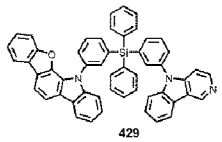
429
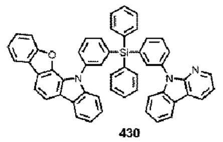
430
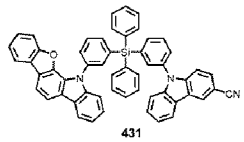
431
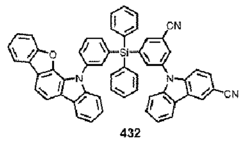
432

wherein, in Compounds 1 to 432,
Ph may be a phenyl group.

When the host is a mixture of an electron transport host and a hole transport host, the weight ratio of the electron transport host and hole transport host may be 1: 9 to 9: 1, for example, 2: 8 to 8: 2, for example, 4: 6 to 6: 4, for example, 5: 5. When the weight ratio of the electron transport host and the hole transport host satisfies the above-described ranges, the hole-and-electron transport balance in the emission layer may be made.

In one or more embodiments, the host may include at least one of TPBi, TBADN, ADN (also referred to as "DNA"), CBP, CDBP, TCP, mCP, or Compound H50 to Compound H52:

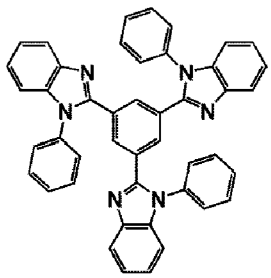
TPBi
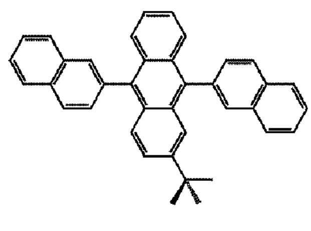
TBADN
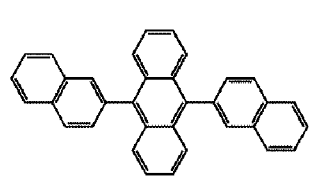
ADN

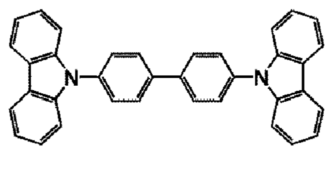
CBP
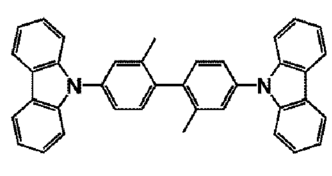
CDBP
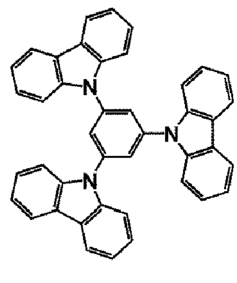
TCP

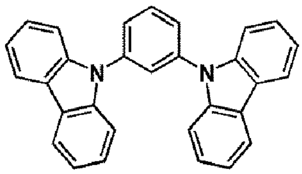

mCP

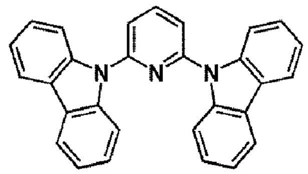

H50

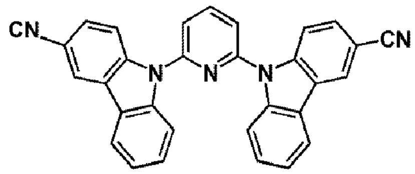

H51

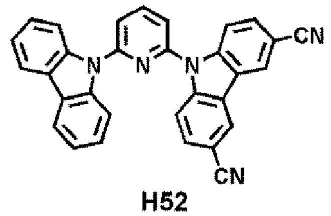

H52

In one or more embodiments, the host may further include a compound represented by Formula 301:

Formula 301

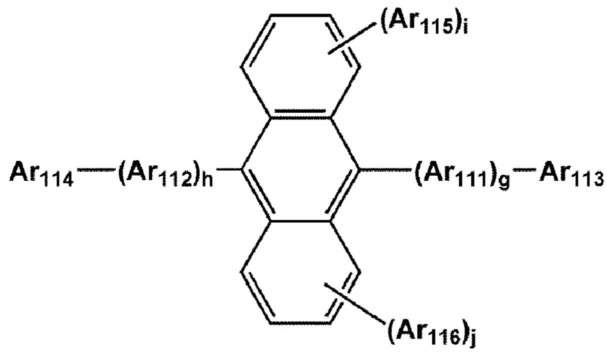

wherein, $Ar_{111}$ and $Ar_{112}$ in Formula 301 may each independently be:

a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, or an anthracenyl group.

$Ar_{113}$ to $Ar_{116}$ in Formula 301 may each independently be:

a $C_1$-$C_{10}$ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, or an anthracenyl group.
g, h, i, and j in Formula 301 may each independently be an integer from 0 to 4, and may be, for example, 0, 1, or 2.

$Ar_{113}$ and $Ar_{116}$ in Formula 301 may each independently be:

a $C_1$-$C_{10}$ alkyl group, substituted with at least one of a phenyl group, a naphthyl group, or an anthracenyl group;
a phenyl group, a naphthyl group, an anthracenyl group, a pyrenyl, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthracenyl group, a pyrenyl group, a phenanthrenyl group, or a fluorenyl group; or
a group of the formula:

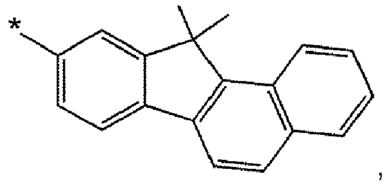

but embodiments of the present disclosure are not limited thereto.

In one or more embodiments, the host may include a compound represented by Formula 302:

Formula 302

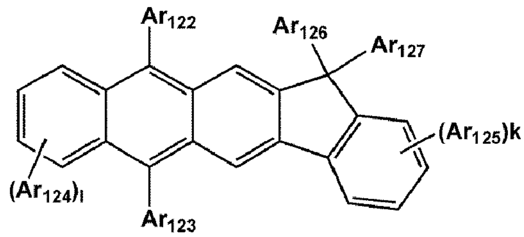

$Ar_{122}$ to $Ar_{125}$ in Formula 302 are the same as described in connection with $Ar_{113}$ in Formula 301.

$Ar_{126}$ and $Ar_{127}$ in Formula 302 may each independently be a $C_1$-$C_{10}$ alkyl group (for example, a methyl group, an ethyl group, or a propyl group).

k and l in Formula 302 may each independently be an integer from 0 to 4. For example, k and l may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a light-emitting dopant, an amount of the light-emitting dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

The light-emitting dopant may include the polycyclic compound represented by Formula 1.

In one or more embodiments, the sensitizer may include metal ($M_{11}$) of at least one of a first-row transition metal of the Periodic Table of Elements, a second-row transition metal of the Periodic Table of Elements, or a third-row transition metal of the Periodic Table of Elements, and an organic ligand $L_1$, and $L_2$ and $M_{11}$ may form 1, 2, 3, or 4 cyclometallated rings.

In one or more embodiments, the sensitizer may include an organometallic compound represented by Formula 101:

Formula 101 $M_{11}(L_1)_{n1}(L_2)_{n2}$

wherein, in Formula 101,

$M_{11}$ is a first-row transition metal of the Periodic Table of Elements, a second-row transition metal of the Periodic Table of Elements, or a third-row transition metal of the Periodic Table of Elements;

$L_1$ is a ligand represented by one of Formulae 10-1 to 10-4;

$L_2$ may be a monodentate ligand or a bidentate ligand;

n1 may be 1;

n2 is 0, 1, or 2;

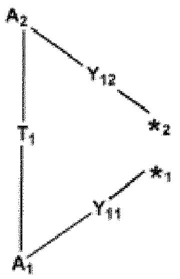

10-1

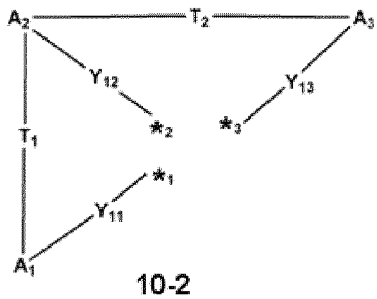

10-2

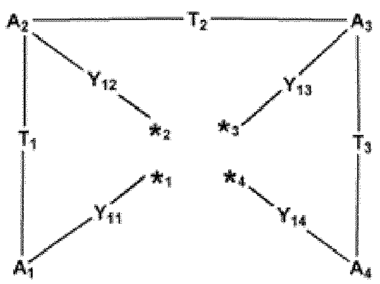

10-3

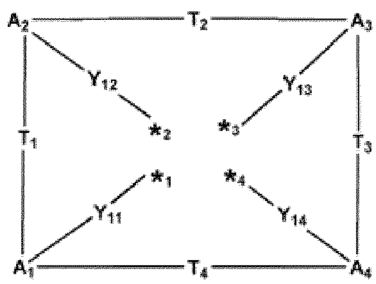

10-4

wherein, in Formulae 10-1 to 10-4,

$A_1$ to $A_4$ may each independently be a substituted or unsubstituted $C_5$-$C_{30}$ carbocyclic group, a substituted or unsubstituted $C_1$-$C_{30}$ heterocyclic group, or a noncyclic group,

$Y_{11}$ to $Y_{14}$ may each independently be a chemical bond, O, S, $N(R_{91})$, $B(R_{91})$, $P(R_{91})$, or $C(R_{91})(R_{92})$,

$T_1$ to $T_4$ may each independently be a single bond, a double bond, $-N(R_{93})-$, - $B(R_{93})_-$, $-P(R_{93})'$, $-C(R_{93})(R_{94})-$, $-Si(R_{93})(R_{94})-$, $-Ge(R_{93})(R_{94})'$, -S-, -Se-, -O', -C(=O)-, - S(=O)-, $-S(=O)_2-$, $-C(R_{93})=$, $=C(R_{93})-$, $-C(R_{93})=C(R_{94})-$, -C(=S)-, or -C≡C-,

at least one substituent of the substituted $C_5$-$C_{30}$ carbocyclic group, a substituent of substituted $C_1$-$C_{30}$ heterocyclic group, and $R_{91}$ to $R_{94}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or-$P(=S)(Q_1)(Q_2)$, wherein each of a substituent of the substituted $C_5$-$C_{30}$ carbocyclic group and a substituent of substituted $C_1$-$C_{30}$ heterocyclic group is not hydrogen,

*1, *2, *3, and *4 each indicate a binding site to $M_{11}$, and

$Q_1$ to $Q_3$ may each independently be hydrogen, deuterium, -F, -Cl, -Br, -I, a hydroxyl group, a cyano group, a nitro group, an amidino group, a hydrazine group, a hydrazone group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group; a $C_1$-$C_{60}$ alkyl group that is substituted with at least one of deuterium, -F, a

cyano group, a $C_1$-$C_{60}$ alkyl group, or a $C_6$-$C_{60}$ aryl group; or a $C_6$-$C_{60}$ aryl group that is substituted with at least one of deuterium, -F, a cyano group, a $C_1$-$C_{60}$ alkyl group, or a $C_6$-$C_{60}$ aryl group.

In one or more embodiments, the sensitizer may be one of Groups I to VI, but embodiments of the present disclosure are not limited thereto:

## Group I

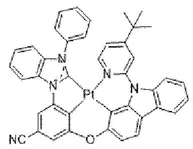
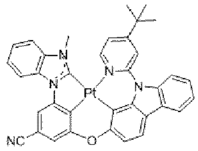
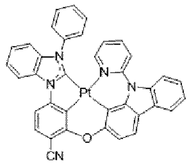
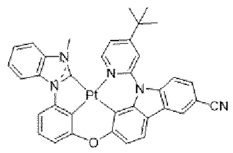
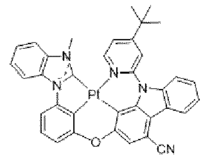

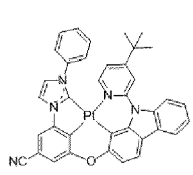
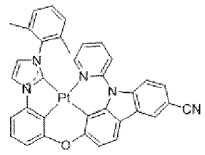

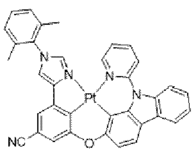
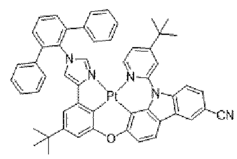
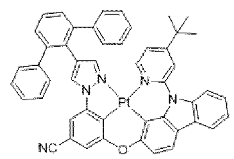
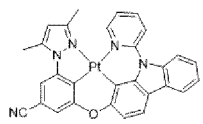

## Group II

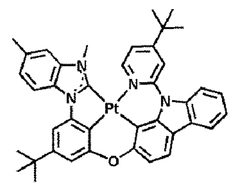
1

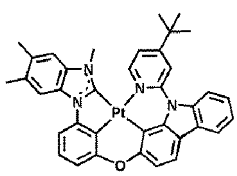
2

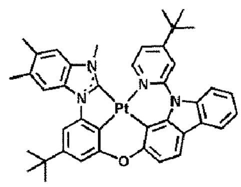
3

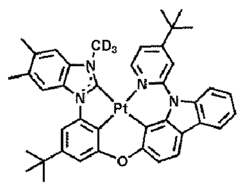
4

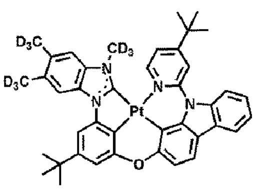
5

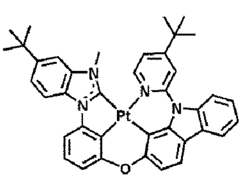
6

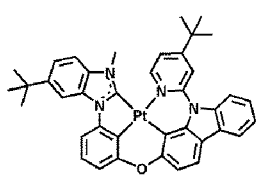
7

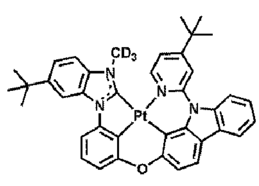
8

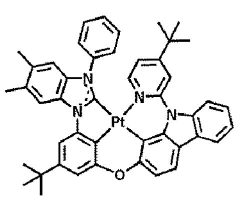
9

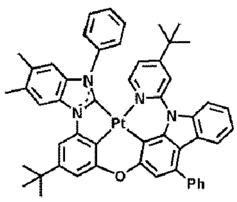
10

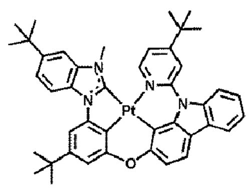
11

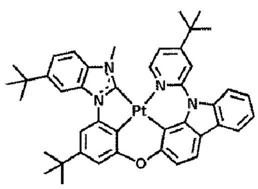
12

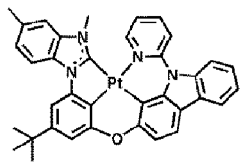
13

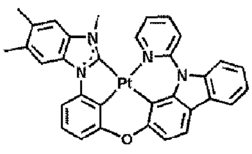
14

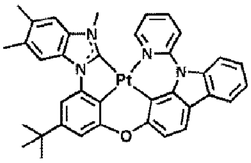
15

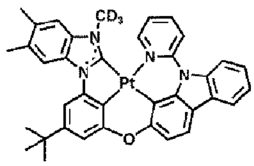
16

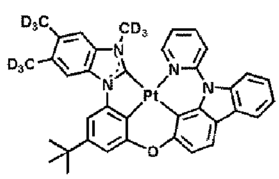
17

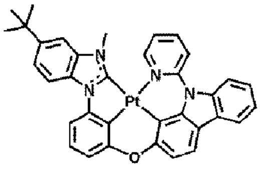
18

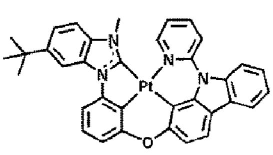
19

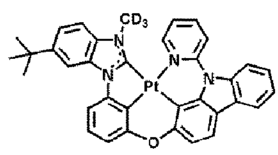
20

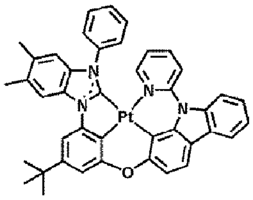
21

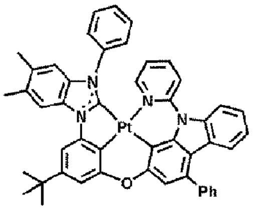
22

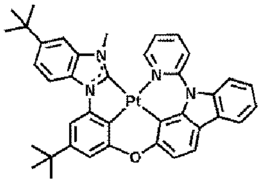
23

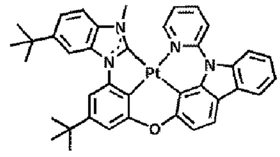
24

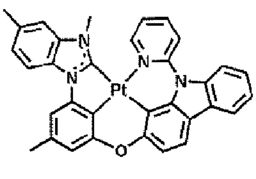
25

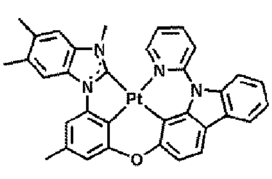
26

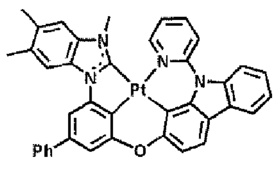
27

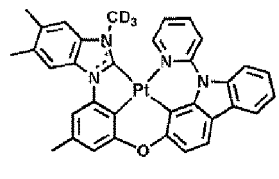
28

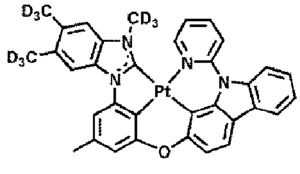
29

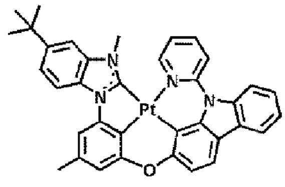
30

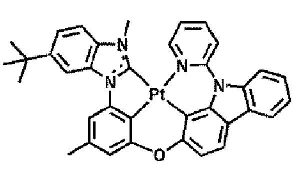
31

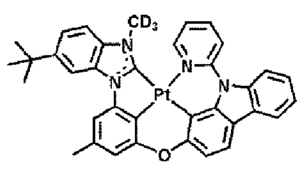
32

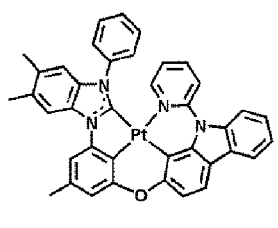
33

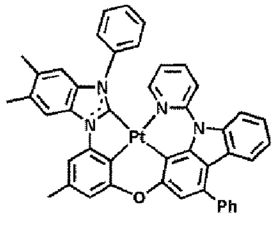
34

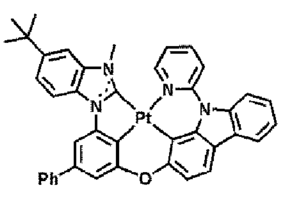
35

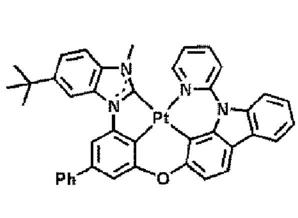
36

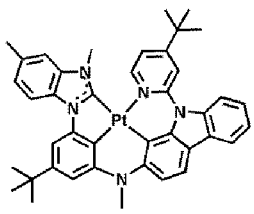
37

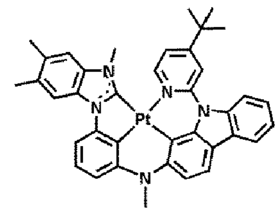
38

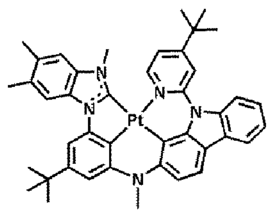
39

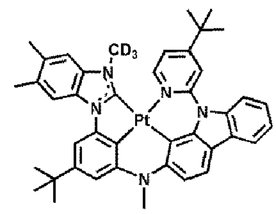
40

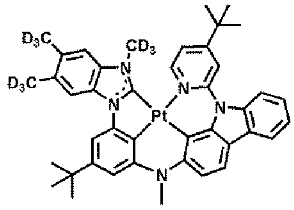
41

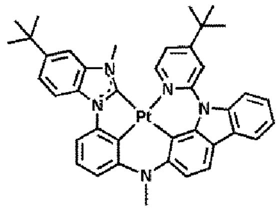
42

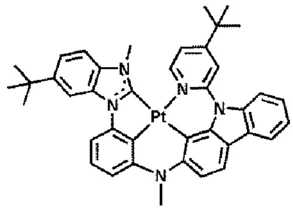
43

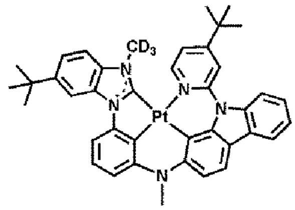
44

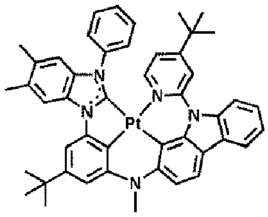
45

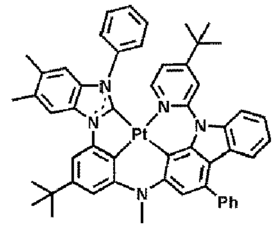
46

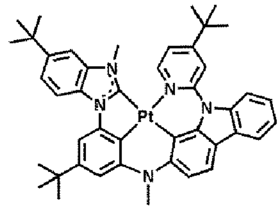
47

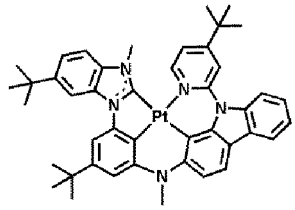
48

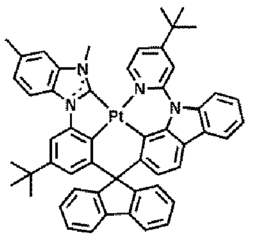
49

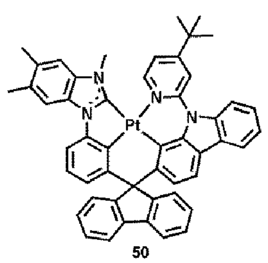
50

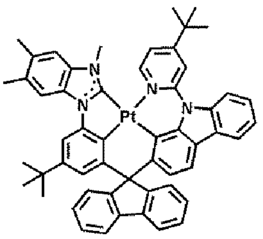
51

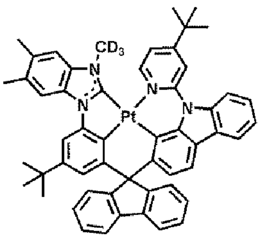
52

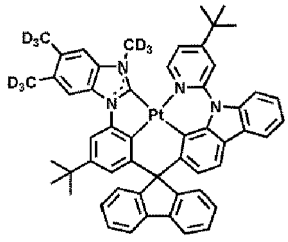
53

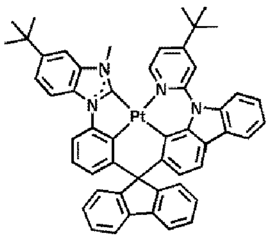
54

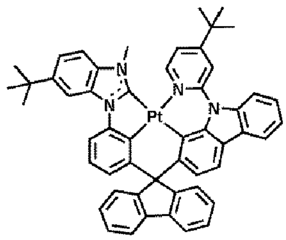
55

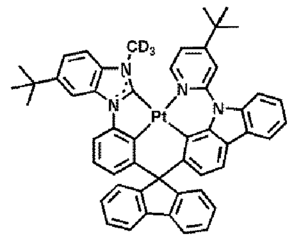
56

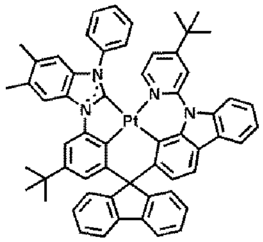
57

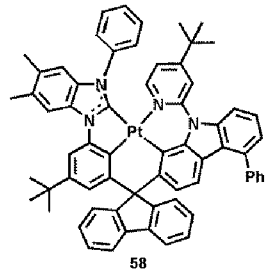
58

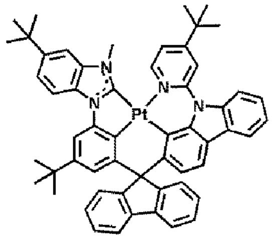
59

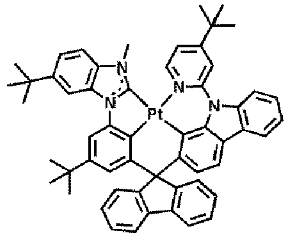
60

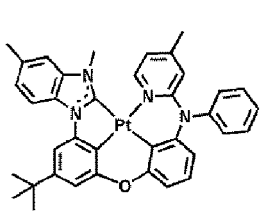
61

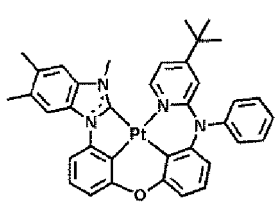
62

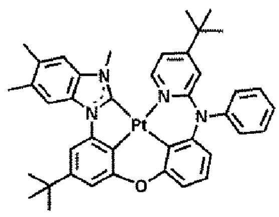
63

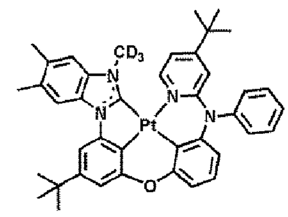
64

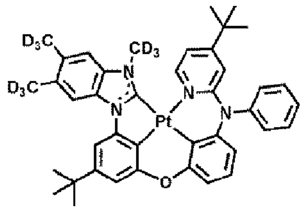
65

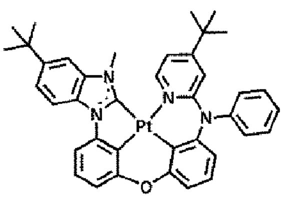
66

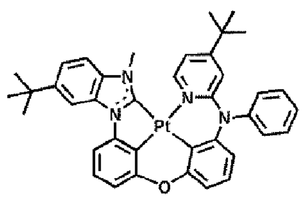
67

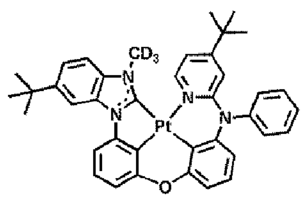
68

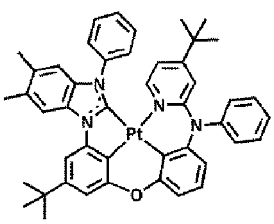
69

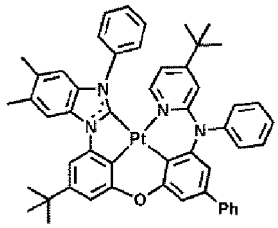
70

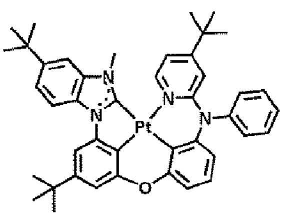
71

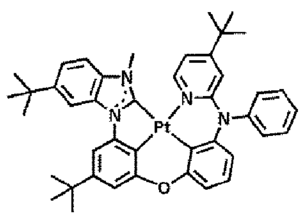
72

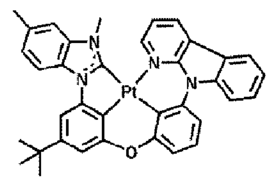
73

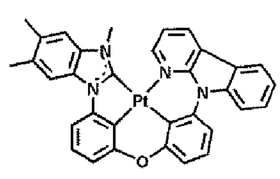
74

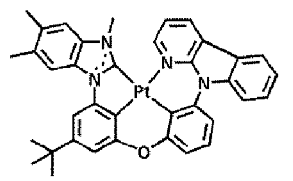
75

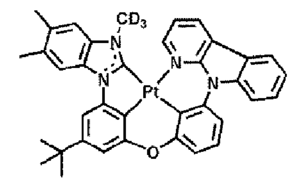
76

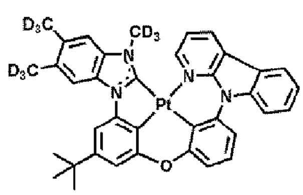
77

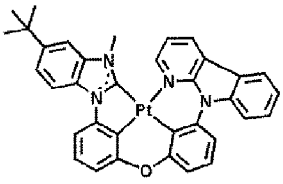
78

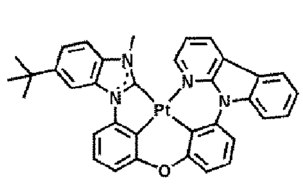
79

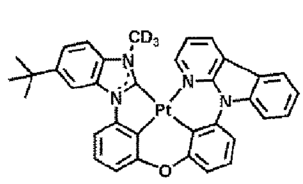
89

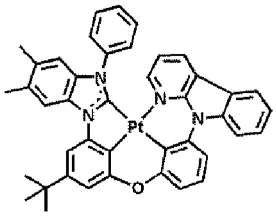
81

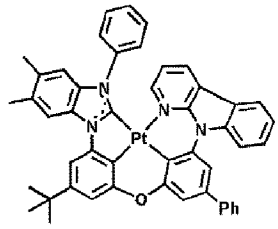
82

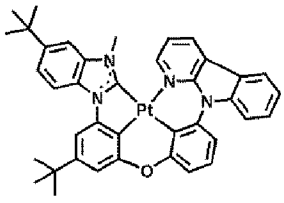
83

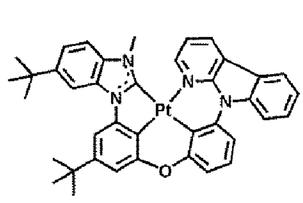
84

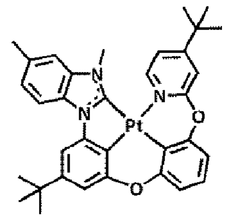
85

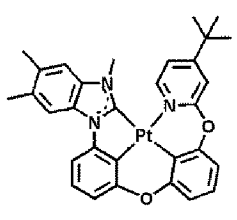
86

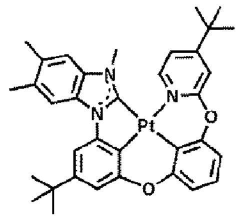
87

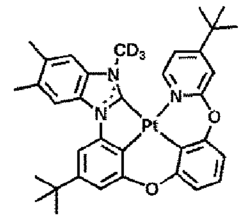
88

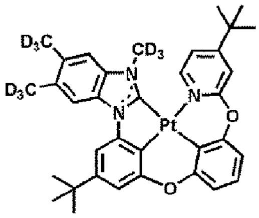
89

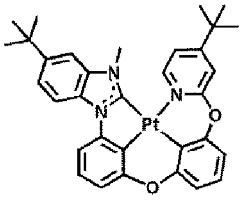
90

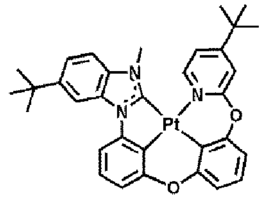
91

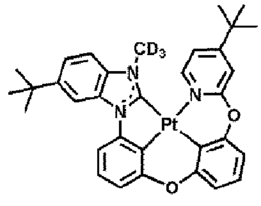
92

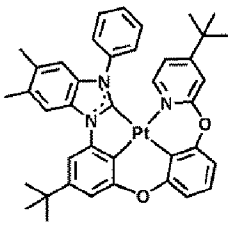
93

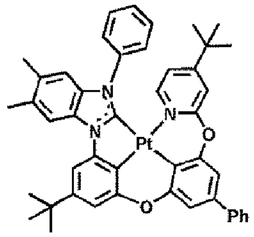
94

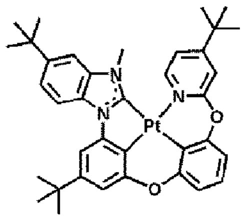
95

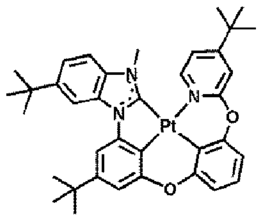
96

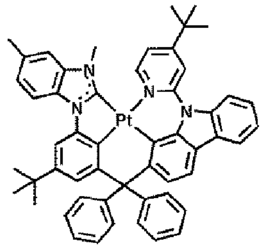
97

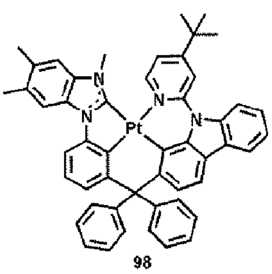
98

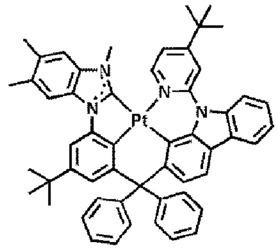
99

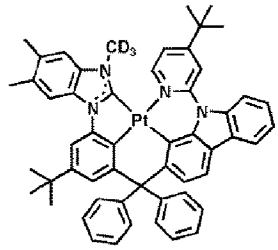
100

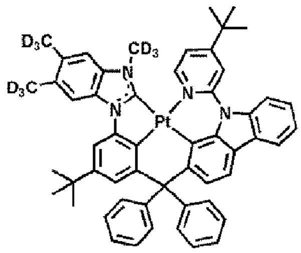
101

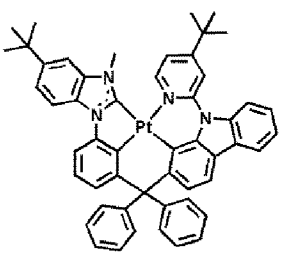
102

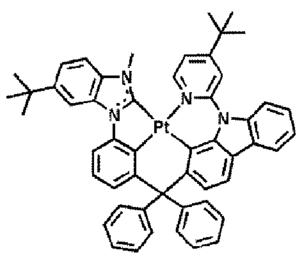
103

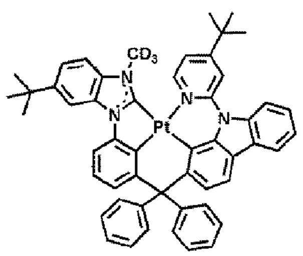
104

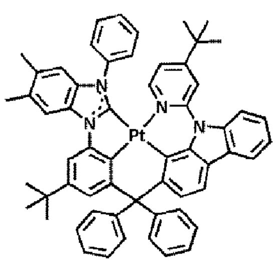
105

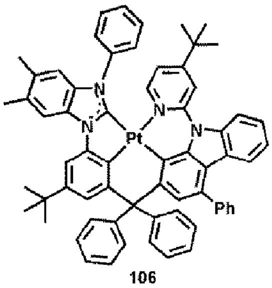
106

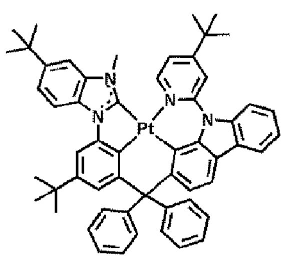
107

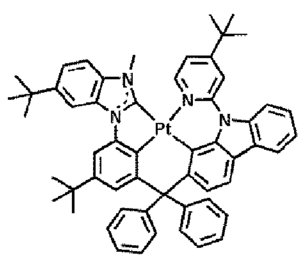
108

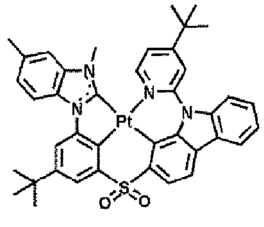
109

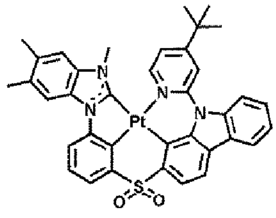
110

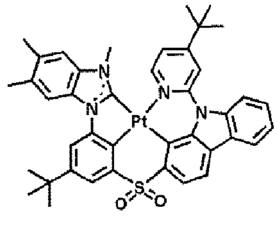
111

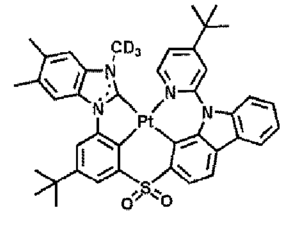
112

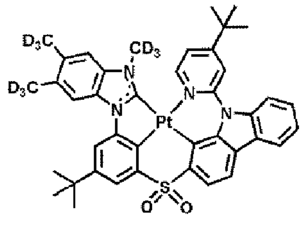
113

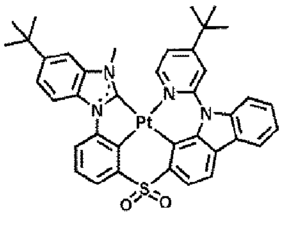
114

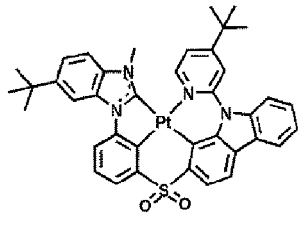
115

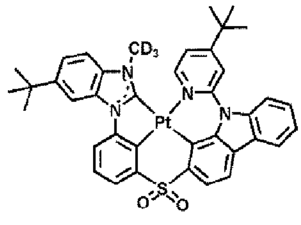
116

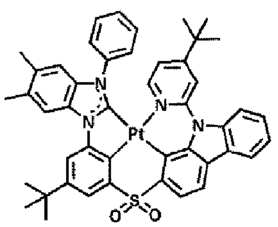
117

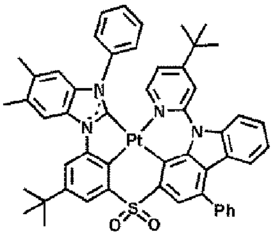
118

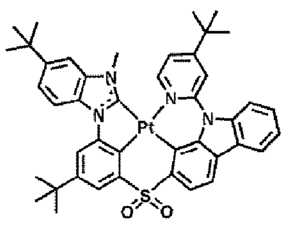
119

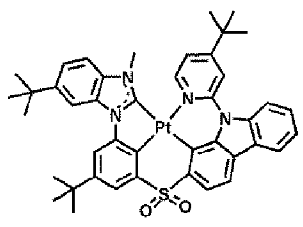
120

## Group III

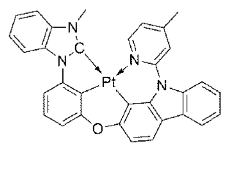

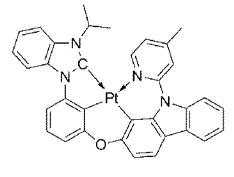

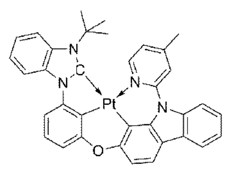

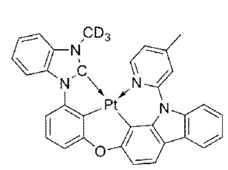

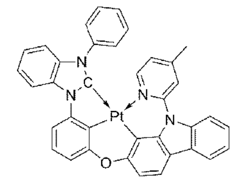

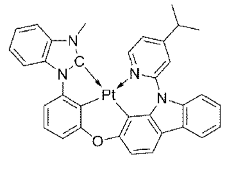

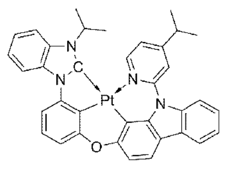

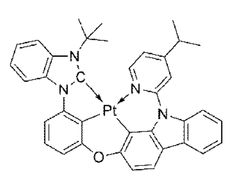

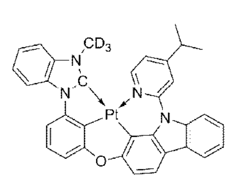

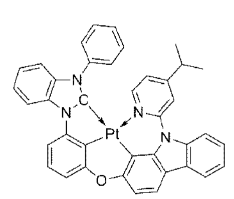

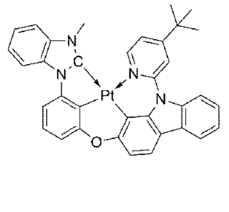

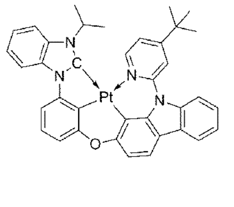

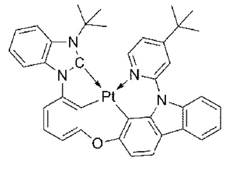

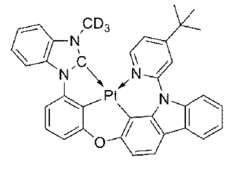

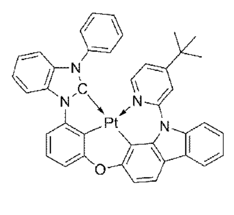

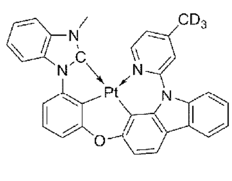
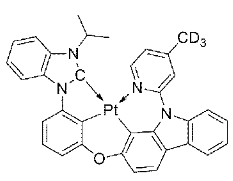
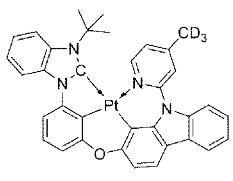
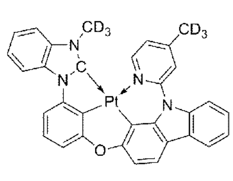
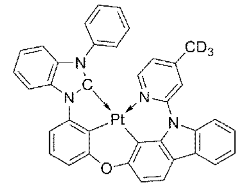
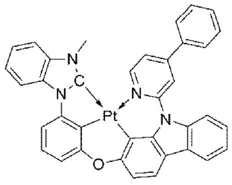
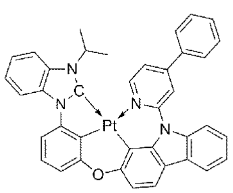
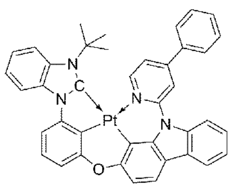
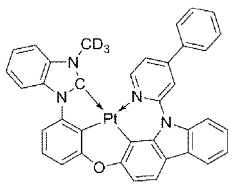
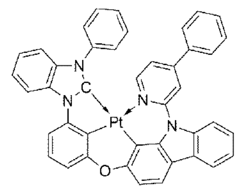
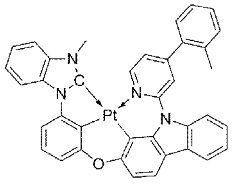
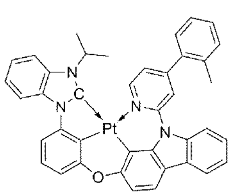
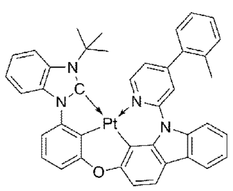
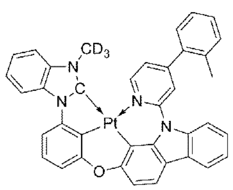
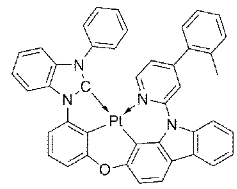
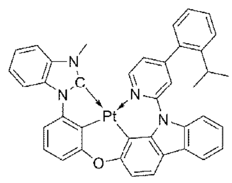
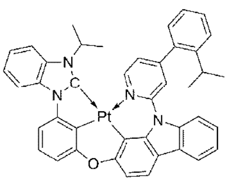
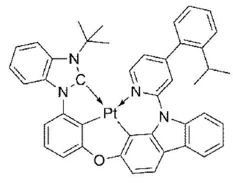
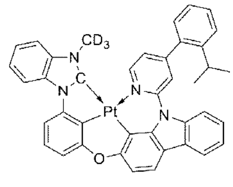
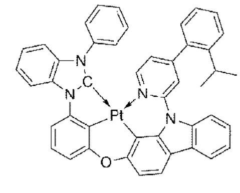
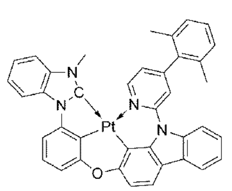
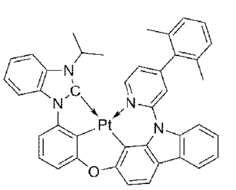
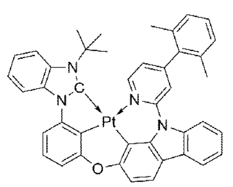
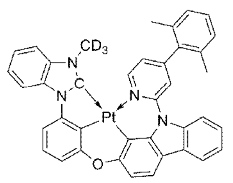
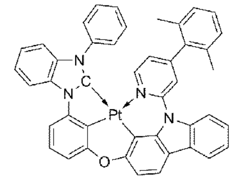
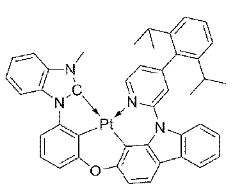
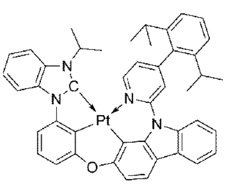
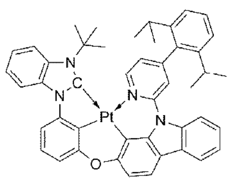
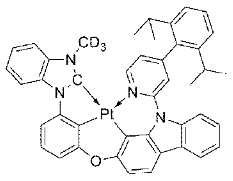
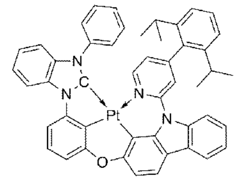
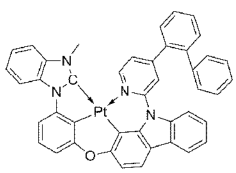
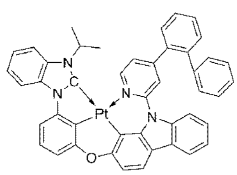
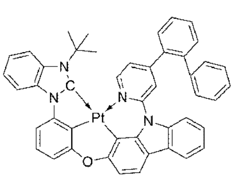
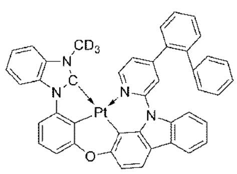
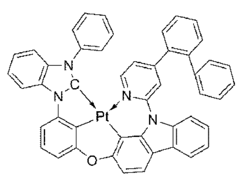
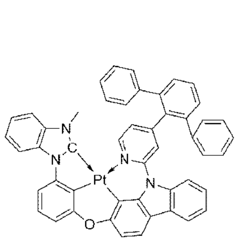
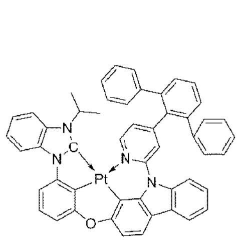
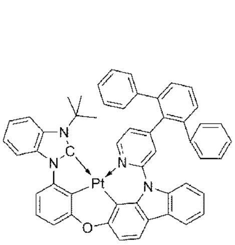
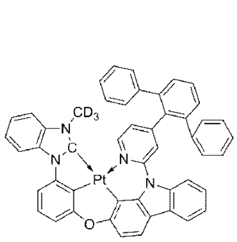
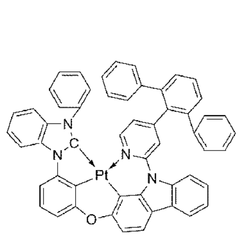

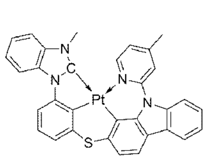 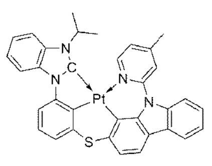 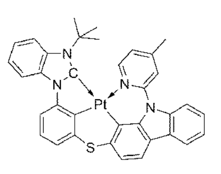 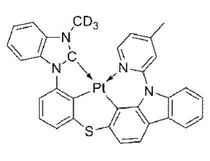 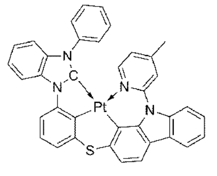

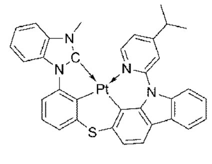 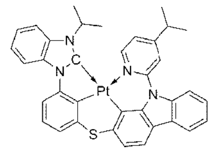 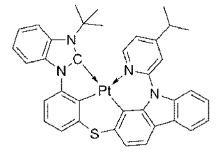 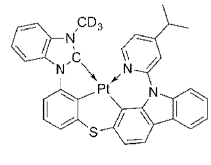 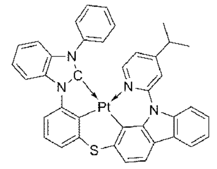

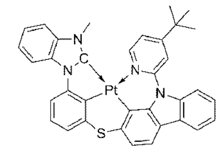 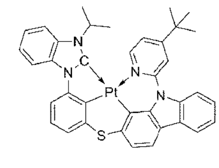 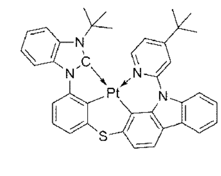 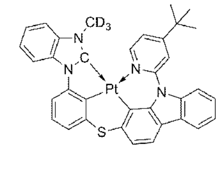 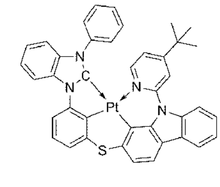

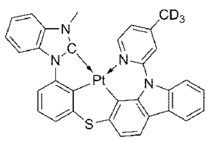 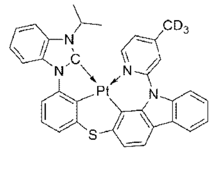 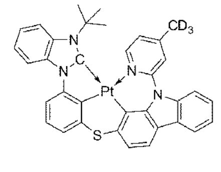 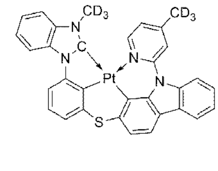 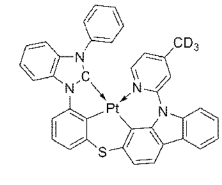

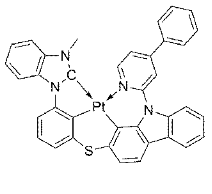 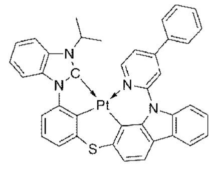 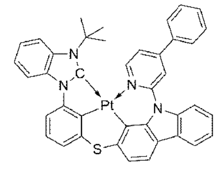 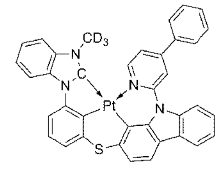 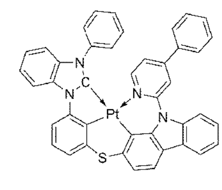

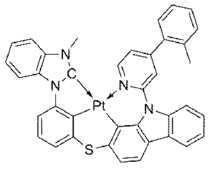 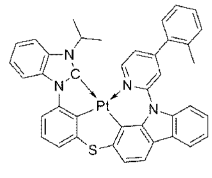 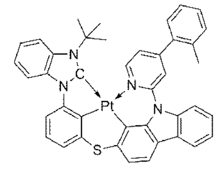 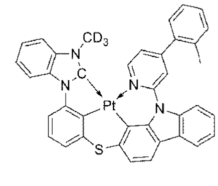 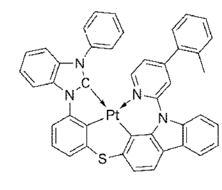

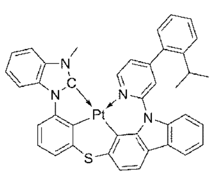 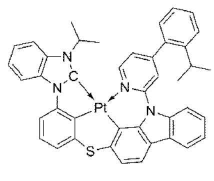 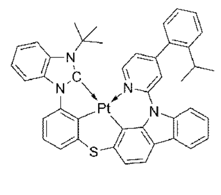 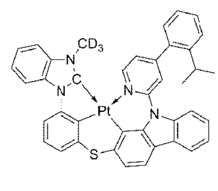 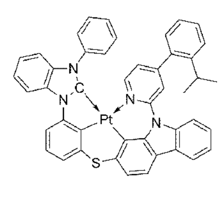

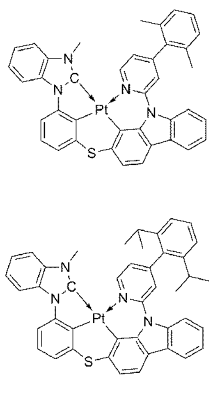 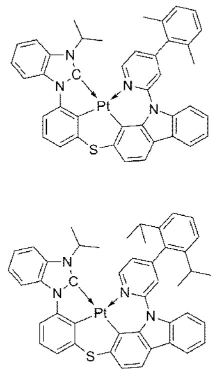 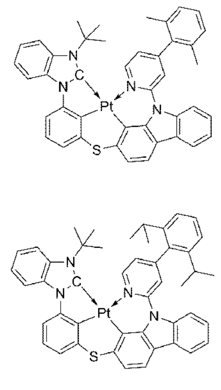 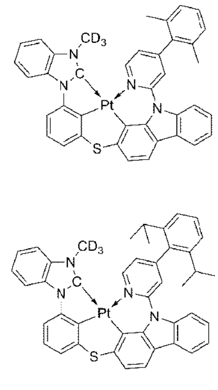 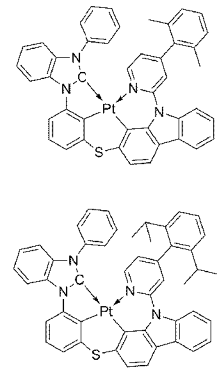

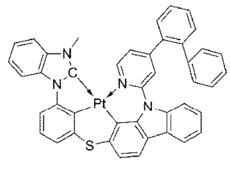
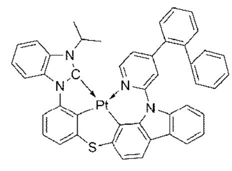
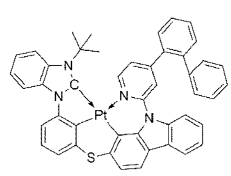
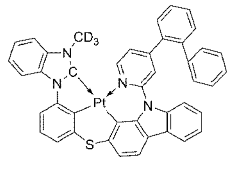
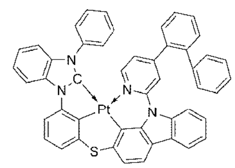
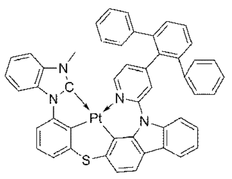
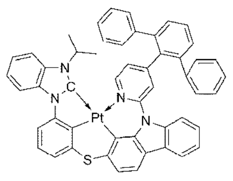
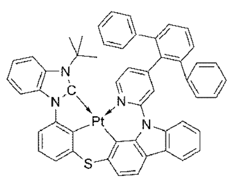
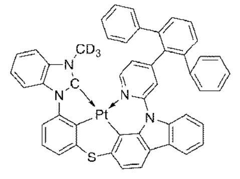
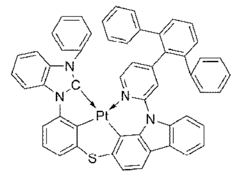
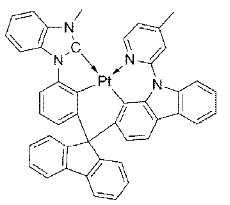
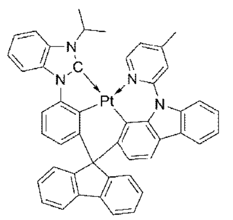
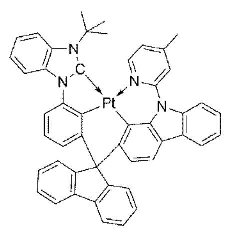
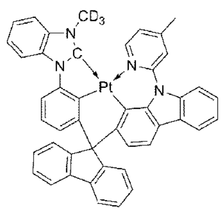
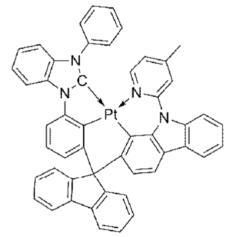
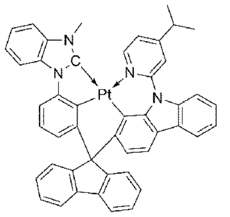
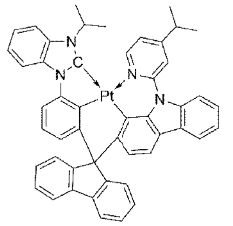
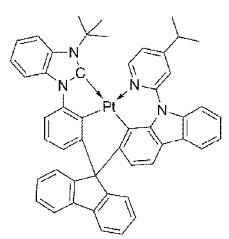
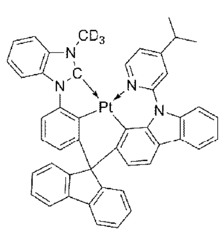
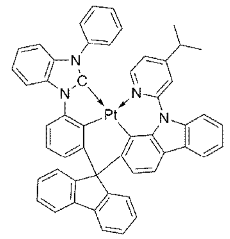
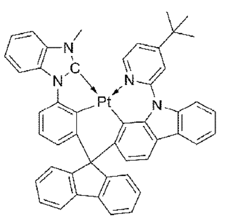
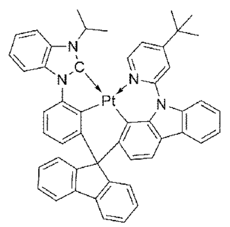
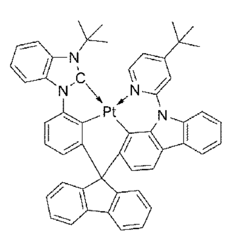
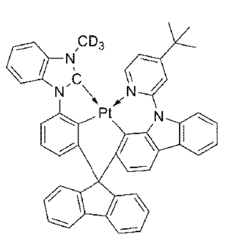
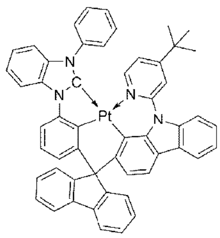

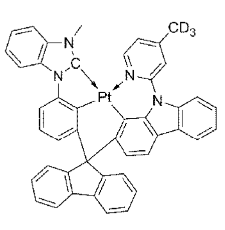 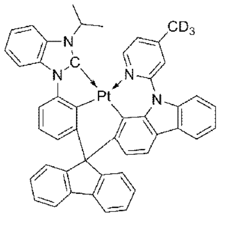 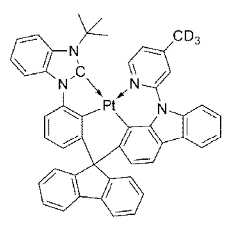 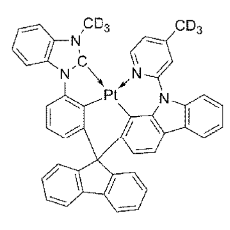 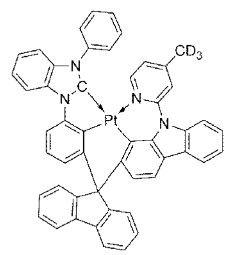

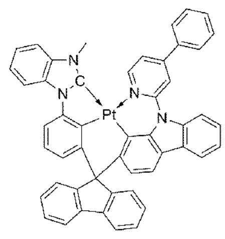 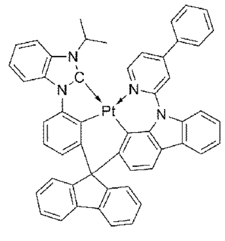 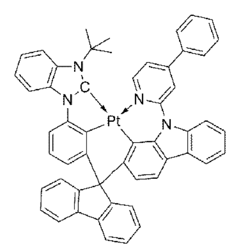 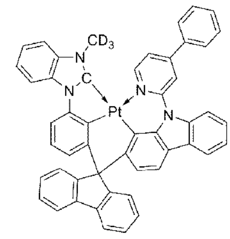 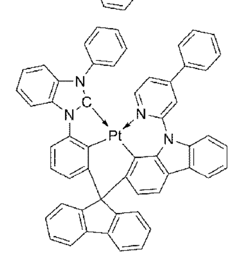

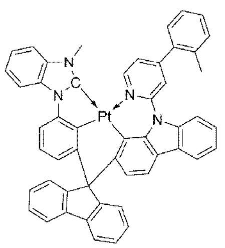 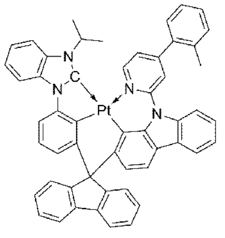 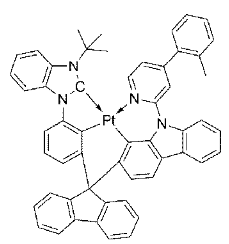 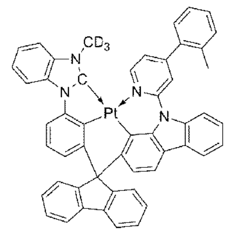 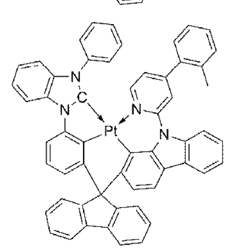

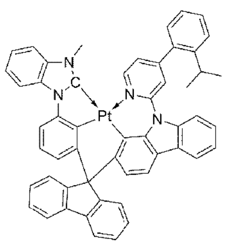 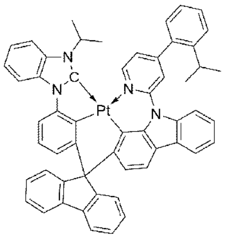 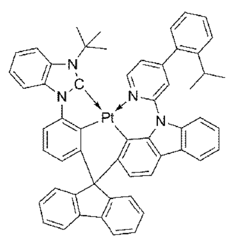 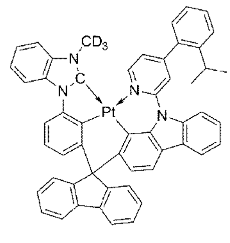 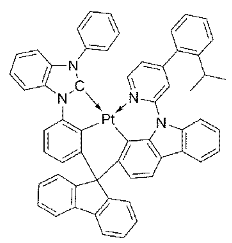

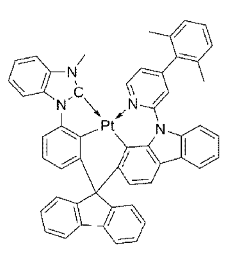 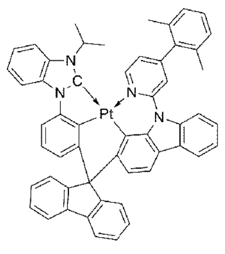 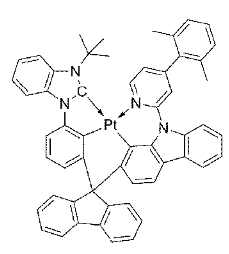 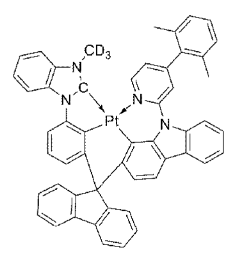 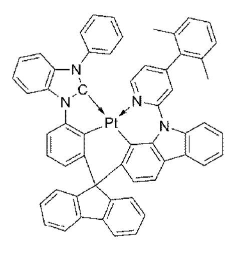

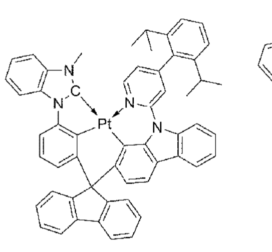 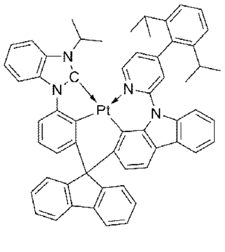 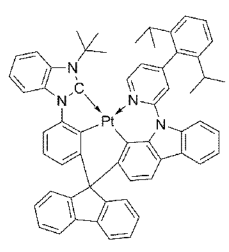 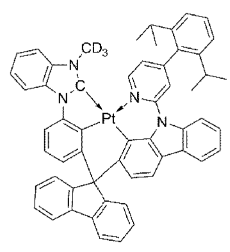 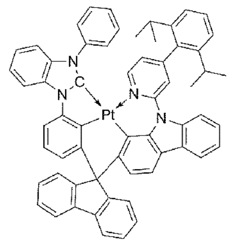

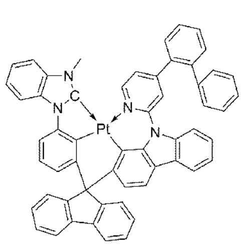
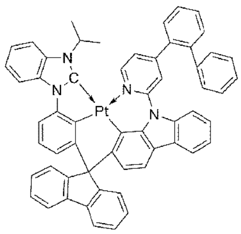
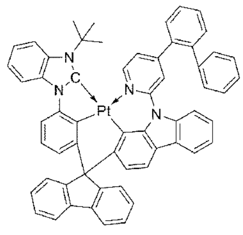
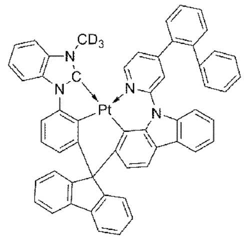
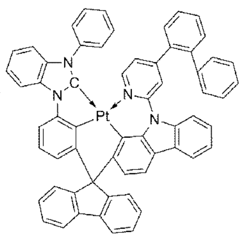

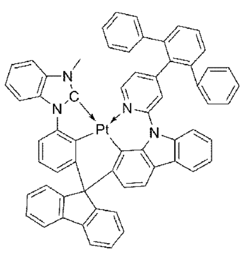
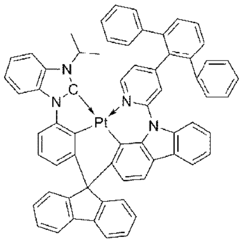
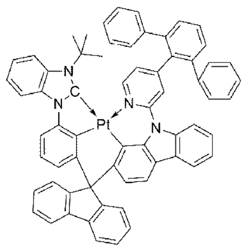
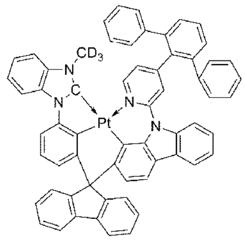
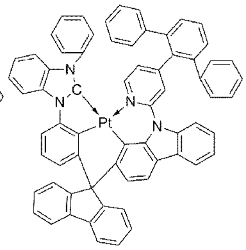

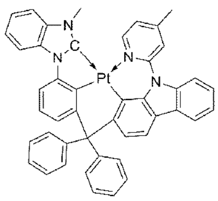
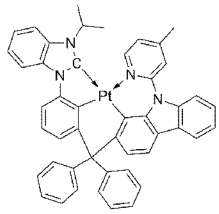
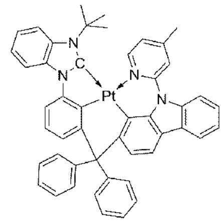
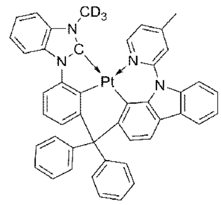
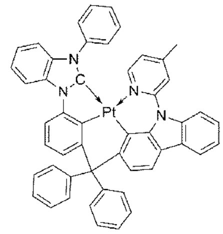

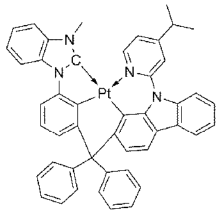
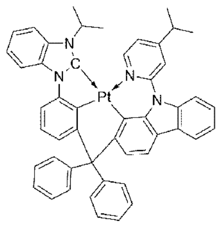
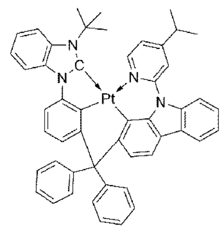
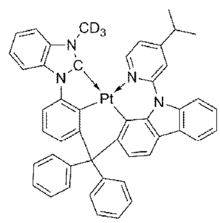
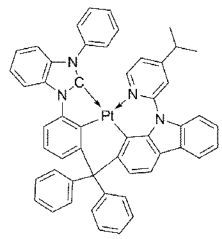

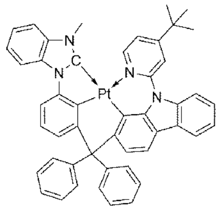
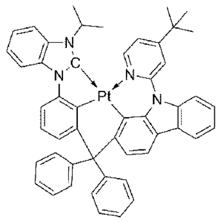
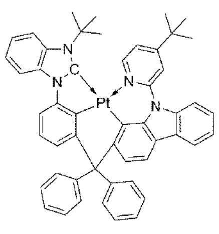
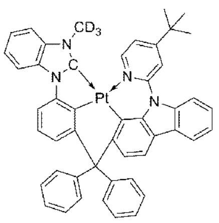
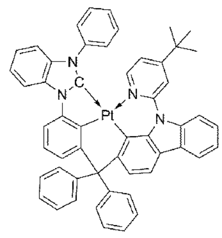

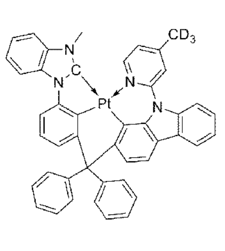
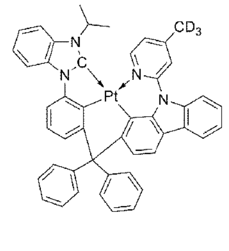
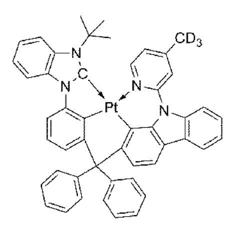
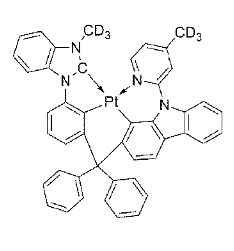
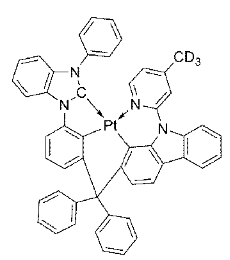
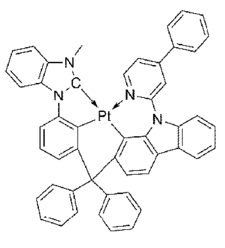
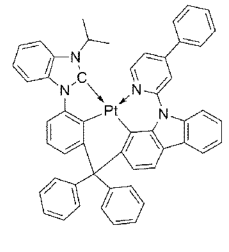
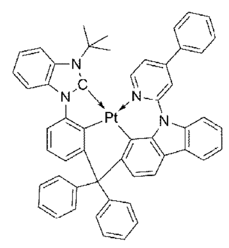
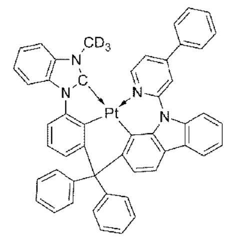
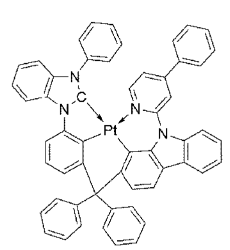
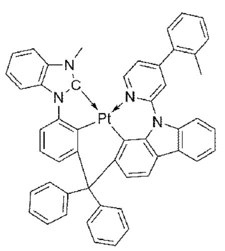
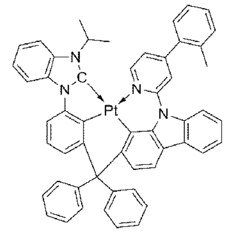
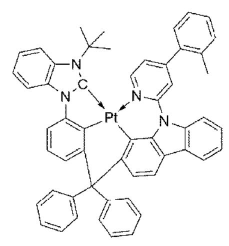
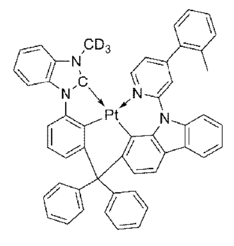
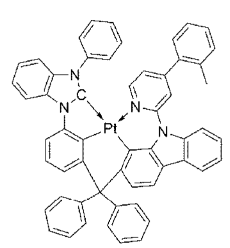
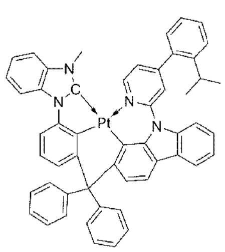
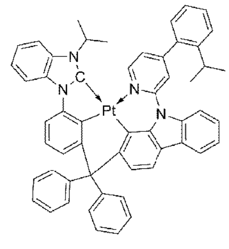
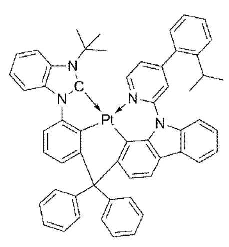
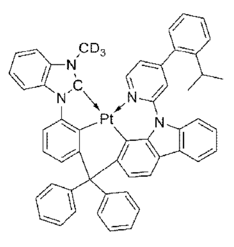
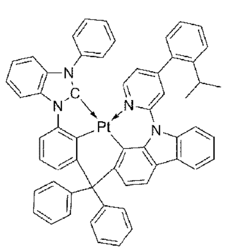
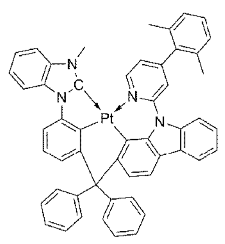
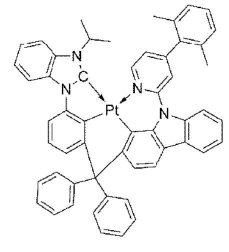
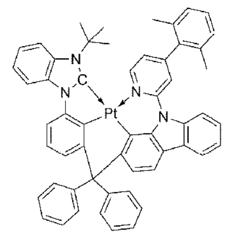
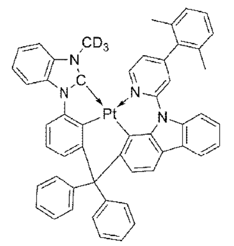
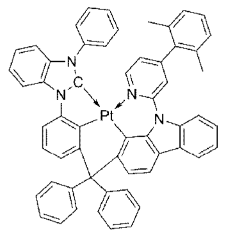
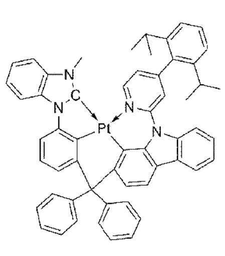
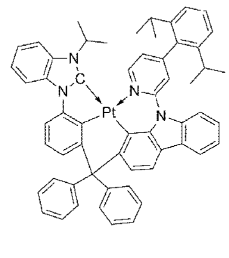
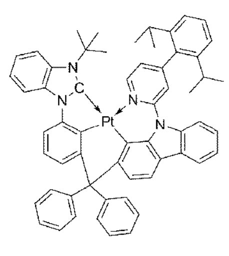
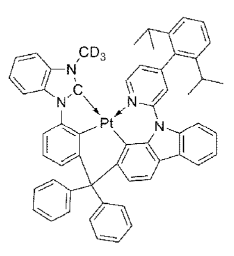
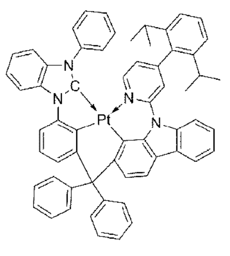

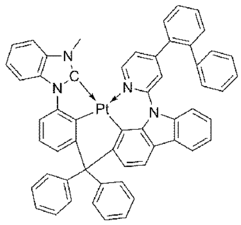 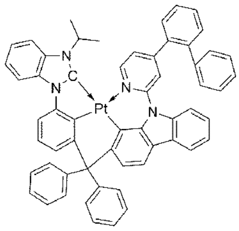 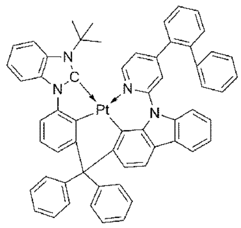 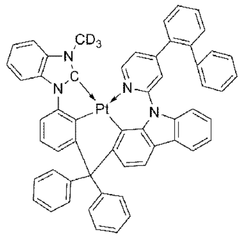 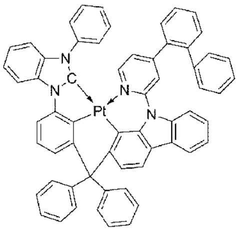

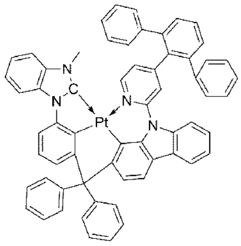 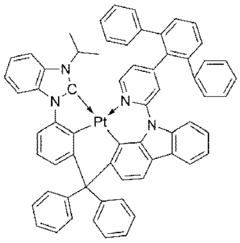 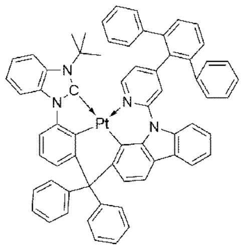 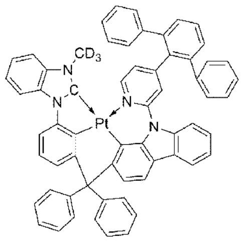 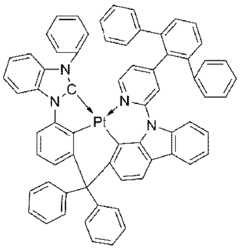

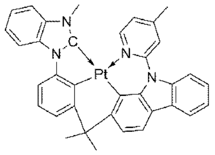 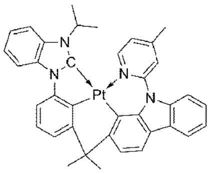 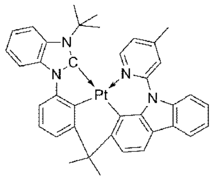 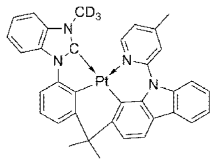 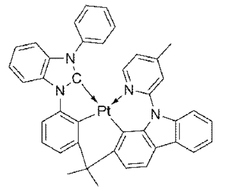

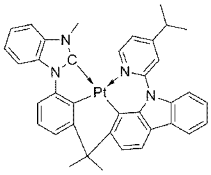 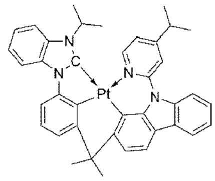 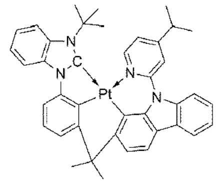 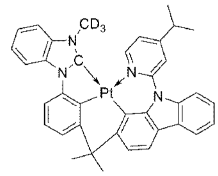 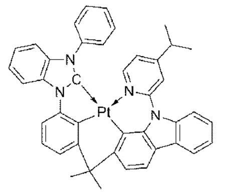

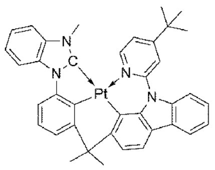 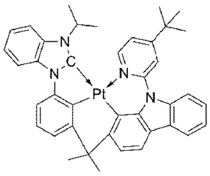 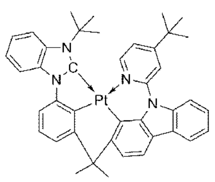 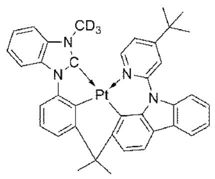 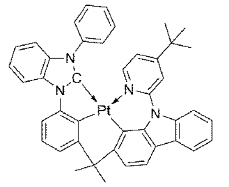

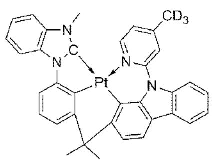
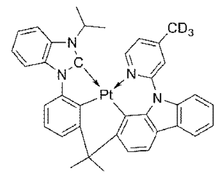
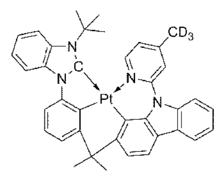
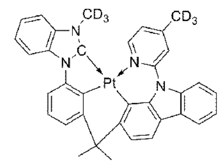
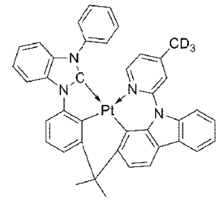

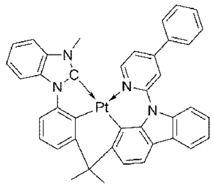
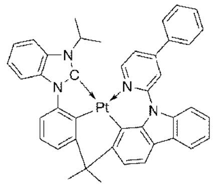
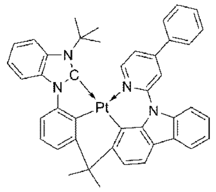
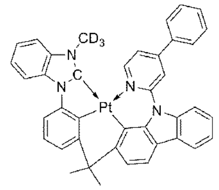
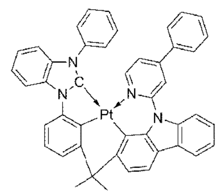

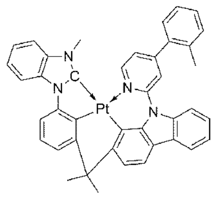
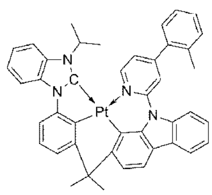
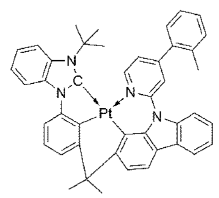
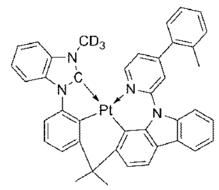
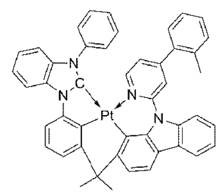

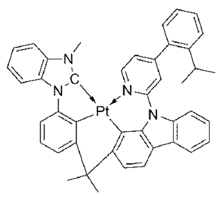
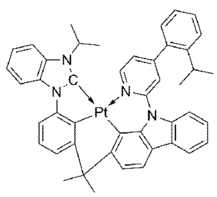
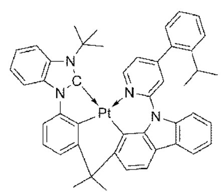
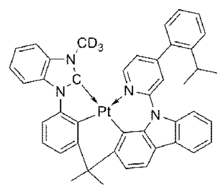
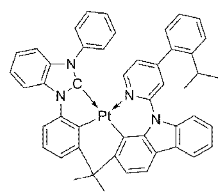

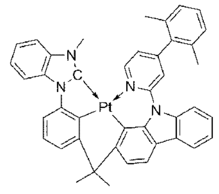
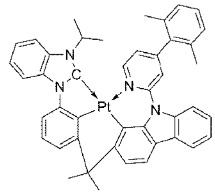
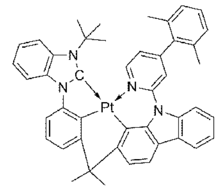
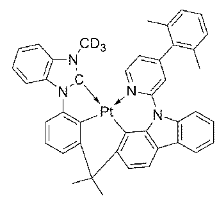
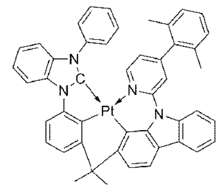

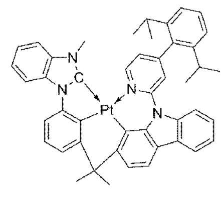
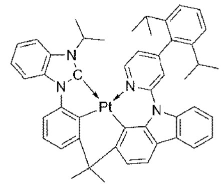
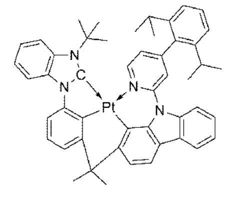
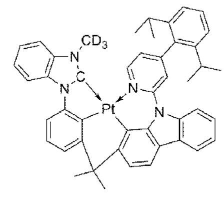
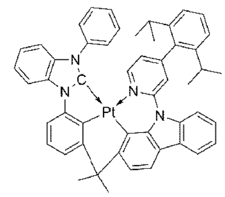

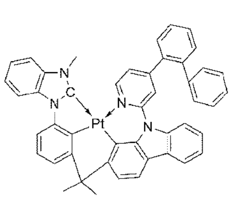
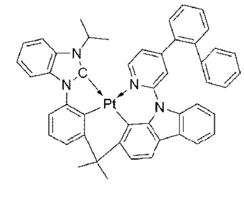
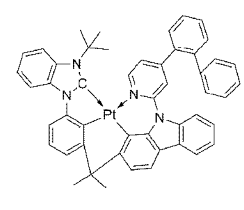
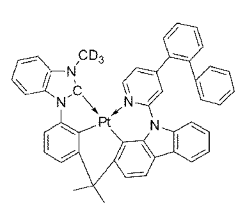
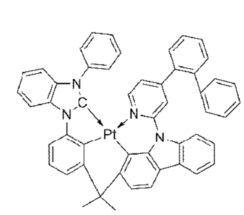
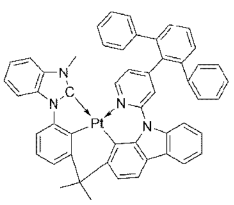
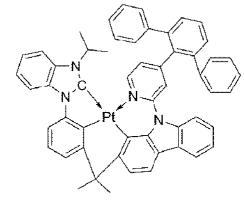
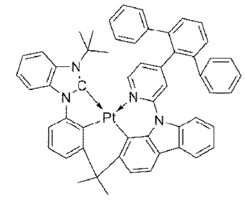
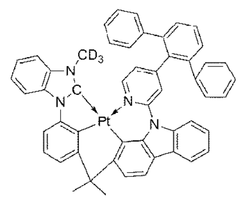
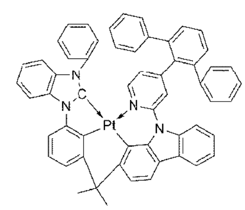
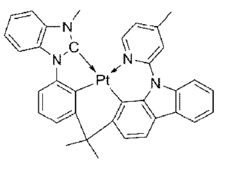
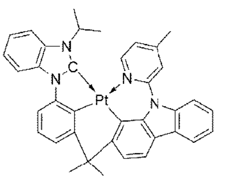
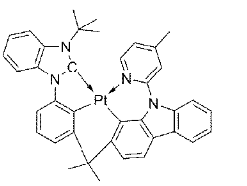
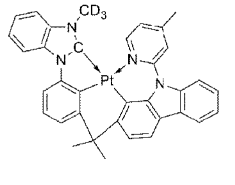
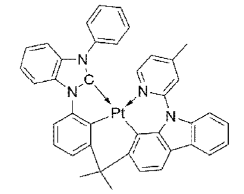
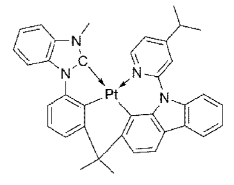
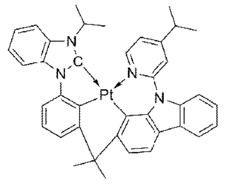
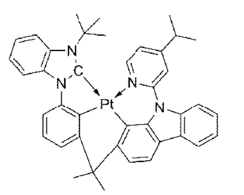
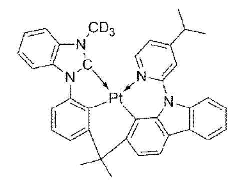
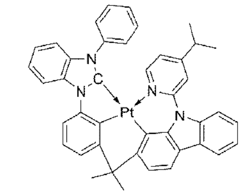
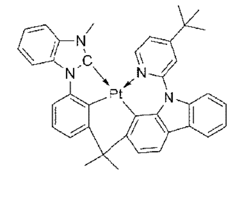
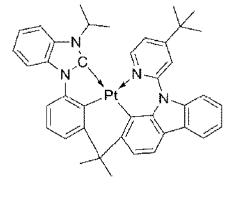
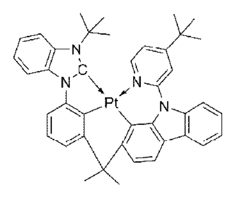
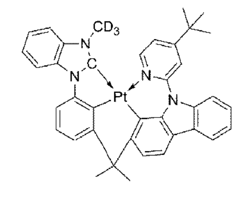
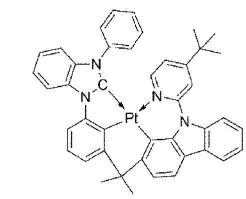
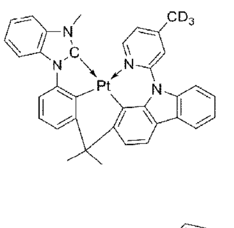
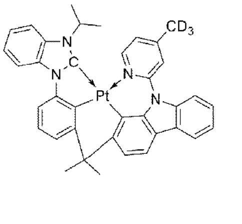
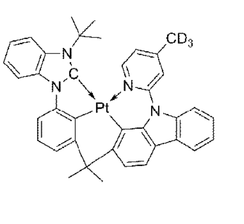
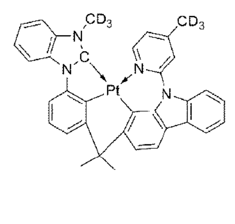
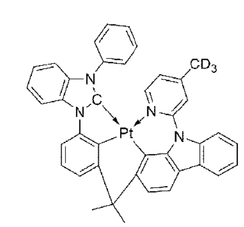
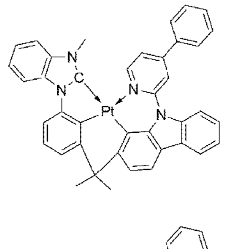
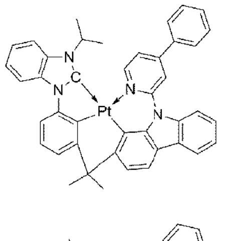
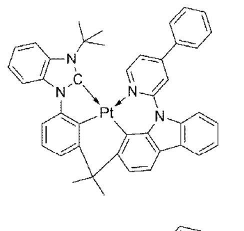
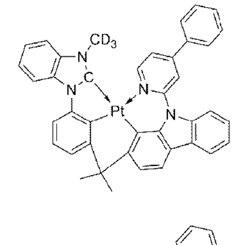
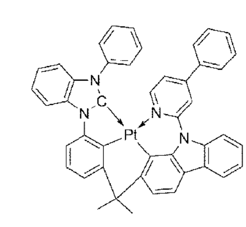
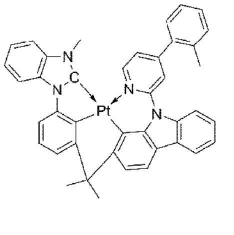
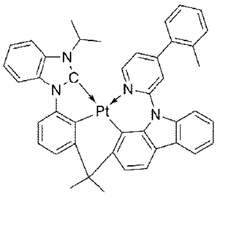
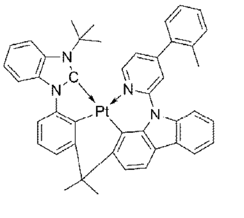
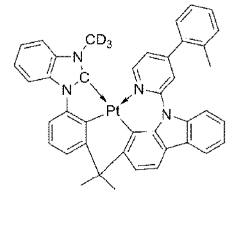
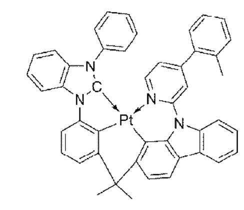

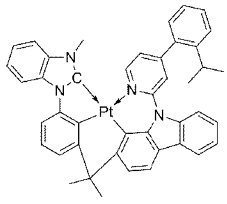
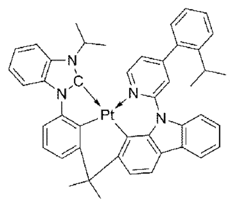
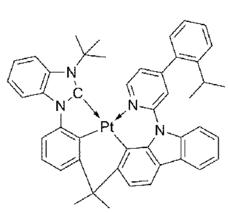
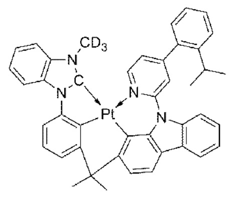
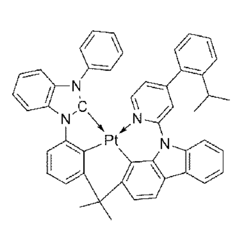

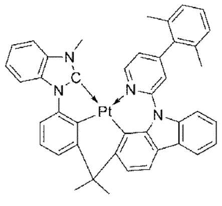
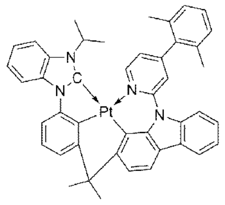
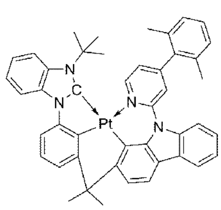
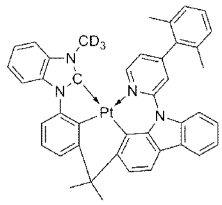
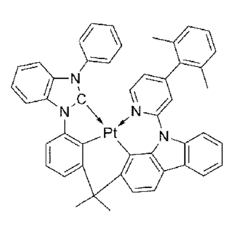

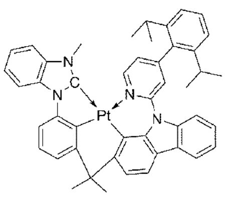
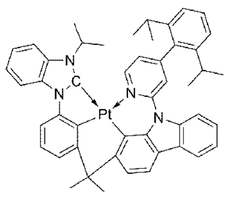
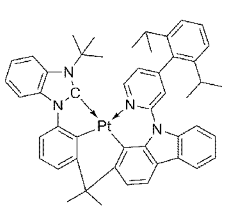
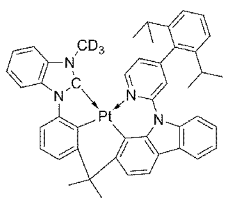
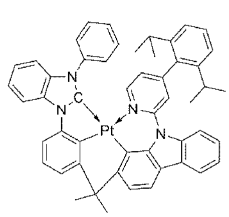

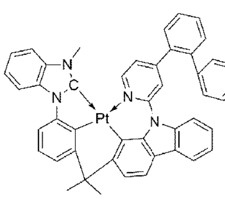
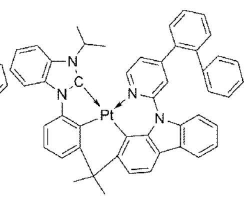
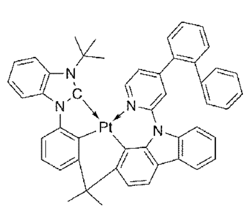
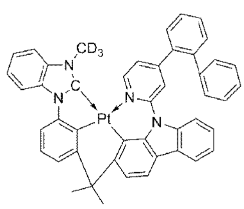
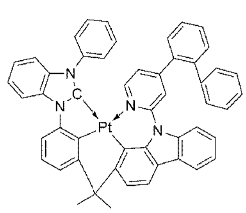

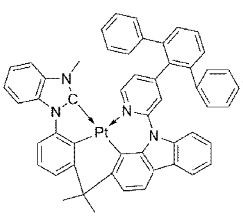
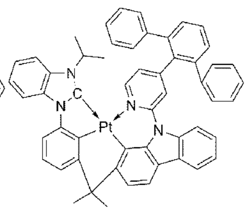
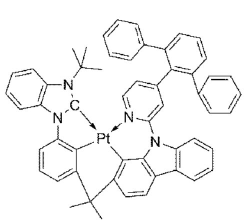
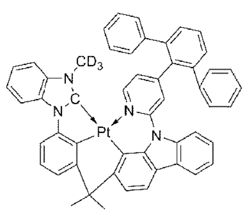
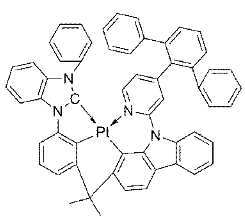

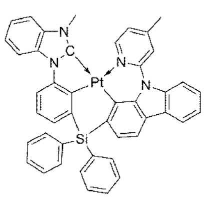
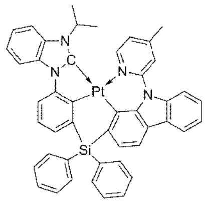
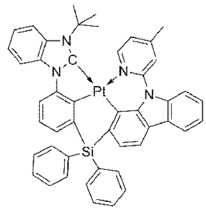
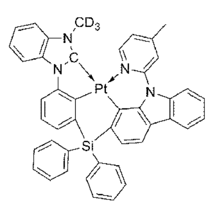
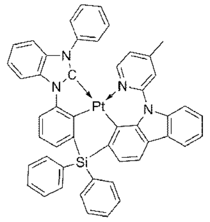
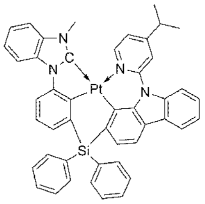
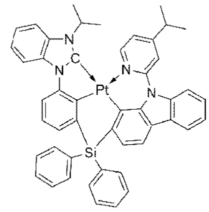
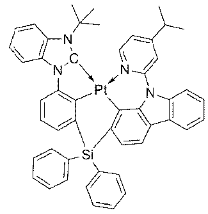
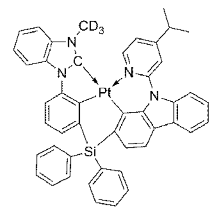
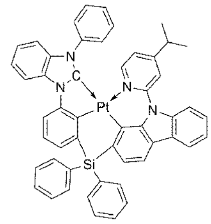
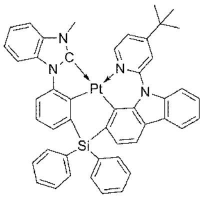
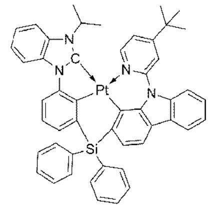
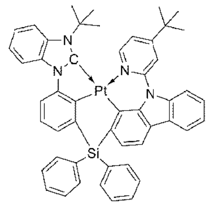
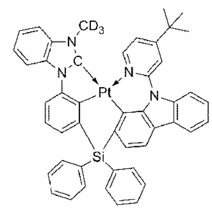
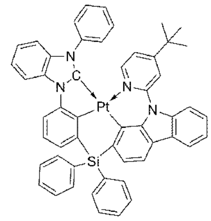
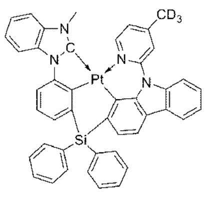
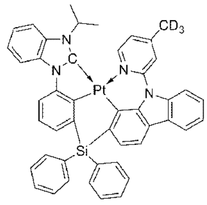
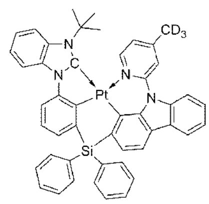
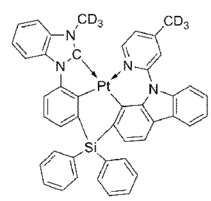
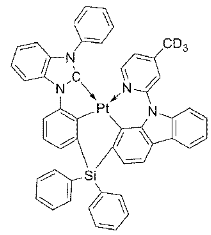
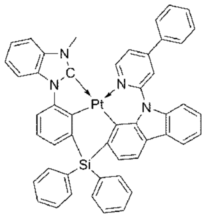
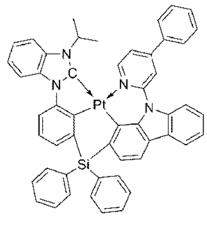
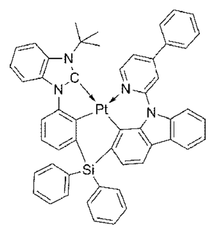
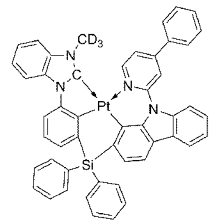
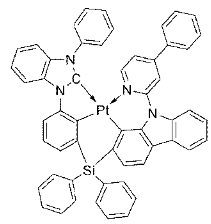
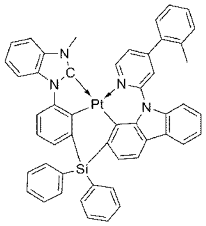
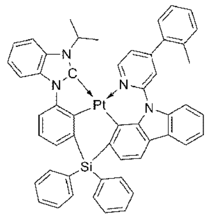
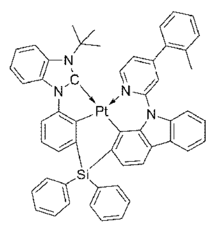
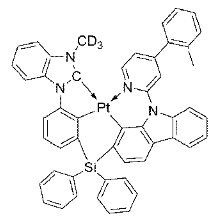
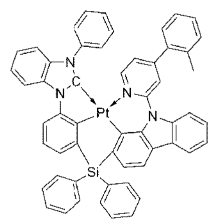

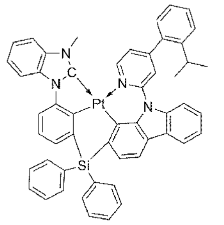
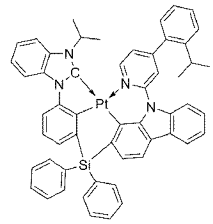
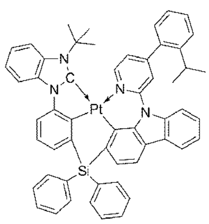
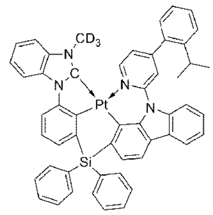
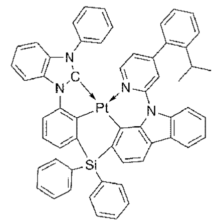

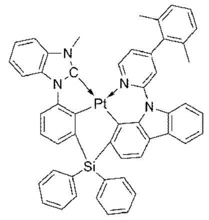
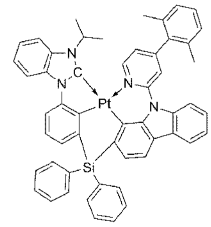
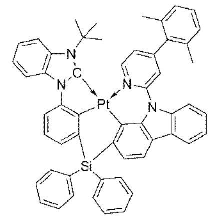
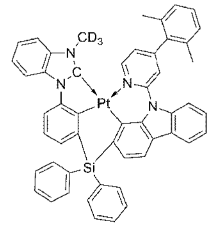
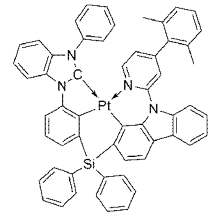

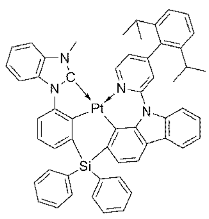
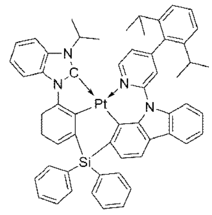
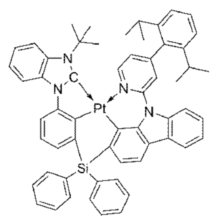
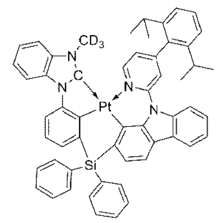
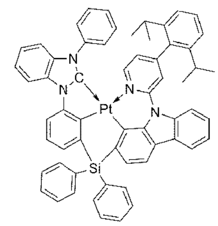

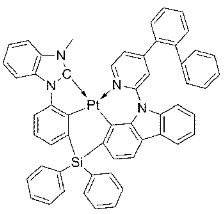
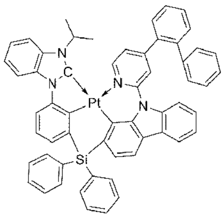
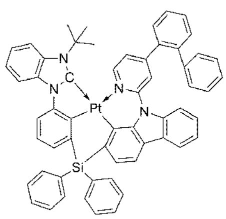
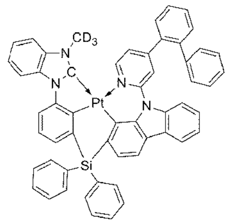
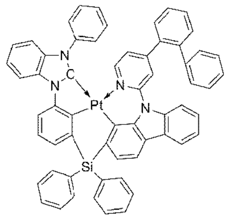

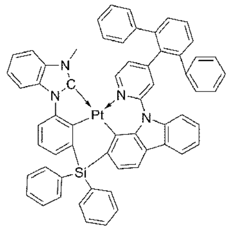
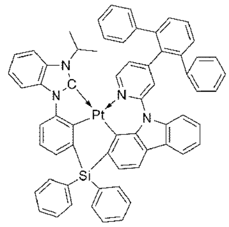
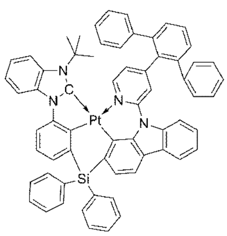
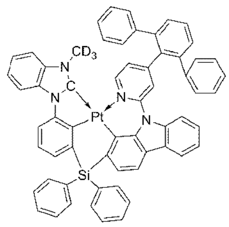
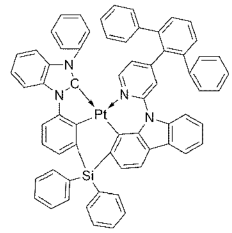

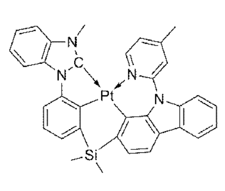 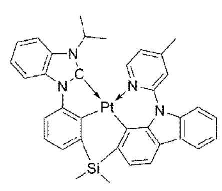 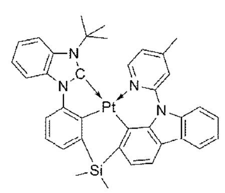 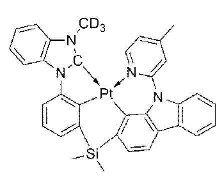 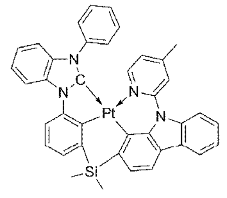

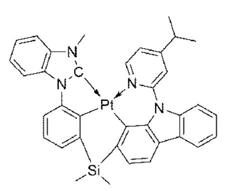 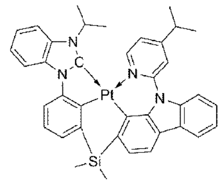 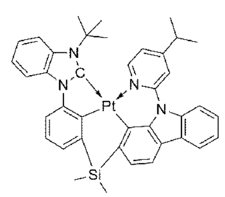 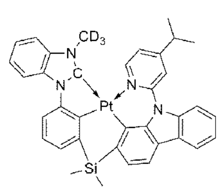 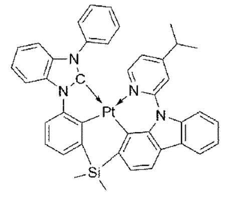

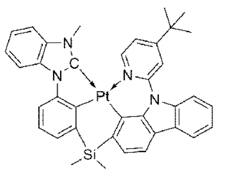 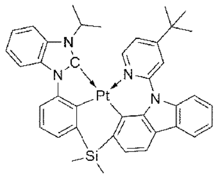 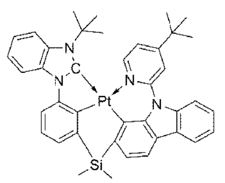 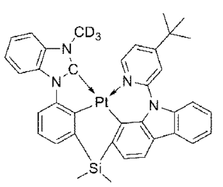 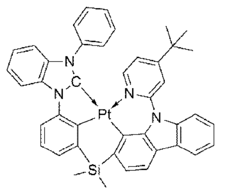

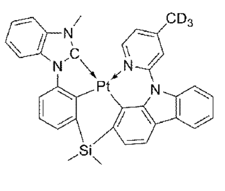 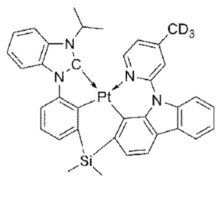 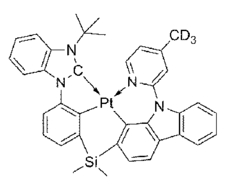 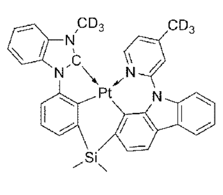 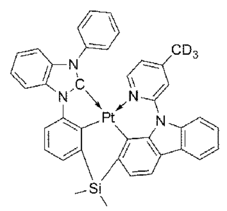

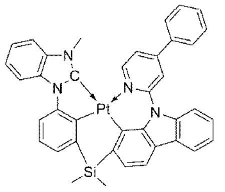 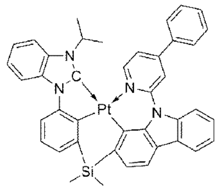 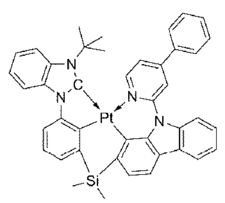 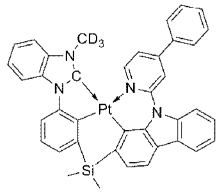 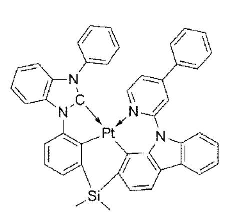

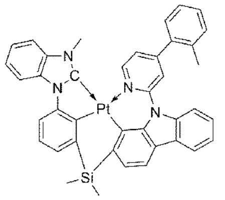 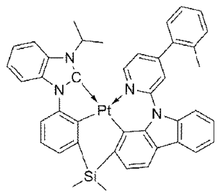 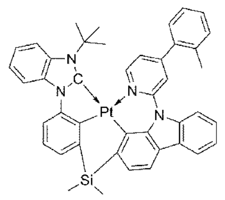 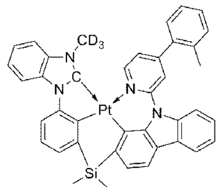 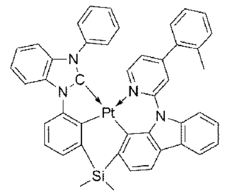

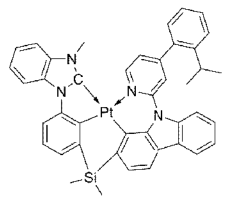 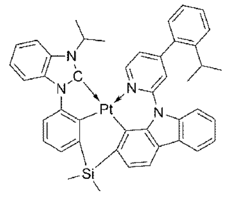 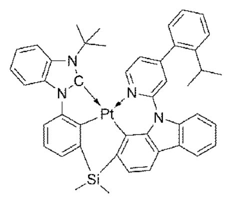 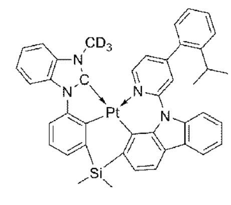 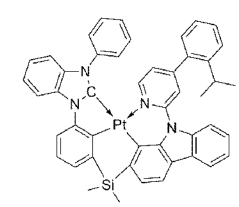

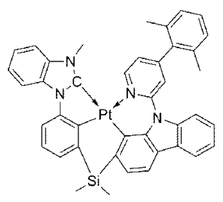 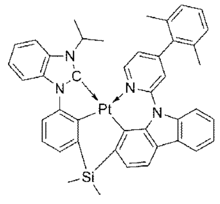 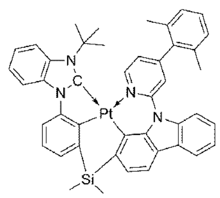 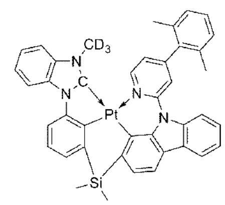 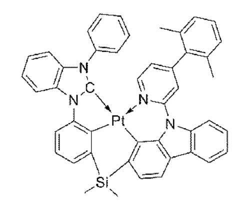

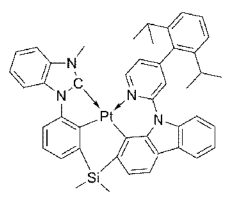 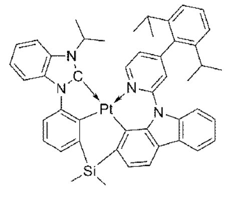 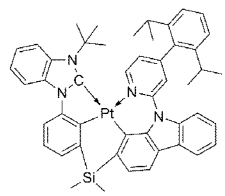 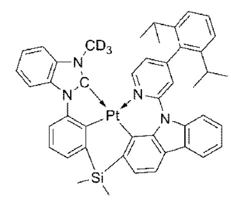 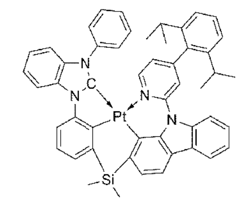

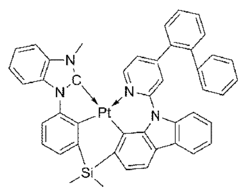 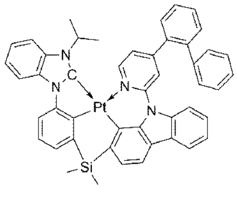 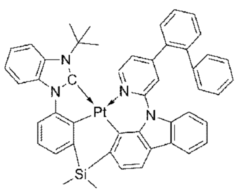 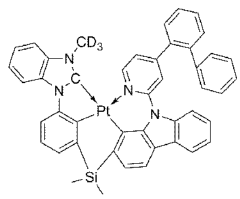 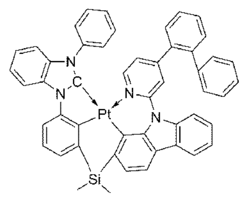

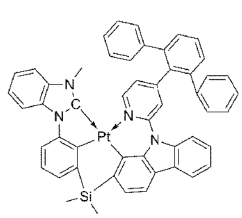 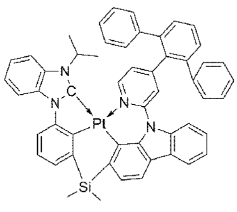 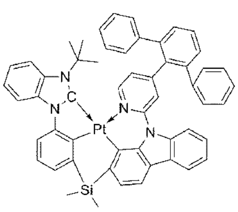 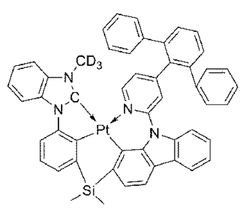 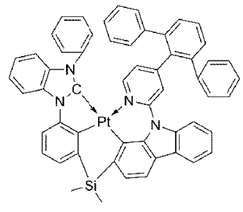

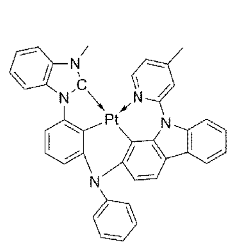
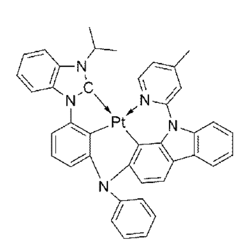
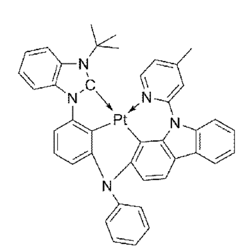
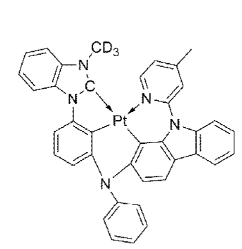
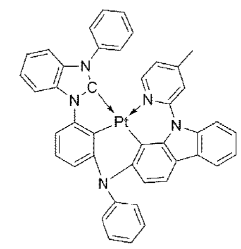
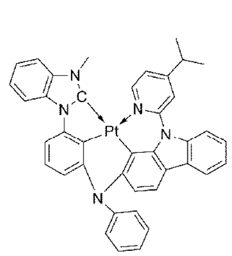
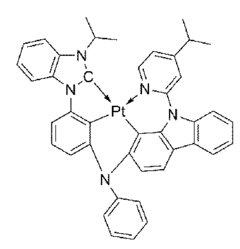
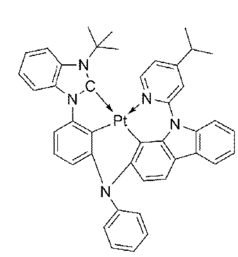
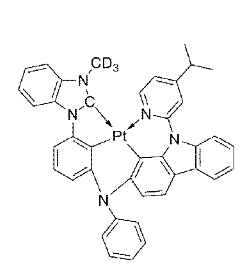
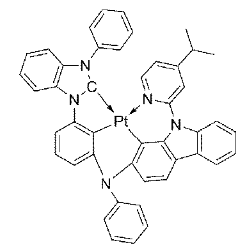
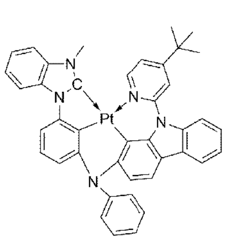
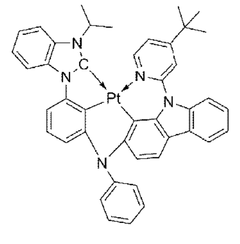
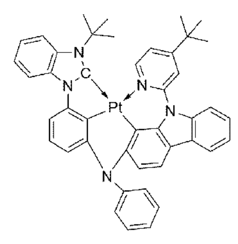
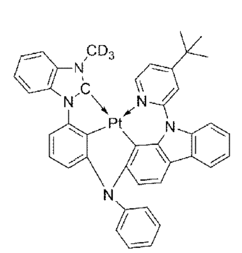
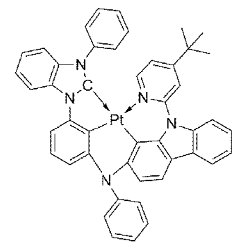
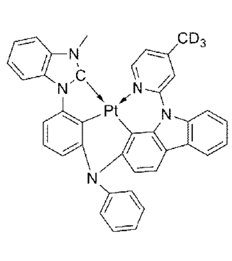
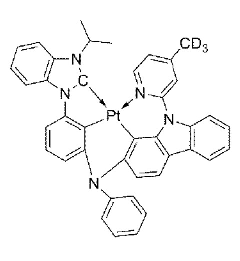
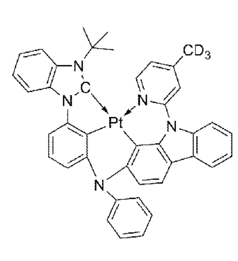
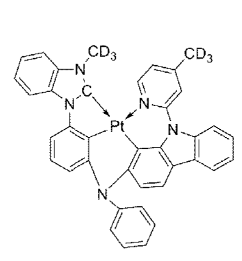
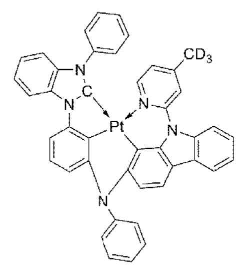
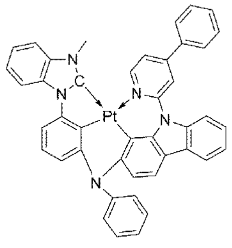
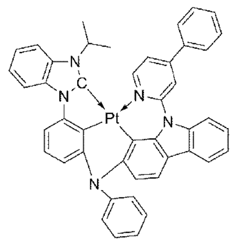
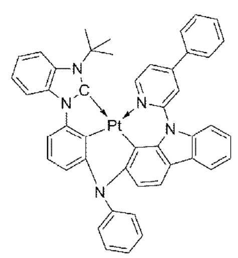
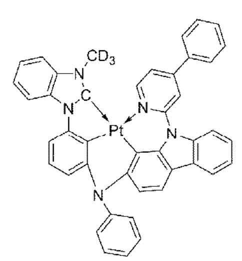
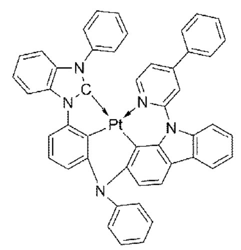
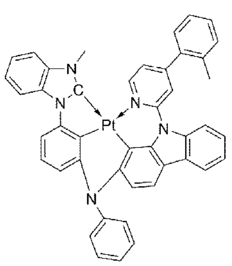
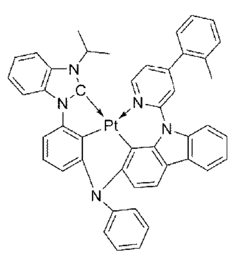
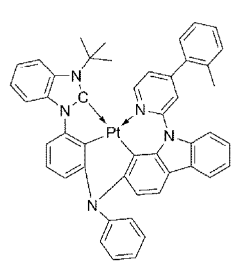
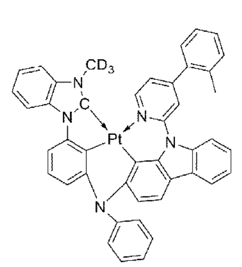
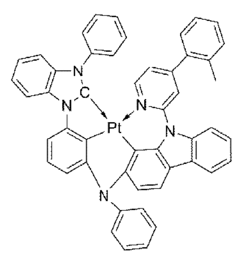

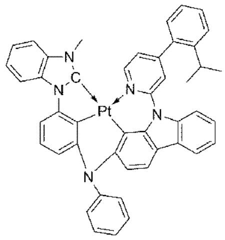
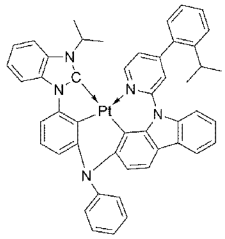
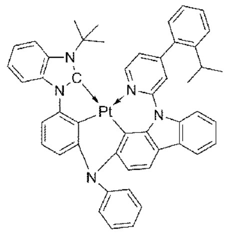
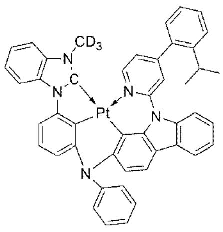
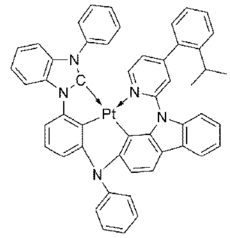
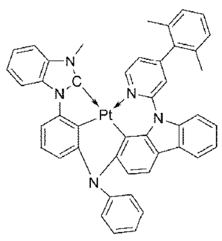
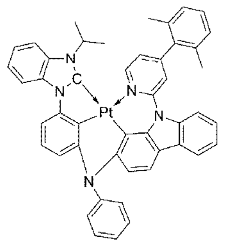
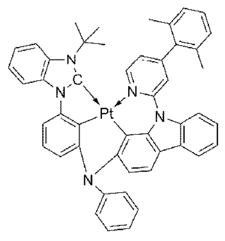
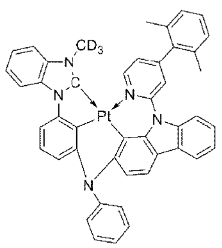
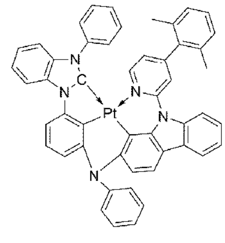
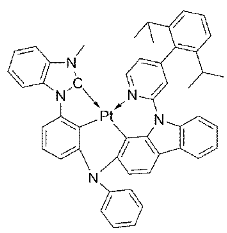
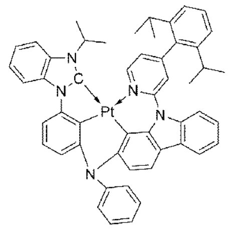
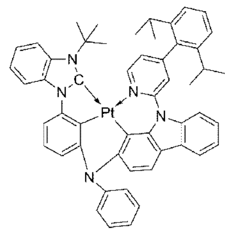
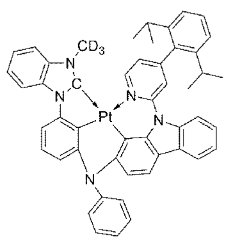
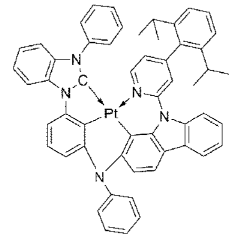
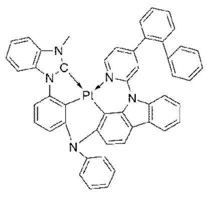
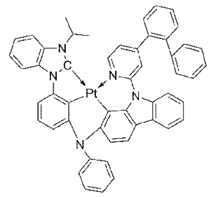
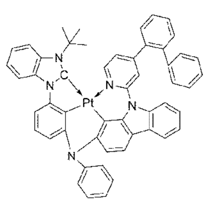
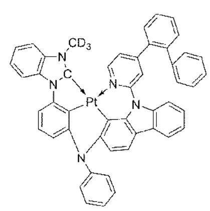
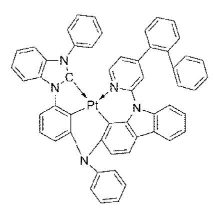
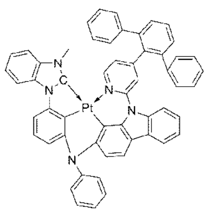
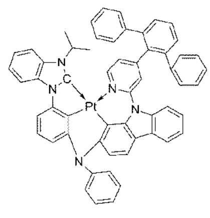
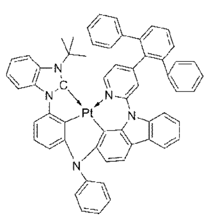
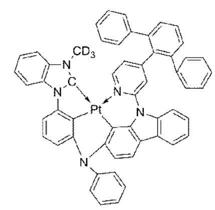
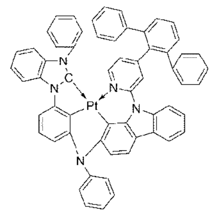

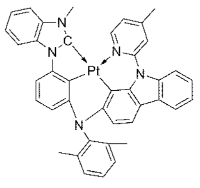
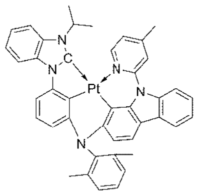
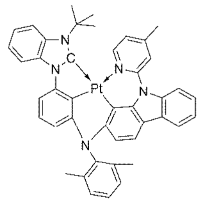
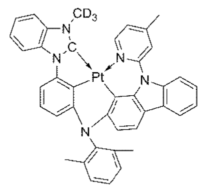
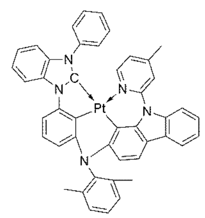

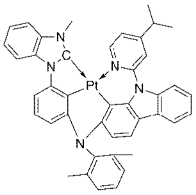
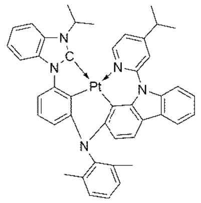
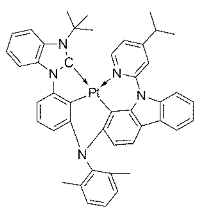
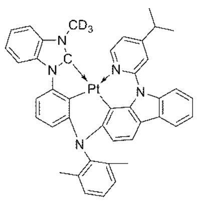
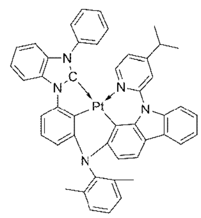

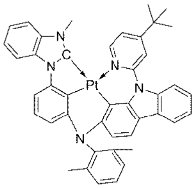
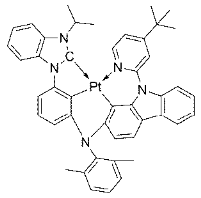
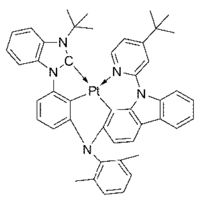
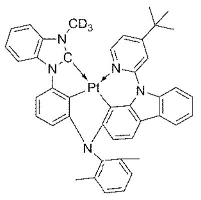
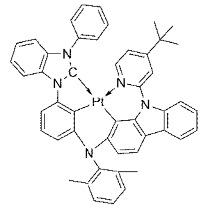

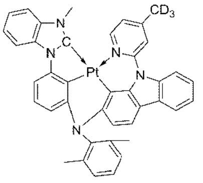
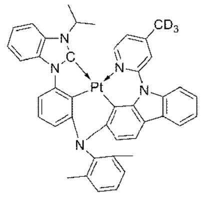
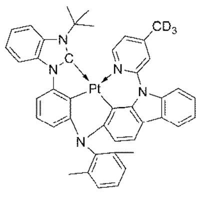
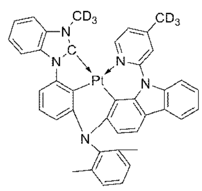
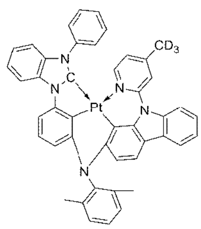

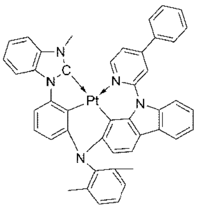
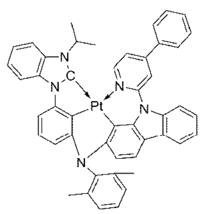
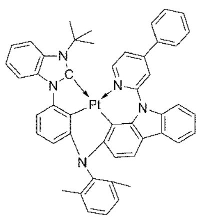
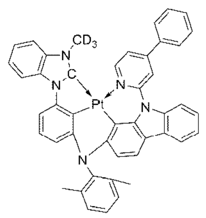
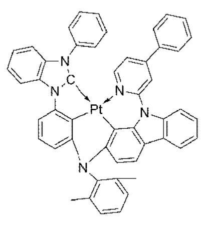

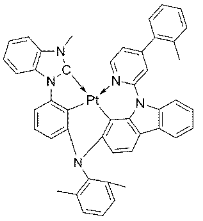
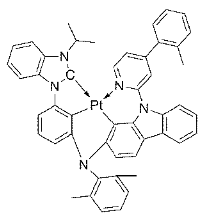
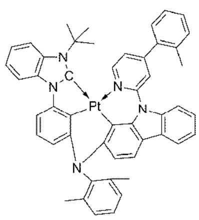
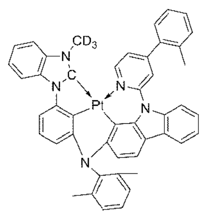
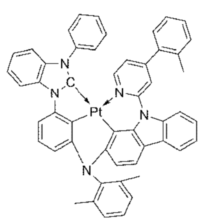

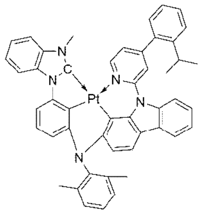 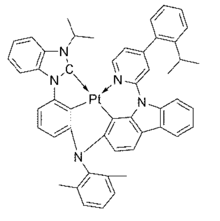 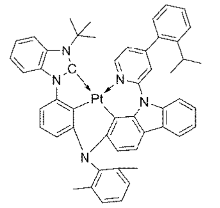 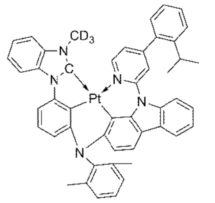 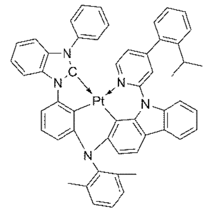

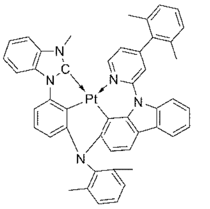 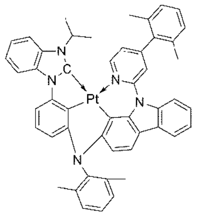 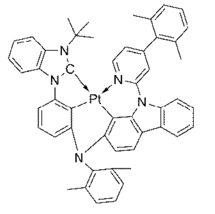 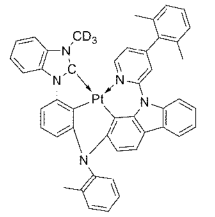 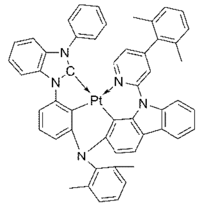

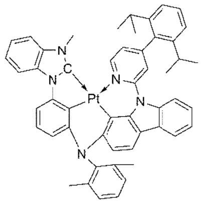 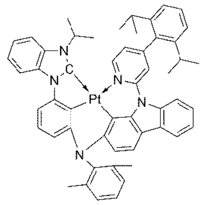 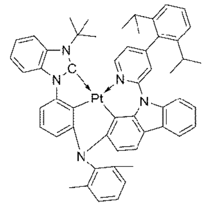 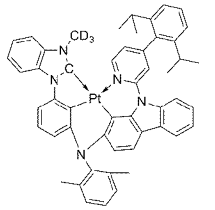 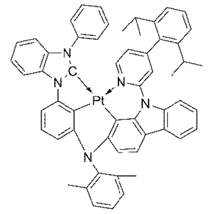

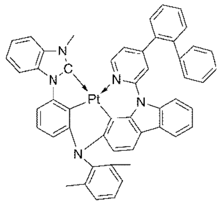 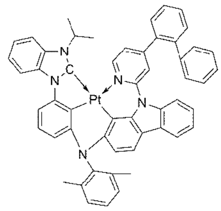 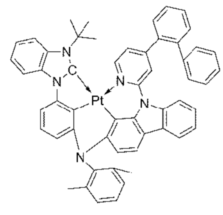 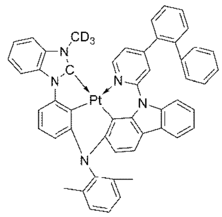 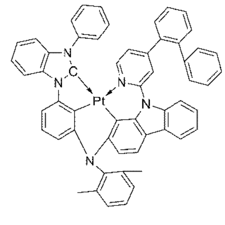

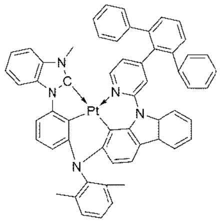 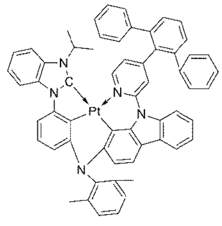 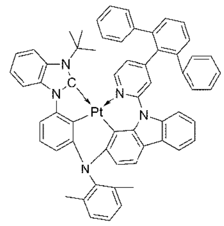 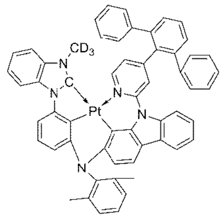 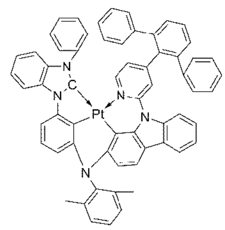

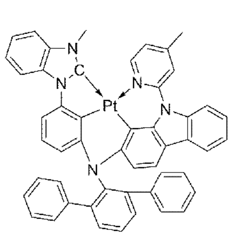
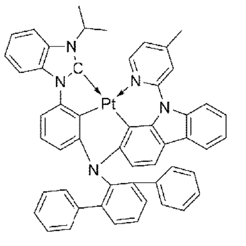
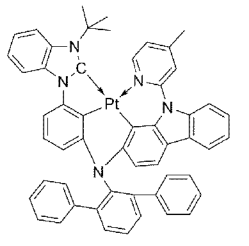
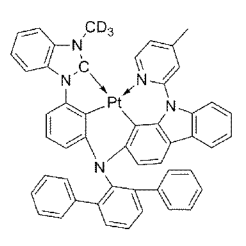
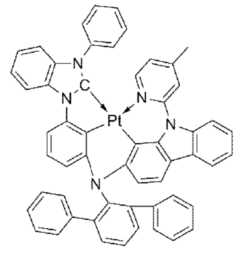

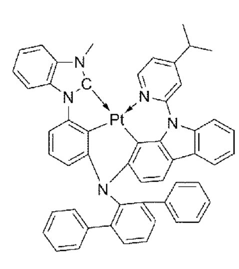
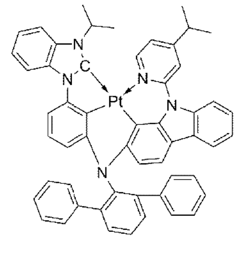
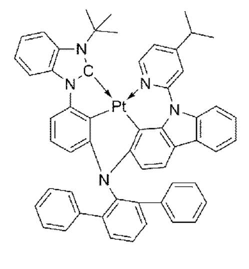
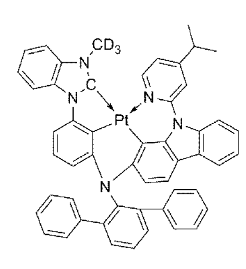
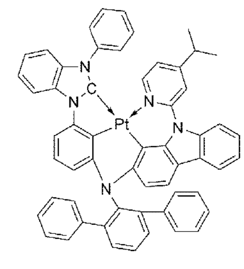

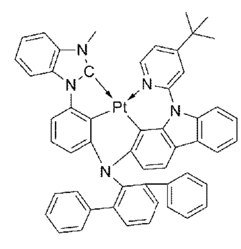
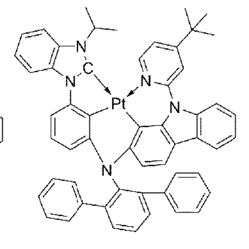
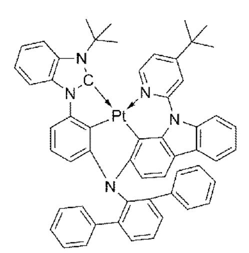
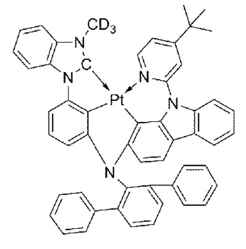
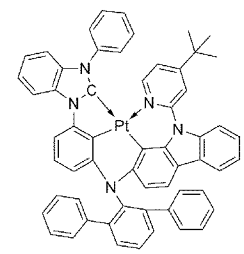

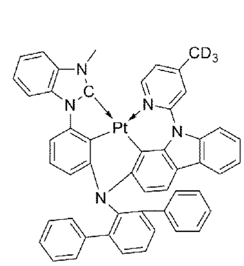
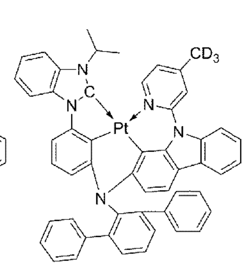
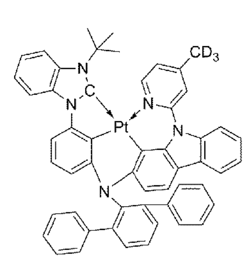
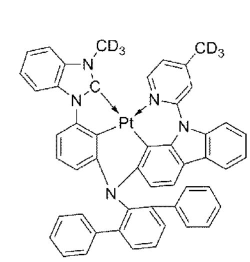
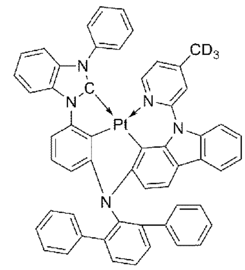

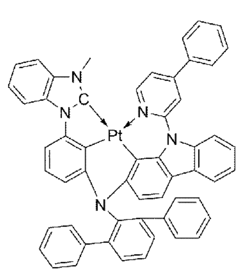
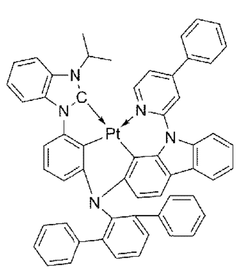
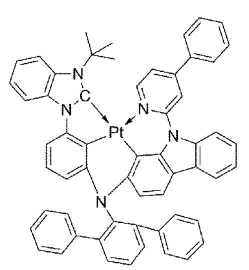
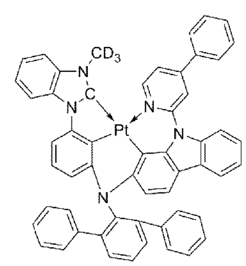
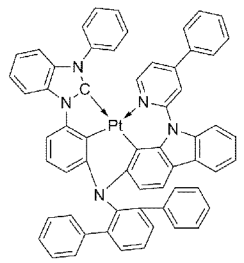

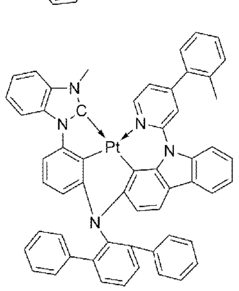
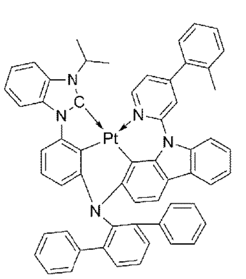
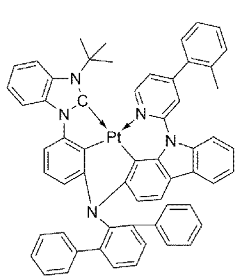
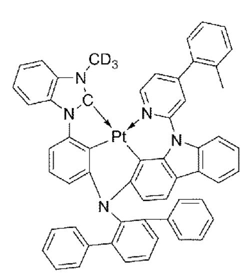
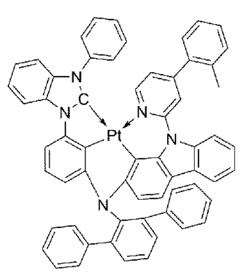

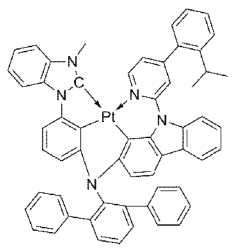
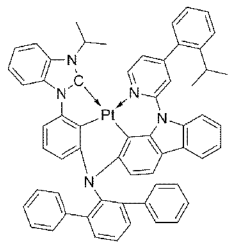
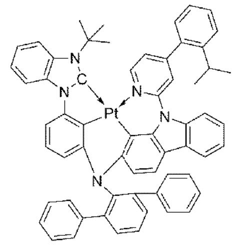
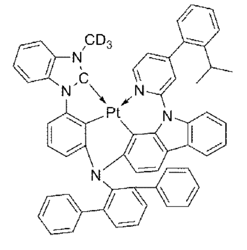
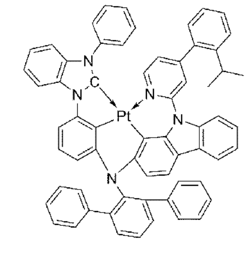
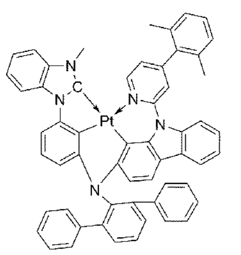
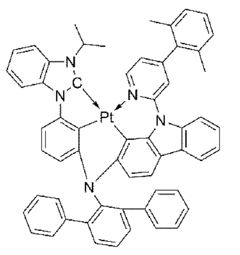
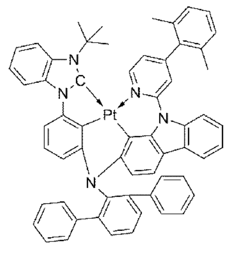
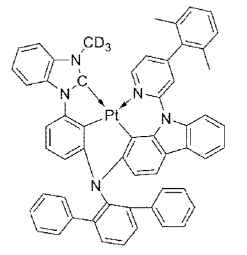
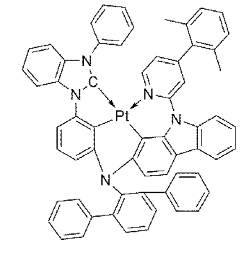
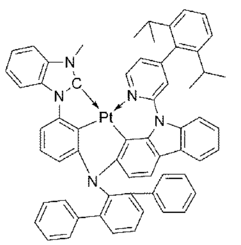
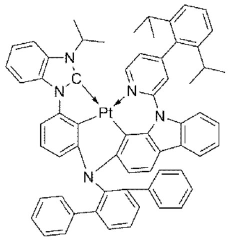
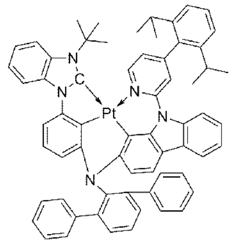
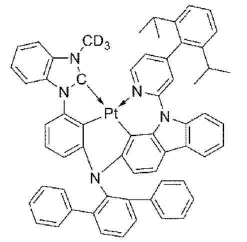
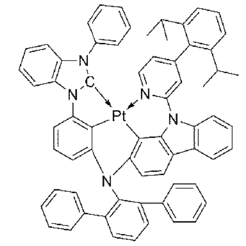
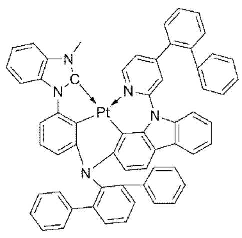
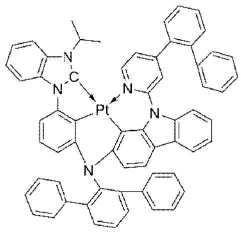
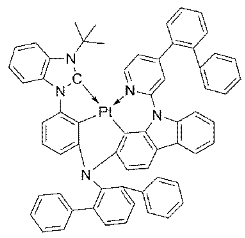
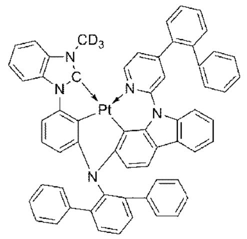
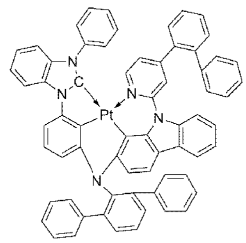
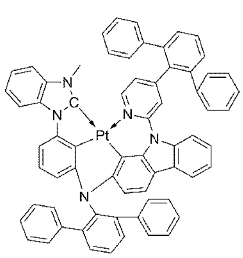
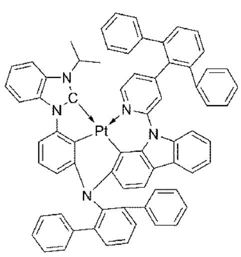
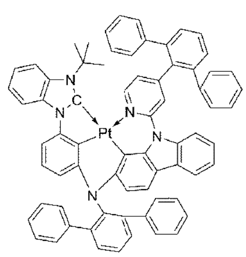
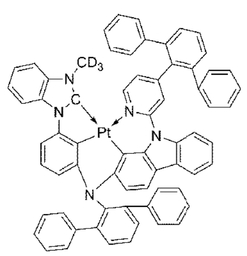
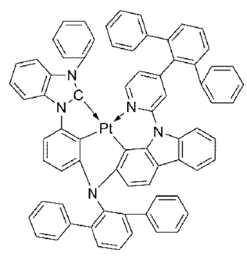

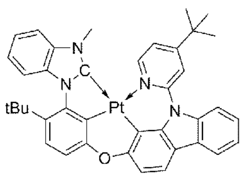 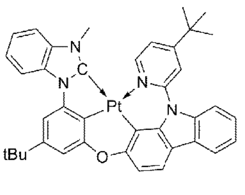 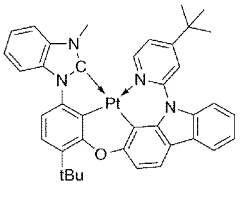 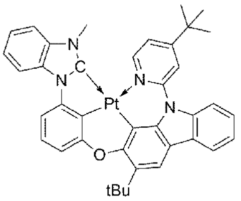 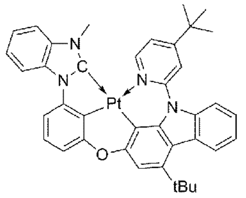

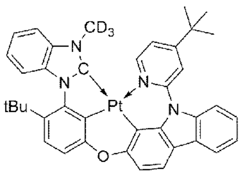 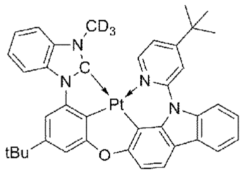 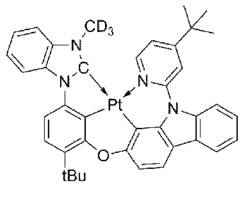 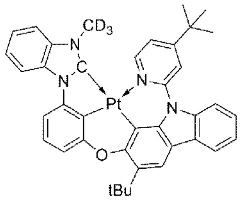 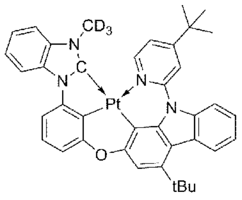

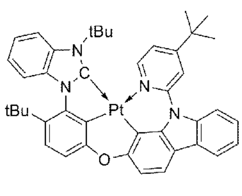 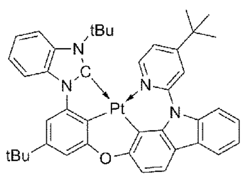 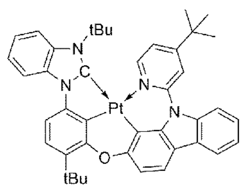 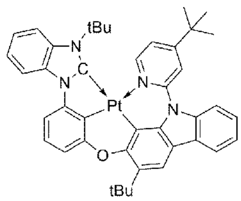 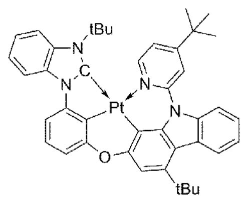

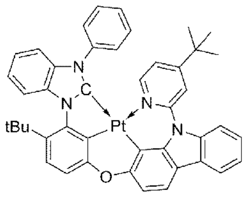 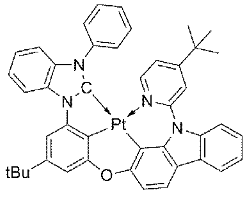 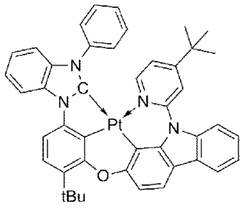 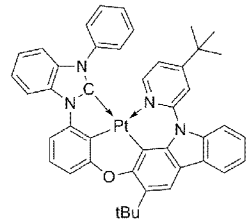 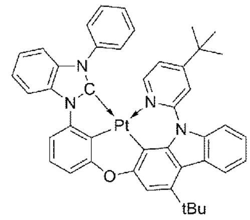

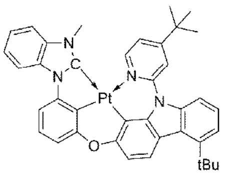 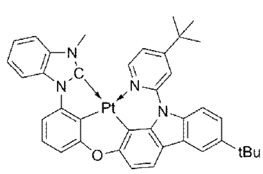 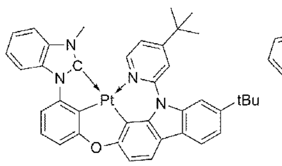 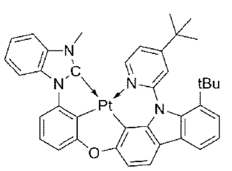 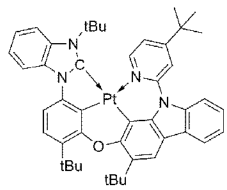

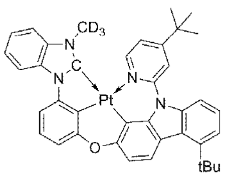 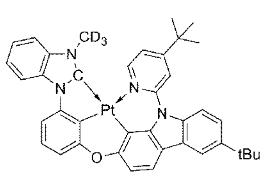 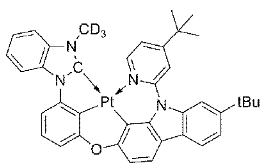 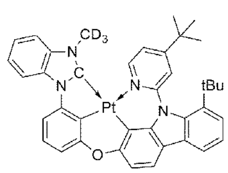 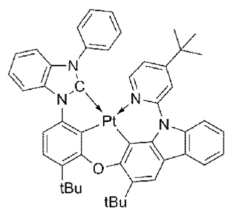

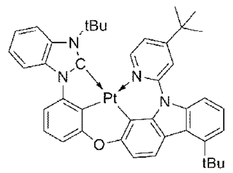 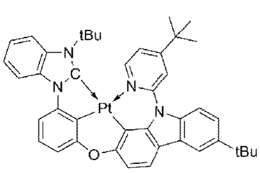 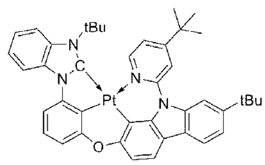 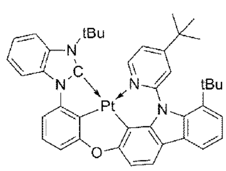 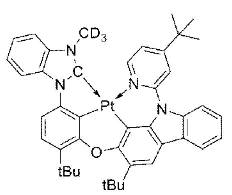

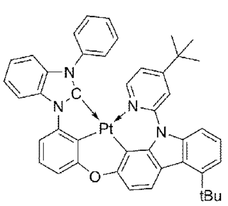 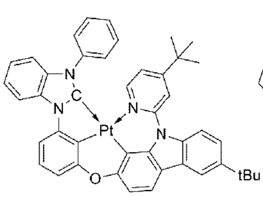 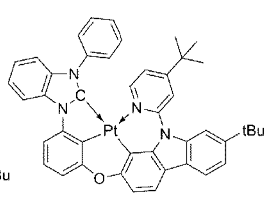 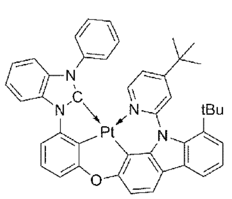 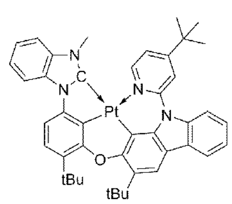

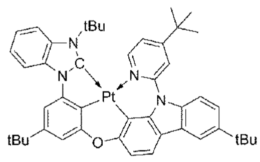
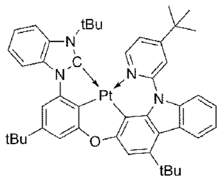
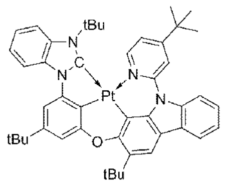
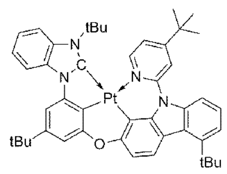
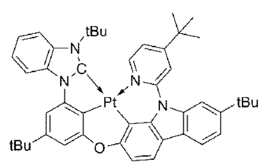

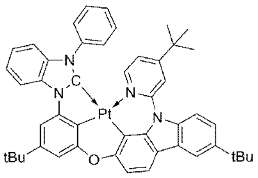
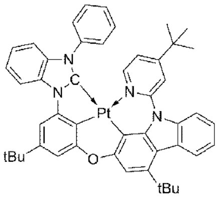
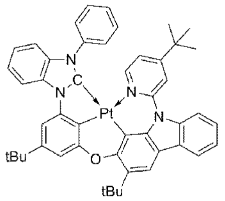
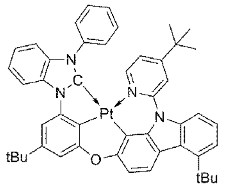
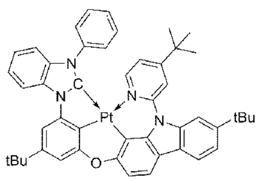

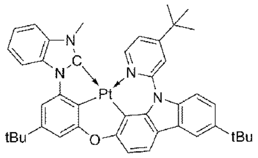
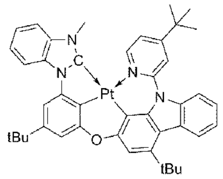
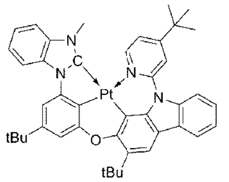
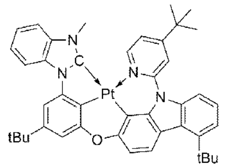
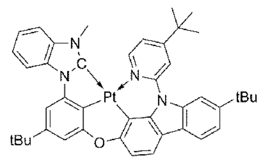

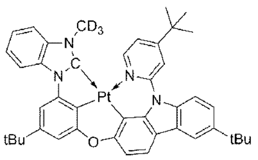
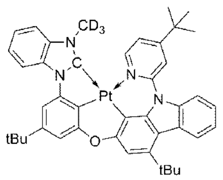
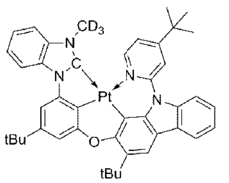
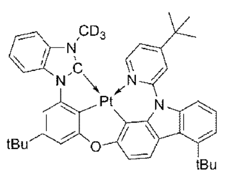
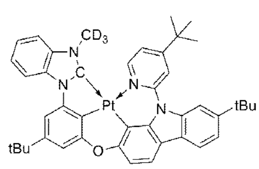

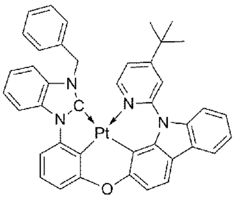
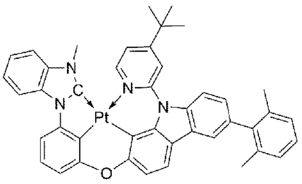
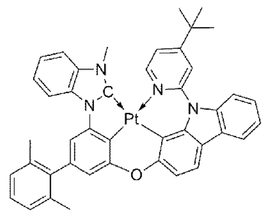
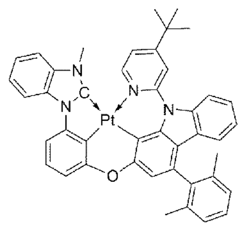

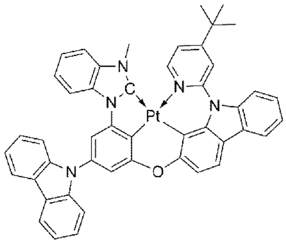
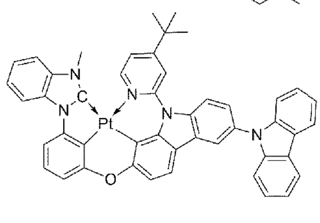

Group IV

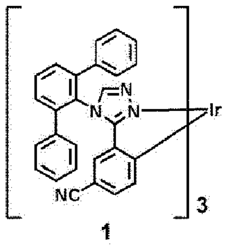
1

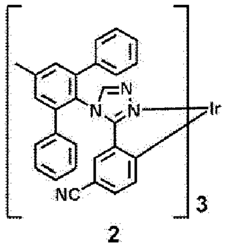
2

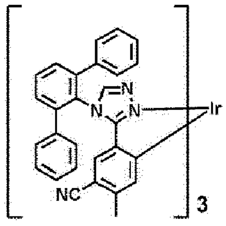
3

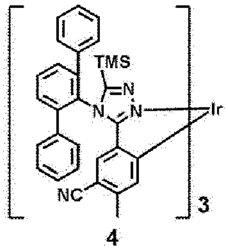
4

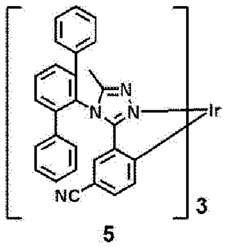
5

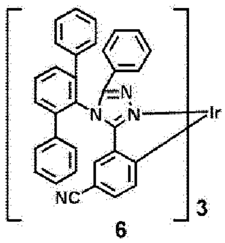
6

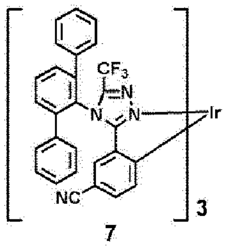
7

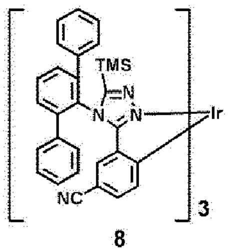
8

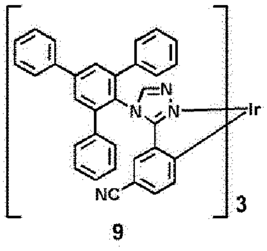
9

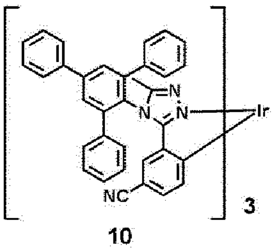
10

Group V a compound represented by Formula A below:

Formula A $(L_{101})_{n101}\text{-}M_{101}\text{-}(L_{102})_{m101}$

wherein, $L_{101}$, n101, $M_{101}$, $L_{102}$, and m101 in Formula A are as described in Tables 2 to 4 below:

Table 2

| Compound | $L_{101}$ | n101 | $M_{101}$ | $L_{102}$ | m101 | Compound | $L_{101}$ | n101 | $M_{101}$ | $L_{102}$ | m101 |
|---|---|---|---|---|---|---|---|---|---|---|---|
| BD001 | LM1 | 3 | Ir | - | 0 | BD051 | LM51 | 3 | Ir | - | 0 |
| BD002 | LM2 | 3 | Ir | - | 0 | BD052 | LM52 | 3 | Ir | - | 0 |
| BD003 | LM3 | 3 | Ir | - | 0 | BD053 | LM53 | 3 | Ir | - | 0 |
| BD004 | LM4 | 3 | Ir | - | 0 | BD054 | LM54 | 3 | Ir | - | 0 |
| BD005 | LM5 | 3 | Ir | - | 0 | BD055 | LM55 | 3 | Ir | - | 0 |
| BD006 | LM6 | 3 | Ir | - | 0 | BD056 | LM56 | 3 | Ir | - | 0 |
| BD007 | LM7 | 3 | Ir | - | 0 | BD057 | LM57 | 3 | Ir | - | 0 |
| BD008 | LM8 | 3 | Ir | - | 0 | BD058 | LM58 | 3 | Ir | - | 0 |
| BD009 | LM9 | 3 | Ir | - | 0 | BD059 | LM59 | 3 | Ir | - | 0 |
| BD010 | LM10 | 3 | Ir | - | 0 | BD060 | LM60 | 3 | Ir | - | 0 |
| BD011 | LM11 | 3 | Ir | - | 0 | BD061 | LM61 | 3 | Ir | - | 0 |
| BD012 | LM12 | 3 | Ir | - | 0 | BD062 | LM62 | 3 | Ir | - | 0 |
| BD013 | LM13 | 3 | Ir | - | 0 | BD063 | LM63 | 3 | Ir | - | 0 |

(continued)

| Compound | $L_{101}$ | n101 | $M_{101}$ | $L_{102}$ | m101 | Compound | $L_{101}$ | n101 | $M_{101}$ | $L_{102}$ | m101 |
|---|---|---|---|---|---|---|---|---|---|---|---|
| BD014 | LM14 | 3 | Ir | - | 0 | BD064 | LM64 | 3 | Ir | - | 0 |
| BD015 | LM15 | 3 | Ir | - | 0 | BD065 | LM65 | 3 | Ir | - | 0 |
| BD016 | LM16 | 3 | Ir | - | 0 | BD066 | LM66 | 3 | Ir | - | 0 |
| BD017 | LM17 | 3 | Ir | - | 0 | BD067 | LM67 | 3 | Ir | - | 0 |
| BD018 | LM18 | 3 | Ir | - | 0 | BD068 | LM68 | 3 | Ir | - | 0 |
| BD019 | LM19 | 3 | Ir | - | 0 | BD069 | LM69 | 3 | Ir | - | 0 |
| BD020 | LM20 | 3 | Ir | - | 0 | BD070 | LM70 | 3 | Ir | - | 0 |
| BD021 | LM21 | 3 | Ir | - | 0 | BD071 | LM71 | 3 | Ir | - | 0 |
| BD022 | LM22 | 3 | Ir | - | 0 | BD072 | LM72 | 3 | Ir | - | 0 |
| BD023 | LM23 | 3 | Ir | - | 0 | BD073 | LM73 | 3 | Ir | - | 0 |
| BD024 | LM24 | 3 | Ir | - | 0 | BD074 | LM74 | 3 | Ir | - | 0 |
| BD025 | LM25 | 3 | Ir | - | 0 | BD075 | LM75 | 3 | Ir | - | 0 |
| BD026 | LM26 | 3 | Ir | - | 0 | BD076 | LM76 | 3 | Ir | - | 0 |
| BD027 | LM27 | 3 | Ir | - | 0 | BD077 | LM77 | 3 | Ir | - | 0 |
| BD028 | LM28 | 3 | Ir | - | 0 | BD078 | LM78 | 3 | Ir | - | 0 |
| BD029 | LM29 | 3 | Ir | - | 0 | BD079 | LM79 | 3 | Ir | - | 0 |
| BD030 | LM30 | 3 | Ir | - | 0 | BD080 | LM80 | 3 | Ir | - | 0 |
| BD031 | LM31 | 3 | Ir | - | 0 | BD081 | LM81 | 3 | Ir | - | 0 |
| BD032 | LM32 | 3 | Ir | - | 0 | BD082 | LM82 | 3 | Ir | - | 0 |
| BD033 | LM33 | 3 | Ir | - | 0 | BD083 | LM83 | 3 | Ir | - | 0 |
| BD034 | LM34 | 3 | Ir | - | 0 | BD084 | LM84 | 3 | Ir | - | 0 |
| BD035 | LM35 | 3 | Ir | - | 0 | BD085 | LM85 | 3 | Ir | - | 0 |
| BD036 | LM36 | 3 | Ir | - | 0 | BD086 | LM86 | 3 | Ir | - | 0 |
| BD037 | LM37 | 3 | Ir | - | 0 | BD087 | LM87 | 3 | Ir | - | 0 |
| BD038 | LM38 | 3 | Ir | - | 0 | BD088 | LM88 | 3 | Ir | - | 0 |
| BD039 | LM39 | 3 | Ir | - | 0 | BD089 | LM89 | 3 | Ir | - | 0 |
| BD040 | LM40 | 3 | Ir | - | 0 | BD090 | LM90 | 3 | Ir | - | 0 |
| BD041 | LM41 | 3 | Ir | - | 0 | BD091 | LM91 | 3 | Ir | - | 0 |
| BD042 | LM42 | 3 | Ir | - | 0 | BD092 | LM92 | 3 | Ir | - | 0 |
| BD043 | LM43 | 3 | Ir | - | 0 | BD093 | LM93 | 3 | Ir | - | 0 |
| BD044 | LM44 | 3 | Ir | - | 0 | BD094 | LM94 | 3 | Ir | - | 0 |
| BD045 | LM45 | 3 | Ir | - | 0 | BD095 | LM95 | 3 | Ir | - | 0 |
| BD046 | LM46 | 3 | Ir | - | 0 | BD096 | LM96 | 3 | Ir | - | 0 |
| BD047 | LM47 | 3 | Ir | - | 0 | BD097 | LM97 | 3 | Ir | - | 0 |
| BD048 | LM48 | 3 | Ir | - | 0 | BD098 | LM98 | 3 | Ir | - | 0 |
| BD049 | LM49 | 3 | Ir | - | 0 | BD099 | LM99 | 3 | Ir | - | 0 |
| BD050 | LM50 | 3 | Ir | - | 0 | BD100 | LM100 | 3 | Ir | - | 0 |

Table 3

| Compound | $L_{101}$ | n101 | $M_{101}$ | $L_{102}$ | m101 | Compound | $L_{101}$ | n101 | $M_{101}$ | $L_{102}$ | m101 |
|---|---|---|---|---|---|---|---|---|---|---|---|
| BD101 | LM101 | 3 | Ir | - | 0 | BD151 | LM151 | 3 | Ir | - | 0 |
| BD102 | LM102 | 3 | Ir | - | 0 | BD152 | LM152 | 3 | Ir | - | 0 |
| BD103 | LM103 | 3 | Ir | - | 0 | BD153 | LM153 | 3 | Ir | - | 0 |
| BD104 | LM104 | 3 | Ir | - | 0 | BD154 | LM154 | 3 | Ir | - | 0 |
| BD105 | LM105 | 3 | Ir | - | 0 | BD155 | LM155 | 3 | Ir | - | 0 |
| BD106 | LM106 | 3 | Ir | - | 0 | BD156 | LM156 | 3 | Ir | - | 0 |
| BD107 | LM107 | 3 | Ir | - | 0 | BD157 | LM157 | 3 | Ir | - | 0 |
| BD108 | LM108 | 3 | Ir | - | 0 | BD158 | LM158 | 3 | Ir | - | 0 |
| BD109 | LM109 | 3 | Ir | - | 0 | BD159 | LM159 | 3 | Ir | - | 0 |
| BD110 | LM110 | 3 | Ir | - | 0 | BD160 | LM160 | 3 | Ir | - | 0 |
| BD111 | LM111 | 3 | Ir | - | 0 | BD161 | LM161 | 3 | Ir | - | 0 |
| BD112 | LM112 | 3 | Ir | - | 0 | BD162 | LM162 | 3 | Ir | - | 0 |
| BD113 | LM113 | 3 | Ir | - | 0 | BD163 | LM163 | 3 | Ir | - | 0 |
| BD114 | LM114 | 3 | Ir | - | 0 | BD164 | LM164 | 3 | Ir | - | 0 |
| BD115 | LM115 | 3 | Ir | - | 0 | BD165 | LM165 | 3 | Ir | - | 0 |
| BD116 | LM116 | 3 | Ir | - | 0 | BD166 | LM166 | 3 | Ir | - | 0 |
| BD117 | LM117 | 3 | Ir | - | 0 | BD167 | LM167 | 3 | Ir | - | 0 |
| BD118 | LM118 | 3 | Ir | - | 0 | BD168 | LM168 | 3 | Ir | - | 0 |
| BD119 | LM119 | 3 | Ir | - | 0 | BD169 | LM169 | 3 | Ir | - | 0 |
| BD120 | LM120 | 3 | Ir | - | 0 | BD170 | LM170 | 3 | Ir | - | 0 |
| BD121 | LM121 | 3 | Ir | - | 0 | BD171 | LM171 | 3 | Ir | - | 0 |
| BD122 | LM122 | 3 | Ir | - | 0 | BD172 | LM172 | 3 | Ir | - | 0 |
| BD123 | LM123 | 3 | Ir | - | 0 | BD173 | LM173 | 3 | Ir | - | 0 |
| BD124 | LM124 | 3 | Ir | - | 0 | BD174 | LM174 | 3 | Ir | - | 0 |
| BD125 | LM125 | 3 | Ir | - | 0 | BD175 | LM175 | 3 | Ir | - | 0 |
| BD126 | LM126 | 3 | Ir | - | 0 | BD176 | LM176 | 3 | Ir | - | 0 |
| BD127 | LM127 | 3 | Ir | - | 0 | BD177 | LM177 | 3 | Ir | - | 0 |
| BD128 | LM128 | 3 | Ir | - | 0 | BD178 | LM178 | 3 | Ir | - | 0 |
| BD129 | LM129 | 3 | Ir | - | 0 | BD179 | LM179 | 3 | Ir | - | 0 |
| BD130 | LM130 | 3 | Ir | - | 0 | BD180 | LM180 | 3 | Ir | - | 0 |
| BD131 | LM131 | 3 | Ir | - | 0 | BD181 | LM181 | 3 | Ir | - | 0 |
| BD132 | LM132 | 3 | Ir | - | 0 | BD182 | LM182 | 3 | Ir | - | 0 |
| BD133 | LM133 | 3 | Ir | - | 0 | BD183 | LM183 | 3 | Ir | - | 0 |
| BD134 | LM134 | 3 | Ir | - | 0 | BD184 | LM184 | 3 | Ir | - | 0 |
| BD135 | LM135 | 3 | Ir | - | 0 | BD185 | LM185 | 3 | Ir | - | 0 |
| BD136 | LM136 | 3 | Ir | - | 0 | BD186 | LM186 | 3 | Ir | - | 0 |
| BD137 | LM137 | 3 | Ir | - | 0 | BD187 | LM187 | 3 | Ir | - | 0 |

(continued)

| Compound | $L_{101}$ | n101 | $M_{101}$ | $L_{102}$ | m101 | Compound | $L_{101}$ | n101 | $M_{101}$ | $L_{102}$ | m101 |
|---|---|---|---|---|---|---|---|---|---|---|---|
| BD138 | LM138 | 3 | Ir | - | 0 | BD188 | LM188 | 3 | Ir | - | 0 |
| BD139 | LM139 | 3 | Ir | - | 0 | BD189 | LM189 | 3 | Ir | - | 0 |
| BD140 | LM140 | 3 | Ir | - | 0 | BD190 | LM190 | 3 | Ir | - | 0 |
| BD141 | LM141 | 3 | Ir | - | 0 | BD191 | LM191 | 3 | Ir | - | 0 |
| BD142 | LM142 | 3 | Ir | - | 0 | BD192 | LM192 | 3 | Ir | - | 0 |
| BD143 | LM143 | 3 | Ir | - | 0 | BD193 | LM193 | 3 | Ir | - | 0 |
| BD144 | LM144 | 3 | Ir | - | 0 | BD194 | LM194 | 3 | Ir | - | 0 |
| BD145 | LM145 | 3 | Ir | - | 0 | BD195 | LM195 | 3 | Ir | - | 0 |
| BD146 | LM146 | 3 | Ir | - | 0 | BD196 | LM196 | 3 | Ir | - | 0 |
| BD147 | LM147 | 3 | Ir | - | 0 | BD197 | LM197 | 3 | Ir | - | 0 |
| BD148 | LM148 | 3 | Ir | - | 0 | BD198 | LM198 | 3 | Ir | - | 0 |
| BD149 | LM149 | 3 | Ir | - | 0 | BD199 | LM199 | 3 | Ir | - | 0 |
| BD150 | LM150 | 3 | Ir | - | 0 | BD200 | LM200 | 3 | Ir | - | 0 |

Table 4

| Compound Name | $L_{101}$ | n101 | $M_{101}$ | $L_{102}$ | m101 | Compound Name | $L_{101}$ | n101 | $M_{101}$ | $L_{102}$ | m101 |
|---|---|---|---|---|---|---|---|---|---|---|---|
| BD201 | LM201 | 3 | Ir | - | 0 | BD251 | LFP1 | 3 | Ir | - | 0 |
| BD202 | LM202 | 3 | Ir | - | 0 | BD252 | LFP2 | 3 | Ir | - | 0 |
| BD203 | LM203 | 3 | Ir | - | 0 | BD253 | LFP3 | 3 | Ir | - | 0 |
| BD204 | LM204 | 3 | Ir | - | 0 | BD254 | LFP4 | 3 | Ir | - | 0 |
| BD205 | LM205 | 3 | Ir | - | 0 | BD255 | LFP5 | 3 | Ir | - | 0 |
| BD206 | LM206 | 3 | Ir | - | 0 | BD256 | LFP6 | 3 | Ir | - | 0 |
| BD207 | LM207 | 3 | Ir | - | 0 | BD257 | LFP7 | 3 | Ir | - | 0 |
| BD208 | LM208 | 3 | Ir | - | 0 | BD258 | LM47 | 2 | Ir | AN1 | 1 |
| BD209 | LM209 | 3 | Ir | - | 0 | BD259 | LM47 | 2 | Ir | AN2 | 1 |
| BD210 | LM210 | 3 | Ir | - | 0 | BD260 | LM47 | 2 | Ir | AN3 | 1 |
| BD211 | LM211 | 3 | Ir | - | 0 | BD261 | LM47 | 2 | Ir | AN4 | 1 |
| BD212 | LM212 | 3 | Ir | - | 0 | BD262 | LM47 | 2 | Ir | AN5 | 1 |
| BD213 | LM213 | 3 | Ir | - | 0 | BD263 | LM11 | 2 | Pt | - | 0 |
| BD214 | LM214 | 3 | Ir | - | 0 | BD264 | LM13 | 2 | Pt | - | 0 |
| BD215 | LM215 | 3 | Ir | - | 0 | BD265 | LM15 | 2 | Pt | - | 0 |
| BD216 | LM216 | 3 | Ir | - | 0 | BD266 | LM45 | 2 | Pt | - | 0 |
| BD217 | LM217 | 3 | Ir | - | 0 | BD267 | LM47 | 2 | Pt | - | 0 |
| BD218 | LM218 | 3 | Ir | - | 0 | BD268 | LM49 | 2 | Pt | - | 0 |
| BD219 | LM219 | 3 | Ir | - | 0 | BD269 | LM98 | 2 | Pt | - | 0 |
| BD220 | LM220 | 3 | Ir | - | 0 | BD270 | LM100 | 2 | Pt | - | 0 |
| BD221 | LM221 | 3 | Ir | - | 0 | BD271 | LM102 | 2 | Pt | - | 0 |

(continued)

| Compound Name | $L_{101}$ | n101 | $M_{101}$ | $L_{102}$ | m101 | Compound Name | $L_{101}$ | n101 | $M_{101}$ | $L_{102}$ | m101 |
|---|---|---|---|---|---|---|---|---|---|---|---|
| BD222 | LM222 | 3 | Ir | - | 0 | BD272 | LM132 | 2 | Pt | - | 0 |
| BD223 | LM223 | 3 | Ir | - | 0 | BD273 | LM134 | 2 | Pt | - | 0 |
| BD224 | LM224 | 3 | Ir | - | 0 | BD274 | LM136 | 2 | Pt | - | 0 |
| BD225 | LM225 | 3 | Ir | - | 0 | BD275 | LM151 | 2 | Pt | - | 0 |
| BD226 | LM226 | 3 | Ir | - | 0 | BD276 | LM153 | 2 | Pt | - | 0 |
| BD227 | LM227 | 3 | Ir | - | 0 | BD277 | LM158 | 2 | Pt | - | 0 |
| BD228 | LM228 | 3 | Ir | - | 0 | BD278 | LM180 | 2 | Pt | - | 0 |
| BD229 | LM229 | 3 | Ir | - | 0 | BD279 | LM182 | 2 | Pt | - | 0 |
| BD230 | LM230 | 3 | Ir | - | 0 | BD280 | LM187 | 2 | Pt | - | 0 |
| BD231 | LM231 | 3 | Ir | - | 0 | BD281 | LM201 | 2 | Pt | - | 0 |
| BD232 | LM232 | 3 | Ir | - | 0 | BD282 | LM206 | 2 | Pt | - | 0 |
| BD233 | LM233 | 3 | Ir | - | 0 | BD283 | LM211 | 2 | Pt | - | 0 |
| BD234 | LM234 | 3 | Ir | - | 0 | BD284 | LM233 | 2 | Pt | - | 0 |
| BD235 | LM235 | 3 | Ir | - | 0 | BD285 | LM235 | 2 | Pt | - | 0 |
| BD236 | LM236 | 3 | Ir | - | 0 | BD286 | LM240 | 2 | Pt | - | 0 |
| BD237 | LM237 | 3 | Ir | - | 0 | BD287 | LFM5 | 2 | Pt | - | 0 |
| BD238 | LM238 | 3 | Ir | - | 0 | BD288 | LFM6 | 2 | Pt | - | 0 |
| BD239 | LM239 | 3 | Ir | - | 0 | BD289 | LFM7 | 2 | Pt | - | 0 |
| BD240 | LM240 | 3 | Ir | - | 0 | BD290 | LFP5 | 2 | Pt | - | 0 |
| BD241 | LM241 | 3 | Ir | - | 0 | BD291 | LFP6 | 2 | Pt | - | 0 |
| BD242 | LM242 | 3 | Ir | - | 0 | BD292 | LFP7 | 2 | Pt | - | 0 |
| BD243 | LM243 | 3 | Ir | - | 0 | BD293 | LM47 | 1 | Pt | AN1 | 1 |
| BD244 | LFM1 | 3 | Ir | - | 0 | BD294 | LM47 | 1 | Pt | AN2 | 1 |
| BD245 | LFM2 | 3 | Ir | - | 0 | BD295 | LM47 | 1 | Pt | AN3 | 1 |
| BD246 | LFM3 | 3 | Ir | - | 0 | BD296 | LM47 | 1 | Pt | AN4 | 1 |
| BD247 | LFM4 | 3 | Ir | - | 0 | BD297 | LM47 | 1 | Pt | AN5 | 1 |
| BD248 | LFM5 | 3 | Ir | - | 0 | | | | | | |
| BD249 | LFM6 | 3 | Ir | - | 0 | | | | | | |
| BD250 | LFM7 | 3 | Ir | - | 0 | | | | | | |

LM1 to LM243, LFM1 to LFM7 and LFP1 to LFP7 in Tables 2 to 4 may be understood by referring to Formulae 11-1 to 11-3 and Tables 5 to 7:

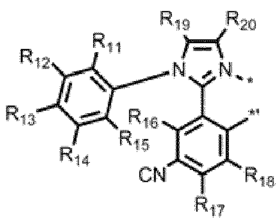

11-1

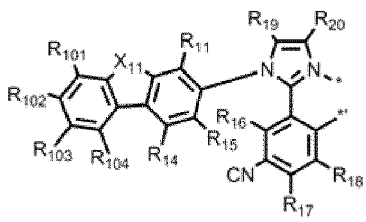

11-2

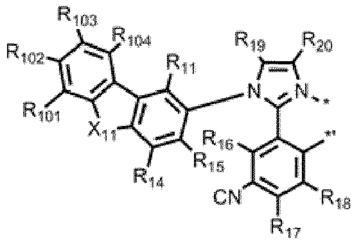

11-3

Table 5

| Formula 11-1 | | | | | | | | | | |
|---|---|---|---|---|---|---|---|---|---|---|
| Ligand name | $R_{11}$ | $R_{12}$ | $R_{13}$ | $R_{14}$ | $R_{15}$ | $R_{16}$ | $R_{17}$ | $R_{18}$ | $R_{19}$ | $R_{20}$ |
| LM1 | X1 | H | X3 | H | X1 | H | H | H | H | D |
| LM2 | X1 | H | X3 | H | X1 | H | H | H | D | H |
| LM3 | X1 | H | X3 | H | X1 | H | H | H | D | D |
| LM4 | Y1 | H | X3 | H | Y1 | H | H | H | D | D |
| LM5 | Y2 | H | X3 | H | Y2 | H | H | H | D | D |
| LM6 | Y3 | H | X3 | H | Y3 | H | H | H | D | D |
| LM7 | Y3 | D | X3 | D | Y3 | H | H | H | D | D |
| LM8 | Y3 | D | X3 | D | Y3 | D | H | H | D | D |
| LM9 | Y3 | D | X3 | D | Y3 | D | D | H | D | D |
| LM10 | Y3 | D | X3 | D | Y3 | D | D | D | D | D |
| LM11 | Y3 | D | Y11 | D | Y3 | D | D | D | D | D |
| LM12 | Y3 | D | Y11 | D | Y3 | H | X1 | H | D | D |
| LM13 | Y3 | D | Y11 | D | Y3 | D | Y3 | D | D | D |
| LM14 | Y3 | D | Y11 | D | Y3 | H | X4 | H | D | D |
| LM15 | Y3 | D | Y11 | D | Y3 | D | Y12 | D | D | D |
| LM16 | X2 | H | X3 | H | X2 | H | H | H | H | D |
| LM17 | X2 | H | X3 | H | X2 | H | H | H | D | H |
| LM18 | X2 | H | X3 | H | X2 | H | H | H | D | D |
| LM19 | Y4 | H | X3 | H | Y4 | H | H | H | D | D |
| LM20 | Y5 | H | X3 | H | Y5 | H | H | H | D | D |
| LM21 | Y6 | H | X3 | H | Y6 | H | H | H | D | D |
| LM22 | Y7 | H | X3 | H | Y7 | H | H | H | D | D |
| LM23 | Y8 | H | X3 | H | Y8 | H | H | H | D | D |
| LM24 | Y9 | H | X3 | H | Y9 | H | H | H | D | D |
| LM25 | Y10 | H | X3 | H | Y10 | H | H | H | D | D |
| LM26 | Y10 | D | X3 | D | Y10 | H | H | H | D | D |
| LM27 | Y10 | D | X3 | D | Y10 | D | H | H | D | D |
| LM28 | Y10 | D | X3 | D | Y10 | D | D | H | D | D |
| LM29 | Y10 | D | X3 | D | Y10 | D | D | D | D | D |

(continued)

| Formula 11-1 | | | | | | | | | | |
|---|---|---|---|---|---|---|---|---|---|---|
| Ligand name | $R_{11}$ | $R_{12}$ | $R_{13}$ | $R_{14}$ | $R_{15}$ | $R_{16}$ | $R_{17}$ | $R_{18}$ | $R_{19}$ | $R_{20}$ |
| LM30 | Y10 | D | Y11 | D | Y10 | D | D | D | D | D |
| LM31 | Y10 | D | Y11 | D | Y10 | H | X1 | H | D | D |
| LM32 | Y10 | D | Y11 | D | Y10 | D | Y3 | D | D | D |
| LM33 | Y10 | D | Y11 | D | Y10 | H | X4 | H | D | D |
| LM34 | Y10 | D | Y11 | D | Y10 | D | Y12 | D | D | D |
| LM35 | X1 | H | X4 | H | X1 | H | H | H | H | D |
| LM36 | X1 | H | X4 | H | X1 | H | H | H | D | H |
| LM37 | X1 | H | X4 | H | X1 | H | H | H | D | D |
| LM38 | Y1 | H | X4 | H | Y1 | H | H | H | D | D |
| LM39 | Y2 | H | X4 | H | Y2 | H | H | H | D | D |
| LM40 | Y3 | H | X4 | H | Y3 | H | H | H | D | D |
| LM41 | Y3 | D | X4 | D | Y3 | H | H | H | D | D |
| LM42 | Y3 | D | X4 | D | Y3 | D | H | H | D | D |
| LM43 | Y3 | D | X4 | D | Y3 | D | D | H | D | D |
| LM44 | Y3 | D | X4 | D | Y3 | D | D | D | D | D |
| LM45 | Y3 | D | Y12 | D | Y3 | D | D | D | D | D |
| LM46 | Y3 | D | Y12 | D | Y3 | H | X1 | H | D | D |
| LM47 | Y3 | D | Y12 | D | Y3 | D | Y3 | D | D | D |
| LM48 | Y3 | D | Y12 | D | Y3 | H | X4 | H | D | D |
| LM49 | Y3 | D | Y12 | D | Y3 | D | Y12 | D | D | D |
| LM50 | X2 | H | X4 | H | X2 | H | H | H | H | D |
| LM51 | X2 | H | X4 | H | X2 | H | H | H | D | H |
| LM52 | X2 | H | X4 | H | X2 | H | H | H | D | D |
| LM53 | Y4 | H | X4 | H | Y4 | H | H | H | D | D |
| LM54 | Y5 | H | X4 | H | Y5 | H | H | H | D | D |
| LM55 | Y6 | H | X4 | H | Y6 | H | H | H | D | D |
| LM56 | Y7 | H | X4 | H | Y7 | H | H | H | D | D |
| LM57 | Y8 | H | X4 | H | Y8 | H | H | H | D | D |
| LM58 | Y9 | H | X4 | H | Y9 | H | H | H | D | D |
| LM59 | Y10 | H | X4 | H | Y10 | H | H | H | D | D |
| LM60 | Y10 | D | X4 | D | Y10 | H | H | H | D | D |
| LM61 | Y10 | D | X4 | D | Y10 | D | H | H | D | D |
| LM62 | Y10 | D | X4 | D | Y10 | D | D | H | D | D |
| LM63 | Y10 | D | X4 | D | Y10 | D | D | D | D | D |
| LM64 | Y10 | D | Y12 | D | Y10 | D | D | D | D | D |
| LM65 | Y10 | D | Y12 | D | Y10 | H | X1 | H | D | D |
| LM66 | Y10 | D | Y12 | D | Y10 | D | Y3 | D | D | D |

(continued)

| Formula 11-1 | | | | | | | | | | |
|---|---|---|---|---|---|---|---|---|---|---|
| Ligand name | $R_{11}$ | $R_{12}$ | $R_{13}$ | $R_{14}$ | $R_{15}$ | $R_{16}$ | $R_{17}$ | $R_{18}$ | $R_{19}$ | $R_{20}$ |
| LM67 | Y10 | D | Y12 | D | Y10 | H | X4 | H | D | D |
| LM68 | Y10 | D | Y12 | D | Y10 | D | Y12 | D | D | D |
| LM69 | X1 | H | X5 | H | X1 | H | H | H | H | D |
| LM70 | X1 | H | X5 | H | X1 | H | H | H | D | H |
| LM71 | X1 | H | X5 | H | X1 | H | H | H | D | D |
| LM72 | Y1 | H | X5 | H | Y1 | H | H | H | D | D |
| LM73 | Y2 | H | X5 | H | Y2 | H | H | H | D | D |
| LM74 | Y3 | H | X5 | H | Y3 | H | H | H | D | D |
| LM75 | Y3 | D | X5 | D | Y3 | H | H | H | D | D |
| LM76 | Y3 | D | X5 | D | Y3 | D | H | H | D | D |
| LM77 | Y3 | D | X5 | D | Y3 | D | D | H | D | D |
| LM78 | Y3 | D | X5 | D | Y3 | D | D | D | D | D |
| LM79 | Y3 | D | Y13 | D | Y3 | D | D | D | D | D |
| LM80 | Y3 | D | Y13 | D | Y3 | H | X1 | H | D | D |
| LM81 | Y3 | D | Y13 | D | Y3 | D | Y3 | D | D | D |
| LM82 | Y3 | D | Y13 | D | Y3 | H | X4 | H | D | D |
| LM83 | Y3 | D | Y13 | D | Y3 | D | Y12 | D | D | D |
| LM84 | X2 | H | X5 | H | X2 | H | H | H | H | D |
| LM85 | X2 | H | X5 | H | X2 | H | H | H | D | H |
| LM86 | X2 | H | X5 | H | X2 | H | H | H | D | D |
| LM87 | Y4 | H | X5 | H | Y4 | H | H | H | D | D |
| LM88 | Y5 | H | X5 | H | Y5 | H | H | H | D | D |
| LM89 | Y6 | H | X5 | H | Y6 | H | H | H | D | D |
| LM90 | Y7 | H | X5 | H | Y7 | H | H | H | D | D |
| LM91 | Y8 | H | X5 | H | Y8 | H | H | H | D | D |
| LM92 | Y9 | H | X5 | H | Y9 | H | H | H | D | D |
| LM93 | Y10 | H | X5 | H | Y10 | H | H | H | D | D |
| LM94 | Y10 | D | X5 | D | Y10 | H | H | H | D | D |
| LM95 | Y10 | D | X5 | D | Y10 | D | H | H | D | D |
| LM96 | Y10 | D | X5 | D | Y10 | D | D | H | D | D |
| LM97 | Y10 | D | X5 | D | Y10 | D | D | D | D | D |
| LM98 | Y10 | D | Y13 | D | Y10 | D | D | D | D | D |
| LM99 | Y10 | D | Y13 | D | Y10 | H | X1 | H | D | D |
| LM100 | Y10 | D | Y13 | D | Y10 | D | Y3 | D | D | D |
| LM101 | Y10 | D | Y13 | D | Y10 | H | X4 | H | D | D |
| LM102 | Y10 | D | Y13 | D | Y10 | D | Y12 | D | D | D |
| LM103 | X1 | H | X6 | H | X1 | H | H | H | H | D |

(continued)

| Formula 11-1 | | | | | | | | | | |
|---|---|---|---|---|---|---|---|---|---|---|
| Ligand name | $R_{11}$ | $R_{12}$ | $R_{13}$ | $R_{14}$ | $R_{15}$ | $R_{16}$ | $R_{17}$ | $R_{18}$ | $R_{19}$ | $R_{20}$ |
| LM104 | X1 | H | X6 | H | X1 | H | H | H | D | H |
| LM105 | X1 | H | X6 | H | X1 | H | H | H | D | D |
| LM106 | Y1 | H | X6 | H | Y1 | H | H | H | D | D |
| LM107 | Y2 | H | X6 | H | Y2 | H | H | H | D | D |
| LM108 | Y3 | H | X6 | H | Y3 | H | H | H | D | D |
| LM109 | Y3 | D | X6 | D | Y3 | H | H | H | D | D |
| LM110 | Y3 | D | X6 | D | Y3 | D | H | H | D | D |
| LM111 | Y3 | D | X6 | D | Y3 | D | D | H | D | D |
| LM112 | Y3 | D | X6 | D | Y3 | D | D | D | D | D |
| LM113 | Y3 | D | Y14 | D | Y3 | D | D | D | D | D |
| LM114 | Y3 | D | Y14 | D | Y3 | H | X1 | H | D | D |
| LM115 | Y3 | D | Y14 | D | Y3 | D | Y3 | D | D | D |
| LM116 | Y3 | D | Y14 | D | Y3 | H | X4 | H | D | D |
| LM117 | Y3 | D | Y14 | D | Y3 | D | Y12 | D | D | D |
| LM118 | X2 | H | X6 | H | X2 | H | H | H | H | D |
| LM119 | X2 | H | X6 | H | X2 | H | H | H | D | H |
| LM120 | X2 | H | X6 | H | X2 | H | H | H | D | D |
| LM121 | Y4 | H | X6 | H | Y4 | H | H | H | D | D |
| LM122 | Y5 | H | X6 | H | Y5 | H | H | H | D | D |
| LM123 | Y6 | H | X6 | H | Y6 | H | H | H | D | D |
| LM124 | Y7 | H | X6 | H | Y7 | H | H | H | D | D |
| LM125 | Y8 | H | X6 | H | Y8 | H | H | H | D | D |
| LM126 | Y9 | H | X6 | H | Y9 | H | H | H | D | D |
| LM127 | Y10 | H | X6 | H | Y10 | H | H | H | D | D |
| LM128 | Y10 | D | X6 | D | Y10 | H | H | H | D | D |
| LM129 | Y10 | D | X6 | D | Y10 | D | H | H | D | D |
| LM130 | Y10 | D | X6 | D | Y10 | D | D | H | D | D |
| LM131 | Y10 | D | X6 | D | Y10 | D | D | D | D | D |
| LM132 | Y10 | D | Y14 | D | Y10 | D | D | D | D | D |
| LM133 | Y10 | D | Y14 | D | Y10 | H | X1 | H | D | D |
| LM134 | Y10 | D | Y14 | D | Y10 | D | Y3 | D | D | D |
| LM135 | Y10 | D | Y14 | D | Y10 | H | X4 | H | D | D |
| LM136 | Y10 | D | Y14 | D | Y10 | D | Y12 | D | D | D |
| LM137 | X1 | H | X7 | H | X1 | H | H | H | H | D |
| LM138 | X1 | H | X7 | H | X1 | H | H | H | D | H |
| LM139 | X1 | H | X7 | H | X1 | H | H | H | D | D |
| LM140 | Y1 | H | X7 | H | Y1 | H | H | H | D | D |

(continued)

| Formula 11-1 | | | | | | | | | | |
|---|---|---|---|---|---|---|---|---|---|---|
| Ligand name | $R_{11}$ | $R_{12}$ | $R_{13}$ | $R_{14}$ | $R_{15}$ | $R_{16}$ | $R_{17}$ | $R_{18}$ | $R_{19}$ | $R_{20}$ |
| LM141 | Y2 | H | X7 | H | Y2 | H | H | H | D | D |
| LM142 | Y3 | H | X7 | H | Y3 | H | H | H | D | D |
| LM143 | Y3 | D | X7 | D | Y3 | H | H | H | D | D |
| LM144 | Y3 | D | X7 | D | Y3 | D | H | H | D | D |
| LM145 | Y3 | D | X7 | D | Y3 | D | D | H | D | D |
| LM146 | Y3 | D | X7 | D | Y3 | D | D | D | D | D |
| LM147 | Y3 | D | X8 | D | Y3 | D | D | D | D | D |
| LM148 | Y3 | D | Y16 | D | Y3 | D | D | D | D | D |
| LM149 | Y3 | D | Y17 | D | Y3 | D | D | D | D | D |
| LM150 | Y3 | D | Y18 | D | Y3 | D | D | D | D | D |
| LM151 | Y3 | D | Y15 | D | Y3 | D | D | D | D | D |
| LM152 | Y3 | D | Y15 | D | Y3 | H | X1 | H | D | D |
| LM153 | Y3 | D | Y15 | D | Y3 | D | Y3 | D | D | D |
| LM154 | Y3 | D | Y16 | D | Y3 | D | Y3 | D | D | D |
| LM155 | Y3 | D | Y17 | D | Y3 | D | Y3 | D | D | D |
| LM156 | Y3 | D | Y18 | D | Y3 | D | Y3 | D | D | D |
| LM157 | Y3 | D | Y15 | D | Y3 | H | X4 | H | D | D |
| LM158 | Y3 | D | Y15 | D | Y3 | D | Y12 | D | D | D |
| LM159 | Y3 | D | Y16 | D | Y3 | D | Y12 | D | D | D |
| LM160 | Y3 | D | Y17 | D | Y3 | D | Y12 | D | D | D |
| LM161 | Y3 | D | Y18 | D | Y3 | D | Y12 | D | D | D |
| LM162 | X2 | H | X7 | H | X2 | H | H | H | H | D |
| LM163 | X2 | H | X7 | H | X2 | H | H | H | D | H |
| LM164 | X2 | H | X7 | H | X2 | H | H | H | D | D |
| LM165 | Y4 | H | X7 | H | Y4 | H | H | H | D | D |
| LM166 | Y5 | H | X7 | H | Y5 | H | H | H | D | D |
| LM167 | Y6 | H | X7 | H | Y6 | H | H | H | D | D |
| LM168 | Y7 | H | X7 | H | Y7 | H | H | H | D | D |
| LM169 | Y8 | H | X7 | H | Y8 | H | H | H | D | D |
| LM170 | Y9 | H | X7 | H | Y9 | H | H | H | D | D |
| LM171 | Y10 | H | X7 | H | Y10 | H | H | H | D | D |
| LM172 | Y10 | D | X7 | D | Y10 | H | H | H | D | D |
| LM173 | Y10 | D | X7 | D | Y10 | D | H | H | D | D |
| LM174 | Y10 | D | X7 | D | Y10 | D | D | H | D | D |
| LM175 | Y10 | D | X7 | D | Y10 | D | D | D | D | D |
| LM176 | Y10 | D | X8 | D | Y10 | D | D | D | D | D |
| LM177 | Y10 | D | Y16 | D | Y10 | D | D | D | D | D |

(continued)

| Formula 11-1 | | | | | | | | | | |
|---|---|---|---|---|---|---|---|---|---|---|
| Ligand name | $R_{11}$ | $R_{12}$ | $R_{13}$ | $R_{14}$ | $R_{15}$ | $R_{16}$ | $R_{17}$ | $R_{18}$ | $R_{19}$ | $R_{20}$ |
| LM178 | Y10 | D | Y17 | D | Y10 | D | D | D | D | D |
| LM179 | Y10 | D | Y18 | D | Y10 | D | D | D | D | D |
| LM180 | Y10 | D | Y15 | D | Y10 | D | D | D | D | D |
| LM181 | Y10 | D | Y15 | D | Y10 | H | X1 | H | D | D |
| LM182 | Y10 | D | Y15 | D | Y10 | D | Y3 | D | D | D |
| LM183 | Y10 | D | Y16 | D | Y10 | D | Y3 | D | D | D |
| LM184 | Y10 | D | Y17 | D | Y10 | D | Y3 | D | D | D |
| LM185 | Y10 | D | Y18 | D | Y10 | D | Y3 | D | D | D |
| LM186 | Y10 | D | Y15 | D | Y10 | H | X4 | H | D | D |
| LM187 | Y10 | D | Y15 | D | Y10 | D | Y12 | D | D | D |
| LM188 | Y10 | D | Y16 | D | Y10 | D | Y12 | D | D | D |
| LM189 | Y10 | D | Y17 | D | Y10 | D | Y12 | D | D | D |
| LM190 | Y10 | D | Y18 | D | Y10 | D | Y12 | D | D | D |
| LM191 | X1 | X7 | H | H | X1 | H | H | H | H | D |
| LM192 | X1 | X7 | H | H | X1 | H | H | H | D | H |
| LM193 | X1 | X7 | H | H | X1 | H | H | H | D | D |
| LM194 | Y1 | X7 | H | H | Y1 | H | H | H | D | D |
| LM195 | Y2 | X7 | H | H | Y2 | H | H | H | D | D |
| LM196 | Y3 | X7 | H | H | Y3 | H | H | H | D | D |
| LM197 | Y3 | X7 | D | D | Y3 | H | H | H | D | D |
| LM198 | Y3 | X7 | D | D | Y3 | D | H | H | D | D |
| LM199 | Y3 | X7 | D | D | Y3 | D | D | H | D | D |
| LM200 | Y3 | X7 | D | D | Y3 | D | D | D | D | D |
| LM201 | Y3 | Y15 | D | D | Y3 | D | D | D | D | D |
| LM202 | Y3 | Y16 | D | D | Y3 | D | D | D | D | D |
| LM203 | Y3 | Y17 | D | D | Y3 | D | D | D | D | D |
| LM204 | Y3 | Y18 | D | D | Y3 | D | D | D | D | D |
| LM205 | Y3 | Y15 | D | D | Y3 | H | X1 | H | D | D |
| LM206 | Y3 | Y15 | D | D | Y3 | D | Y3 | D | D | D |
| LM207 | Y3 | Y16 | D | D | Y3 | D | Y3 | D | D | D |
| LM208 | Y3 | Y17 | D | D | Y3 | D | Y3 | D | D | D |
| LM209 | Y3 | Y18 | D | D | Y3 | D | Y3 | D | D | D |
| LM210 | Y3 | Y15 | D | D | Y3 | H | X4 | H | D | D |
| LM211 | Y3 | Y15 | D | D | Y3 | D | Y12 | D | D | D |
| LM212 | Y3 | Y16 | D | D | Y3 | D | Y12 | D | D | D |
| LM213 | Y3 | Y17 | D | D | Y3 | D | Y12 | D | D | D |
| LM214 | Y3 | Y18 | D | D | Y3 | D | Y12 | D | D | D |

(continued)

| Formula 11-1 | | | | | | | | | | |
|---|---|---|---|---|---|---|---|---|---|---|
| Ligand name | $R_{11}$ | $R_{12}$ | $R_{13}$ | $R_{14}$ | $R_{15}$ | $R_{16}$ | $R_{17}$ | $R_{18}$ | $R_{19}$ | $R_{20}$ |
| LM215 | X2 | X7 | H | H | X2 | H | H | H | H | D |
| LM216 | X2 | X7 | H | H | X2 | H | H | H | D | H |
| LM217 | X2 | X7 | H | H | X2 | H | H | H | D | D |
| LM218 | Y4 | X7 | H | H | Y4 | H | H | H | D | D |
| LM219 | Y5 | X7 | H | H | Y5 | H | H | H | D | D |
| LM220 | Y6 | X7 | H | H | Y6 | H | H | H | D | D |
| LM221 | Y7 | X7 | H | H | Y7 | H | H | H | D | D |
| LM222 | Y8 | X7 | H | H | Y8 | H | H | H | D | D |
| LM223 | Y9 | X7 | H | H | Y9 | H | H | H | D | D |
| LM224 | Y10 | X7 | H | H | Y10 | H | H | H | D | D |
| LM225 | Y10 | X7 | D | D | Y10 | H | H | H | D | D |
| LM226 | Y10 | X7 | D | D | Y10 | D | H | H | D | D |
| LM227 | Y10 | X7 | D | D | Y10 | D | D | H | D | D |
| LM228 | Y10 | X7 | D | D | Y10 | D | D | D | D | D |
| LM229 | Y10 | X8 | D | D | Y10 | D | D | D | D | D |
| LM230 | Y10 | Y16 | D | D | Y10 | D | D | D | D | D |
| LM231 | Y10 | Y17 | D | D | Y10 | D | D | D | D | D |
| LM232 | Y10 | Y18 | D | D | Y10 | D | D | D | D | D |
| LM233 | Y10 | Y15 | D | D | Y10 | D | D | D | D | D |
| LM234 | Y10 | Y15 | D | D | Y10 | H | X1 | H | D | D |
| LM235 | Y10 | Y15 | D | D | Y10 | D | Y3 | D | D | D |
| LM236 | Y10 | Y16 | D | D | Y10 | D | Y3 | D | D | D |
| LM237 | Y10 | Y17 | D | D | Y10 | D | Y3 | D | D | D |
| LM238 | Y10 | Y18 | D | D | Y10 | D | Y3 | D | D | D |
| LM239 | Y10 | Y15 | D | D | Y10 | H | X4 | H | D | D |
| LM240 | Y10 | Y15 | D | D | Y10 | D | Y12 | D | D | D |
| LM241 | Y10 | Y16 | D | D | Y10 | D | Y12 | D | D | D |
| LM242 | Y10 | Y17 | D | D | Y10 | D | Y12 | D | D | D |
| LM243 | Y10 | Y18 | D | D | Y10 | D | Y12 | D | D | D |

Table 6

| Formula 11-2 | | | | | | | | | | | | |
|---|---|---|---|---|---|---|---|---|---|---|---|---|
| Ligand name | $R_{11}$ | $X_{11}$ | $R_{101}$ | $R_{102}$ | $R_{103}$ | $R_{104}$ | $R_{14}$ | $R_{15}$ | $R_{16}$ | $R_{17}$ | $R_{18}$ | $R_{19}$ | $R_{20}$ |
| LFM1 | Y10 | N-Ph | D | D | D | D | D | Y10 | D | D | D | D | D |
| LFM2 | Y10 | S | D | D | D | D | D | Y10 | D | D | D | D | D |
| LFM3 | Y10 | O | D | D | D | D | D | Y10 | D | D | D | D | D |

(continued)

| Formula 11-2 | | | | | | | | | | | | |
|---|---|---|---|---|---|---|---|---|---|---|---|---|
| Ligand name | $R_{11}$ | $X_{11}$ | $R_{101}$ | $R_{102}$ | $R_{103}$ | $R_{104}$ | $R_{14}$ | $R_{15}$ | $R_{16}$ | $R_{17}$ | $R_{18}$ | $R_{19}$ | $R_{20}$ |
| LFM4 | Y3 | O | D | D | D | D | D | Y3 | D | D | D | D | D |
| LFM5 | Y10 | O | D | D | D | D | D | Y10 | D | D | D | D | D |
| LFM6 | Y10 | O | D | D | D | D | D | Y10 | D | Y3 | D | D | D |
| LFM7 | Y10 | O | D | D | D | D | D | Y10 | D | Y12 | D | D | D |

Table 7

| Formula 11-3 | | | | | | | | | | | | | |
|---|---|---|---|---|---|---|---|---|---|---|---|---|---|
| Ligand name | $R_{11}$ | $X_{11}$ | $R_{101}$ | $R_{102}$ | $R_{103}$ | $R_{104}$ | $R_{14}$ | $R_{15}$ | $R_{16}$ | $R_{17}$ | $R_{18}$ | $R_{19}$ | $R_{20}$ |
| LFP1 | Y10 | N-Ph | D | D | D | D | D | Y10 | D | D | D | D | D |
| LFP2 | Y10 | S | D | D | D | D | D | Y10 | D | D | D | D | D |
| LFP3 | Y10 | O | D | D | D | D | D | Y10 | D | D | D | D | D |
| LFP4 | Y3 | O | D | D | D | D | D | Y3 | D | D | D | D | D |
| LFP5 | Y10 | O | D | D | D | D | D | Y10 | D | D | D | D | D |
| LFP6 | Y10 | O | D | D | D | D | D | Y10 | D | Y3 | D | D | D |
| LFP7 | Y10 | O | D | D | D | D | D | Y10 | D | Y12 | D | D | D |

X1 to X10 and Y1 to Y18 in Tables 5-7 are the same as described below, and Ph in the tables refers to a phenyl group:

$*-CH_3$

**X1**

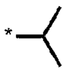

**X2**

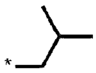

**X3**

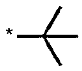

**X4**

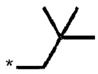

**X5**

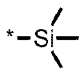

**X6**

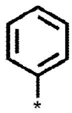

**X7**

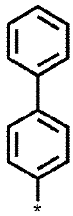

**X8**

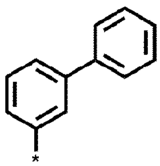

**X9**

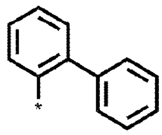

**X10**

$*-CH_2D$

**Y1**

$*-CHD_2$

**Y2**

$*-CD_3$

**Y3**

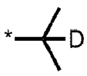

**Y4**

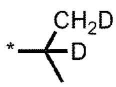

**Y5**

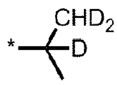

**Y6**

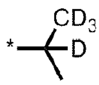

**Y7**

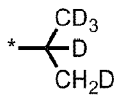

**Y8**

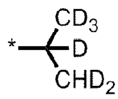

**Y9**

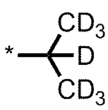

**Y10**

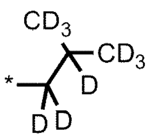

**Y11**

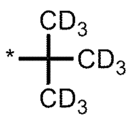

**Y12**

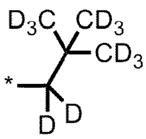

**Y13**

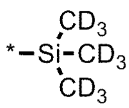

**Y14**

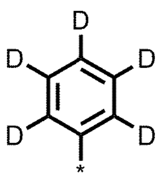

**Y15**

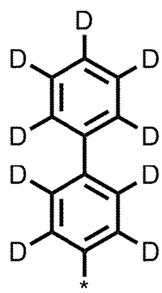

**Y16**

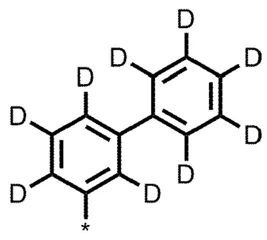

**Y17**

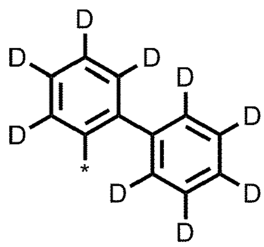

**Y18**

Group VI

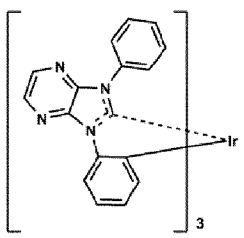

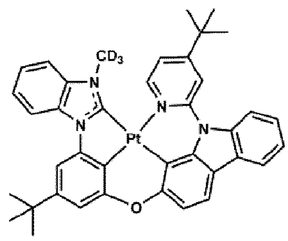

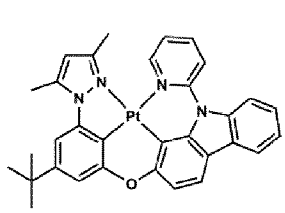

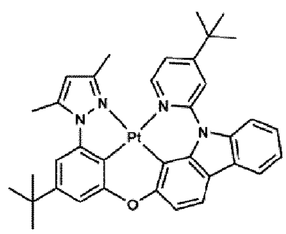

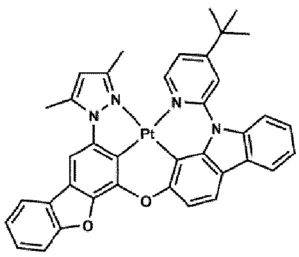

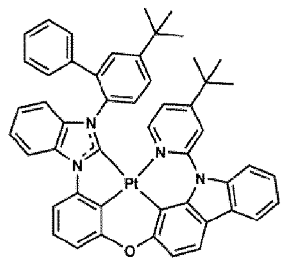

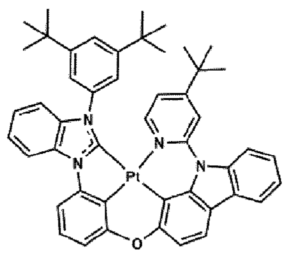

In one or more embodiments, the sensitizer may be a TADF emitter that satisfies Condition 7:

Condition 7

$$\Delta E_{ST} \leq 0.3 \text{ eV}$$

wherein, in Condition 7,

$\Delta E_{ST}$ is the difference between the lowest excited singlet energy level and the lowest excited triplet energy level of the sensitizer.

In one or more embodiments, the sensitizer may include the thermally activated delayed fluorescence emitter represented by Formula 201 or 202:

Formula 201

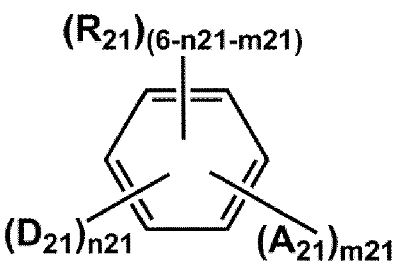

Formula 202

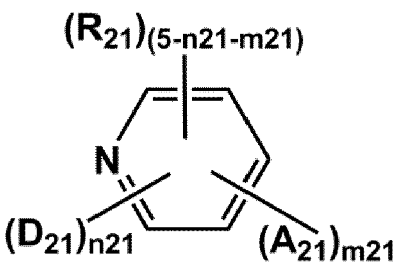

wherein, in Formulae 201 and 202,

$A_{21}$ is an acceptor group,
$D_{21}$ is a donor group,
m21 may be 1, 2, or 3, and n21 may be 1, 2, or 3,
the sum of n21 and m21 in Formula 201 may be 6 or less, and the sum of n21 and m21 in Formula 202 may be 5 or less,
$R_{21}$ may be hydrogen, deuterium, -F, -Cl, -Br, -I, $SF_5$, a hydroxyl group, a cyano group, a nitro group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ alkylheteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$, and a plurality of $R_{21}$(s) may optionally be bonded to form a substituted or unsubstituted $C_5$-$C_{30}$ carbocyclic group or a substituted or unsubstituted $C_1$-$C_{30}$ heterocyclic group,
$Q_1$ to $Q_3$ may each independently be hydrogen, deuterium, -F, -Cl, -Br, -I, a hydroxyl group, a cyano group, a nitro group, an amidino group, a hydrazine group, a hydrazone group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a $C_1$-$C_{60}$ alkyl group that is substituted with at least one of deuterium, -F, a cyano group, a $C_1$-$C_{60}$ alkyl group, or a $C_6$-$C_{60}$ aryl group, or a $C_6$-$C_{60}$ aryl group that is substituted with at least one of deuterium, -F, a cyano group, a $C_1$-$C_{60}$ alkyl group, or a $C_6$-$C_{60}$ aryl group.

For example, $A_{21}$ in Formula 201 and 202 may be a substituted unsubstituted $\pi$ electron-deficient nitrogen-free cyclic group.

In one or more embodiments, the $\pi$ electron-deficient nitrogen-free cyclic group may be a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed cyclic group of two or more $\pi$ electron-deficient nitrogen-free cyclic groups, but embodiments of the present disclosure are not limited thereto.

For example, $D_{21}$ in Formulae 201 and 202 may be:

-F, a cyano group, or a $\pi$-electron deficient nitrogen-containing cyclic group; a $C_1$-$C_{60}$ alkyl group, a $\pi$-electron deficient nitrogen-containing cyclic group, or an $\pi$ electron-deficient nitrogen-free cyclic group, each substituted with at least one of -F or a cyano group; or
a $\pi$-electron deficient nitrogen-containing cyclic group, substituted with at least one of deuterium, a $C_1$-$C_{60}$ alkyl group, a $\pi$-electron deficient nitrogen-containing cyclic group, or a $\pi$ electron-deficient nitrogen-free cyclic group.

In one or more embodiments, the $\pi$-electron deficient nitrogen-free cyclic group is the same as described above.

The term "$\pi$-electron deficient nitrogen-containing cyclic group" used herein refers to a cyclic group having at least one -N= moiety, and, for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a

thiadiazole group, an imidazopyridine group, an imidazopyrimidine group, an azacarbazole group, and a benzimidazolobenzimidazole group; or a condensed cyclic group in which two or more π electron-deficient nitrogen-containing cyclic groups are condensed with each other.

In one or more embodiments, the sensitizer may be a compound of one of Groups VII to XI, but embodiments of the present disclosure are not limited thereto:

Group VII

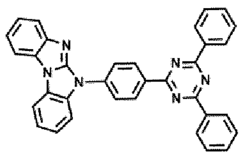
1

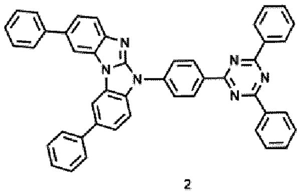
2

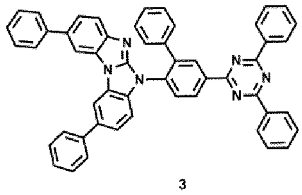
3

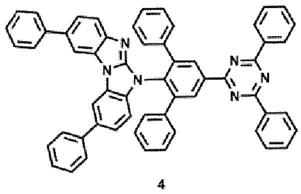
4

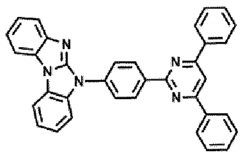
5

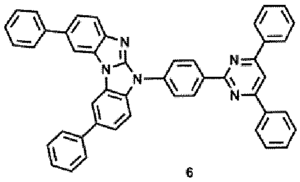
6

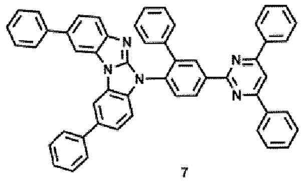
7

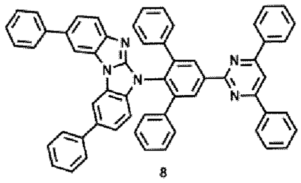
8

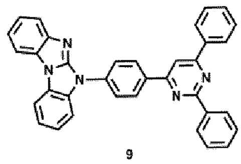
9

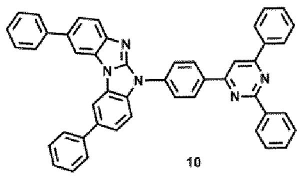
10

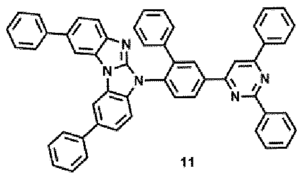
11

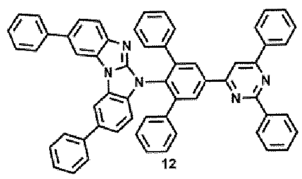
12

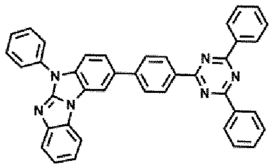
13

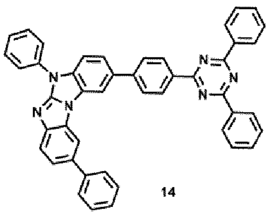
14

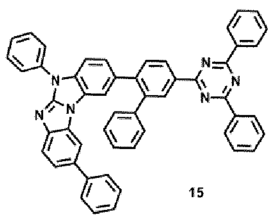
15

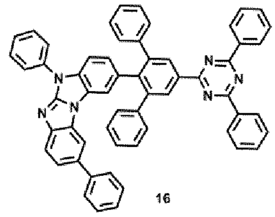
16

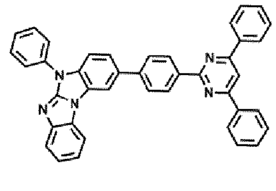
17

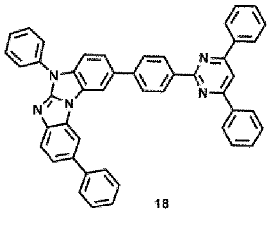
18

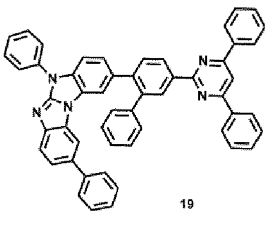
19

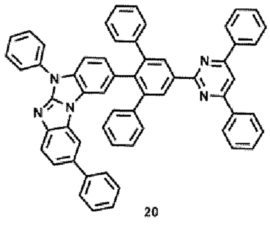
20

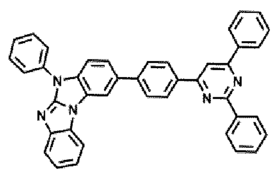
21

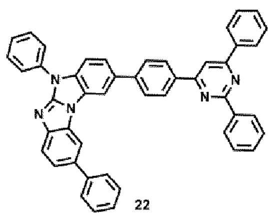
22

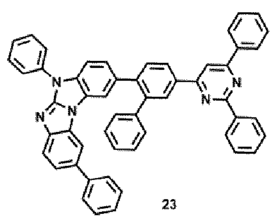
23

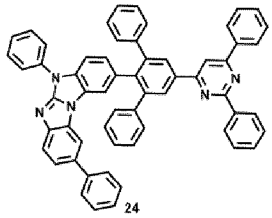
24

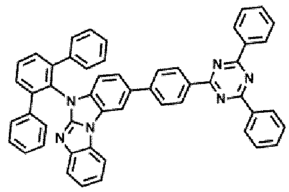
25

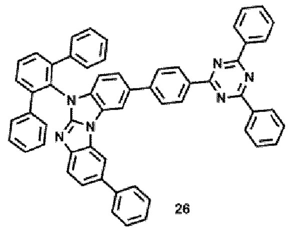
26

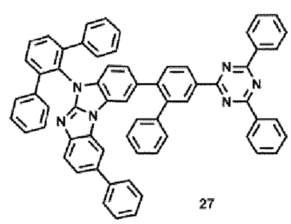
27

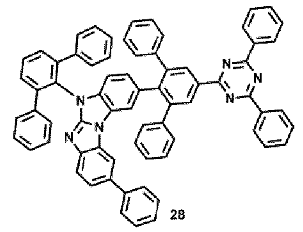
28

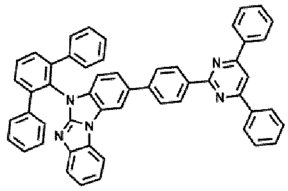
29

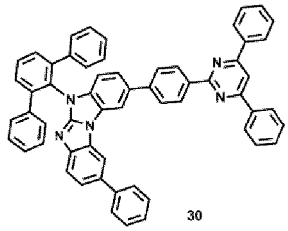
30

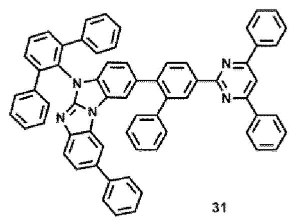
31

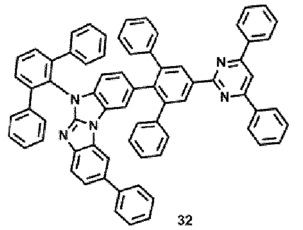
32

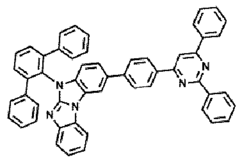
33

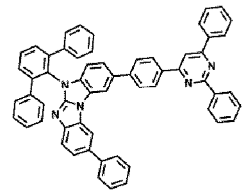
34

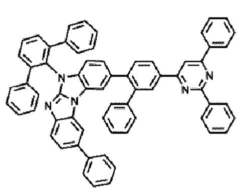
35

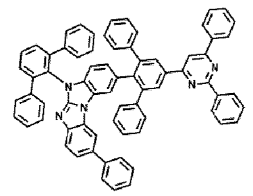
36

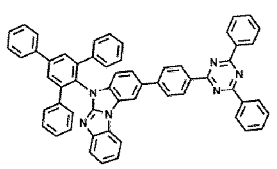
37

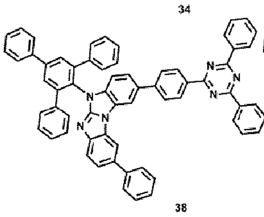
38

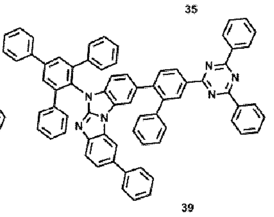
39

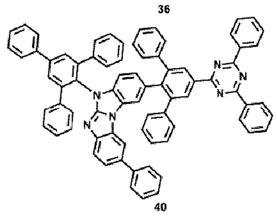
40

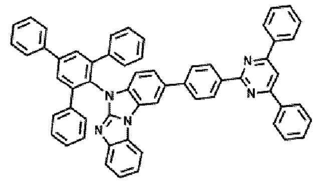
41

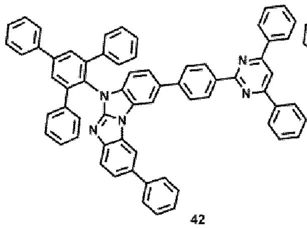
42

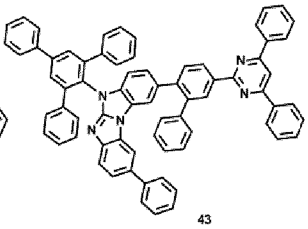
43

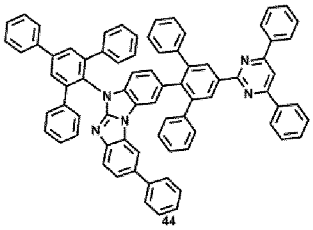
44

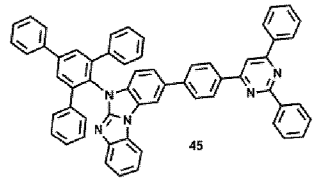
45

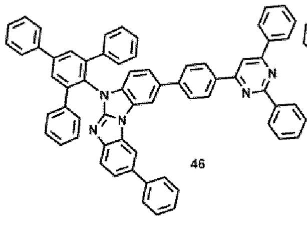
46

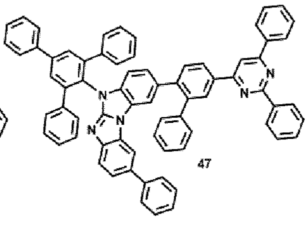
47

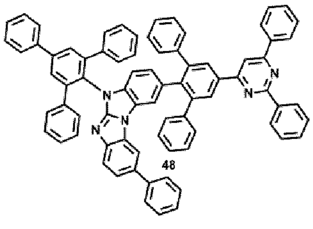
48

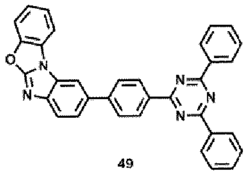
49

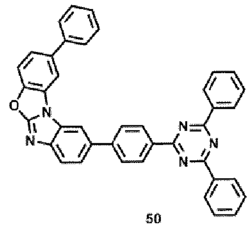
50

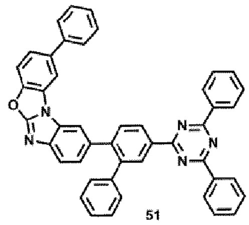
51

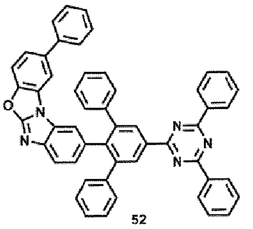
52

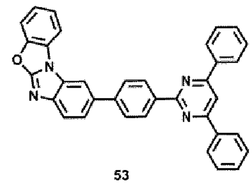
53

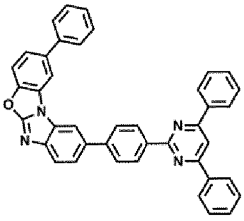
54

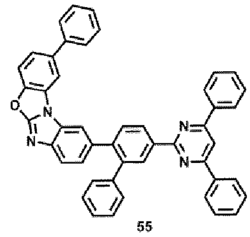
55

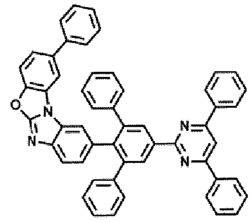
56

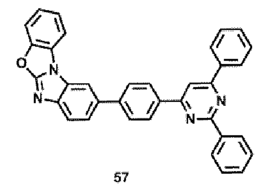
57

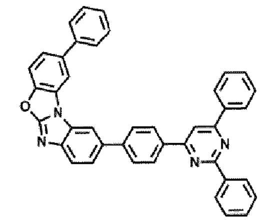
58

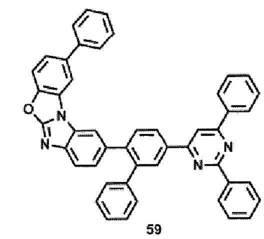
59

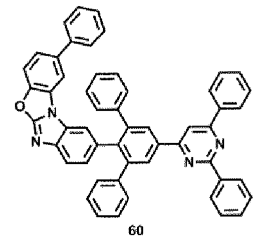
60

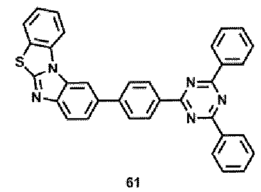
61
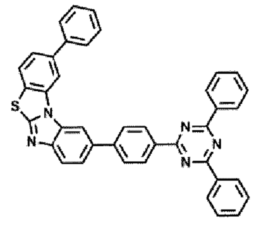
62
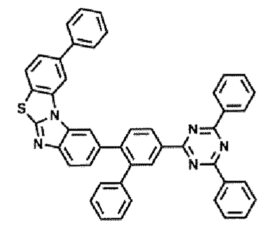
63
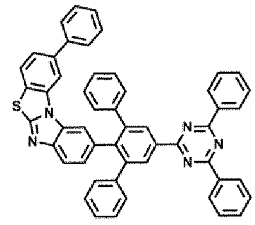
64
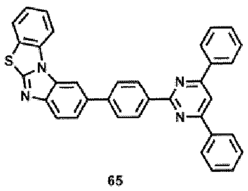
65
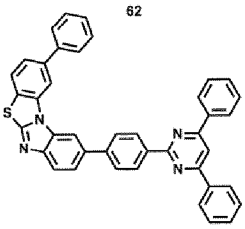
66
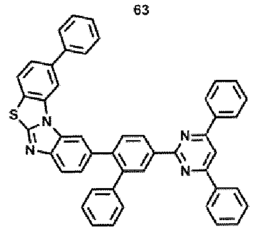
67
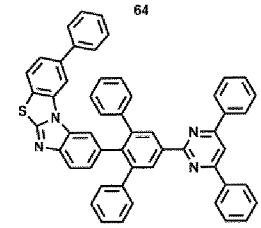
68
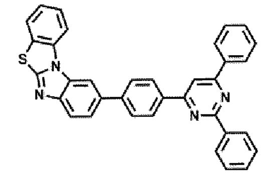
69
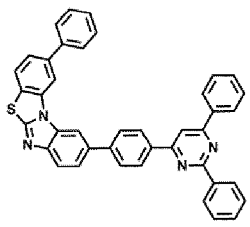
70
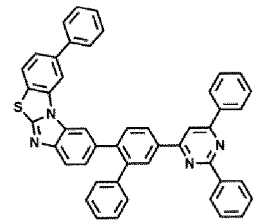
71
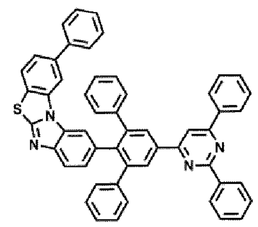
72
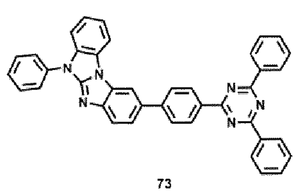
73
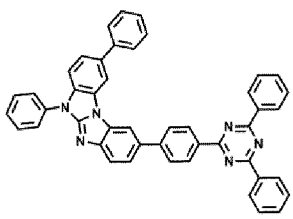
74
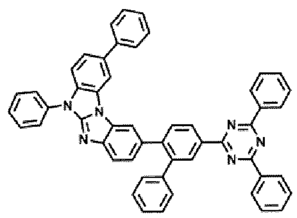
75
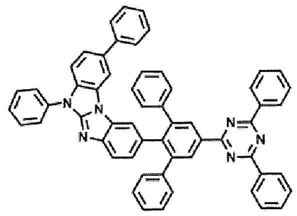
76
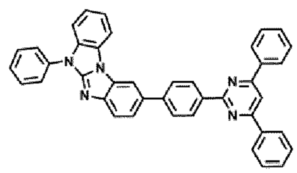
77
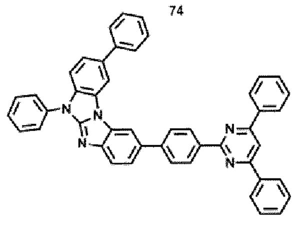
78
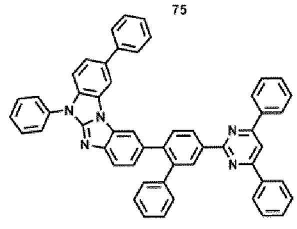
79
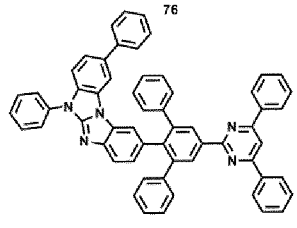
80
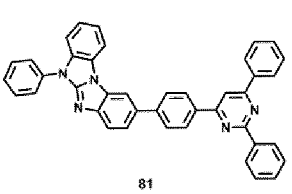
81
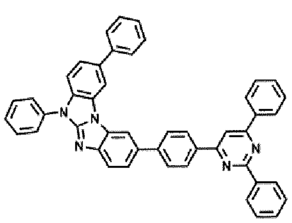
82
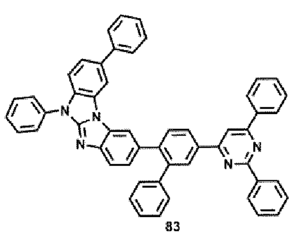
83
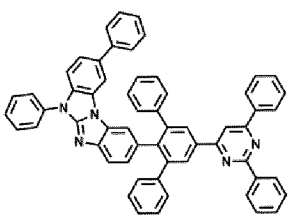
84
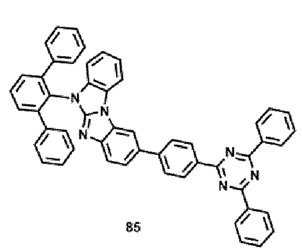
85
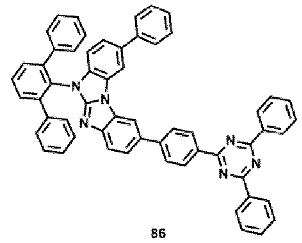
86
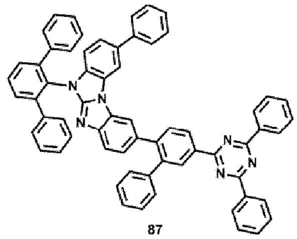
87
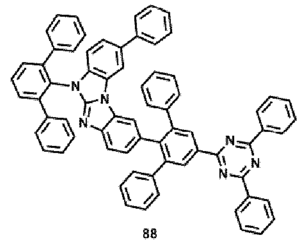
88

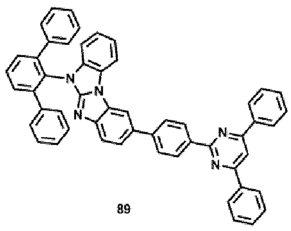

89

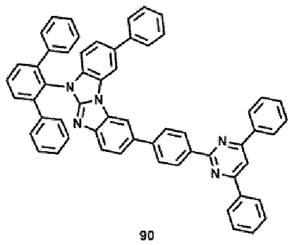

90

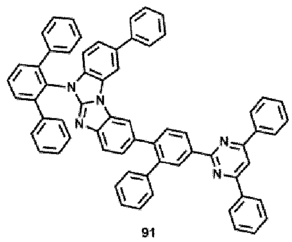

91

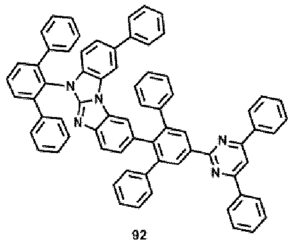

92

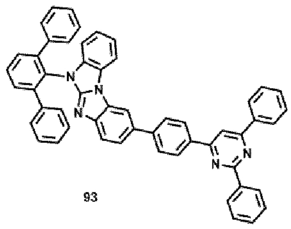

93

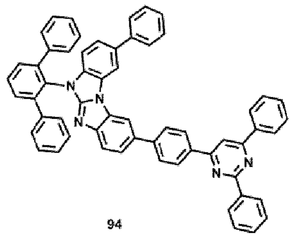

94

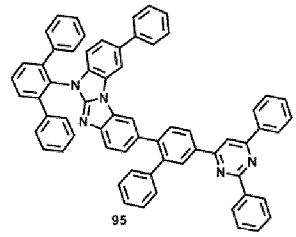

95

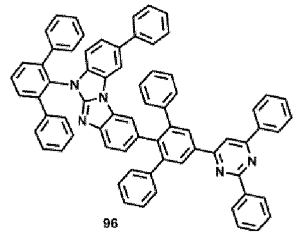

96

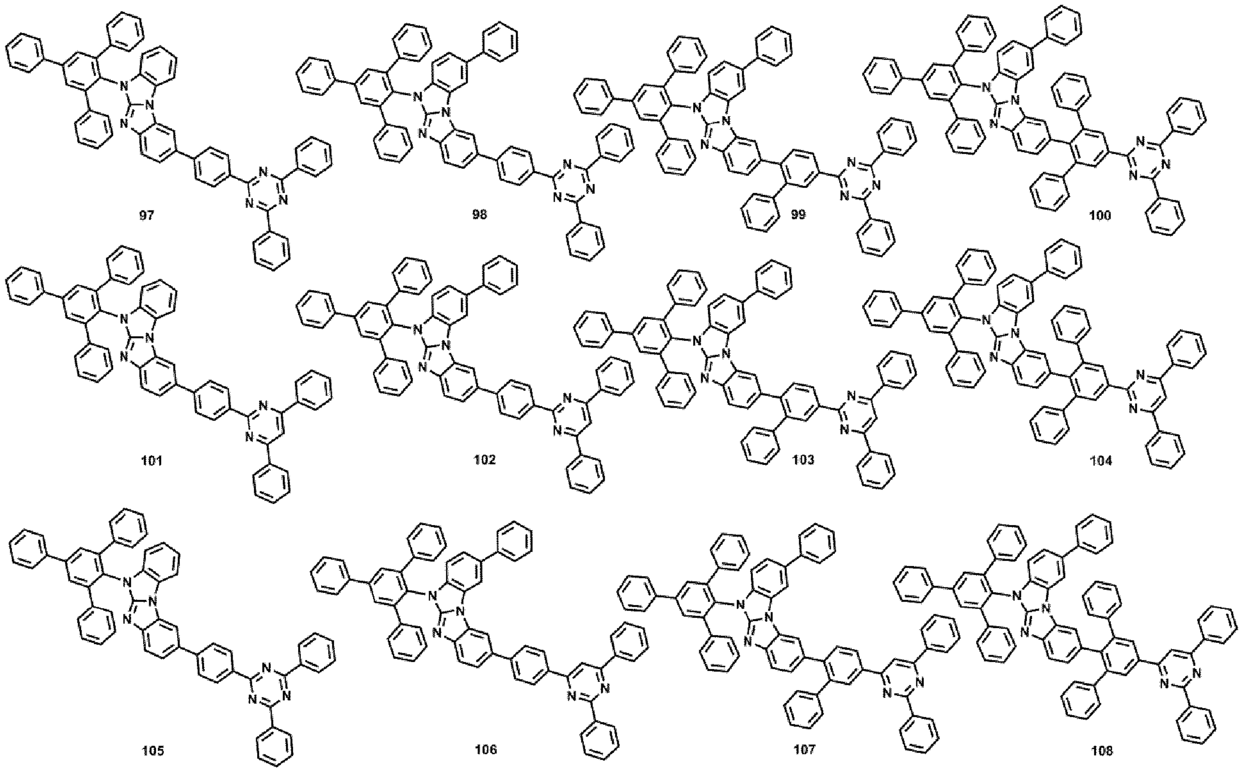

97

98

99

100

101

102

103

104

105

106

107

108

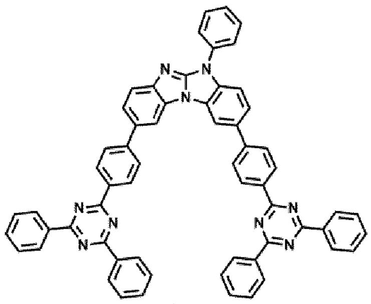
109

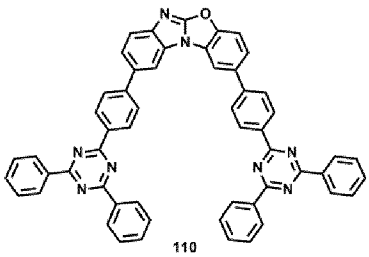
110

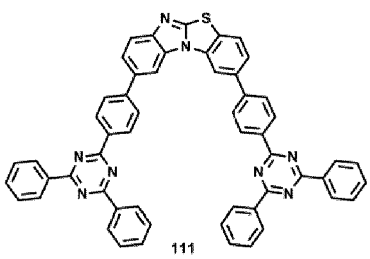
111

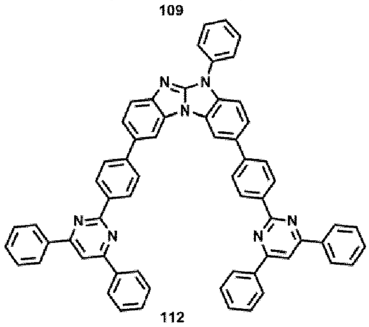
112

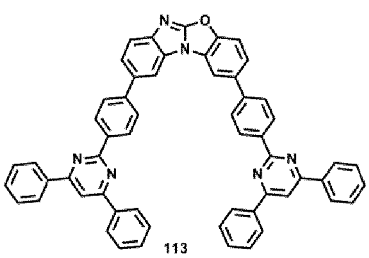
113

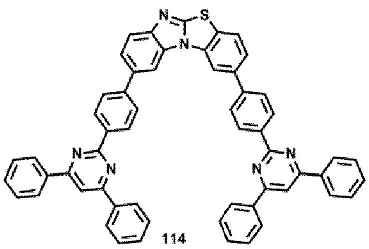
114

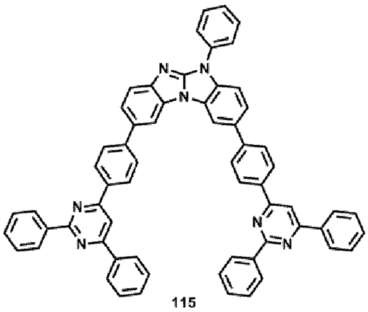
115

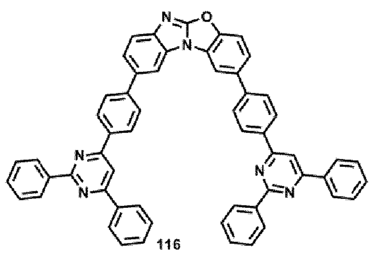
116

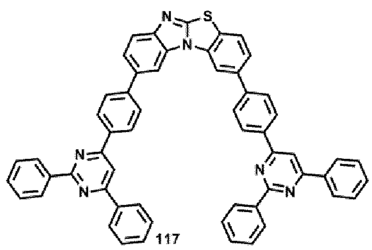
117

## Group VIII

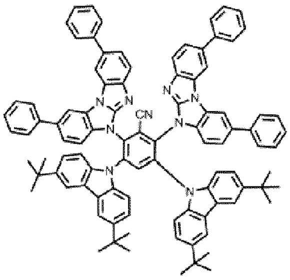
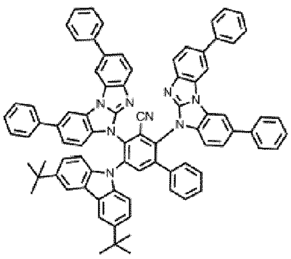
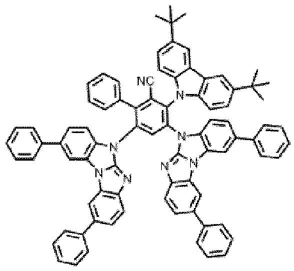
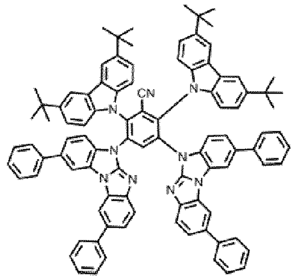
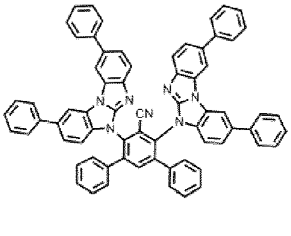
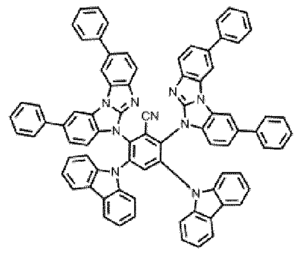
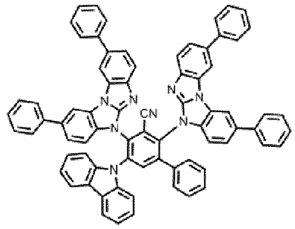
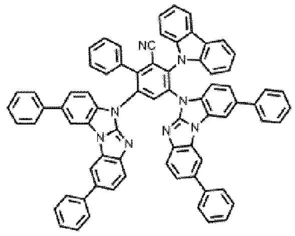
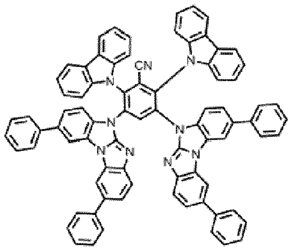
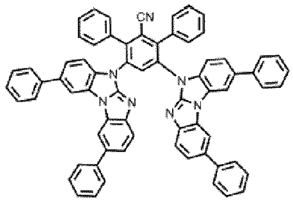

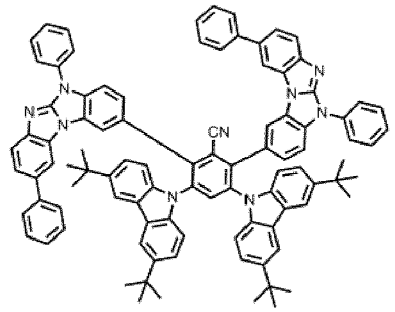

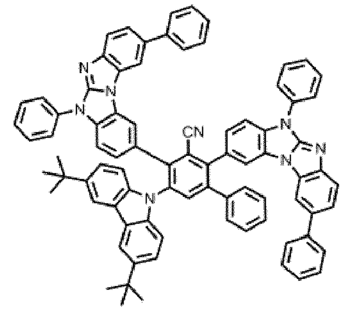

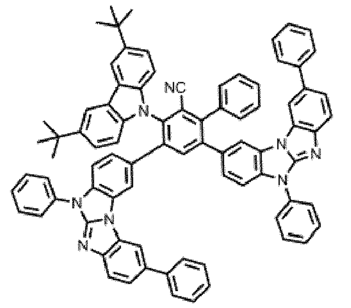

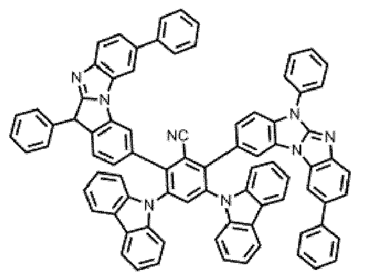

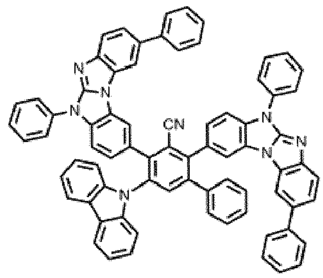

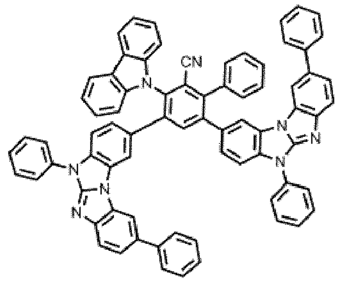

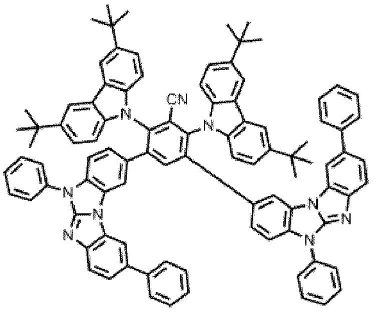

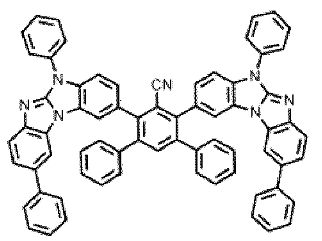

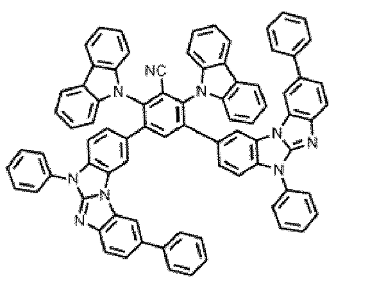

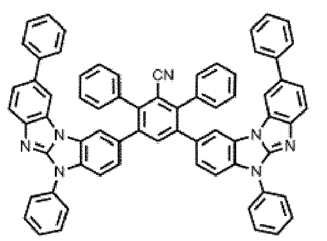

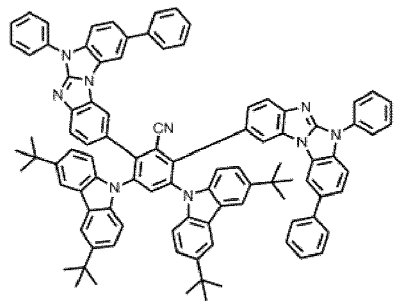
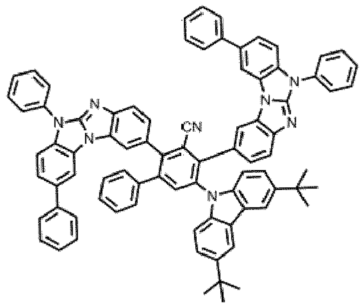
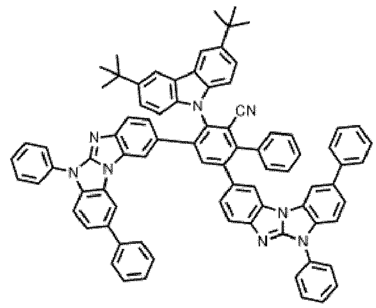

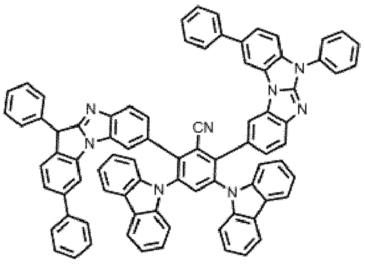
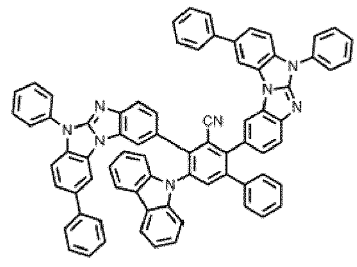
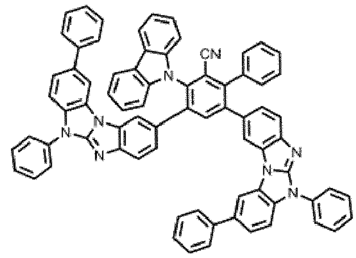

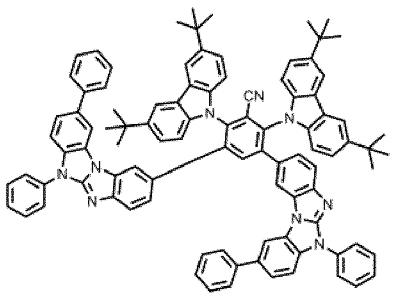
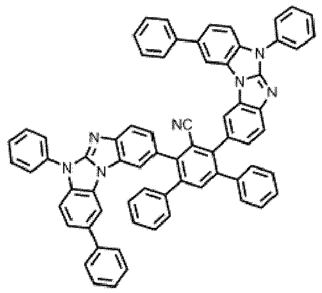

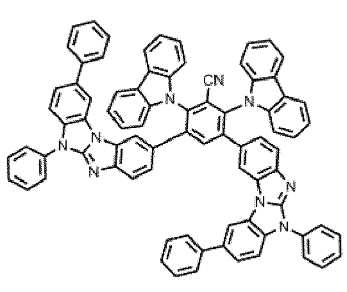
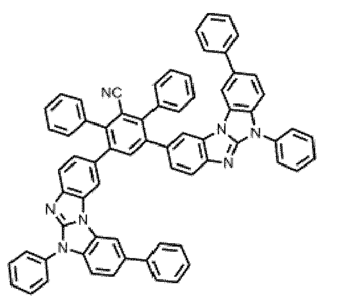

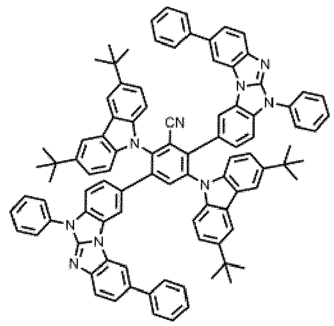
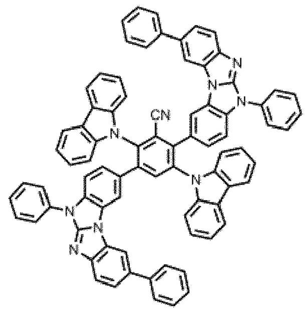
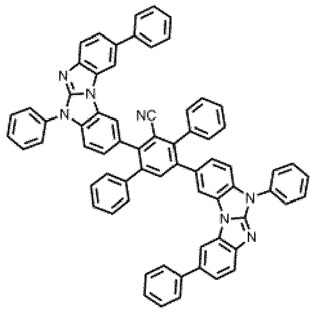

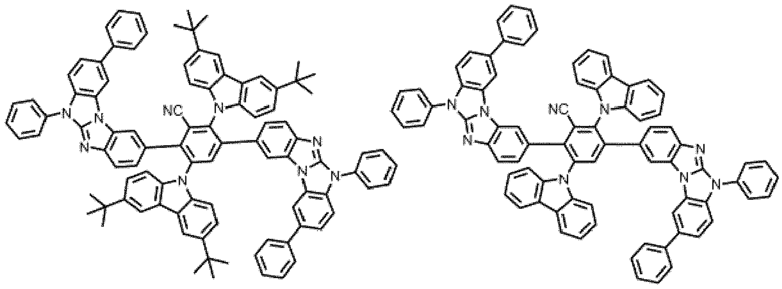
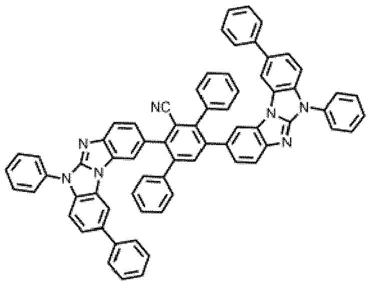

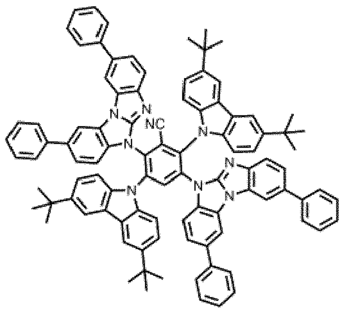
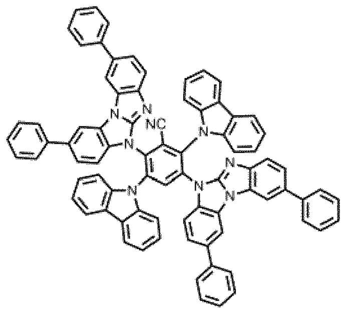
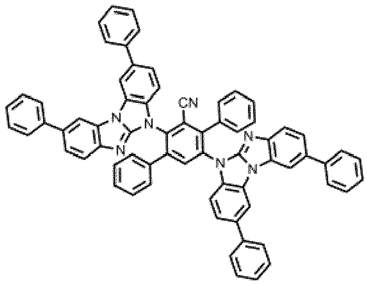

## Group IX

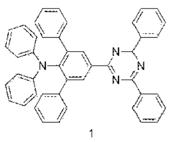
1
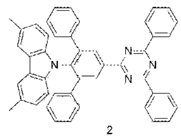
2
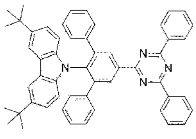
3
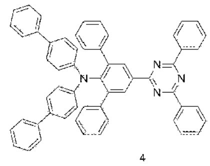
4
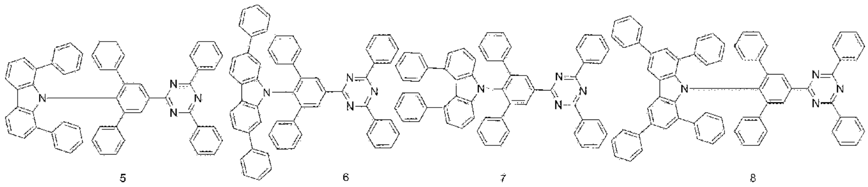
5
6
7
8
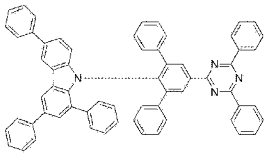
9
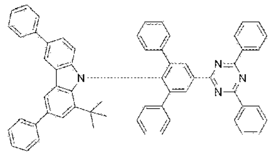
10
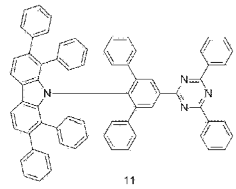
11
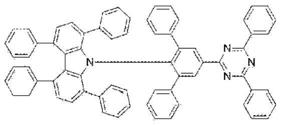
12
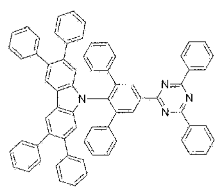
13
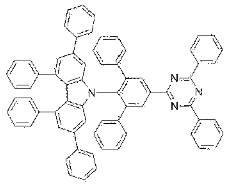
14
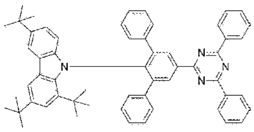
15
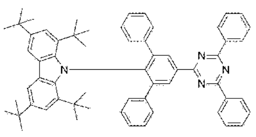
16
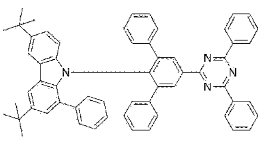
17
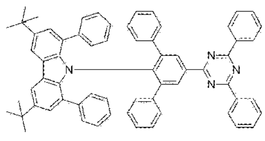
18
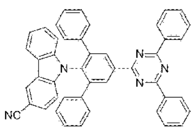
19
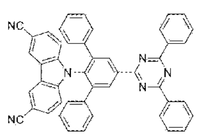
20
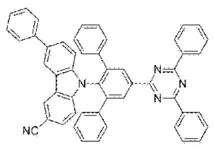
21
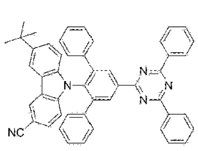
22
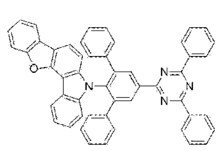
23
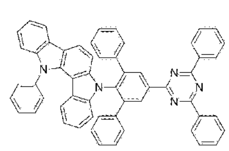
24

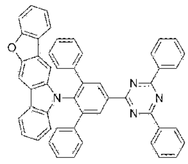
25
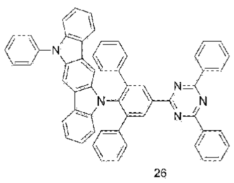
26
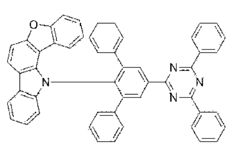
27
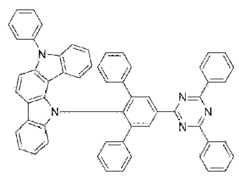
28
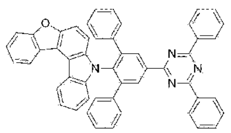
29
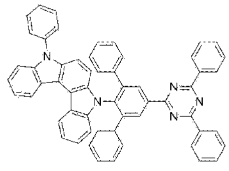
30
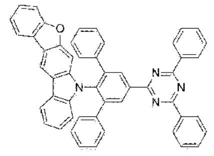
31
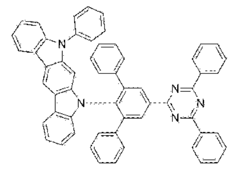
32
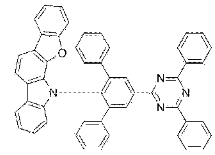
33
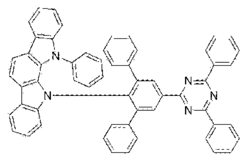
34
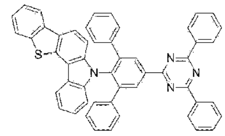
35
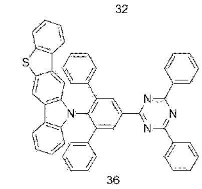
36
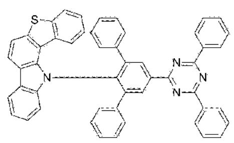
37
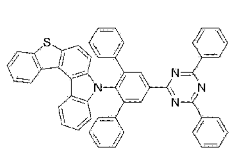
38
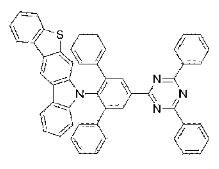
39
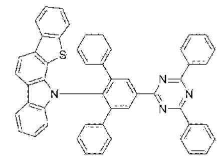
40
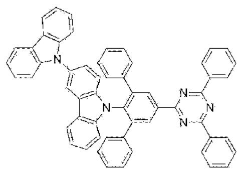
41
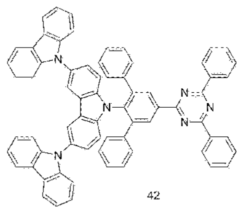
42
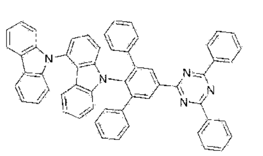
43
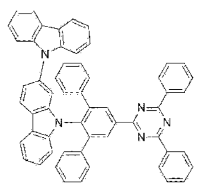
44
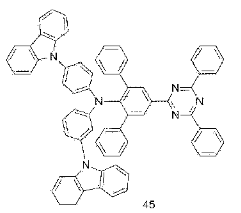
45
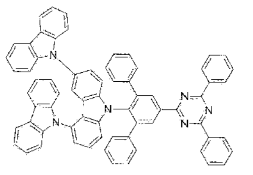
46
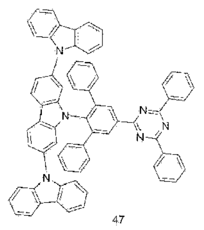
47
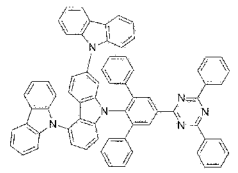
48
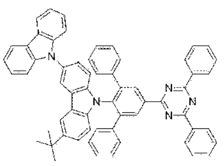
49
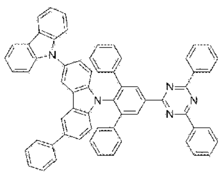
50
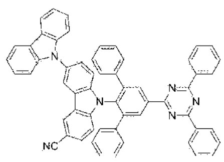
51
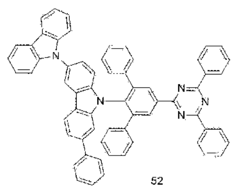
52

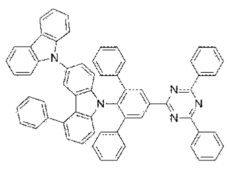
53
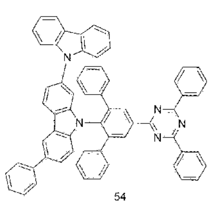
54
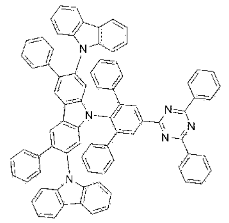
55
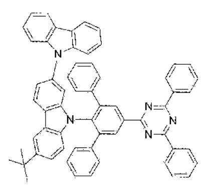
56
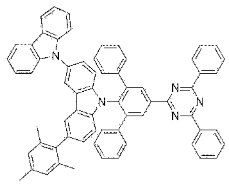
57
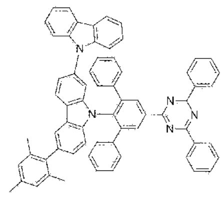
58
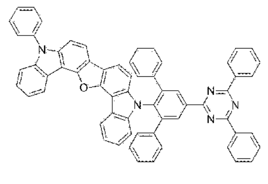
59
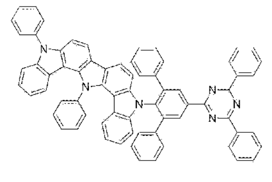
60
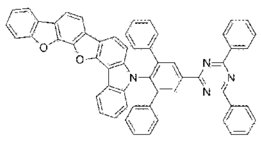
61
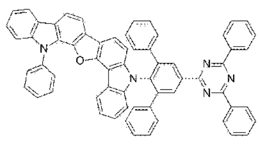
62
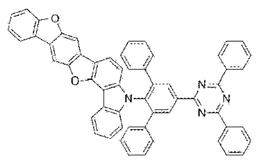
63
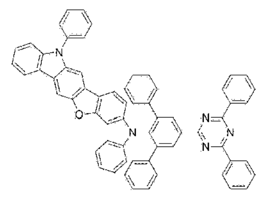
64
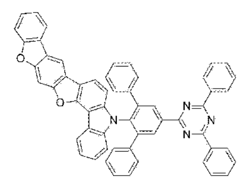
65
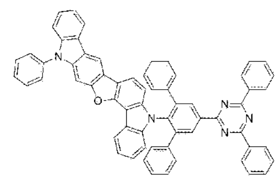
66
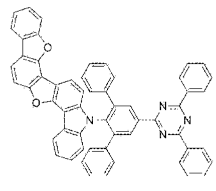
67
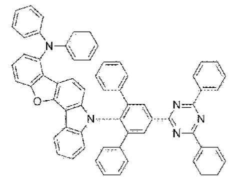
68
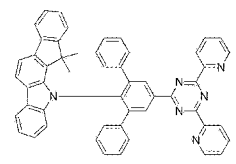
69
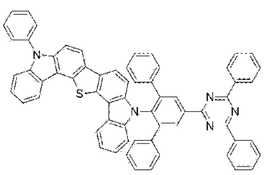
70
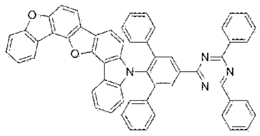
71
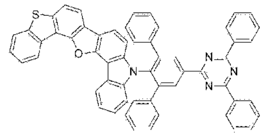
72
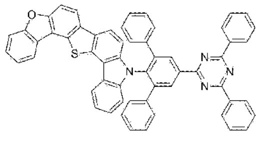
73
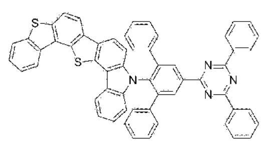
74
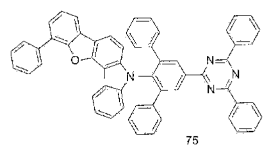
75
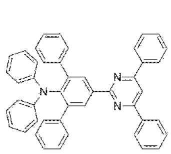
76
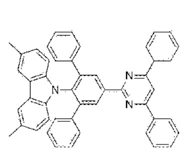
77
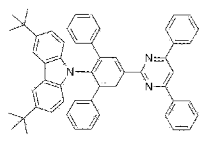
78
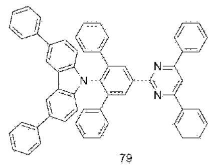
79
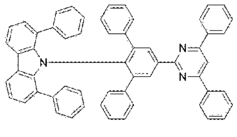
80
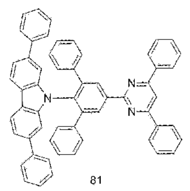
81
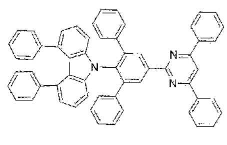
82
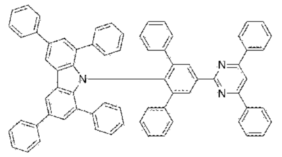
83

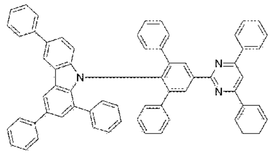
84

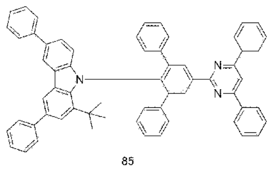
85

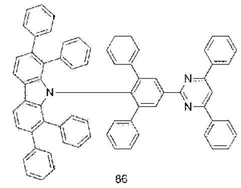
86

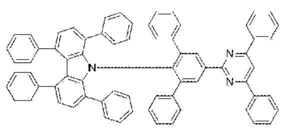
87

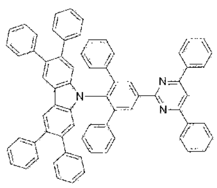
88

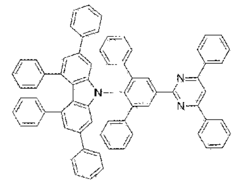
89

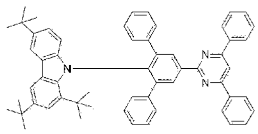
90

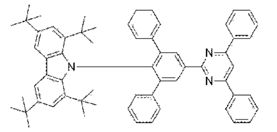
91

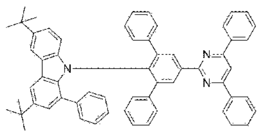
92

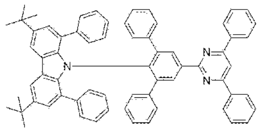
93

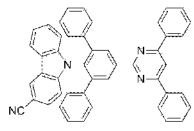
94

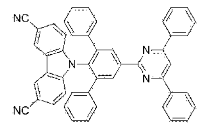
95

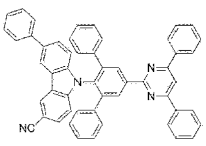
96

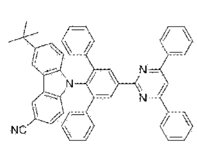
97

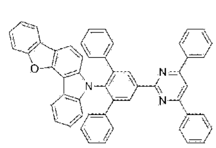
98

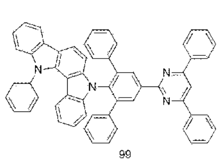
99

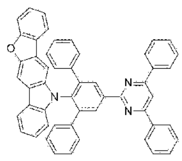
100

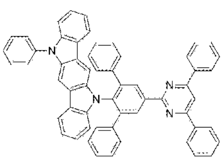
101

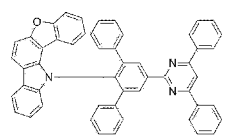
102

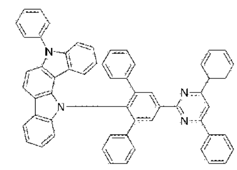
103

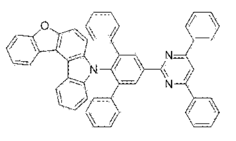
104

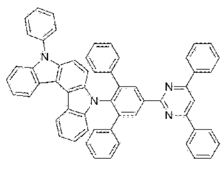
105

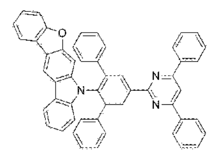
106

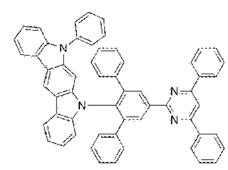
107

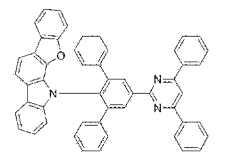
108

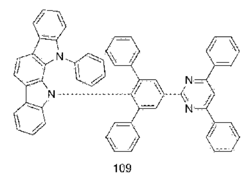
109

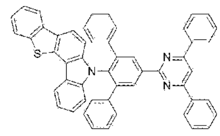
110

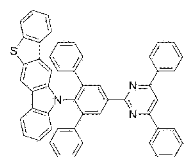
111

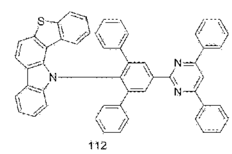
112

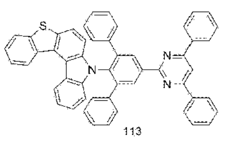
113

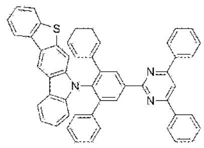
114

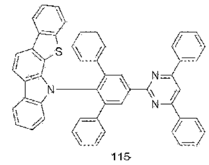
115

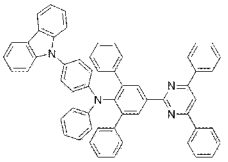
116
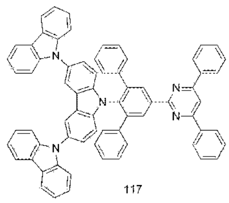
117
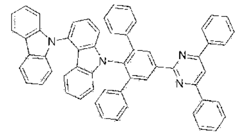
118
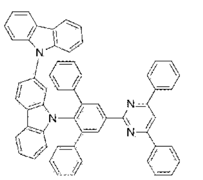
119

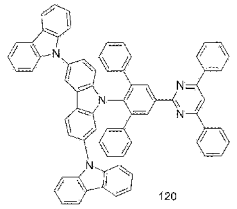
120
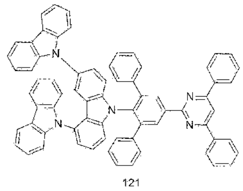
121
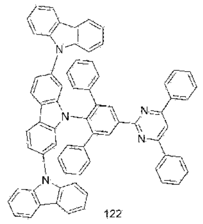
122
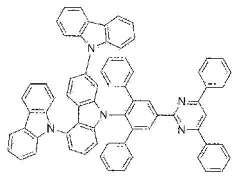
123

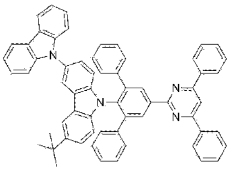
124
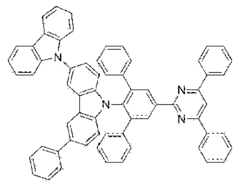
125
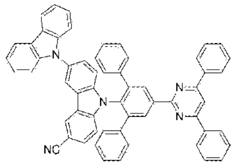
126
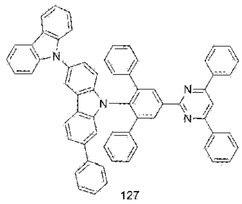
127

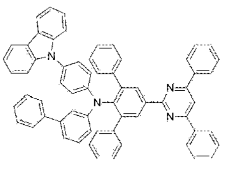
128
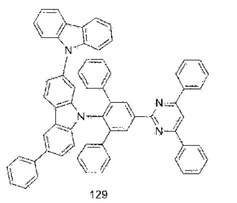
129
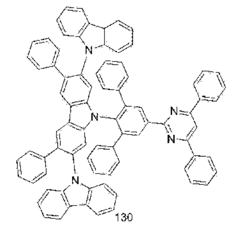
130
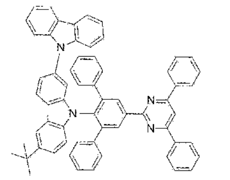
131

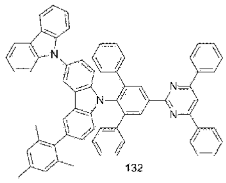
132
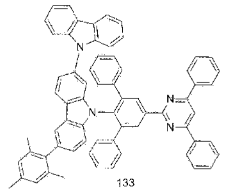
133
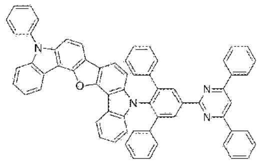
134
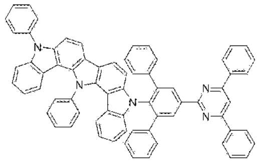
135

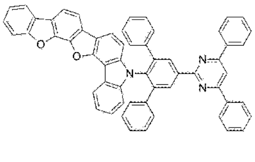
136
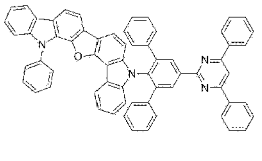
137
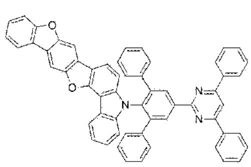
138
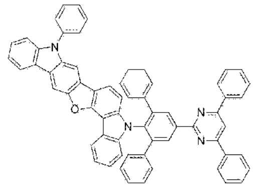
139

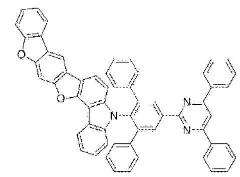
140
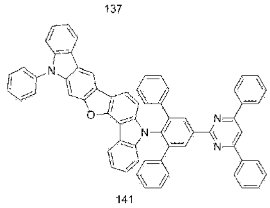
141
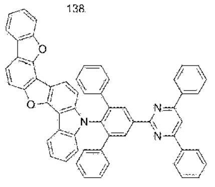
142
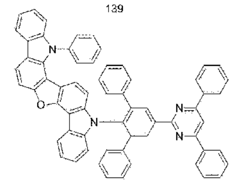
143

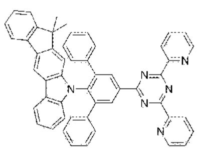
144

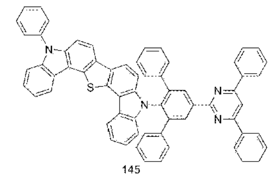
145

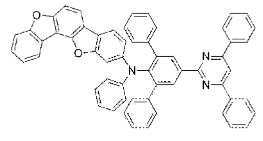
146

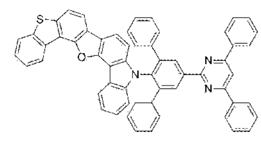
147

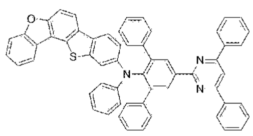
148

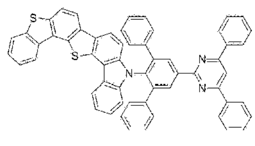
149

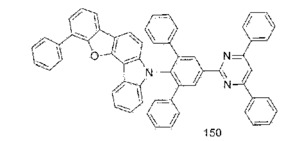
150

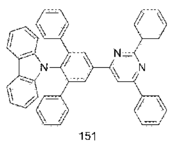
151

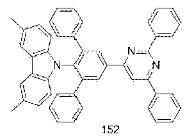
152

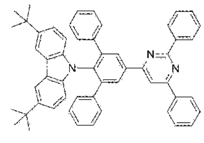
153

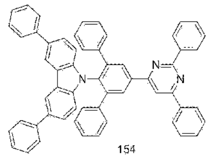
154

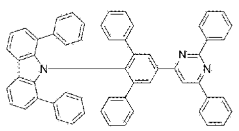
155

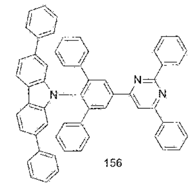
156

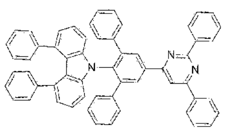
157

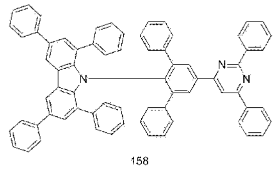
158

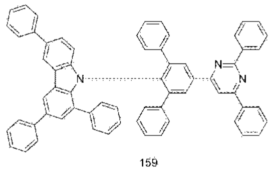
159

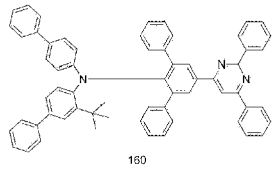
160

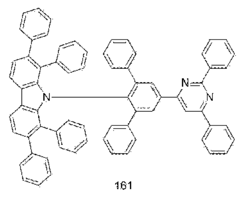
161

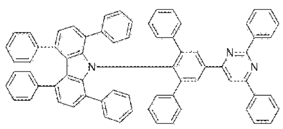
162

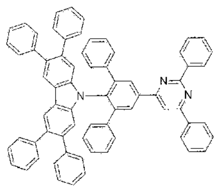
163

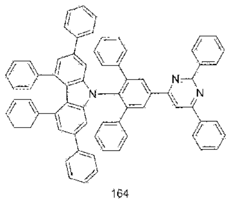
164

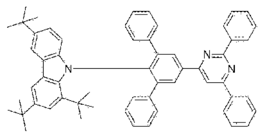
165

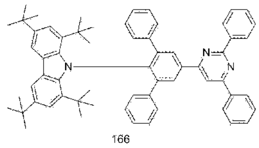
166

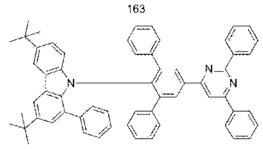
167

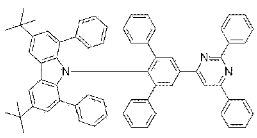
168

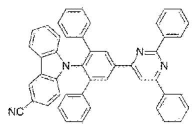
169

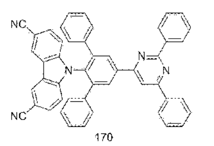
170

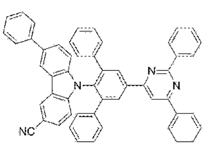
171

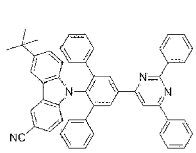
172

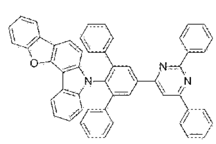
173

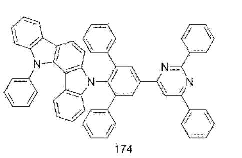
174

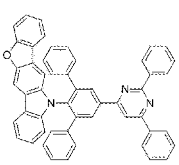
175

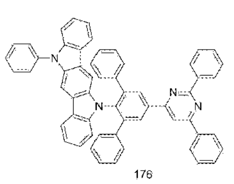
176

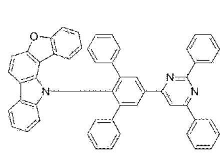
177

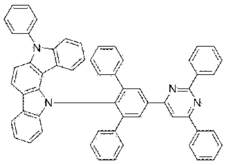
178

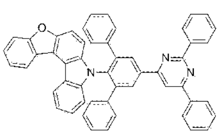
179

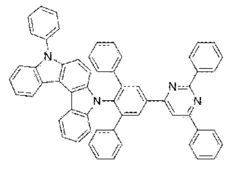
180

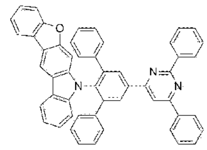
181

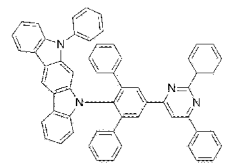
182

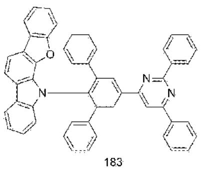
183

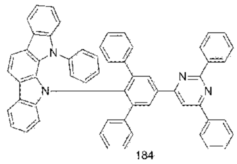
184

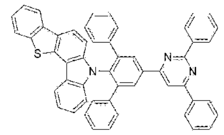
185

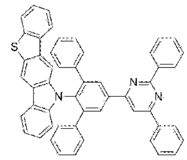
186

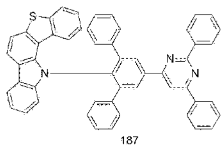
187

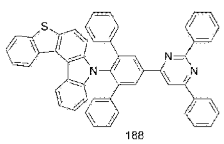
188

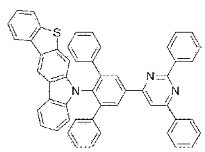
189

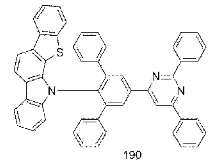
190

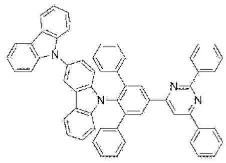
191

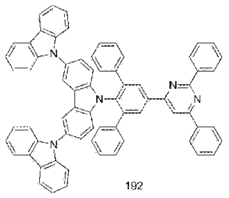
192

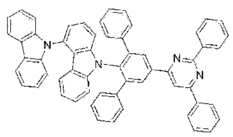
193

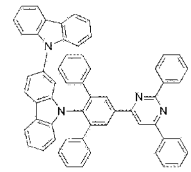
194

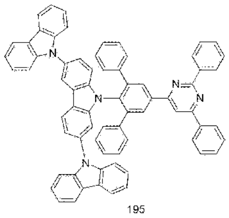
195

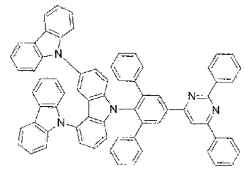
196

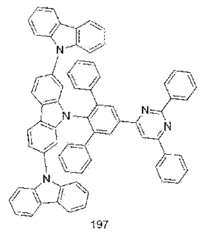
197

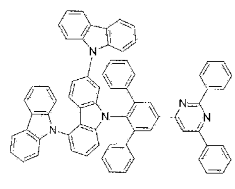
198

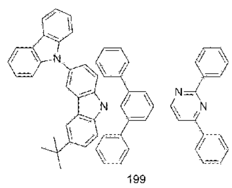
199

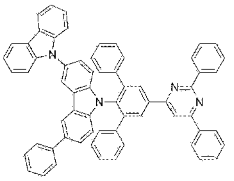
200

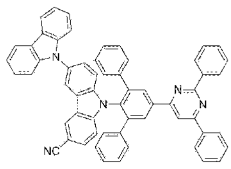
201

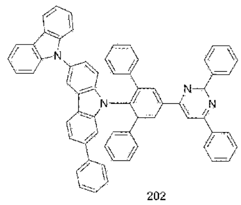
202

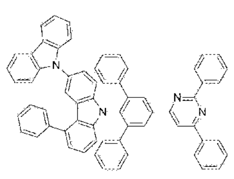
203

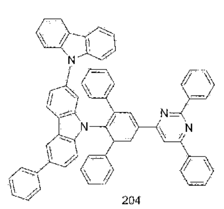
204

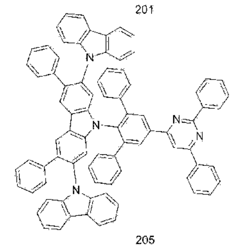
205

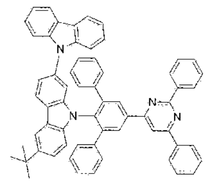
206

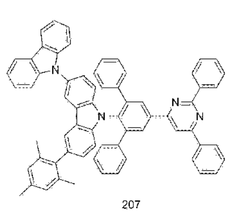
207

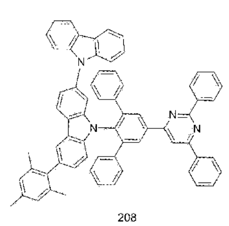
208

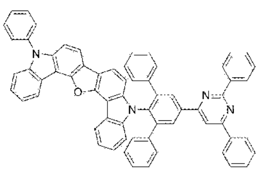
209

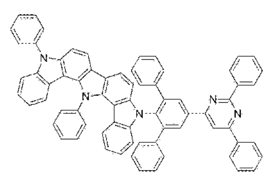
210

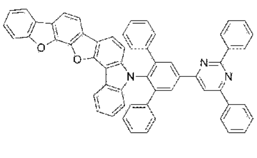
211

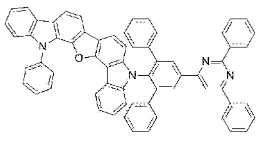
212

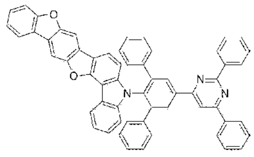
213

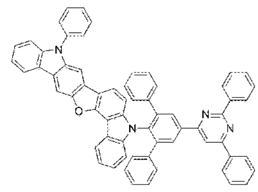
214

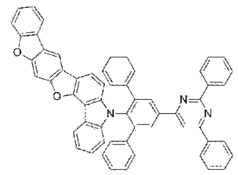
215

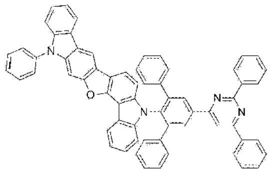
216

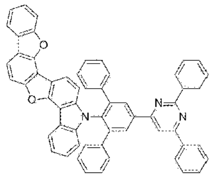
217

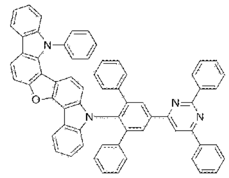
218

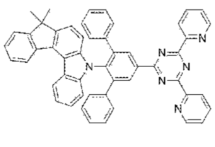
219

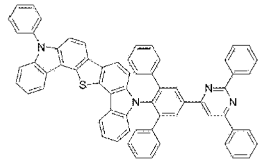
220

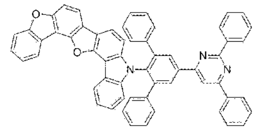
221

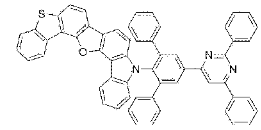
222

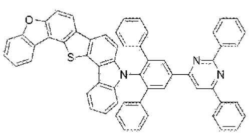
223

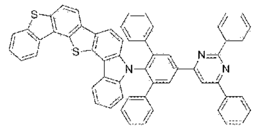
224

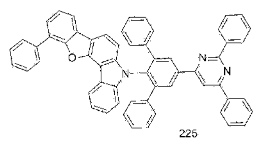
225

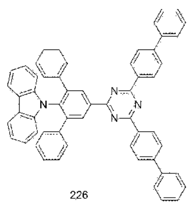
226

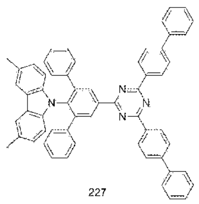
227

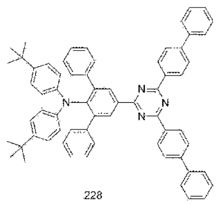
228

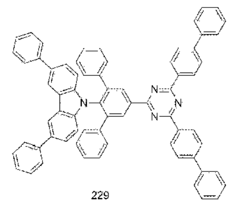
229

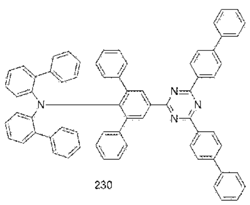
230

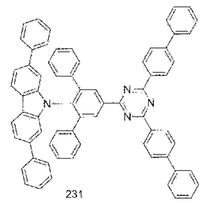
231

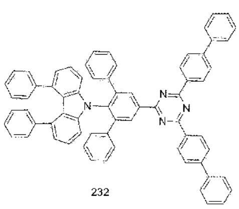
232

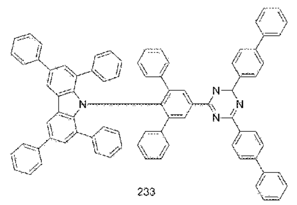
233

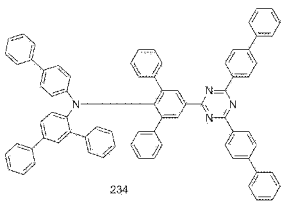
234

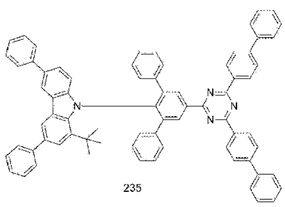
235

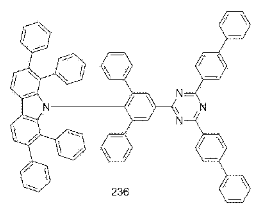
236

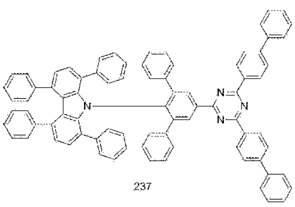
237

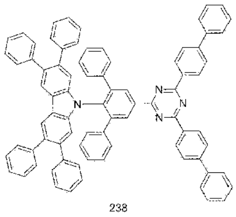
238

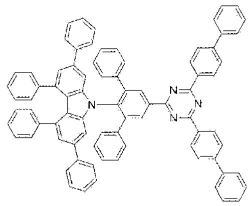
239

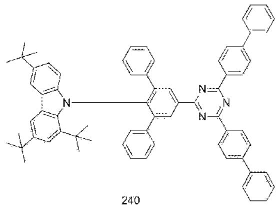
240

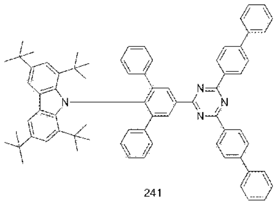
241

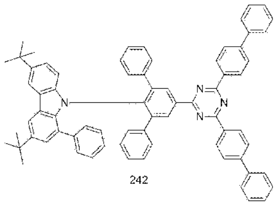
242

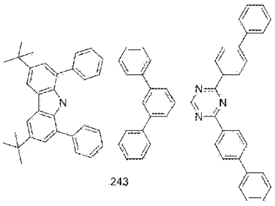
243

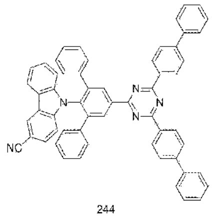
244

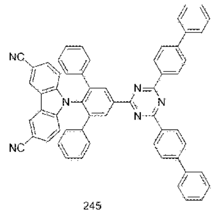
245

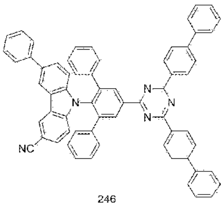
246

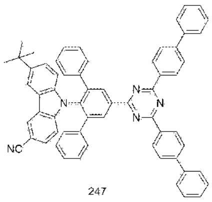
247

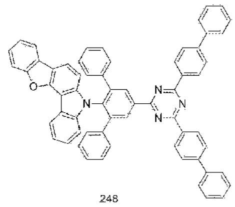
248

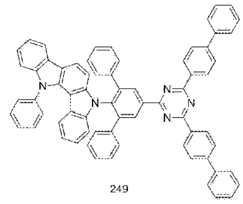
249

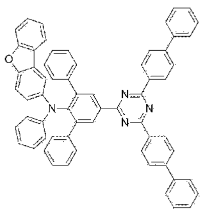
250

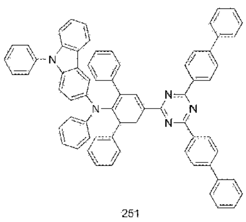
251

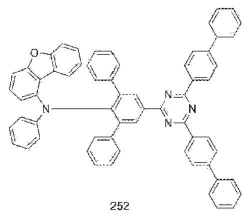
252

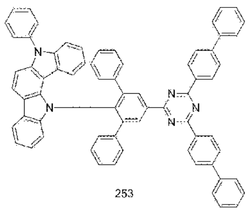
253

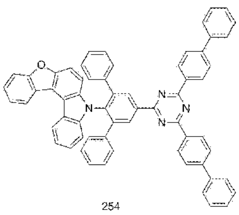
254

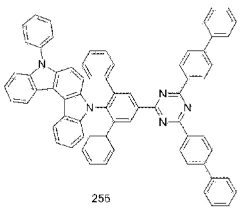
255

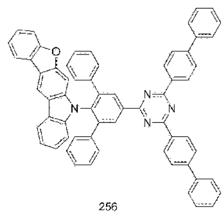
256

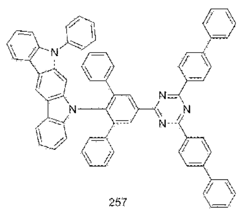
257

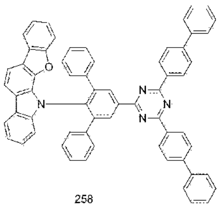
258

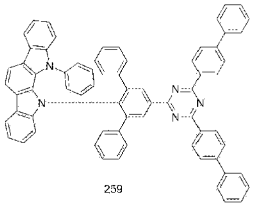
259

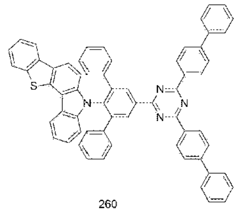
260

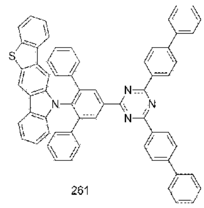
261

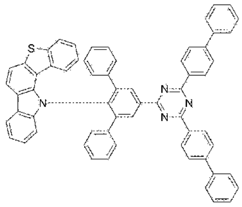
262

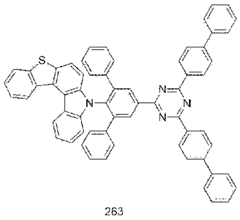
263

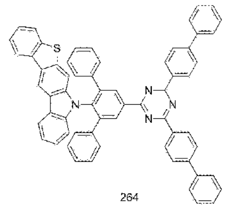
264

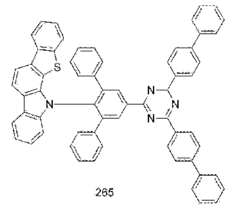
265

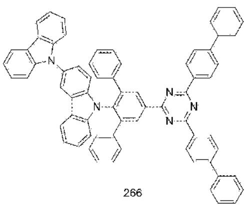
266

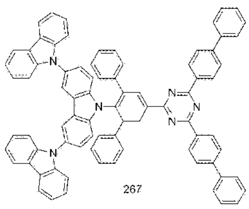
267

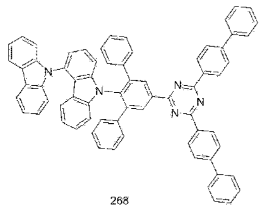
268

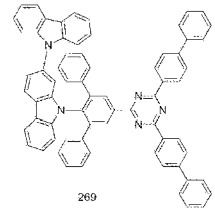
269

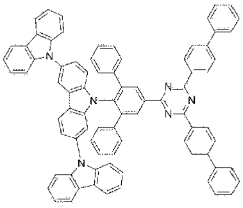
270

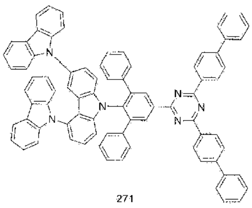
271

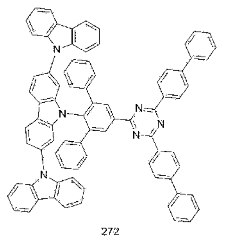
272

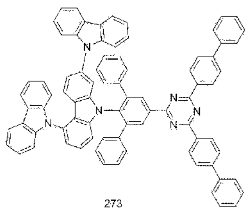
273

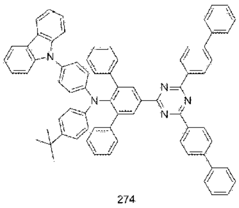
274

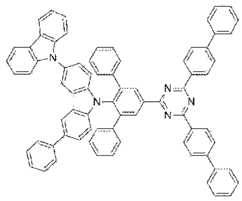
275

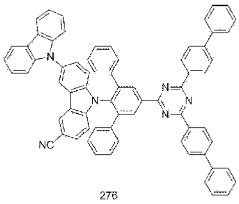
276

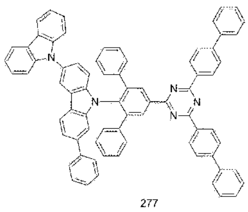
277

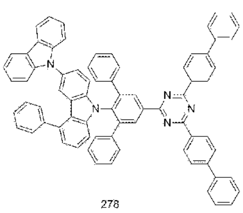
278

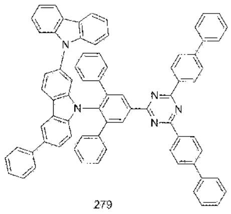
279

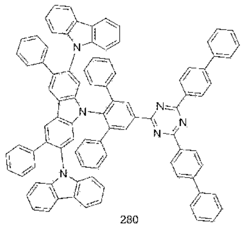
280

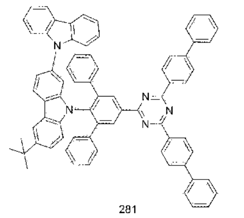
281

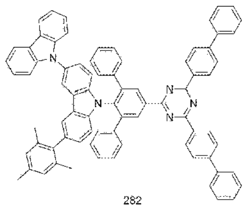
282

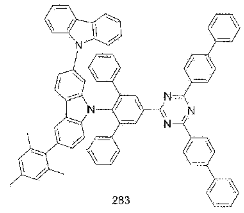
283

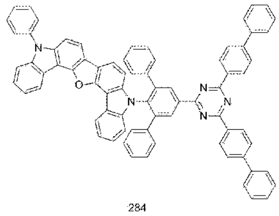
284

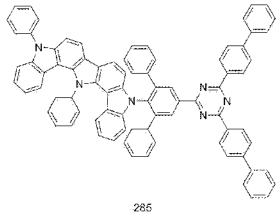
285

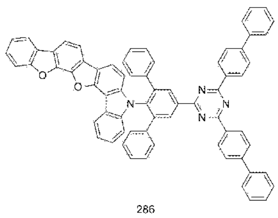
286

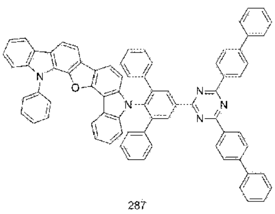
287

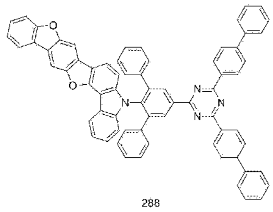
288

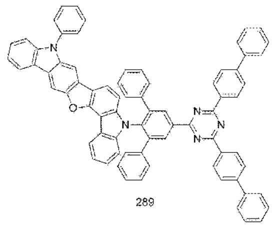
289

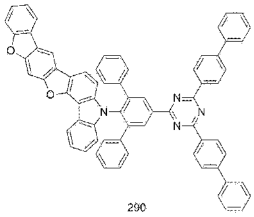
290

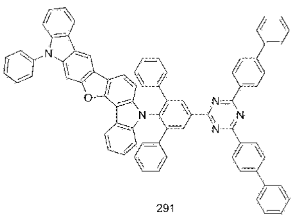
291

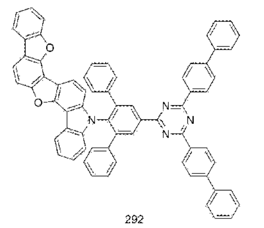
292

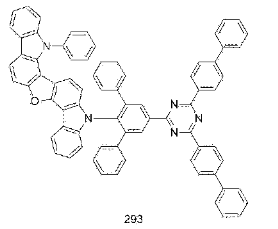
293

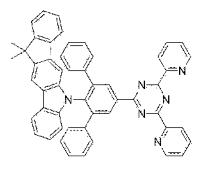
294

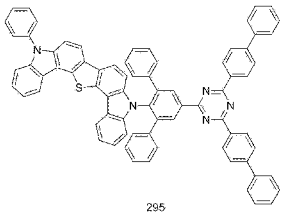
295

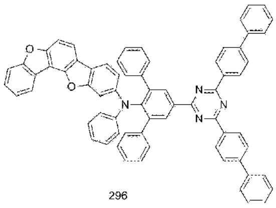
296

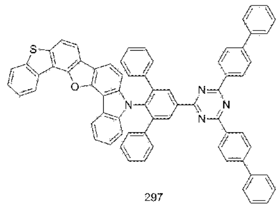
297

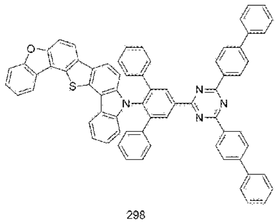
298

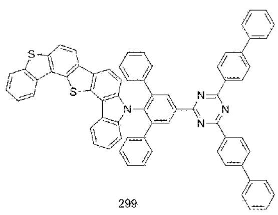
299

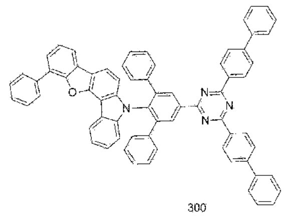
300

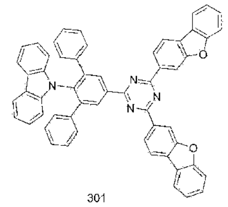
301
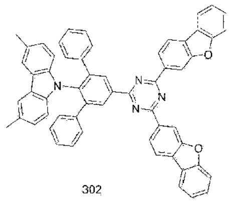
302
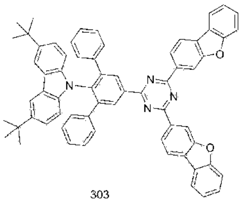
303
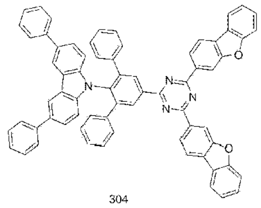
304
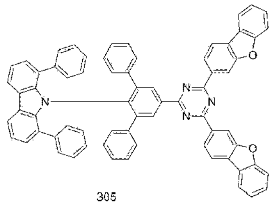
305
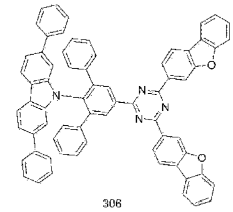
306
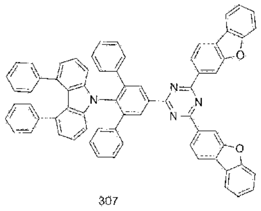
307
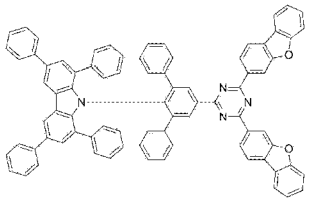
308
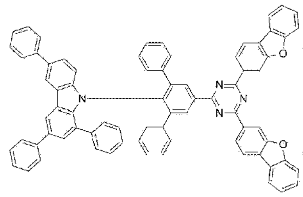
309
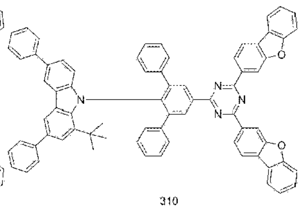
310
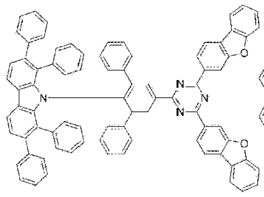
311
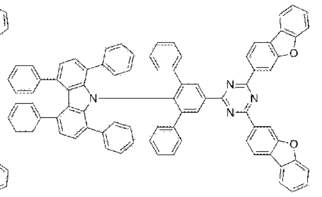
312
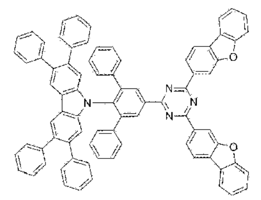
313
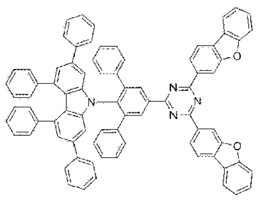
314
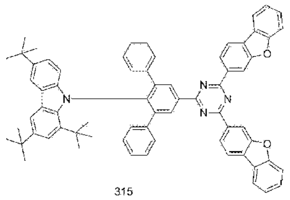
315
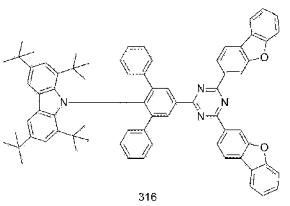
316
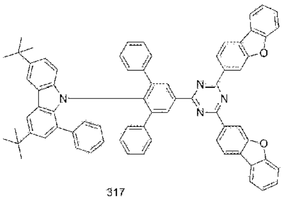
317
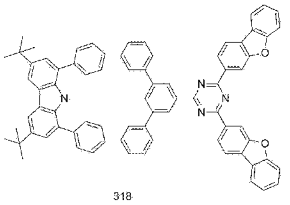
318
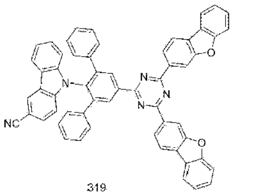
319
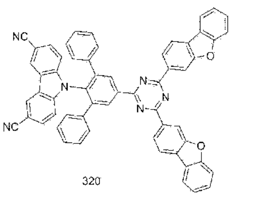
320
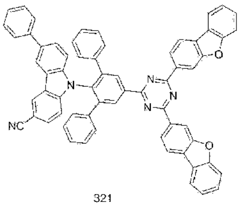
321
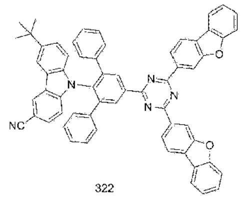
322
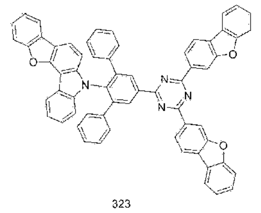
323
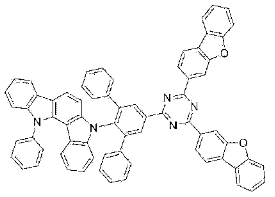
324
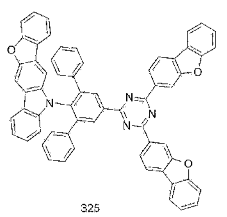
325
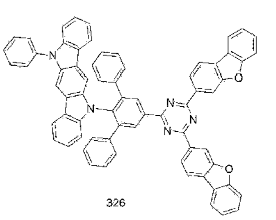
326
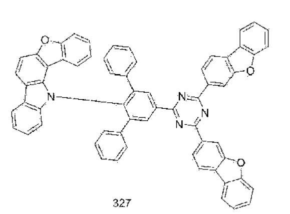
327
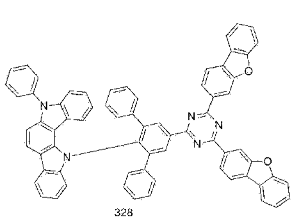
328

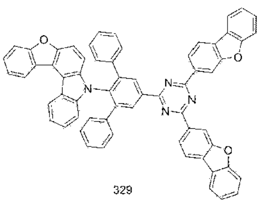
329

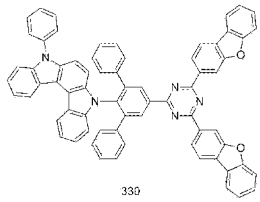
330

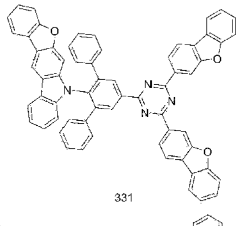
331

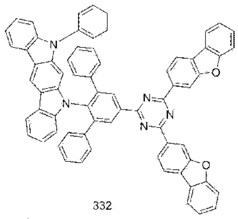
332

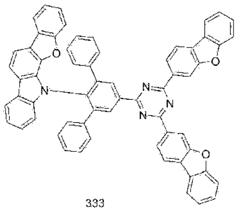
333

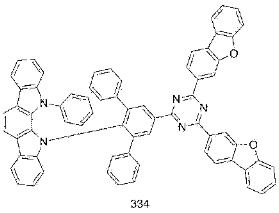
334

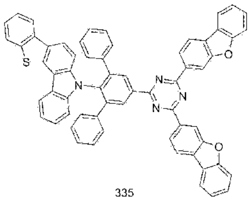
335

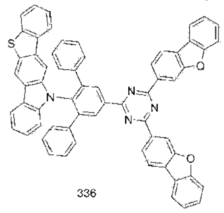
336

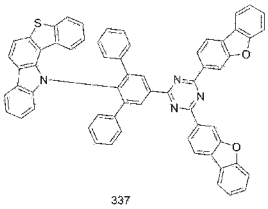
337

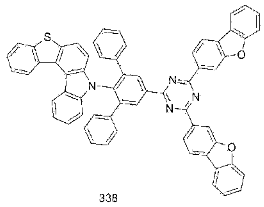
338

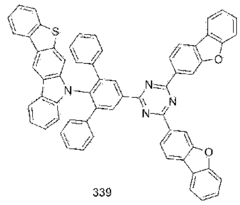
339

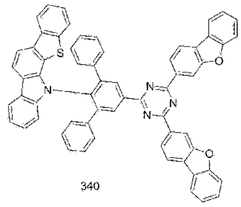
340

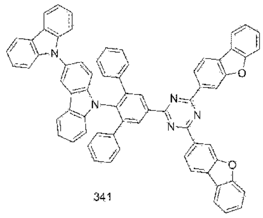
341

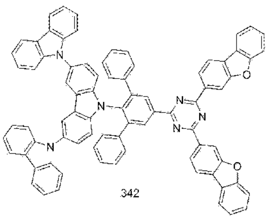
342

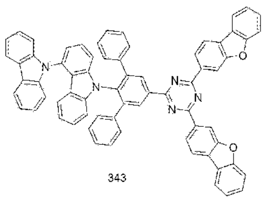
343

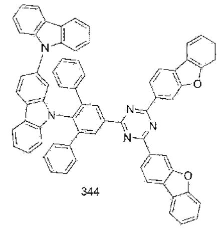
344

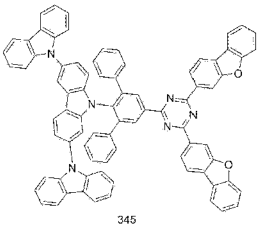
345

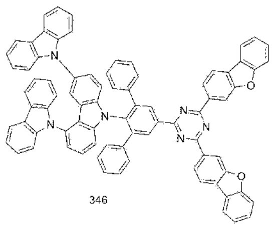
346

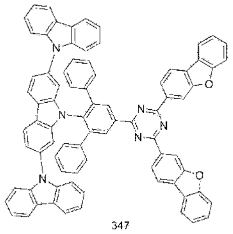
347

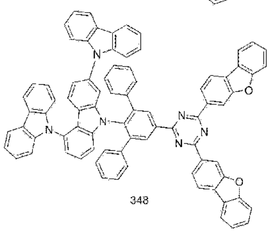
348

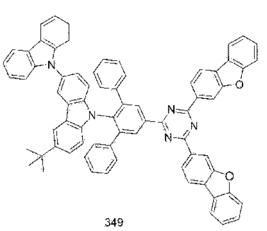
349

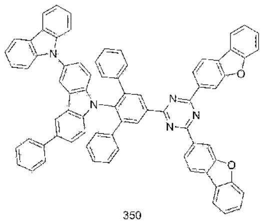
350

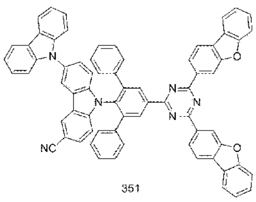
351

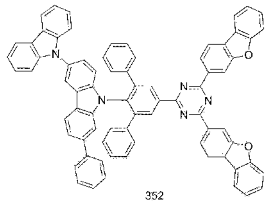
352

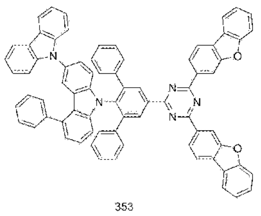
353

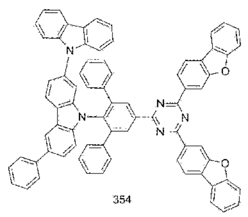
354

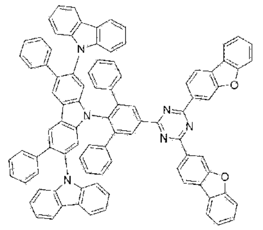
355

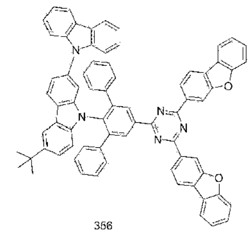
356

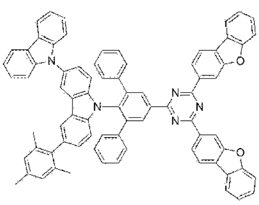
357

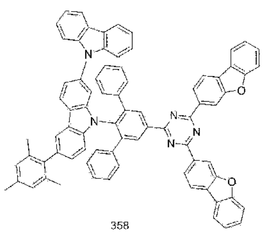
358

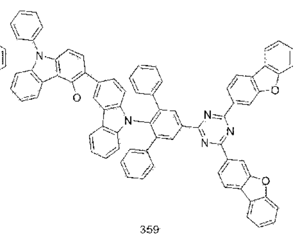
359

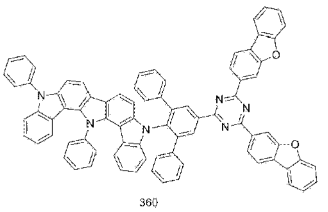
360

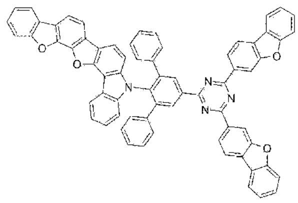
361

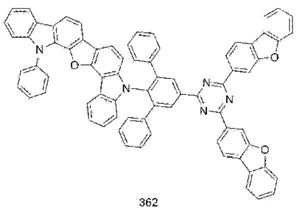
362

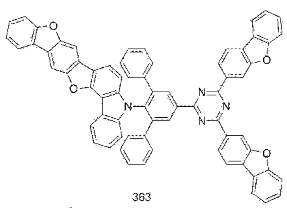
363

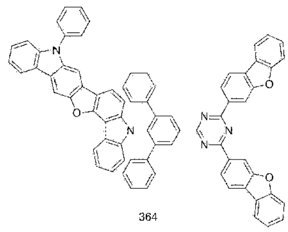
364

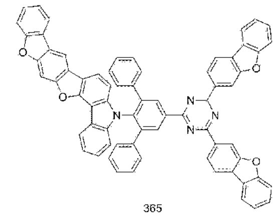
365

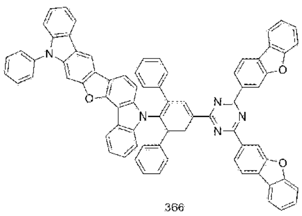
366

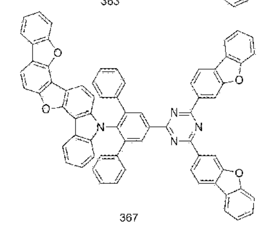
367

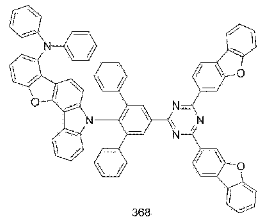
368

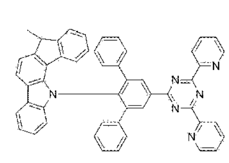
369

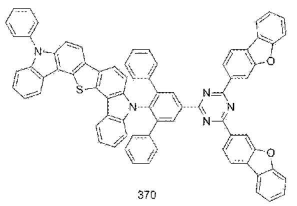
370

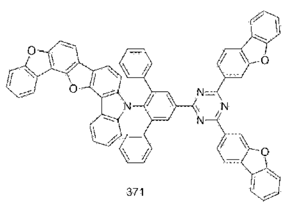
371

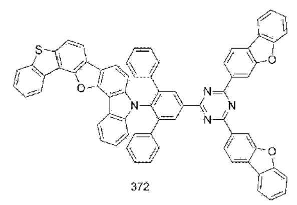
372

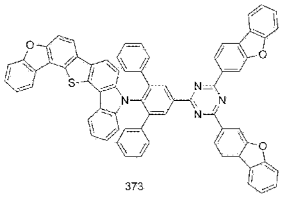
373

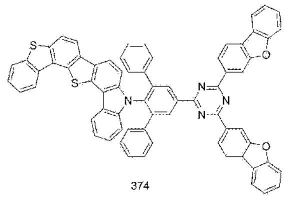
374

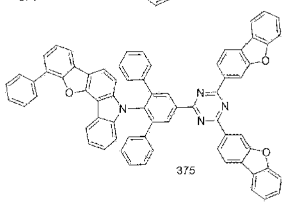
375

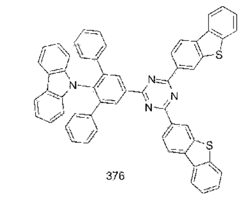
376

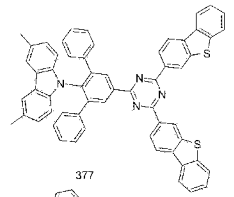
377

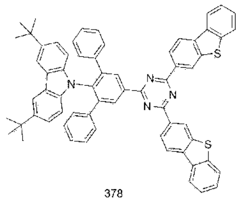
378

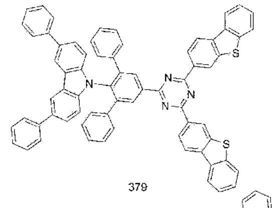
379

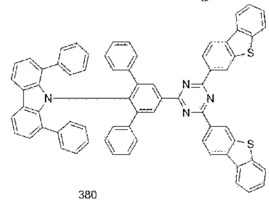
380

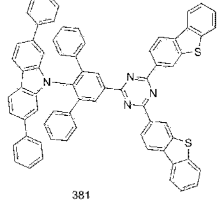
381

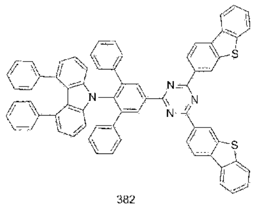
382

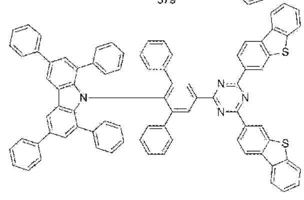
383

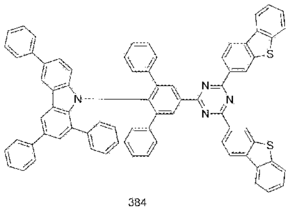
384

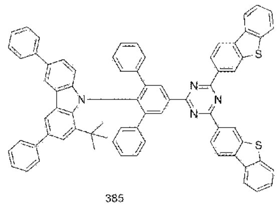
385

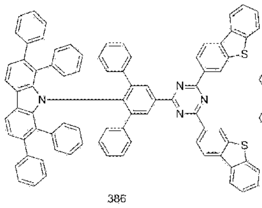
386

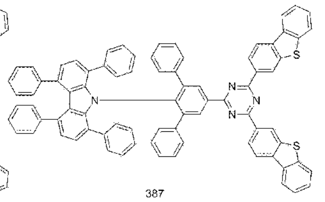
387

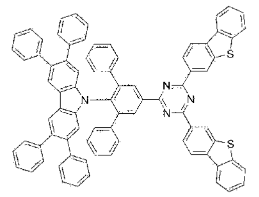
388

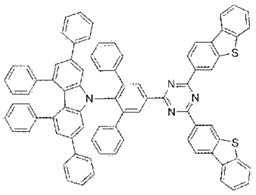
389

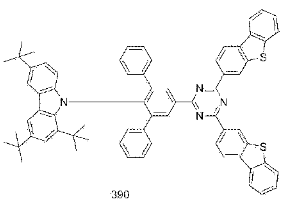
390

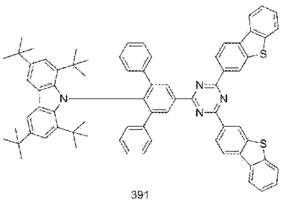
391

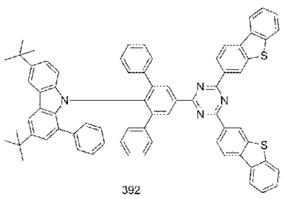
392

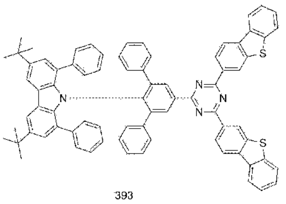
393

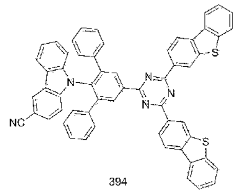
394

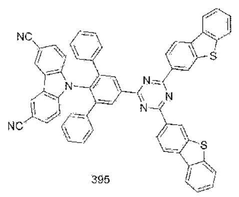
395

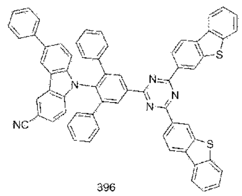
396

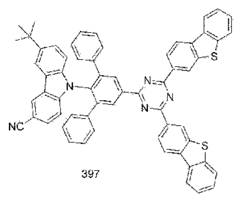
397

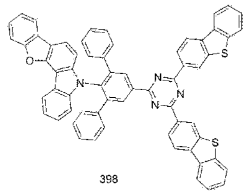
398

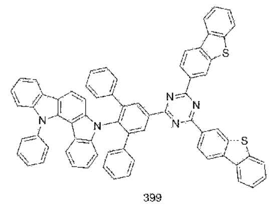
399

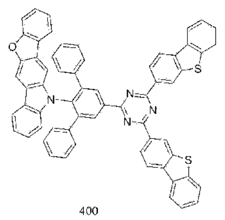
400

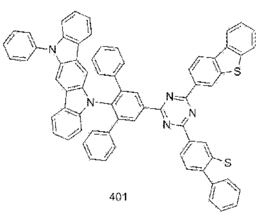
401

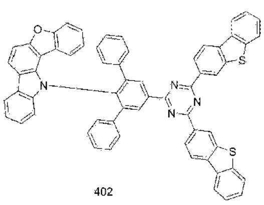
402

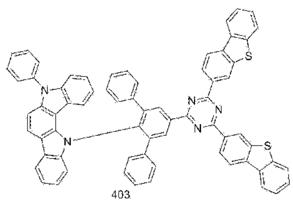
403

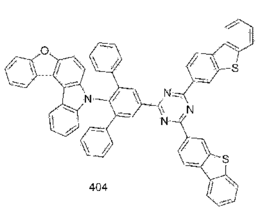
404

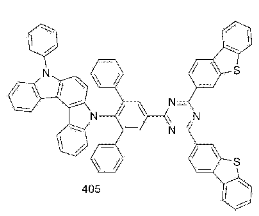
405

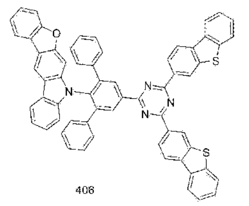
408

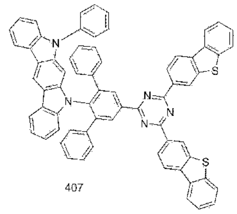
407

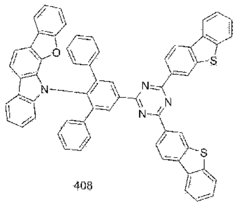
408

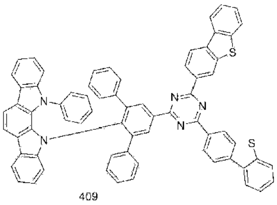
409

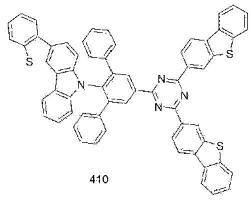
410

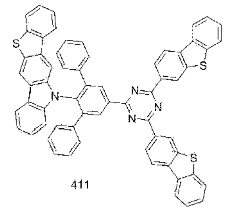
411

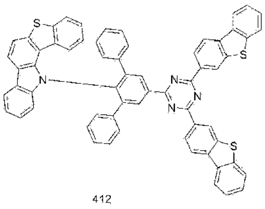
412

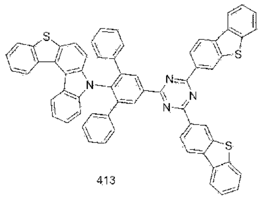
413

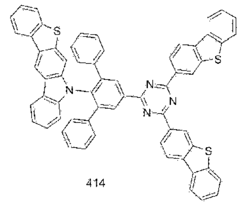
414

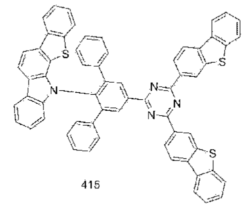
415

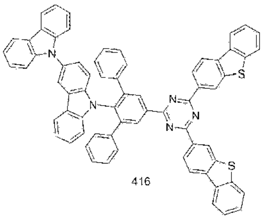
416

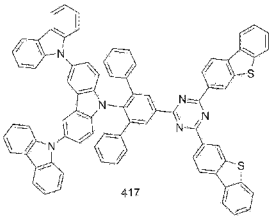
417

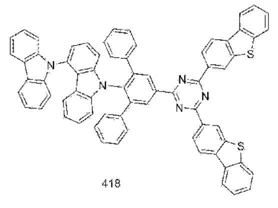
418

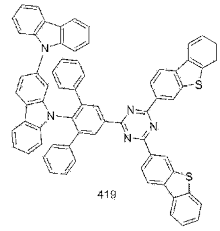
419

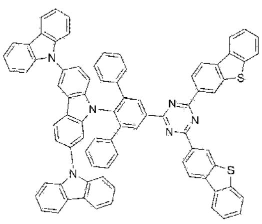
420

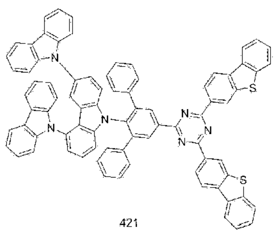
421

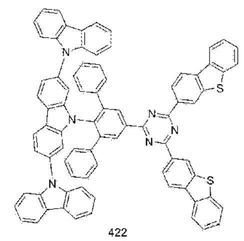
422

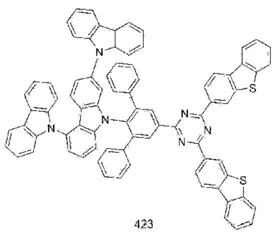
423

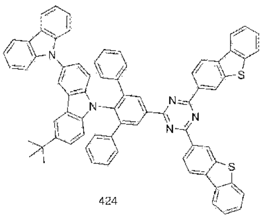
424

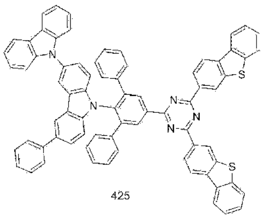
425

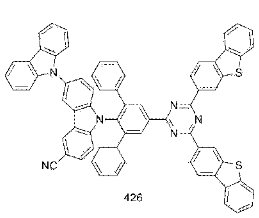
426

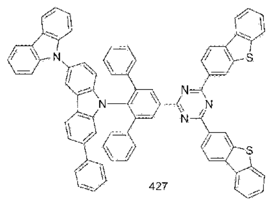
427

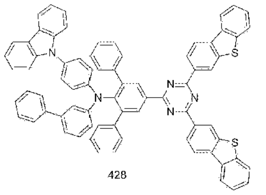
428

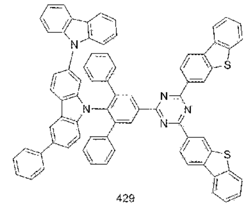
429

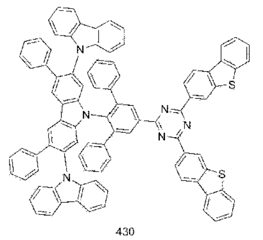
430

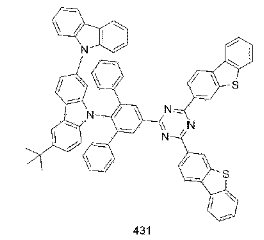
431

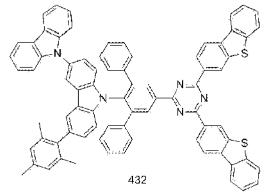
432

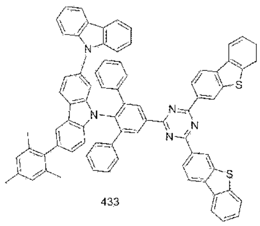
433

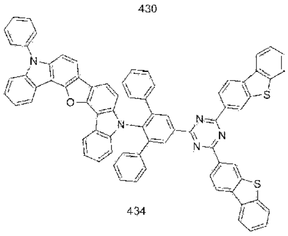
434

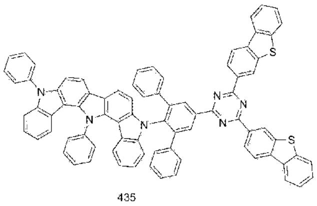
435

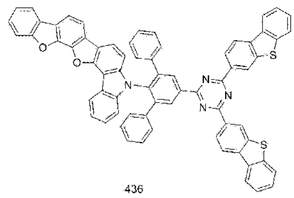
436

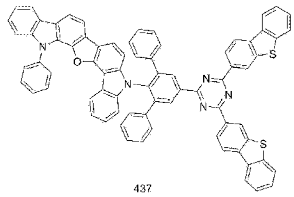
437

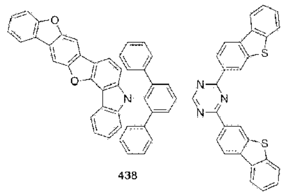
438

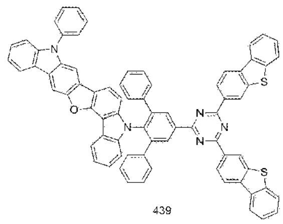
439

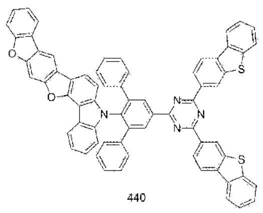
440

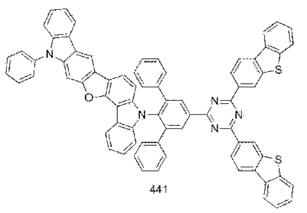
441

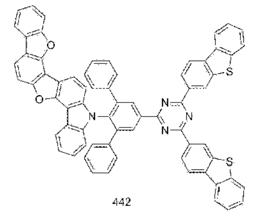
442

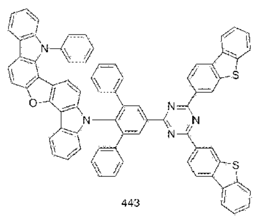
443

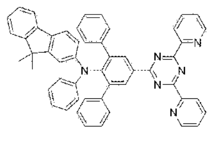
444

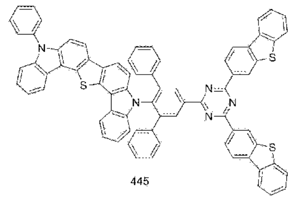
445

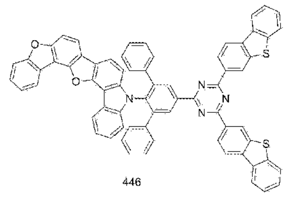
446

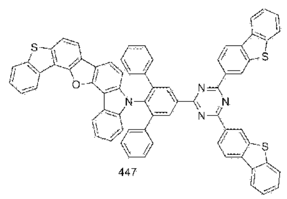
447

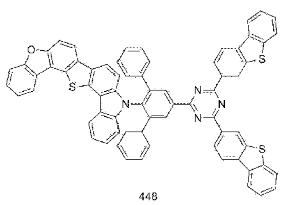
448

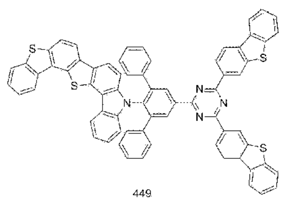
449

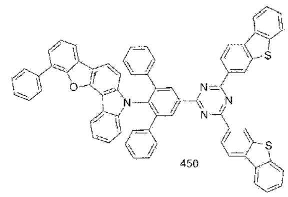
450

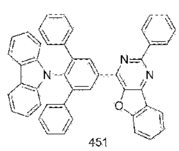
451

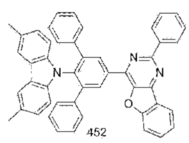
452

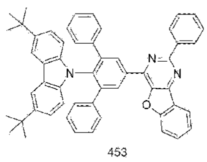
453

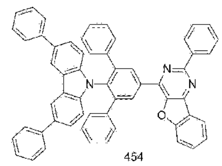
454

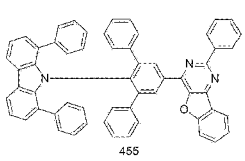
455

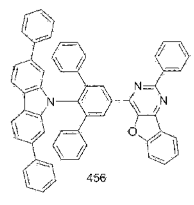
456

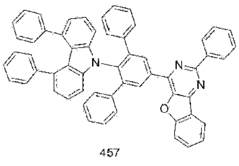
457

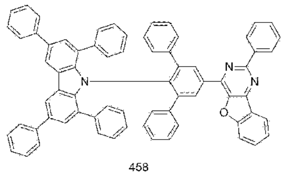
458

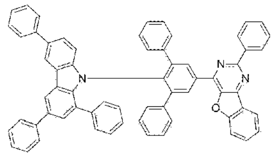
459

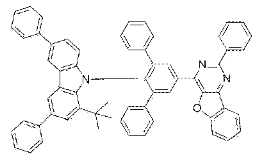
460

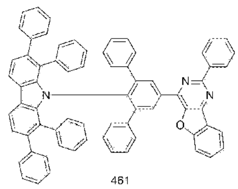
461

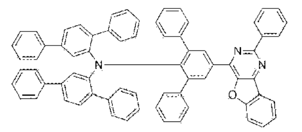
462

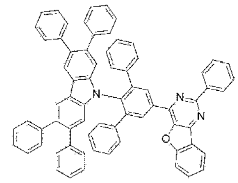
463

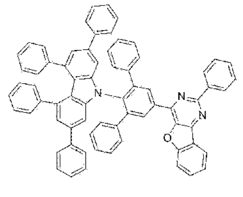
464

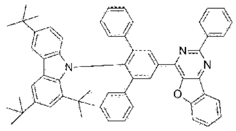
465

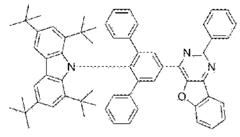
466

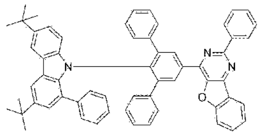
467

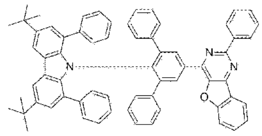
468

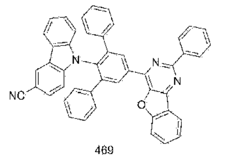
469

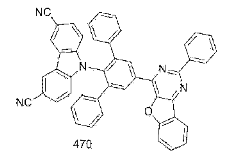
470

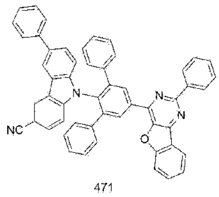
471

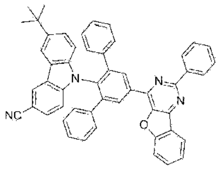
472

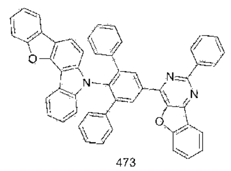
473

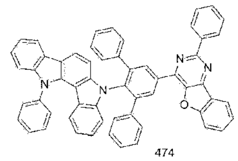
474

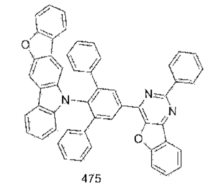
475

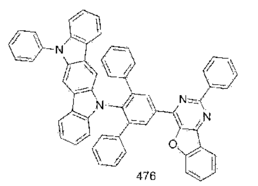
476

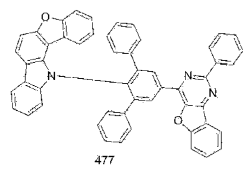
477

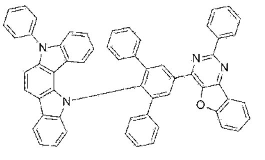
478

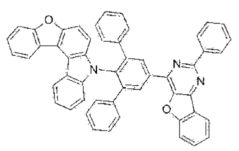
479

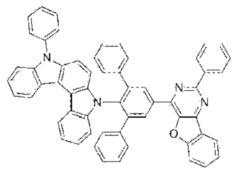
480

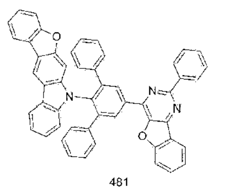
481

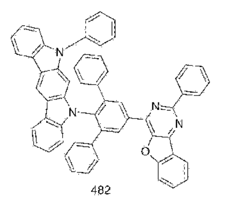
482

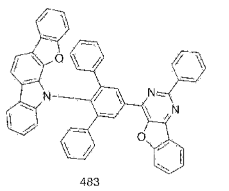
483

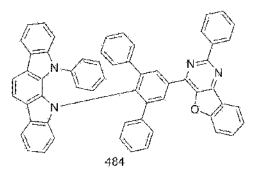
484

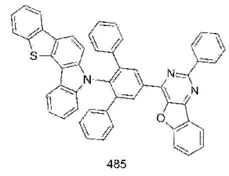
485

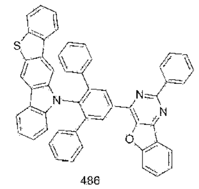
486

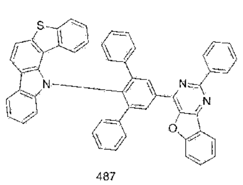
487

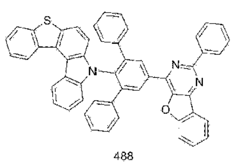
488

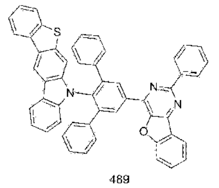
489

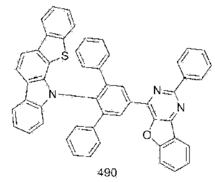
490

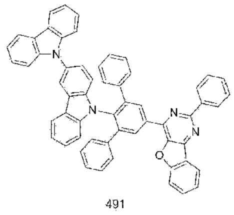
491

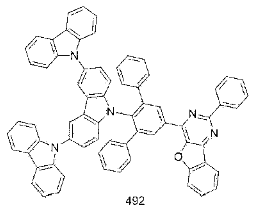
492

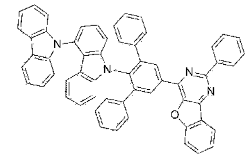
493

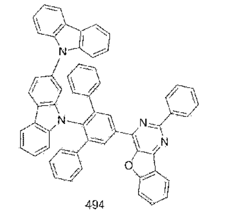
494

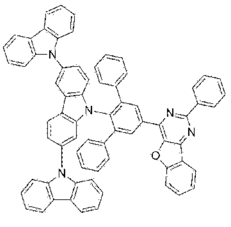
495

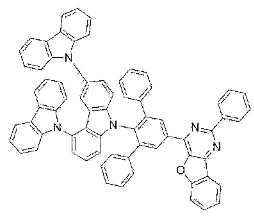
496

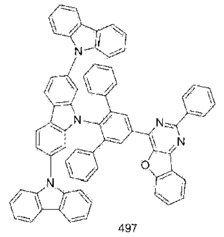
497

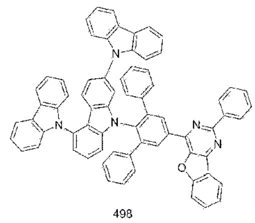
498

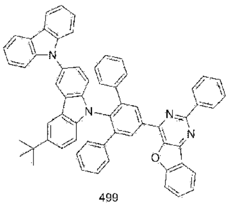
499

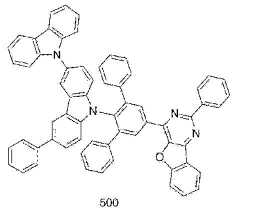
500

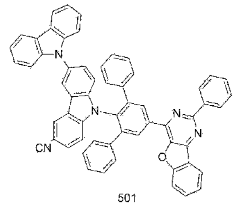
501

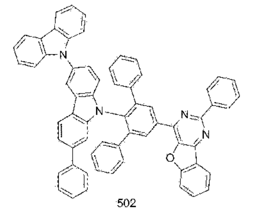
502

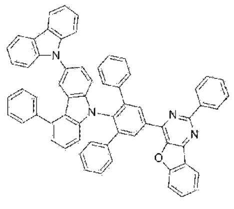
503

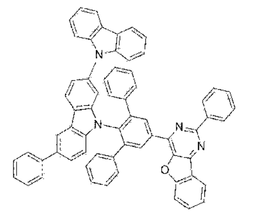
504

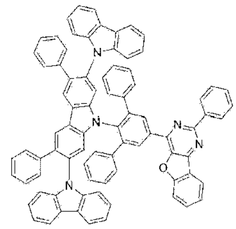
505

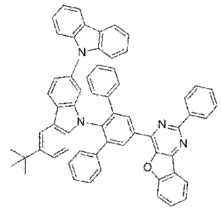
506

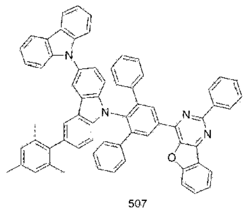
507

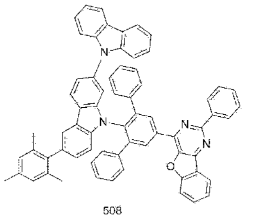
508

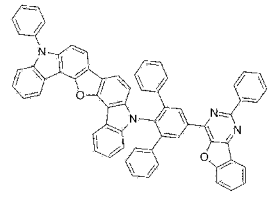
509

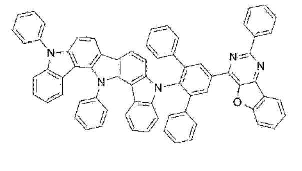
510

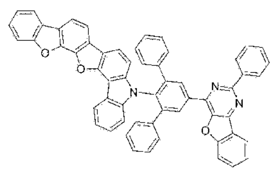
511

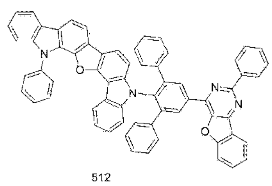
512

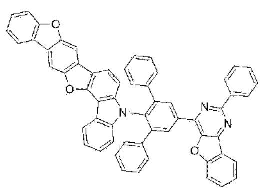
513

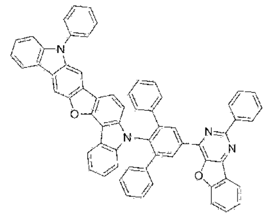
514

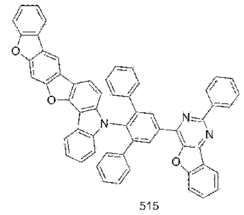
515

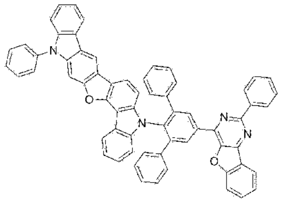
516

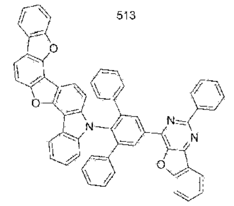
517

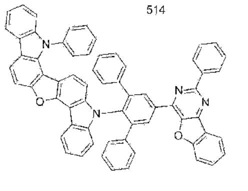
518

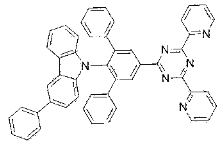
519

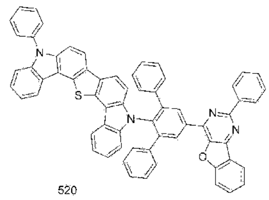
520

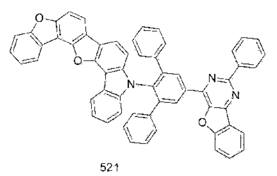
521

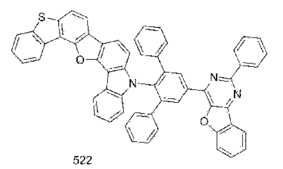
522

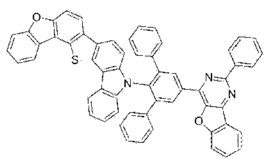
523

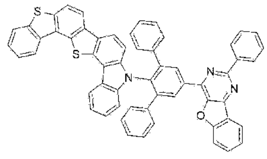
524

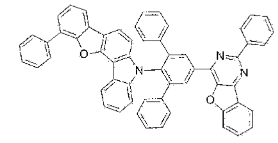
525

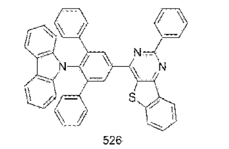
526

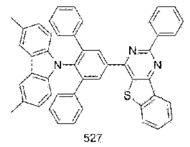
527

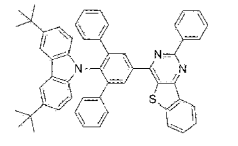
528

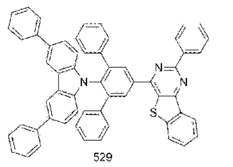
529

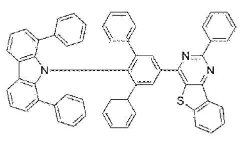
530

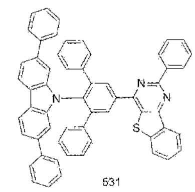
531

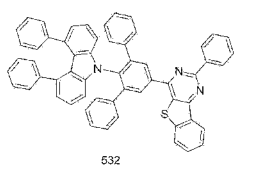
532

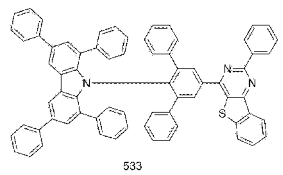
533

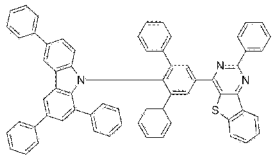
534

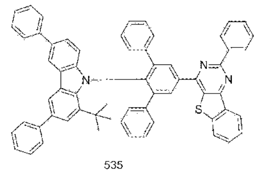
535

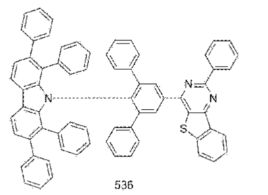
536

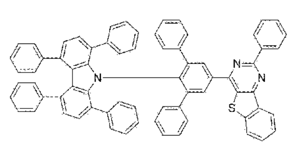
537

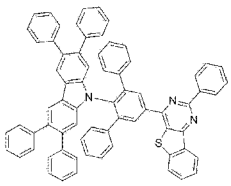
538

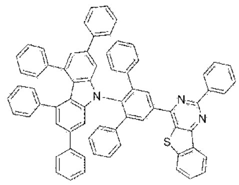
539

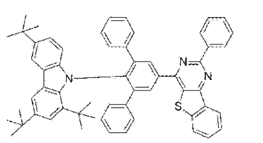
540

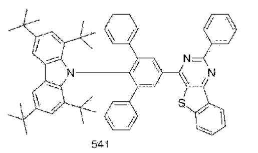
541

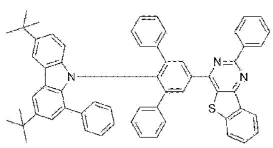
542

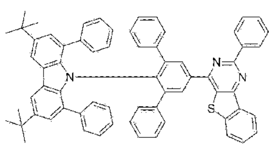
543

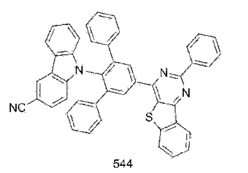
544

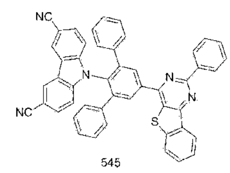
545

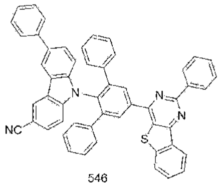
546

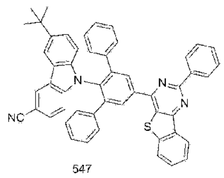
547

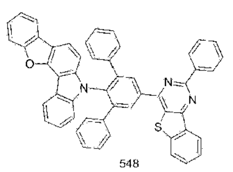
548

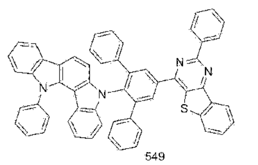
549

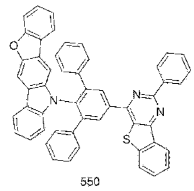
550

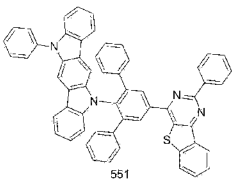
551

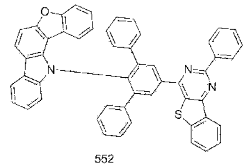
552

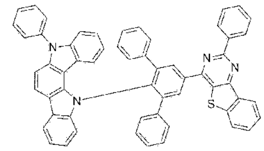
553

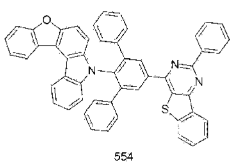
554

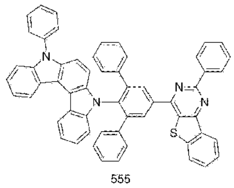
555

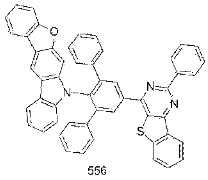
556

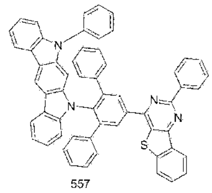
557

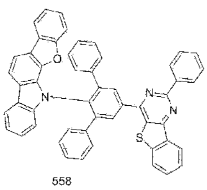
558

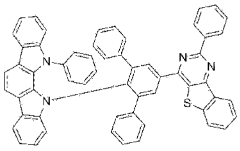
559

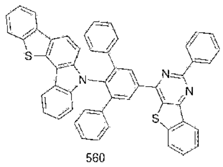
560

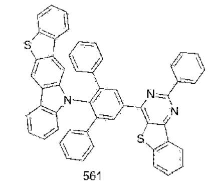
561

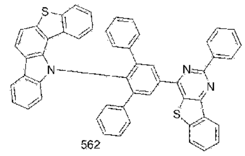
562

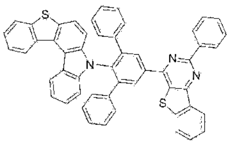
563

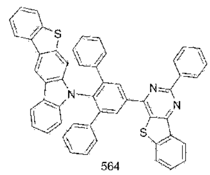
564

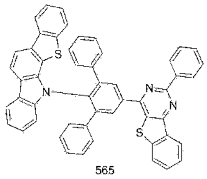
565

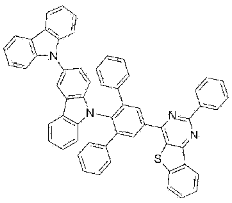
566

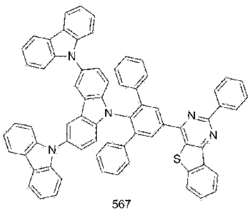
567

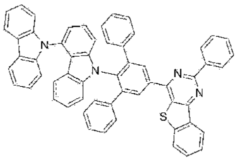
568

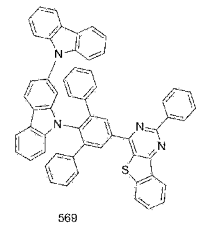
569

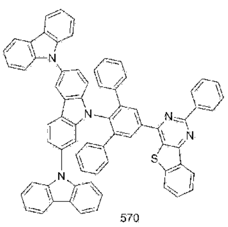
570

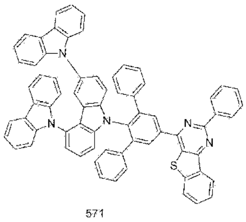
571

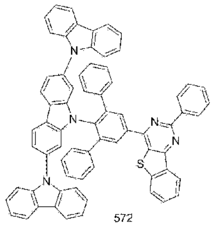
572

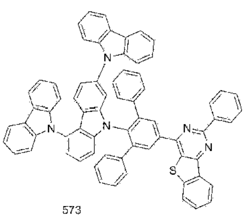
573

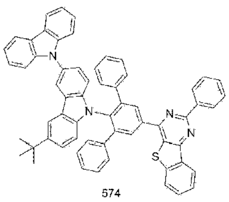
574

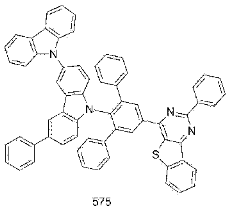
575

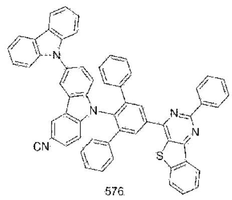
576

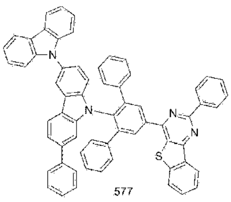
577

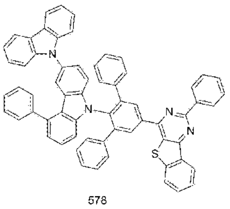
578

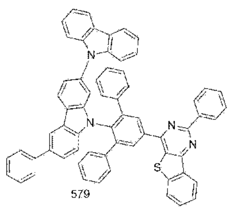
579

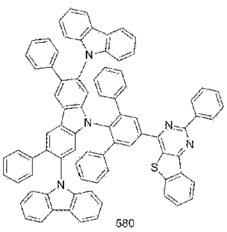
580

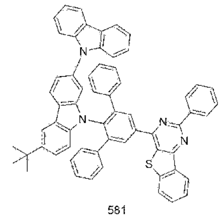
581

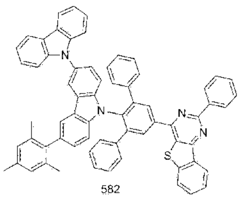
582

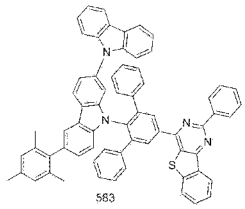
583

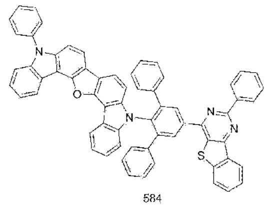
584

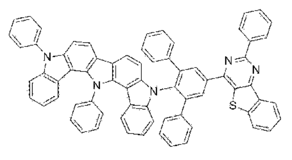
585

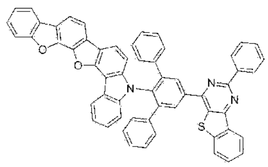
586

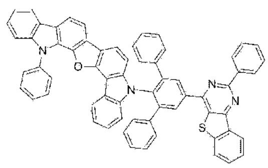
587

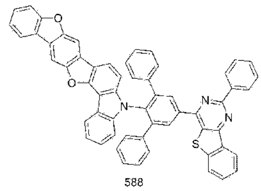
588

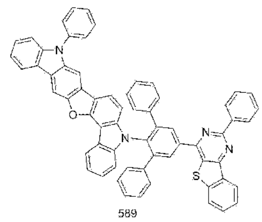
589

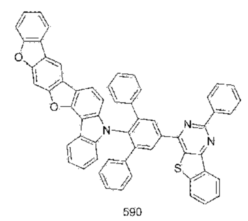
590

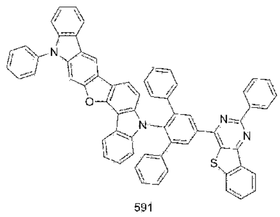
591

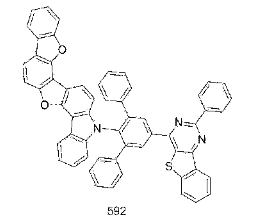
592

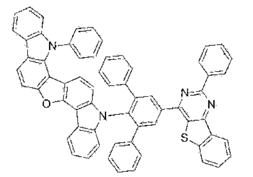
593

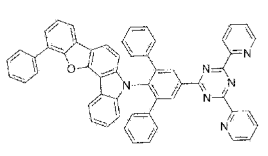
594

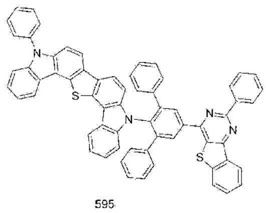
595

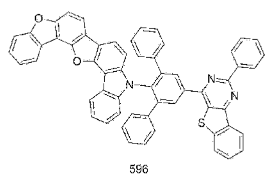
596

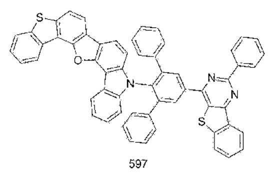
597

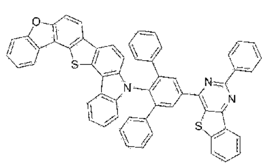
598

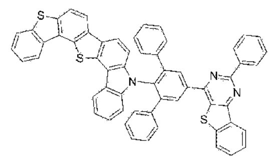
599

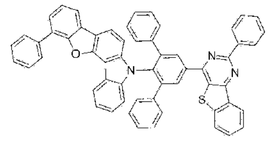
600

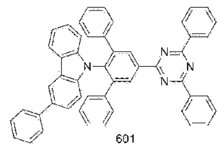
601

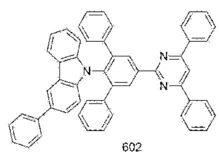
602

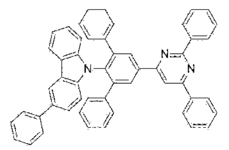
603

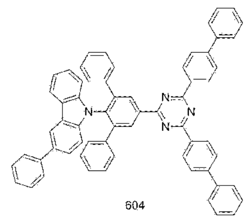
604

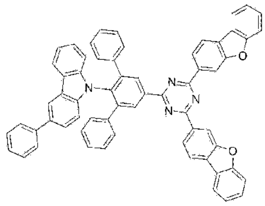
605

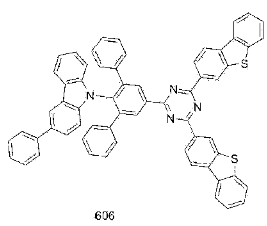
606

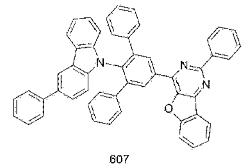
607

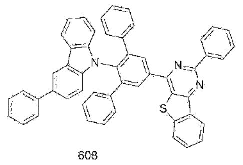
608

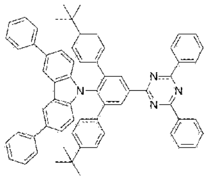
609

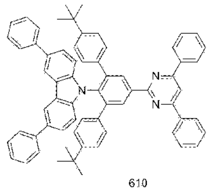
610

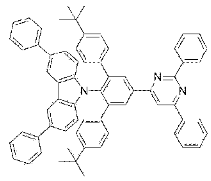
611

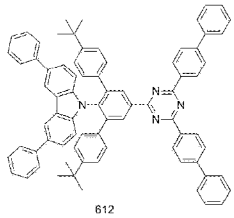
612

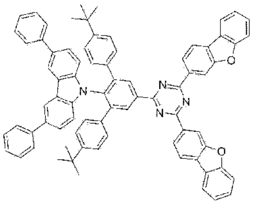
613

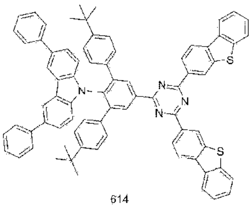
614

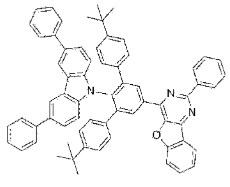
615

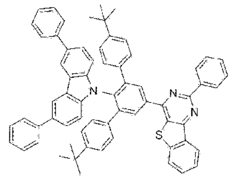
616

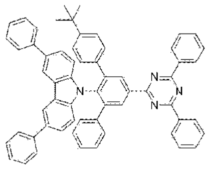
617

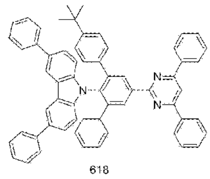
618

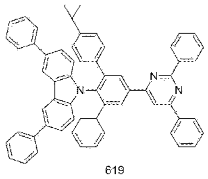
619

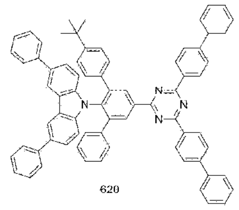
620

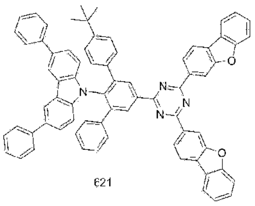
621

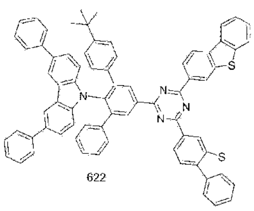
622

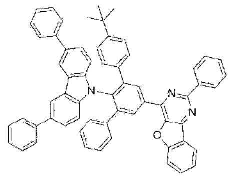
623

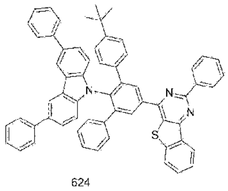
624

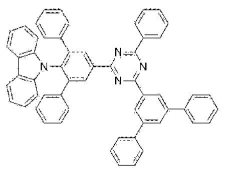
625

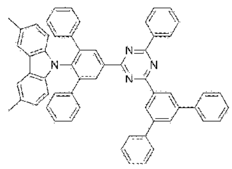
626

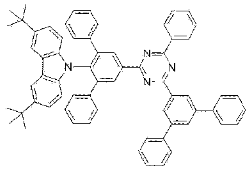
627

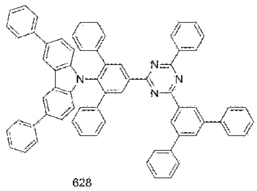
628

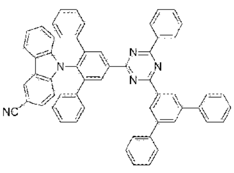
629

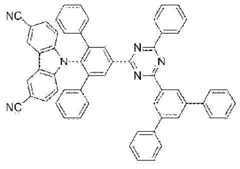
630

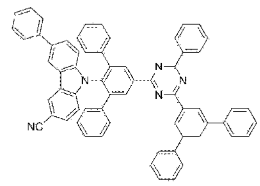
631

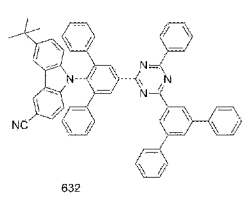
632

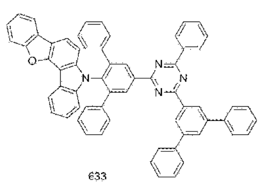
633

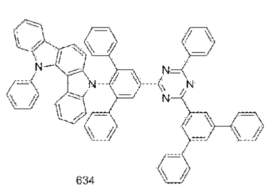
634

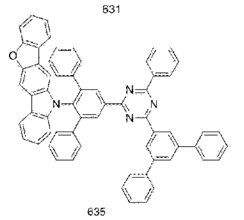
635

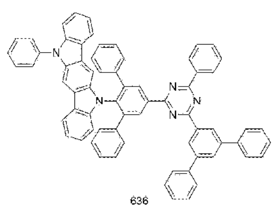
636

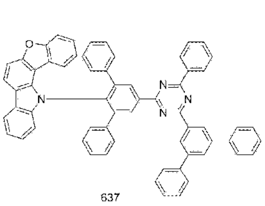
637

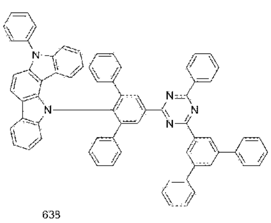
638

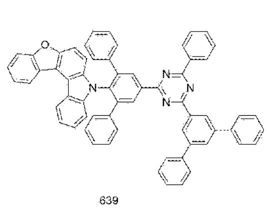
639

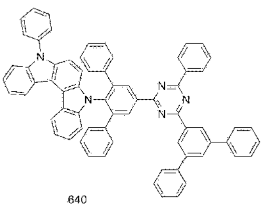
640

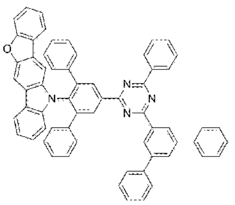
641

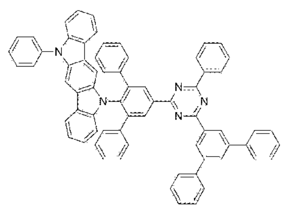
642

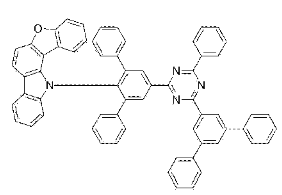
643

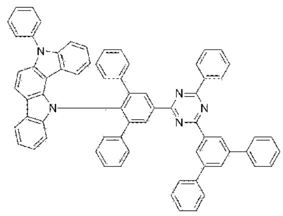
644

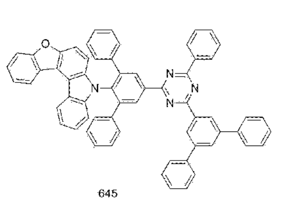
645

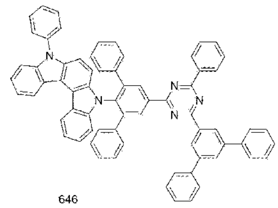
646

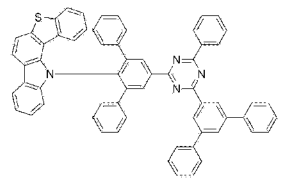
647

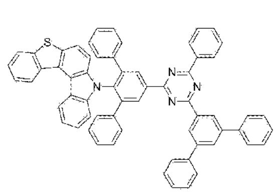
648

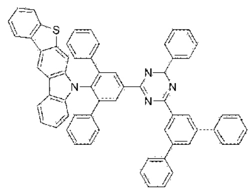
649

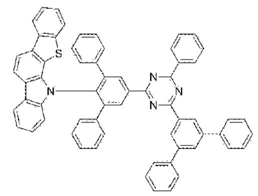
650

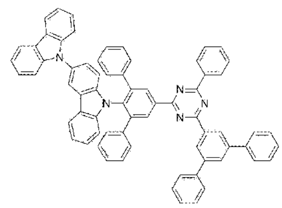
651

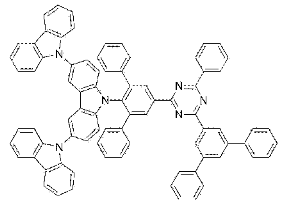
652

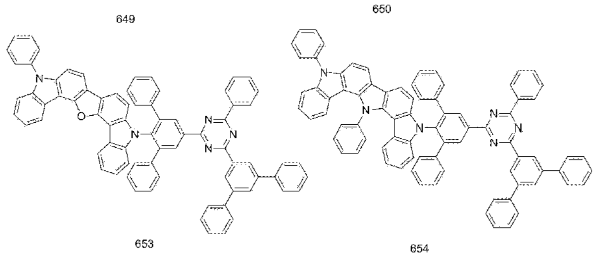
653

654

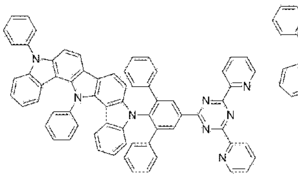
655

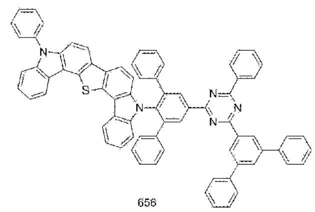
656

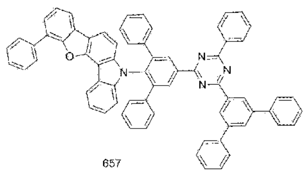
657

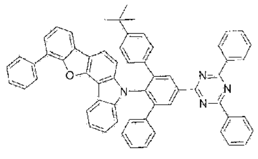
658

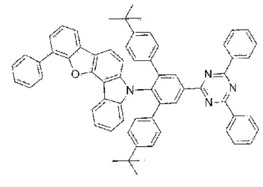
659

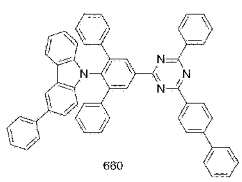
660

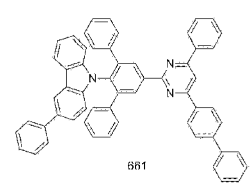
661

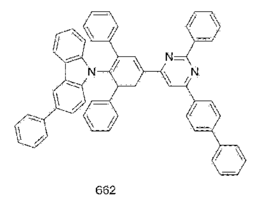
662

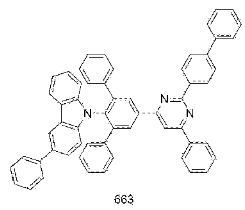
663

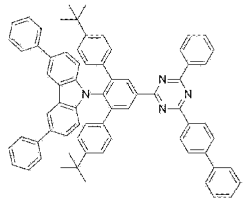
664

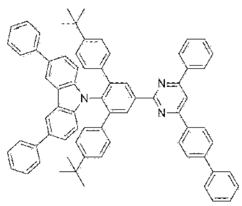
665

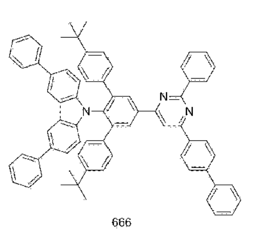
666

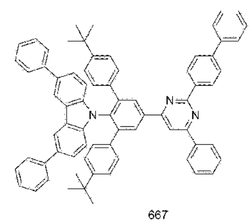
667

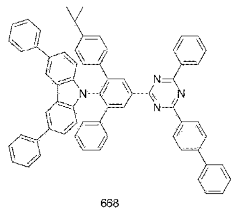
668

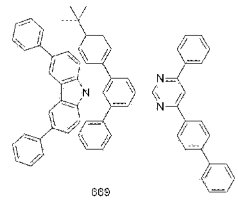
669

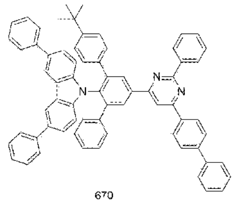
670

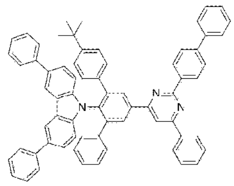
671

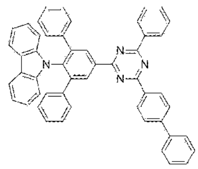
672

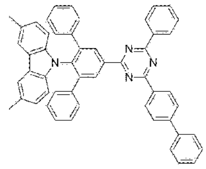
673

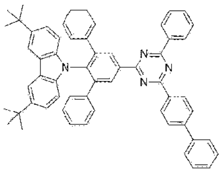
674

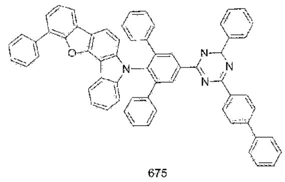
675

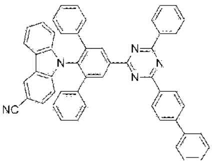
676

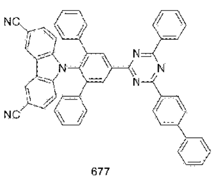
677

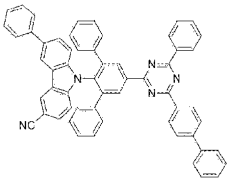
678

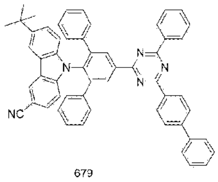
679

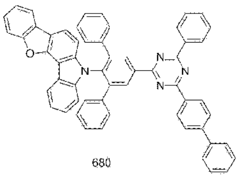
680

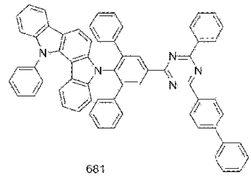
681

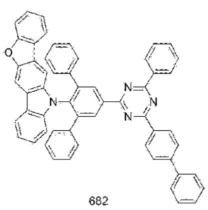
682

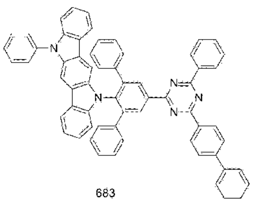
683

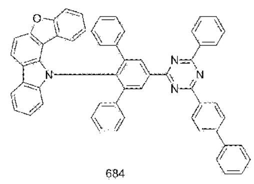
684

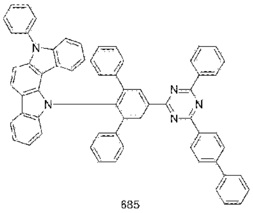
685

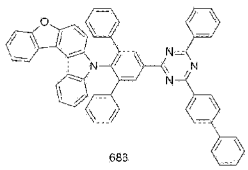
686

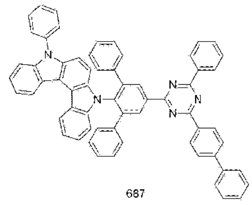
687

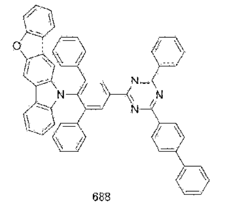
688

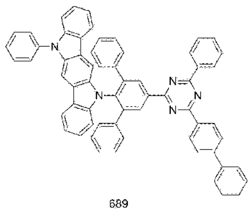
689

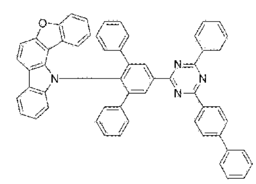
690

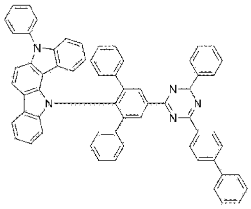
691

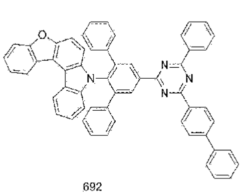
692

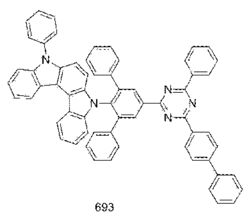
693

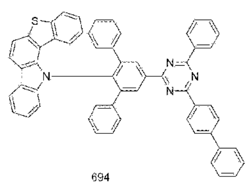
694

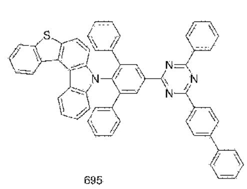
695

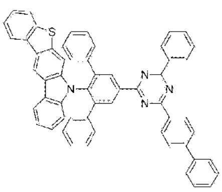
696

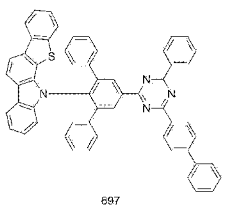
697

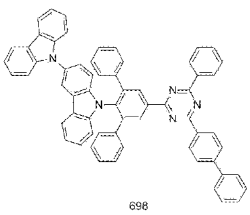
698

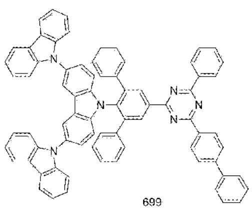
699

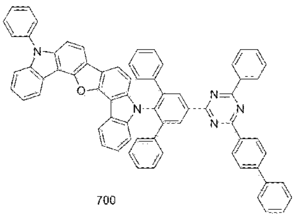
700

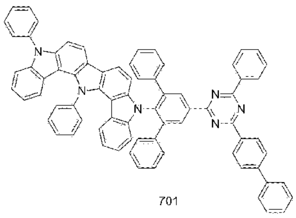
701

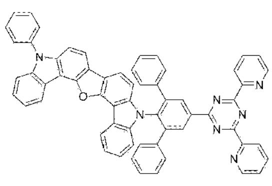
702

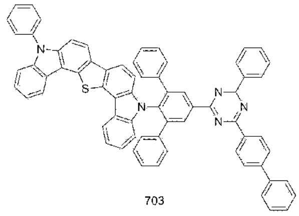
703

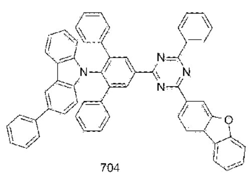
704

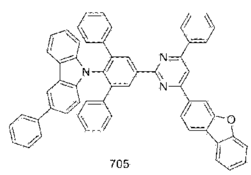
705

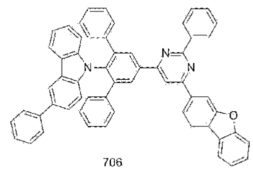
706

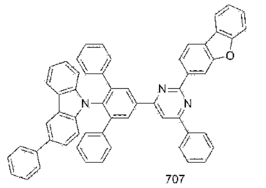
707

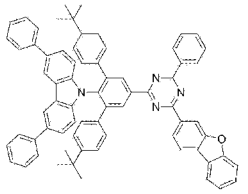
708

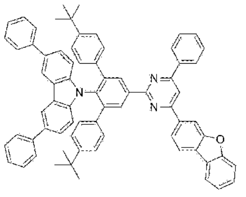
709

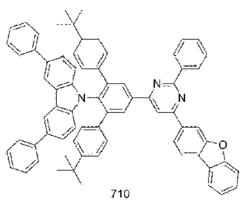
710

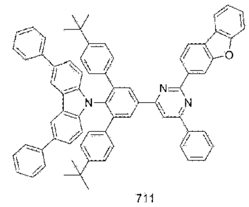
711

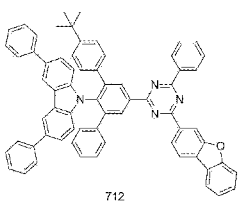
712

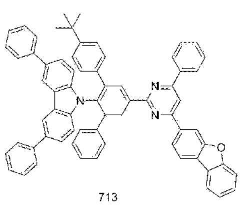
713

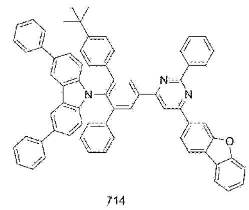
714

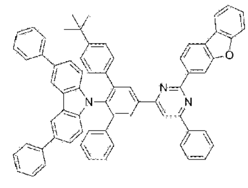
715

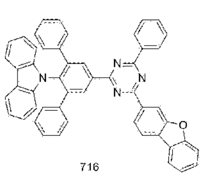
716

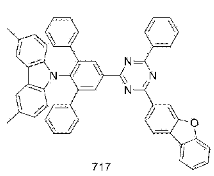
717

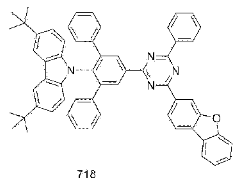
718

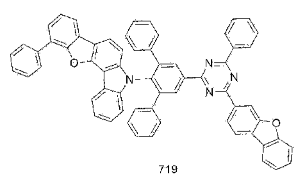
719

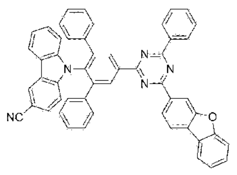
720

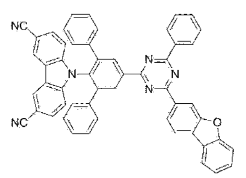
721

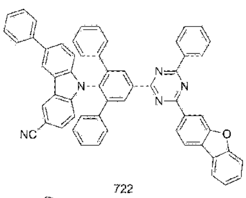
722

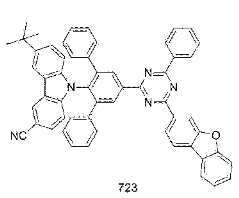
723

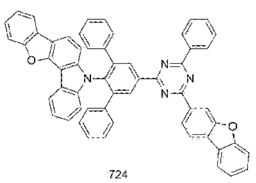
724

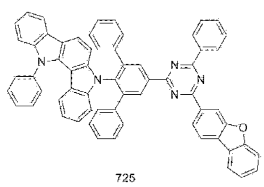
725

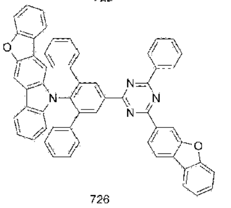
726

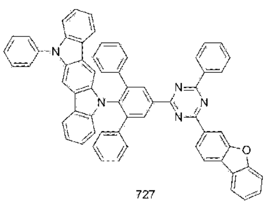
727

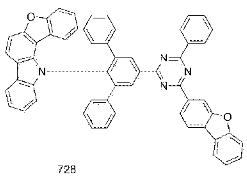
728

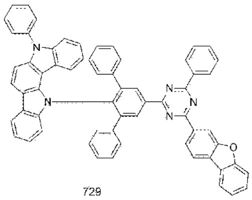
729

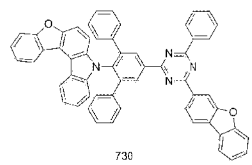
730

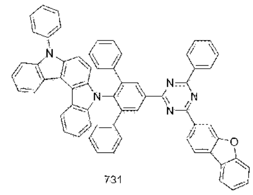
731

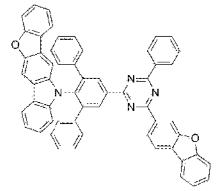
732

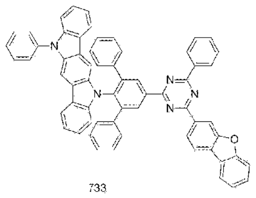
733

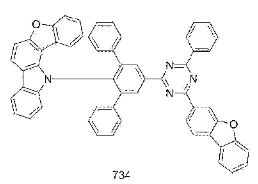
734

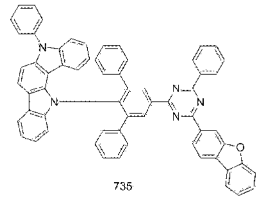
735

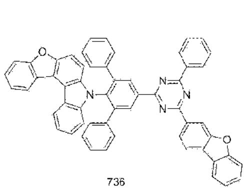
736

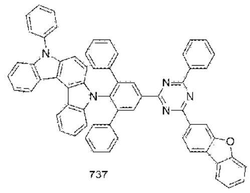
737

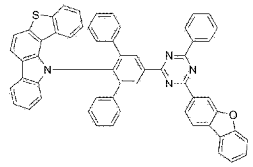
738

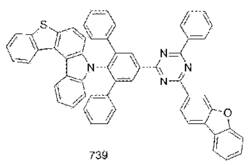
739

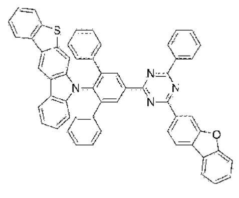
740

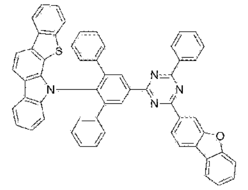
741

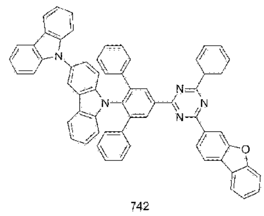
742

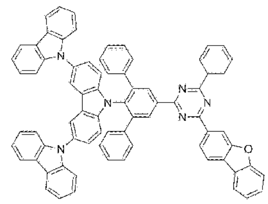
743

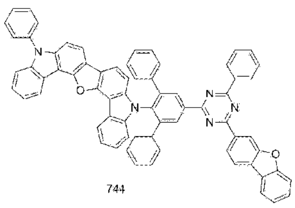
744

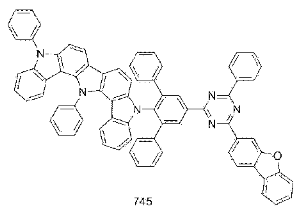
745

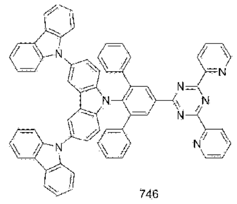
746

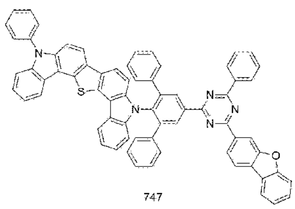
747

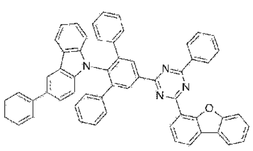
748

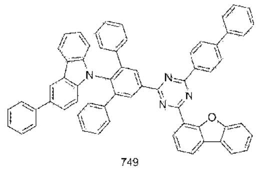
749

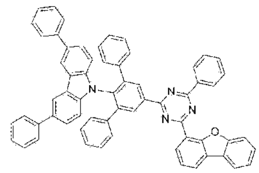
750

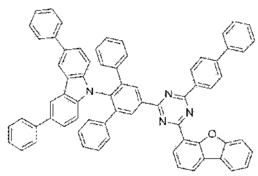
751

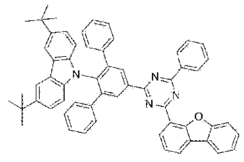
752

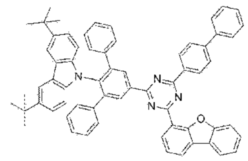
753

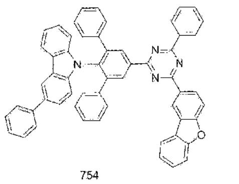
754

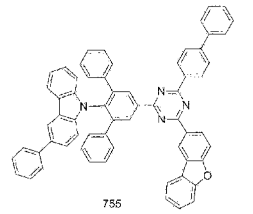
755

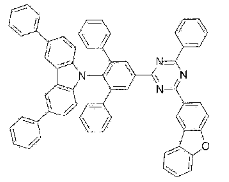
756

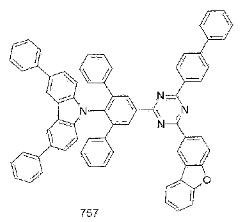
757

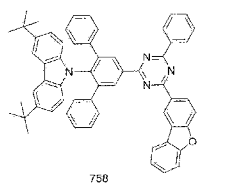
758

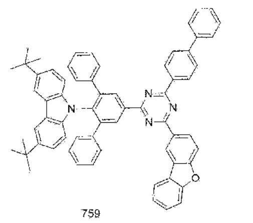
759

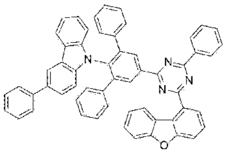
760
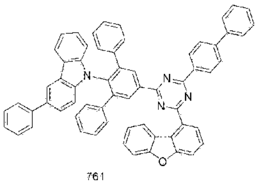
761
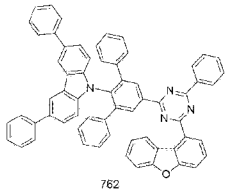
762
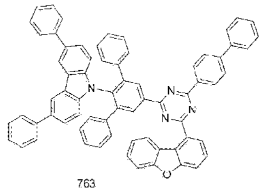
763
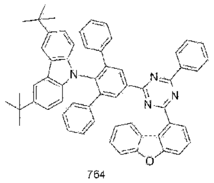
764
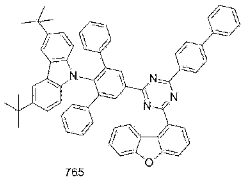
765
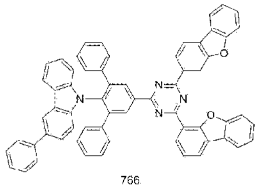
766
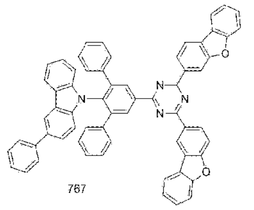
767
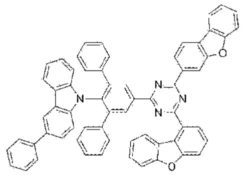
768
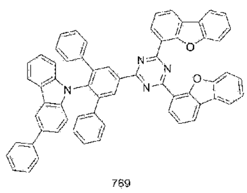
769
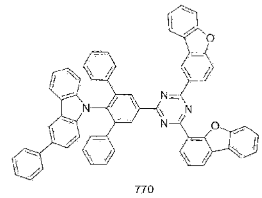
770
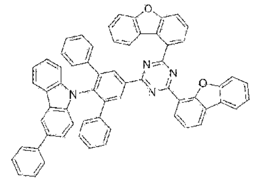
771
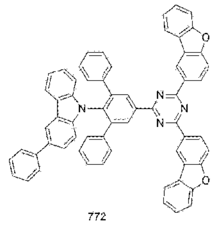
772
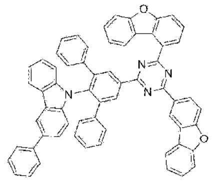
773
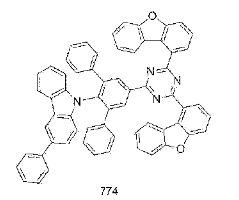
774
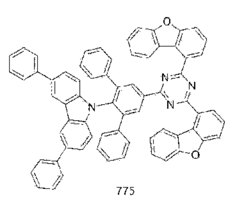
775
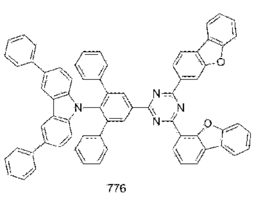
776
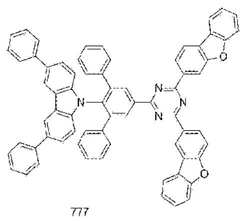
777
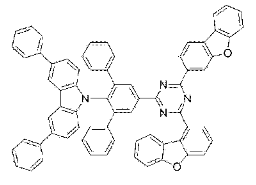
778
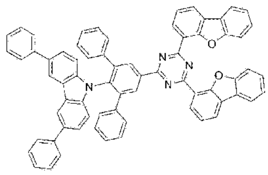
779
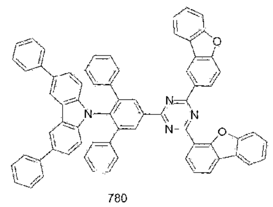
780
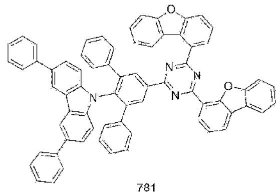
781
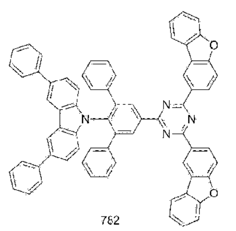
782
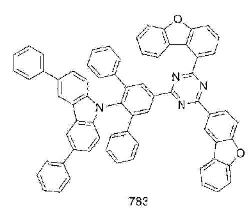
783
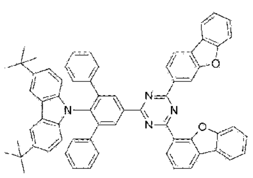
784
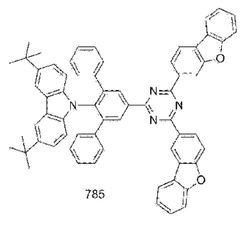
785
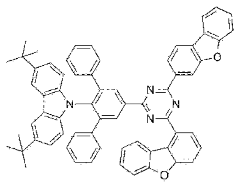
786
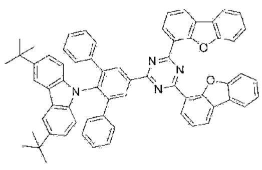
787
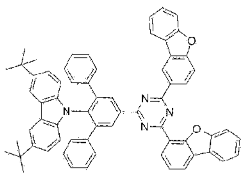
788
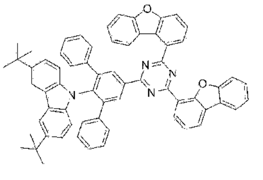
789
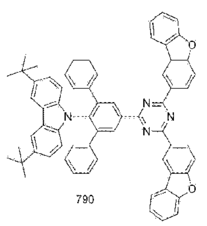
790
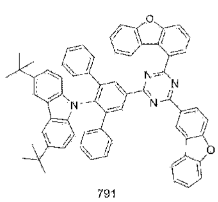
791
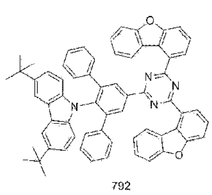
792

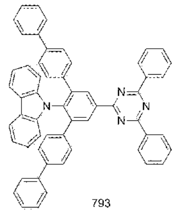
793

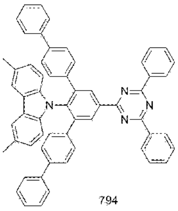
794

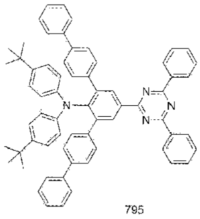
795

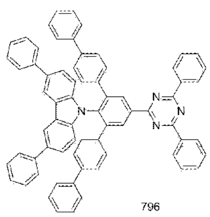
796

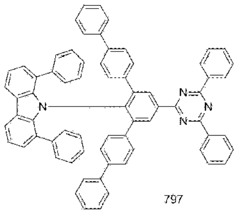
797

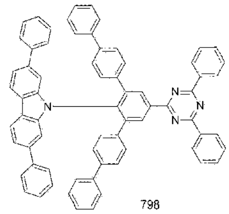
798

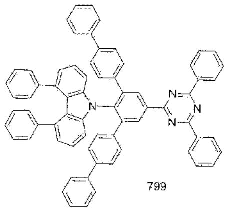
799

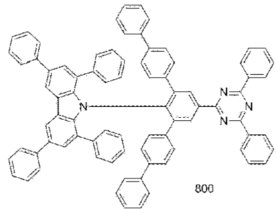
800

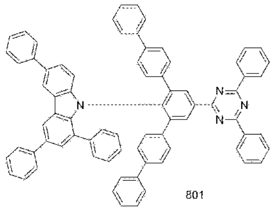
801

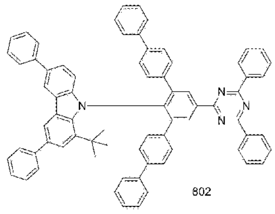
802

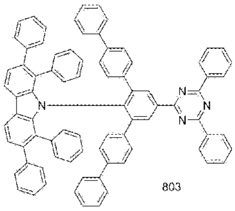
803

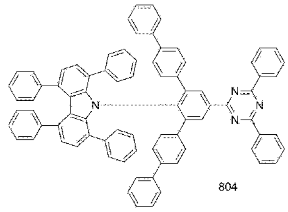
804

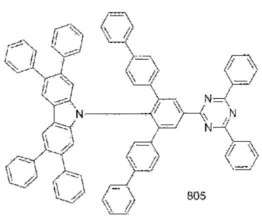
805

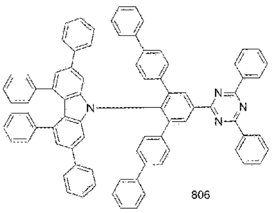
806

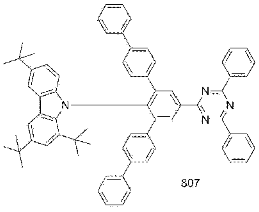
807

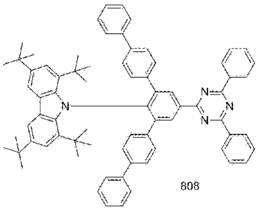
808

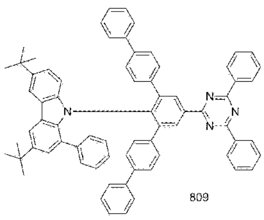
809

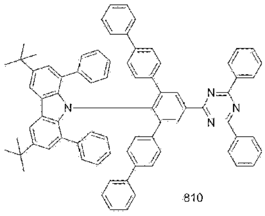
810

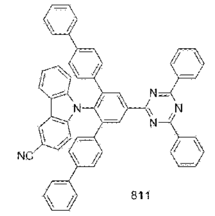
811

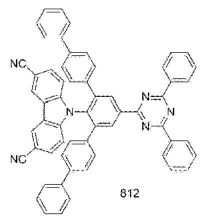
812

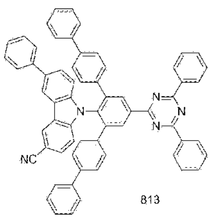
813

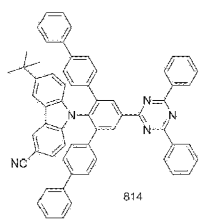
814

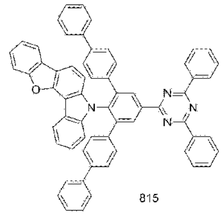
815

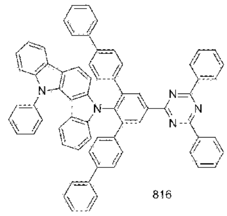
816

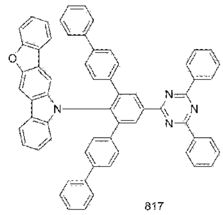
817

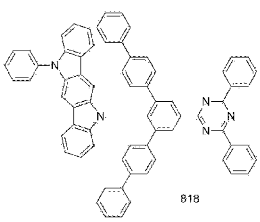
818

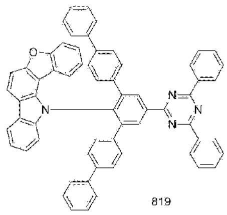
819

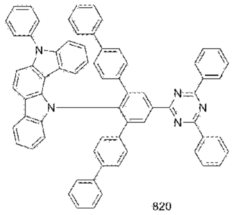
820

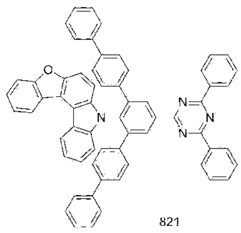
821
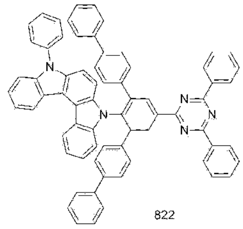
822
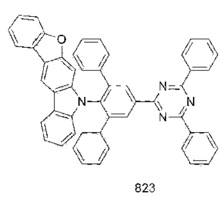
823
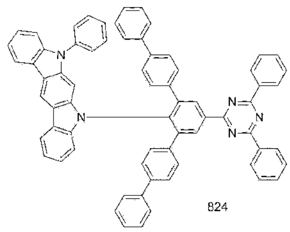
824
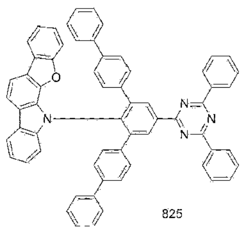
825
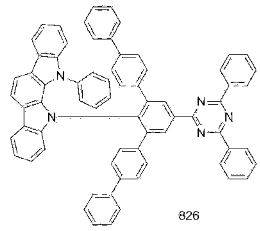
826
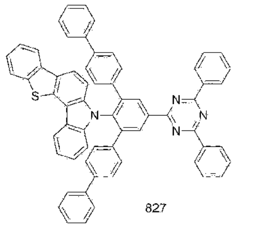
827
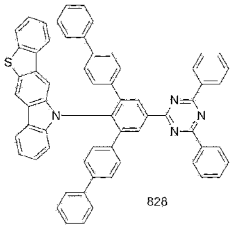
828
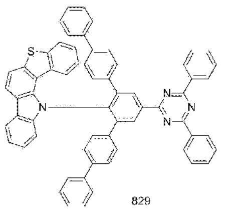
829
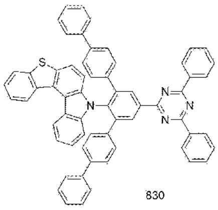
830
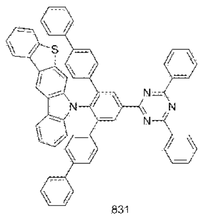
831
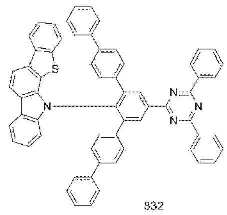
832
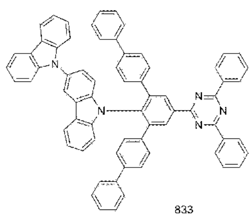
833
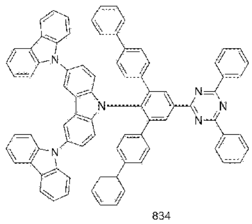
834
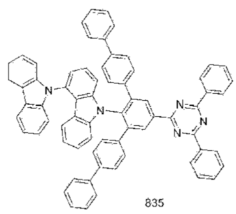
835
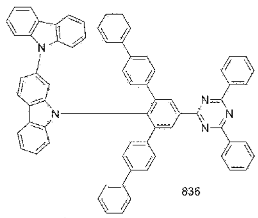
836
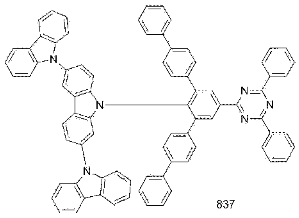
837
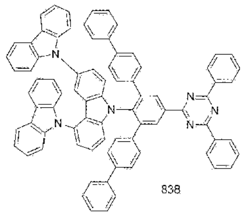
838
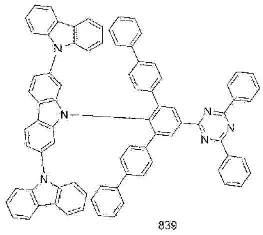
839
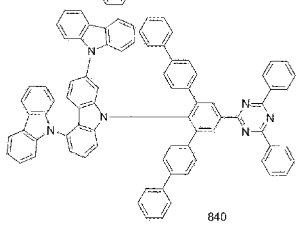
840
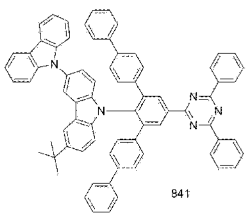
841
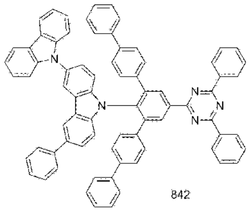
842
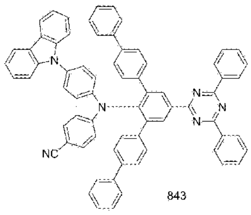
843
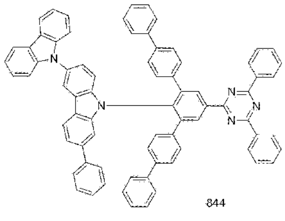
844
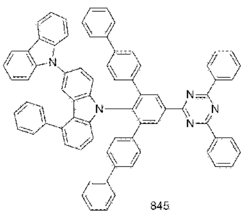
845
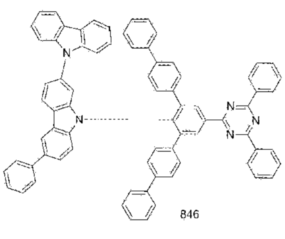
846
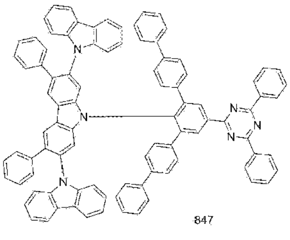
847
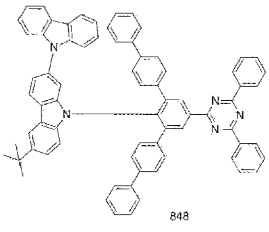
848

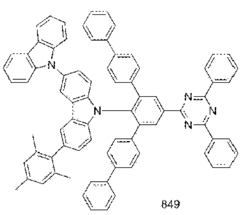
849

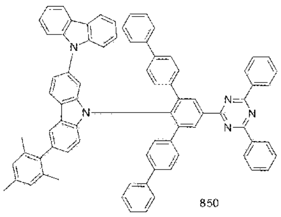
850

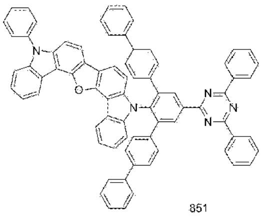
851

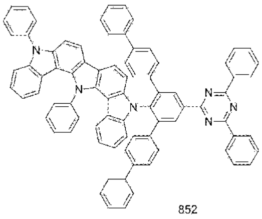
852

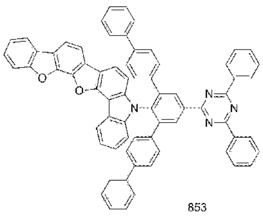
853

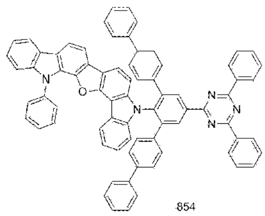
854

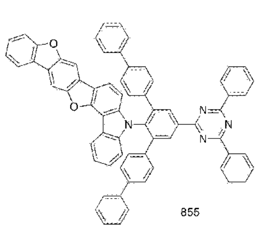
855

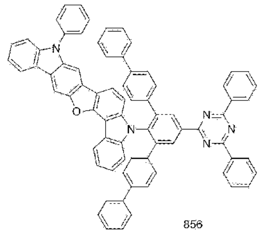
856

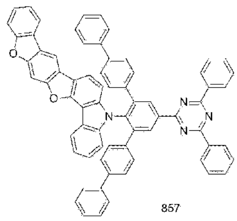
857

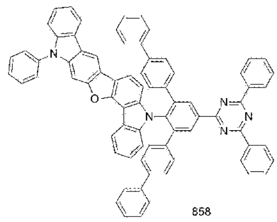
858

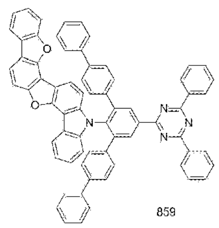
859

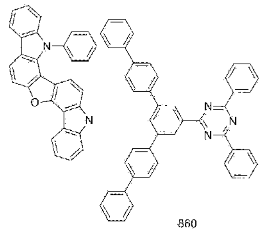
860

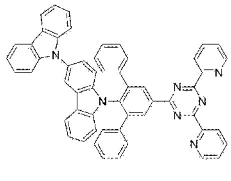
861

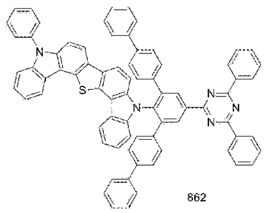
862

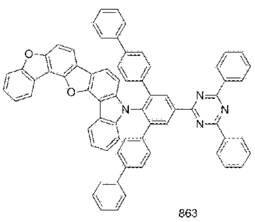
863

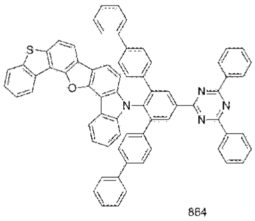
864

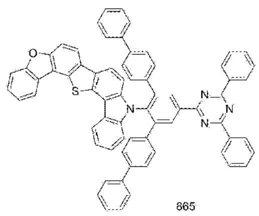
865

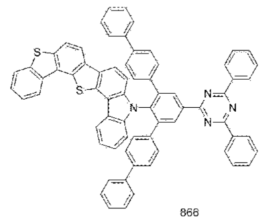
866

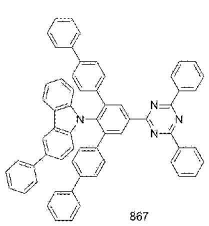
867

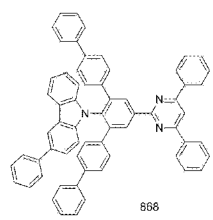
868

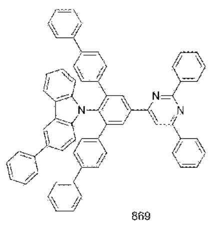
869

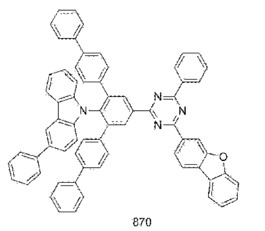
870

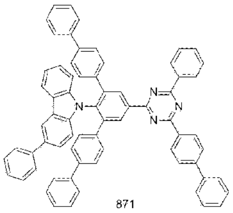
871
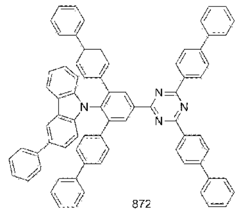
872
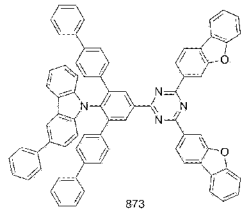
873
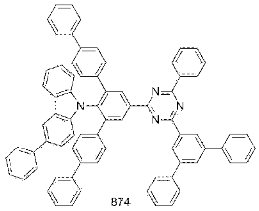
874
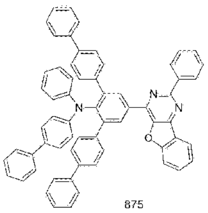
875
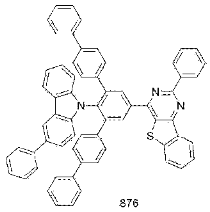
876
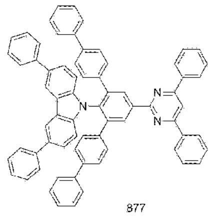
877
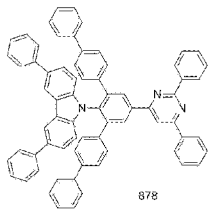
878
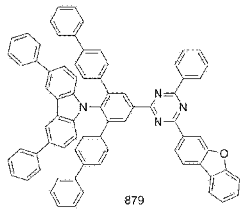
879
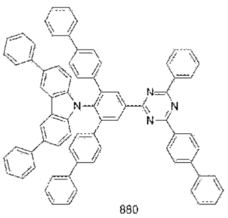
880
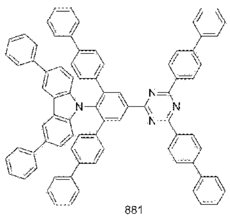
881
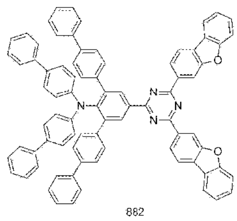
882
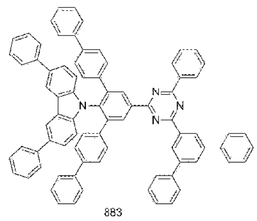
883
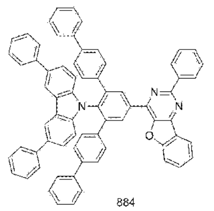
884
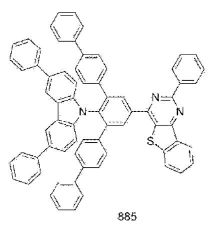
885
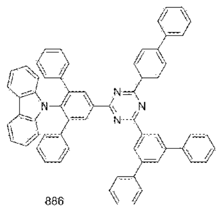
886
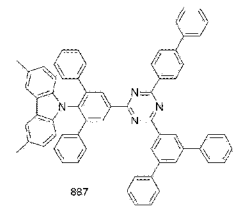
887
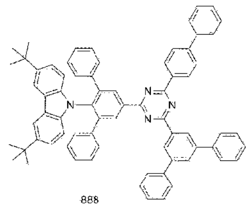
888
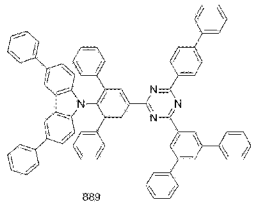
889
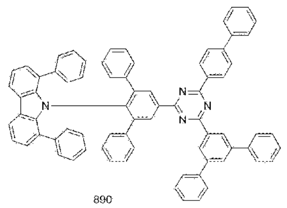
890
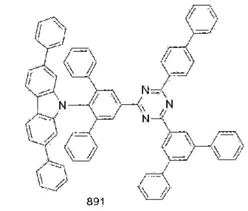
891
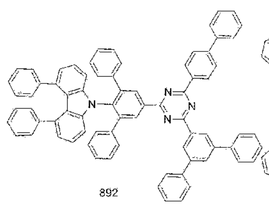
892
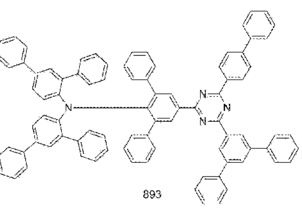
893
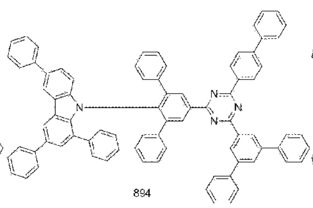
894
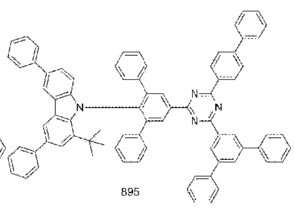
895
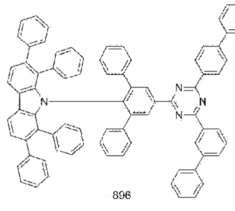
896
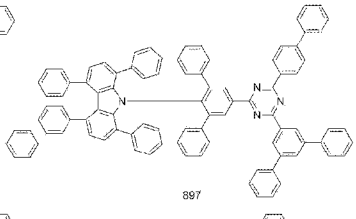
897
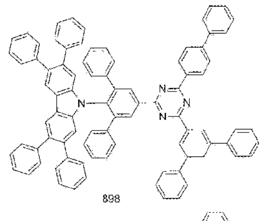
898
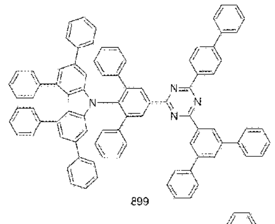
899
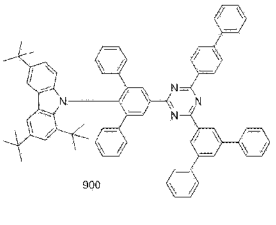
900
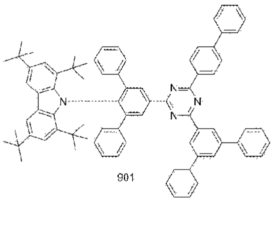
901
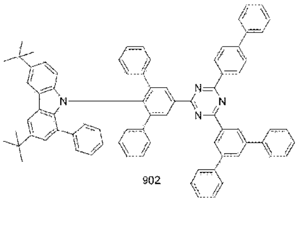
902
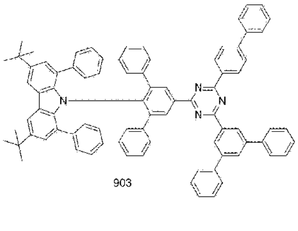
903

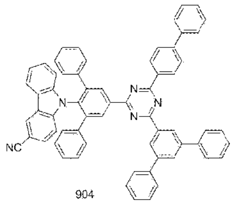
904

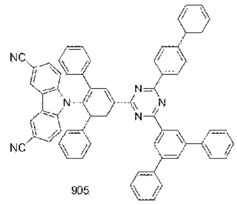
905

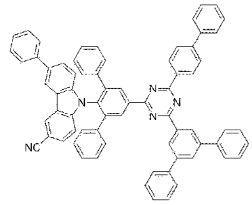
906

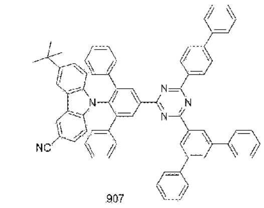
907

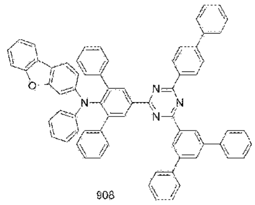
908

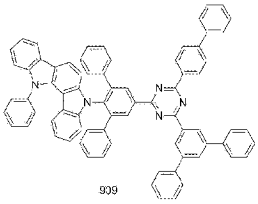
909

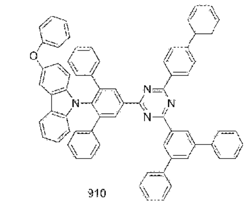
910

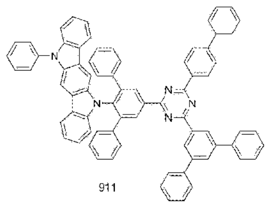
911

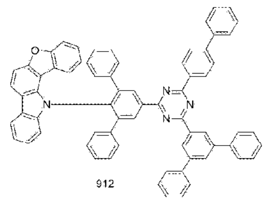
912

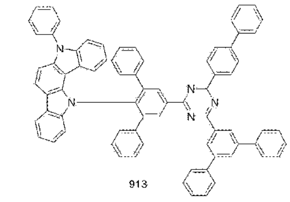
913

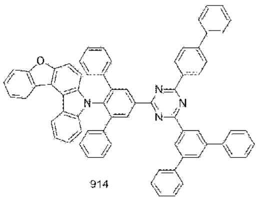
914

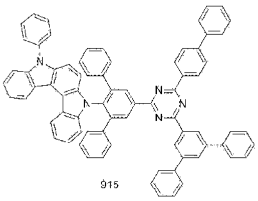
915

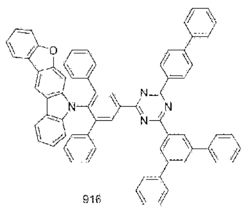
916

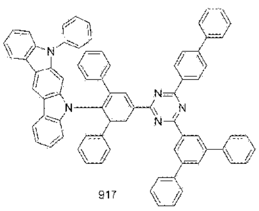
917

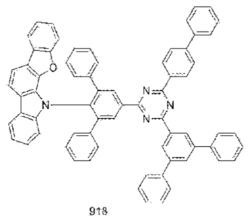
918

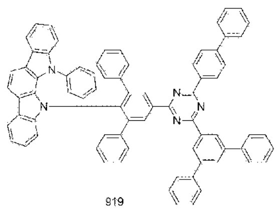
919

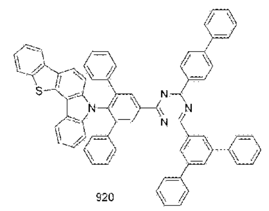
920

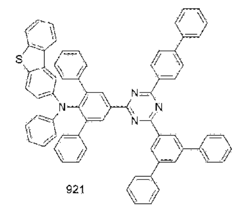
921

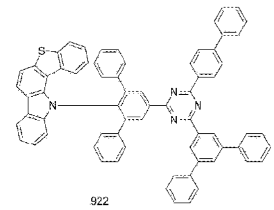
922

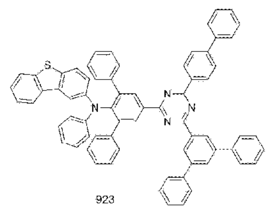
923

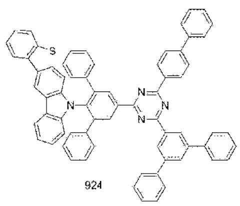
924

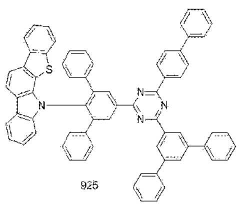
925

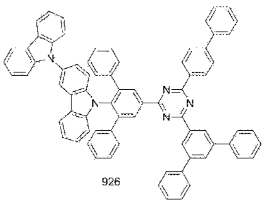
926

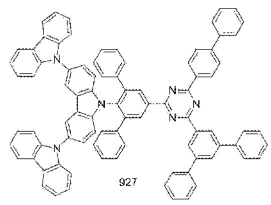
927

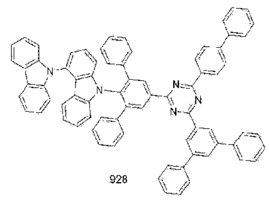
928

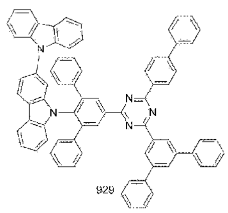
929

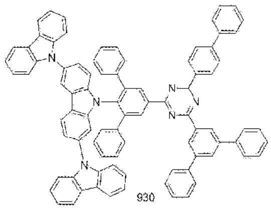
930

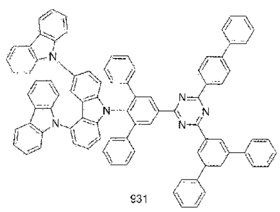
931

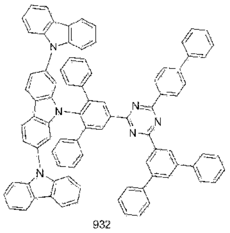
932

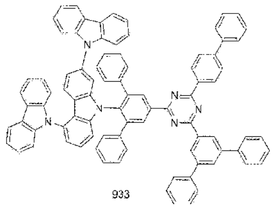
933

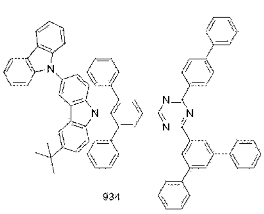
934

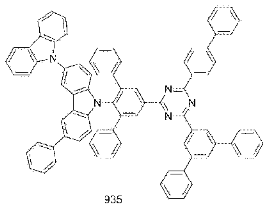
935

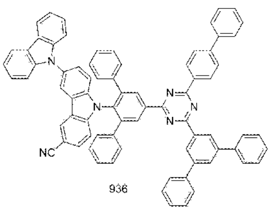
936

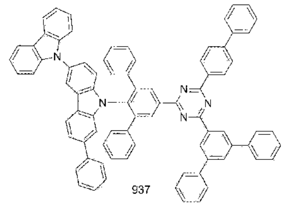
937

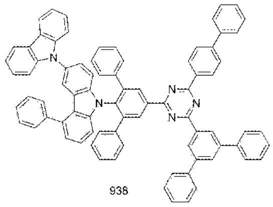
938

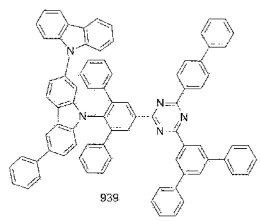
939

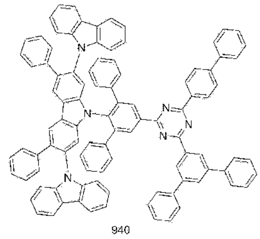
940

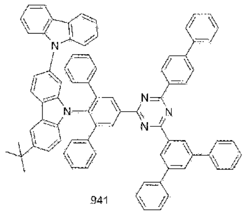
941

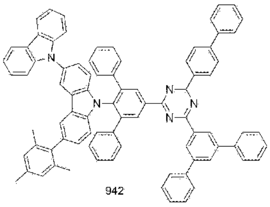
942

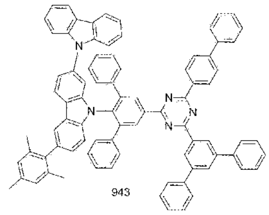
943

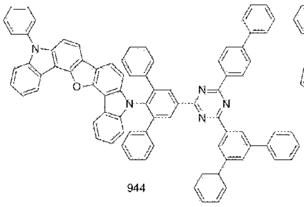
944

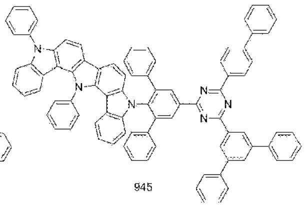
945

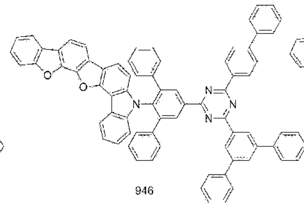
946

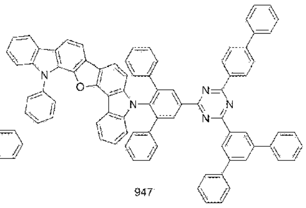
947

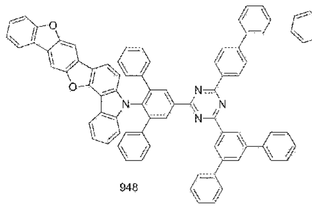
948

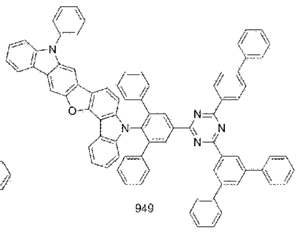
949

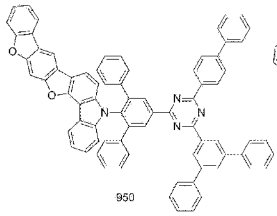
950

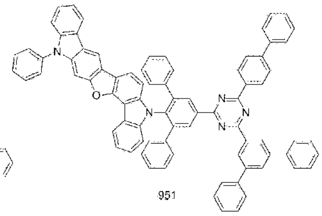
951

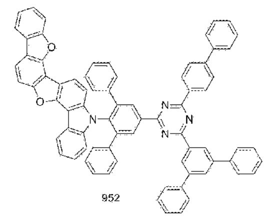
952

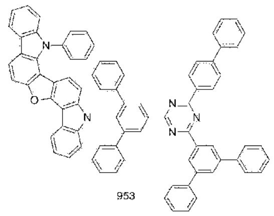
953

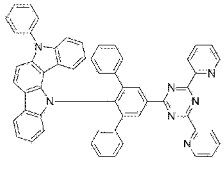
954

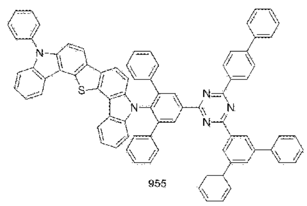
955

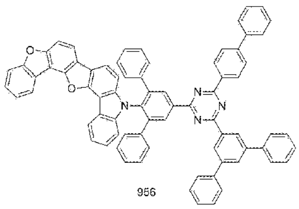
956

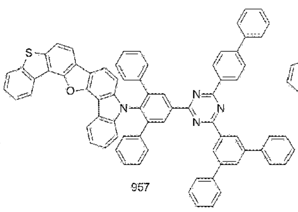
957

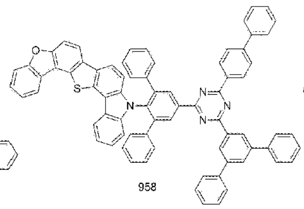
958

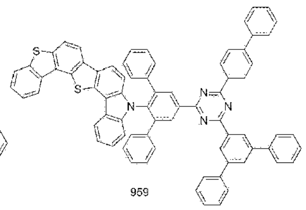
959

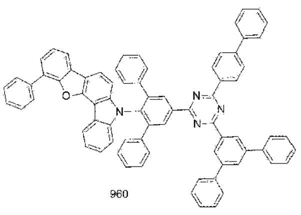
960

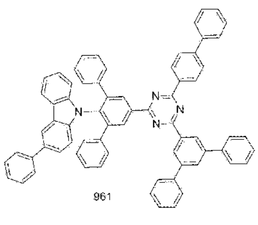
961

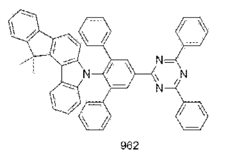
962

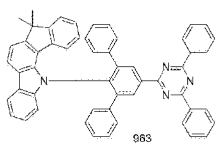
963

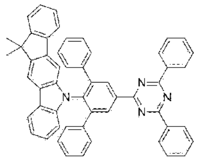
964

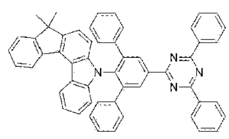
965

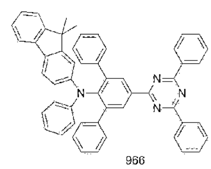
966

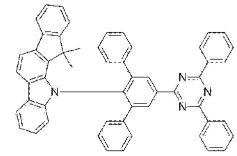
967

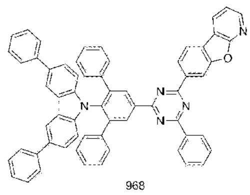
968

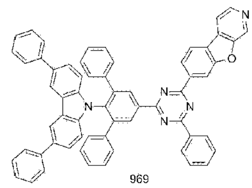
969

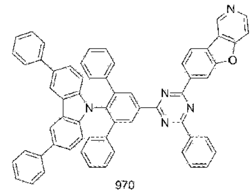
970

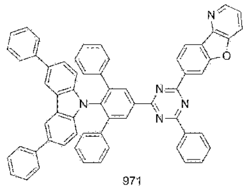
971

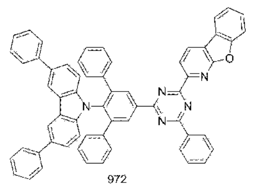
972

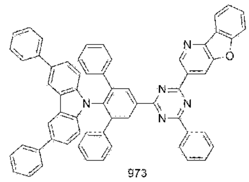
973

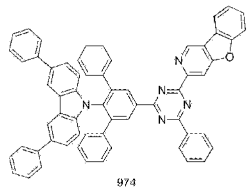
974

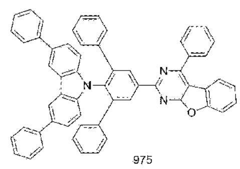
975

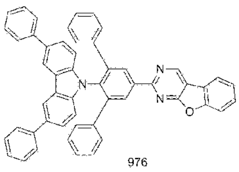
976

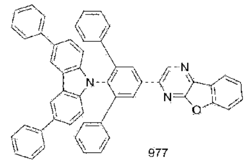
977

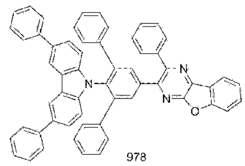
978

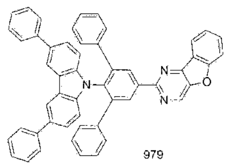
979

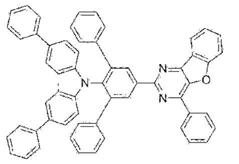
980

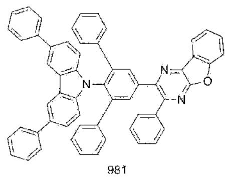
981

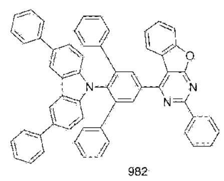
982

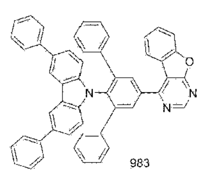
983

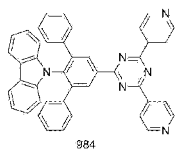
984

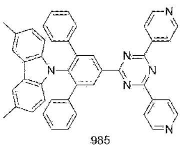
985

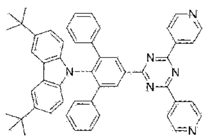
986

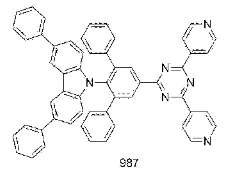
987

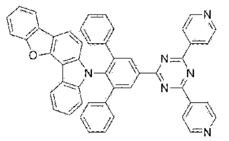
988

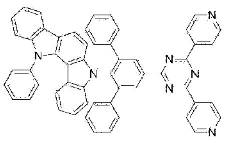
989

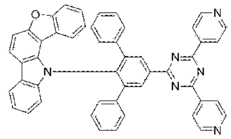
990

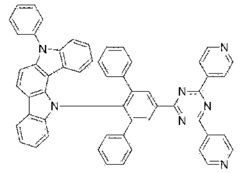
991

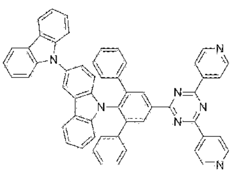
992

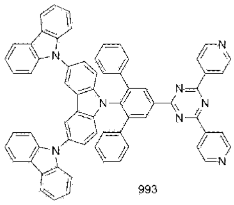
993

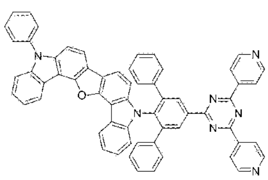
994

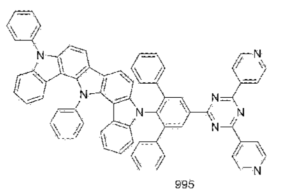
995

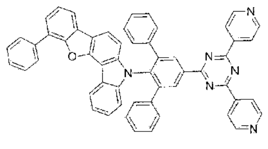
996

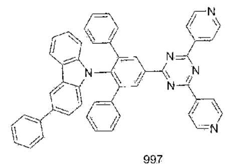
997

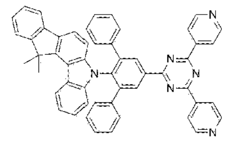
998

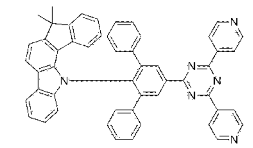
999

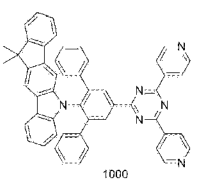
1000

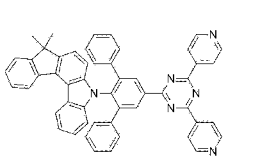
1001

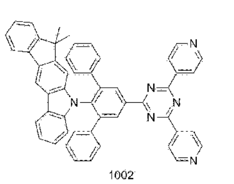
1002

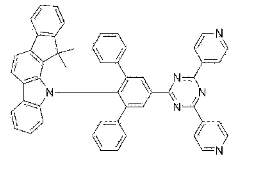
1003

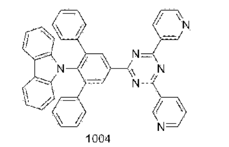
1004

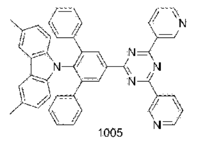
1005

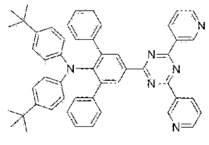
1006

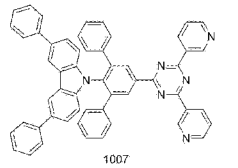
1007

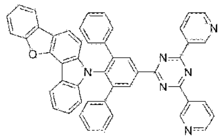
1008

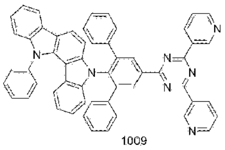
1009

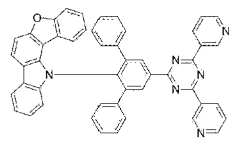
1010

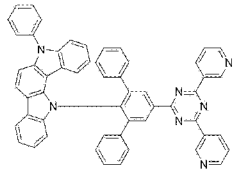
1011

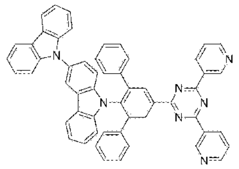
1012

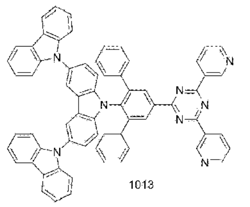
1013

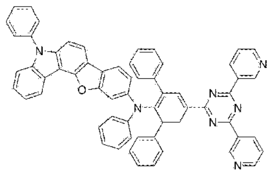
1014

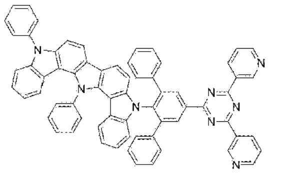
1015

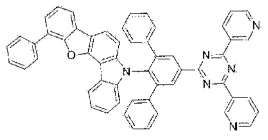
1016

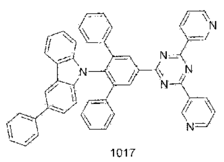
1017

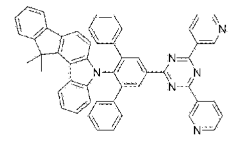
1018

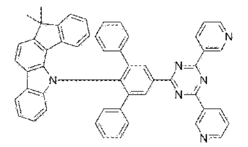
1019

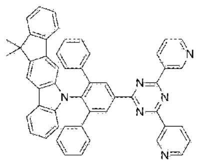
1020

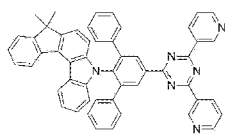
1021

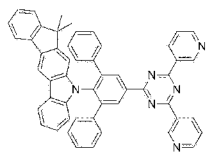
1022

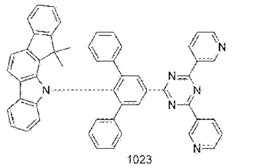
1023

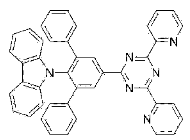
1024

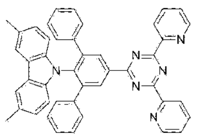
1025

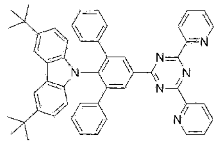
1026

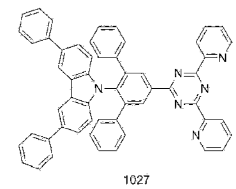
1027

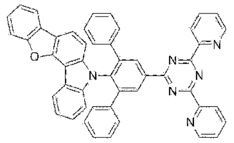
1028

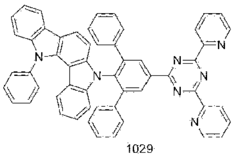
1029

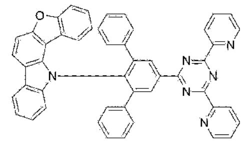
1030

Group X

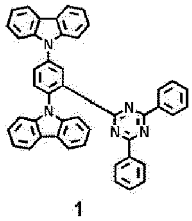
1

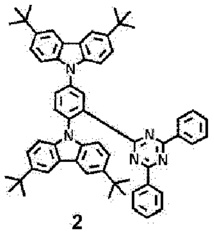
2

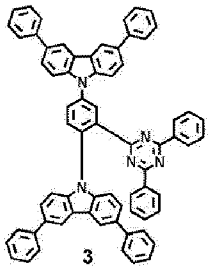
3

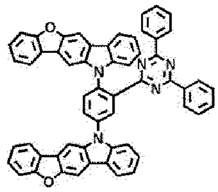
4

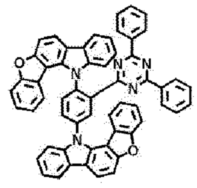
5

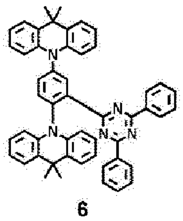
6

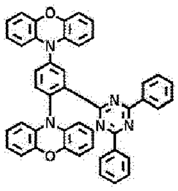
7

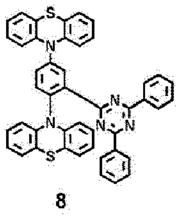
8

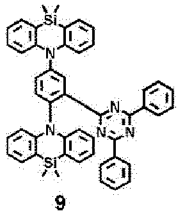
9

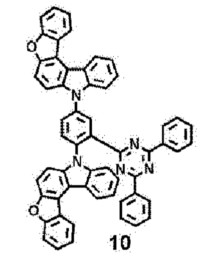
10

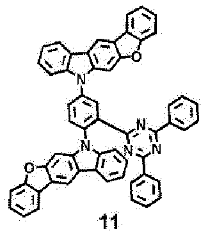
11

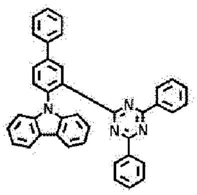
12

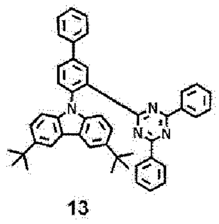
13

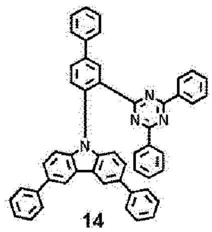
14

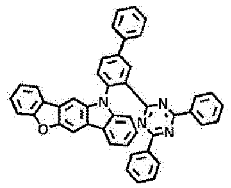
15

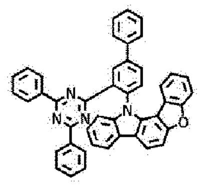
16

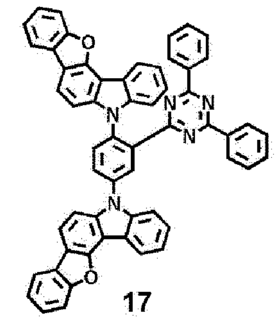
17

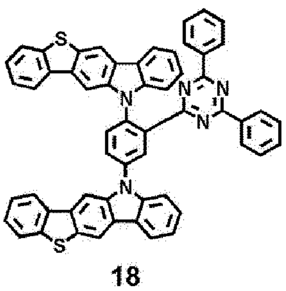
18

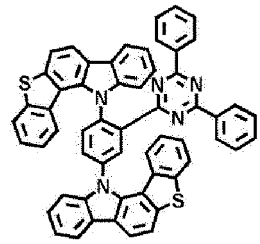
19

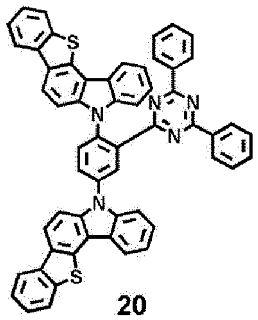
20

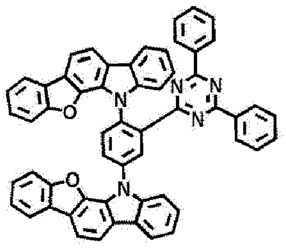
21

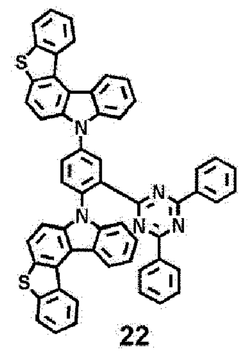
22

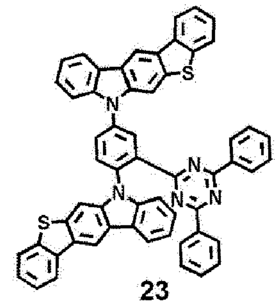
23

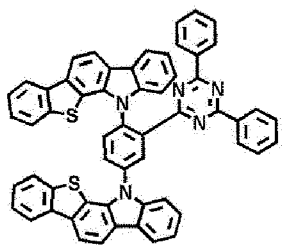
24

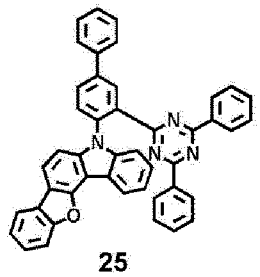
25

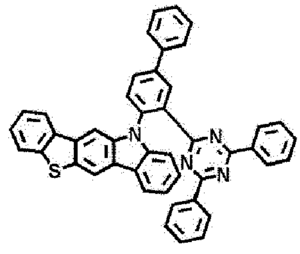
26

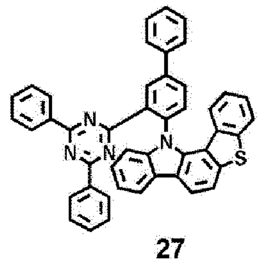
27

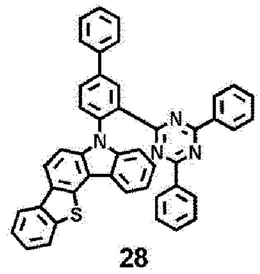
28

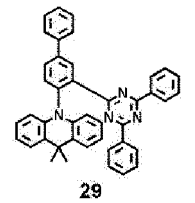
29
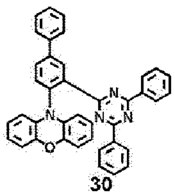
30
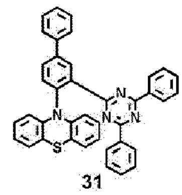
31
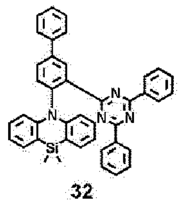
32
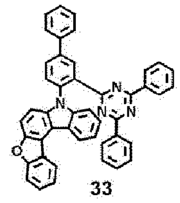
33
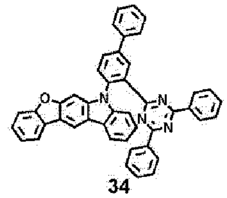
34

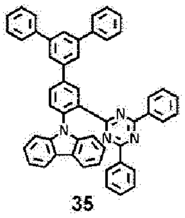
35
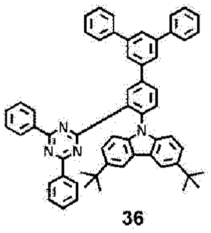
36
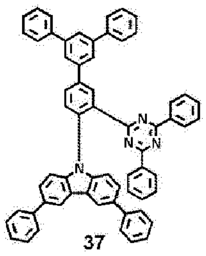
37
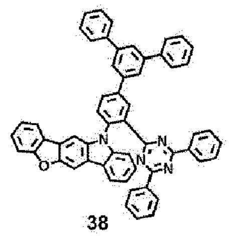
38
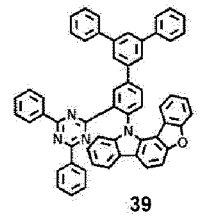
39

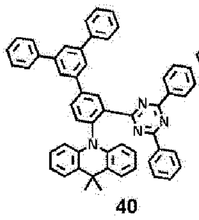
40
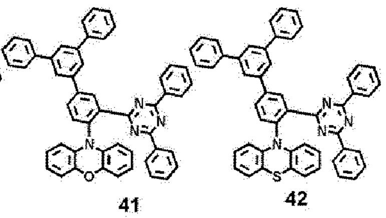
41
42
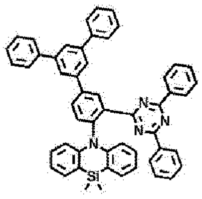
43
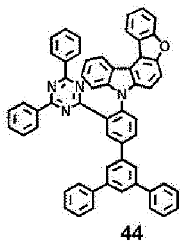
44
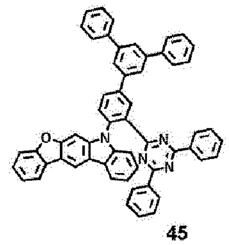
45

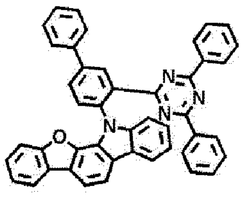
46

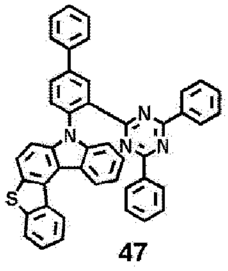
47

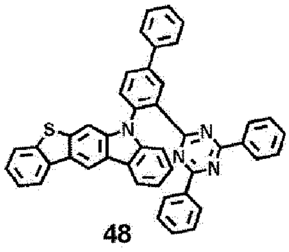
48

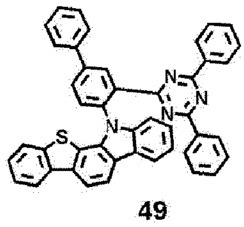
49

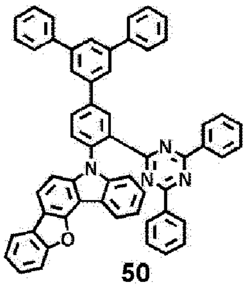
50

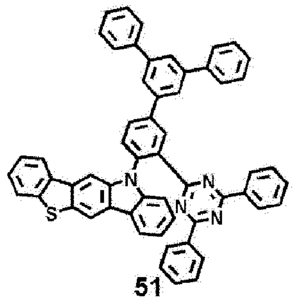
51

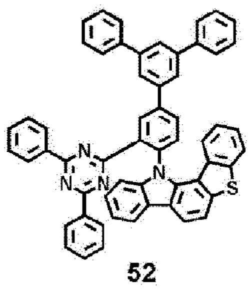
52

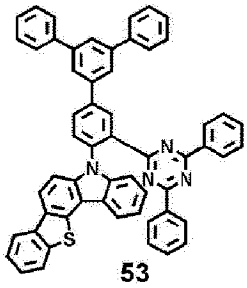
53

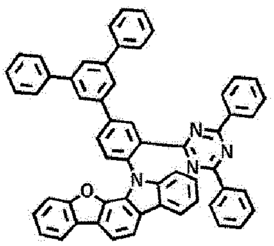
54

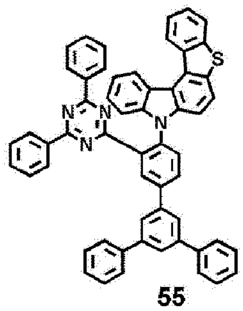
55

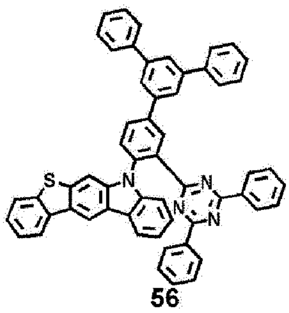
56

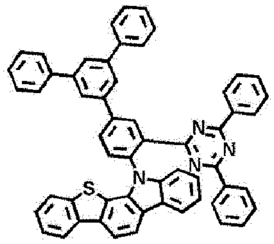
57

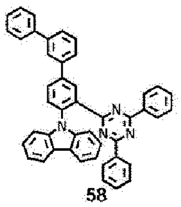
58

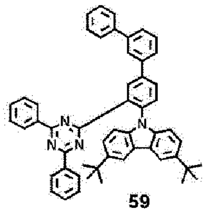
59

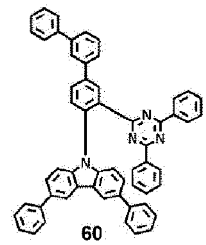
60

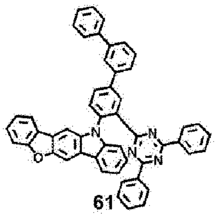
61

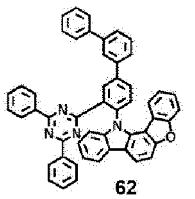
62

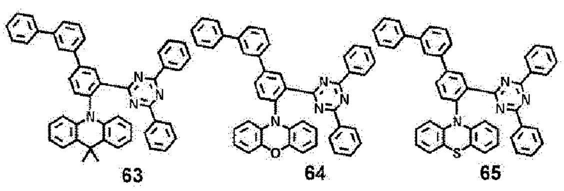
63 64 65

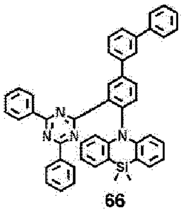
66

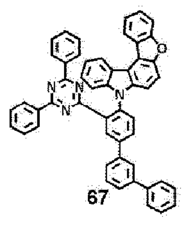
67

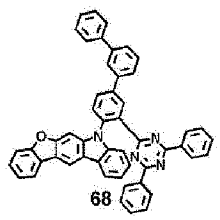
68

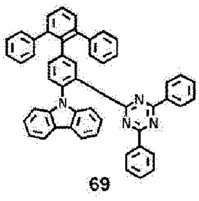
69

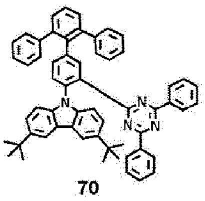
70

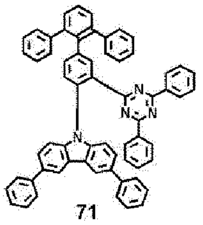
71

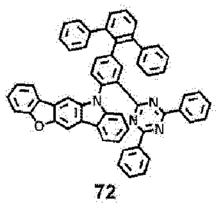
72

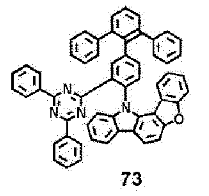
73

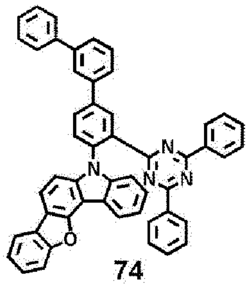
74
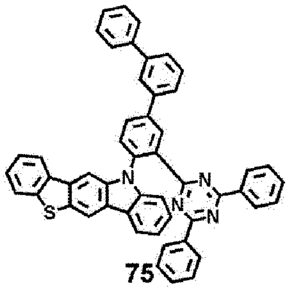
75
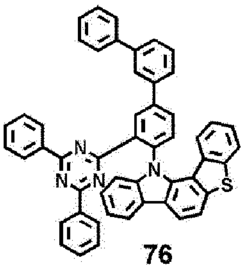
76
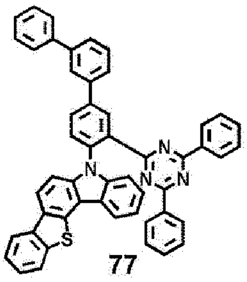
77

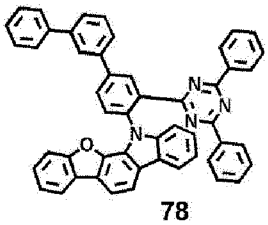
78
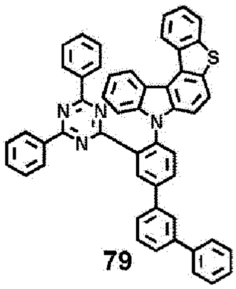
79
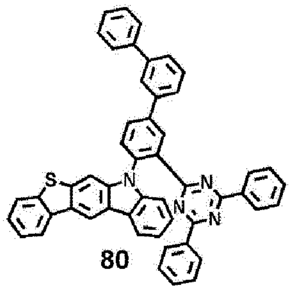
80
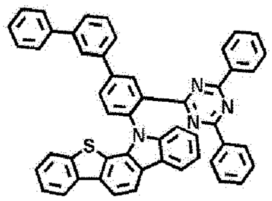
81

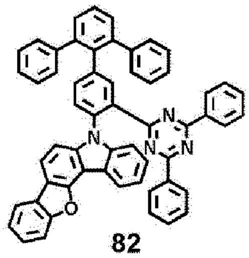
82
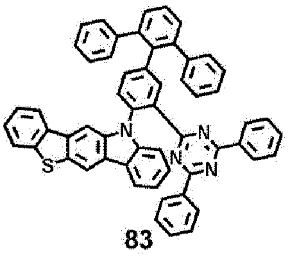
83
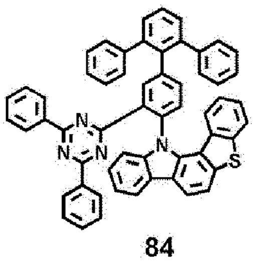
84
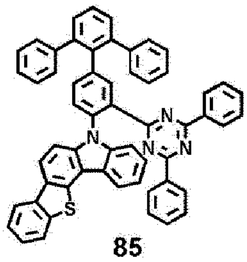
85

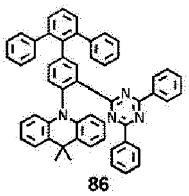
86
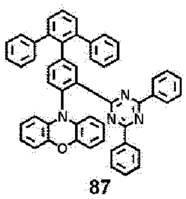
87
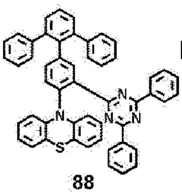
88
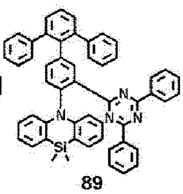
89
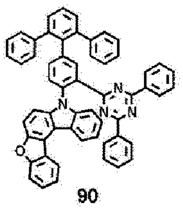
90
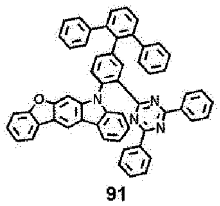
91

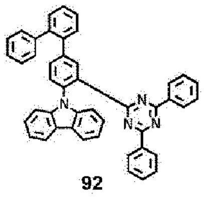
92
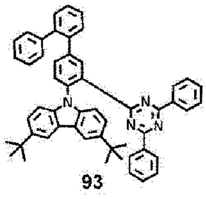
93
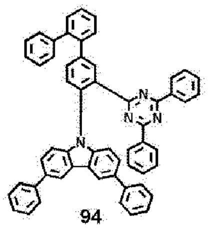
94
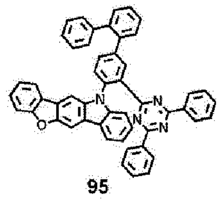
95
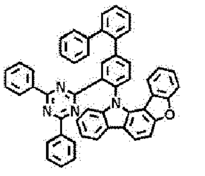
96

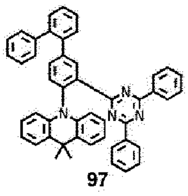
97
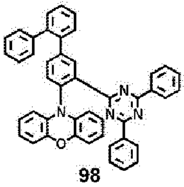
98
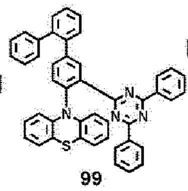
99
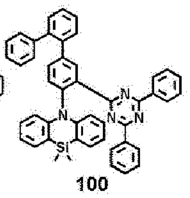
100
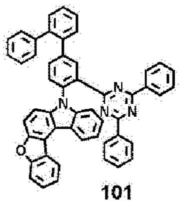
101
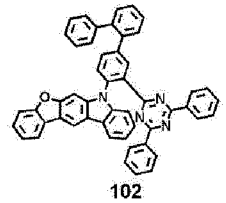
102

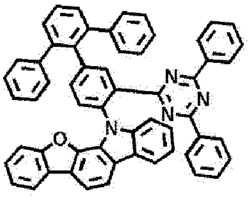
103

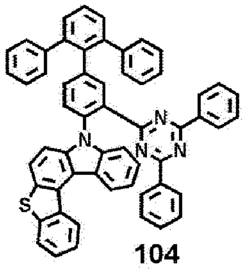
104

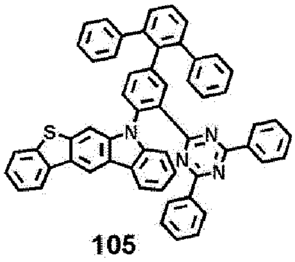
105

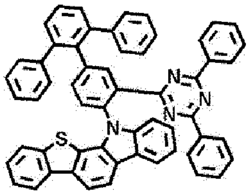
106

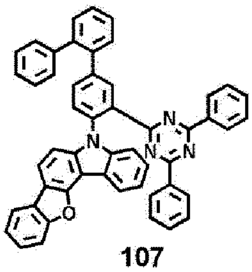
107

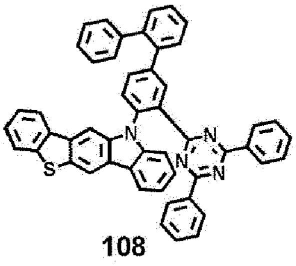
108

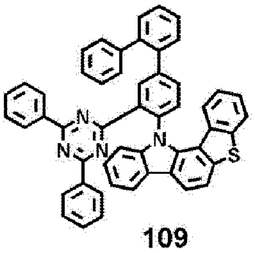
109

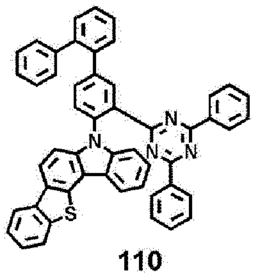
110

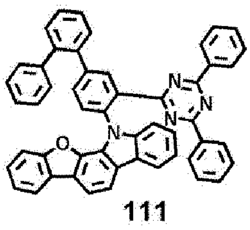
111

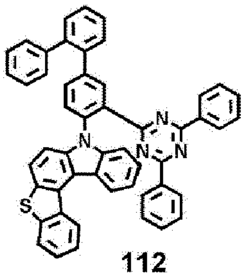
112

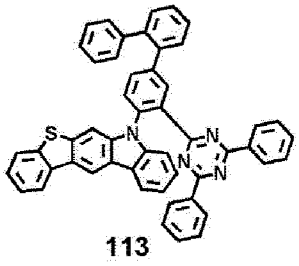
113

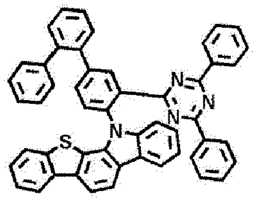
114

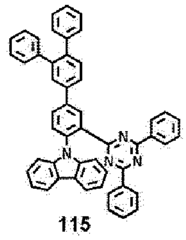
115

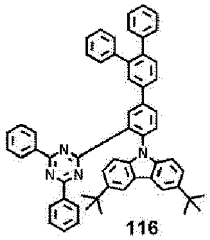
116

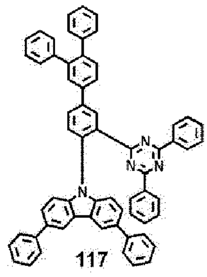
117

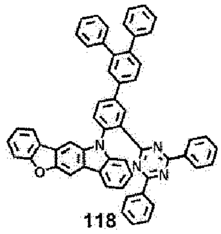
118

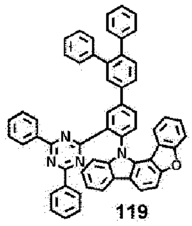
119

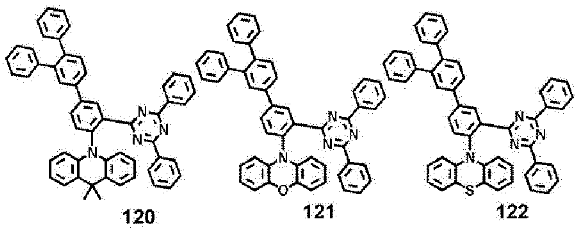
120

121

122

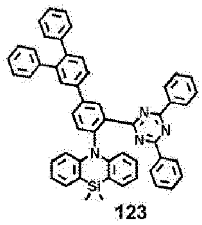
123

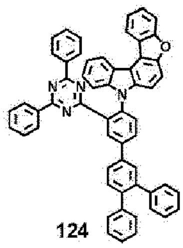
124

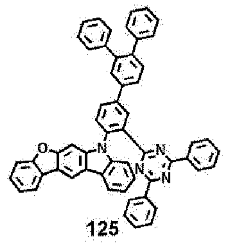
125

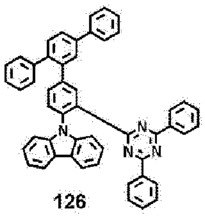
126

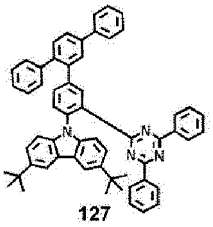
127

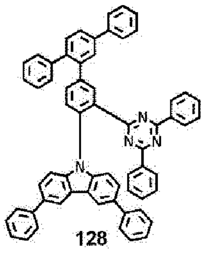
128

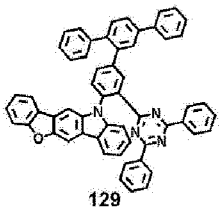
129

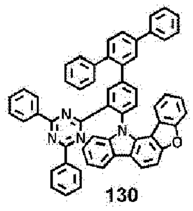
130

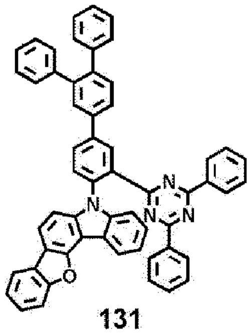

131

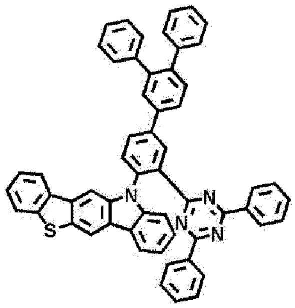

132

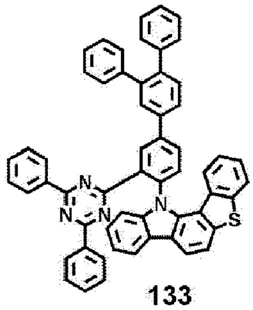

133

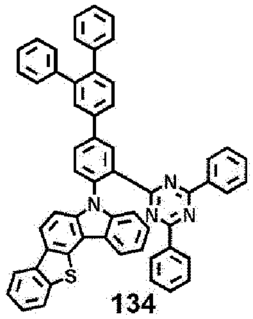

134

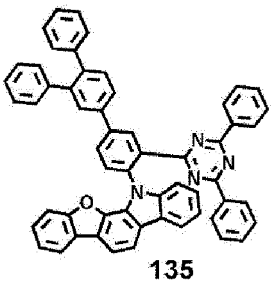

135

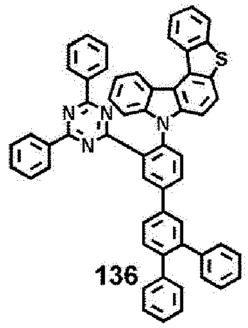

136

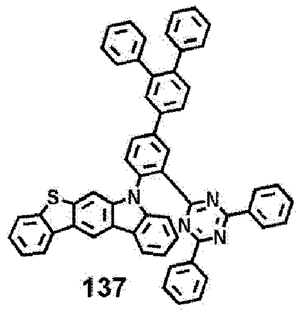

137

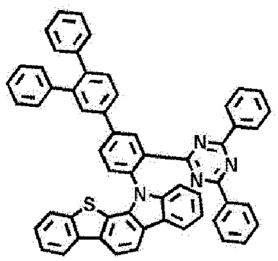

138

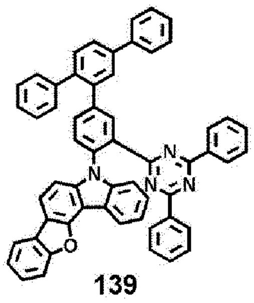

139

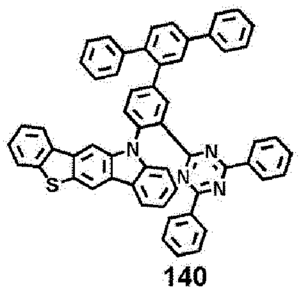

140

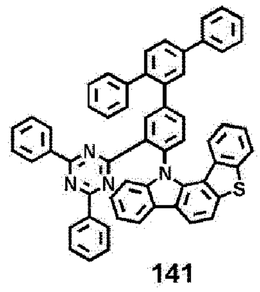

141

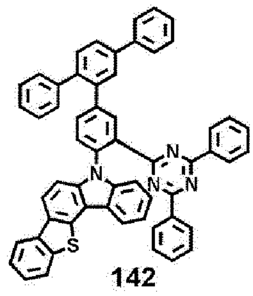

142

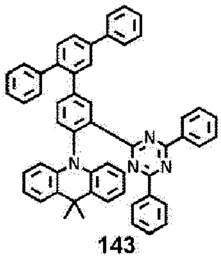
143

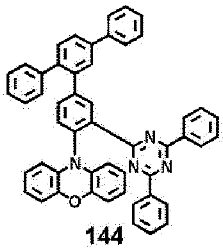
144

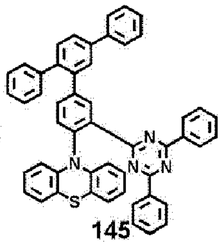
145

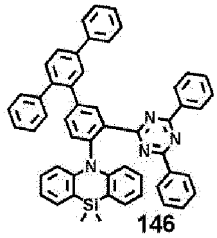
146

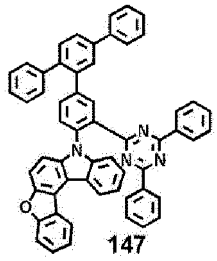
147

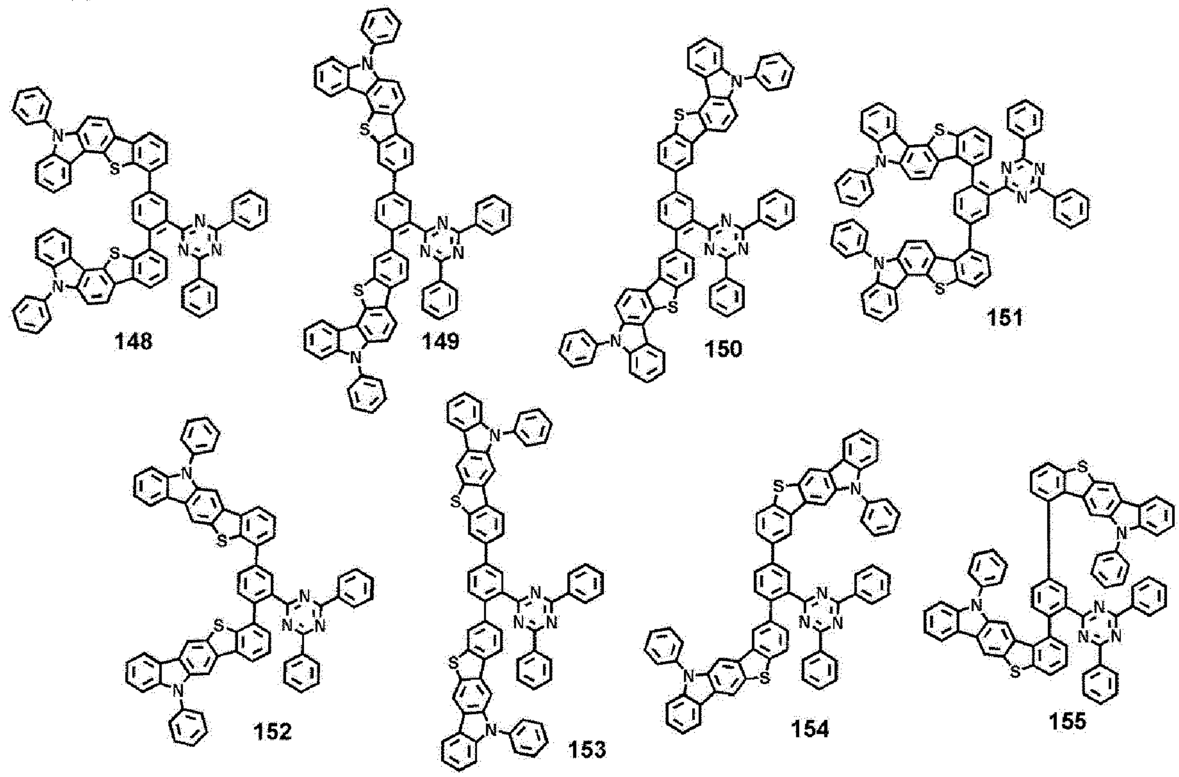
148

149

150

151

152

153

154

155

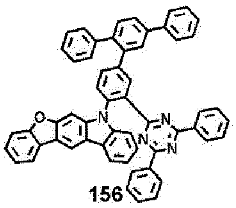
156

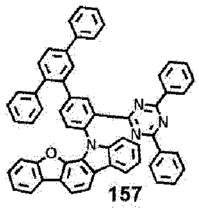
157

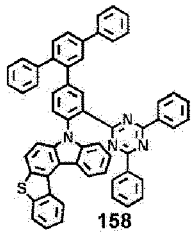
158

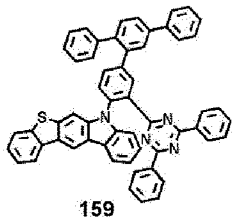
159

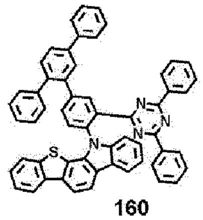
160

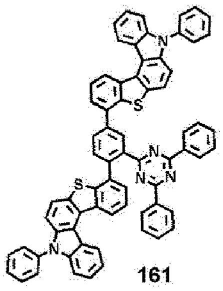
161

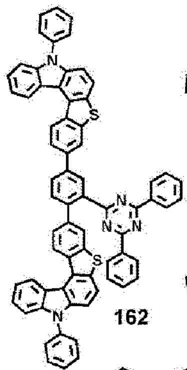
162

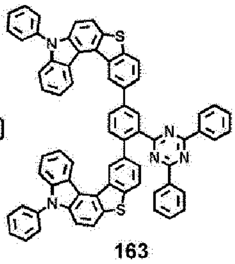
163

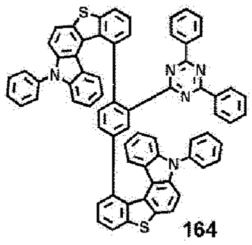
164

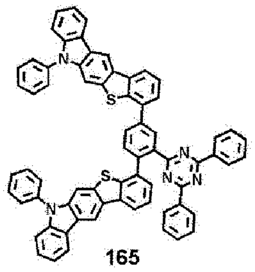
165

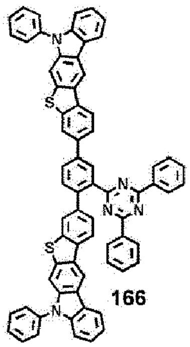
166

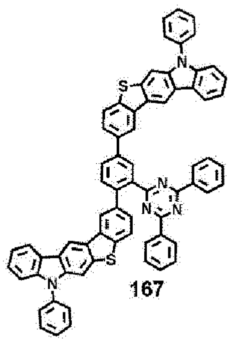
167

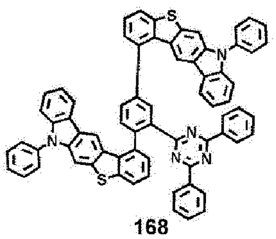
168

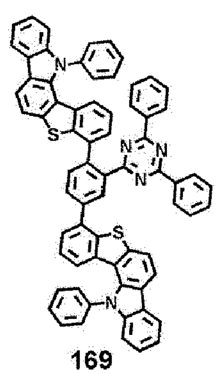

169

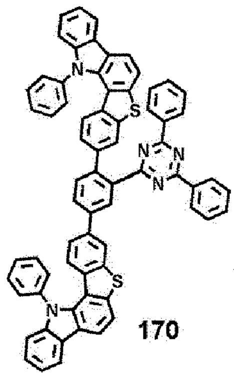

170

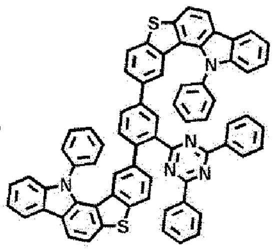

171

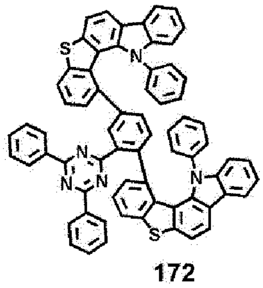

172

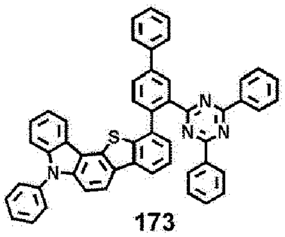

173

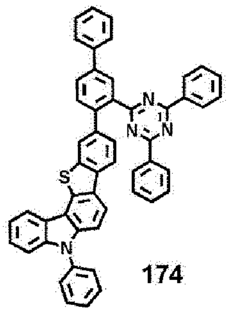

174

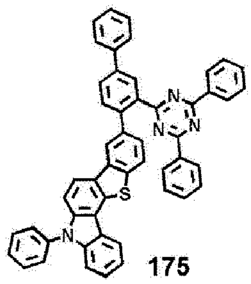

175

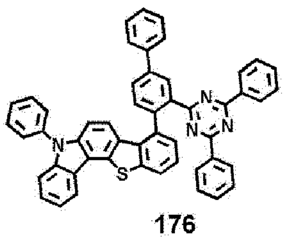

176

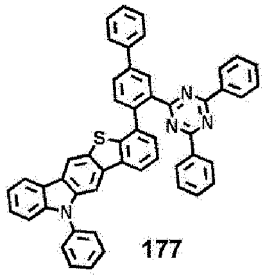

177

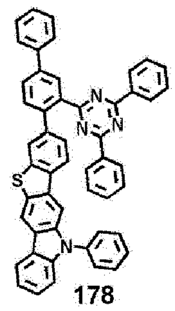

178

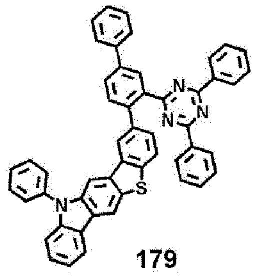

179

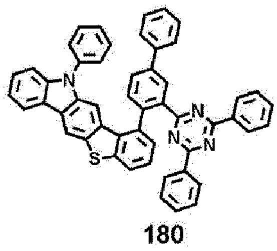

180

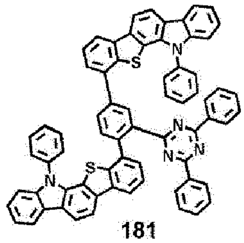

181

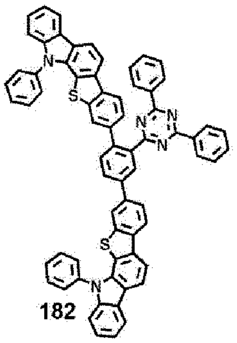

182

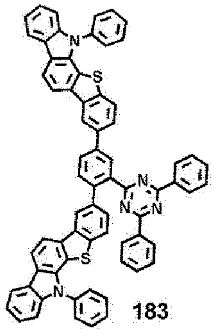

183

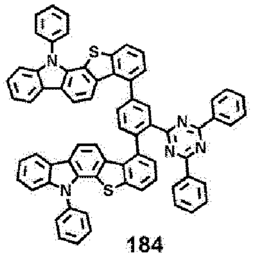

184

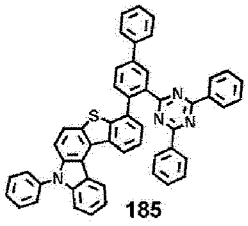

185

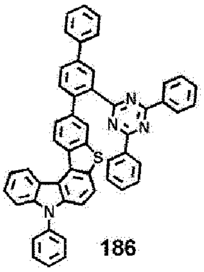

186

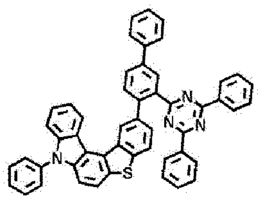

187

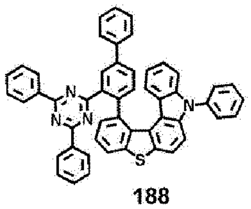

188

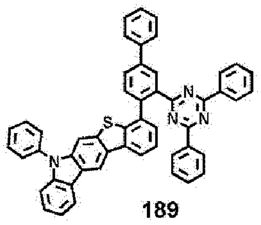

189

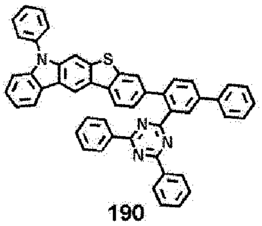

190

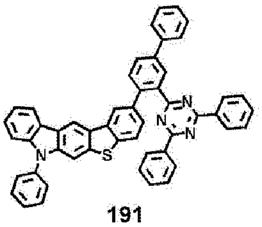

191

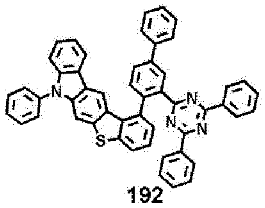

192

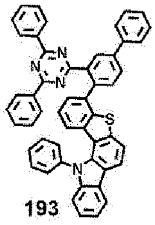

193

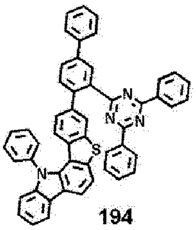

194

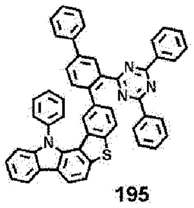

195

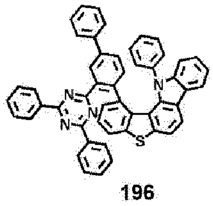

196

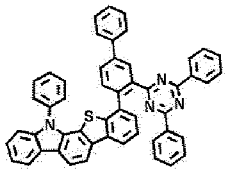

197

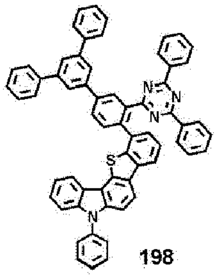

198

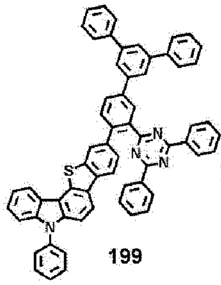

199

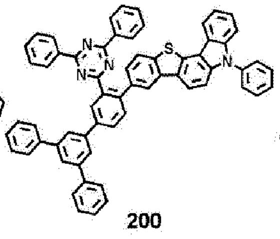

200

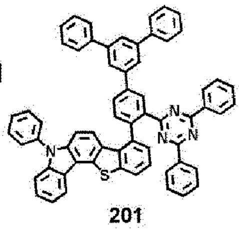

201

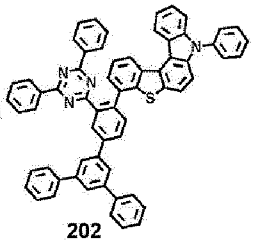

202

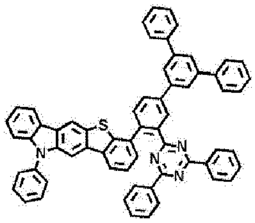

203

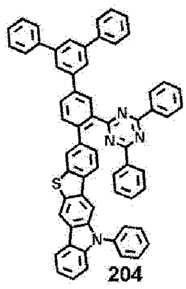

204

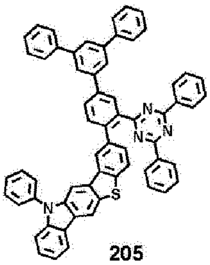

205

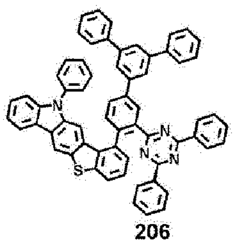

206

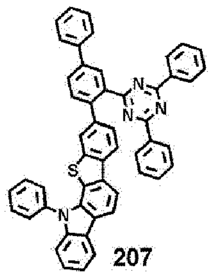
207

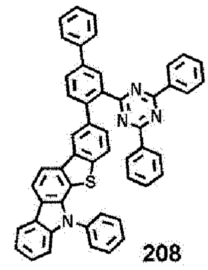
208

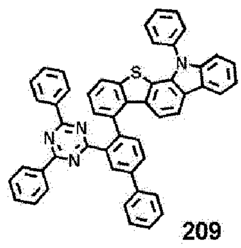
209

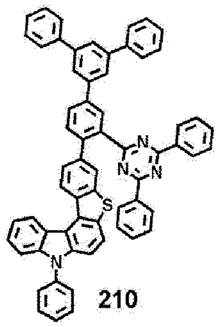
210

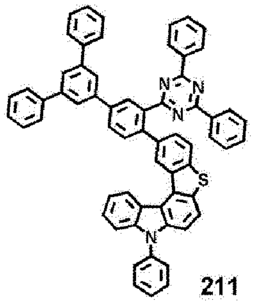
211

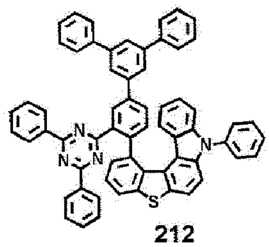
212

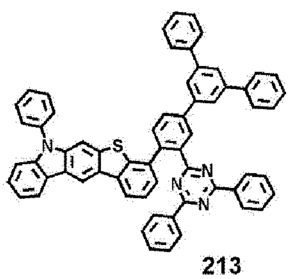
213

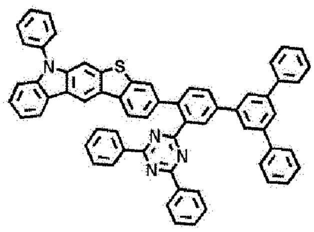
214

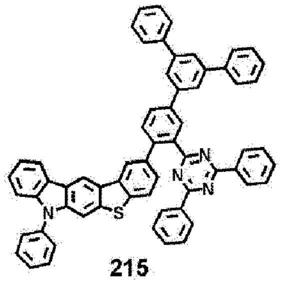
215

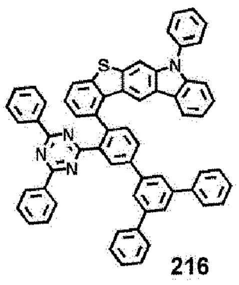
216

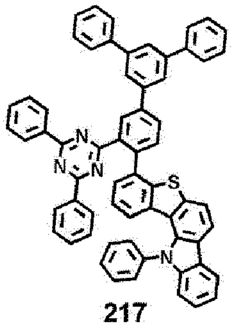

217

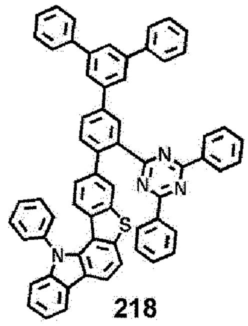

218

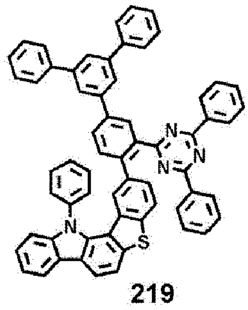

219

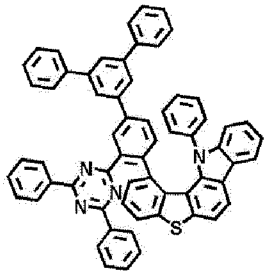

220

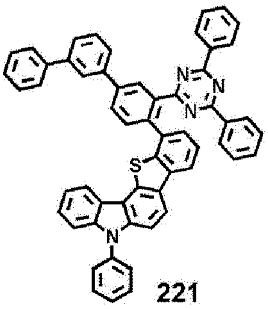

221

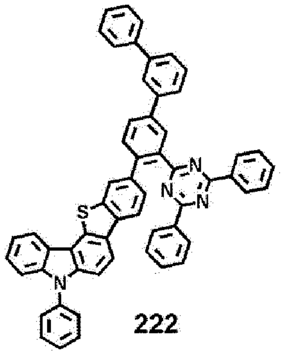

222

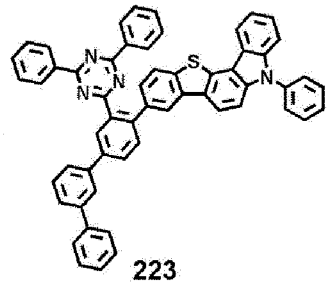

223

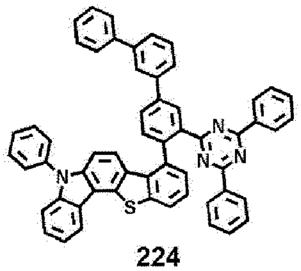

224

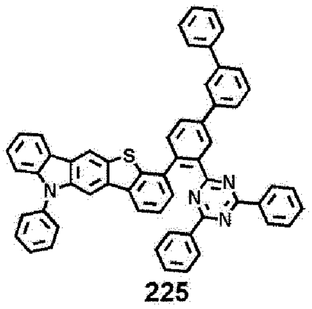

225

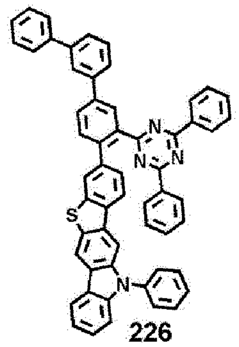

226

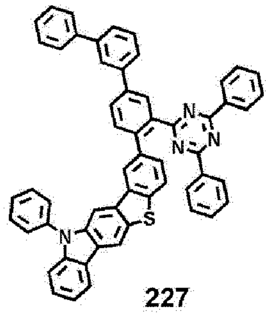

227

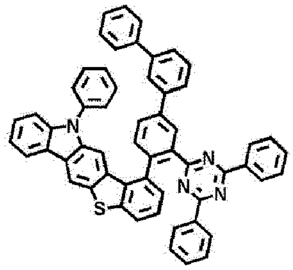

228

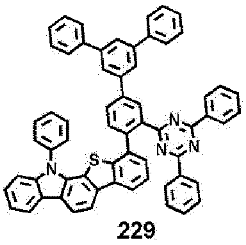
229

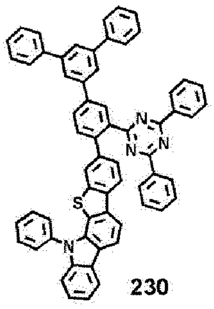
230

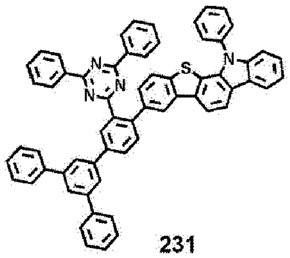
231

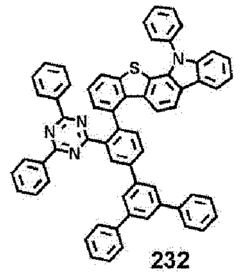
232

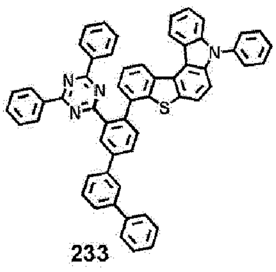
233

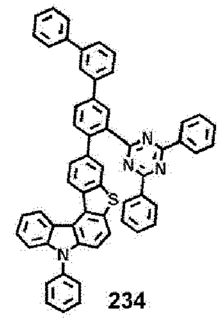
234

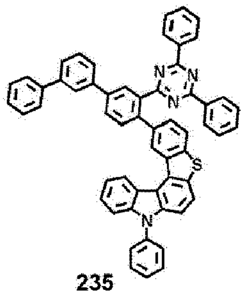
235

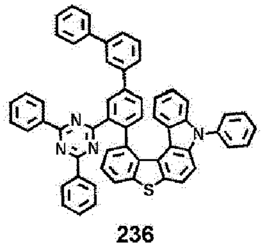
236

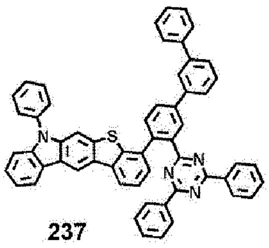
237

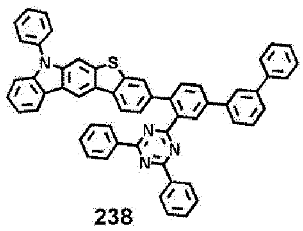
238

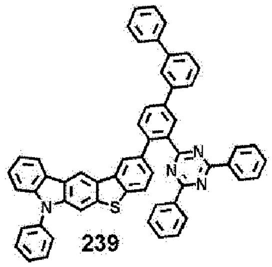
239

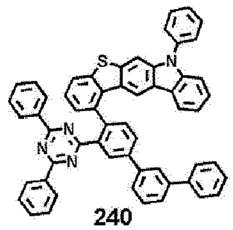
240

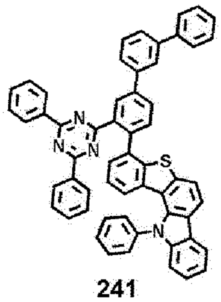
241

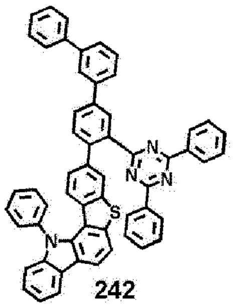
242

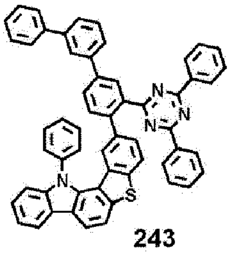
243

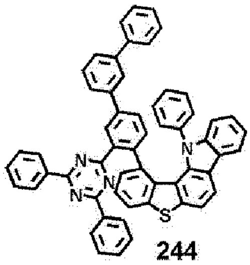
244

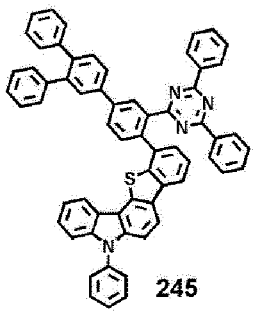
245

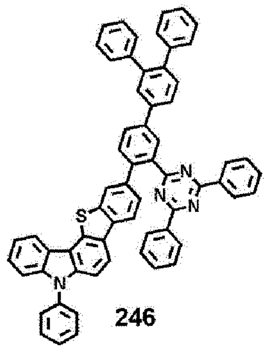
246

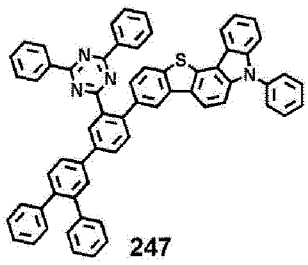
247

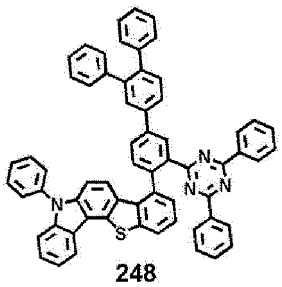
248

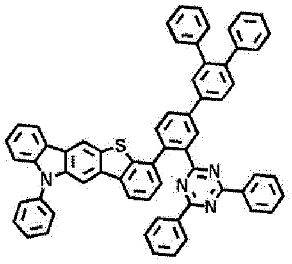
249

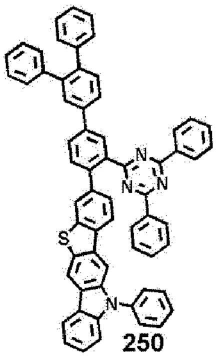
250

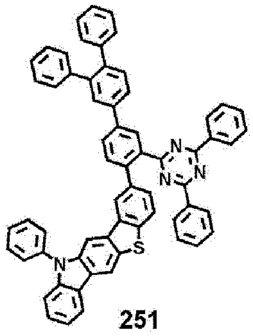
251

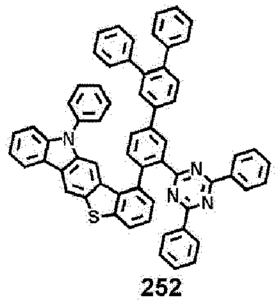
252

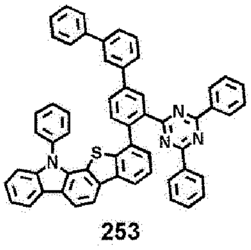

253

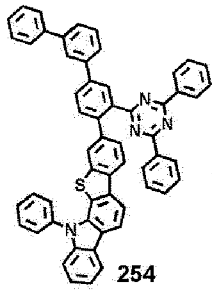

254

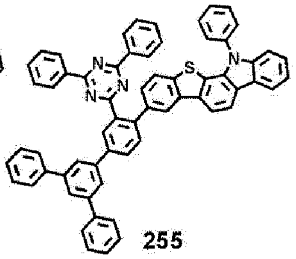

255

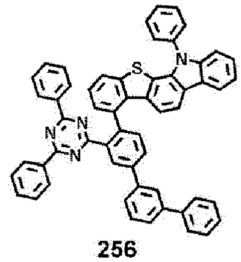

256

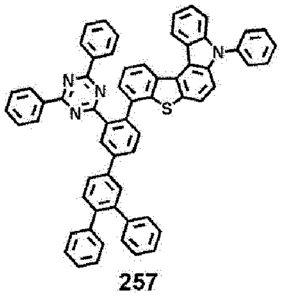

257

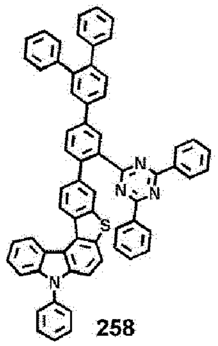

258

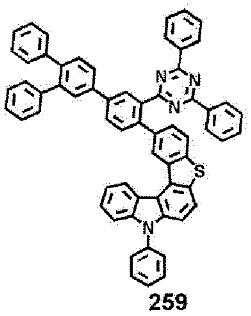

259

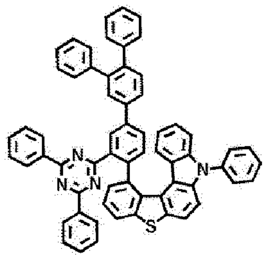

260

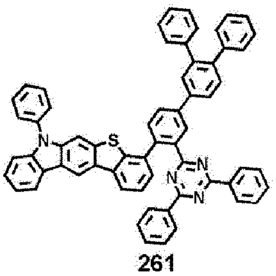

261

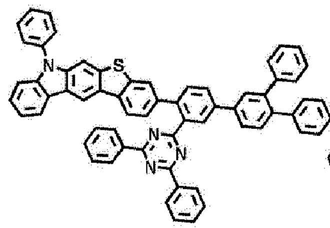

262

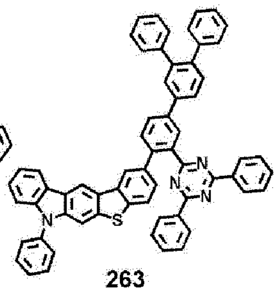

263

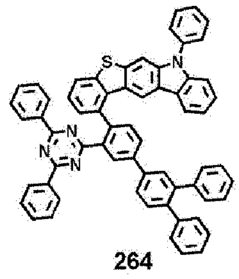

264

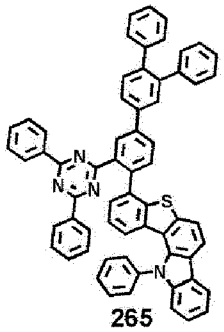
265

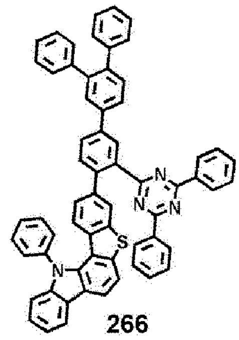
266

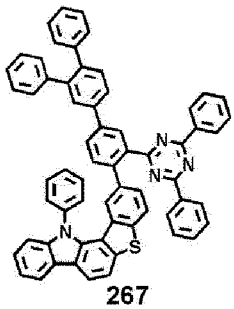
267

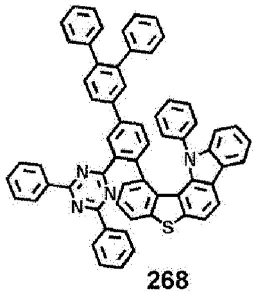
268

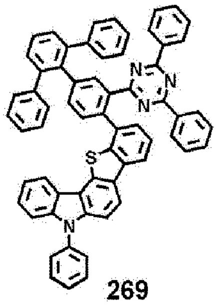
269

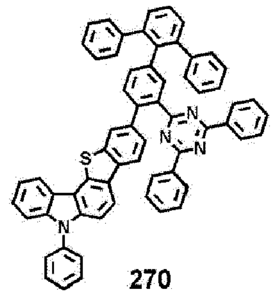
270

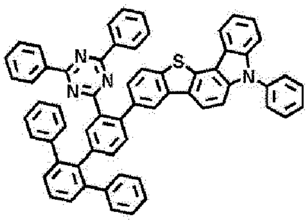
271

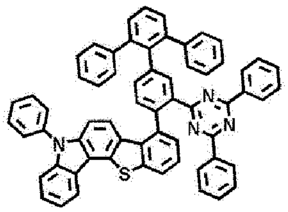
272

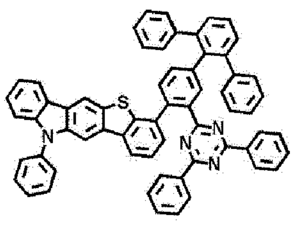
273

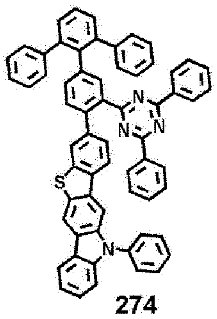
274

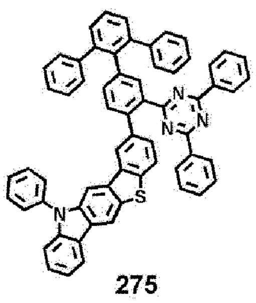
275

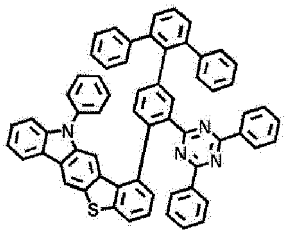
276

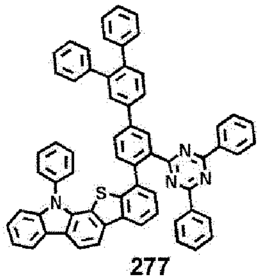

277

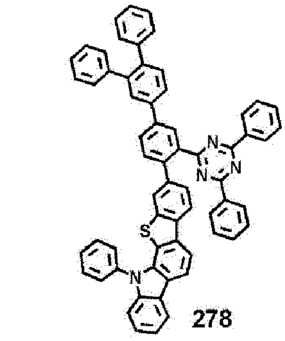

278

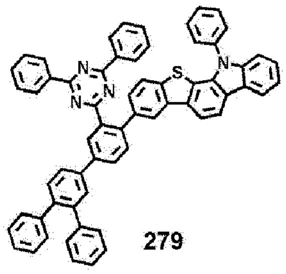

279

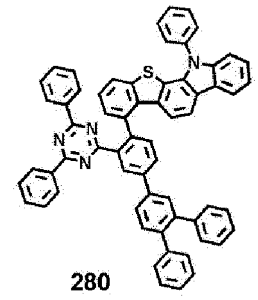

280

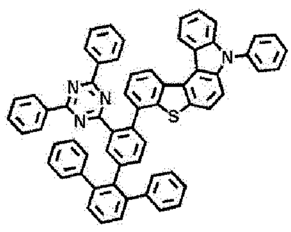

281

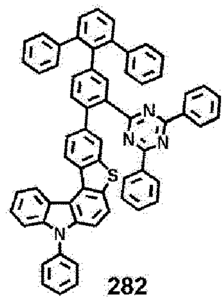

282

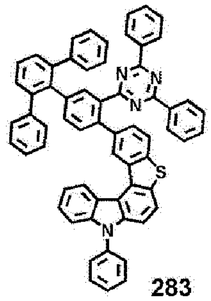

283

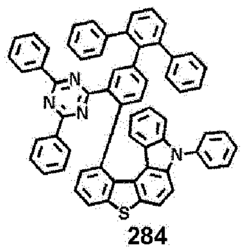

284

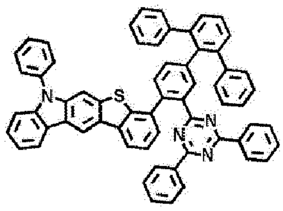

285

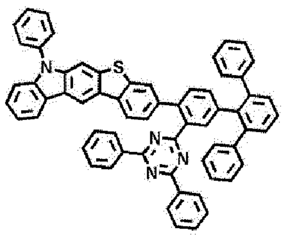

286

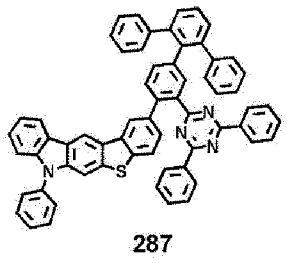

287

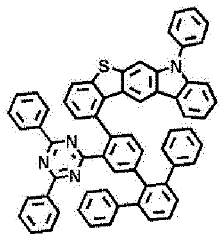

288

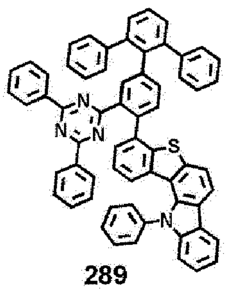

289

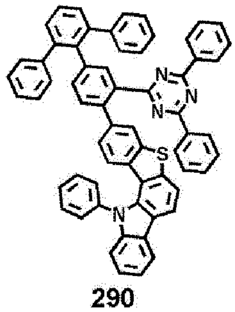

290

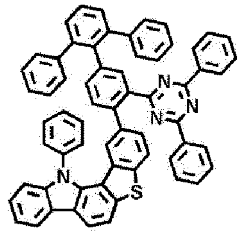

291

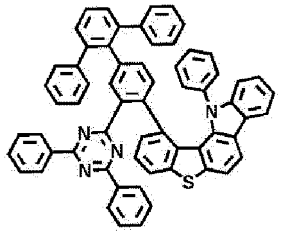

292

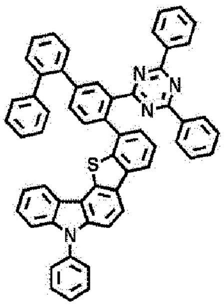

293

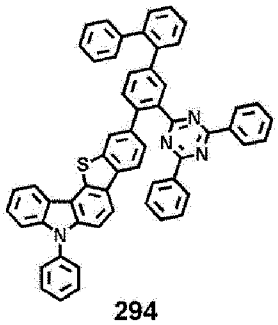

294

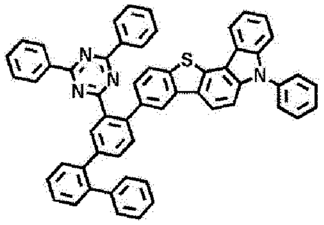

295

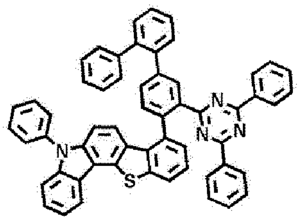

296

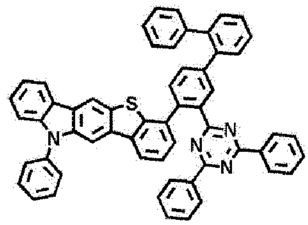

297

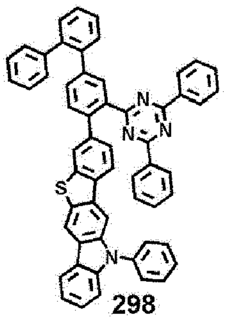

298

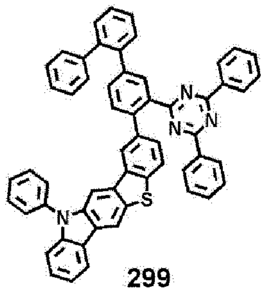

299

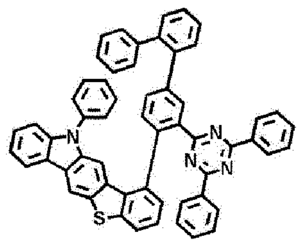

300

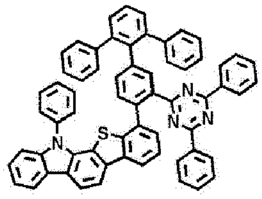
301

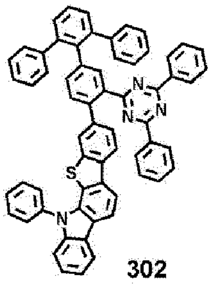
302

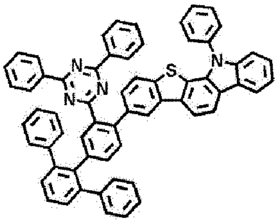
303

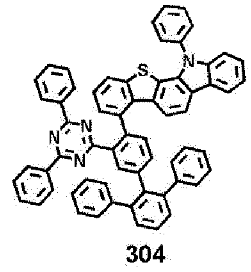
304

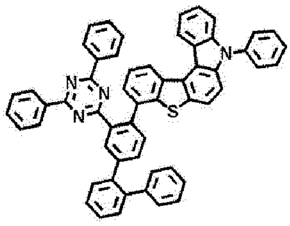
305

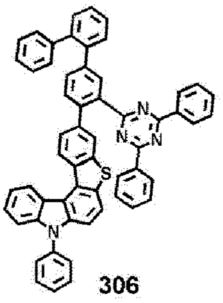
306

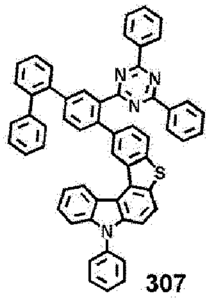
307

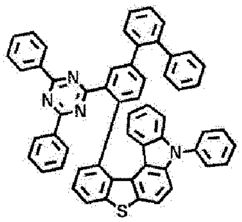
308

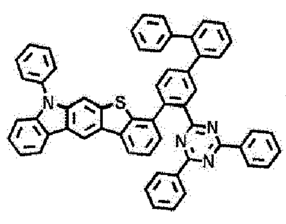
309

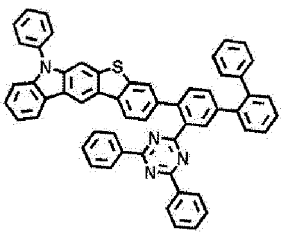
310

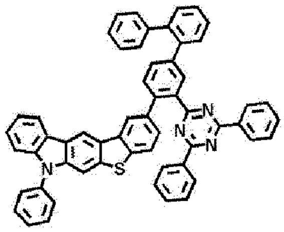
311

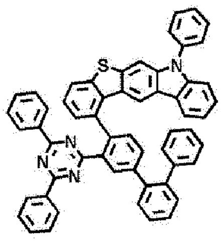
312

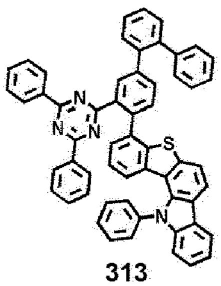
313

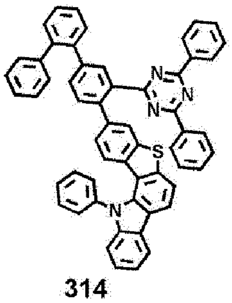
314

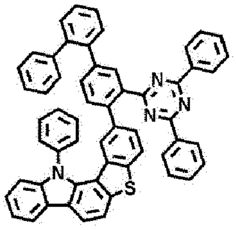
315

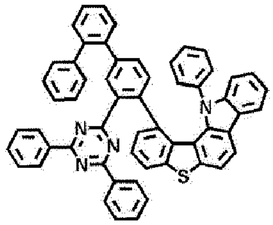
316

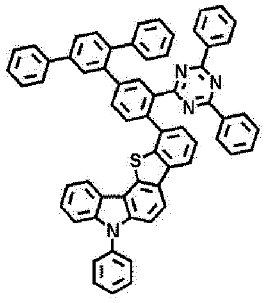
317

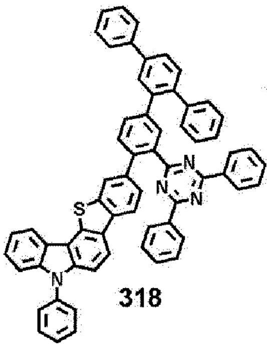
318

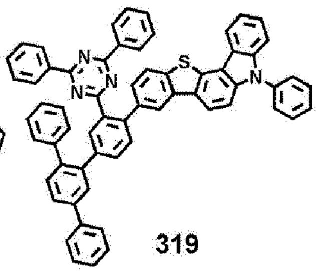
319

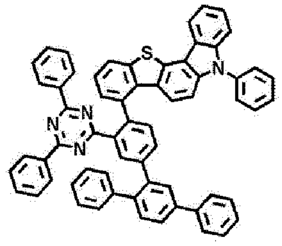
320

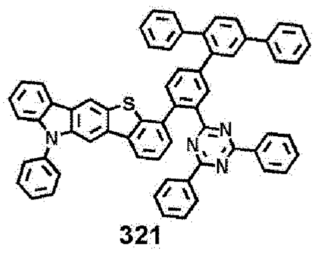
321

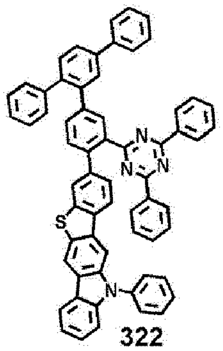
322

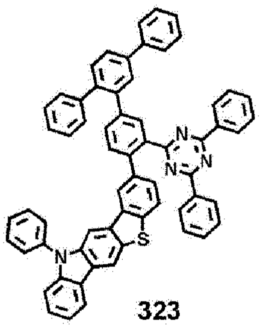
323

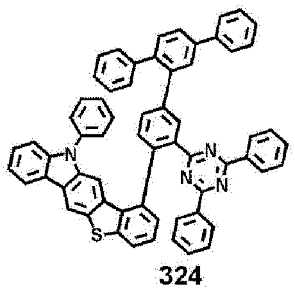
324

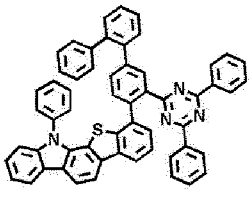
325

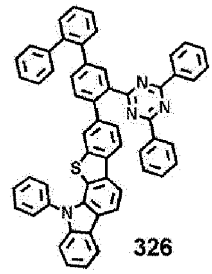
326

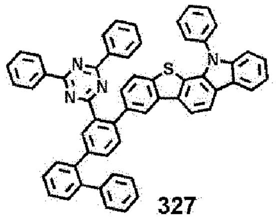
327

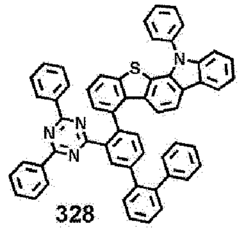
328

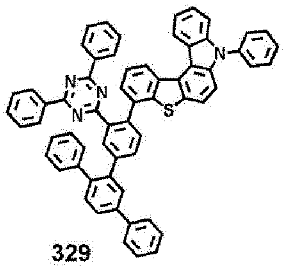
329

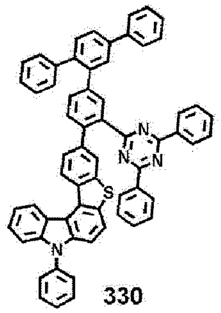
330

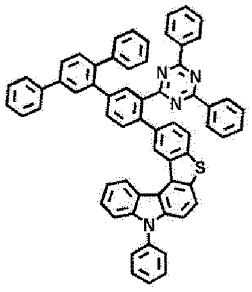
331

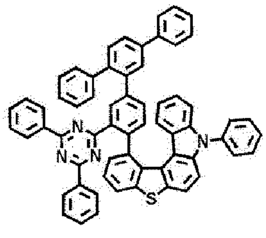
332

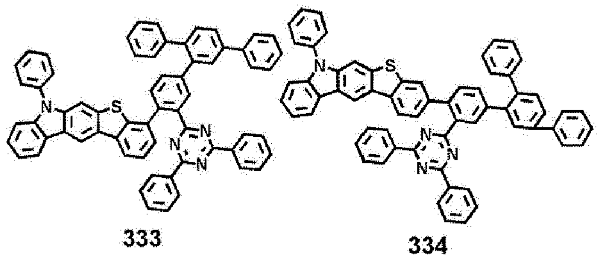
333

334

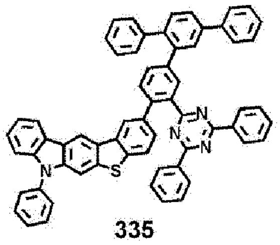
335

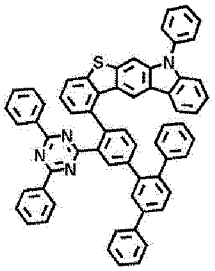
336

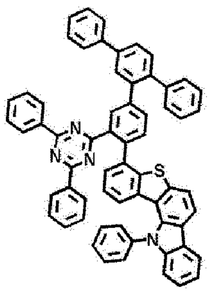
337

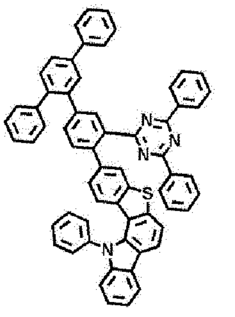
338

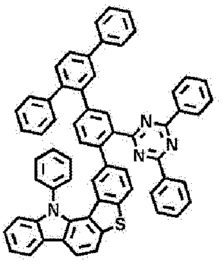
339

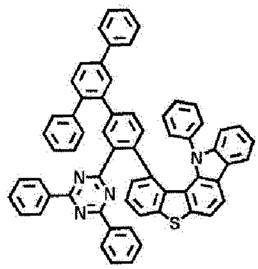
340

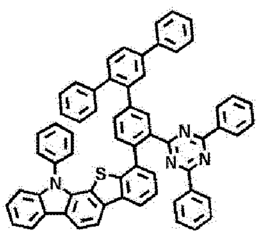
341

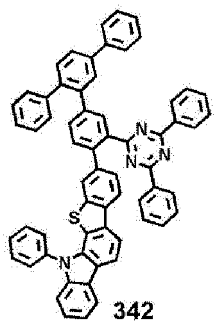
342

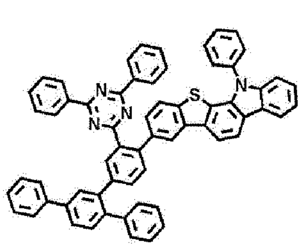
343

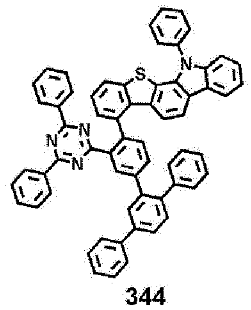
344

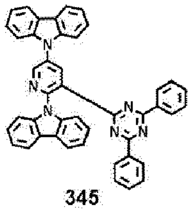
345

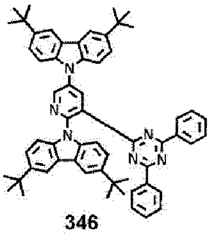
346

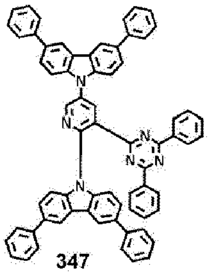
347

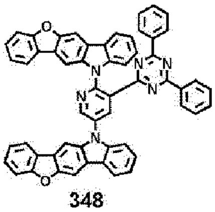
348

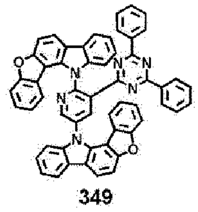
349

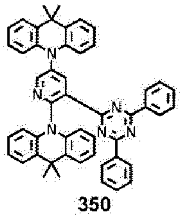
350

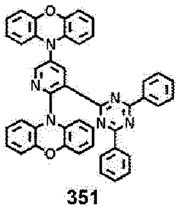
351

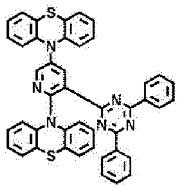
352

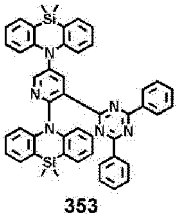
353

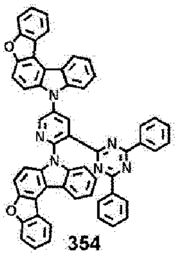
354

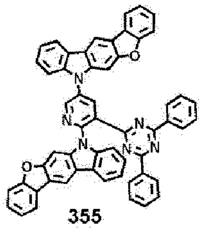
355

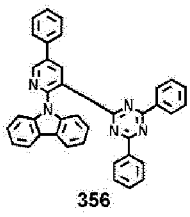
356

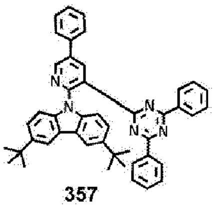
357

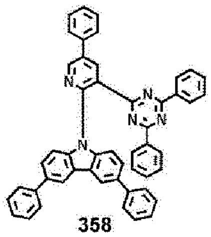
358

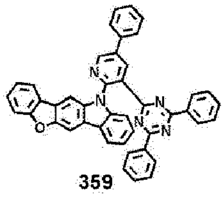
359

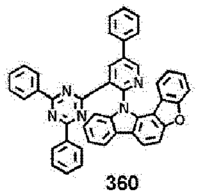
360

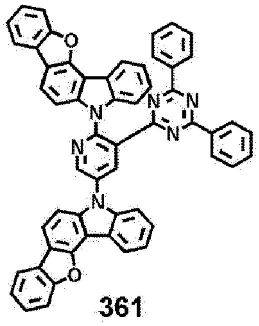
361
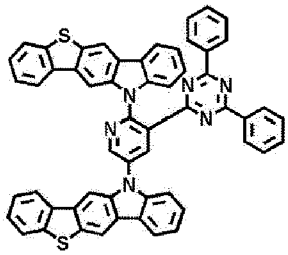
362
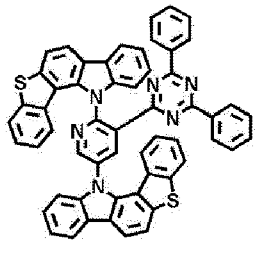
363
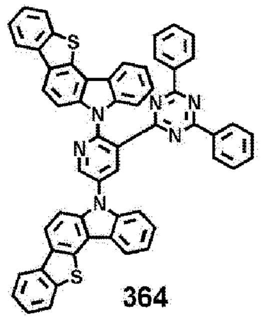
364

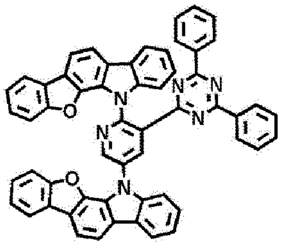
365
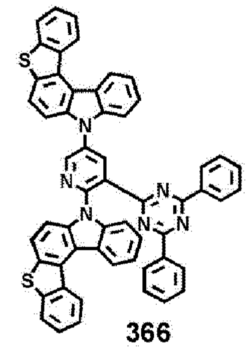
366
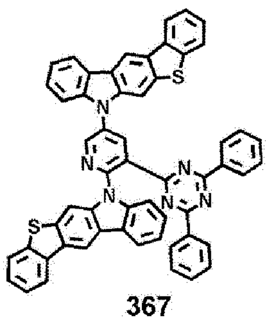
367
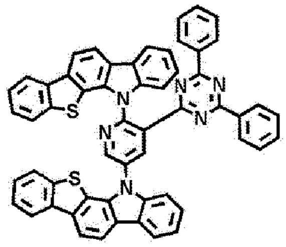
368

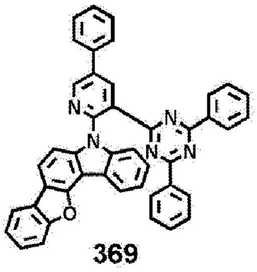
369
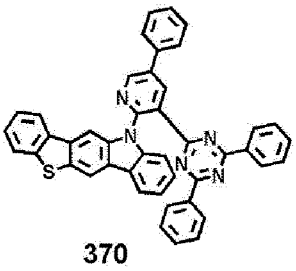
370
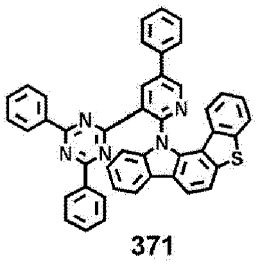
371
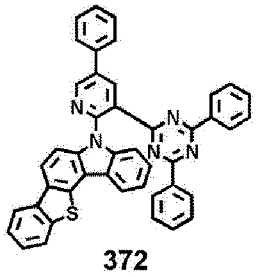
372

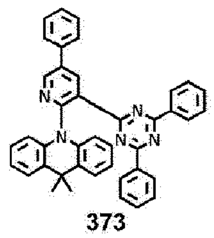
373

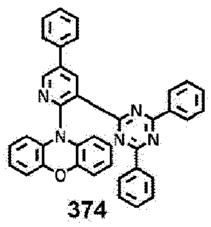
374

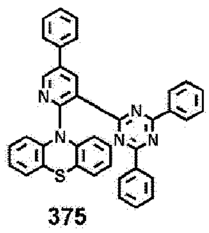
375

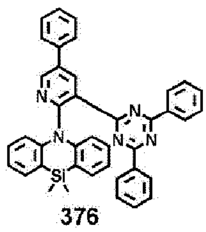
376

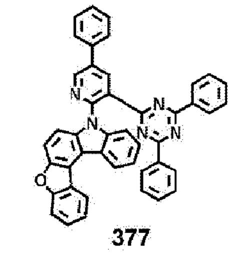
377

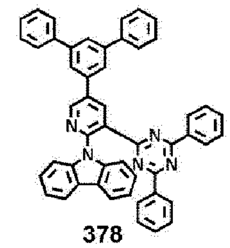
378

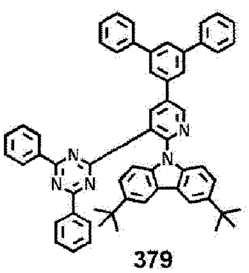
379

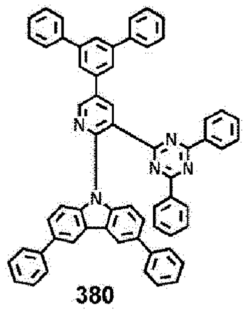
380

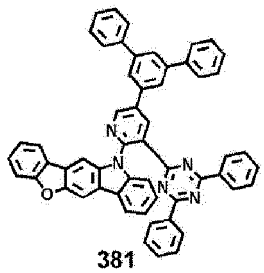
381

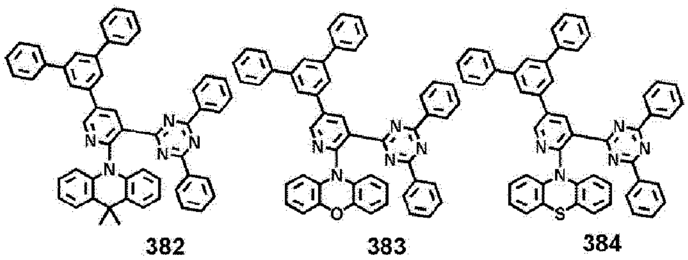
382

383

384

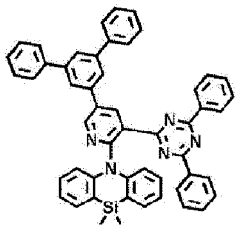
385

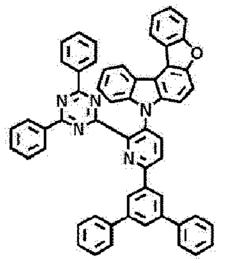
386

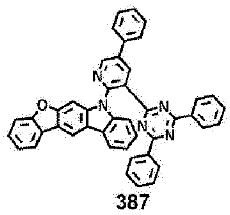
387

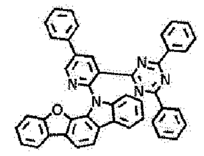
388

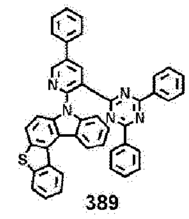
389

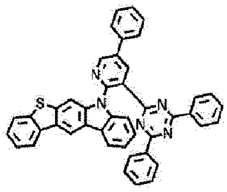
390

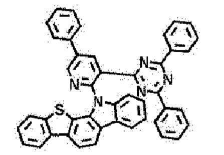
391

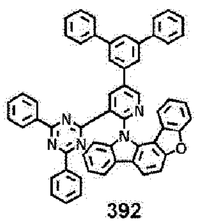
392

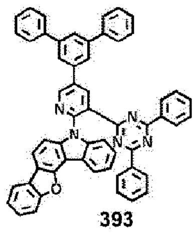
393

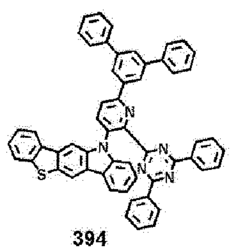
394

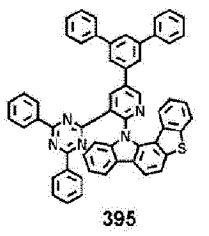
395

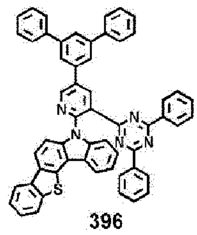
396

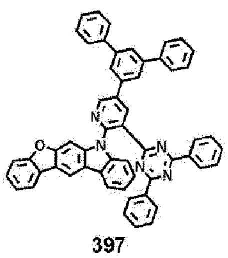
397

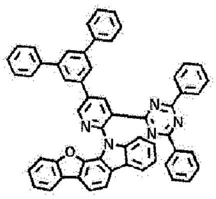
398

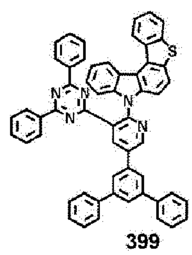
399

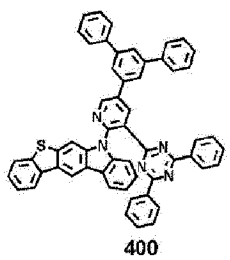
400

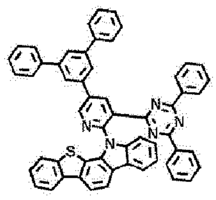
401

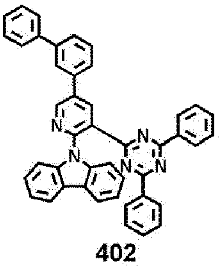
402

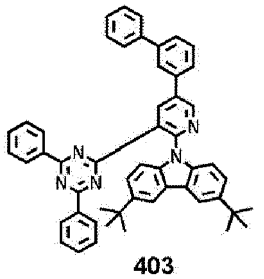
403

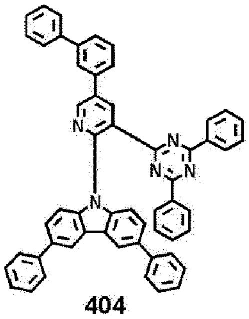
404

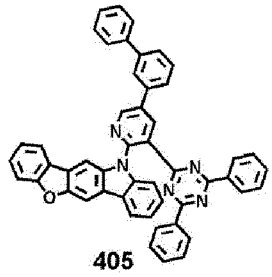
405

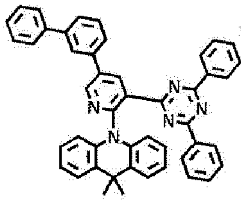
406

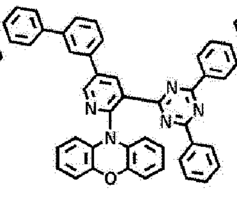
407

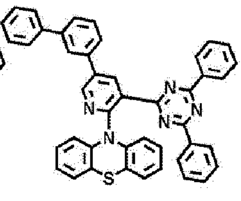
408

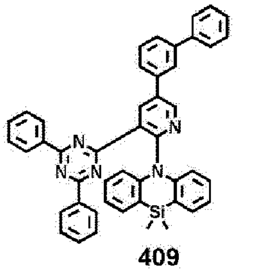
409

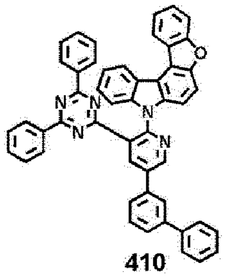
410

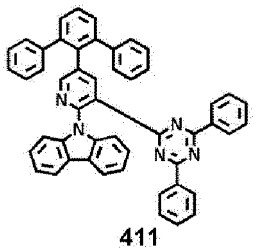
411

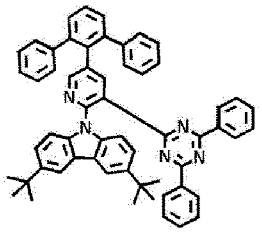
412

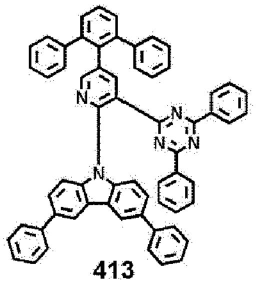
413

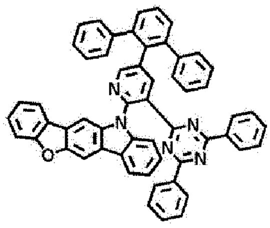
414

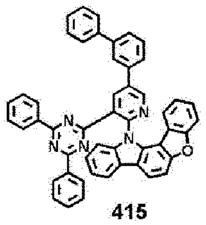
415

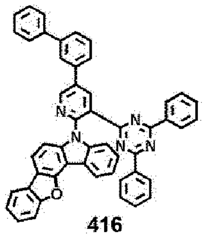
416

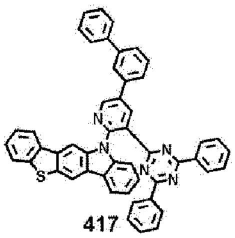
417

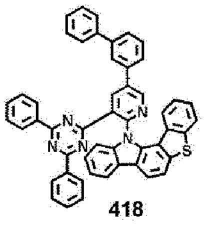
418

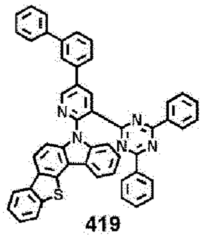
419

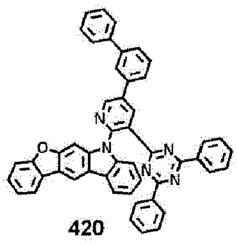
420

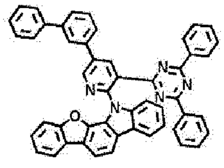
421

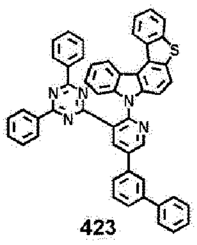
423

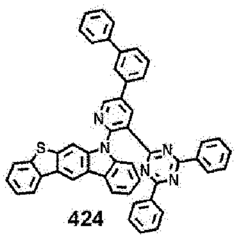
424

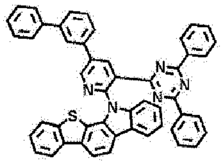
425

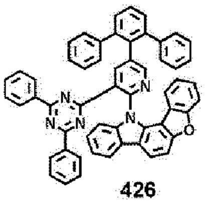
426

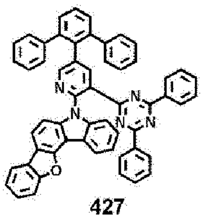
427

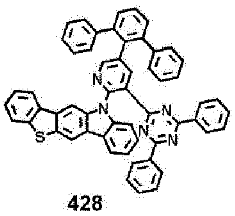
428

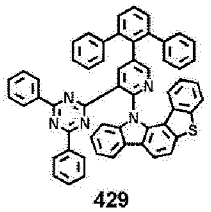
429

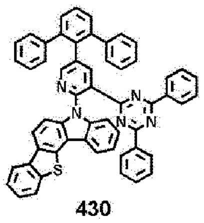
430

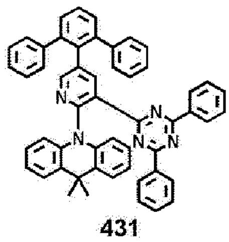
431
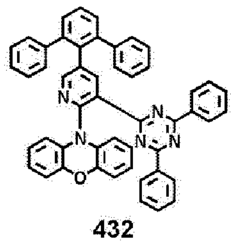
432
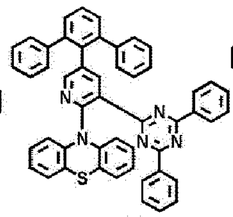
433
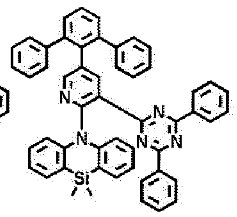
434
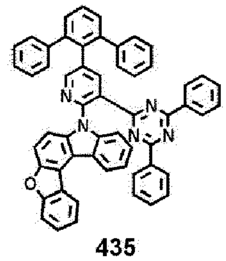
435

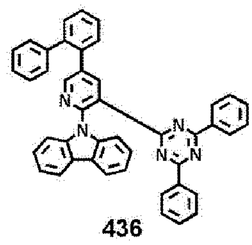
436
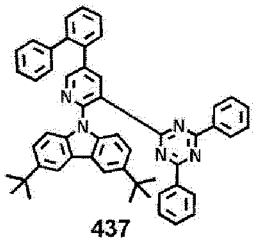
437
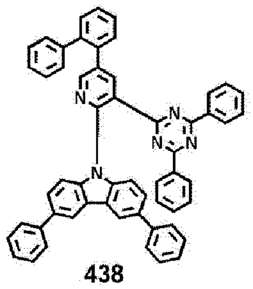
438
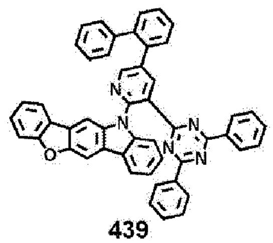
439

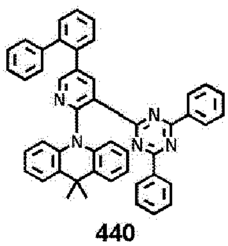
440
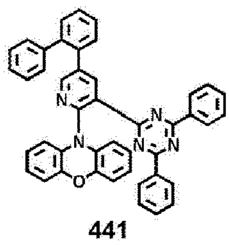
441
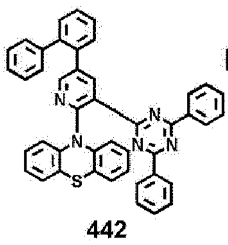
442
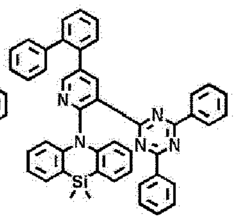
443
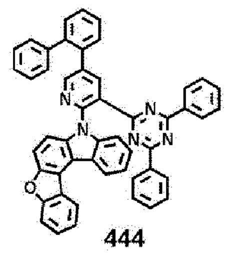
444

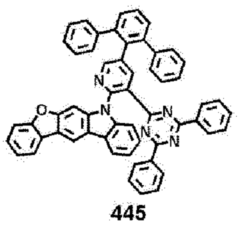
445
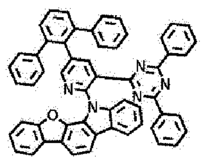
446
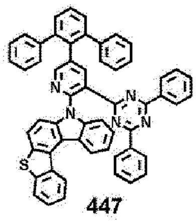
447
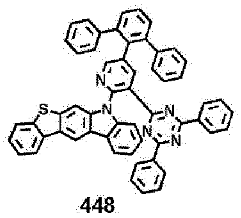
448
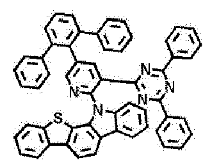
449

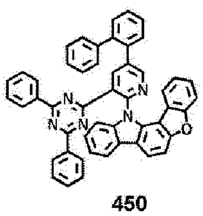
450
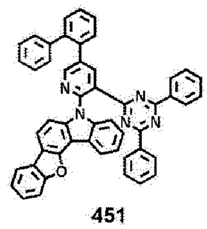
451
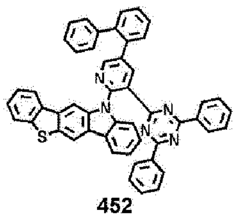
452
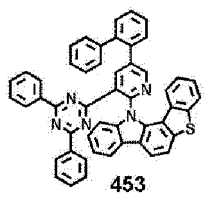
453
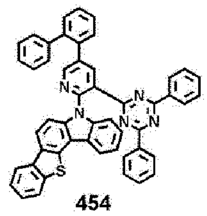
454

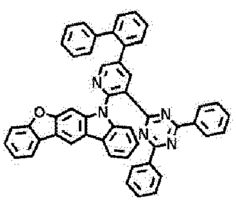
455
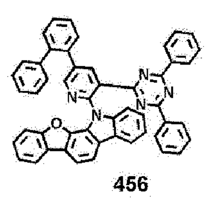
456
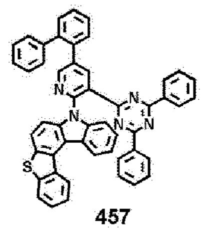
457
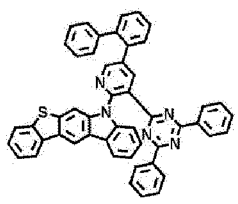
458
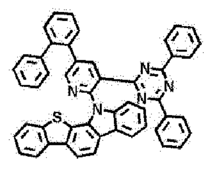
459

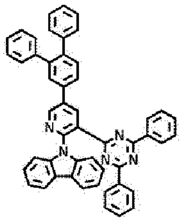
460

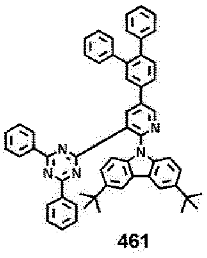
461

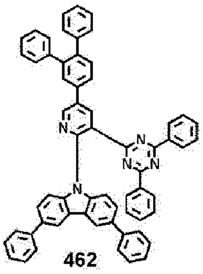
462

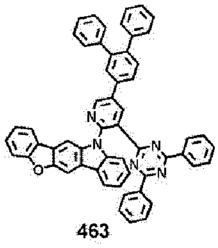
463

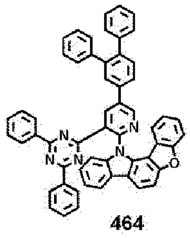
464

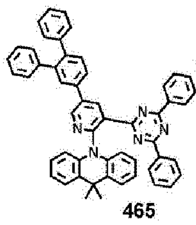
465

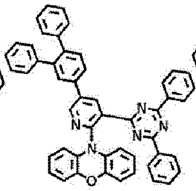
466

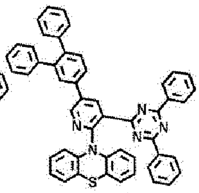
467

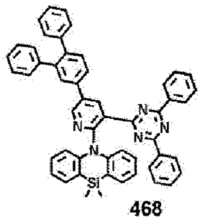
468

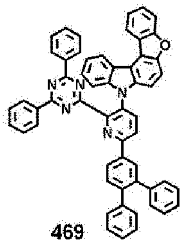
469

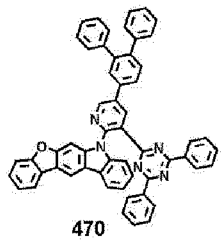
470

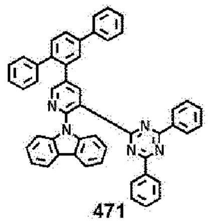
471

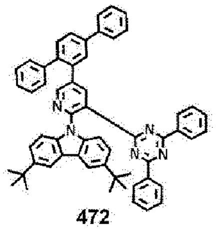
472

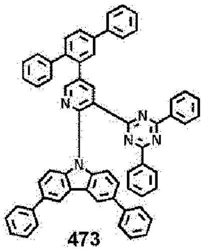
473

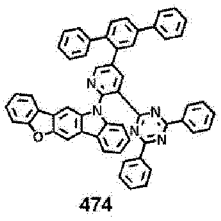
474

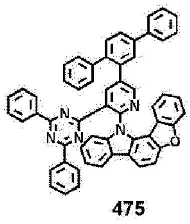
475

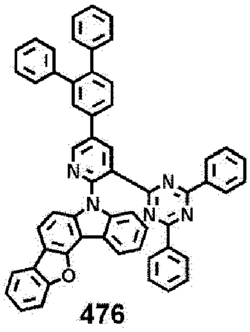
476

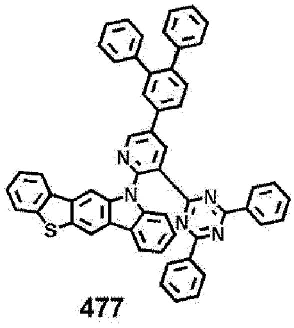
477

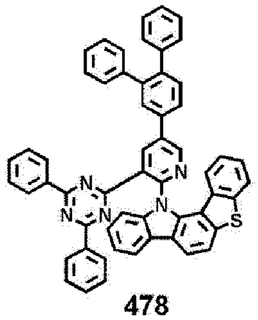
478

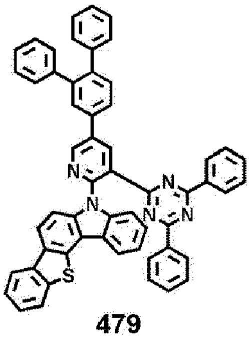
479

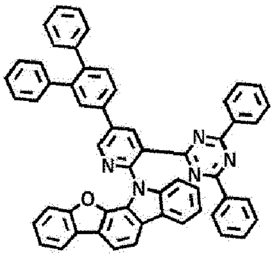
480

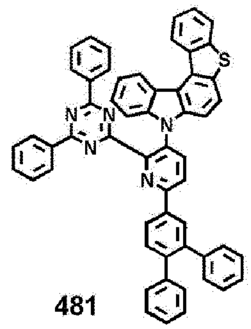
481

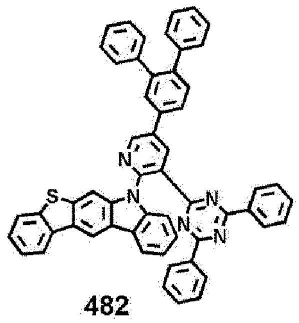
482

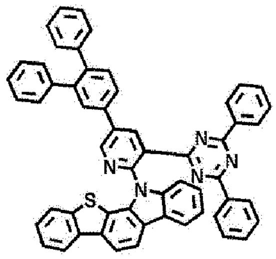
483

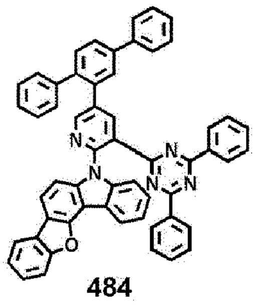
484

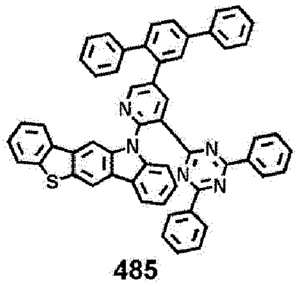
485

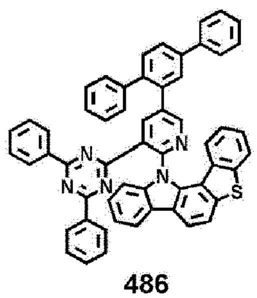
486

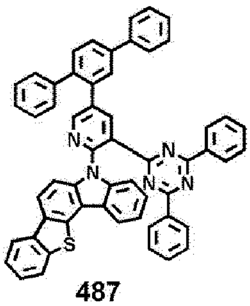
487

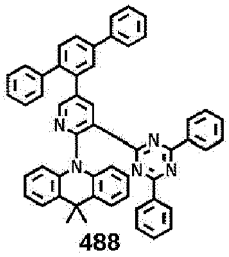
488

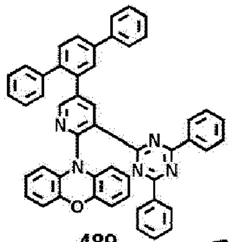
489

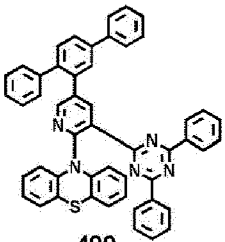
490

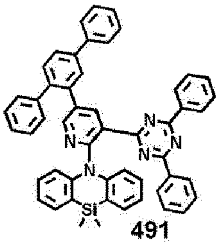
491

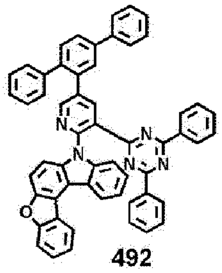
492

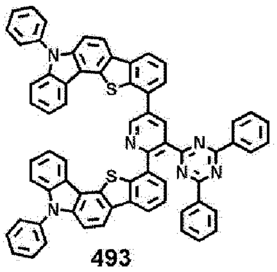
493

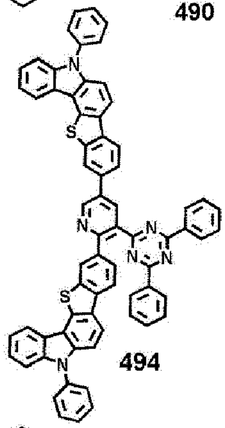
494

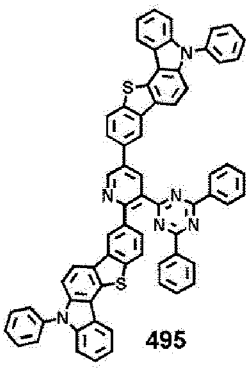
495

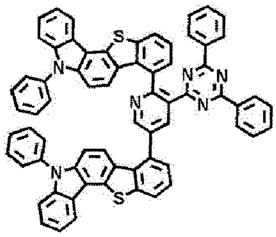
496

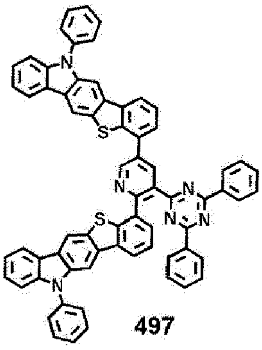
497

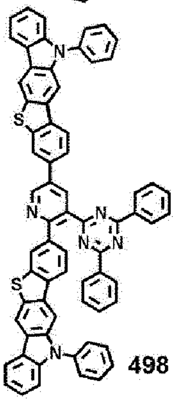
498

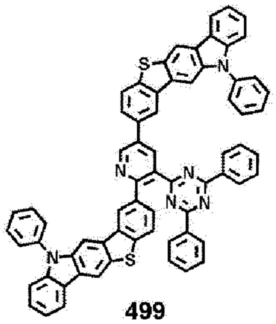
499

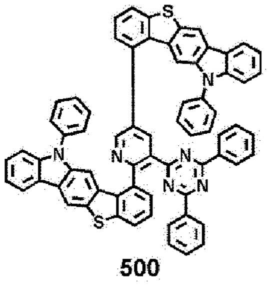
500

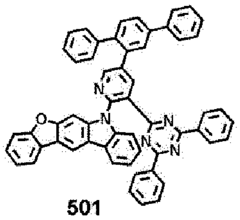
501

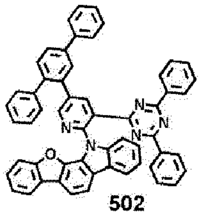
502

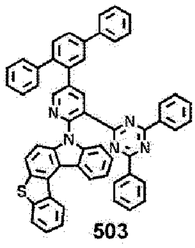
503

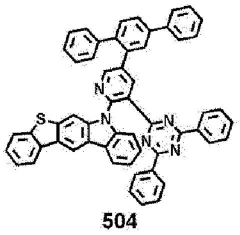
504

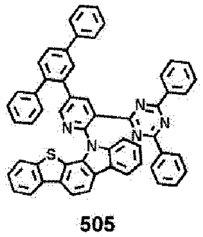
505

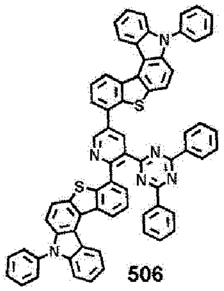
506

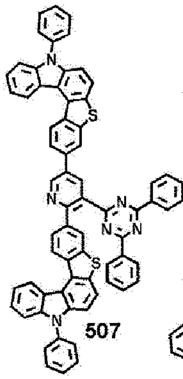
507

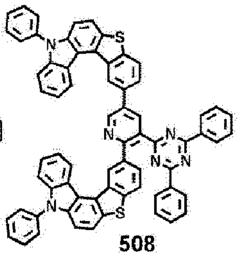
508

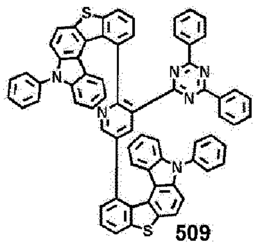
509

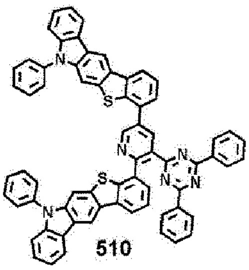
510

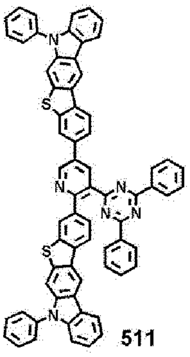
511

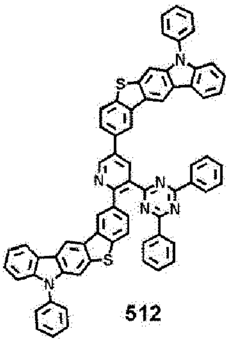
512

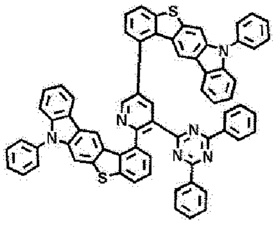
513

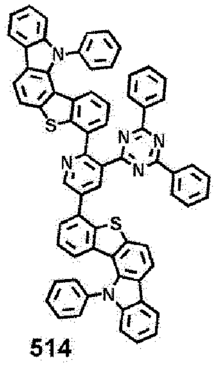
514

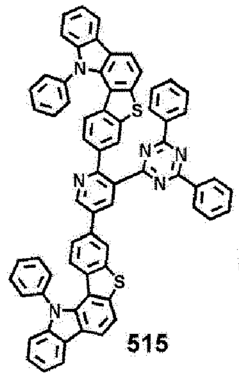
515

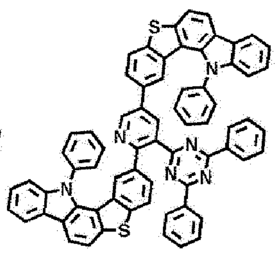
516

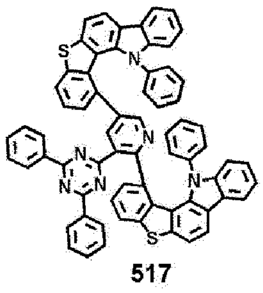
517

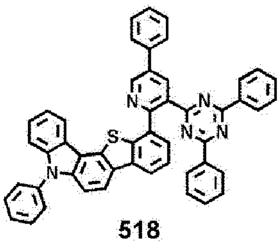
518

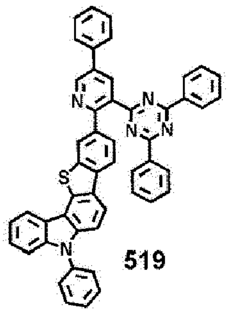
519

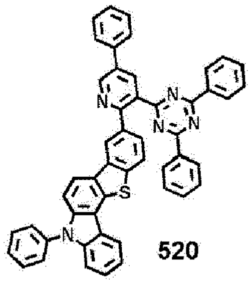
520

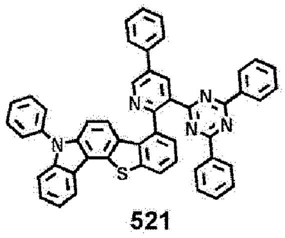
521

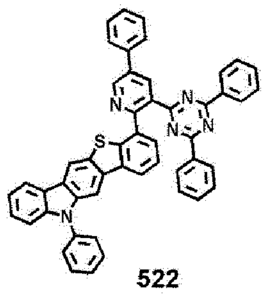
522

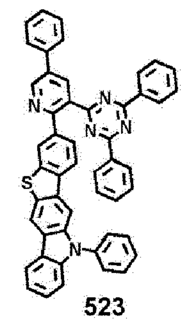
523

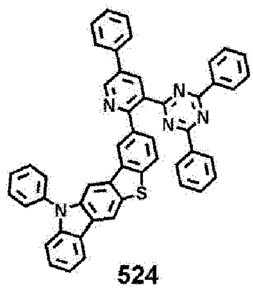
524

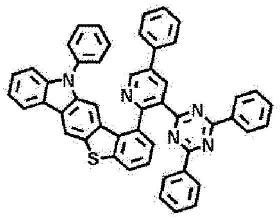
525

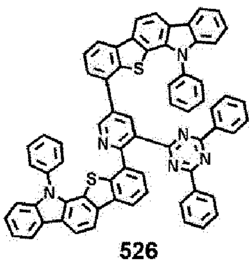
526

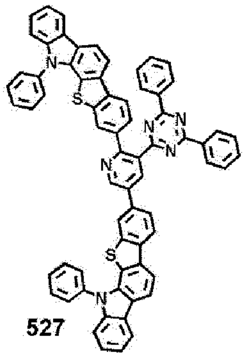
527

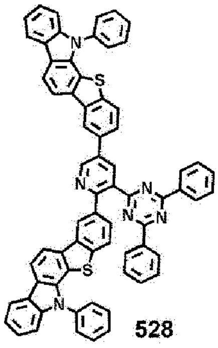
528

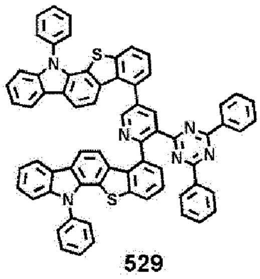
529

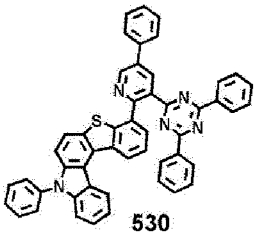
530

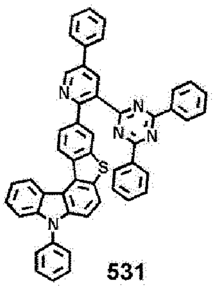
531

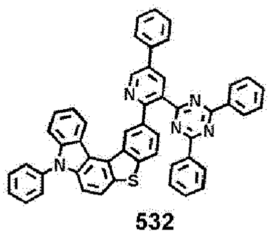
532

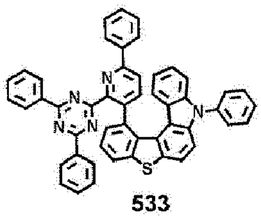
533

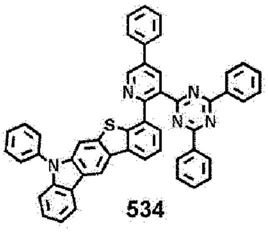
534

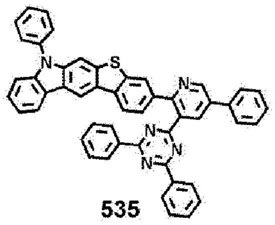
535

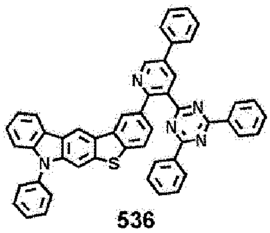
536

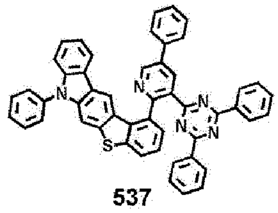
537

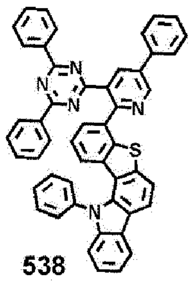
538

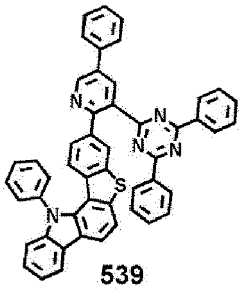
539

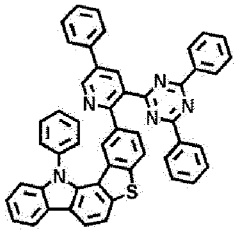
540

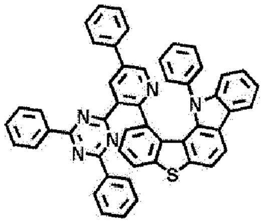
541

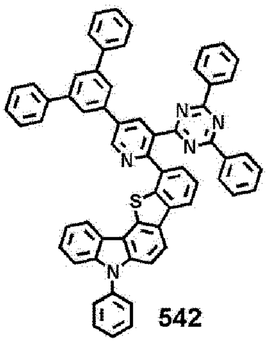
542

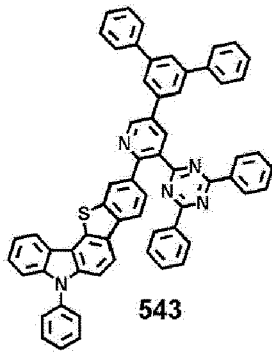
543

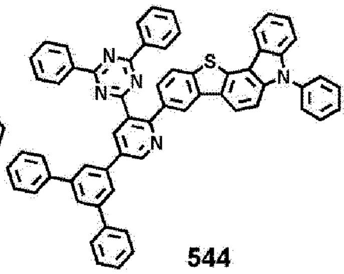
544

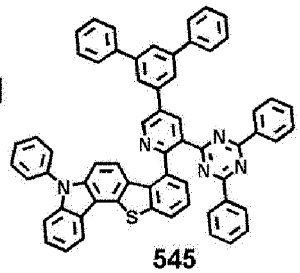
545

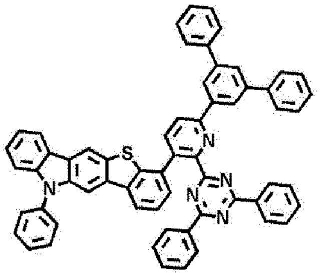
546

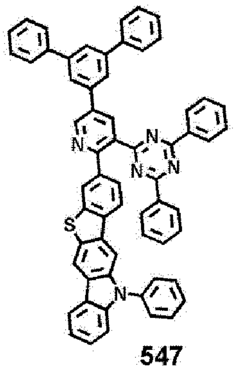
547

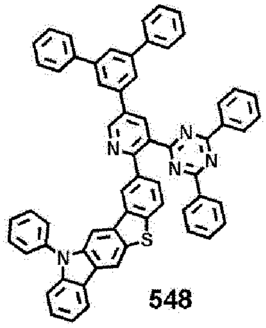
548

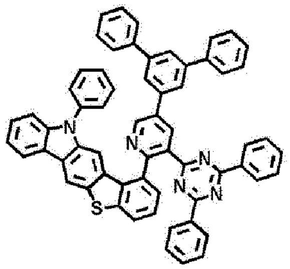
549

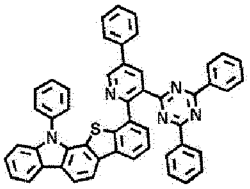
550

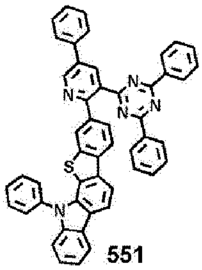
551

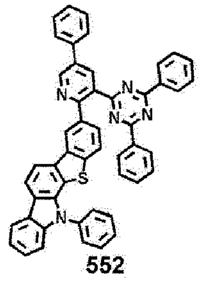
552

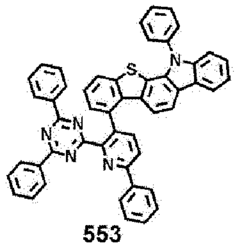
553

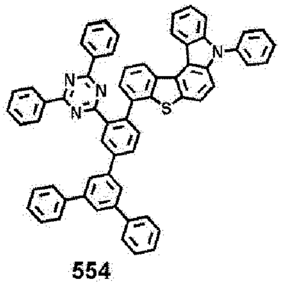
554

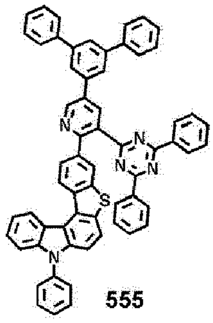
555

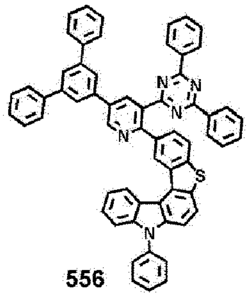
556

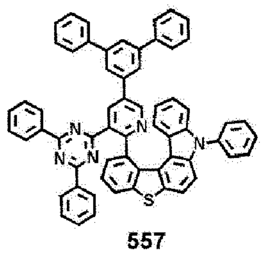
557

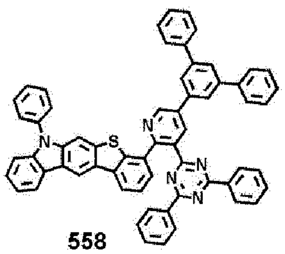
558

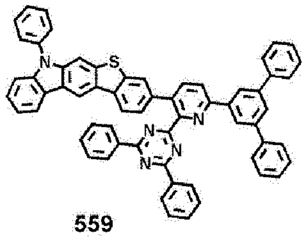
559

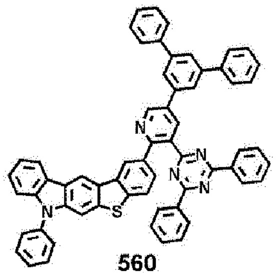
560

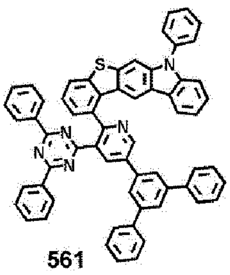
561

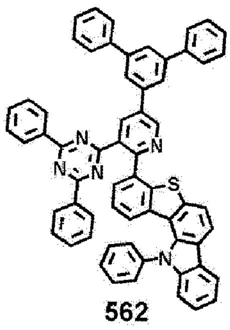
562

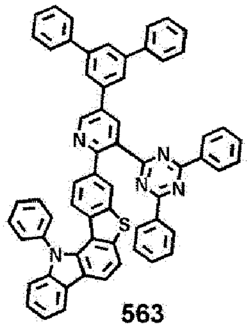
563

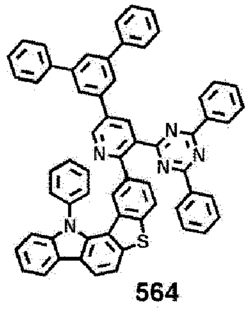
564

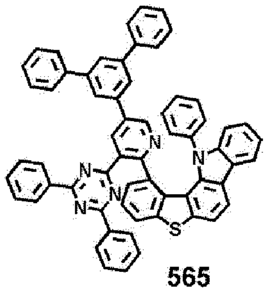
565

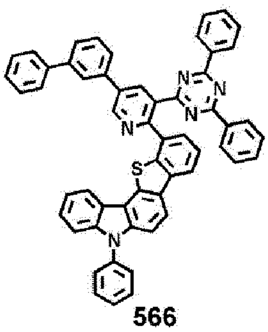
566

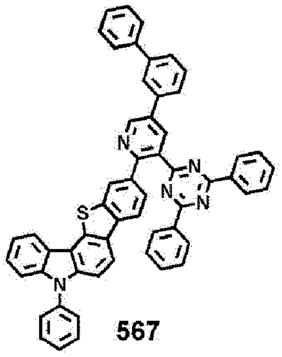
567

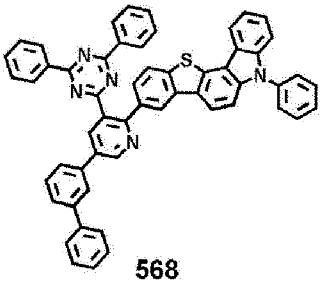
568

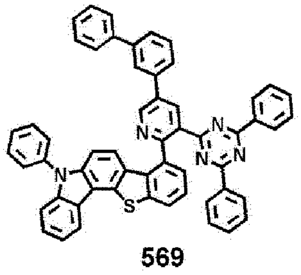
569

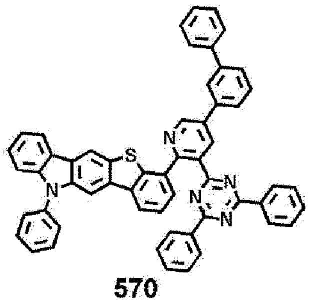
570

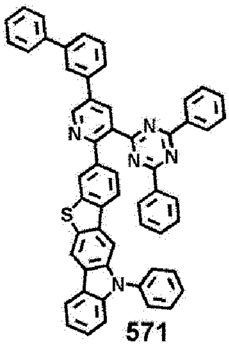
571

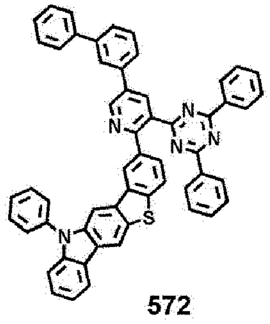
572

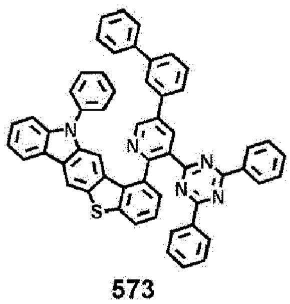
573

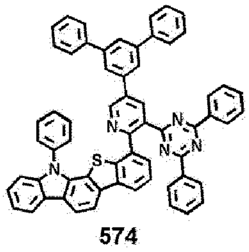
574

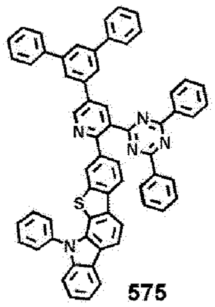
575

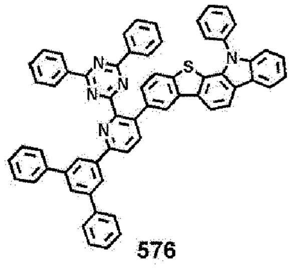
576

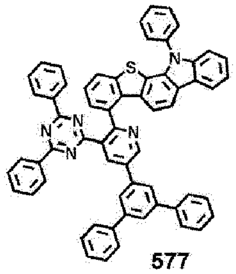
577

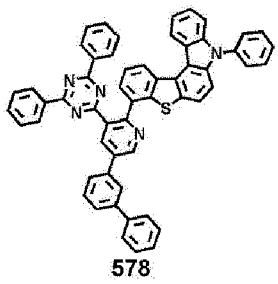
578

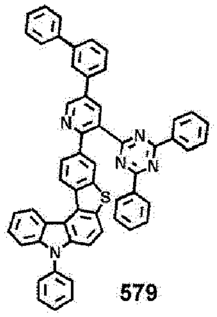
579

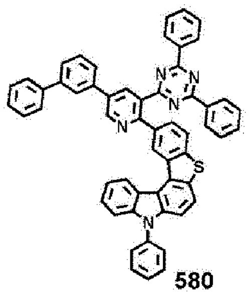
580

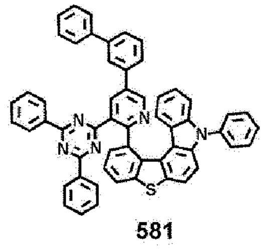
581

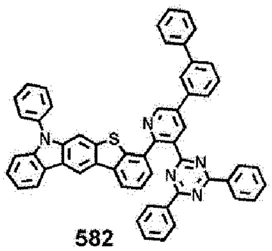
582

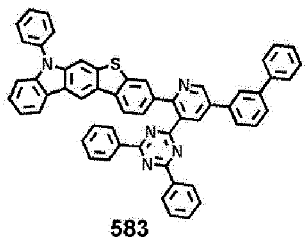
583

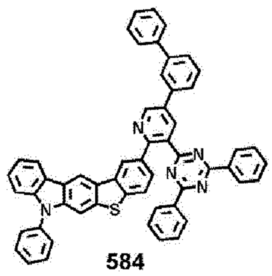
584

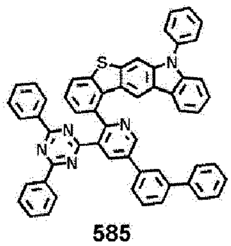
585

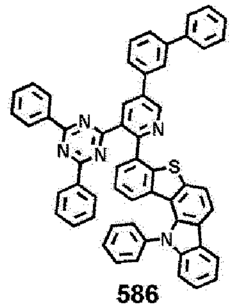

586

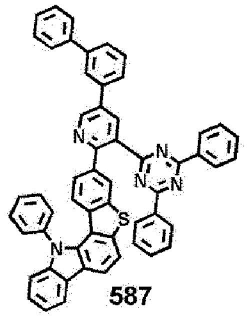

587

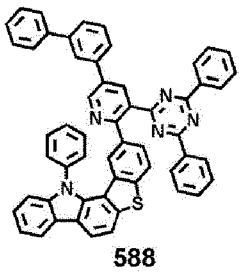

588

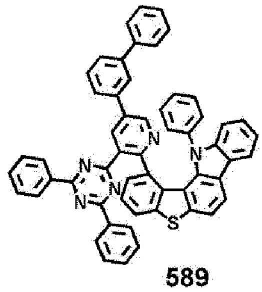

589

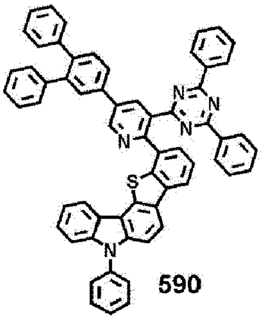

590

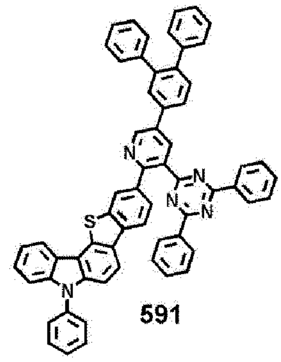

591

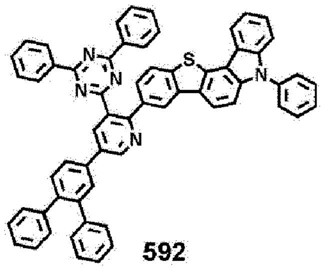

592

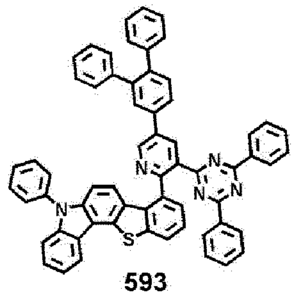

593

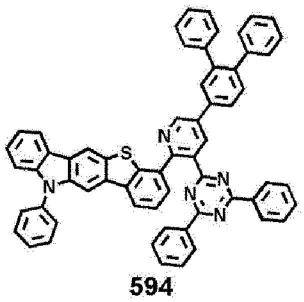

594

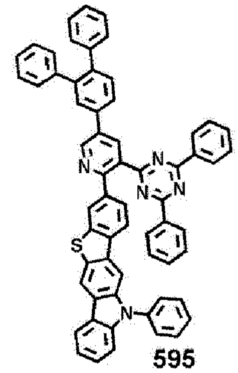

595

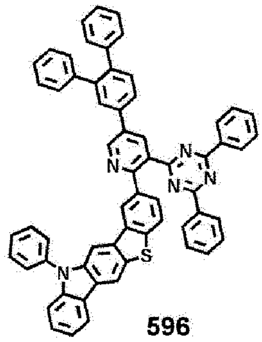

596

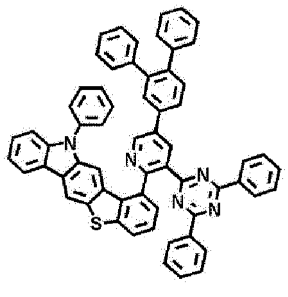

597

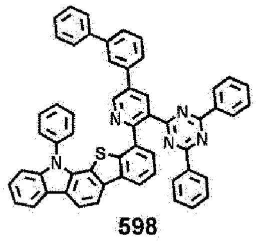

598

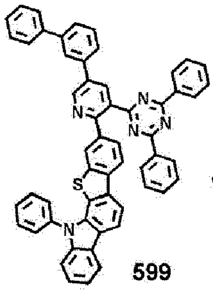

599

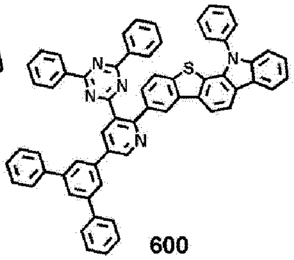

600

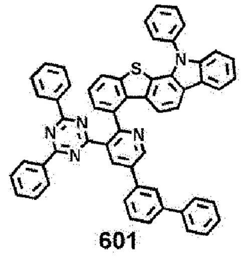

601

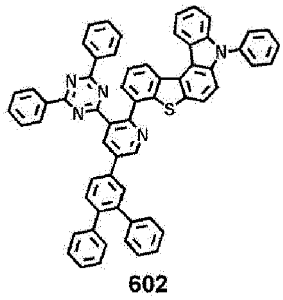

602

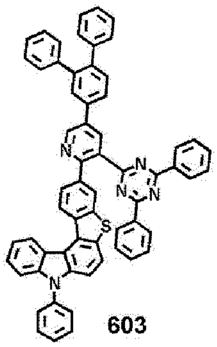

603

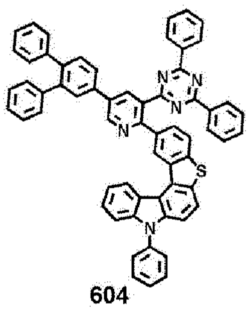

604

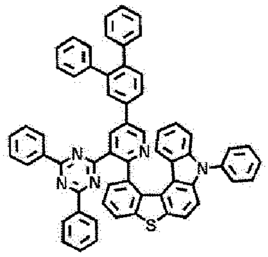

605

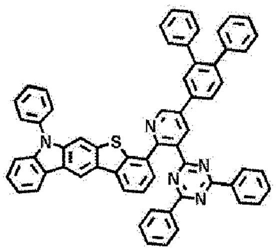

606

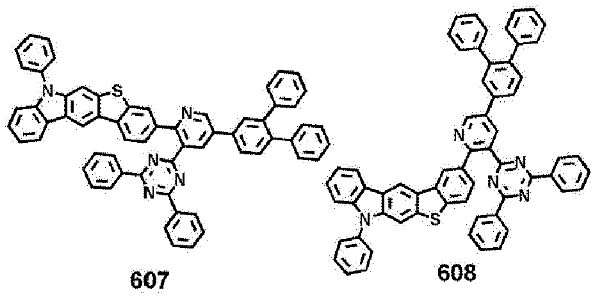

607

608

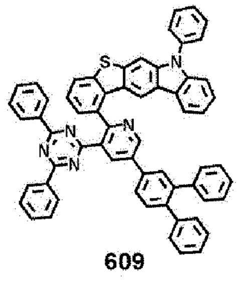

609

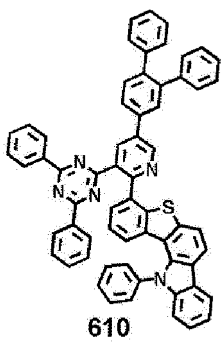

610

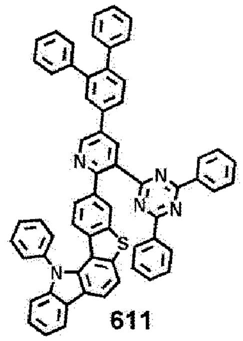

611

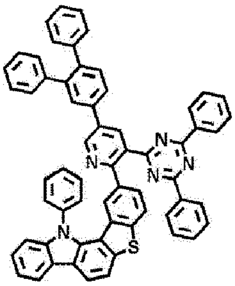

612

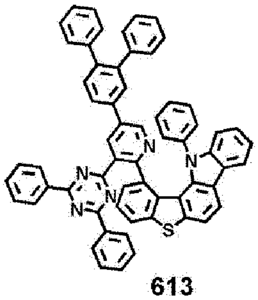

613

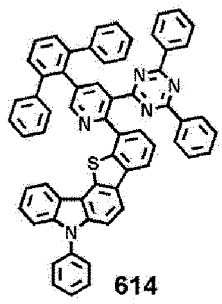

614

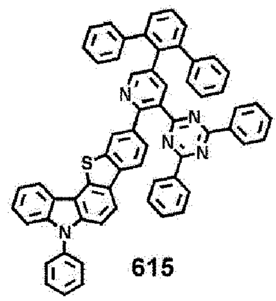

615

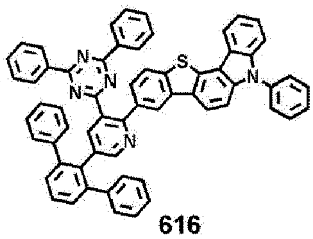

616

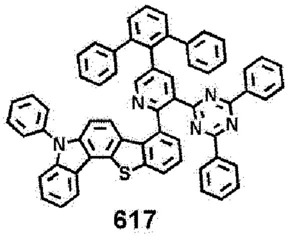

617

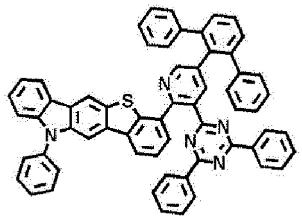

618

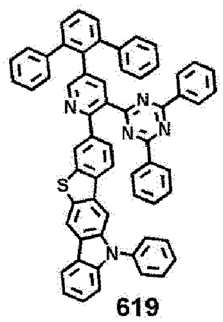

619

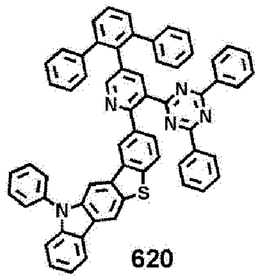

620

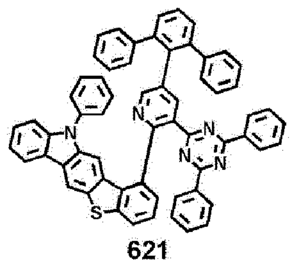

621

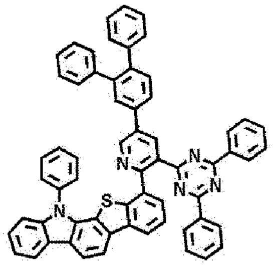
622

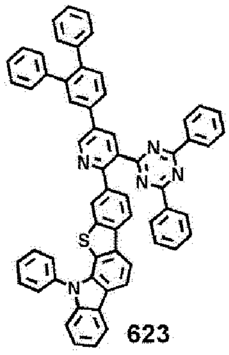
623

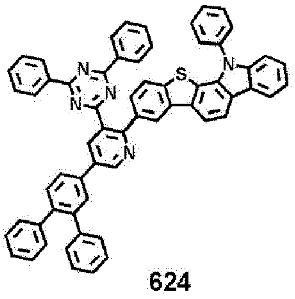
624

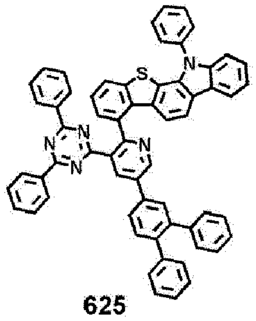
625

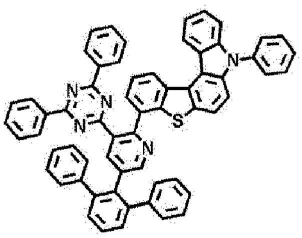
626

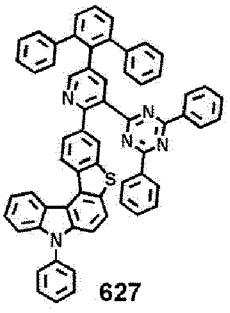
627

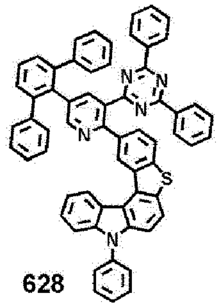
628

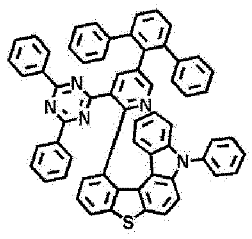
629

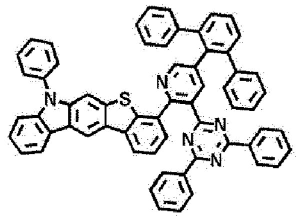
630

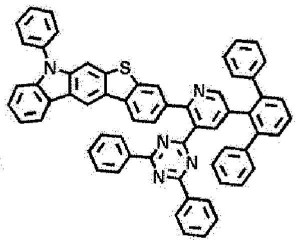
631

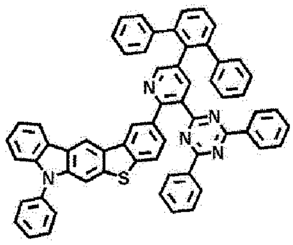
632

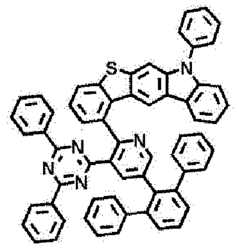
633

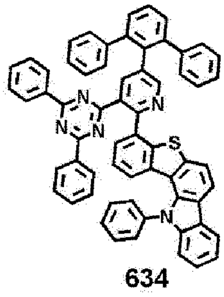
634

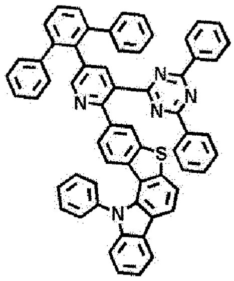
635

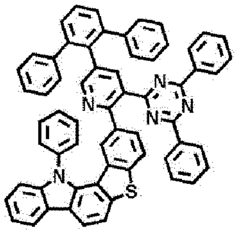
636

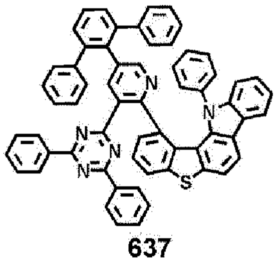
637

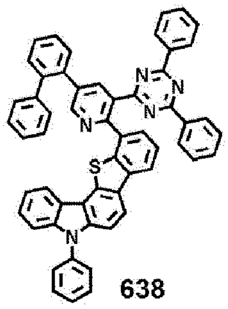
638

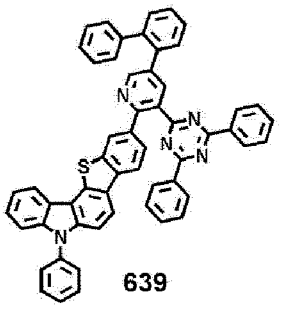
639

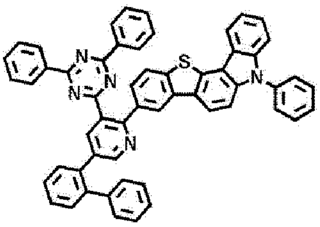
640

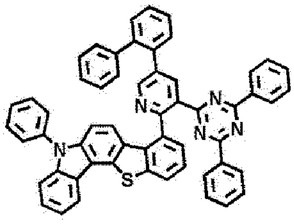
641

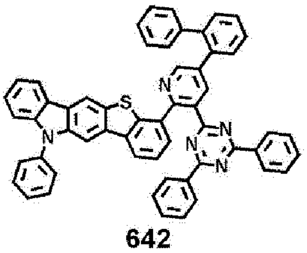
642

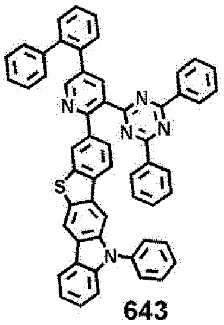
643

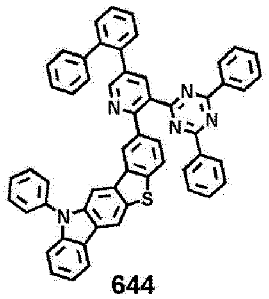
644

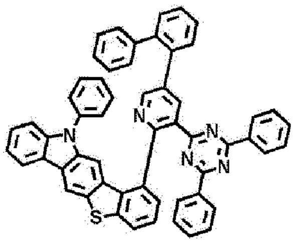
645

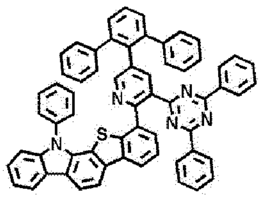
646

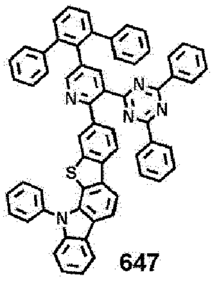
647

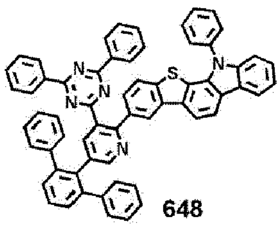
648

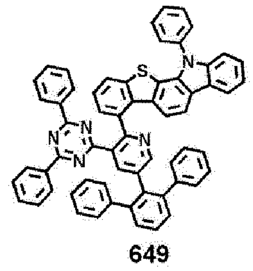
649

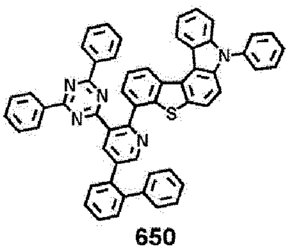
650

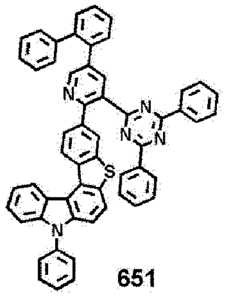
651

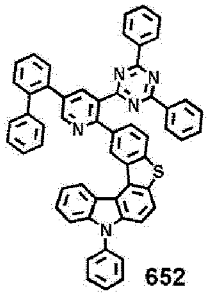
652

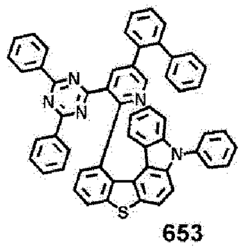
653

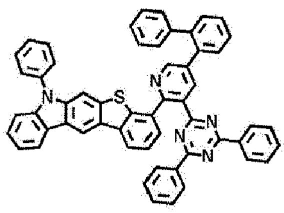
654

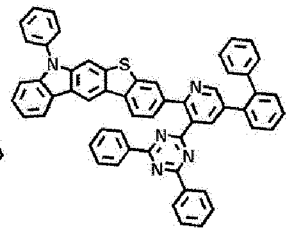
655

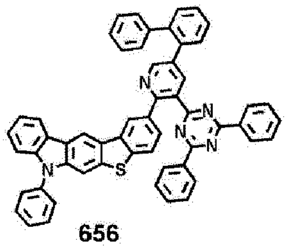
656

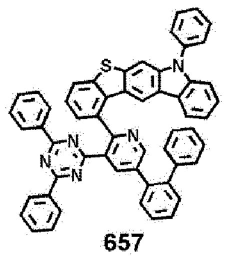
657

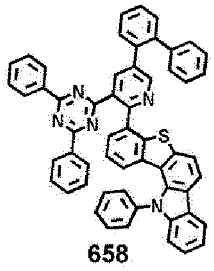
658

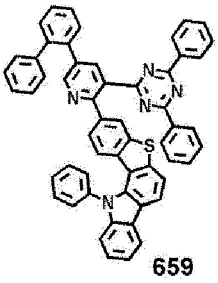
659

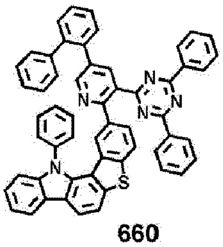
660

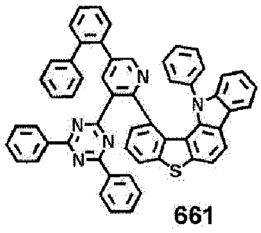
661

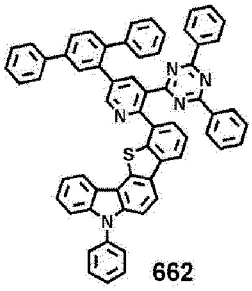
662

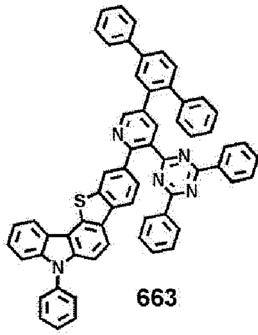
663

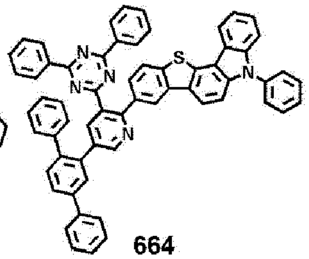
664

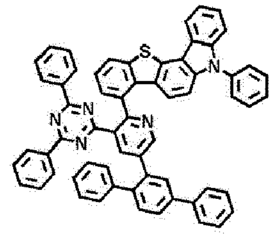
665

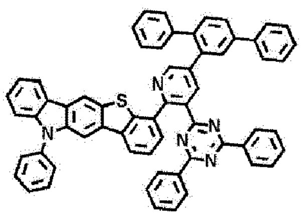
666

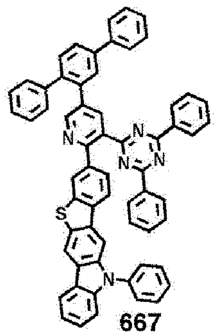
667

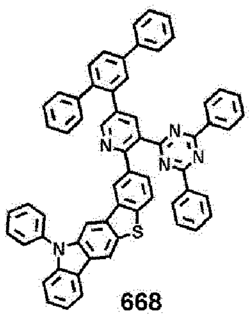
668

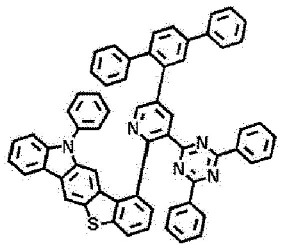
669

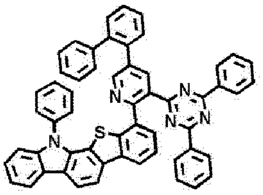
670

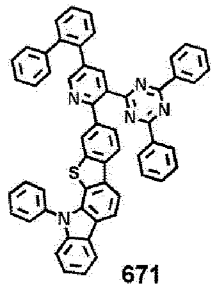
671

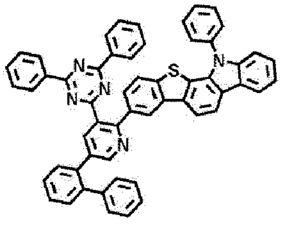
672

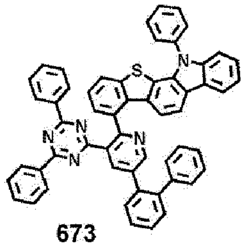
673

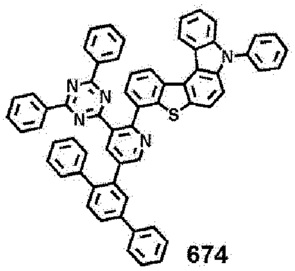
674

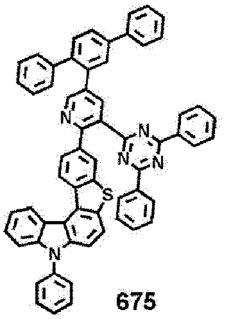
675

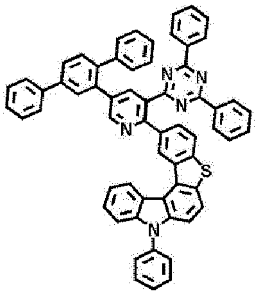
676

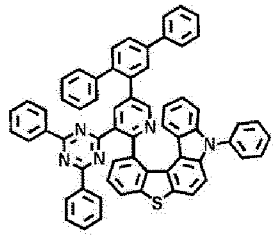
677

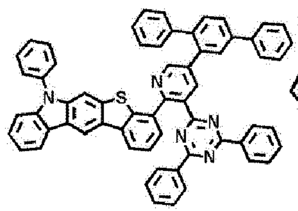
678

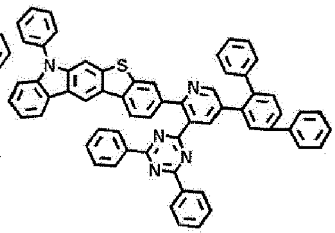
679

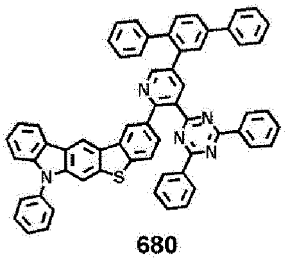
680

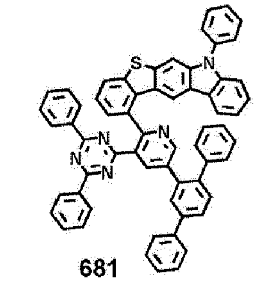
681

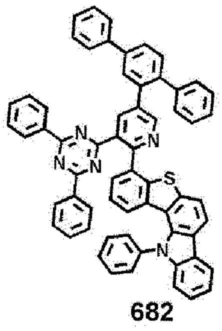
682

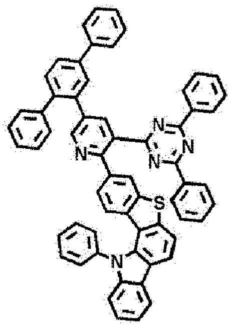
683

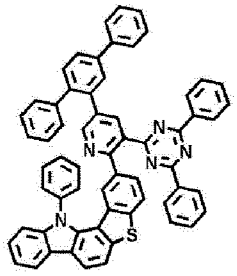
684

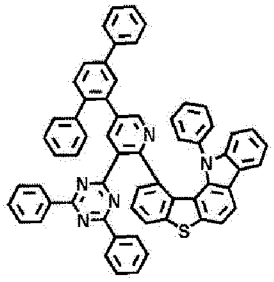
685

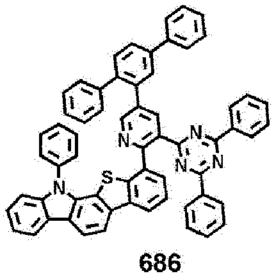
686

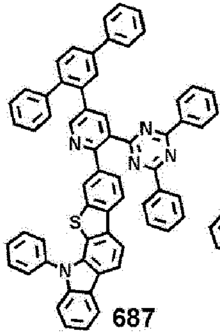
687

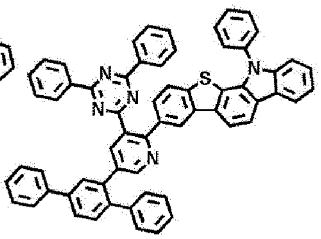
688

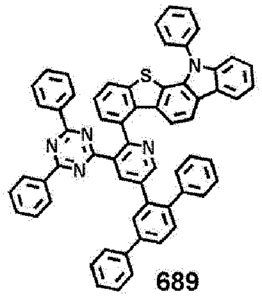
689

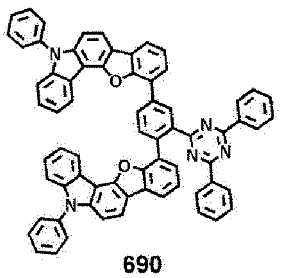
690

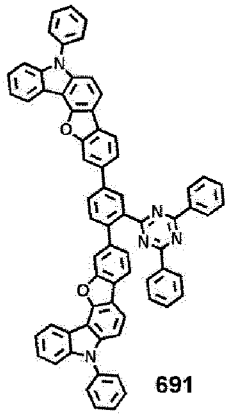
691

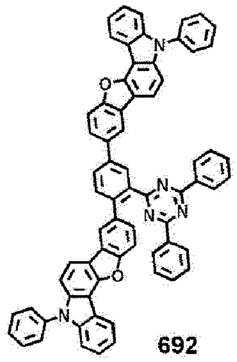
692

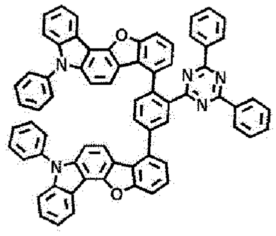
693

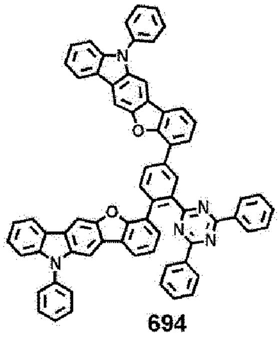
694

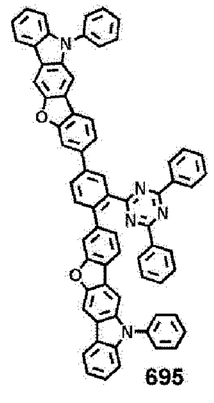
695

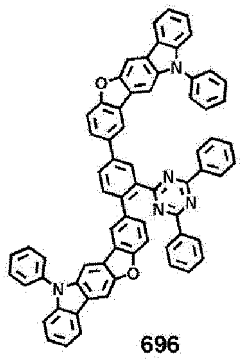
696

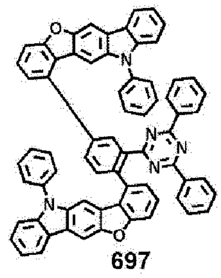
697

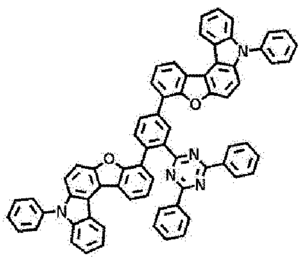
698

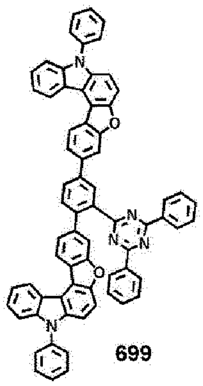
699

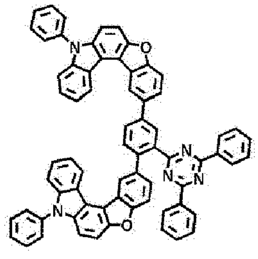
700

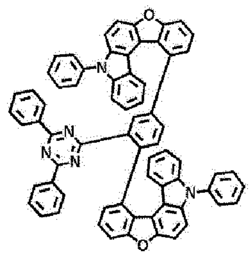
701

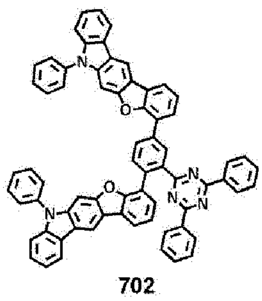
702

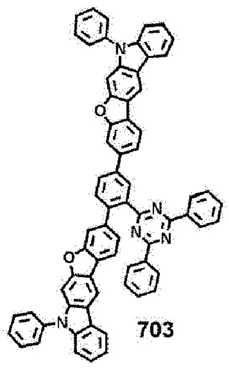
703

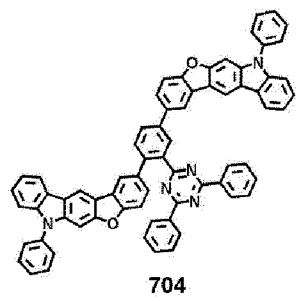
704

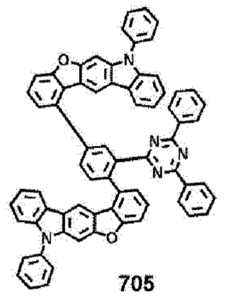
705

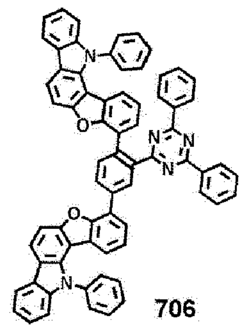
706

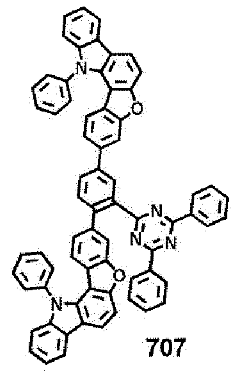
707

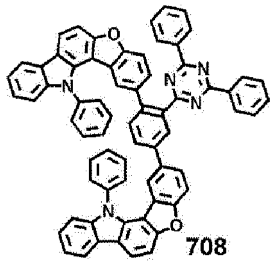
708

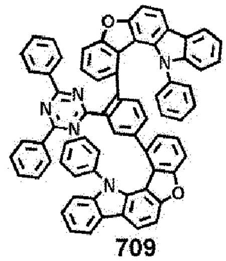
709

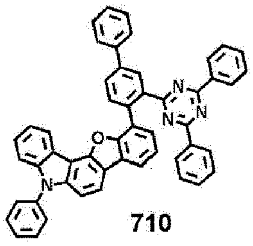
710

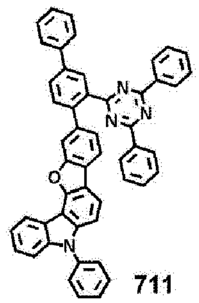
711

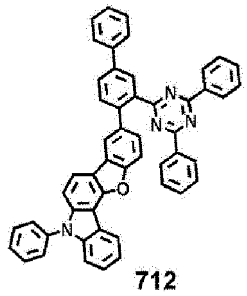
712

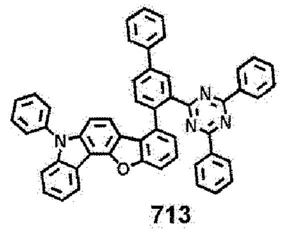
713

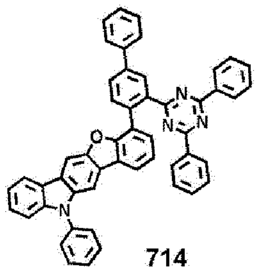
714

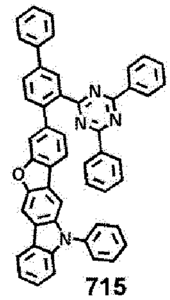
715

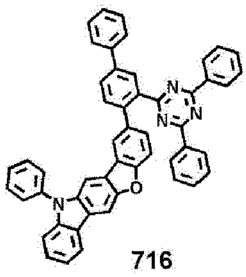
716

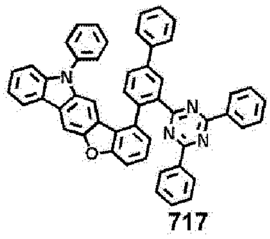
717

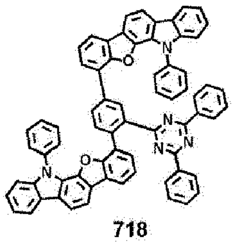
718

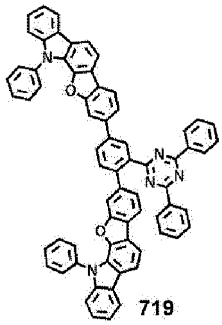
719

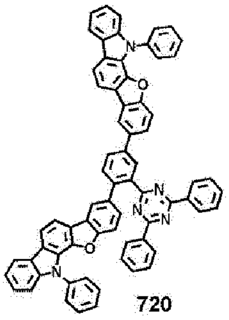
720

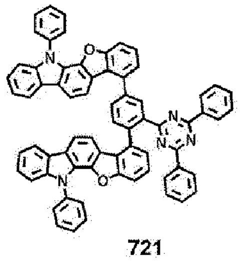
721

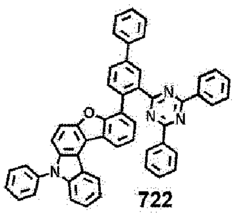
722

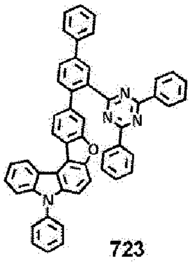
723

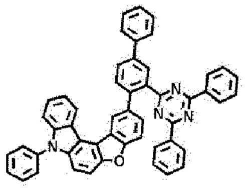
724

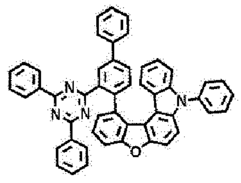
725

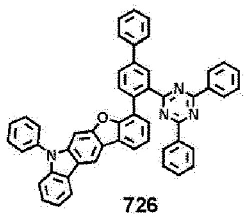
726

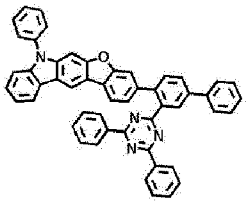
727

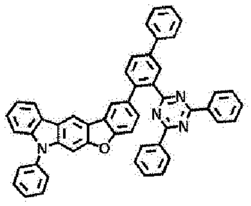
728

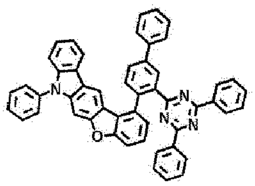
729

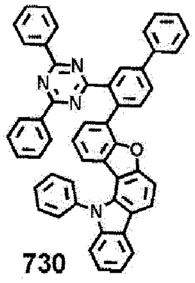

730

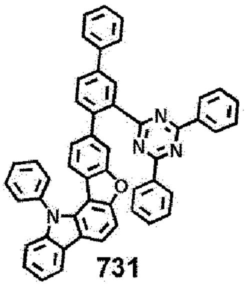

731

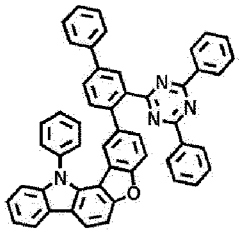

732

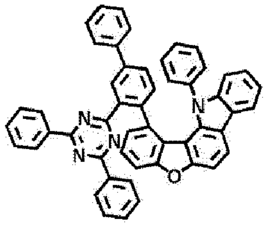

733

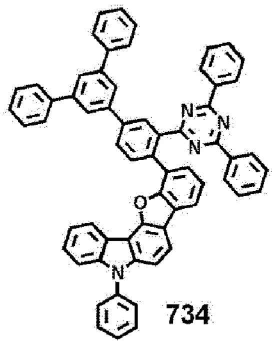

734

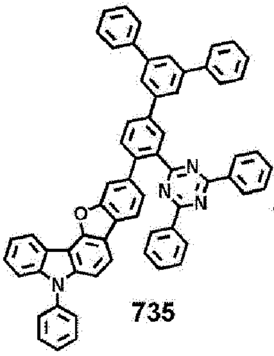

735

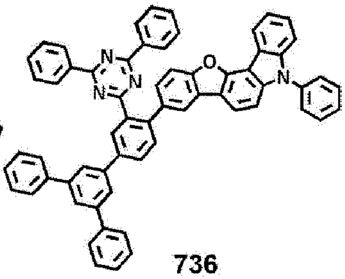

736

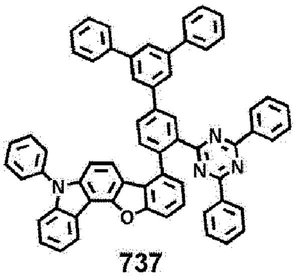

737

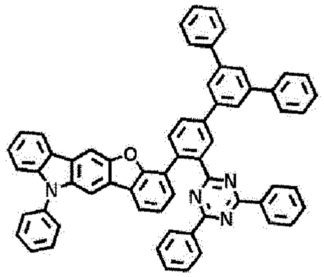

738

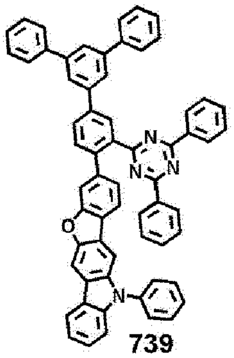

739

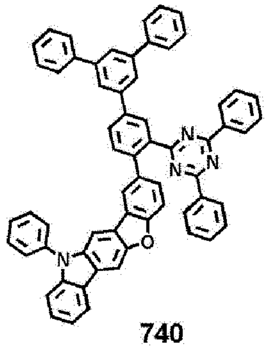

740

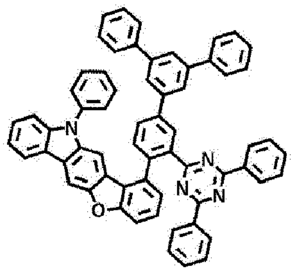

741

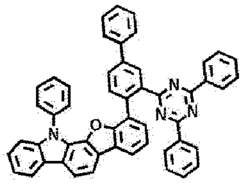
742

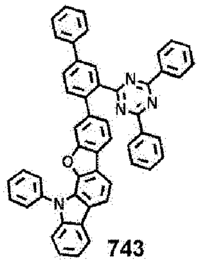
743

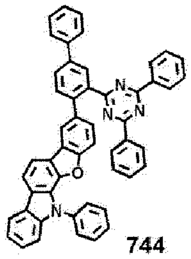
744

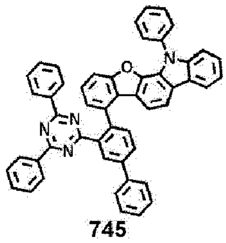
745

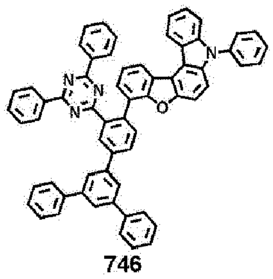
746

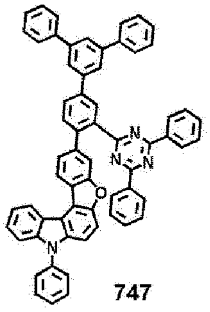
747

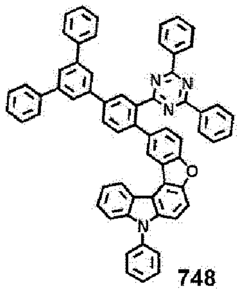
748

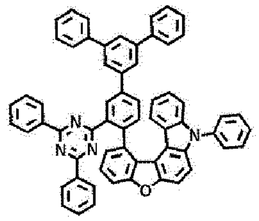
749

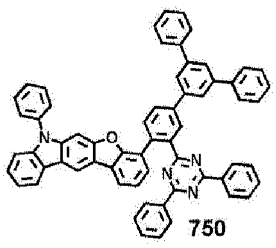
750

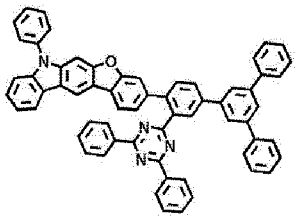
751

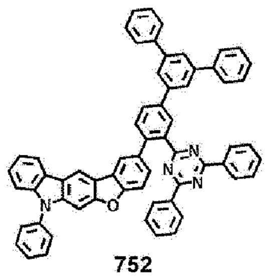
752

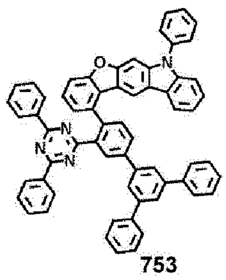
753

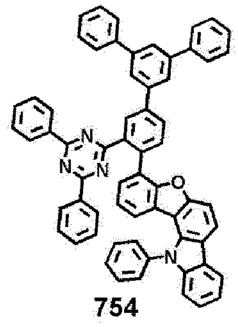
754

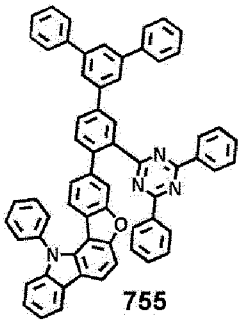
755

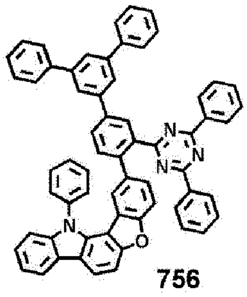
756

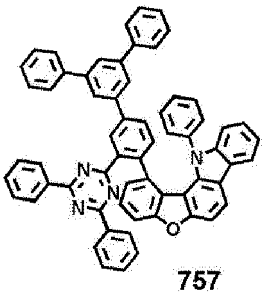
757

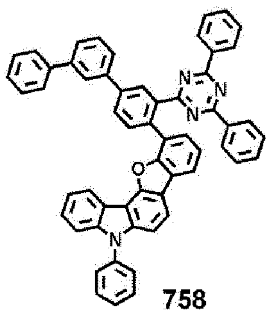
758

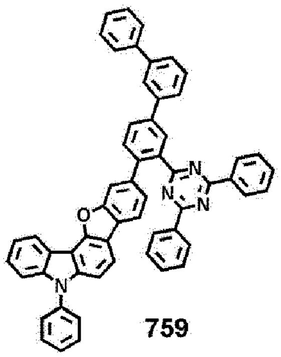
759

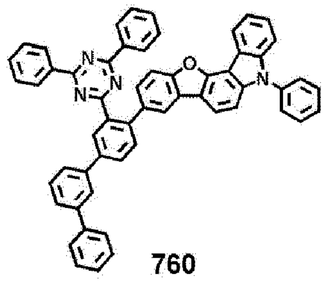
760

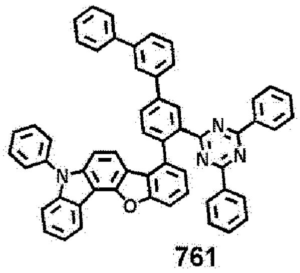
761

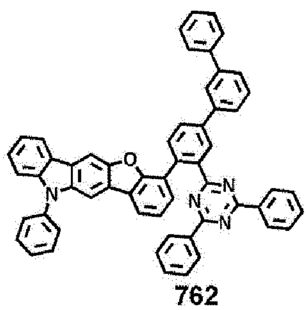
762

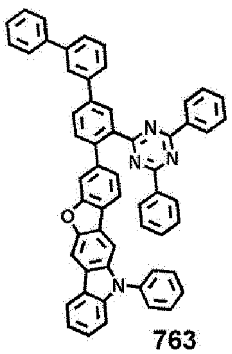
763

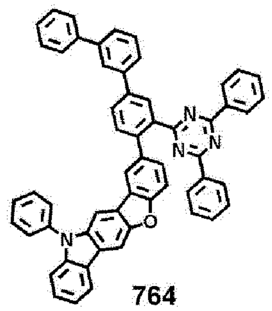
764

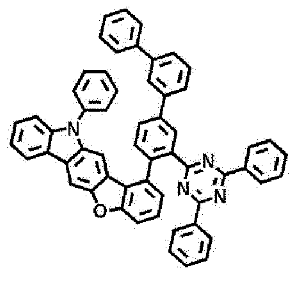
765

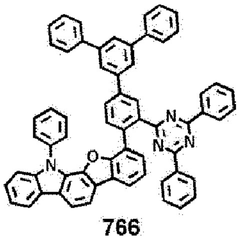
766

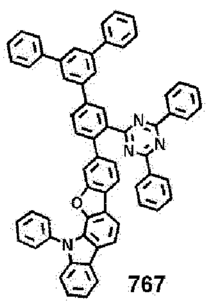
767

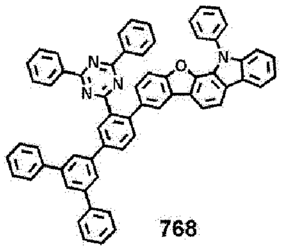
768

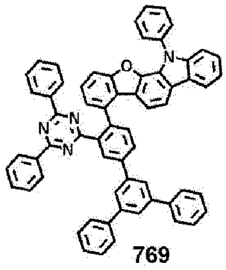
769

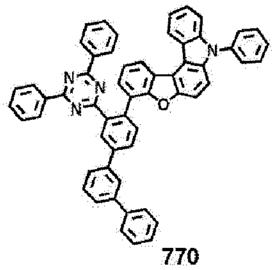
770

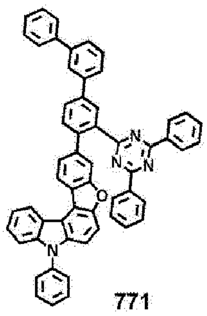
771

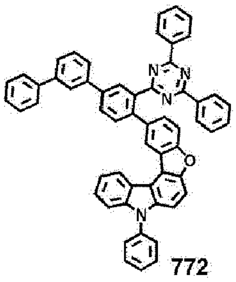
772

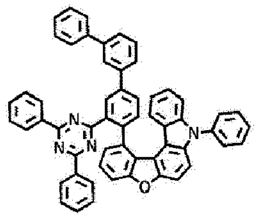
773

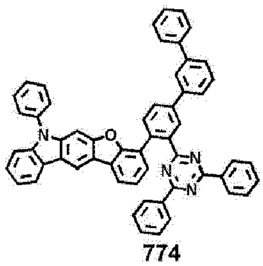
774

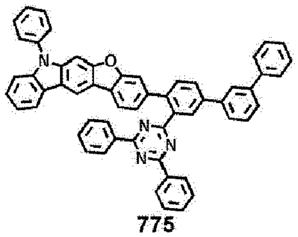
775

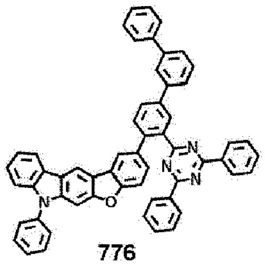
776

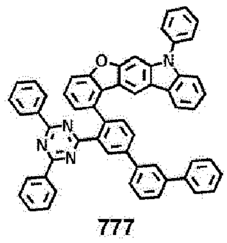
777

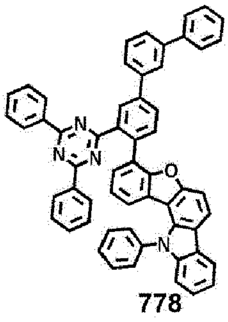
778

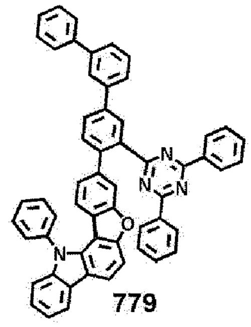
779

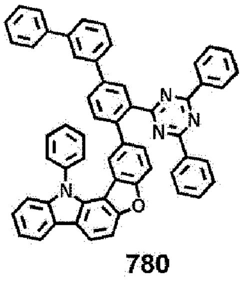
780

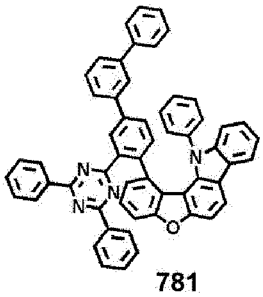
781

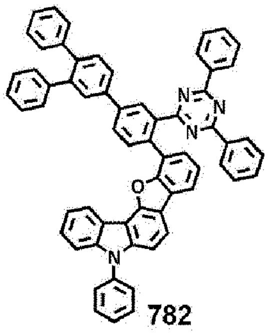
782

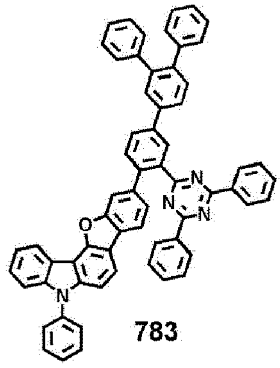
783

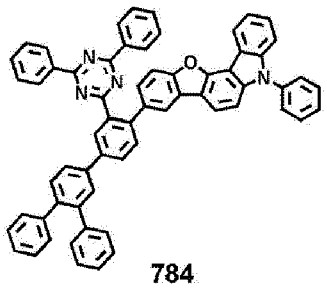
784

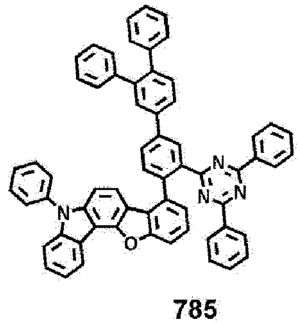
785

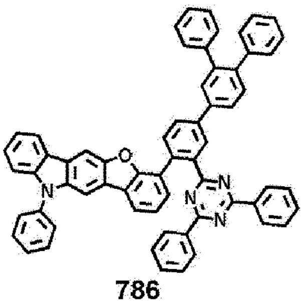
786

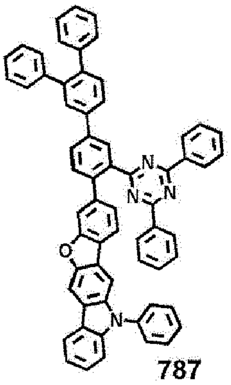
787

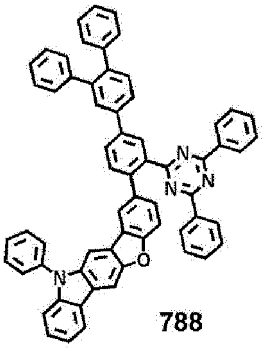
788

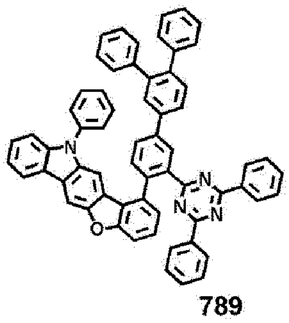
789

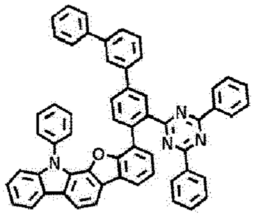

790

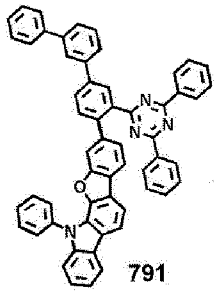

791

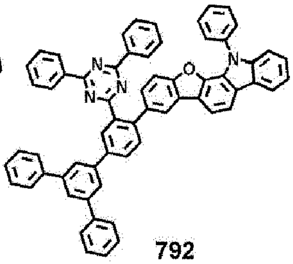

792

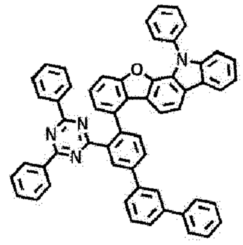

793

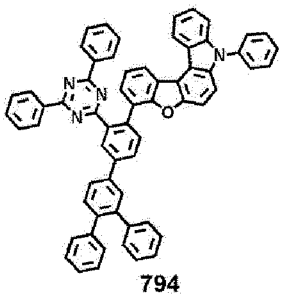

794

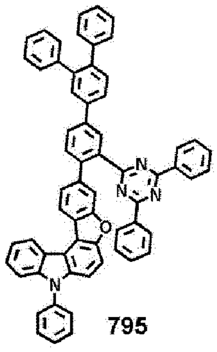

795

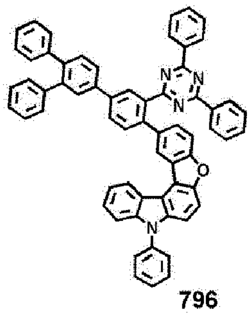

796

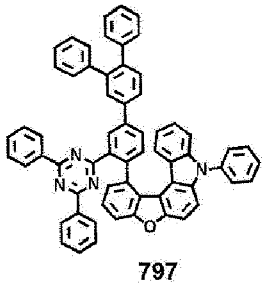

797

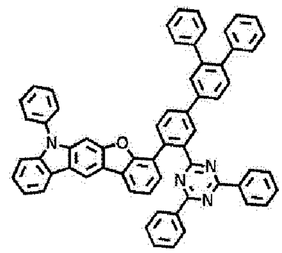

798

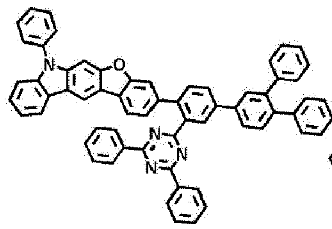

799

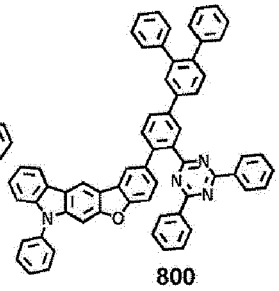

800

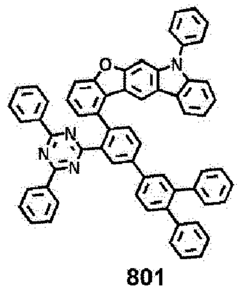

801

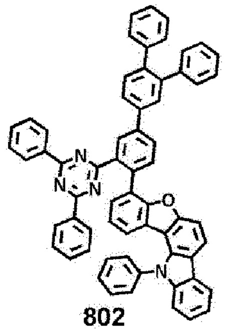
802

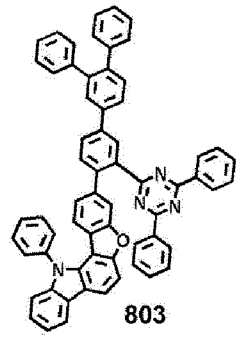
803

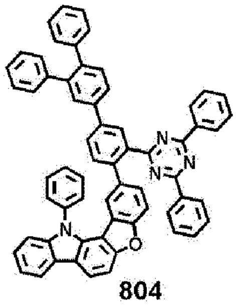
804

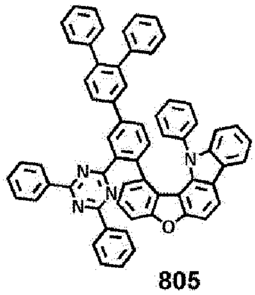
805

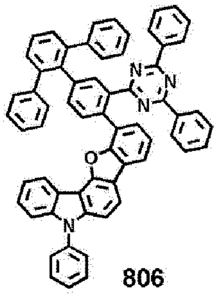
806

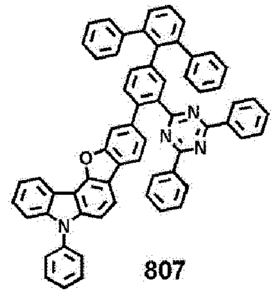
807

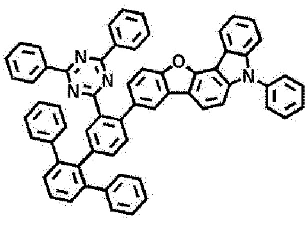
808

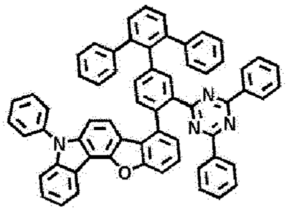
809

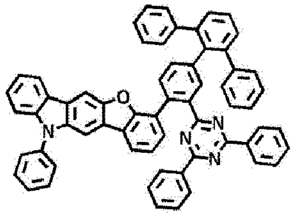
810

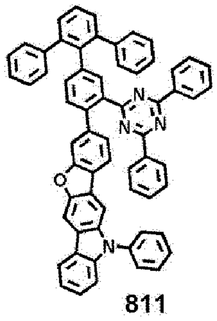
811

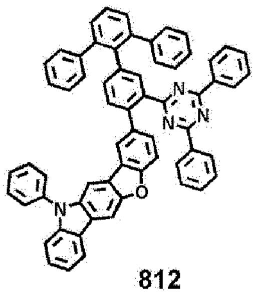
812

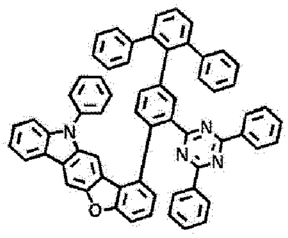
813

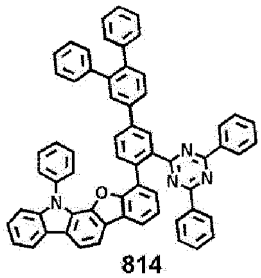
814

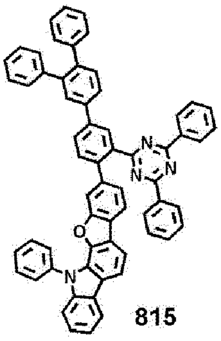
815

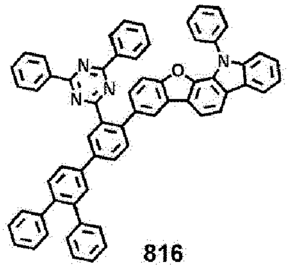
816

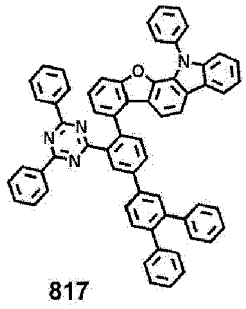
817

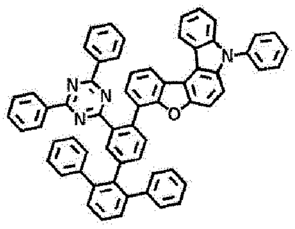
818

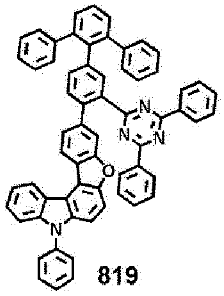
819

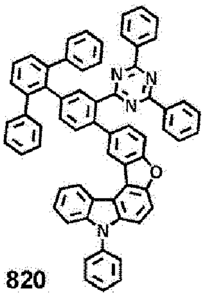
820

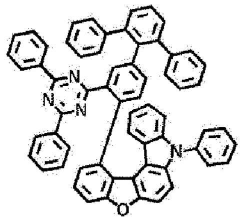
821

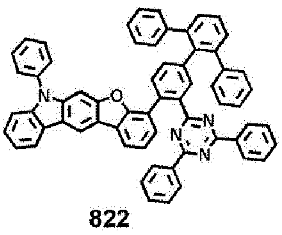
822

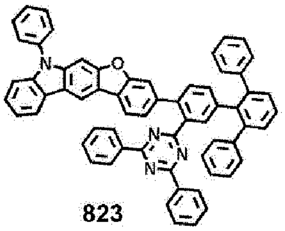
823

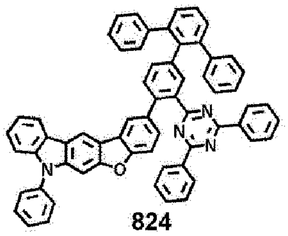
824

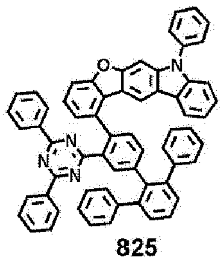
825

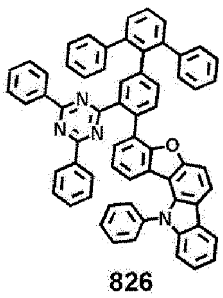

826

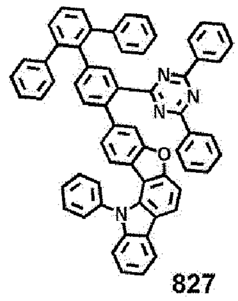

827

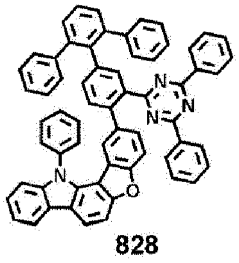

828

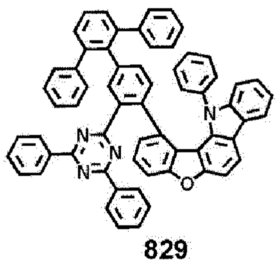

829

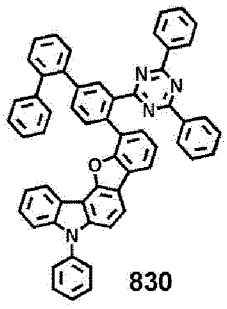

830

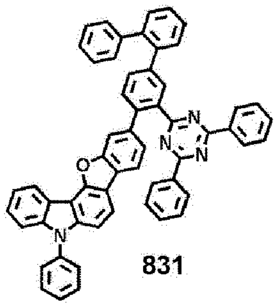

831

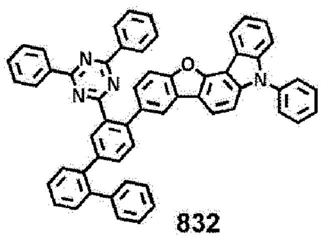

832

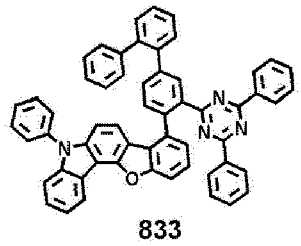

833

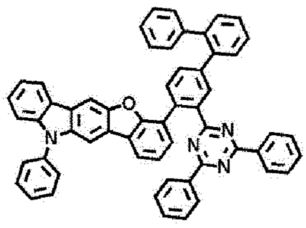

834

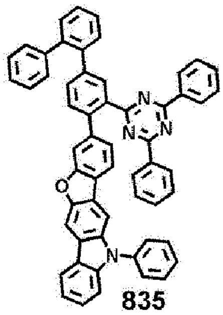

835

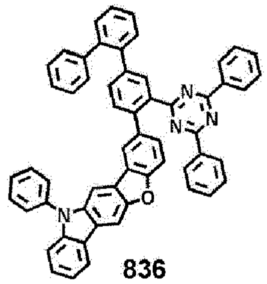

836

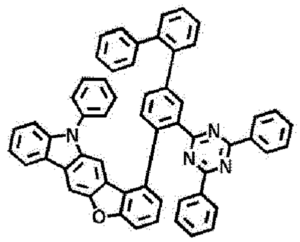

837

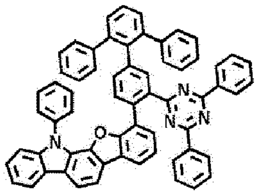
838

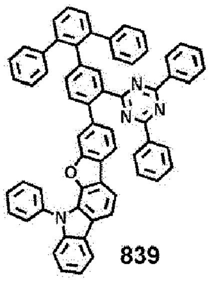
839

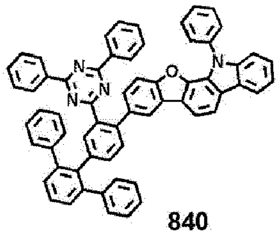
840

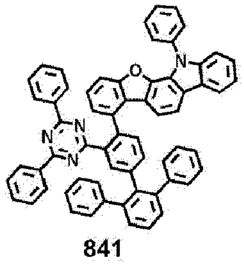
841

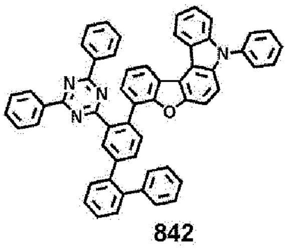
842

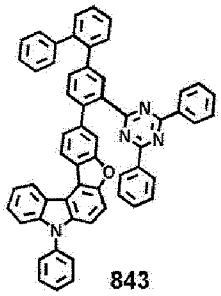
843

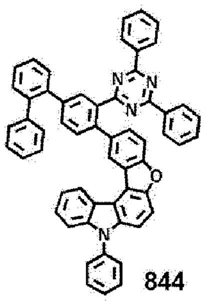
844

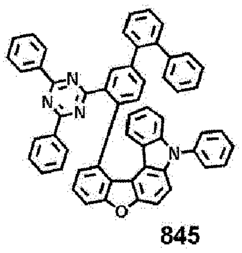
845

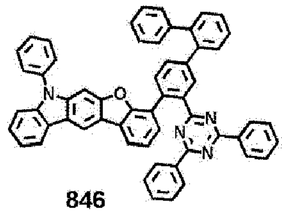
846

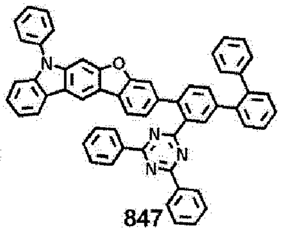
847

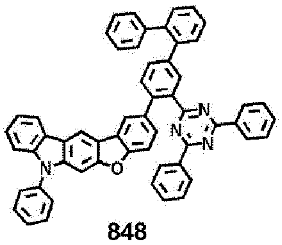
848

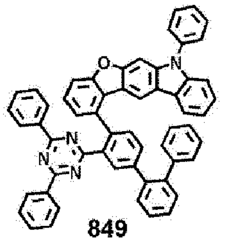
849

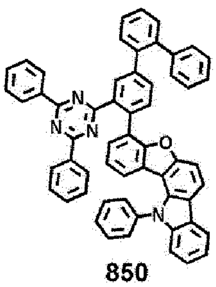
850

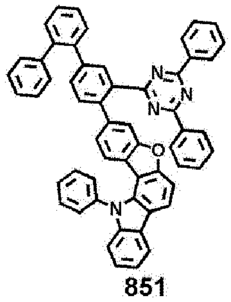
851

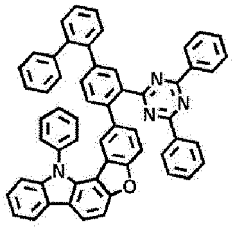
852

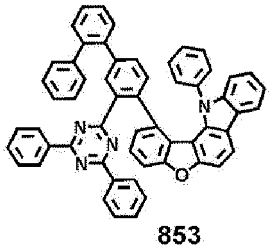
853

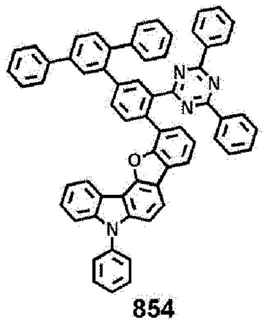
854

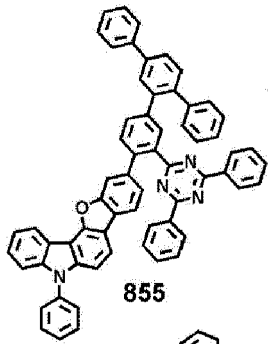
855

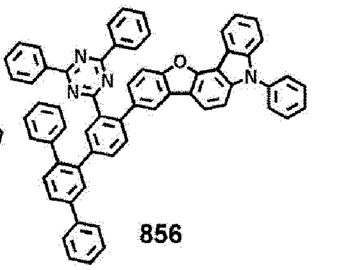
856

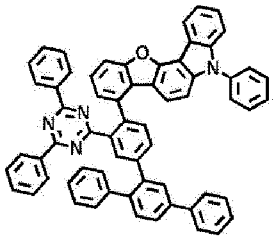
857

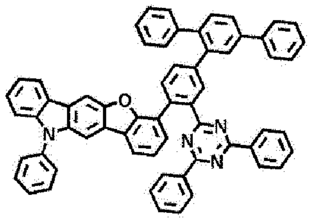
858

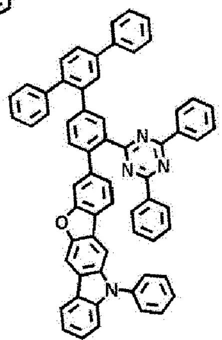
859

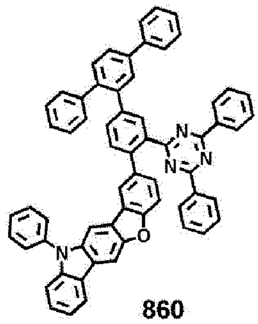
860

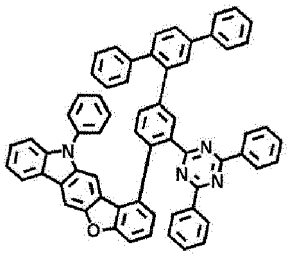
861

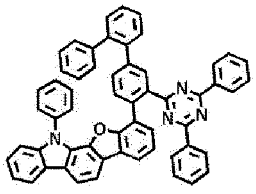

862

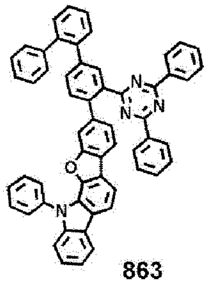

863

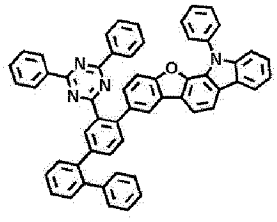

864

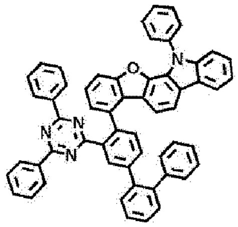

865

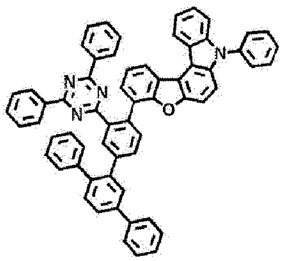

866

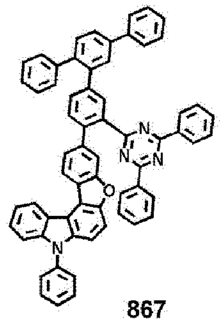

867

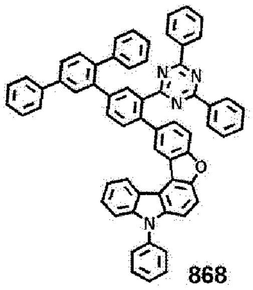

868

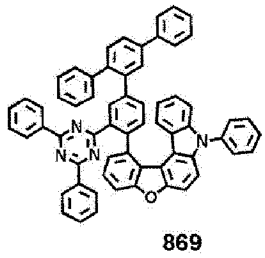

869

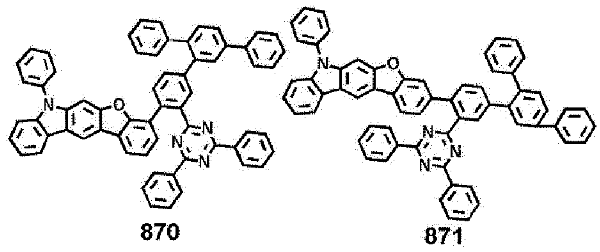

870

871

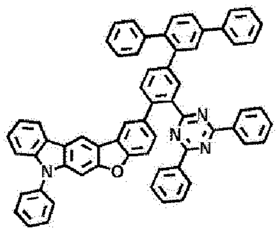

872

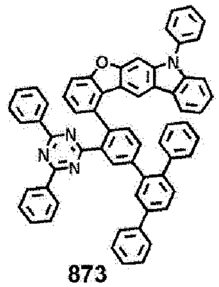

873

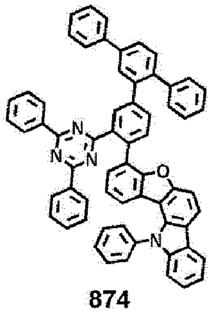

874

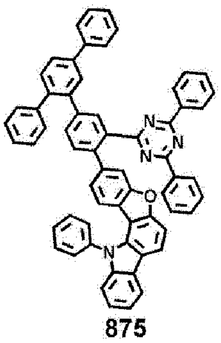

875

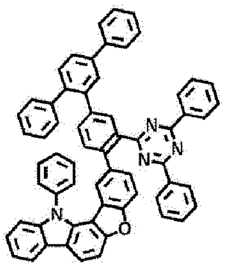

876

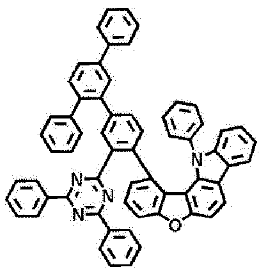

877

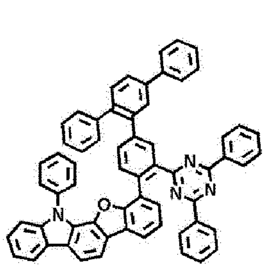

878

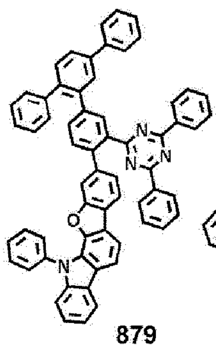

879

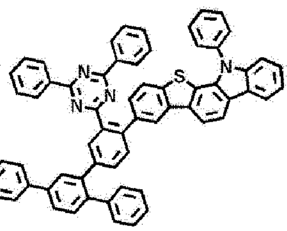

880

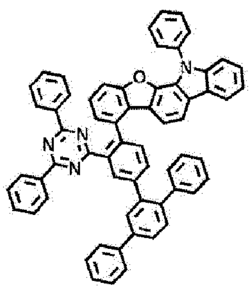

881

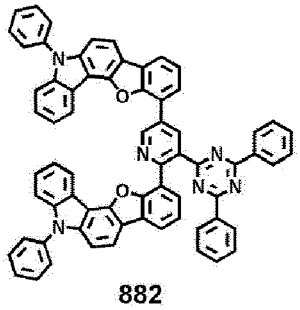

882

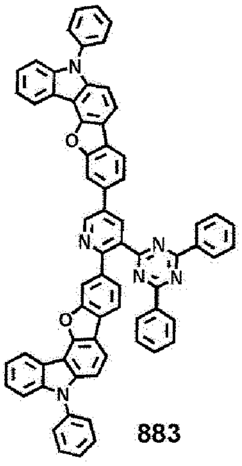

883

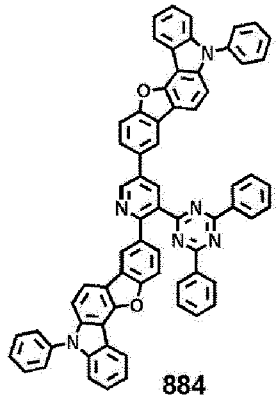

884

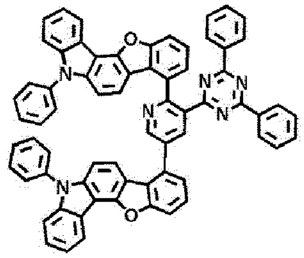

885

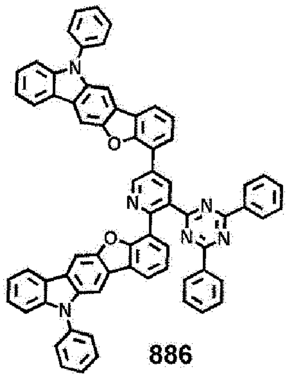

886

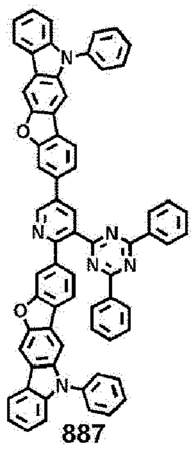

887

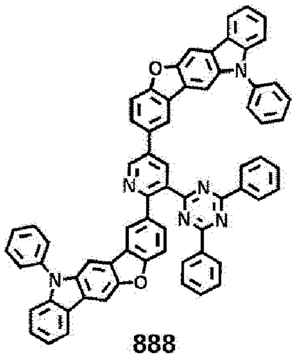

888

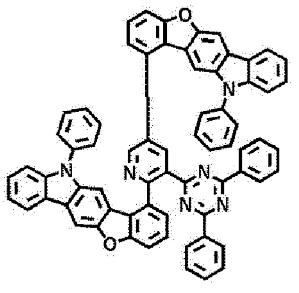

889

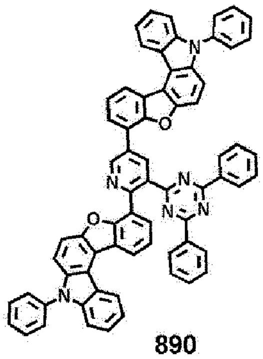
**890**

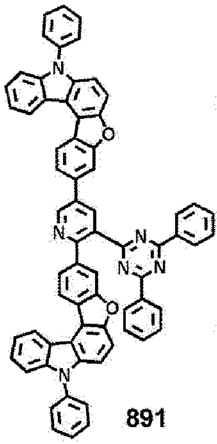
**891**

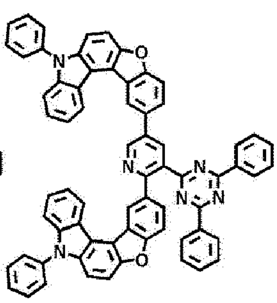
**892**

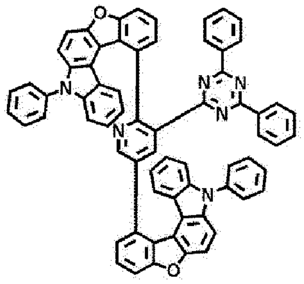
**893**

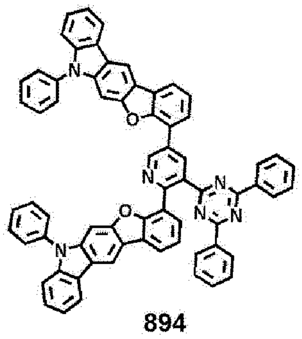
**894**

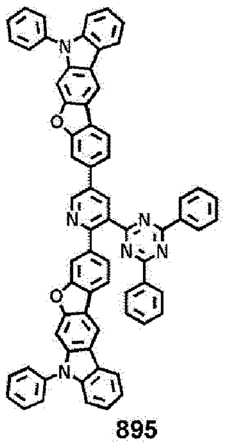
**895**

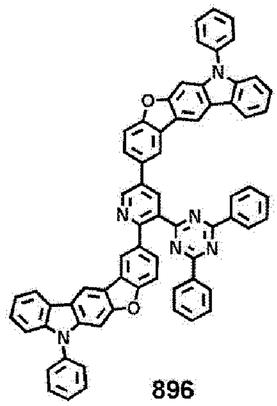
**896**

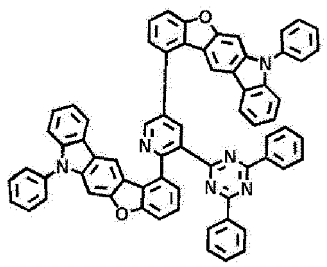
**897**

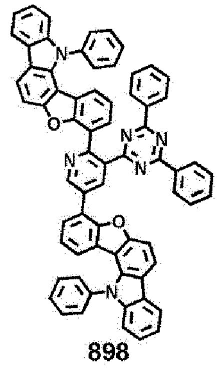
898

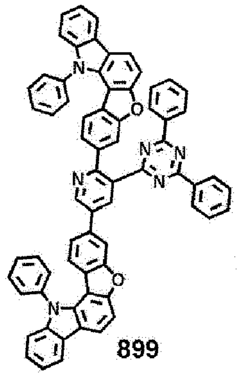
899

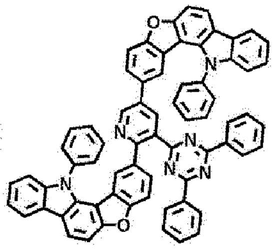
900

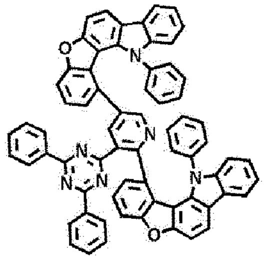
901

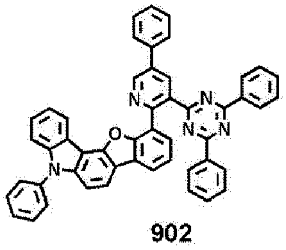
902

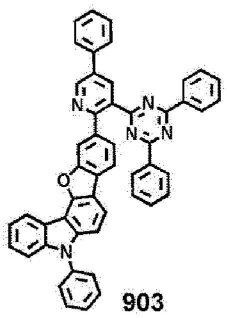
903

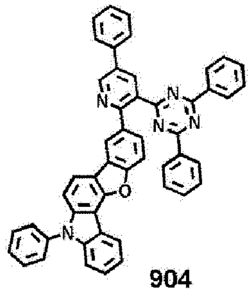
904

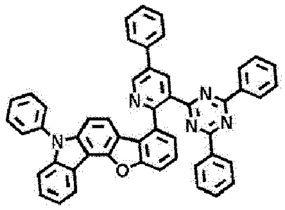
905

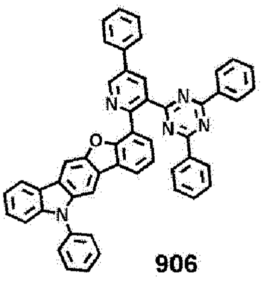
906

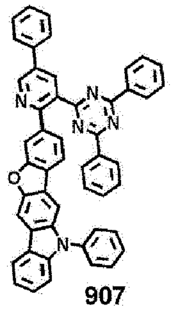
907

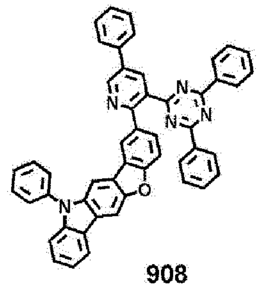
908

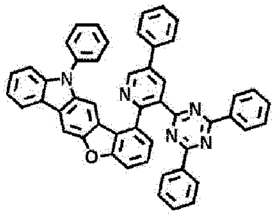
909

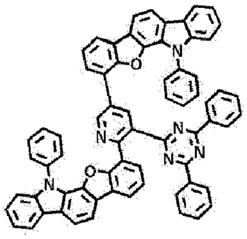

910

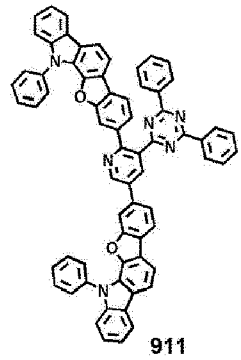

911

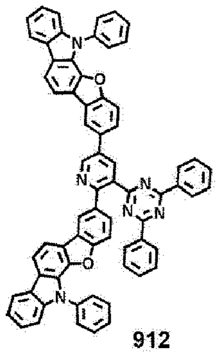

912

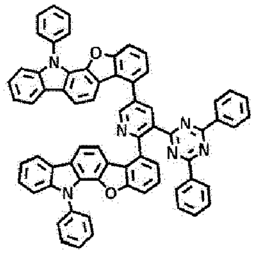

913

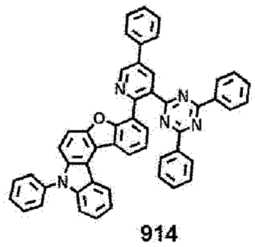

914

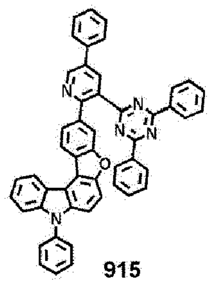

915

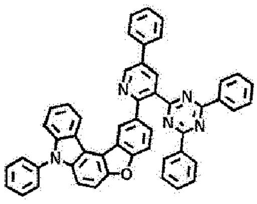

916

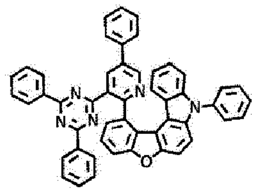

917

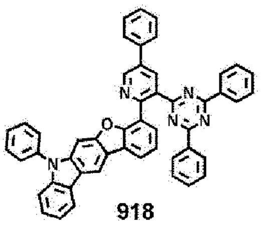

918

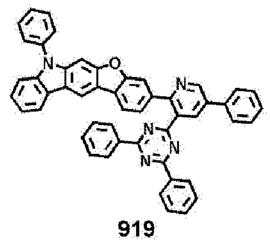

919

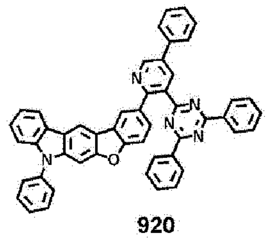

920

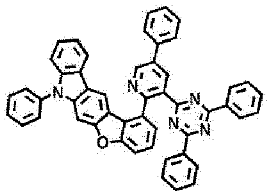

921

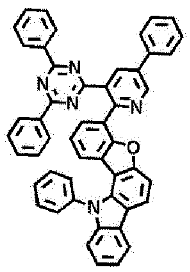
922

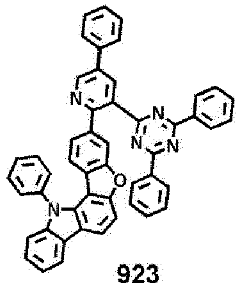
923

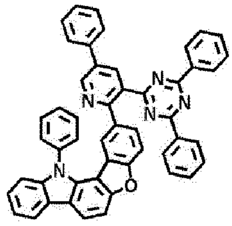
924

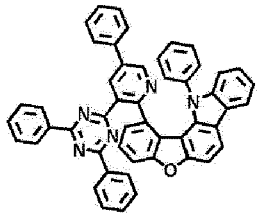
925

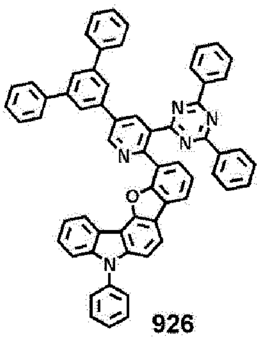
926

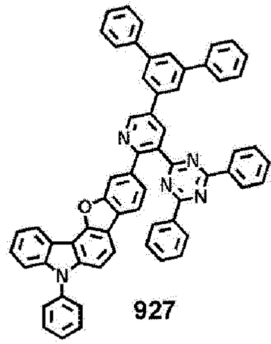
927

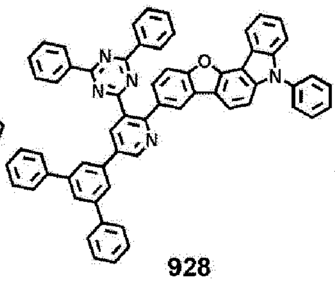
928

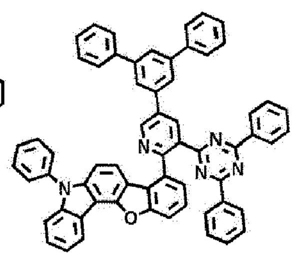
929

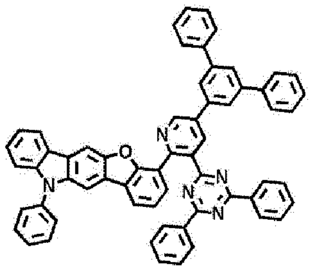
930

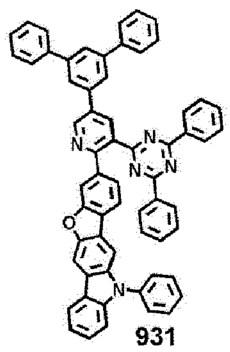
931

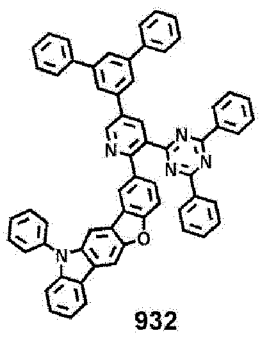
932

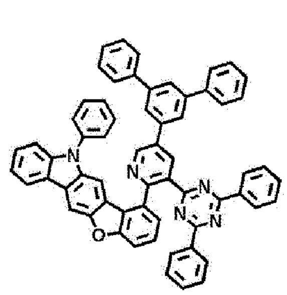
933

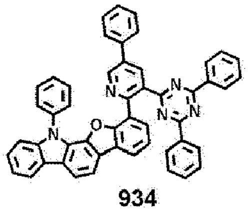

934

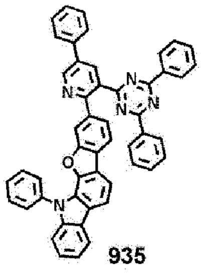

935

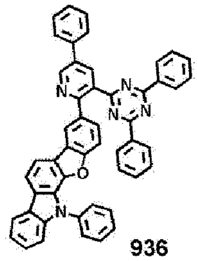

936

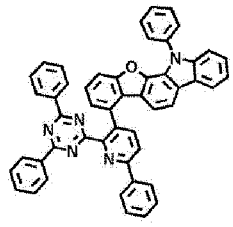

937

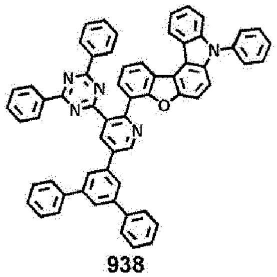

938

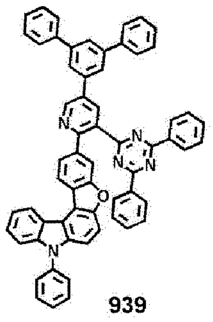

939

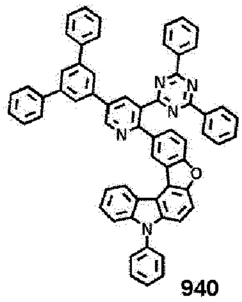

940

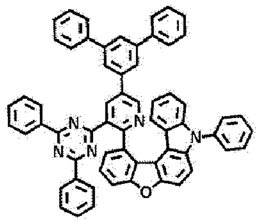

941

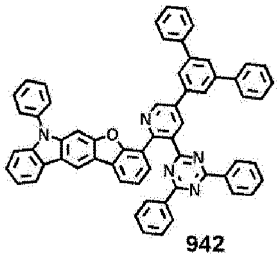

942

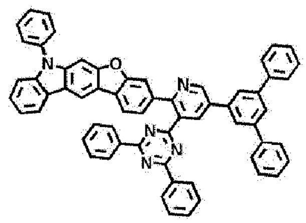

943

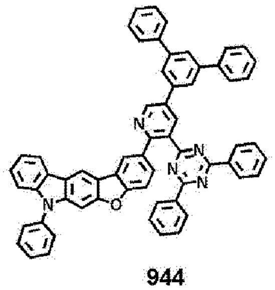

944

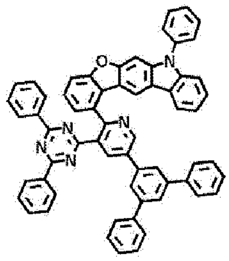

945

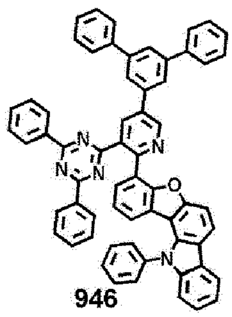
946

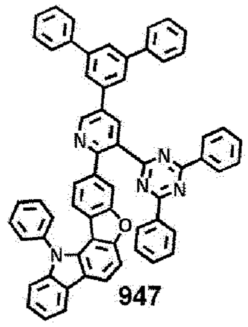
947

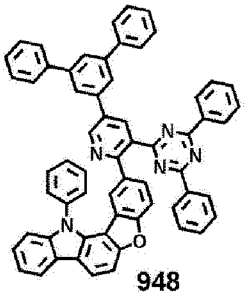
948

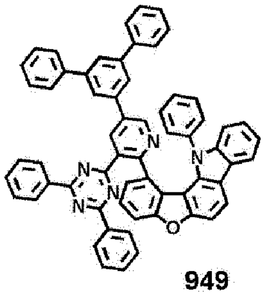
949

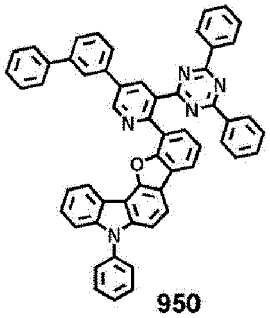
950

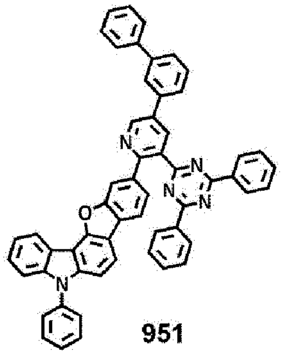
951

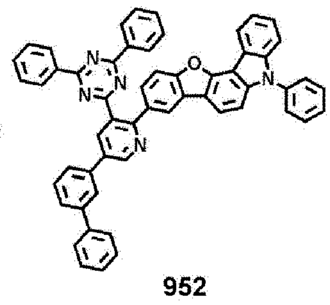
952

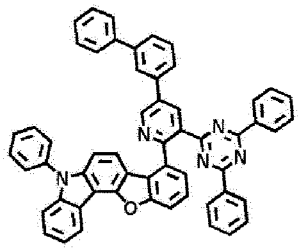
953

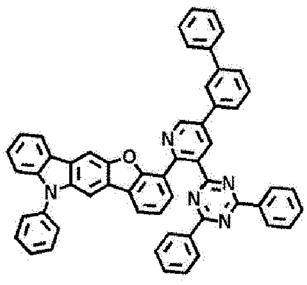
954

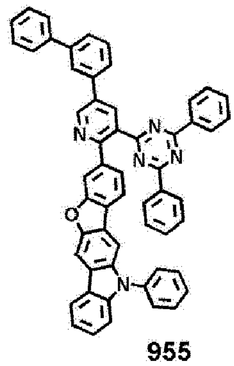
955

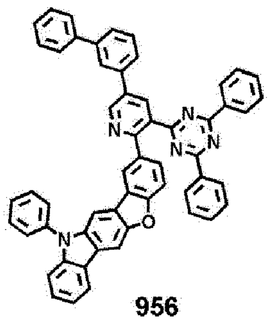
956

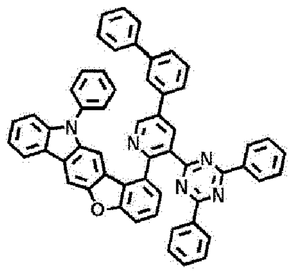
957

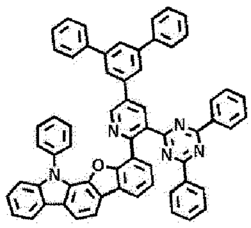
958

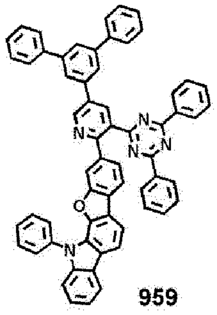
959

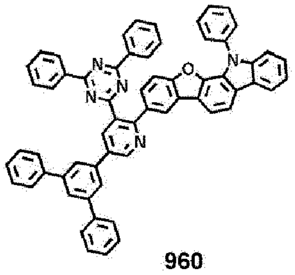
960

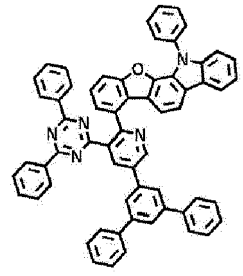
961

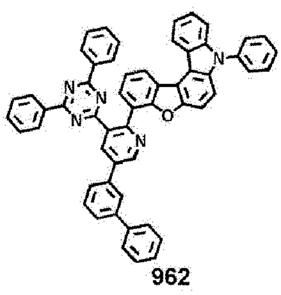
962

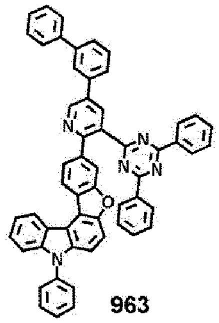
963

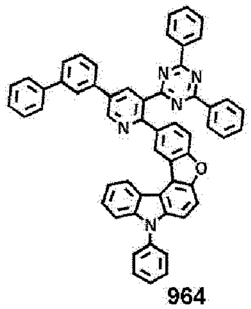
964

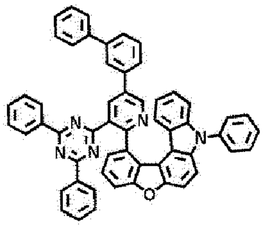
965

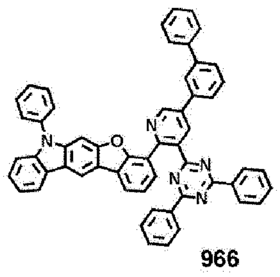
966

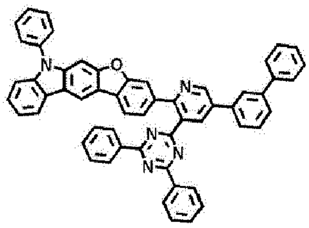
967

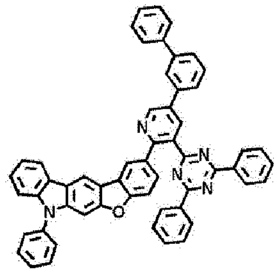
968

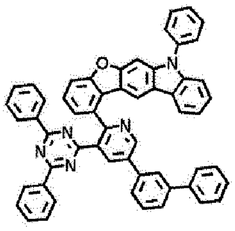
969

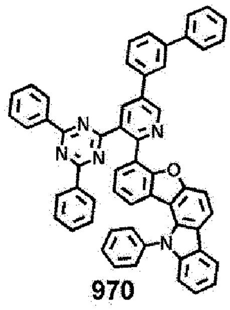
970

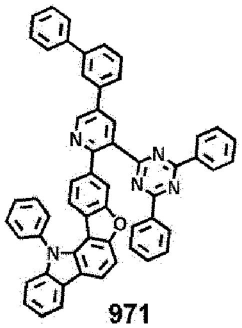
971

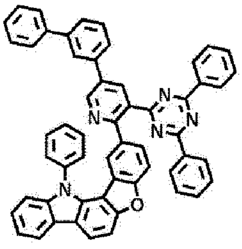
972

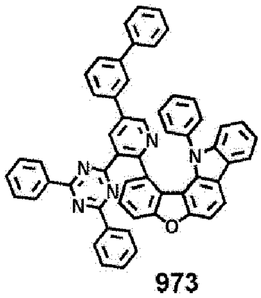
973

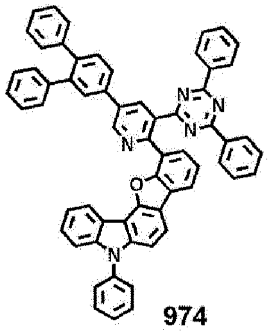
974

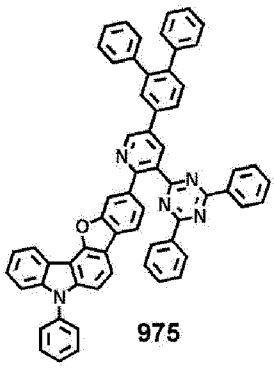
975

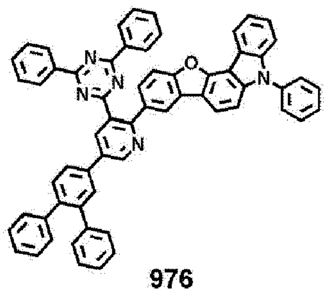
976

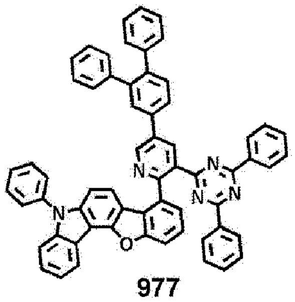
977

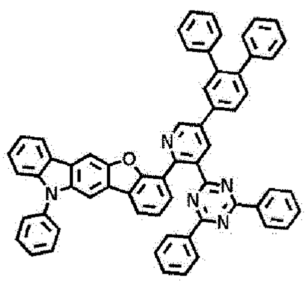
978

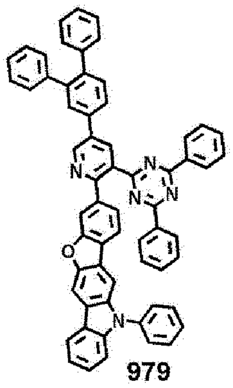
979

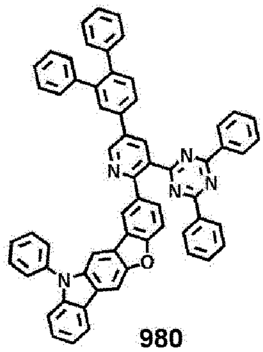
980

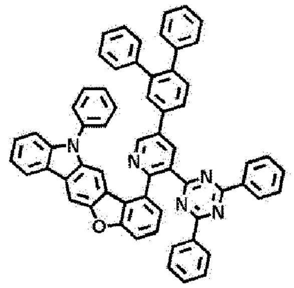
981

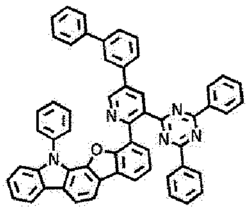

982

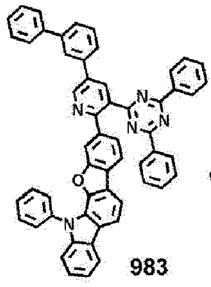

983

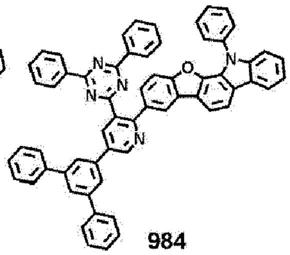

984

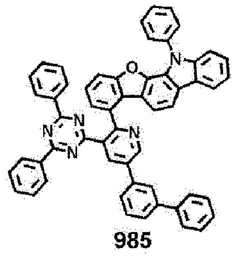

985

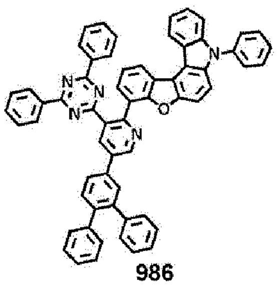

986

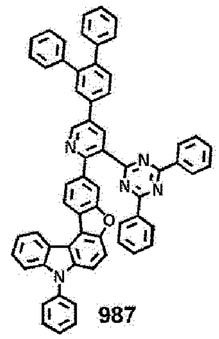

987

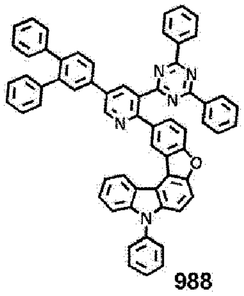

988

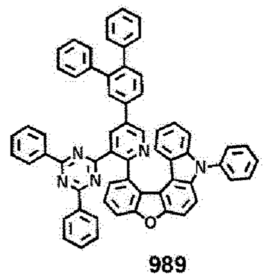

989

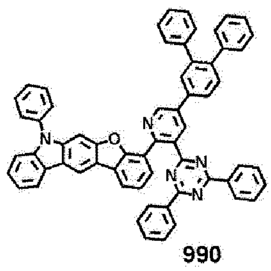

990

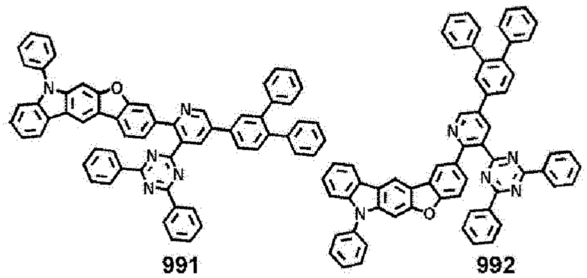

991

992

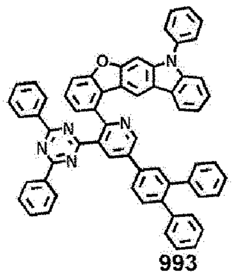

993

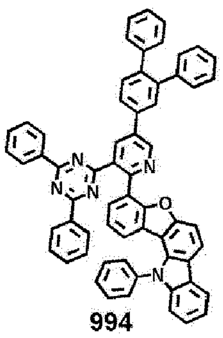

994

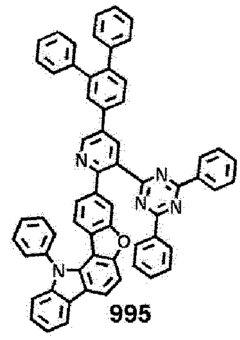

995

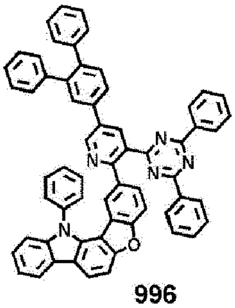

996

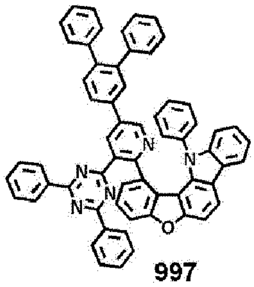

997

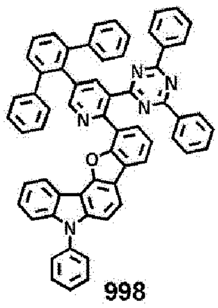

998

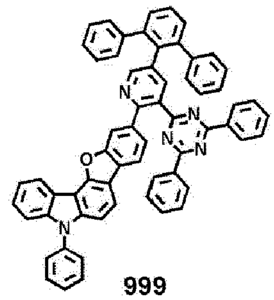

999

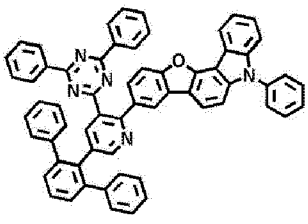

1000

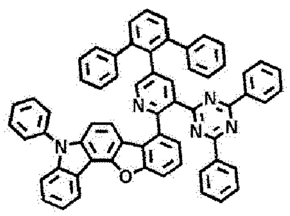

1001

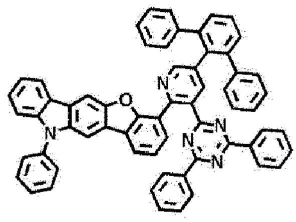

1002

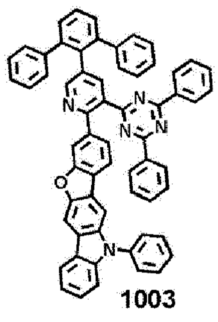

1003

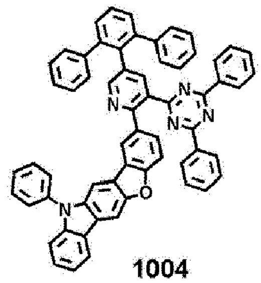

1004

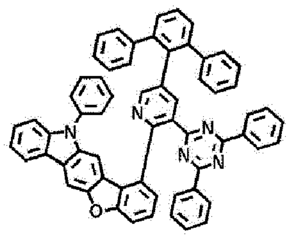

1005

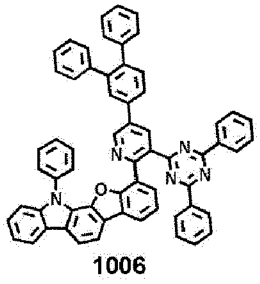
1006

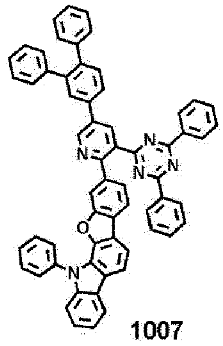
1007

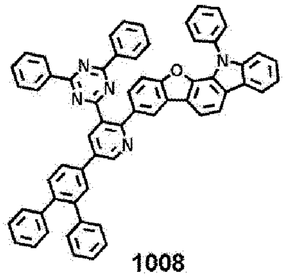
1008

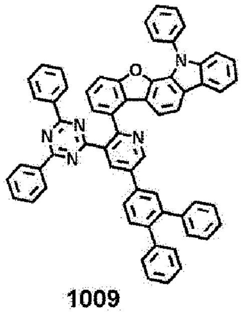
1009

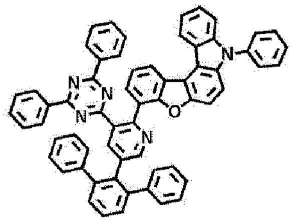
1010

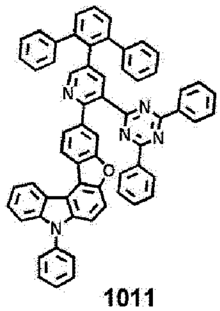
1011

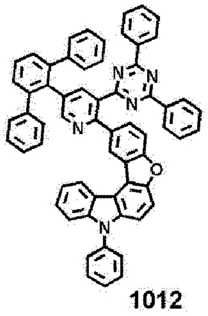
1012

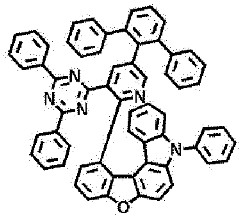
1013

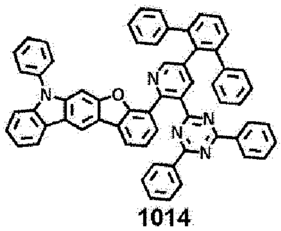
1014

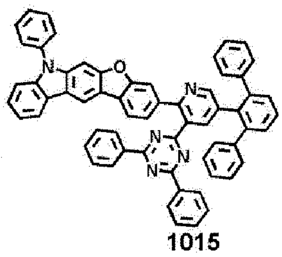
1015

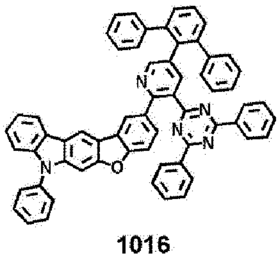
1016

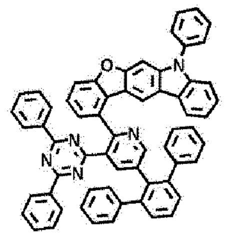
1017

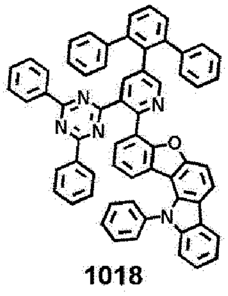
1018

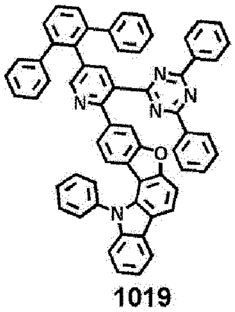
1019

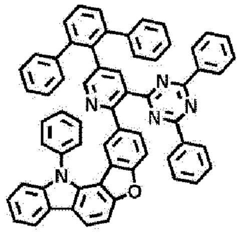
1020

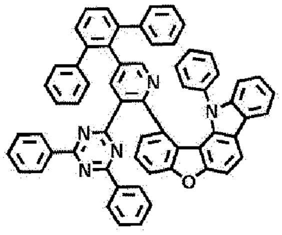
1021

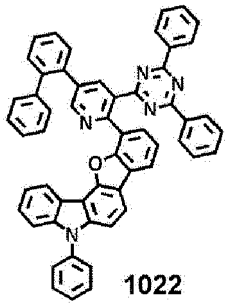
1022

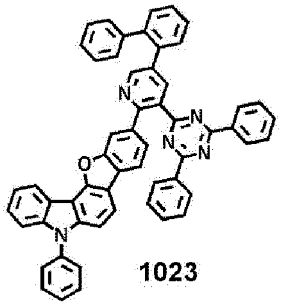
1023

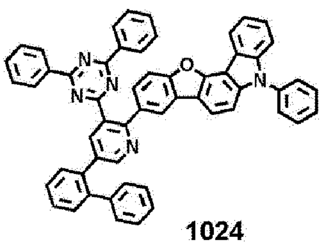
1024

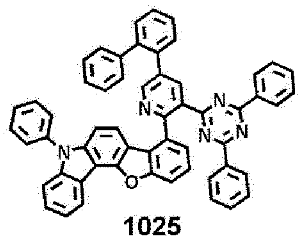
1025

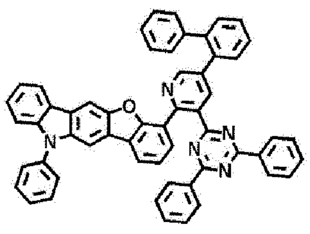
1026

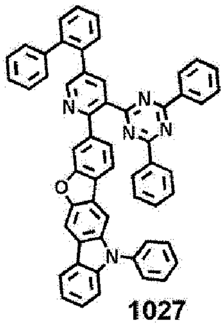
1027

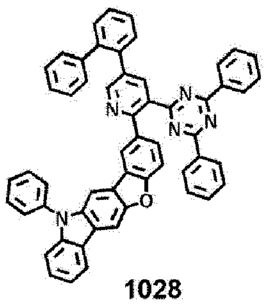
1028

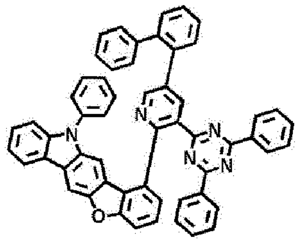
1029

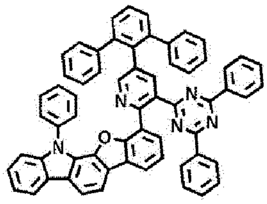

1030

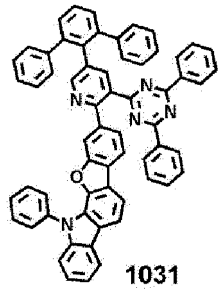

1031

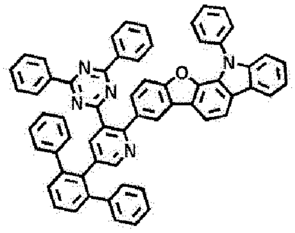

1032

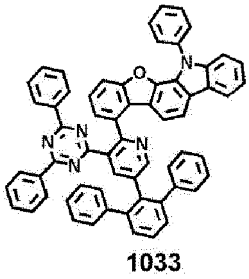

1033

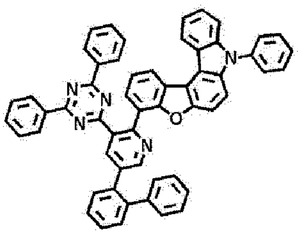

1034

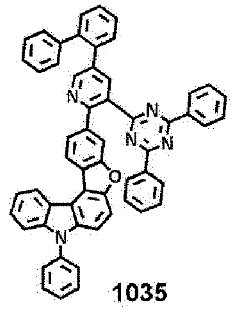

1035

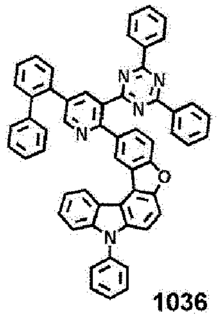

1036

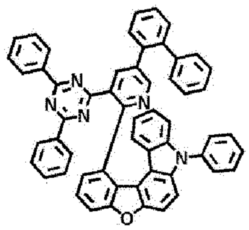

1037

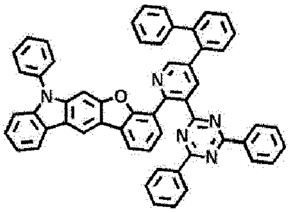

1038

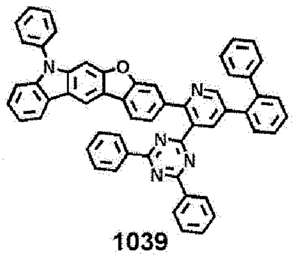

1039

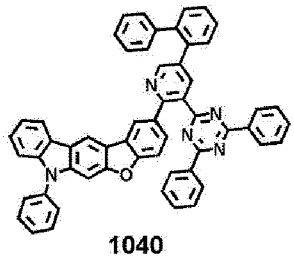

1040

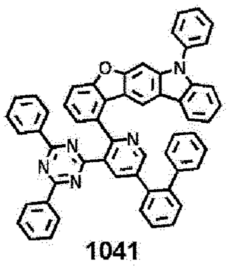

1041

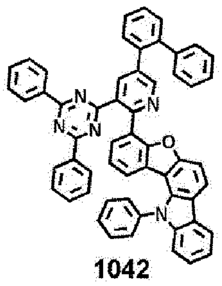
1042

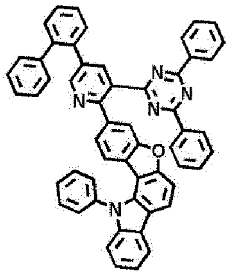
1043

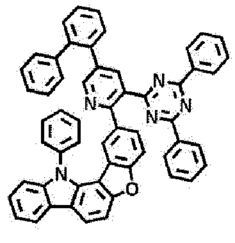
1044

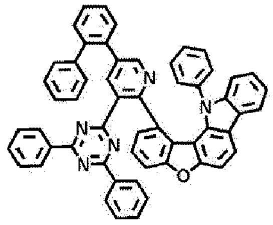
1045

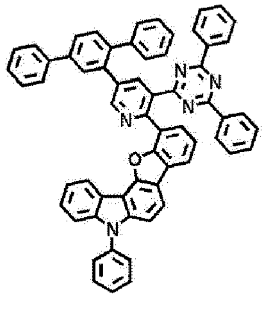
1046

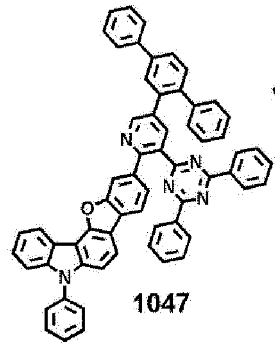
1047

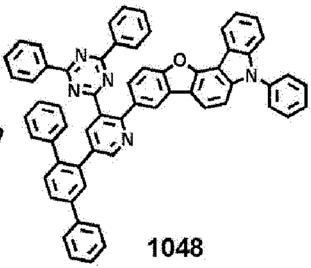
1048

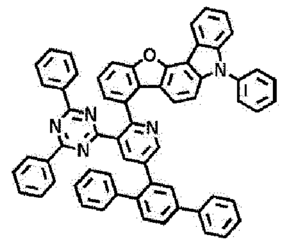
1049

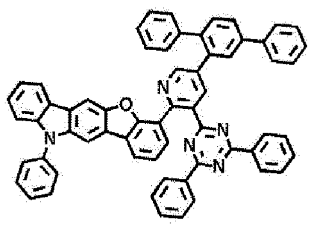
1050

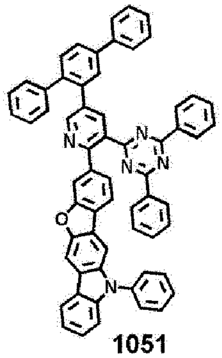
1051

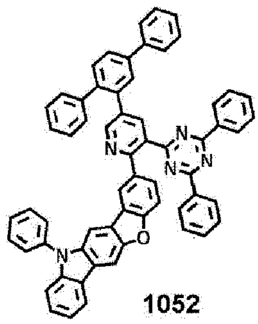
1052

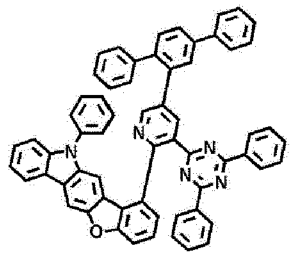
1053

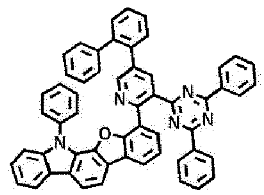

1054

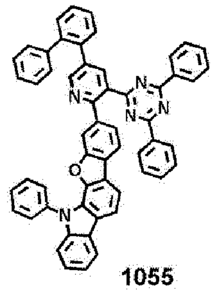

1055

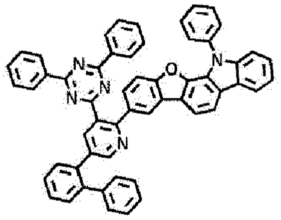

1056

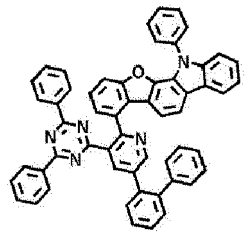

1057

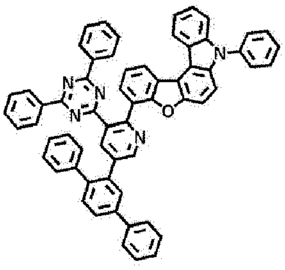

1058

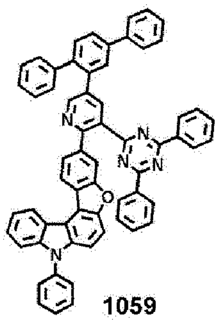

1059

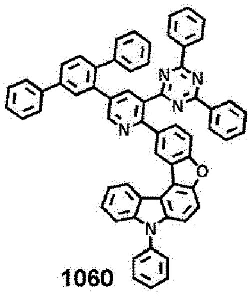

1060

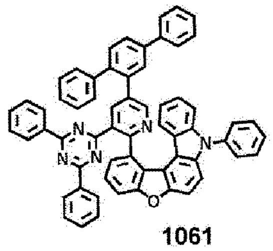

1061

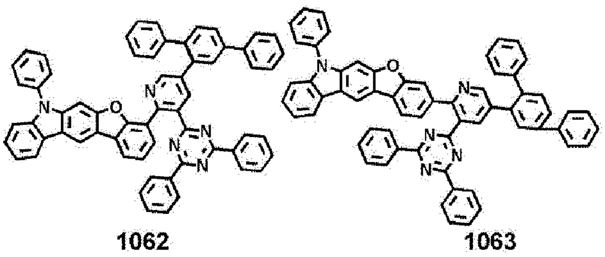

1062

1063

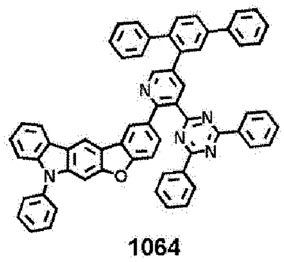

1064

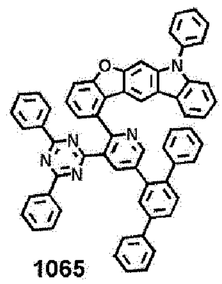

1065

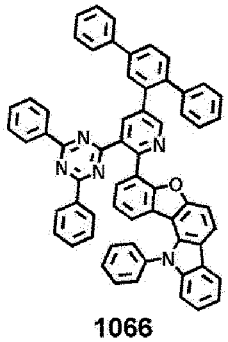

**1066**

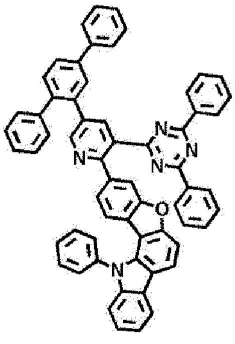

**1067**

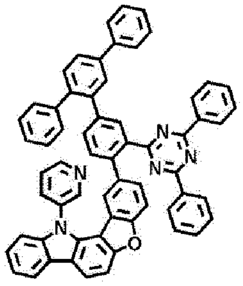

**1068**

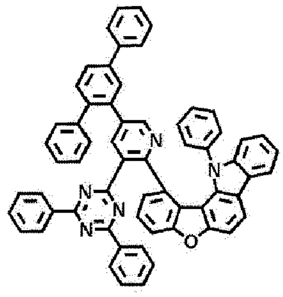

**1069**

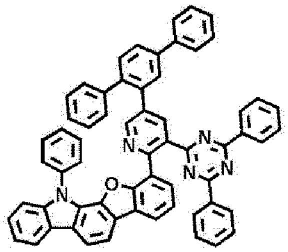

**1070**

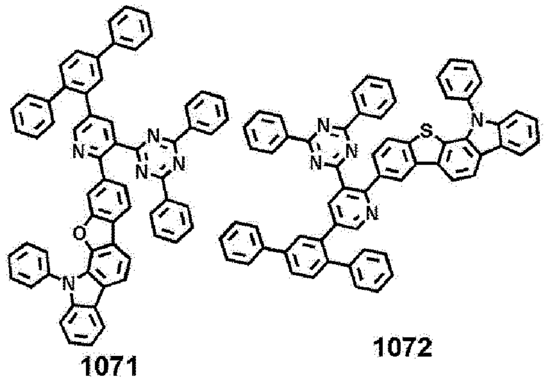

**1071**

**1072**

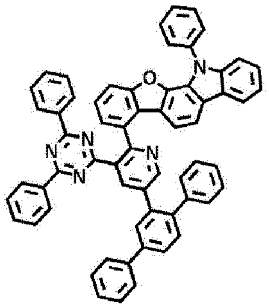

**1073**

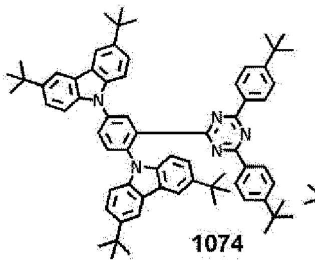

**1074**

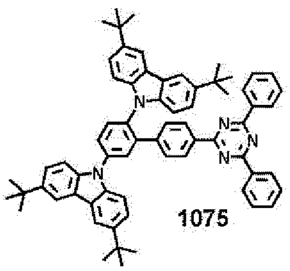

**1075**

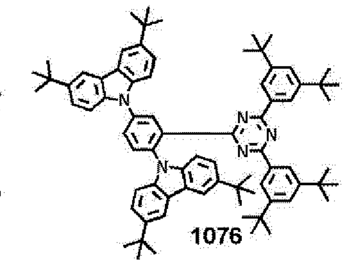

**1076**

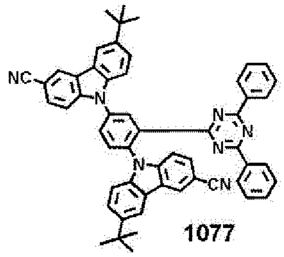

**1077**

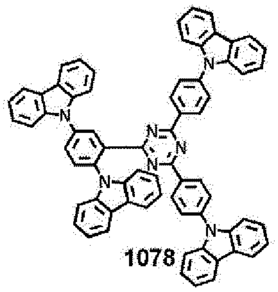

**1078**

Group XI

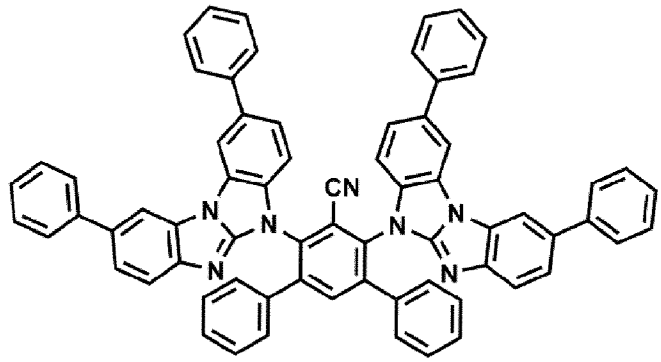

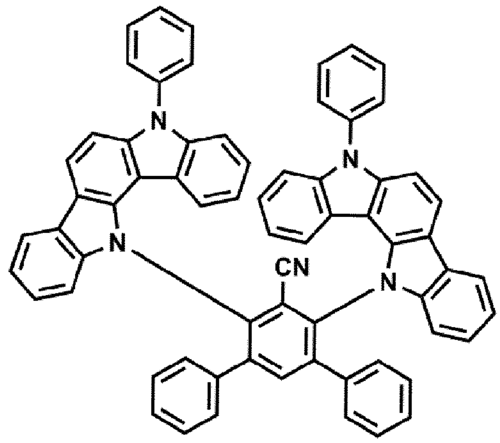

Electron transport region 17

Then, an electron transport region may be located on the emission layer.

The electron transport region 17 is placed between the emission layer 15 and the second electrode 19 of the organic light-emitting device 10.

The electron transport region 17 may have a single-layered structure or a multi-layered structure.

For example, the electron transport region 17 may have an electron transport layer, an electron transport layer/electron injection layer structure, a buffer layer/electron transport layer structure, hole blocking layer/electron transport layer structure, a buffer layer/electron transport layer/electron injection layer structure, or a hole blocking layer/electron transport layer/electron injection layer structure, but embodiments of the present disclosure are not limited thereto. The electron transport region 17 may further include an electron control layer.

The electron transport region 17 may include known electron transport materials.

The electron transport region (for example, a buffer layer, a hole blocking layer, an electron control layer, or an electron transport layer in the electron transport region) may include a metal-free compound containing at least one $\pi$ electron-deficient nitrogen-containing $C_1$-$C_{60}$ cyclic group. The $\pi$ electron-deficient nitrogen-containing $C_1$-$C_{60}$ cyclic group is the same as described above.

In one or more embodiments, the electron transport region may include a compound represented by Formula 601 below:

Formula 601 $[Ar_{601}]_{xe11}$-$[(L_{601})_{xe1}$-$R_{601}]_{xe21}$

wherein, in Formula 601,

$Ar_{601}$ and $L_{601}$ may each independently be a $C_5$-$C_{60}$ carbocyclic group unsubstituted or substituted with at least one $R_{601a}$ or a $C_1$-$C_{60}$ heterocyclic group unsubstituted or substituted with at least one $R_{601a}$,
xe11 may be 1, 2, or 3,
xe1 may be an integer from 0 to 5,
$R_{601a}$ and $R_{601}$ may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-Si(Q_{601})(Q_{602})(Q_{603})$, $-C(=O)(Q_{601})$, $-S(=O)_2(Q_{601})$, or $-P(=O)(Q_{601})(Q_{602})$,
Q601 to Q603 may each independently be a $C_1$-$C_{10}$ alkyl group, a $C_1$-$C_{10}$ alkoxy group, a phenyl group, a biphenyl group, a terphenyl group, or a naphthyl group, and xe21 may be an integer from 1 to 5.

In one or more embodiments, at least one of $Ar_{601}$(s) in the number of xe11 and $R_{601}$(s) in the number of xe21 may include the $\pi$ electron-deficient nitrogen-containing $C_1$-$C_{60}$ cyclic group.

In one or more embodiments, $Ar_{601}$ and $L_{601}$ in Formula 601 may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one of deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, $-Si(Q_{31})(Q_{32})(Q_{33})$, $-S(=O)_2(Q_{31})$, or $-P(=O)(Q_{31})(Q_{32})$, and

$Q_{31}$ to $Q_{33}$ may each independently be a $C_1$-$C_{10}$ alkyl group, a $C_1$-$C_{10}$ alkoxy group, a phenyl group, a biphenyl group, a terphenyl group, or a naphthyl group.

When xe11 in Formula 601 is 2 or more, two or more $Ar_{601}$(s) may be linked to each other via a single bond.

In one or more embodiments, $Ar_{601}$ in Formula 601 may be an anthracene group.

In one or more embodiments, the compound represented by Formula 601 may be represented by Formula 601-1:

Formula 601-1

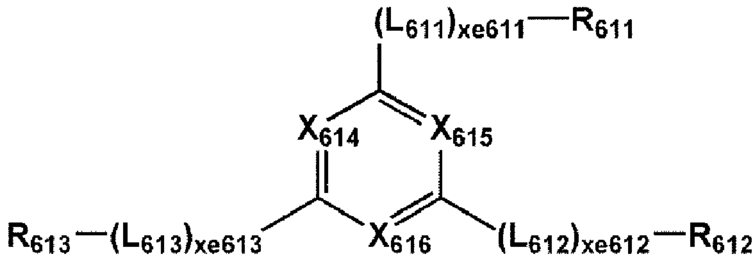

In Formula 601-1,

$X_{614}$ may be N or $C(R_{614})$, $X_{615}$ may be N or $C(R_{615})$, $X_{616}$ may be N or $C(R_{616})$, at least one of $X_{614}$ to $X_{616}$ may be N,
$L_{611}$ to $L_{613}$ may each independently be the same as described in connection with $L_{601}$,
xe611 to xe613 may each independently be the same as described in connection with xe1,
$R_{611}$ to $R_{613}$ may each independently be the same as described in connection with $R_{601}$, and
$R_{614}$ to $R_{616}$ may each independently be hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, or a naphthyl group.

In one or more embodiments, xe1 and xe611 to xe613 in Formulae 601 and 601-1 may each independently be 0, 1, or 2.

In one or more embodiments, $R_{601}$ and $R_{611}$ to $R_{613}$ in Formulae 601 and 601-1 may each independently be a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, or an azacarbazolyl group, each unsubstituted or sub-

stituted with deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, or an azacarbazolyl group; or

$$-S(=O)_2(Q_{601}),$$

or

$$-P(=O)(Q_{601})(Q_{602}),$$

wherein $Q_{601}$ and $Q_{602}$ are the same as described above.

The electron transport region may include at least one of Compounds ET1 to ET36, but embodiments of the present disclosure are not limited thereto:

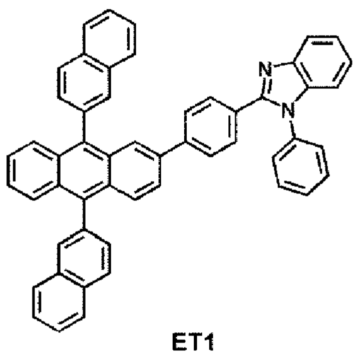

ET1

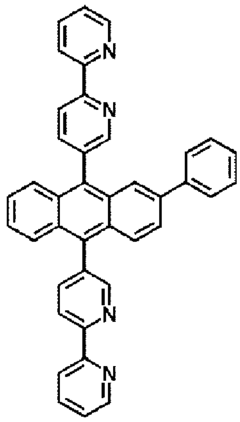

ET2

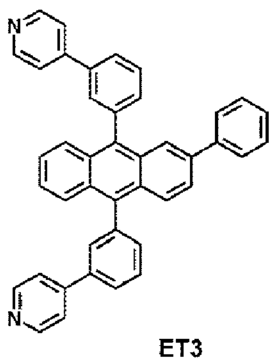

ET3

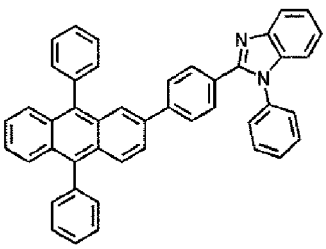

ET4

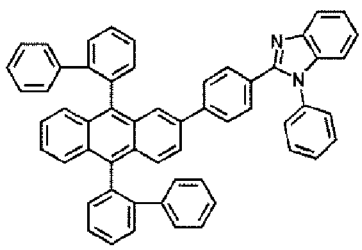

ET5

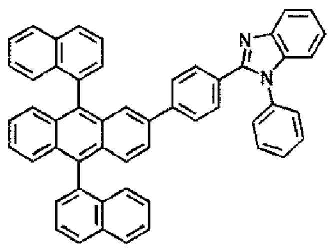

ET6

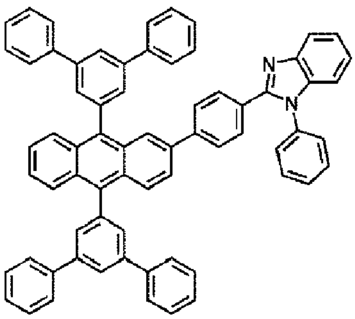

ET7

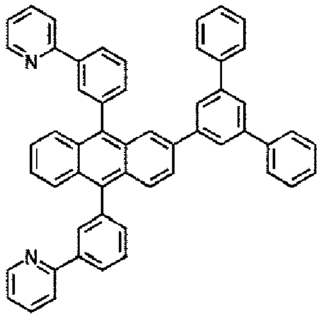

ET8

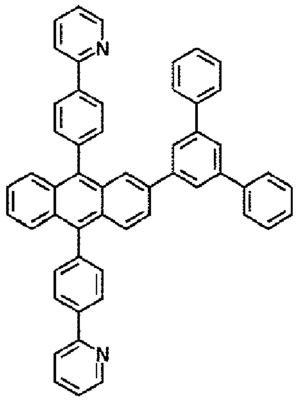

ET9

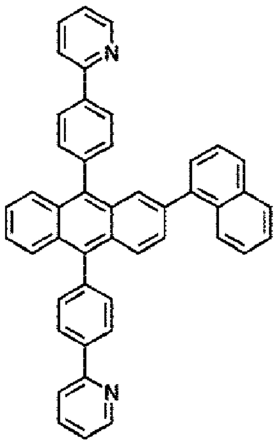

ET10

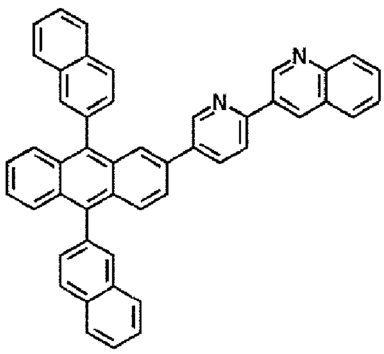

ET11

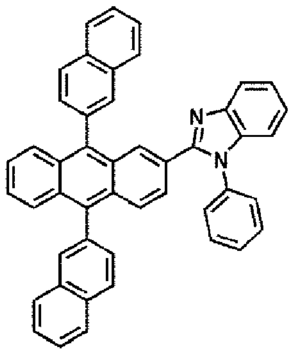

ET12

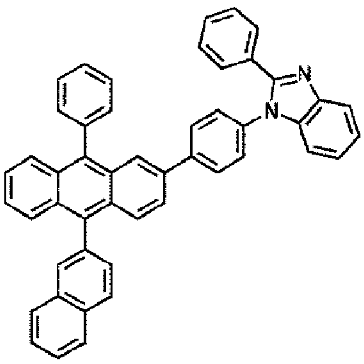

ET13

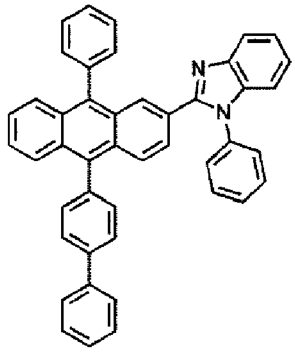

ET14

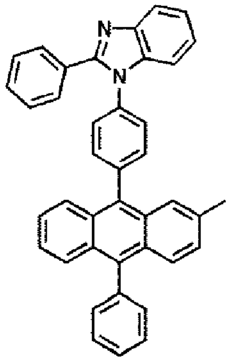

ET15

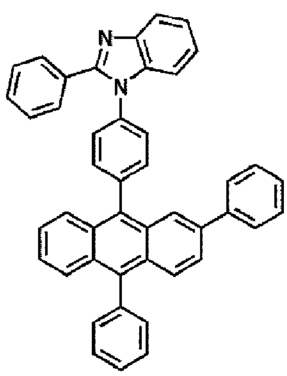

ET16

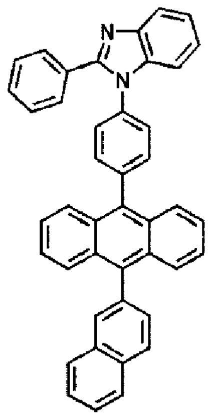

ET17

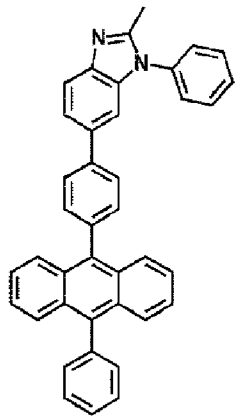

ET18

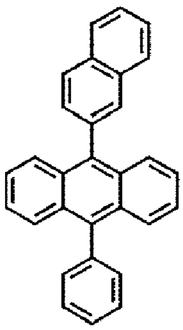

ET19

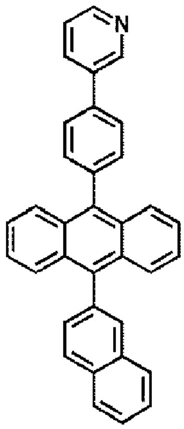

ET20

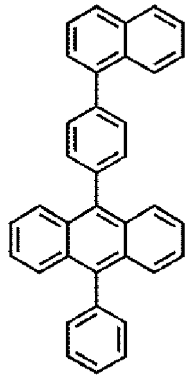

ET21

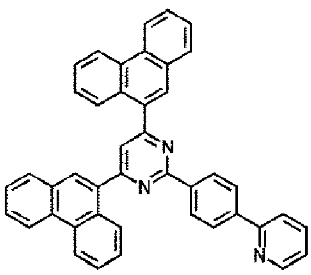

ET22

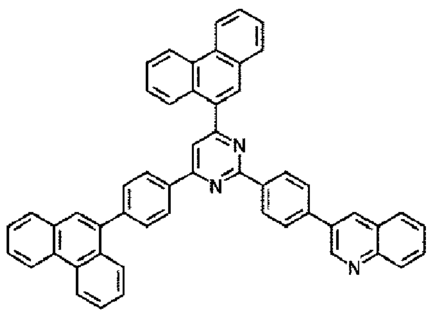

ET23

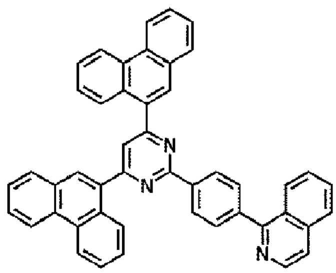

ET24

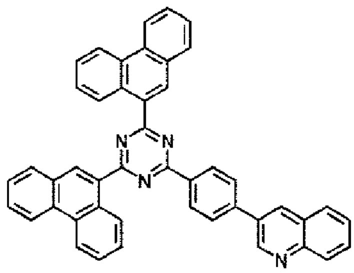
ET25

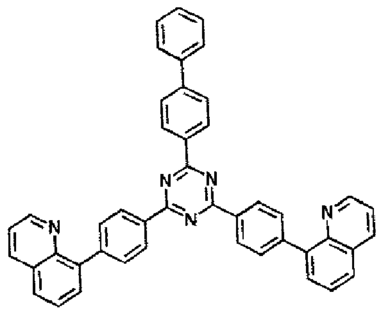
ET26

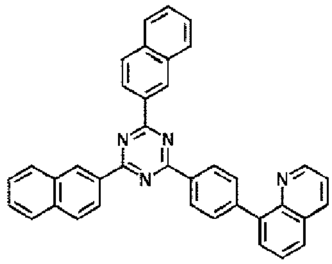
ET27

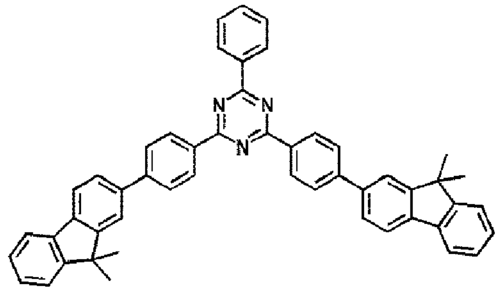
ET28

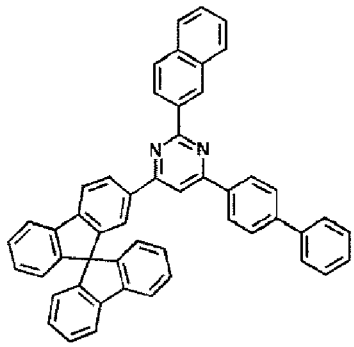
ET29

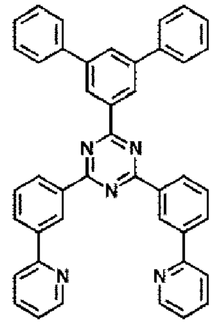
ET30

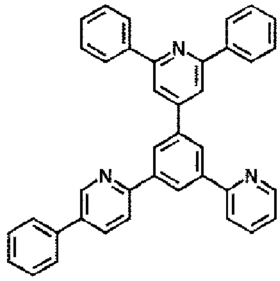
ET31

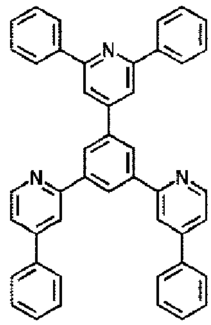
ET32

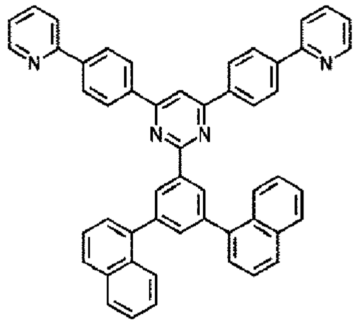
ET33

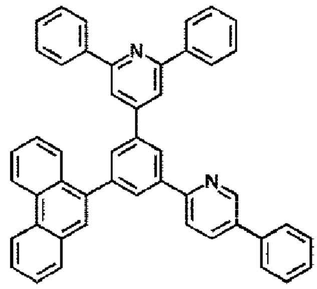
ET34

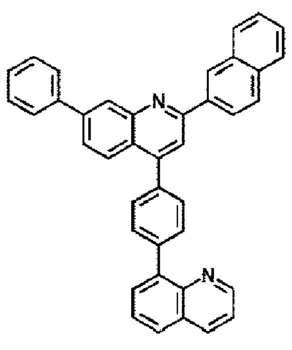
ET35

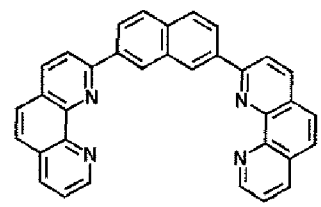
ET36

In one or more embodiments, the electron transport region may include at least one of 2,9-dimethyl-4,7-diphenyl-1,10-phenanthroline (BCP), 4,7-dphenyl-1,10-phenanthroline (Bphen), $Alq_3$, BAlq, 3-(biphenyl-4-yl)-5-(4-tert-butylphenyl)-4-phenyl-4H-1,2,4-triazole (TAZ), or NTAZ:

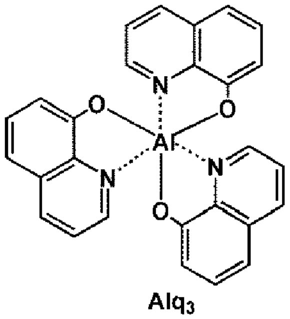

$Alq_3$

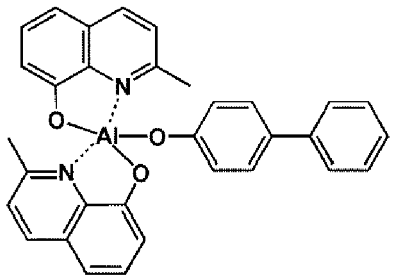

BAlq

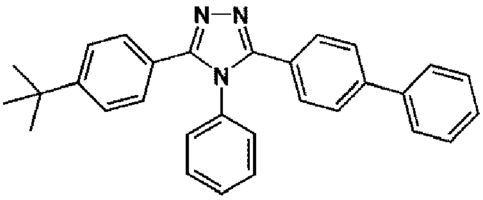

TAZ

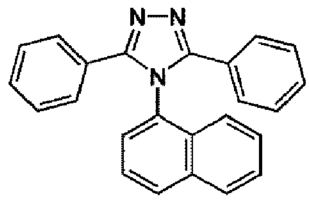

NTAZ

Thicknesses of the buffer layer, the hole blocking layer, and the electron control layer may each independently be in the range of about 20 Å to about 1,000 Å, for example, about 30 Å to about 300 Å. When the thicknesses of the buffer layer, the hole blocking layer, and the electron control layer are within these ranges, excellent hole blocking characteristics or excellent electron control characteristics may be obtained without a substantial increase in driving voltage.

A thickness of the electron transport layer may be in the range of about 100 Å to about 1,000 Å,for example, about 150 Å to about 500 Å. When the thickness of the electron transport layer is within the range described above, the electron transport layer may have satisfactory electron transport characteristics without a substantial increase in driving voltage.

The electron transport region 17 (for example, the electron transport layer in the electron transport region) may further include, in addition to the materials described above, a metal-containing material.

The metal-containing material may include at least one alkali metal complex or alkaline earth-metal complex. The alkali metal complex may include at least one metal ion that is a Li ion, a Na ion, a K ion, a Rb ion, or a Cs ion, and the alkaline earth-metal complex may include at least one metal ion that is a Be ion, a Mg ion, a Ca ion, a Sr ion, or a Ba ion. A ligand coordinated with the metal ion of the alkali metal complex or the alkaline earth-metal complex may be a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, or a cyclopentadiene, but embodiments of the present disclosure are not limited thereto.

In one or more embodiments, the metal-containing material may include a Li complex. The Li complex may include, for example, Compound ET-D1 (Liq) or ET-D2:

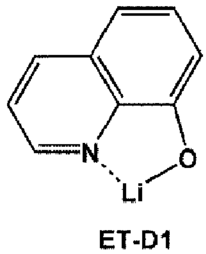

ET-D1

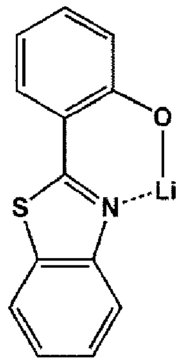

ET-D2

The electron transport region 17 may include an electron injection layer that facilitates the injection of electrons

from the second electrode 19. The electron injection layer may directly contact the second electrode 19.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may be Li, Na, K, Rb, or Cs. In one or more embodiments, the alkali metal may be Li, Na, or Cs. In one or more embodiments, the alkali metal may be Li or Cs, but embodiments of the present disclosure are not limited thereto.

The alkaline earth metal may be Mg, Ca, Sr, or Ba.

The rare earth metal may be Sc, Y, Ce, Tb, Yb, or Gd.

The alkali metal compound, the alkaline earth-metal compound, and the rare earth metal compound may be oxides or halides (for example, fluorides, chlorides, bromides, or iodides) of the alkali metal, the alkaline earth-metal, or the rare earth metal.

The alkali metal compound may be an alkali metal oxide, such as $Li_2O$, $Cs_2O$, or $K_2O$, or an alkali metal halide, such as LiF, NaF, CsF, KF, LiI, NaI, CsI, or KI. In one or more embodiments, the alkali metal compound may be LiF, $Li_2O$, NaF, LiI, NaI, CsI, or KI, but embodiments of the present disclosure are not limited thereto.

The alkaline earth-metal compound may be an alkaline earth-metal oxide, such as BaO, SrO, CaO, $Ba_xSr_{1-x}O$ ($0<x<1$), or $Ba_xCa_{1-x}O$ ($0<x<1$). In one or more embodiments, the alkaline earth-metal compound may be BaO, SrO, or CaO, but embodiments of the present disclosure are not limited thereto.

The rare earth metal compound may be $YbF_3$, $ScF_3$, $ScO_3$, $Y_2O_3$, $Ce_2O_3$, $GdF_3$, or $TbF_3$. In one or more embodiments, the rare earth metal compound may be $YbF_3$, $ScF_3$, $TbF_3$, $YbI_3$, $ScI_3$, or $TbI_3$, but embodiments of the present disclosure are not limited thereto.

The alkali metal complex, the alkaline earth-metal complex, and the rare earth metal complex may include an ion of alkali metal, alkaline earth-metal, and rare earth metal as described above, and a ligand coordinated with a metal ion of the alkali metal complex, the alkaline earth-metal complex, or the rare earth metal complex may be hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, or cyclopentadiene, but embodiments of the present disclosure are not limited thereto.

The electron injection layer may consist of an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof may be homogeneously or non-homogeneously dispersed in a matrix including the organic material.

A thickness of the electron injection layer may be in a range of about 1 Å to about 100 Å,and, for example, about 3 Å to about 90 Å. When the thickness of the electron injection layer is within the range described above, the electron injection layer may have satisfactory electron injection characteristics without a substantial increase in driving voltage.

Second electrode 19

The second electrode 19 is located on the organic layer 10A having such a structure. The second electrode 19 may be a cathode which is an electron injection electrode, and in this regard, a material for forming the second electrode 19 may be a metal, an alloy, an electrically conductive compound, or a combination thereof, which have a relatively low work function.

The second electrode 19 may include at least one of lithium (Li), silver (Ag), magnesium (Mg), aluminum (Al), aluminum-lithium (Al-Li), calcium (Ca), magnesium-indium (Mg-In), magnesium-silver (Mg-Ag), ITO, or IZO, but embodiments of the present disclosure are not limited thereto. The second electrode 19 may be a transmissive electrode, a semi-transmissive electrode, or a reflective electrode.

The second electrode 19 may have a single-layered structure having a single layer or a multi-layered structure including two or more layers.

Another aspect provides a diagnostic composition including at least one polycyclic compound represented by Formula 1.

The polycyclic compound represented by Formula 1 provides high luminescence efficiency. Accordingly, a diagnostic composition including the polycyclic compound may have high diagnostic efficiency.

The diagnostic composition may be used in various applications including a diagnosis kit, a diagnosis reagent, a biosensor, and a biomarker.

Explanation of terms

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" used herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group.

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si, and S as a ring-forming atom instead of a carbon atom, and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom instead of a carbon atom, 1 to 10 carbon atoms, and at least one carbon-carbon double bond in its ring and no aromaticity. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a cyclic aromatic system that has at least one heteroatom selected from N, O, P, Si, and S as a ring-forming atom instead of a carbon atom, and 1 to 60 carbon atoms. The term "$C_1$-$C_{60}$ heteroarylene group" as used herein refers to a divalent group having a cyclic aromatic system that has at least one heteroatom selected from N, O, P, and S as a ring-forming atom instead of a carbon atom, and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other.

The term "$C_6$-$C_{60}$ aryloxy group" used herein refers to $-OA_{102}$ (where $A_{102}$ is the $C_6$-$C_{60}$ aryl group), and the $C_6$-$C_{60}$ arylthio group is $-SA_{103}$ (where $A_{103}$ is the $C_6$-$C_{60}$ aryl group), and the $C_6$-$C_{60}$ arylalkyl group is $-(CR_2)_nA_{104}$ (where $A_{104}$ is the $C_6$-$C_{59}$ aryl group, R is H or a $C_1$-$C_{10}$ alkyl group, and n is an integer from 1 to 10).

The term "substituted or unsubstituted $C_1$-$C_{60}$ heteroaryloxy group" as used herein refers to -$OA_{102}$ (where $A_{102}$ is the $C_1$-$C_{60}$ heteroaryl group). The term "substituted or unsubstituted $C_1$-$C_{60}$ heteroarylthio group" as used herein is -$SA_{103}$ (where $A_{103}$ is the $C_1$-$C_{60}$ heteroaryl group). The term "substituted or unsubstituted $C_2$-$C_{60}$ heteroarylalkyl group" as used herein is -$(CR_2)_nA_{104}$ (where $A_{104}$ is the $C_1$-$C_{59}$ heteroaryl group, R is H or a $C_1$-$C_{10}$ alkyl group, and n is an integer from 1 to 10).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom instead of a carbon atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as a monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S as ring members instead of a carbon atom, and 1 to 30 carbon atoms. The $C_1$-$C_{30}$ heterocyclic group may be a monocyclic group or a polycyclic group.

In one or more embodiments, the $\pi$ electron-deficient nitrogen-containing $C_1$-$C_{60}$ cyclic group may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, an acridine group, or a pyridopyrazine group.

For example, the $\pi$ electron-deficient nitrogen-free cyclic group may be a $\pi$ electron-rich $C_3$-$C_{60}$ cyclic group, and the $\pi$ electron-rich $C_3$-$C_{60}$ cyclic group may be a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a carbazole group, a dibenzosilole group, an indenocarbazole group, an indolocarbazole group, a benzofurocarbazole group, a benzothienocarbazole group, a benzosilolocarbazole group, a triindolobenzene group, a pyrrolophenanthrene group, a furanophenanthrene group, a thienophenanthrene group, a benzonaphthofuran group, a benzonaphthothiophene group, an (indolo)phenanthrene group, a (benzofuran)phenanthrene group, or a (benzothieno)phenanthrene group.

For example, the $C_5$-$C_{60}$ carbocyclic group may be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, cyclopentadiene group, an indene group, a fluorene group, a 5,6,7,8-tetrahydroisoquinoline group, a 5,6,7,8-tetrahydroquinoline group, an adamantane group, a norbornane group, or a norbornene group.

For example, the $C_1$-$C_{60}$ heterocyclic group may be a thiophene group, a furan group, a pyrrole group, a silole group, a borole group, phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group,

an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group.

The term "a $\pi$ electron-deficient nitrogen-containing $C_1$-$C_{60}$ cyclic group, a $\pi$ electron-rich $C_3$-$C_{60}$ cyclic group, a $C_5$-$C_{60}$ carbocyclic group, and a $C_1$-$C_{60}$ heterocyclic group" may be part of a condensed cycle or may be a monovalent, a divalent, a trivalent, a tetravalent, a pentavalent, or a hexavalent group, depending on the formula structure.

At least one substituent of the substituted $\pi$ electron-deficient nitrogen-containing $C_1$-$C_{60}$ cyclic group, the substituted $\pi$ electron-rich $C_3$-$C_{60}$ cyclic group, the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_7$-$C_{60}$ aryl alkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group may be :

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, or $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$heteroaryloxy group, a $C_1$-$C_{60}$heteroarylthio group, a $C_2$-$C_{60}$ heteroarylalkyl group, a monovalent non-aromatic condensed polycyclic group, or a monovalent non-aromatic condensed heteropolycyclic group, each substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$heteroaryloxy group, a $C_1$-$C_{60}$heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, or $-P(=O)(Q_{28})(Q_{29})$; or

$-N(Q_{31})(Q_{32})$, $-Si(Q_{33})(Q_{34})(Q_{35})$, $-B(Q_{36})(Q_{37})$, and $-P(=O)(Q_{38})(Q_{39})$,

wherein $Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group.

For example, $Q_1$ to $Q_9$, $Q_{11}$ to $Q_{19}$, $Q_{21}$ to $Q_{29}$ and $Q_{31}$ to $Q_{39}$ described herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or $-CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or any combination thereof.

The term "room temperature" used herein refers to a temperature of about 25 °C.
The terms "a biphenyl group, a terphenyl group, and a quaterphenyl group" used herein respectively refer to monovalent groups in which two, three, or four phenyl groups which are linked together via a single bond.
The terms "a cyano-containing phenyl group, a cyano-containing biphenyl group, a cyano-containing terphenyl group, and a cyano-containing quaterphenyl group" used herein respectively refer to a phenyl group, a biphenyl group, a terphenyl group, and a quaterphenyl group, each of which is substituted with at least one cyano group. In "a cyano-containing phenyl group, a cyano-containing biphenyl group, a cyano-containing terphenyl group, and a cyano-containing quaterphenyl group", a cyano group may be substituted to any position of the corresponding group, and the "cyano-containing phenyl group, the cyano-containing biphenyl group, the cyano-containing terphenyl group, and the cyano-containing quaterphenyl group" may further include substituents other than a cyano group. For example, a phenyl group substituted with a cyano group, and a phenyl group substituted with a cyano group and a methyl group may all belong to "a cyano-containing phenyl group."
Hereinafter, a compound and an organic light-emitting device according to embodiments are described in detail with reference to Synthesis Examples and Examples. However, the organic light-emitting device is not limited thereto. The wording "'B' was used instead of 'A'" used in describing Synthesis Examples means that an amount of 'A' used was identical to an amount of 'B' used, in terms of a molar equivalent.

Examples

Synthesis Example 1 : Synthesis of Compound 1 (diazoboranaphtoanthracene)

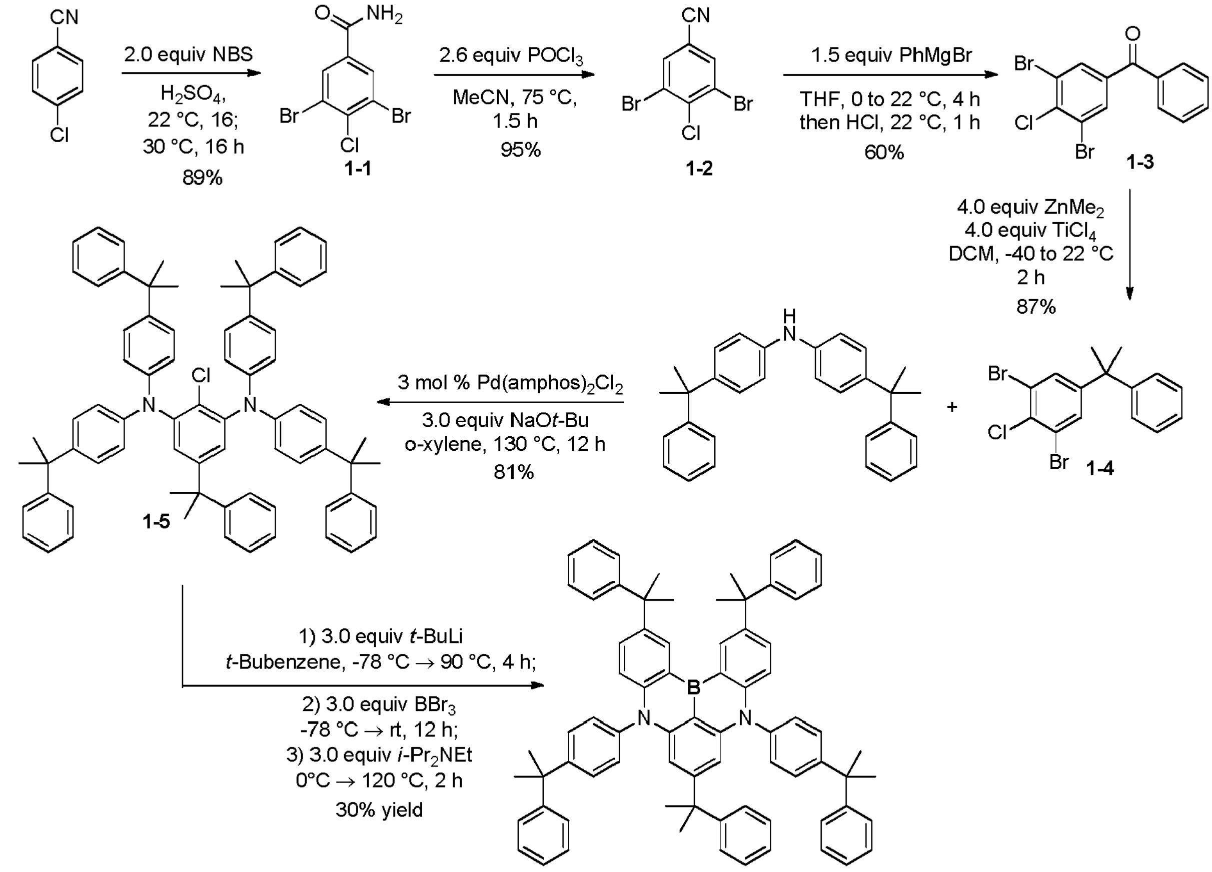


**Compound 1**

Synthesis of Compound 1-1 (3,5-dibromo-4-chlorobenzamide)

4-chlorobenzonitrile (1.00 grams (g), 7.27 millimoles (mmol)) and a magnetic bar were placed in a 50 mL round-bottom flask, and the reaction vessel was cooled to 0 °C using an ice water bath, and then $H_2SO_4$ (10.8 mL) and N-bromosuccinimide(NBS) (2.59 g, 14.54 mmol) were added thereto and then stirred under nitrogen gas. The resultant mixture was stirred for 16 hours while the reaction temperature was slowly raised from 0 °C to room temperature and then, further stirred at 30 °C for 16 hours. The reaction solution was cooled to 0 °C using an ice water bath, and then, distilled water (10 mL) was added thereto and stirred at room temperature for 1 hour, and the reaction was terminated with aqueous ammonia at 0 °C. The produced solid was filtered and dried with filter paper. The dry reaction product was separated by silica gel column chromatography (ethyl acetate (EtOAc):hexanes=1:2) to synthesize 3,5-dibromo-4-chlorobenzamide (2.03 g, 6.47 mmol, 89%) of Compound 1-1, which was a white solid.

Proton nuclear magnetic resonance ($^1$ H NMR) spectroscopy (400 megahertz (MHz), $d_6$-dimethylsulfoxide (DMSO-$d_6$)): chemical shift (δ, ppm): 8.23 (s, 2H); $^{13}$C NMR (100 MHz, DMSO-$d_6$): δ (ppm) 164.2, 136.2, 135.1, 131.9, 122.9.

Synthesis of Compound 1-2 (3,5-dibromo-4-chlorobenzonitrile)

3,5-dibromo-4-chlorobenzamide (Compound 1-1, 1.96 g, 6.25 mmol) was added to a 100 mL round-bottom flask, and acetonitrile (MeCN) (25.0 mL) was added thereto under nitrogen gas. $POCl_3$ (1.50 mL, 16.3 mmol) was added thereto and the reaction mixture was stirred at 75 °C for 1.5 hours. Thereafter, the reaction mixture was cooled to 0 °C using an ice bath, and saturated $NaHCO_3$ aqueous solution (30 mL) was added thereto to terminate the reaction. The resultant solid was filtered with filter paper, dried, and then separated by silica gel column chromatography (100% hexanes) to synthesize 3,5-dibromo-4-chlorobenzonitrile (1.76 g, 5.94 mmol, 95%) of Compound 1-2, which was a white solid.

$^1$ H NMR (400 MHz, $CDCl_3$): δ (ppm) 7.89 (s, 2H); $^{13}$C NMR (100 MHz, $CDCl_3$): δ (ppm) 140.8, 135.4, 124.5, 115.4, 112.7.

Synthesis of Compound 1-3 ((3,5-dibromo-4-chlorophenyl)(phenyl)methanone)

3,5-dibromo-4-chlorobenzonitrile (Compound 1-2, 500 mg, 1.70 mmol) was added to a 50 mL round-bottom flask, and tetrahydrofuran(THF) (5.1 mL) was added thereto under nitrogen gas. The reaction solution was cooled to 0 °C using an ice water bath, and then, $C_6H_5MgBr$(PhMgBr) (2.54 mL, 2.54 mmol) was slowly added thereto. The resultant mixture was stirred at room temperature for 4 hours, and then, 2N HCl (13.7 mL) was added at room temperature, followed by one hour of stirring. The reaction was terminated by adding saturated $NaHCO_3$ aqueous solution (5 mL), followed by extraction with $CH_2Cl_2$ (3 × 5 mL). $MgSO_4$ was added to a collected organic layer solution to remove water therefrom, followed by concentration by filtration. The concentrated reaction product was separated by silica gel column chromatography (EtOAc:hexanes=1:10), triturated with EtOAc, and filtered, thereby completing the preparation of Compound 1-3 (3,5-dibromo-4-chlorophenyl)(phenyl)methanone (380 mg, 1.02 mmol, 60 %), which was a white solid compound.

$^1H$ NMR (400 MHz, $CDCl_3$): δ (ppm) 8.01 (s, 2H), 7.78 (dd, J = 8.0, 1.1 Hz, 2H), 7.68-7.64 (m, 1H), 7.54 (t, J = 7.5 Hz, 1H); $^{13}C$ NMR (100 MHz, CDCl3): δ (ppm) 192.8, 139.1, 137.6, 136.1, 133.7, 133.3, 129.9, 128.7, 123.7.

Synthesis: of Compound 1-4 (1,3-dibromo-2-chloro-5-(2-phenylpropan-2-yl)benzene)

A 25 mL round-bottom flask was cooled to -40 °C with dry ice and acetone, and then, $TiCl_4$ (2.96 mL, 3.96 mmol) and $Zn(CH_3)_2$ (2.47 mL, 3.96 mmol) were slowly added thereto under nitrogen gas and stirred for 30 minutes. (3,5-dibromo-4-chlorophenyl)(phenyl)methanone (Compound 1-3, 370 mg, 0.99 mmol) in $CH_2Cl_2$ (DCM) was slowly added to the reaction vessel, and then, was stirred for 2 hours while the temperature thereof was gradually raised to room temperature. The reaction solution was cooled to 0 °C using an ice water bath, and then, distilled water (10 mL) was added thereto to terminate the reaction, followed by extraction with $CH_2Cl_2$ (3 × 10 mL). $MgSO_4$ was added to a collected organic layer solution to remove water therefrom, followed by concentration by filtration. The concentrated reaction product was separated by silica gel column chromatography (100% hexanes), to obtain 1,3-dibromo-2-chloro-5-(2-phenylpropan-2-yl)benzene (334 mg, 0.86 mmol, 87 %) of Compound 4, which was a white solid.

$^1H$ NMR (400 MHz, $CDCl_3$): δ (ppm) 7.43 (s, 2H), 7.33-7.30 (m, 2H), 7.23-7.18 (m, 3H), 1.65 (s, 6H); $^{13}C$ NMR (100 MHz, $CDCl_3$): δ (ppm) 152.1, 148.5, 132.0, 131.4, 128.4, 126.5, 126.3, 123.0, 42.8, 30.5

Synthesis of Compound 1-5 (2-chloro-5-(2-phenylpropan-2-yl)-$N^1$,$N^1$,$N^3$,$N^3$-tetrakis(4-(2-phenylpropan-2-yl)phenyl)benzene-1,3-diamine):

In a glove box under a nitrogen atmosphere, bis(4-(2-phenylpropan-2-yl)phenyl)amine (12.3 g, 30.4 mmol), dichlorobis[di-tert-butyl(4-dimethylaminophenyl)phosphine]palladium(II) (Pd(amphos)$_2$Cl$_2$) (307 mg, 0.430 mmol), and sodium t-butoxide (NaOt-Bu) (3.48 g, 43.5 mmol) were placed in a 100 mL round-bottom flask, and sealed with rubber septa. Then, the round-bottom flask was taken out of the glove box. Nitrogen gas was flown into the round-bottom flask containing reactants for 5 minutes, and then, 1,3-dibromo-2-chloro-5-(2-phenylpropan-2-yl)benzene dissolved in o-xylene (5 mL) (Compound 1-4, 5.58 g, 14.5 mmol) and o-xylene (53 mL) were added thereto, and then, stirred at 130 °C for 12 hours. The reaction solution was cooled to room temperature, and extracted with $CH_2Cl_2$ (3 × 20 mL), and an organic layer solution was collected therefrom, and water was removed therefrom by using $MgSO_4$, and then filtered and concentrated. The concentrated reaction product was separated by silica gel column chromatography (EtOAc:hexanes=1:50) to obtain 2-chloro-5-(2-phenylpropan-2-yl)-$N^1$,$N^1$,$N^3$,$N^3$-tetrakis(4-(2-phenylpropan-2-yl)phenyl)benzene-1,3-diamine of Compound 1-5 (12.2 g, 11.7 mmol, 81 %), which was a white solid.

$^1H$ NMR (400 MHz, CDCl3): δ (ppm) 7.28-7.20 (m, 20H), 7.18-7.14 (m, 5H), 7.04-7.00 (m, 8H), 6.96 (s, 2H), 6.83-6.79 (m, 8H), 1.64 (s, 24H), 1.53 (s, 6H); $^{13}C$ NMR (100 MHz, CDCl3): δ (ppm) 150.9, 149.6, 145.2, 144.3, 140.8, 130.0, 128.0, 127.9, 127.9, 127.2, 127.1, 126.8, 128.5, 125.7, 125.5, 120.8, 42.8, 42.4, 30.8, 30.5.

Synthesis of Compound 1 of diazoboranaphthoanthracene (2,7,12-tris(2-phenylpropan-2-yl)-5,9-bis(4-(2-phenylpropan-2-yl)phenyl)-5,9-dihydro-5,9-diaza-13b-boranaphtho[3,2,1-de]anthracene):

2-chloro-5-(2-phenylpropan-2-yl)-$N^1$,$N^1$,$N^3$,$N^3$-tetrakis(4-(2-phenylpropan-2-yl)phenyl)benzene-1,3-diamine (Compound 1-5, 100 mg, 0.0960 mmol) was added to a 50 mL round-bottom flask, and then, t-Bu-benzene (0.20 mL) was added thereto under nitrogen gas. The resultant mixture was cooled to -78 °C by using dry ice and acetone, and then, tert-butyl lithium (t-BuLi) (0.170 mL, 0.290 mmol) was slowly added and stirred at 90 °C for 4 hours. The temperature was lowered to -78 °C, and $BBr_3$ (0.0280 mL, 0.290 mmol) was slowly added thereto, followed by twelve hours of stirring at room temperature. The temperature was lowered to 0 °C using an ice water bath, and then, diisopropylethylamine (i-Pr2NEt) (0.0500 mL, 0.290 mmol) was slowly added thereto and stirred at 120 °C for 2 hours. The reaction solution was cooled to 0°C using an ice water bath, and then, the reaction was terminated with 5% sodium acetate aqueous solution

(5 mL), followed by extraction with EtOAc (3 × 5 mL). $MgSO_4$ was added to a collected organic layer solution to remove water therefrom, followed by concentration by filtration. The concentrated reaction product was separated by silica gel column chromatography (EtOAc:hexanes=1:100), and then, precipitated with diethylether (3 × 5 mL) and filtered to obtain Compound 1 of 2,7,12-tris(2-phenylpropan-2-yl)-5,9-bis(4-(2-phenylpropan-2-yl)phenyl)-5,9-dihydro-5,9-diaza-13b-boranaphtho[3,2,1-de]anthracene (30.0 mg, 0.300 mmol, 30 %), which was a yellow solid.

$^1$H NMR (400 MHz, CDCl3): δ (ppm) 8.89 (d, J = 2.3 Hz, 2H), 7.42 (d, J = 8.2 Hz, 4H), 7.35-7.20 (m, 17H), 7.18-7.06 (m, 12H), 7.00 (dd, J = 7.8, 1.9 Hz, 2H), 6.72 (d, J = 9.1 Hz, 2H), 5.92 (s, 2H), 1.79 (s, 12H), 1.77 (s, 12H), 1.38 (s, 6H); $^{13}$C NMR (100 MHz, CDCl3): δ (ppm) 151.1, 150.8, 150.5, 150.4, 146.6, 145.9, 141.1, 139.7, 131.7, 130.4, 129.2, 128.1, 128.0, 127.6, 126.8, 126.8, 126.5, 125.8, 125.4, 125.2, 116.7, 104.1, 43.5, 43.0, 42.5, 31.0, 30.8, 30.0.

Example 1

A glass substrate was cut to a size of 50 millimeters (mm) × 50 mm × 0.5 mm and then, sonicated in acetone isopropyl alcohol and pure water, each for 15 minutes, and then, washed by exposure to UV ozone for 30 minutes.

Subsequently, a first host (H1), a second host (H2), a sensitizer (S-2), and a fluorescent emitter (Compound 1) were co-deposited on the glass to form an emission layer having a thickness of 500 Å. At this time, a film was formed such that the first host and the second host were mixed at a weight ratio of 50:50, and the sensitizer and a fluorescent emitter were 10 wt% and 1.5 wt%, respectively, based on the total weight of the first host, the second host, the sensitizer, and the fluorescent emitter.

Example 2

A glass substrate with an ITO electrode located thereon was cut to a size of 50 mm × 50 mm × 0.5 mm and then, sonicated in acetone isopropyl alcohol and pure water, each for 15 minutes, and then, washed by exposure to UV ozone for 30 minutes.

Then, HAT-CN was deposited on the ITO electrode (anode) on the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron blocking layer having a thickness of 50 Å.

A first host (H1), a second host (H2), a sensitizer (S-2), and a fluorescent emitter (Compound 1) were co-deposited on the electron blocking layer to form an emission layer having a thickness of 400 Å. At this time, the first host and the second host were mixed at a weight ratio of 60:40, and the amounts of the sensitizer and fluorescent emitter were adjusted to be 10 wt% and 0.5 wt%, respectively, based on the total weight of the first host, the second host, the sensitizer and the fluorescent emitter.

DBFPO was deposited on the emission layer to form a hole blocking layer having a thickness of 100 Å, and then DBFPO and Liq were co-deposited thereon at a weight ratio of 5:5 to form an electron transport layer having a thickness of 300 Å, and then, Liq was deposited on the electron transport layer to form an electron injection layer having a thickness of 10 Å, and Al was deposited on the electron injection layer to form a cathode having a thickness of 1000 Å, thereby completing the manufacture of an organic light-emitting device.

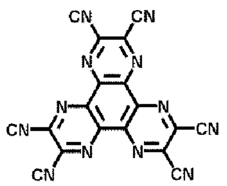
HT-D1(HAT-CN)

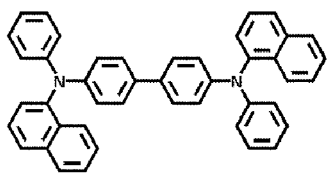
NPB

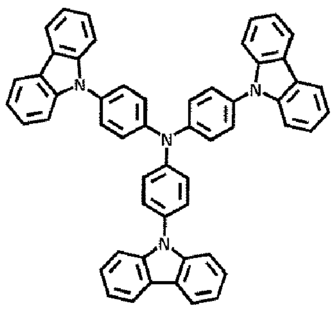
TCTA

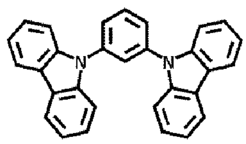
mCP

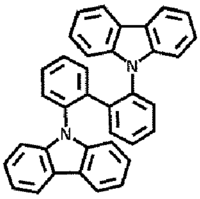

H1

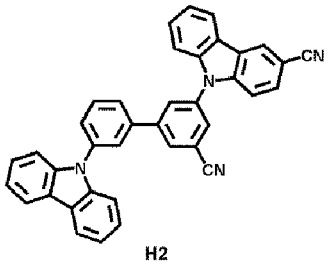

H2

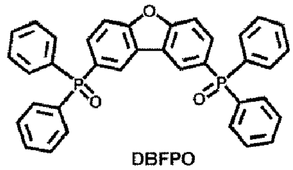

DBFPO

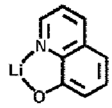

Liq

Example 3

An organic light-emitting device was manufactured in the same manner as in Example 2, except that the sensitizer compound S-2 was not included when the emission layer was formed, and the fluorescent emitter compound shown in Table 8 was used at 1.5 wt%.

Comparative Examples 1 and 2

Organic light-emitting devices were manufactured in the same manner as in Example 1, except that Compounds shown in Table 8 were each used instead of Compound 1 as a dopant when the emission layer was formed.

Comparative Examples 3 and 4

Organic light-emitting devices were manufactured in the same manner as in Example 2, except that Compounds shown in Table 8 were each used instead of Compound 1 as a dopant when the emission layer was formed.

Comparative Examples 5 and 6

Organic light-emitting devices were manufactured in the same manner as in Example 3, except that Compounds shown in Table 8 were each used instead of Compound 1 as a dopant when the emission layer was formed.

Table 8

| Device No. | Host | | Sensitizer | Fluorescent emitter |
|---|---|---|---|---|
| | First host | Second host | | |
| Example 1 | H1 | H2 | S-2 | Compound 1 |
| Example 2 | H1 | H2 | S-2 | Compound 1 |
| Example 3 | H1 | H2 | - | Compound 1 |
| Comparative Example 1 | H1 | H2 | S-2 | Compound A |
| Comparative Example 2 | H1 | H2 | S-2 | Compound B |
| Comparative Example 3 | H1 | H2 | S-2 | Compound A |
| Comparative Example 4 | H1 | H2 | S-2 | Compound B |
| Comparative Example 5 | H1 | H2 | - | Compound A |
| Comparative Example 6 | H1 | H2 | - | Compound B |

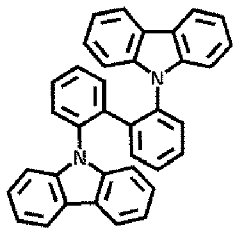

H1

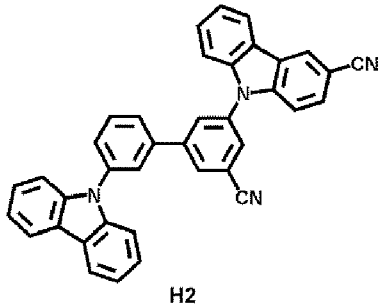

H2

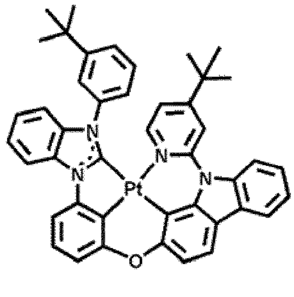

S-2

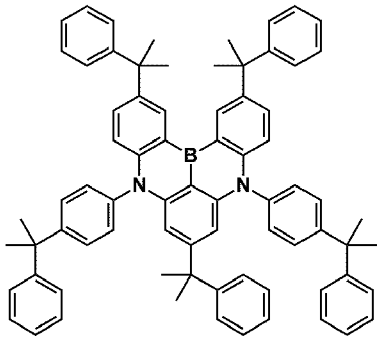

1

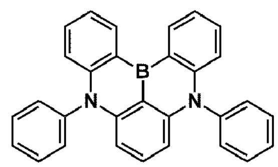

Compound A

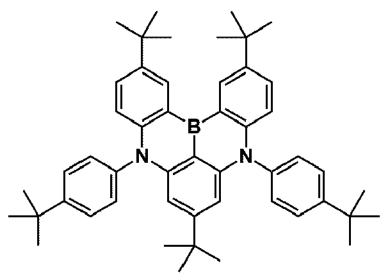

Compound B

Evaluation Example 1: PL spectrum evaluation

Compound 1 was diluted at a concentration of 10 mM in toluene, and then, the PL spectrum thereof was measured by using a ISC PC1 spectrofluorometer having a Xenon lamp mounted thereon at room temperature and 77K. This process cycle was repeatedly performed on Compounds A and B. Results thereof are shown in Figs. 2 to 4.

Evaluation Example 2: Decay time measurement

For each of the films produced in Example 1 and Comparative Examples 1 and 2, the PL spectrum was evaluated at room temperature by using the FluoTime 300 of PicoQuant Inc. and PLS340 (excitation wavelength = 340 nm, spectrum width = 20 nm), which was a pumping source of PicoQuant. In detail, the wavelength of the main peak of the spectrum obtained for each film was determined, and the number of photons emitted from the respective sample at the wavelength of the main peak by photon pulses (pulse width = 500 picoseconds (ps)) applied by the PLS340 to the respective film was repeatedly measured based on time-correlated single photon counting (TCSPC), to obtain a TRPL curve which can be subjected to fitting. Two or more exponential decay functions, obtained therefrom, were subjected to fitting to calculate a decay time with respect to each film. In this regard, the same measurement was performed for the same measurement time as the measurement time to obtain the TRPL curve in the dark (a state where the light-low pulse signal incident to a certain film was blocked), thereby obtaining the background signal curve, which was then subjected to fitting for use as a baseline.

The function used for fitting is the same as Equation A below, and the largest value among the decay time (in microseconds, μs) obtained therefrom was taken.

Equation A

$$f(t) = \sum_{i=1}^{n} A_i \, exp(-t/T_{decay,i})$$

Table 9

| | Dopant in emission layer | $S_1$ (eV) | $T_1$ (eV) | $\Delta E_{ST}$ (eV) | Decay time (μs) | Driving voltage (V) | EQE (%) |
|---|---|---|---|---|---|---|---|
| Example 1 | Compound 1 | 2.678 | 2.531 | 0.150 | 4.569 | 4.77 | 22.5 |
| Comparative Example 1 | Compound A | 2.737 | 2.567 | 0.170 | 7.231 | 4.93 | 19.2 |
| Comparative Example 2 | Compound B | 2.696 | 2.366 | 0.329 | 5.512 | 4.97 | 21.9 |

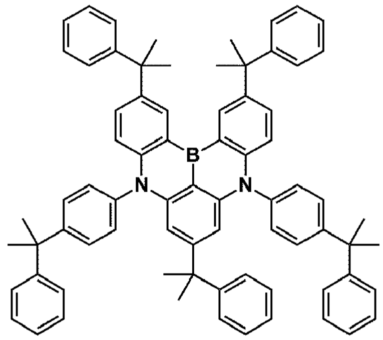

1

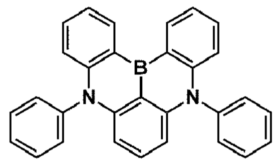

Compound A

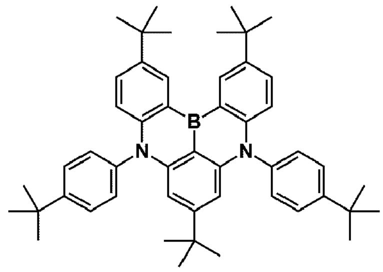

Compound B

As shown in Table 9 and FIGS. 2 to 4, the band gap energy of Compound 1 used in Example 1 is smaller than those of Compounds A and B used in Comparative Examples 1 and 2, and the overlapping range of $S_1$ and $T_1$ energy level is wide, and thus, the reverse intersystem crossing occurs easily. Accordingly, it was confirmed that the organic light-emitting device of Example 1 has shorter decay time than Comparative Examples 1 and 2.

Evaluation Example 3: Evaluation of Properties of Organic Light-Emitting Devices (1)

The driving voltage and quantum efficiency (%) were evaluated for each of the organic light-emitting devices manufactured in Example 2 and Comparative Examples 3 and 4, and results thereof are shown in Table 10.

Table 10

| | Dopant in emission layer | Quantum efficiency (%) | Driving voltage (%) |
|---|---|---|---|
| Example 2 | Compound 1 | 119 | 97 |
| Comparative Example 3 | Compound A | 100 | 100 |
| Comparative Example 4 | Compound B | 110 | 101 |

Evaluation Example 4: Evaluation of Properties of Organic Light-Emitting Devices (2)

The driving voltage and quantum efficiency (%) were evaluated for each of the organic light-emitting devices manufactured in Example 3 and Comparative Examples 5 and 6, and results thereof are shown in Table 11.

Table 11

| | Dopant in emission layer | Quantum efficiency (%) | Driving voltage (%) |
|---|---|---|---|
| Example 3 | Compound 1 | 153 | 94 |
| Comparative Example 5 | Compound A | 100 | 100 |
| Comparative Example 6 | Compound B | 151 | 98 |

As shown in Tables 10 to 11, due to the use of the Compound 1 as a dopant, Example 2 and 3 have higher efficiency and lower driving voltage than Comparative Examples 3 to 6.

An organic light-emitting device, which includes a new structure of polycyclic compound in an emission layer, has high efficiency and long lifespan.

It should be understood that exemplary embodiments described herein should be considered in a descriptive sense and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope as defined by the following claims.

## Claims

**1.** A polycyclic compound represented by Formula 1:

Formula 1

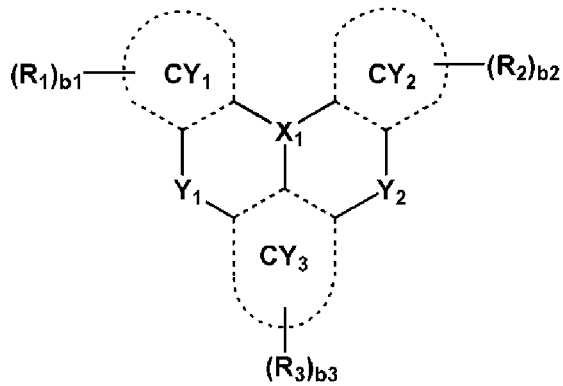

$$*-(L_{11})_{a11}-(A_{11})_{m11}$$ (Formula 1-1)

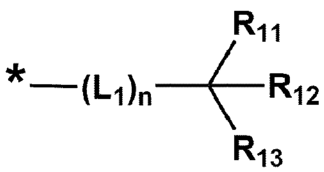

(Formula 1-2)

wherein, in Formulae 1, 1-1, and 1-2,

ring $CY_1$, ring $CY_2$, and ring $CY_3$ are each independently a $C_5$-$C_{30}$ carbocyclic group or a $C_1$-$C_{30}$ heterocyclic group,
$X_1$ is B, N, P, P(=O), P(=S), Al, Ga, As, $C(R_4)$, $Si(R_4)$, or $Ge(R_4)$,
$Y_1$ and $Y_2$ are each independently O, S, Se, $B(R_5)$, $N(R_5)$, $C(R_5)(R_6)$, $Si(R_5)(R_6)$, $Ge(R_5)(R_6)$, $Ga(R_5)$, $As(R_5)$, $P(R_5)$, $P(=O)(R_5)$, $P(=S)(R_5)$, or $Al(R_5)$,
$R_1$, $R_2$, $R_3$, $R_4$, $R_5$, and $R_6$ are each independently a group represented by Formula 1-1, hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted

$C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, - $N(Q_1)(Q_2)$, $-Si(Q_3)(Q_4)(Q_5)$, $-B(Q_6)(Q_7)$, or $-P(=O)(Q_8)(Q_9)$,
at least one of $R_1$ to $R_6$ is a group represented by Formula 1-1,
two neighboring groups of $R_1$ to $R_6$ are optionally linked to each other to form a substituted or unsubstituted $C_5$-$C_{30}$ carbocyclic group or a substituted or unsubstituted $C_1$-$C_{30}$ heterocyclic group,
b1 to b3 are each independently an integer of 0 to 10,
when b1 is 2 or more, two or more of $R_1$(s) are identical to or different from each other, when b2 is 2 or more, two or more of $R_2$(s) are identical to or different from each other, and when b3 is 2 or more, two or more of $R_3$(s) are identical to or different from each other,
$L_{11}$ is a single bond, a substituted or unsubstituted $C_5$-$C_{30}$ carbocyclic group, or a substituted or unsubstituted $C_1$-$C_{30}$ heterocyclic group,
a11 is an integer from 1 to 3,
$A_{11}$ is a group represented by Formula 1-2,
m11 is an integer from 1 to 5,
$L_1$ is a substituted or unsubstituted $C_1$-$C_{20}$ alkylene group, a substituted or unsubstituted $C_2$-$C_{20}$ alkenylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,
n is an integer from 0 to 3, wherein, when n is 0, $L_1$ is not present, and when n is 2 or more, two or more of $L_1$(s) are identical to or different from each other,
$R_{11}$, $R_{12}$, and $R_{13}$ are each independently hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, or $-P(=O)(Q_8)(Q_9)$,
at least one of $R_{11}$, $R_{12}$, and $R_{13}$ is a substituted or unsubstituted $C_6$-$C_{60}$ aryl group,
* and *' each indicate a binding site to a neighboring group, and
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_7$-$C_{60}$ aryl alkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, the substituted monovalent non-aromatic condensed heteropolycyclic group, the substituted $C_1$-$C_{20}$ alkylene group, the substituted $C_2$-$C_{20}$ alkenylene group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, and the substituted divalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a $C_1$-$C_{60}$ alkyl group,

a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-Si(Q_{11})(Q_{12})(Q_{13})$, $-N(Q_{14})(Q_{15})$, $-B(Q_{16})(Q_{17})$, or-$P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a s $C_2$-$C_{60}$ heteroarylalkyl group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group, each substituted with at least one of deuterium, -F, -Cl, -Br, -I, $-CD_3$, $-CD_2H$, $-CDH_2$,$-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group,$-Si(Q_{21})(Q_{22})(Q_{23})$, $-N(Q_{24})(Q_{25})$ $-B(Q_{26})(Q_{27})$, or $-P(=O)(Q_{26})(Q_{29})$; or

$-Si(Q_{31})(Q_{32})(Q_{33})$, $-N(Q_{34})(Q_{35})$, $-B(Q_{36})(Q_{37})$, or $-P(=O)(Q_{38})(Q_{39})$,

wherein $Q_1$ to $Q_9$, $Q_{11}$ to $Q_{19}$, $Q_{21}$ to $Q_{29}$, and $Q_{31}$ to $Q_{39}$ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, or a substituted or unsubstituted monovalent non-aromatic condensed heteropolycyclic group.

**2.** The polycyclic compound of claim 1, wherein ring $CY_1$, ring $CY_2$, and ring $CY_3$ are each independently:

group A;

group B;

a condensed ring in which two or more of group A are condensed with each other;

a condensed ring in which two or more group B are condensed with each other; or

a condensed ring in which at least one group A is condensed with at least one group B,

wherein group A is a cyclic diene group, an indene group, an azulene group, a benzene group, a naphthalene group, an anthracene group, a phenanthrene group, a tetracene group, a tetraphene group, a pyrene group, a chrysene group, a triphenylene group, or a fluorene group, and

wherein group B is a furan group, a thiophene group, a pyrrole group, borole group, a silole group, a pyrrolidine group, an imidazole group, a triazole group, an oxazole group, an isoxazole group, a thiazole group, an isothiazole group, a pyridine group, a pyrimidine group, a pyridazine group, a triazine group, an indole group, an isoindole group, an indolizine group, a quinoline group, an isoquinoline group, a quinoxaline group, an isoquinoxaline group, a carbazole group, a dibenzofuran group, a dibenzothiophene group, a dibenzosilole group, or a dibenzoborole group.

**3.** The polycyclic compound of claims 1 or 2, wherein ring $CY_1$, ring $CY_2$, and ring $CY_3$ are each independently a benzene group, a naphthalene group, an anthracene group, or a fluorene group; and/or wherein $Y_1$ and $Y_2$ are the same.

**4.** The polycyclic compound of any of claims 1-3, wherein
$X_1$ is B, N, P, P(=O), P(=S), or Al, and
$Y_1$ and $Y_2$ are each independently O, S, Se, $B(R_5)$, $N(R_5)$, $C(R_5)(R_6)$, or $Si(R_5)(R_6)$.

**5.** The polycyclic compound of any of claims 1-4, wherein $L_{11}$ is:

a single bond;
a benzene group, an indene group, a naphthalene group, an azulene group, a heptalene group, acenaphthylene group, a fluorene group, a phenalene group, a phenanthrene group, an anthracene group, a fluoranthene group, a triphenylene group, a pyrene group, a chrysene group, a pyridine group, a pyrimidine group, a pyrazine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, a carbazole group, an azacarbazole group, a dibenzofuran group, a dibenzothiophene group, or a dibenzosilole group; or
a benzene group, an indene group, a naphthalene group, an azulene group, a heptalene group, acenaphthylene group, a fluorene group, a phenalene group, a phenanthrene group, an anthracene group, a fluoranthene group, a triphenylene group, a pyrene group, a chrysene group, a pyridine group, a pyrimidine group, a pyrazine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, a carbazole group, an azacarbazole group, a dibenzofuran group, a dibenzothiophene group, or a dibenzosilole group, each substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group.

**6.** The polycyclic compound of any of claims 1-5, wherein $L_{11}$ is a single bond; or
a group represented by one of Formulae 3-1 to 3-46:

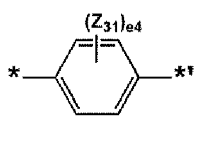
3-1

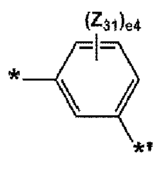
3-2

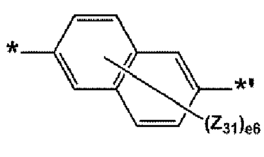
3-3

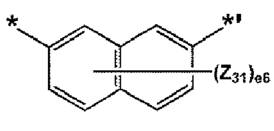
3-4

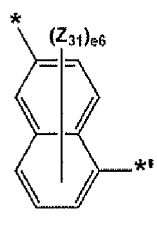
3-5

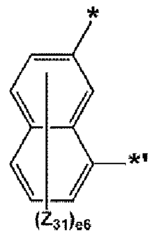

3-6

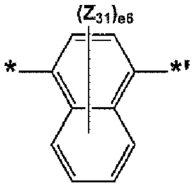

3-7

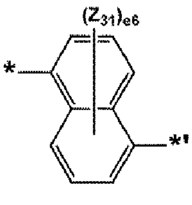

3-8

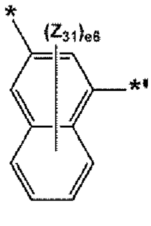

3-9

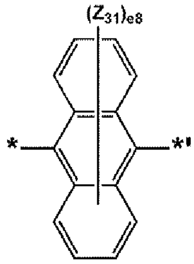

3-10

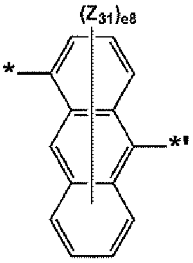

3-11

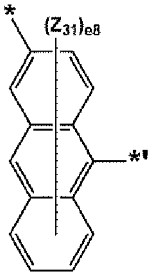

3-12

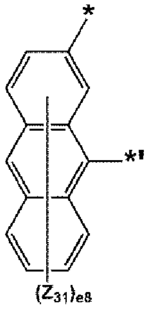

3-13

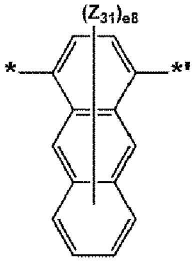

3-14

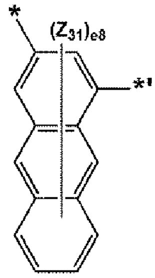

3-15

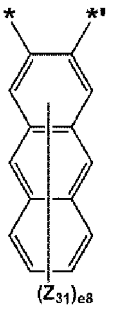

3-16

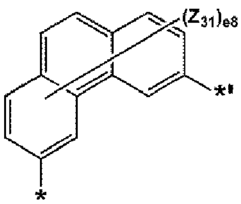

3-17

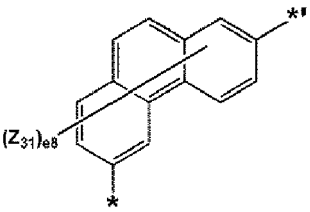

3-18

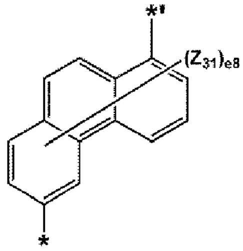

3-19

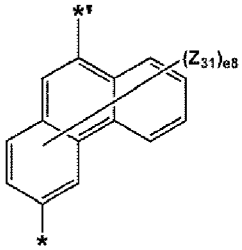

3-20

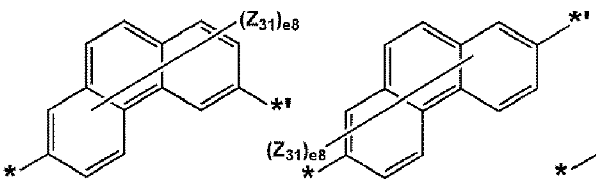

3-21

3-22

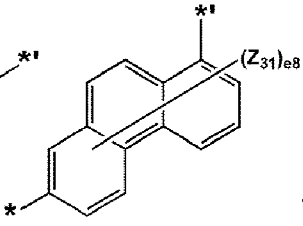

3-23

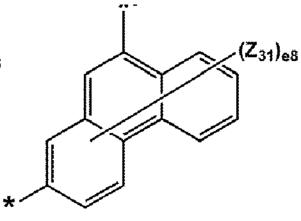

3-24

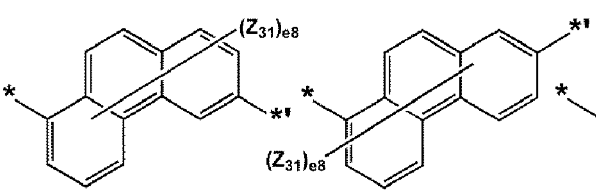

3-25

3-26

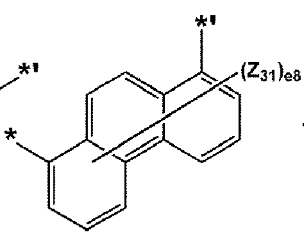

3-27

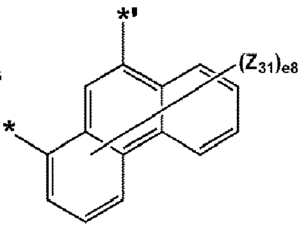

3-28

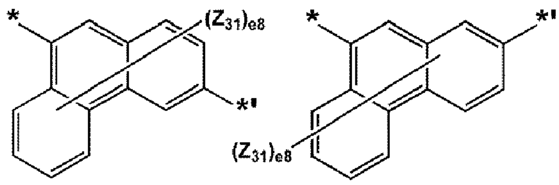

3-29 3-30

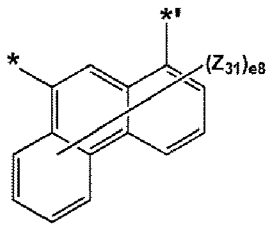

3-31

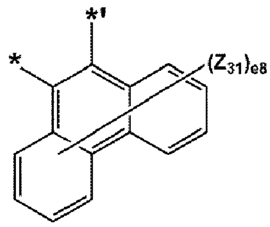

3-32

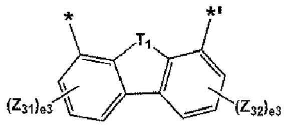

3-33

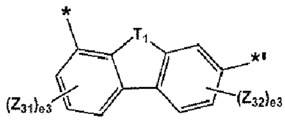

3-34

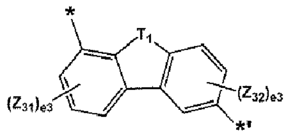

3-35

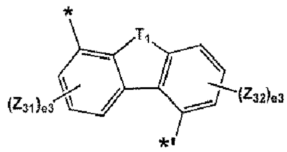

3-36

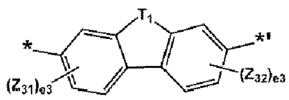

3-37

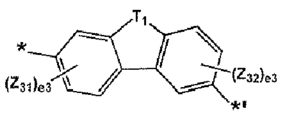

3-38

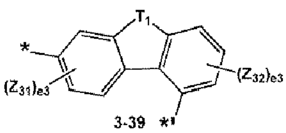

3-39

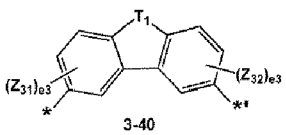

3-40

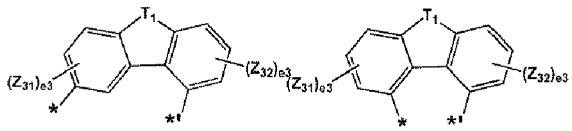

3-41 3-42

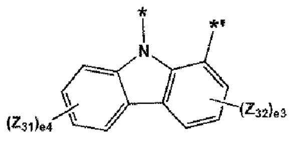

3-43

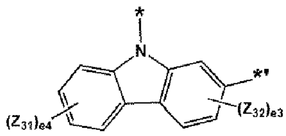

3-44

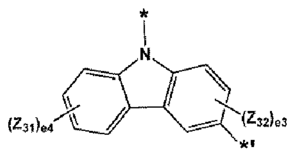

3-45

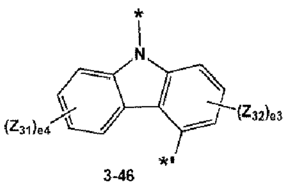

3-46

wherein, in Formulae 3-1 to 3-46,

$T_1$ is O, S, $Si(Z_{33})(Z_{34})$, $C(Z_{33})(Z_{34})$, or Se,
$Z_{31}$ to $Z_{34}$ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, or a $C_1$-$C_{60}$ heteroaryl group,
e3 is an integer from 1 to 3,
e4 is an integer from 1 to 4,
e6 is an integer from 1 to 6,
e8 is an integer from 1 to 8, and
* and *' each indicate a binding site to a neighboring atom.

**7.** The polycyclic compound of any of claims 1-6, wherein $R_1$, $R_2$, $R_3$, $R_4$, $R_5$, and $R_6$ are each independently:

a group represented by Formula 1-1;

hydrogen, deuterium, -F, -Cl, -Br, -I, a hydroxyl group, a cyano group (CN), a nitro group, an amino group, a $C_1$-$C_{60}$ alkyl group, or a $C_1$-$C_{60}$ alkoxy group;

a $C_1$-$C_{60}$ alkyl group or a $C_1$-$C_{60}$ alkoxy group, each substituted with at least one of deuterium, -F, -Cl, -Br, -I, a hydroxyl group, a cyano group, a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group;

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group; or

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, each substituted with at least one of deuterium, -F, -Cl, -Br, -I, a hydroxyl group, a cyano group, a nitro group, an amino group, a $C_1$-$C_{60}$ alkyl group, a $C_7$-$C_{60}$ aryl alkyl group, $C_7$-$C_{60}$ alkyl aryl group, a $C_1$-$C_{60}$ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group.

**8.** The polycyclic compound of any of claims 1-7, wherein at least two of $R_1$ to $R_6$ are each independently a group represented by Formula 1-1; and/or
wherein $R_{11}$ to $R_{13}$ are each independently:

hydrogen, deuterium, -F, -Cl, -Br, -I, a hydroxyl group, a cyano group (CN), a nitro group, an amino group, a $C_1$-$C_{60}$ alkyl group, or a $C_1$-$C_{60}$ alkoxy group;

a $C_1$-$C_{60}$ alkyl group or a $C_1$-$C_{60}$ alkoxy group, each substituted with at least one of deuterium, -F, -Cl, -Br, -I, a hydroxyl group, a cyano group, a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group;

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl

group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group; or

a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group, each substituted with at least one of deuterium, -F, -Cl, -Br, -I, a hydroxyl group, a cyano group, a nitro group, an amino group, a $C_1$-$C_{60}$ alkyl group, a $C_1$-$C_{60}$ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, or a carbazolyl group.

**9.** The polycyclic compound of any of claims 1-8, wherein m11 is 1 or 2.

**10.** The polycyclic compound of any of claims 1-9, wherein Formula 1-2 is represented by one of Formulae 1-2a to 1-2c:

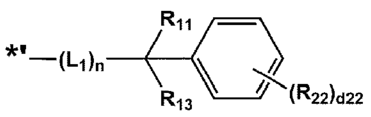

**1-2a**

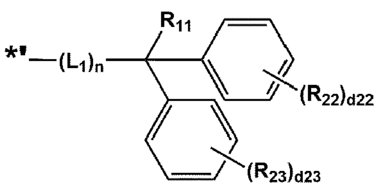

**1-2b**

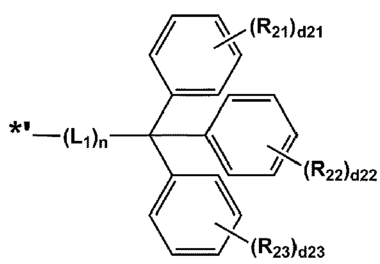

**1-2c**

wherein, in Formulae 1-2a to 1-2c,

$R_{11}$, $R_{13}$, $L_1$, and n are each the same as described in claim 1,
$R_{21}$ to $R_{23}$ are each independently:

hydrogen, deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-Si(Q_{21})(Q_{22})(Q_{23})$,$-N(Q_{24})(Q_{25})$ $-B(Q_{26})(Q_{27})$, or $-P(=O)(Q_{28})(Q_{29})$, and

d21 to d23 are each independently an integer from 1 to 5, wherein when d21 is an integer of 2 or more, two or more of $R_{21}$(S) are identical to or different from each other, when d22 is an integer of 2 or more, two or more of $R_{22}$(s) are identical to or different from each other, and when d23 is an integer of 2 or more, two or more of $R_{23}$(s) are identical to or different from each other;

preferably wherein, in Formulae 1-2a and 1-2b, $R_{11}$ and $R_{13}$ are each independently:

deuterium, -F, -Cl, -Br, -I, a hydroxyl group, a cyano group, a nitro group, an amino group, a $C_1$-$C_{60}$ alkyl group, or a $C_1$-$C_{60}$ alkoxy group; or
a $C_1$-$C_{60}$ alkyl group or a $C_1$-$C_{60}$ alkoxy group, each substituted with at least one of deuterium, -F, -Cl, -Br, -I, a hydroxyl group, a cyano group, a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, or a chrysenyl group,

**11.** The polycyclic compound of any of claims 1-10, wherein Formula 1 is represented by Formula 2:

Formula 2

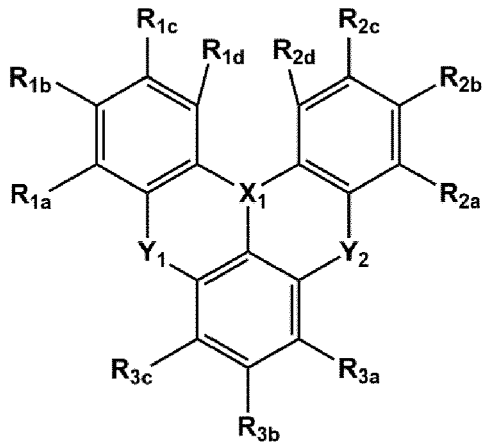

wherein, in Formula 2,

$X_1$, $Y_1$, and $Y_2$ are the same as described in claim 1,
$R_{1a}$ to $R_{1d}$ are each the same as described in connection with $R_1$ in claim 1, $R_{2a}$ to $R_{2d}$ are each the same as described in connection with $R_2$ in claim 1, and $R_{3a}$ to $R_{3c}$ are each the same as described in connection with $R_3$ in claim 1, and

wherein:

(i) one of $R_{1a}$ to $R_{1d}$ is a group represented by Formula 1-1; one of $R_{2a}$ to $R_{2d}$ is a group represented by Formula 1-1; or one of $R_{3a}$ to $R_{3c}$ is a group represented by Formula 1-1,
(ii) two of $R_{1a}$ to $R_{1d}$ are each a group represented by Formula 1-1, two of $R_{2a}$ to $R_{2d}$ are each a group represented by Formula 1-1, or two of $R_{3a}$ to $R_{3c}$ are each a group represented by Formula 1-1,
(iii) three of $R_{1a}$ to $R_{1d}$ are each a group represented by Formula 1-1; three of $R_{2a}$ to $R_{2d}$ are each a group represented by Formula 1-1; or $R_{3a}$ to $R_{3c}$ are each a group represented by Formula 1-1,
(iv) each of $R_{1a}$ to $R_{1d}$ is a group represented by Formula 1-1; or each of $R_{2a}$ to $R_{2d}$ is a group represented by Formula 1-1,
(v) one of $R_{1a}$ to $R_{1d}$ is a group represented by Formula 1-1 and one of $R_{2a}$ to $R_{2d}$ is a group represented by Formula 1-1; one of $R_{1a}$ to $R_{1d}$ is a group represented by Formula 1-1 and one of $R_{3a}$ to $R_{3c}$ is a group represented by Formula 1-1; or one of $R_{2a}$ to $R_{2d}$ is a group represented by Formula 1-1 and one of $R_{3a}$ to $R_{3c}$ is a group represented by Formula 1-1;
(vi) two of $R_{1a}$ to $R_{1d}$ are each a group represented by Formula 1-1 and one of $R_{2a}$ to $R_{2d}$ is a group represented by Formula 1-1; two of $R_{1a}$ to $R_{1d}$ are each a group represented by Formula 1-1 and one of $R_{3a}$ to $R_{3c}$ is a

group represented by Formula 1-1; two of $R_{2a}$ to $R_{2d}$ are each a group represented by Formula 1-1 and one of $R_{1a}$ to $R_{1d}$ is a group represented by Formula 1-1; two of $R_{2a}$ to $R_{2d}$ are each a group represented by Formula 1-1 and one of $R_{3a}$ to $R_{3c}$ is a group represented by Formula 1-1; two of $R_{3a}$ to $R_{3c}$ are each a group represented by Formula 1-1 and one of $R_{1a}$ to $R_{1d}$ is a group represented by Formula 1-1; two of $R_{3a}$ to $R_{3c}$ are each a group represented by Formula 1-1 and one of $R_{2a}$ to $R_{2d}$ is a group represented by Formula 1-1; or one of $R_{1a}$ to $R_{1d}$ is a group represented by Formula 1-1, one of $R_{2a}$ to $R_{2d}$ is a group represented by Formula 1-1, and one of $R_{3a}$ to $R_{3c}$ is a group represented by Formula 1-1;

(vii) two of $R_{1a}$ to $R_{1d}$ are each a group represented by Formula 1-1 and two of $R_{2a}$ to $R_{2d}$ are each a group represented by Formula 1-1; two of $R_{1a}$ to $R_{1d}$ are each a group represented by Formula 1-1 and two of $R_{3a}$ to $R_{3c}$ are each a group represented by Formula 1-1; two of $R_{2a}$ to $R_{2d}$ are each a group represented by Formula 1-1 and two of $R_{3a}$ to $R_{3c}$ are each a group represented by Formula 1-1; two of $R_{1a}$ to $R_{1d}$ are each a group represented by Formula 1-1; one of $R_{2a}$ to $R_{2d}$ is a group represented by Formula 1-1 and one of $R_{3a}$ to $R_{3c}$ is a group represented by Formula 1-1; two of $R_{2a}$ to $R_{2d}$ are each a group represented by Formula 1-1; one of $R_{1a}$ to $R_{1d}$ is a group represented by Formula 1-1 and one of $R_{3a}$ to $R_{3c}$ is a group represented by Formula 1-1; two of $R_{3a}$ to $R_{3c}$ are each a group represented by Formula 1-1, one of $R_{1a}$ to $R_{1d}$ is a group represented by Formula 1-1, and one of $R_{2a}$ to $R_{2d}$ is a group represented by Formula 1-1; three of $R_{1a}$ to $R_{1d}$ are each a group represented by Formula 1-1 and one of $R_{2a}$ to $R_{2d}$ is a group represented by Formula 1-1; three of $R_{2a}$ to $R_{2d}$ are each a group represented by Formula 1-1 and one of $R_{1a}$ to $R_{1d}$ is a group represented by Formula 1-1, three of $R_{1a}$ to $R_{1d}$ are each a group represented by Formula 1-1 and one of $R_{3a}$ to $R_{3c}$ is a group represented by Formula 1-1; three of $R_{2a}$ to $R_{2d}$ are each a group represented by Formula 1-1 and one of $R_{3a}$ to $R_{3c}$ is a group represented by Formula 1-1; $R_{3a}$ to $R_{3c}$ are each a group represented by Formula 1-1 and one of $R_{1a}$ to $R_{1d}$ is a group represented by Formula 1-1; or $R_{3a}$ to $R_{3c}$ are each a group represented by Formula 1-1 and one of $R_{2a}$ to $R_{2d}$ is a group represented by Formula 1-1;

(viii) $R_{1a}$ to $R_{1d}$ are each a group represented by Formula 1-1 and one of $R_{2a}$ to $R_{2d}$ is a group represented by Formula 1-1; $R_{1a}$ to $R_{1d}$ are each a group represented by Formula 1-1 and one of $R_{3a}$ to $R_{3c}$ is a group represented by Formula 1-1; three of $R_{1a}$ to $R_{1d}$ are each a group represented by Formula 1-1, one of $R_{2a}$ to $R_{2d}$ is a group represented by Formula 1-1, and one of $R_{3a}$ to $R_{3c}$ is a group represented by Formula 1-1; three of $R_{1a}$ to $R_{1d}$ are each a group represented by Formula 1-1 and two of $R_{2a}$ to $R_{2d}$ are each a group represented by Formula 1-1; three of $R_{1a}$ to $R_{1d}$ are each a group represented by Formula 1-1 and two of $R_{3a}$ to $R_{3c}$ are each a group represented by Formula 1-1; two of $R_{1a}$ to $R_{1d}$ are each a group represented by Formula 1-1 and three of $R_{2a}$ to $R_{2d}$ are each a group represented by Formula 1-1; two of $R_{1a}$ to $R_{1d}$ are each a group represented by Formula 1-1, two of $R_{2a}$ to $R_{2d}$ are each a group represented by Formula 1-1, and one of $R_{3a}$ to $R_{3c}$ is a group represented by Formula 1-1; two of $R_{1a}$ to $R_{1d}$ are each a group represented by Formula 1-1, one of $R_{2a}$ to $R_{2d}$ is a group represented by Formula 1-1, and two of $R_{3a}$ to $R_{3c}$ are each a group represented by Formula 1-1; two of $R_{1a}$ to $R_{1d}$ are each a group represented by Formula 1-1 and $R_{3a}$ to $R_{3c}$ are each a group represented by Formula 1-1; one of $R_{1a}$ to $R_{1d}$ is a group represented by Formula 1-1 and $R_{2a}$ to $R_{2d}$ are each a group represented by Formula 1-1; one of $R_{1a}$ to $R_{1d}$ is a group represented by Formula 1-1, three of $R_{2a}$ to $R_{2d}$ are each a group represented by Formula 1-1, and one of $R_{3a}$ to $R_{3c}$ is a group represented by Formula 1-1; one of $R_{1a}$ to $R_{1d}$ is a group represented by Formula 1-1, two of $R_{2a}$ to $R_{2d}$ are each a group represented by Formula 1-1, and two of $R_{3a}$ to $R_{3c}$ are each a group represented by Formula 1-1; one of $R_{1a}$ to $R_{1d}$ is a group represented by Formula 1-1, one of $R_{2a}$ to $R_{2d}$ is a group represented by Formula 1-1, and $R_{3a}$ to $R_{3c}$ are each a group represented by Formula 1-1; $R_{2a}$ to $R_{2d}$ are each a group represented by Formula 1-1 and one of $R_{3a}$ to $R_{3c}$ is a group represented by Formula 1-1, three of $R_{2a}$ to $R_{2d}$ are each a group represented by Formula 1-1, and two of $R_{3a}$ to $R_{3c}$ are each a group represented by Formula 1-1; or two of $R_{2a}$ to $R_{2d}$ are each a group represented by Formula 1-1 and $R_{3a}$ to $R_{3c}$ are each a group represented by Formula 1-1, or

(ix) $R_{1a}$ to $R_{1d}$ are each a group represented by Formula 1-1 and two of $R_{2a}$ to $R_{2d}$ are each a group represented by Formula 1-1; $R_{1a}$ to $R_{1d}$ are each a group represented by Formula 1-1, one of $R_{2a}$ to $R_{2d}$ is a group represented by Formula 1-1, and one of $R_{3a}$ to $R_{3c}$ is a group represented by Formula 1-1; $R_{1a}$ to $R_{1d}$ are each a group represented by Formula 1-1 and two of $R_{3a}$ to $R_{3c}$ are each a group represented by Formula 1-1; three of $R_{1a}$ to $R_{1d}$ are each a group represented by Formula 1-1 and three of $R_{2a}$ to $R_{2d}$ are each a group represented by Formula 1-1; three of $R_{1a}$ to $R_{1d}$ are each a group represented by Formula 1-1, two of $R_{2a}$ to $R_{2d}$ are each a group represented by Formula 1-1, and one of $R_{3a}$ to $R_{3c}$ is a group represented by Formula 1-1; three of $R_{1a}$ to $R_{1d}$ are each a group represented by Formula 1-1, one of $R_{2a}$ to $R_{2d}$ is a group represented by Formula 1-1, and two of $R_{3a}$ to $R_{3c}$ are each a group represented by Formula 1-1; three of $R_{1a}$ to $R_{1d}$ are each a group represented by Formula 1-1 and $R_{3a}$ to $R_{3c}$ are each a group represented by Formula 1-1; two of $R_{1a}$ to $R_{1d}$ are each a group represented by Formula 1-1 and $R_{2a}$ to $R_{2d}$ are each a group represented by Formula 1-1; two of $R_{1a}$ to $R_{1d}$ are each a group represented by Formula 1-1, three of $R_{2a}$ to $R_{2d}$ are each a group represented by Formula 1-1, and one of $R_{3a}$ to $R_{3c}$ is a group represented by Formula 1-1; two of $R_{1a}$ to $R_{1d}$ are each a

group represented by Formula 1-1, two of $R_{2a}$ to $R_{2d}$ are each a group represented by Formula 1-1, and two of $R_{3a}$ to $R_{3c}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and $R_{3a}$ to $R_{3c}$ are each a group represented by Formula 1-1; one of $R_{1a}$ to $R_{1d}$ is a group represented by Formula 1-1, $R_{2a}$ to $R_{2d}$ are each a group represented by Formula 1-1, and one of $R_{3a}$ to $R_{3c}$ is a group represented by Formula 1-1; one of $R_{1a}$ to $R_{1d}$ is a group represented by Formula 1-1, three of $R_{2a}$ to $R_{2d}$ are each a group represented by Formula 1-1, and two of $R_{3a}$ to $R_{3c}$ are each a group represented by Formula 1-1; one of $R_{1a}$ to $R_{1d}$ is a group represented by Formula 1-1, two of $R_{2a}$ to $R_{2d}$ are each a group represented by Formula 1-1, and $R_{3a}$ to $R_{3c}$ are each a group represented by Formula 1-1; $R_{2a}$ to $R_{2d}$ are each a group represented by Formula 1-1 and two of $R_{3a}$ to $R_{3c}$ are each a group represented by Formula 1-1; or three of $R_{2a}$ to $R_{2d}$ are each a group represented by Formula 1-1 and $R_{3a}$ to $R_{3c}$ are each a group represented by Formula 1-1.

**12.** The polycyclic compound of any of claims 1-11, wherein Formula 1 is represented by Formula 2A:

Formula 2A

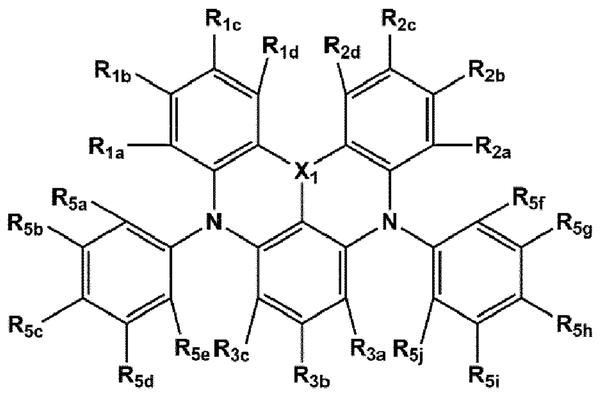

wherein, in Formula 2A,

$X_1$ is the same as described in claim 1,
$R_{1a}$ to $R_{1d}$ are each the same as described in connection with $R_1$ in claim 1,
$R_{2a}$ to $R_{2d}$ are each the same as described in connection with $R_2$ in claim 1, and
$R_{3a}$ to $R_{3c}$ are each the same as described in connection with $R_3$ in claim 1, and $R_{5a}$ to $R_{5j}$ are each the same as described in connection with $R_5$ in claim 1, and

wherein:

(i) one of $R_{1a}$ to $R_{1d}$ is a group represented by Formula 1-1; one of $R_{2a}$ to $R_{2d}$ is a group represented by Formula 1-1; one of $R_{3a}$ to $R_{3c}$ is a group represented by Formula 1-1; one of $R_{5a}$ to Rse is a group represented by Formula 1-1; or one of $R_{5f}$ to $R_{5j}$ is a group represented by Formula 1-1,
(ii) two of $R_{1a}$ to $R_{1d}$ are each a group represented by Formula 1-1; two of $R_{2a}$ to $R_{2d}$ are each a group represented by Formula 1-1; two of $R_{3a}$ to $R_{3c}$ are each a group represented by Formula 1-1; two of $R_{5a}$ to Rse are each a group represented by Formula 1-1; or two of $R_{5f}$ to $R_{5j}$ are each a group represented by Formula 1-1;
(iii) three of $R_{1a}$ to $R_{1d}$ are each a group represented by Formula 1-1; three of $R_{2a}$ to $R_{2d}$ are each a group represented by Formula 1-1; each of $R_{3a}$ to $R_{3c}$ is a group represented by Formula 1-1; three of $R_{5a}$ to Rse are each a group represented by Formula 1-1; or three of $R_{5f}$ to $R_{5j}$ are each a group represented by Formula 1-1;
(iv) each of $R_{1a}$ to $R_{1d}$ is a group represented by Formula 1-1; each of $R_{2a}$ to $R_{2d}$ is a group represented by Formula 1-1; four of $R_{5a}$ to Rse are each a group represented by Formula 1-1; or four of $R_{5f}$ to $R_{5j}$ are each a group represented by Formula 1-1;
(v) each of $R_{5a}$ to Rse is a group represented by Formula 1-1; or each of $R_{5f}$ to $R_{5j}$ is a group represented by Formula 1-1;
(vi) one of $R_{1a}$ to $R_{1d}$ is a group represented by Formula 1-1 and one of $R_{2a}$ to $R_{2d}$ is a group represented by Formula 1-1; one of $R_{1a}$ to $R_{1d}$ is a group represented by Formula 1-1 and one of $R_{3a}$ to $R_{3c}$ is a group represented

by Formula 1-1; one of $R_{1a}$ to $R_{1d}$ is a group represented by Formula 1-1 and one of $R_{5a}$ to Rse is a group represented by Formula 1-1; one of $R_{1a}$ to $R_{1d}$ is a group represented by Formula 1-1 and one of $R_{5f}$ to $R_{5j}$ is a group represented by Formula 1-1; one of $R_{2a}$ to $R_{2d}$ is a group represented by Formula 1-1 and one of $R_{3a}$ to $R_{3c}$ is a group represented by Formula 1-1; one of $R_{2a}$ to $R_{2d}$ is a group represented by Formula 1-1 and one of $R_{5a}$ to Rse is a group represented by Formula 1-1; one of $R_{2a}$ to $R_{2d}$ is a group represented by Formula 1-1 and one of $R_{5f}$ to $R_{5j}$ is a group represented by Formula 1-1; one of $R_{3a}$ to $R_{3c}$ is a group represented by Formula 1-1 and one of $R_{5a}$ to Rse is a group represented by Formula 1-1; one of $R_{3a}$ to $R_{3c}$ is a group represented by Formula 1-1 and one of $R_{5f}$ to $R_{5j}$ is a group represented by Formula 1-1; one of $R_{5a}$ to Rse is a group represented by Formula 1-1 and one of $R_{5f}$ to $R_{5j}$ is a group represented by Formula 1-1;

(vii) two of $R_{1a}$ to $R_{1d}$ are each a group represented by Formula 1-1 and one of $R_{2a}$ to $R_{2d}$ is a group represented by Formula 1-1; two of $R_{1a}$ to $R_{1d}$ are each a group represented by Formula 1-1 and one of $R_{3a}$ to $R_{3c}$ is a group represented by Formula 1-1; two of $R_{1a}$ to $R_{1d}$ are each a group represented by Formula 1-1 and one of $R_{5a}$ to Rse is a group represented by Formula 1-1; two of $R_{1a}$ to $R_{1d}$ are each a group represented by Formula 1-1 and one of $R_{5f}$ to $R_{5j}$ is a group represented by Formula 1-1; two of $R_{2a}$ to $R_{2d}$ are each a group represented by Formula 1-1 and one of $R_{1a}$ to $R_{1d}$ is a group represented by Formula 1-1; two of $R_{2a}$ to $R_{2d}$ are each a group represented by Formula 1-1 and one of $R_{3a}$ to $R_{3c}$ is a group represented by Formula 1-1; two of $R_{2a}$ to $R_{2d}$ are each a group represented by Formula 1-1 and one of $R_{5a}$ to Rse is a group represented by Formula 1-1; two of $R_{2a}$ to $R_{2d}$ are each a group represented by Formula 1-1 and one of $R_{5f}$ to $R_{5j}$ is a group represented by Formula 1-1; two of $R_{3a}$ to $R_{3c}$ are each a group represented by Formula 1-1 and one of $R_{1a}$ to $R_{1d}$ is a group represented by Formula 1-1; two of $R_{3a}$ to $R_{3c}$ are each a group represented by Formula 1-1 and one of $R_{2a}$ to $R_{2d}$ is a group represented by Formula 1-1; two of $R_{3a}$ to $R_{3c}$ are each a group represented by Formula 1-1 and one of $R_{5a}$ to Rse is a group represented by Formula 1-1; two of $R_{3a}$ to $R_{3c}$ are each a group represented by Formula 1-1 and one of $R_{5f}$ to $R_{5j}$ is a group represented by Formula 1-1; two of $R_{5a}$ to Rse are each a group represented by Formula 1-1 and one of $R_{1a}$ to $R_{1d}$ is a group represented by Formula 1-1; two of $R_{5a}$ to Rse are each a group represented by Formula 1-1 and one of $R_{2a}$ to $R_{2d}$ is a group represented by Formula 1-1; two of $R_{5a}$ to Rse are each a group represented by Formula 1-1 and one of $R_{3a}$ to $R_{3c}$ is a group represented by Formula 1-1; two of $R_{5a}$ to Rse are each a group represented by Formula 1-1 and one of $R_{5f}$ to $R_{5j}$ is a group represented by Formula 1-1; two of $R_{5f}$ to $R_{5j}$ are each a group represented by Formula 1-1 and one of $R_{1a}$ to $R_{1d}$ is a group represented by Formula 1-1; two of $R_{5f}$ to $R_{5j}$ are each a group represented by Formula 1-1 and one of $R_{2a}$ to $R_{2d}$ is a group represented by Formula 1-1; two of $R_{5f}$ to $R_{5j}$ are each a group represented by Formula 1-1 and one of $R_{3a}$ to $R_{3c}$ is a group represented by Formula 1-1; two of $R_{5f}$ to $R_{5j}$ are each a group represented by Formula 1-1 and one of $R_{5a}$ to Rse is a group represented by Formula 1-1; one of $R_{1a}$ to $R_{1d}$ is a group represented by Formula 1-1, one of $R_{2a}$ to $R_{2d}$ is a group represented by Formula 1-1, and one of $R_{3a}$ to $R_{3c}$ is a group represented by Formula 1-1; one of $R_{1a}$ to $R_{1d}$ is a group represented by Formula 1-1; one of $R_{2a}$ to $R_{2d}$ is a group represented by Formula 1-1 and one of $R_{5a}$ to Rse is a group represented by Formula 1-1; one of $R_{1a}$ to $R_{1d}$ is a group represented by Formula 1-1, one of $R_{2a}$ to $R_{2d}$ is a group represented by Formula 1-1, and one of $R_{5f}$ to $R_{5j}$ is a group represented by Formula 1-1; one of $R_{1a}$ to $R_{1d}$ is a group represented by Formula 1-1, one of $R_{3a}$ to $R_{3c}$ is a group represented by Formula 1-1, and one of $R_{5a}$ to Rse is a group represented by Formula 1-1; one of $R_{1a}$ to $R_{1d}$ is a group represented by Formula 1-1, one of $R_{3a}$ to $R_{3c}$ is a group represented by Formula 1-1, and one of $R_{5f}$ to $R_{5j}$ is a group represented by Formula 1-1; one of $R_{1a}$ to $R_{1d}$ is a group represented by Formula 1-1, one of $R_{5a}$ to Rse is a group represented by Formula 1-1, and one of $R_{5f}$ to $R_{5j}$ is a group represented by Formula 1-1; one of $R_{2a}$ to $R_{2d}$ is a group represented by Formula 1-1, one of $R_{3a}$ to $R_{3c}$ is a group represented by Formula 1-1, and one of $R_{5a}$ to Rse is a group represented by Formula 1-1; one of $R_{2a}$ to $R_{2d}$ is a group represented by Formula 1-1, one of $R_{3a}$ to $R_{3c}$ is a group represented by Formula 1-1, and one of $R_{5f}$ to $R_{5j}$ is a group represented by Formula 1-1; one of $R_{2a}$ to $R_{2d}$ is a group represented by Formula 1-1, one of $R_{5a}$ to Rse is a group represented by Formula 1-1, and one of $R_{5f}$ to $R_{5j}$ is a group represented by Formula 1-1; or one of $R_{3a}$ to $R_{3c}$ is a group represented by Formula 1-1, one of $R_{5a}$ to Rse is a group represented by Formula 1-1, and one of $R_{5f}$ to $R_{5j}$ is a group represented by Formula 1-1;

(viii) two of $R_{1a}$ to $R_{1d}$ are each a group represented by Formula 1-1 and two of $R_{2a}$ to $R_{2d}$ are each a group represented by Formula 1-1; two of $R_{1a}$ to $R_{1d}$ are each a group represented by Formula 1-1 and two of $R_{3a}$ to $R_{3c}$ are each a group represented by Formula 1-1; two of $R_{1a}$ to $R_{1d}$ are each a group represented by Formula 1-1 and two of $R_{5a}$ to Rse are each a group represented by Formula 1-1; two of $R_{1a}$ to $R_{1d}$ are each a group represented by Formula 1-1 and two of $R_{5f}$ to $R_{5j}$ are each a group represented by Formula 1-1; two of $R_{2a}$ to $R_{2d}$ are each a group represented by Formula 1-1 and two of $R_{3a}$ to $R_{3c}$ are each a group represented by Formula 1-1; two of $R_{2a}$ to $R_{2d}$ are each a group represented by Formula 1-1 and two of $R_{5a}$ to Rse are each a group represented by Formula 1-1; two of $R_{2a}$ to $R_{2d}$ are each a group represented by Formula 1-1 and two of $R_{5f}$ to $R_{5j}$ are each a group represented by Formula 1-1; two of $R_{3a}$ to $R_{3c}$ are each a group represented by Formula 1-1 and two of $R_{5a}$ to Rse are each a group represented by Formula 1-1; two of $R_{3a}$ to $R_{3c}$ are each

a group represented by Formula 1-1 and two of $R_{5f}$ to $R_{5j}$ are each a group represented by Formula 1-1; two of $R_{5a}$ to Rse are each a group represented by Formula 1-1 and two of $R_{5f}$ to $R_{5j}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and one of $R_{3a}$ to $R_{3c}$ is a group represented by Formula 1-1; two of $R_{1a}$ to $R_{1d}$ are each a group represented by Formula 1-1, one of $R_{2a}$ to $R_{2d}$ is a group represented by Formula 1-1, and one of $R_{5a}$ to Rse is a group represented by Formula 1-1; two of $R_{1a}$ to $R_{1d}$ are each a group represented by Formula 1-1, one of $R_{2a}$ to $R_{2d}$ is a group represented by Formula 1-1, and one of $R_{5f}$ to $R_{5j}$ is a group represented by Formula 1-1; two of $R_{1a}$ to $R_{1d}$ are each a group represented by Formula 1-1, one of $R_{3a}$ to $R_{3c}$ is a group represented by Formula 1-1, and one of $R_{5a}$ to Rse is a group represented by Formula 1-1; two of $R_{1a}$ to $R_{1d}$ are each a group represented by Formula 1-1, one of $R_{3a}$ to $R_{3c}$ is a group represented by Formula 1-1, and one of $R_{5f}$ to $R_{5j}$ is a group represented by Formula 1-1; two of $R_{1a}$ to $R_{1d}$ are each a group represented by Formula 1-1, one of $R_{5a}$ to Rse is a group represented by Formula 1-1, and one of $R_{5f}$ to $R_{5j}$ is a group represented by Formula 1-1; two of $R_{2a}$ to $R_{2d}$ are each a group represented by Formula 1-1, one of $R_{1a}$ to $R_{1d}$ is a group represented by Formula 1-1, and one of $R_{3a}$ to $R_{3c}$ is a group represented by Formula 1-1; two of $R_{2a}$ to $R_{2d}$ are each a group represented by Formula 1-1, one of $R_{1a}$ to $R_{1d}$ is a group represented by Formula 1-1, and one of $R_{5a}$ to $R_{5e}$ is a group represented by Formula 1-1; two of $R_{2a}$ to $R_{2d}$ are each a group represented by Formula 1-1, one of $R_{1a}$ to $R_{1d}$ is a group represented by Formula 1-1, and one of $R_{5f}$ to $R_{5j}$ is a group represented by Formula 1-1; two of $R_{2a}$ to $R_{2d}$ are each a group represented by Formula 1-1, one of $R_{3a}$ to $R_{3c}$ is a group represented by Formula 1-1, and one of $R_{5a}$ to $R_{5e}$ is a group represented by Formula 1-1; two of $R_{2a}$ to $R_{2d}$ are each a group represented by Formula 1-1, one of $R_{3a}$ to $R_{3c}$ is a group represented by Formula 1-1, and one of $R_{5f}$ to $R_{5j}$ is a group represented by Formula 1-1; two of $R_{2a}$ to $R_{2d}$ are each a group represented by Formula 1-1, one of $R_{5a}$ to $R_{5e}$ is a group represented by Formula 1-1, and one of $R_{5f}$ to $R_{5j}$ is a group represented by Formula 1-1; two of $R_{3a}$ to $R_{3c}$ are each a group represented by Formula 1-1, one of $R_{1a}$ to $R_{1d}$ is a group represented by Formula 1-1, and one of $R_{2a}$ to $R_{2d}$ is a group represented by Formula 1-1; two of $R_{3a}$ to $R_{3c}$ are each a group represented by Formula 1-1, one of $R_{1a}$ to $R_{1d}$ is a group represented by Formula 1-1, and one of $R_{5a}$ to $R_{5e}$ is a group represented by Formula 1-1; two of $R_{3a}$ to $R_{3c}$ are each a group represented by Formula 1-1, one of $R_{1a}$ to $R_{1d}$ is a group represented by Formula 1-1, and one of $R_{5f}$ to $R_{5j}$ is a group represented by Formula 1-1; two of $R_{3a}$ to $R_{3c}$ are each a group represented by Formula 1-1, one of $R_{2a}$ to $R_{2d}$ is a group represented by Formula 1-1, and one of $R_{5a}$ to $R_{5e}$ is a group represented by Formula 1-1; two of $R_{3a}$ to $R_{3c}$ are each a group represented by Formula 1-1, one of $R_{2a}$ to $R_{2d}$ is a group represented by Formula 1-1, and one of $R_{5f}$ to $R_{5j}$ is a group represented by Formula 1-1; two of $R_{3a}$ to $R_{3c}$ are each a group represented by Formula 1-1, one of $R_{5a}$ to $R_{5e}$ is a group represented by Formula 1-1, and one of $R_{5f}$ to $R_{5j}$ is a group represented by Formula 1-1; two of $R_{5a}$ to $R_{5e}$ are each a group represented by Formula 1-1, one of $R_{1a}$ to $R_{1d}$ is a group represented by Formula 1-1, and one of $R_{2a}$ to $R_{2d}$ is a group represented by Formula 1-1; two of $R_{5a}$ to $R_{5e}$ are each a group represented by Formula 1-1, one of $R_{1a}$ to $R_{1d}$ is a group represented by Formula 1-1, and one of $R_{3a}$ to $R_{3c}$ is a group represented by Formula 1-1; two of $R_{5a}$ to $R_{5e}$ are each a group represented by Formula 1-1, one of $R_{1a}$ to $R_{1d}$ is a group represented by Formula 1-1, and one of $R_{5f}$ to $R_{5j}$ is a group represented by Formula 1-1; two of $R_{5a}$ to $R_{5e}$ are each a group represented by Formula 1-1, one of $R_{2a}$ to $R_{2d}$ is a group represented by Formula 1-1, and one of $R_{3a}$ to $R_{3c}$ is a group represented by Formula 1-1; two of $R_{5a}$ to $R_{5e}$ are each a group represented by Formula 1-1, one of $R_{2a}$ to $R_{2d}$ is a group represented by Formula 1-1, and one of $R_{5f}$ to $R_{5j}$ is a group represented by Formula 1-1; two of $R_{5a}$ to Rse are each a group represented by Formula 1-1, one of $R_{3a}$ to $R_{3c}$ is a group represented by Formula 1-1, and one of $R_{5f}$ to $R_{5j}$ is a group represented by Formula 1-1; two of $R_{5f}$ to $R_{5j}$ are each a group represented by Formula 1-1, one of $R_{1a}$ to $R_{1d}$ is a group represented by Formula 1-1, and one of $R_{2a}$ to $R_{2d}$ is a group represented by Formula 1-1; two of $R_{5f}$ to $R_{5j}$ are each a group represented by Formula 1-1, one of $R_{1a}$ to $R_{1d}$ is a group represented by Formula 1-1, and one of $R_{3a}$ to $R_{3c}$ is a group represented by Formula 1-1; two of $R_{5f}$ to $R_{5j}$ are each a group represented by Formula 1-1, one of $R_{1a}$ to $R_{1d}$ is a group represented by Formula 1-1, and one of $R_{5a}$ to Rse is a group represented by Formula 1-1; two of $R_{5f}$ to $R_{5j}$ are each a group represented by Formula 1-1, one of $R_{2a}$ to $R_{2d}$ is a group represented by Formula 1-1, and one of $R_{3a}$ to $R_{3c}$ is a group represented by Formula 1-1; two of $R_{5f}$ to $R_{5j}$ are each a group represented by Formula 1-1, one of $R_{2a}$ to $R_{2d}$ is a group represented by Formula 1-1, and one of $R_{5a}$ to Rse is a group represented by Formula 1-1; two of $R_{5f}$ to $R_{5j}$ are each a group represented by Formula 1-1, one of $R_{3a}$ to $R_{3c}$ is a group represented by Formula 1-1, and one of $R_{5a}$ to Rse is a group represented by Formula 1-1; three of $R_{1a}$ to $R_{1d}$ are each a group represented by Formula 1-1, and one of $R_{2a}$ to $R_{2d}$ is a group represented by Formula 1-1; three of $R_{1a}$ to $R_{1d}$ are each a group represented by Formula 1-1, and one of $R_{5a}$ to Rse is a group represented by Formula 1-1; three of $R_{1a}$ to $R_{1d}$ are each a group represented by Formula 1-1, and one of $R_{5f}$ to $R_{5j}$ is a group represented by Formula 1-1; three of $R_{2a}$ to $R_{2d}$ are each a group represented by Formula 1-1 and one of $R_{1a}$ to $R_{1d}$ is a group represented by Formula 1-1; three of $R_{2a}$ to $R_{2d}$ are each a group represented by Formula 1-1 and one of $R_{5a}$ to Rse is a group represented by Formula 1-1; three of $R_{2a}$

to $R_{2d}$ are each a group represented by Formula 1-1 and one of $R_{5f}$ to $R_{5j}$ is a group represented by Formula 1-1; three of $R_{1a}$ to $R_{1d}$ are each a group represented by Formula 1-1 and one of $R_{3a}$ to $R_{3c}$ is a group represented by Formula 1-1; three of $R_{2a}$ to $R_{2d}$ are each a group represented by Formula 1-1 and one of $R_{3a}$ to $R_{3c}$ is a group represented by Formula 1-1; $R_{3a}$ to $R_{3c}$ are each a group represented by Formula 1-1 and one of $R_{1a}$ to $R_{1d}$ is a group represented by Formula 1-1; $R_{3a}$ to $R_{3c}$ are each a group represented by Formula 1-1 and one of $R_{5a}$ to Rse is a group represented by Formula 1-1; $R_{3a}$ to $R_{3c}$ are each a group represented by Formula 1-1 and one of $R_{5f}$ to $R_{5j}$ is a group represented by Formula 1-1; $R_{3a}$ to $R_{3c}$ are each a group represented by Formula 1-1 and one of $R_{2a}$ to $R_{2d}$ is a group represented by Formula 1-1, three of $R_{5a}$ to $R_{5d}$ are each a group represented by Formula 1-1, and one of $R_{1a}$ to $R_{1d}$ is a group represented by Formula 1-1; three of $R_{5a}$ to $R_{5d}$ are each a group represented by Formula 1-1, and one of $R_{2a}$ to $R_{2d}$ is a group represented by Formula 1-1; three of $R_{5a}$ to $R_{5d}$ are each a group represented by Formula 1-1, and one of $R_{3a}$ to $R_{3c}$ is a group represented by Formula 1-1; or three of $R_{5a}$ to $R_{5d}$ are each a group represented by Formula 1-1, and one of $R_{5f}$ to $R_{5j}$ is a group represented by Formula 1-1;

(ix) $R_{1a}$ to $R_{1d}$ are each a group represented by Formula 1-1 and one of $R_{2a}$ to $R_{2d}$ is a group represented by Formula 1-1; $R_{1a}$ to $R_{1d}$ are each a group represented by Formula 1-1 and one of $R_{3a}$ to $R_{3c}$ is a group represented by Formula 1-1; $R_{1a}$ to $R_{1d}$ are each a group represented by Formula 1-1 and one of $R_{5a}$ to Rse is a group represented by Formula 1-1; $R_{1a}$ to $R_{1d}$ are each a group represented by Formula 1-1 and one of $R_{5f}$ to $R_{5j}$ is a group represented by Formula 1-1; three of $R_{1a}$ to $R_{1d}$ are each a group represented by Formula 1-1, one of $R_{2a}$ to $R_{2d}$ is a group represented by Formula 1-1, and one of $R_{3a}$ to $R_{3c}$ is a group represented by Formula 1-1; three of $R_{1a}$ to $R_{1d}$ are each a group represented by Formula 1-1, one of $R_{2a}$ to $R_{2d}$ is a group represented by Formula 1-1, and one of $R_{5a}$ to Rse is a group represented by Formula 1-1; three of $R_{1a}$ to $R_{1d}$ are each a group represented by Formula 1-1, one of $R_{2a}$ to $R_{2d}$ is a group represented by Formula 1-1, and one of $R_{5f}$ to $R_{5j}$ is a group represented by Formula 1-1; three of $R_{1a}$ to $R_{1d}$ are each a group represented by Formula 1-1, one of $R_{3a}$ to $R_{3c}$ is a group represented by Formula 1-1, and one of $R_{5a}$ to Rse is a group represented by Formula 1-1; three of $R_{1a}$ to $R_{1d}$ are each a group represented by Formula 1-1, one of $R_{3a}$ to $R_{3c}$ is a group represented by Formula 1-1, and one of $R_{5a}$ to Rse is a group represented by Formula 1-1; three of $R_{1a}$ to $R_{1d}$ are each a group represented by Formula 1-1, one of $R_{5a}$ to Rse is a group represented by Formula 1-1, and one of $R_{5f}$ to $R_{5j}$ is a group represented by Formula 1-1; three of $R_{1a}$ to $R_{1d}$ are each a group represented by Formula 1-1 and two of $R_{2a}$ to $R_{2d}$ are each a group represented by Formula 1-1; three of $R_{1a}$ to $R_{1d}$ are each a group represented by Formula 1-1 and two of $R_{3a}$ to $R_{3c}$ are each a group represented by Formula 1-1; three of $R_{1a}$ to $R_{1d}$ are each a group represented by Formula 1-1 and two of $R_{5a}$ to Rse are each a group represented by Formula 1-1; three of $R_{1a}$ to $R_{1d}$ are each a group represented by Formula 1-1 and two of $R_{5f}$ to $R_{5j}$ are each a group represented by Formula 1-1; two of $R_{1a}$ to $R_{1d}$ are each a group represented by Formula 1-1 and three of $R_{2a}$ to $R_{2d}$ are each a group represented by Formula 1-1; two of $R_{1a}$ to $R_{1d}$ are each a group represented by Formula 1-1, two of $R_{2a}$ to $R_{2d}$ are each a group represented by Formula 1-1, and one of $R_{3a}$ to $R_{3c}$ is a group represented by Formula 1-1; two of $R_{1a}$ to $R_{1d}$ are each a group represented by Formula 1-1, two of $R_{2a}$ to $R_{2d}$ are each a group represented by Formula 1-1, and one of $R_{5a}$ to Rse is a group represented by Formula 1-1; two of $R_{1a}$ to $R_{1d}$ are each a group represented by Formula 1-1, two of $R_{2a}$ to $R_{2d}$ are each a group represented by Formula 1-1, and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, and two of $R_{3a}$ to $R_{3c}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and two of $R_{5a}$ to Rse are each a group represented by Formula 1-1; two of $R_{1a}$ to $R_{1d}$ are each a group represented by Formula 1-1, one of $R_{2a}$ to $R_{2d}$ is a group represented by Formula 1-1, and two of $R_{5f}$ to $R_{5j}$ are each a group represented by Formula 1-1; two of $R_{1a}$ to $R_{1d}$ are each a group represented by Formula 1-1 and $R_{3a}$ to $R_{3c}$ are each a group represented by Formula 1-1; two of $R_{1a}$ to $R_{1d}$ are each a group represented by Formula 1-1 and three of $R_{5a}$ to Rse are each a group represented by Formula 1-1; two of $R_{1a}$ to $R_{1d}$ are each a group represented by Formula 1-1 and three of $R_{5f}$ to $R_{5j}$ are each a group represented by Formula 1-1; one of $R_{1a}$ to $R_{1d}$ is a group represented by Formula 1-1 and $R_{2a}$ to $R_{2d}$ are each a group represented by Formula 1-1; one of $R_{1a}$ to $R_{1d}$ is a group represented by Formula 1-1 and four of $R_{5a}$ to Rse are each a group represented by Formula 1-1; one of $R_{1a}$ to $R_{1d}$ is a group represented by Formula 1-1 and four of $R_{5f}$ to $R_{5j}$ are each a group represented by Formula 1-1; one of $R_{1a}$ to $R_{1d}$ is a group represented by Formula 1-1, three of $R_{2a}$ to $R_{2d}$ are each a group represented by Formula 1-1, and one of $R_{3a}$ to $R_{3c}$ is a group represented by Formula 1-1; one of $R_{1a}$ to $R_{1d}$ is a group represented by Formula 1-1, three of $R_{2a}$ to $R_{2d}$ are each a group represented by Formula 1-1, and one of $R_{5a}$ to Rse is a group represented by Formula 1-1; one of $R_{1a}$ to $R_{1d}$ is a group represented by Formula 1-1, three of $R_{2a}$ to $R_{2d}$ are each a group represented by Formula 1-1, and one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, and two of $R_{3a}$ to $R_{3c}$ are each a group represented by Formula 1-1; one of $R_{1a}$

to $R_{1d}$ is a group represented by Formula 1-1, two of $R_{2a}$ to $R_{2d}$ are each a group represented by Formula 1-1, and two of $R_{5a}$ to Rse are each a group represented by Formula 1-1; one of $R_{1a}$ to $R_{1d}$ is a group represented by Formula 1-1, two of $R_{2a}$ to $R_{2d}$ are each a group represented by Formula 1-1, and two of $R_{5f}$ to $R_{35j}$ are each a group represented by Formula 1-1; one of $R_{1a}$ to $R_{1d}$ is a group represented by Formula 1-1, one of $R_{2a}$ to $R_{2d}$ is a group represented by Formula 1-1, and $R_{3a}$ to $R_{3c}$ are each a group represented by Formula 1-1; one of $R_{1a}$ to $R_{1d}$ is a group represented by Formula 1-1, one of $R_{2a}$ to $R_{2d}$ is a group represented by Formula 1-1, and three of $R_{5a}$ to Rse are each a group represented by Formula 1-1; one of $R_{1a}$ to $R_{1d}$ is a group represented by Formula 1-1, one of $R_{2a}$ to $R_{2d}$ is a group represented by Formula 1-1, and three of $R_{5f}$ to $R_{5j}$ are each a group represented by Formula 1-1; $R_{2a}$ to $R_{2d}$ are each a group represented by Formula 1-1 and one of $R_{3a}$ to $R_{3c}$ is a group represented by Formula 1-1; $R_{2a}$ to $R_{2d}$ are each a group represented by Formula 1-1 and one of $R_{5a}$ to Rse is a group represented by Formula 1-1; $R_{2a}$ to $R_{2d}$ are each a group represented by Formula 1-1 and one of $R_{5f}$ to $R_{5j}$ is a group represented by Formula 1-1; three of $R_{2a}$ to $R_{2d}$ are each a group represented by Formula 1-1, and two of $R_{3a}$ to $R_{3c}$ are each a group represented by Formula 1-1; three of $R_{2a}$ to $R_{2d}$ are each a group represented by Formula 1-1, one of $R_{3a}$ to $R_{3c}$ is a group represented by Formula 1-1, and one of $R_{5a}$ to Rse is a group represented by Formula 1-1; three of $R_{2a}$ to $R_{2d}$ are each a group represented by Formula 1-1, one of $R_{3a}$ to $R_{3c}$ is a group represented by Formula 1-1, and one of $R_{5f}$ to $R_{5j}$ is a group represented by Formula 1-1; three of $R_{2a}$ to $R_{2d}$ are each a group represented by Formula 1-1, one of $R_{5a}$ to Rse is a group represented by Formula 1-1, and one of $R_{5f}$ to $R_{5j}$ is a group represented by Formula 1-1; three of $R_{2a}$ to $R_{2d}$ are each a group represented by Formula 1-1, and two of $R_{5a}$ to Rse are each a group represented by Formula 1-1; three of $R_{2a}$ to $R_{2d}$ are each a group represented by Formula 1-1, and two of $R_{5f}$ to $R_{5j}$ are each a group represented by Formula 1-1; two of $R_{2a}$ to $R_{2d}$ are each a group represented by Formula 1-1 and $R_{3a}$ to $R_{3c}$ are each a group represented by Formula 1-1; two of $R_{2a}$ to $R_{2d}$ are each a group represented by Formula 1-1, two of $R_{3a}$ to $R_{3c}$ are each a group represented by Formula 1-1 and one of $R_{5a}$ to Rse is a group represented by Formula 1-1; two of $R_{2a}$ to $R_{2d}$ are each a group represented by Formula 1-1, two of $R_{3a}$ to $R_{3c}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, one of $R_{3a}$ to $R_{3c}$ is a group represented by Formula 1-1 and two of $R_{5a}$ to Rse are each a group represented by Formula 1-1; two of $R_{2a}$ to $R_{2d}$ are each a group represented by Formula 1-1, one of $R_{3a}$ to $R_{3c}$ is a group represented by Formula 1-1 and two of $R_{5f}$ to $R_{5j}$ are each a group represented by Formula 1-1; two of $R_{2a}$ to $R_{2d}$ are each a group represented by Formula 1-1, one of $R_{3a}$ to $R_{3c}$ is a group represented by Formula 1-1, one of $R_{5a}$ to Rse is a group represented by Formula 1-1 and one of $R_{5f}$ to $R_{5j}$ is a group represented by Formula 1-1; two of $R_{2a}$ to $R_{2d}$ are each a group represented by Formula 1-1 and three of $R_{5a}$ to Rse are each a group represented by Formula 1-1; two of $R_{2a}$ to $R_{2d}$ are each a group represented by Formula 1-1, two of $R_{5a}$ to Rse are each a group represented by Formula 1-1 and one of $R_{5f}$ to $R_{5j}$ is a group represented by Formula 1-1; two of $R_{2a}$ to $R_{2d}$ are each a group represented by Formula 1-1, one of $R_{5a}$ to Rse is a group represented by Formula 1-1 and two of $R_{5f}$ to $R_{5j}$ are each a group represented by Formula 1-1; two of $R_{2a}$ to $R_{2d}$ are each a group represented by Formula 1-1 and three of $R_{5f}$ to $R_{5j}$ are each a group represented by Formula 1-1; one of $R_{2a}$ to $R_{2d}$ is a group represented by Formula 1-1, three of $R_{3a}$ to $R_{3c}$ are each a group represented by Formula 1-1 and one of $R_{5a}$ to Rse is a group represented by Formula 1-1; one of $R_{2a}$ to $R_{2d}$ is a group represented by Formula 1-1, three of $R_{3a}$ to $R_{3c}$ are each a group represented by Formula 1-1 and one of $R_{5f}$ to $R_{5j}$ are each a group represented by Formula 1-1; one of $R_{2a}$ to $R_{2d}$ is a group represented by Formula 1-1, two of $R_{3a}$ to $R_{3c}$ are each a group represented by Formula 1-1 and two of $R_{5a}$ to Rse are each a group represented by Formula 1-1; one of $R_{2a}$ to $R_{2d}$ is a group represented by Formula 1-1, two of $R_{3a}$ to $R_{3c}$ are each a group represented by Formula 1-1 and two of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1 and three of $R_{5a}$ to Rse are each a group represented by Formula 1-1; one of $R_{2a}$ to $R_{2d}$ is a group represented by Formula 1-1, one of $R_{3a}$ to $R_{3c}$ is a group represented by Formula 1-1 and three of $R_{5f}$ to $R_{5j}$ are each a group represented by Formula 1-1; one of $R_{2a}$ to $R_{2d}$ is a group represented by Formula 1-1 and four of $R_{5a}$ to Rse are each a group represented by Formula 1-1; one of $R_{2a}$ to $R_{2d}$ is a group represented by Formula 1-1 and four of $R_{5f}$ to $R_{5j}$ are each a group represented by Formula 1-1; one of $R_{2a}$ to $R_{2d}$ is a group represented by Formula 1-1, three of $R_{5a}$ to Rse are each a group represented by Formula 1-1 and one of $R_{5f}$ to $R_{5j}$ is a group represented by Formula 1-1; one of $R_{2a}$ to $R_{2d}$ is a group represented by Formula 1-1, two of $R_{5a}$ to Rse are each a group represented by Formula 1-1 and two of $R_{5f}$ to $R_{5j}$ are each a group represented by Formula 1-1; one of $R_{2a}$ to $R_{2d}$ is a group represented by Formula 1-1, one of $R_{5a}$ to Rse is a group represented by Formula 1-1 and three of $R_{5f}$ to $R_{5j}$ are each a group represented by Formula 1-1; $R_{3a}$ to $R_{3c}$ are each a group represented by Formula 1-1 and two of $R_{5a}$ to Rse are each a group represented by Formula 1-1; $R_{3a}$ to $R_{3c}$ are each a group represented by Formula 1-1 and two of $R_{5f}$ to $R_{5j}$ are each a group represented by Formula 1-1; $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula

1-1; two of $R_{3a}$ to $R_{3c}$ are each a group represented by Formula 1-1 and three of $R_{5a}$ to Rse are each a group represented by Formula 1-1; two of $R_{3a}$ to $R_{3c}$ are each a group represented by Formula 1-1 and three of $R_{5f}$ to $R_{5j}$ are each a group represented by Formula 1-1; two of $R_{3a}$ to $R_{3c}$ are each a group represented by Formula 1-1, two of $R_{5a}$ to Rse are each a group represented by Formula 1-1, one of $R_{5f}$ to $R_{5j}$ is a group represented by Formula 1-1; two of $R_{3a}$ to $R_{3c}$ are each a group represented by Formula 1-1, one of $R_{5a}$ to Rse is a group represented by Formula 1-1, two of $R_{5f}$ to $R_{5j}$ are each a group represented by Formula 1-1; one of $R_{3a}$ to $R_{3c}$ is a group represented by Formula 1-1, four of $R_{5a}$ to Rse are each a group represented by Formula 1-1; one of $R_{3a}$ to $R_{3c}$ is a group represented by Formula 1-1, four of $R_{5f}$ to $R_{5j}$ are each a group represented by Formula 1-1; one of $R_{3a}$ to $R_{3c}$ is a group represented by Formula 1-1, three of $R_{5a}$ to Rse are each a group represented by Formula 1-1 and one of $R_{5f}$ to $R_{5j}$ is a group represented by Formula 1-1; one of $R_{3a}$ to $R_{3c}$ is a group represented by Formula 1-1, two of $R_{5a}$ to Rse are each a group represented by Formula 1-1 and two of $R_{5f}$ to $R_{5j}$ are each a group represented by Formula 1-1; one of $R_{3a}$ to $R_{3c}$ is a group represented by Formula 1-1, one of $R_{5a}$ to Rse is a group represented by Formula 1-1 and three of $R_{5f}$ to $R_{5j}$ are each a group represented by Formula 1-1; $R_{5a}$ to Rse are each a group represented by Formula 1-1; $R_{5f}$ to $R_{5j}$ are each a group represented by Formula 1-1; four of $R_{5a}$ to Rse are each a group represented by Formula 1-1 and one of $R_{5f}$ to $R_{5j}$ is a group represented by Formula 1-1; three of $R_{5a}$ to Rse are each a group represented by Formula 1-1 and two of $R_{5f}$ to $R_{5j}$ are each a group represented by Formula 1-1; two of $R_{5a}$ to Rse are each a group represented by Formula 1-1 and three of $R_{5f}$ to $R_{5j}$ are each a group represented by Formula 1-1; one of $R_{5a}$ to Rse is a group represented by Formula 1-1 and four of $R_{5f}$ to $R_{5j}$ are each a group represented by Formula 1-1;, or

(x) $R_{1a}$ to $R_{1d}$ are each a group represented by Formula 1-1 and two of $R_{2a}$ to $R_{2d}$ are each a group represented by Formula 1-1; $R_{1a}$ to $R_{1d}$ are each a group represented by Formula 1-1, one of $R_{2a}$ to $R_{2d}$ is a group represented by Formula 1-1, and one of $R_{3a}$ to $R_{3c}$ is a group represented by Formula 1-1; $R_{1a}$ to $R_{1d}$ are each a group represented by Formula 1-1 and two of $R_{3a}$ to $R_{3c}$ are each a group represented by Formula 1-1; $R_{1a}$ to $R_{1d}$ are each a group represented by Formula 1-1 and two of $R_{5a}$ to Rse are each a group represented by Formula 1-1; $R_{1a}$ to $R_{1d}$ are each a group represented by Formula 1-1 and two of $R_{5f}$ to $R_{5j}$ are each a group represented by Formula 1-1; $R_{1a}$ to $R_{1d}$ are each a group represented by Formula 1-1 one of $R_{2a}$ to $R_{2d}$ is a group represented by Formula 1-1 and one of $R_{5a}$ to Rse is a group represented by Formula 1-1; $R_{1a}$ to $R_{1d}$ are each a group represented by Formula 1-1, one of $R_{2a}$ to $R_{2d}$ is a group represented by Formula 1-1 and one of $R_{5f}$ to $R_{5j}$ is a group represented by Formula 1-1; $R_{1a}$ to $R_{1d}$ are each a group represented by Formula 1-1, one of $R_{3a}$ to $R_{3c}$ is a group represented by Formula 1-1 and one of $R_{5a}$ to Rse is a group represented by Formula 1-1; $R_{1a}$ to $R_{1d}$ are each a group represented by Formula 1-1, one of $R_{3a}$ to $R_{3c}$ is a group represented by Formula 1-1 and one of $R_{5f}$ to $R_{5j}$ is a group represented by Formula 1-1; $R_{1a}$ to $R_{1d}$ are each a group represented by Formula 1-1, one of $R_{5a}$ to Rse is a group represented by Formula 1-1 and one of $R_{5f}$ to $R_{5j}$ is a group represented by Formula 1-1; three of $R_{1a}$ to $R_{1d}$ are each a group represented by Formula 1-1 and three of $R_{2a}$ to $R_{2d}$ are each a group represented by Formula 1-1; three of $R_{1a}$ to $R_{1d}$ are each a group represented by Formula 1-1, two of $R_{2a}$ to $R_{2d}$ are each a group represented by Formula 1-1, and one of $R_{3a}$ to $R_{3c}$ is a group represented by Formula 1-1; three of $R_{1a}$ to $R_{1d}$ are each a group represented by Formula 1-1, two of $R_{2a}$ to $R_{2d}$ are each a group represented by Formula 1-1, and one of $R_{5a}$ to Rse is a group represented by Formula 1-1; three of $R_{1a}$ to $R_{1d}$ are each a group represented by Formula 1-1, two of $R_{2a}$ to $R_{2d}$ are each a group represented by Formula 1-1, and one of $R_{5f}$ to $R_{5j}$ is a group represented by Formula 1-1; three of $R_{1a}$ to $R_{1d}$ are each a group represented by Formula 1-1, one of $R_{2a}$ to $R_{2d}$ is a group represented by Formula 1-1, and two of $R_{3a}$ to $R_{3c}$ are each a group represented by Formula 1-1; three of $R_{1a}$ to $R_{1d}$ are each a group represented by Formula 1-1, one of $R_{2a}$ to $R_{2d}$ is a group represented by Formula 1-1, and two of $R_{5a}$ to Rse are each a group represented by Formula 1-1; three of $R_{1a}$ to $R_{1d}$ are each a group represented by Formula 1-1, one of $R_{2a}$ to $R_{2d}$ is a group represented by Formula 1-1, and two of $R_{5f}$ to $R_{5j}$ are each a group represented by Formula 1-1; three of $R_{1a}$ to $R_{1d}$ are each a group represented by Formula 1-1, one of $R_{2a}$ to $R_{2d}$ is a group represented by Formula 1-1, one of $R_{5a}$ to Rse is a group represented by Formula 1-1 and one of $R_{5f}$ to $R_{5j}$ is a group represented by Formula 1-1; three of $R_{1a}$ to $R_{1d}$ are each a group represented by Formula 1-1 and $R_{3a}$ to $R_{3c}$ are each a group represented by Formula 1-1; three of $R_{1a}$ to $R_{1d}$ are each a group represented by Formula 1-1 and two of $R_{3a}$ to $R_{3c}$ are each a group represented by Formula 1-1 and one of $R_{5a}$ to Rse is a group represented by Formula 1-1; three of $R_{1a}$ to $R_{1d}$ are each a group represented by Formula 1-1 and two of $R_{3a}$ to $R_{3c}$ are each a group represented by Formula 1-1 and one of $R_{5f}$ to $R_{5j}$ is a group represented by Formula 1-1; three of $R_{1a}$ to $R_{1d}$ are each a group represented by Formula 1-1, one of $R_{3a}$ to $R_{3c}$ is a group represented by Formula 1-1 and two of $R_{5a}$ to Rse are each a group represented by Formula 1-1; three of $R_{1a}$ to $R_{1d}$ are each a group represented by Formula 1-1, one of $R_{3a}$ to $R_{3c}$ is a group represented by Formula 1-1 and two of $R_{5f}$ to $R_{5j}$ are each a group represented by Formula 1-1; three of $R_{1a}$ to $R_{1d}$ are each a group represented by Formula 1-1, one of $R_{3a}$ to $R_{3c}$ is a group represented by Formula 1-1, one of $R_{5a}$ to Rse is a group represented by Formula 1-1 and one of $R_{5f}$ to $R_{5j}$ is a group represented by Formula 1-1; two of $R_{1a}$ to $R_{1d}$ are each a group represented by Formula 1-1 and $R_{2a}$

to $R_{2d}$ are each a group represented by Formula 1-1; two of $R_{1a}$ to $R_{1d}$ are each a group represented by Formula 1-1, three of $R_{2a}$ to $R_{2d}$ are each a group represented by Formula 1-1, and one of $R_{3a}$ to $R_{3c}$ is a group represented by Formula 1-1; two of $R_{1a}$ to $R_{1d}$ are each a group represented by Formula 1-1, three of $R_{2a}$ to $R_{2d}$ are each a group represented by Formula 1-1, and one of $R_{5a}$ to Rse is a group represented by Formula 1-1; two of $R_{1a}$ to $R_{1d}$ are each a group represented by Formula 1-1, three of $R_{2a}$ to $R_{2d}$ are each a group represented by Formula 1-1, and one of $R_{5f}$ to $R_{5j}$ is a group represented by Formula 1-1; two of $R_{1a}$ to $R_{1d}$ are each a group represented by Formula 1-1, two of $R_{2a}$ to $R_{2d}$ are each a group represented by Formula 1-1, and two of $R_{3a}$ to $R_{3c}$ are each a group represented by Formula 1-1; two of $R_{1a}$ to $R_{1d}$ are each a group represented by Formula 1-1, two of $R_{2a}$ to $R_{2d}$ are each a group represented by Formula 1-1, one of $R_{3a}$ to $R_{3c}$ is a group represented by Formula 1-1 and one of $R_{5a}$ to Rse is a group represented by Formula 1-1; two of $R_{1a}$ to $R_{1d}$ are each a group represented by Formula 1-1, two of $R_{2a}$ to $R_{2d}$ are each a group represented by Formula 1-1, one of $R_{3a}$ to $R_{3c}$ is a group represented by Formula 1-1 and one of $R_{5f}$ to $R_{5j}$ is a group represented by Formula 1-1; two of $R_{1a}$ to $R_{1d}$ are each a group represented by Formula 1-1, two of $R_{2a}$ to $R_{2d}$ are each a group represented by Formula 1-1, one of $R_{5a}$ to $R_{5e}$ is a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, and $R_{3a}$ to $R_{3c}$ are each a group represented by Formula 1-1; two of $R_{1a}$ to $R_{1d}$ are each a group represented by Formula 1-1, one of $R_{2a}$ to $R_{2d}$ is a group represented by Formula 1-1, and $R_{3a}$ to $R_{3c}$ are each a group represented by Formula 1-1; two of $R_{1a}$ to $R_{1d}$ are each a group represented by Formula 1-1, one of $R_{2a}$ to $R_{2d}$ is a group represented by Formula 1-1, two of $R_{3a}$ to $R_{3c}$ are each a group represented by Formula 1-1 and one of $R_{5a}$ to Rse is a group represented by Formula 1-1; two of $R_{1a}$ to $R_{1d}$ are each a group represented by Formula 1-1, one of $R_{2a}$ to $R_{2d}$ is a group represented by Formula 1-1, two of $R_{3a}$ to $R_{3c}$ are each a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{3a}$ to $R_{3c}$ is a group represented by Formula 1-1 and two of $R_{5a}$ to Rse are each a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{3a}$ to $R_{3c}$ is a group represented by Formula 1-1 and two of $R_{5f}$ to $R_{5j}$ are each a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{3a}$ to $R_{3c}$ is a group represented by Formula 1-1, one of $R_{5a}$ to Rse is a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, and three of $R_{5a}$ to Rse are each a group represented by Formula 1-1; two of $R_{1a}$ to $R_{1d}$ are each a group represented by Formula 1-1, one of $R_{2a}$ to $R_{2d}$ is a group represented by Formula 1-1, two of $R_{5a}$ to Rse are each a group represented by Formula 1-1 and one of $R_{5f}$ to $R_{5j}$ is a group represented by Formula 1-1; two of $R_{1a}$ to $R_{1d}$ are each a group represented by Formula 1-1, one of $R_{2a}$ to $R_{2d}$ is a group represented by Formula 1-1, one of $R_{5a}$ to Rse is a group represented by Formula 1-1 and two of $R_{5f}$ to $R_{5j}$ are each a group represented by Formula 1-1; two of $R_{1a}$ to $R_{1d}$ are each a group represented by Formula 1-1, one of $R_{2a}$ to $R_{2d}$ is a group represented by Formula 1-1 and three of $R_{5f}$ to $R_{5j}$ are each a group represented by Formula 1-1; one of $R_{1a}$ to $R_{1d}$ is a group represented by Formula 1-1, $R_{2a}$ to $R_{2d}$ are each a group represented by Formula 1-1, and one of $R_{3a}$ to $R_{3c}$ is a group represented by Formula 1-1; one of $R_{1a}$ to $R_{1d}$ is a group represented by Formula 1-1, $R_{2a}$ to $R_{2d}$ are each a group represented by Formula 1-1, and one of $R_{5a}$ to Rse is a group represented by Formula 1-1; one of $R_{1a}$ to $R_{1d}$ is a group represented by Formula 1-1, $R_{2a}$ to $R_{2d}$ are each a group represented by Formula 1-1, and one of $R_{5f}$ to $R_{5j}$ is a group represented by Formula 1-1; one of $R_{1a}$ to $R_{1d}$ is a group represented by Formula 1-1, three of $R_{2a}$ to $R_{2d}$ are each a group represented by Formula 1-1, and two of $R_{3a}$ to $R_{3c}$ are each a group represented by Formula 1-1; one of $R_{1a}$ to $R_{1d}$ is a group represented by Formula 1-1, three of $R_{2a}$ to $R_{2d}$ are each a group represented by Formula 1-1, one of $R_{3a}$ to $R_{3c}$ is a group represented by Formula 1-1 and one of $R_{5a}$ to Rse is a group represented by Formula 1-1; one of $R_{1a}$ to $R_{1d}$ is a group represented by Formula 1-1, three of $R_{2a}$ to $R_{2d}$ are each a group represented by Formula 1-1, one of $R_{3a}$ to $R_{3c}$ is a group represented by Formula 1-1 and one of $R_{5f}$ to $R_{5j}$ is a group represented by Formula 1-1; one of $R_{1a}$ to $R_{1d}$ is a group represented by Formula 1-1, three of $R_{2a}$ to $R_{2d}$ are each a group represented by Formula 1-1, two of $R_{5a}$ to Rse are each a group represented by Formula 1-1; one of $R_{1a}$ to $R_{1d}$ is a group represented by Formula 1-1, three of $R_{2a}$ to $R_{2d}$ are each a group represented by Formula 1-1, one of $R_{5a}$ to Rse is a group represented by Formula 1-1 and one of $R_{5f}$ to $R_{5j}$ is a group represented by Formula 1-1; one of $R_{1a}$ to $R_{1d}$ is a group represented by Formula 1-1, three of $R_{2a}$ to $R_{2d}$ are each a group represented by Formula 1-1 and two of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, and $R_{3a}$ to $R_{3c}$ are each a group represented by Formula 1-1; one of $R_{1a}$ to $R_{1d}$ is a group represented by Formula 1-1, two of $R_{2a}$ to $R_{2d}$ are each a group represented by Formula 1-1, two of $R_{3a}$ to $R_{3c}$ are each a group represented by Formula 1-1, one of $R_{5a}$ to Rse is a group represented by Formula

1-1; one of $R_{1a}$ to $R_{1d}$ is a group represented by Formula 1-1, two of $R_{2a}$ to $R_{2d}$ are each a group represented by Formula 1-1, two of $R_{3a}$ to $R_{3c}$ are each a group represented by Formula 1-1, one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{3a}$ to $R_{3c}$ is a group represented by Formula 1-1, two of $R_{5a}$ to Rse are each a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{3a}$ to $R_{3c}$ is a group represented by Formula 1-1, one of $R_{5a}$ to Rse is a group represented by Formula 1-1 and one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{3a}$ to $R_{3c}$ is a group represented by Formula 1-1 and two of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, and three of $R_{5a}$ to Rse are each a group represented by Formula 1-1; one of $R_{1a}$ to $R_{1d}$ is a group represented by Formula 1-1, two of $R_{2a}$ to $R_{2d}$ are each a group represented by Formula 1-1, two of $R_{5a}$ to Rse are each a group represented by Formula 1-1 and one of $R_{5f}$ to $R_{5j}$ is a group represented by Formula 1-1; one of $R_{1a}$ to $R_{1d}$ is a group represented by Formula 1-1, two of $R_{2a}$ to $R_{2d}$ are each a group represented by Formula 1-1, one of $R_{5a}$ to Rse is a group represented by Formula 1-1 and two of $R_{5f}$ to $R_{5j}$ are each a group represented by Formula 1-1; one of $R_{1a}$ to $R_{1d}$ is a group represented by Formula 1-1, two of $R_{2a}$ to $R_{2d}$ are each a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1, $R_{3a}$ to $R_{3c}$ are each a group represented by Formula 1-1 and one of $R_{5a}$ to Rse is a group represented by Formula 1-1; one of $R_{1a}$ to $R_{1d}$ is a group represented by Formula 1-1, one of $R_{2a}$ to $R_{2d}$ are each a group represented by Formula 1-1, $R_{3a}$ to $R_{3c}$ are each a group represented by Formula 1-1 and one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, two of $R_{3a}$ to $R_{3c}$ are each a group represented by Formula 1-1 and two of $R_{5a}$ to Rse are each a group represented by Formula 1-1; one of $R_{1a}$ to $R_{1d}$ is a group represented by Formula 1-1, one of $R_{2a}$ to $R_{2d}$ is a group represented by Formula 1-1, two of $R_{3a}$ to $R_{3c}$ are each a group represented by Formula 1-1 and two of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1, two of $R_{3a}$ to $R_{3c}$ are each a group represented by Formula 1-1, one of $R_{5a}$ to Rse is a group represented by Formula 1-1 and one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1 and three of $R_{5a}$ to $R_{5e}$ are each a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1, two of $R_{5a}$ to $R_{5e}$ are each a group represented by Formula 1-1 and one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1, one of $R_{5a}$ to $R_{5e}$ is a group represented by Formula 1-1 and two of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1, one of $R_{3a}$ to $R_{3c}$ is a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1 and four of $R_{5a}$ to $R_{5e}$ are each a group represented by Formula 1-1; one of $R_{1a}$ to $R_{1d}$ is a group represented by Formula 1-1, one of $R_{2a}$ to $R_{2d}$ is a group represented by Formula 1-1, three of $R_{5a}$ to $R_{5e}$ are each a group represented by Formula 1-1, one of $R_{5f}$ to $R_{5j}$ is a group represented by Formula 1-1; one of $R_{1a}$ to $R_{1d}$ is a group represented by Formula 1-1, one of $R_{2a}$ to $R_{2d}$ is a group represented by Formula 1-1, two of $R_{5a}$ to $R_{5e}$ are each a group represented by Formula 1-1, two of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1, one of $R_{5a}$ to $R_{5e}$ is a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{2a}$ to $R_{2d}$ is a group represented by Formula 1-1 and four of $R_{5f}$ to $R_{5j}$ are each a group represented by Formula 1-1; one of $R_{1a}$ to $R_{1d}$ is a group represented by Formula 1-1, $R_{3a}$ to $R_{3c}$ are each a group represented by Formula 1-1, two of $R_{5a}$ to $R_{5e}$ are each a group represented by Formula 1-1; one of $R_{1a}$ to $R_{1d}$ is a group represented by Formula 1-1, $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula 1-1; one of $R_{1a}$ to $R_{1d}$ is a group represented by Formula 1-1, $R_{3a}$ to $R_{3c}$ are each a group represented by Formula 1-1 and two of $R_{5f}$ to $R_{5j}$ are each a group represented by Formula 1-1; one of $R_{1a}$ to $R_{1d}$ is a group represented by Formula 1-1, two of $R_{3a}$ to $R_{3c}$ are each a group represented by Formula 1-1 and three of $R_{5a}$ to $R_{5e}$ are each a group represented by Formula 1-1; one of $R_{1a}$ to $R_{1d}$ is a group represented by Formula 1-1, two of $R_{3a}$ to $R_{3c}$ are each a group represented by Formula 1-1, two of $R_{5a}$ to $R_{5e}$ are each a group represented by Formula 1-1 and one of $R_{5f}$ to $R_{5j}$ is a group represented

by Formula 1-1; one of $R_{1a}$ to $R_{1d}$ is a group represented by Formula 1-1, two of $R_{3a}$ to $R_{3c}$ are each a group represented by Formula 1-1, one of $R_{5a}$ to $R_{5e}$ is a group represented by Formula 1-1 and two of $R_{5f}$ to $R_{5j}$ are each a group represented by Formula 1-1; one of $R_{1a}$ to $R_{1d}$ is a group represented by Formula 1-1, two of $R_{3a}$ to $R_{3c}$ are each a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1 and four of $R_{5a}$ to $R_{5e}$ are each a group represented by Formula 1-1; one of $R_{1a}$ to $R_{1d}$ is a group represented by Formula 1-1, one of $R_{3a}$ to $R_{3c}$ is a group represented by Formula 1-1, three of $R_{5a}$ to $R_{5e}$ are each a group represented by Formula 1-1 and one of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1, two of $R_{5a}$ to $R_{5e}$ are each a group represented by Formula 1-1 and two of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1, one of $R_{5a}$ to $R_{5e}$ is a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{3a}$ to $R_{3c}$ is a group represented by Formula 1-1 and four of $R_{5f}$ to $R_{5j}$ are each a group represented by Formula 1-1; one of $R_{1a}$ to $R_{1d}$ is a group represented by Formula 1-1 and $R_{5a}$ to $R_{5e}$ are each a group represented by Formula 1-1; one of $R_{1a}$ to $R_{1d}$ is a group represented by Formula 1-1, four of $R_{5a}$ to $R_{5e}$ are each a group represented by Formula 1-1 and one of $R_{5f}$ to $R_{5j}$ is a group represented by Formula 1-1; one of $R_{1a}$ to $R_{1d}$ is a group represented by Formula 1-1, three of $R_{5a}$ to $R_{5e}$ are each a group represented by Formula 1-1 and two of $R_{5f}$ to $R_{5j}$ are each a group represented by Formula 1-1; one of $R_{1a}$ to $R_{1d}$ is a group represented by Formula 1-1, two of $R_{5a}$ to $R_{5e}$ are each a group represented by Formula 1-1 and three of $R_{5f}$ to $R_{5j}$ are each a group represented by Formula 1-1; one of $R_{1a}$ to $R_{1d}$ is a group represented by Formula 1-1, one of $R_{5a}$ to $R_{5e}$ is a group represented by Formula 1-1 and four of $R_{5f}$ to $R_{5j}$ are each a group represented by Formula 1-1; one of $R_{1a}$ to $R_{1d}$ is a group represented by Formula 1-1 and $R_{5f}$ to $R_{5j}$ are each a group represented by Formula 1-1; $R_{2a}$ to $R_{2d}$ are each a group represented by Formula 1-1 and two of $R_{3a}$ to $R_{3c}$ are each a group represented by Formula 1-1; $R_{2a}$ to $R_{2d}$ are each a group represented by Formula 1-1, one of $R_{3a}$ to $R_{3c}$ are each a group represented by Formula 1-1 and one of $R_{5a}$ to $R_{5e}$ is a group represented by Formula 1-1; $R_{2a}$ to $R_{2d}$ are each a group represented by Formula 1-1, one of $R_{3a}$ to $R_{3c}$ are each a group represented by Formula 1-1 and one of $R_{5f}$ to $R_{5j}$ is a group represented by Formula 1-1; $R_{2a}$ to $R_{2d}$ are each a group represented by Formula 1-1 and two of $R_{5a}$ to $R_{5e}$ are each a group represented by Formula 1-1; $R_{2a}$ to $R_{2d}$ are each a group represented by Formula 1-1, one of $R_{5a}$ to $R_{5e}$ is a group represented by Formula 1-1 and one of $R_{5f}$ to $R_{5j}$ is a group represented by Formula 1-1; $R_{2a}$ to $R_{2d}$ are each a group represented by Formula 1-1 and two of $R_{5f}$ to $R_{5j}$ are each a group represented by Formula 1-1; three of $R_{2a}$ to $R_{2d}$ are each a group represented by Formula 1-1 and $R_{3a}$ to $R_{3c}$ are each a group represented by Formula 1-1; three of $R_{2a}$ to $R_{2d}$ are each a group represented by Formula 1-1, two of $R_{3a}$ to $R_{3c}$ are each a group represented by Formula 1-1 and one of $R_{5a}$ to $R_{5e}$ is a group represented by Formula 1-1; three of $R_{2a}$ to $R_{2d}$ are each a group represented by Formula 1-1, two of $R_{3a}$ to $R_{3c}$ are each a group represented by Formula 1-1 and one of $R_{5f}$ to $R_{5j}$ is a group represented by Formula 1-1; three of $R_{2a}$ to $R_{2d}$ are each a group represented by Formula 1-1, one of $R_{3a}$ to $R_{3c}$ is a group represented by Formula 1-1 and two of $R_{5a}$ to $R_{5e}$ are each a group represented by Formula 1-1; three of $R_{2a}$ to $R_{2d}$ are each a group represented by Formula 1-1, one of $R_{3a}$ to $R_{3c}$ is a group represented by Formula 1-1, one of $R_{5a}$ to $R_{5e}$ is a group represented by Formula 1-1 and one of $R_{5f}$ to $R_{5j}$ is a group represented by Formula 1-1; three of $R_{2a}$ to $R_{2d}$ are each a group represented by Formula 1-1, one of $R_{3a}$ to $R_{3c}$ is a group represented by Formula 1-1 and two of $R_{5f}$ to $R_{5j}$ are each a group represented by Formula 1-1; three of $R_{2a}$ to $R_{2d}$ are each a group represented by Formula 1-1 and three of $R_{5a}$ to $R_{5e}$ are each a group represented by Formula 1-1; three of $R_{2a}$ to $R_{2d}$ are each a group represented by Formula 1-1, two of $R_{5a}$ to $R_{5e}$ are each a group represented by Formula 1-1 and one of $R_{5f}$ to $R_{5j}$ is a group represented by Formula 1-1; three of $R_{2a}$ to $R_{2d}$ are each a group represented by Formula 1-1, one of $R_{5a}$ to $R_{5e}$ is a group represented by Formula 1-1 and two of $R_{5f}$ to $R_{5j}$ are each a group represented by Formula 1-1; three of $R_{2a}$ to $R_{2d}$ are each a group represented by Formula 1-1 and three of $R_{5f}$ to $R_{5j}$ are each a group represented by Formula 1-1; two of $R_{2a}$ to $R_{2d}$ are each a group represented by Formula 1-1, $R_{3a}$ to $R_{3c}$ are each a group represented by Formula 1-1 and one of $R_{5a}$ to $R_{5e}$ is a group represented by Formula 1-1; two of $R_{2a}$ to $R_{2d}$ are each a group represented by Formula 1-1, $R_{3a}$ to $R_{3c}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, two of $R_{3a}$ to $R_{3c}$ are each a group represented by Formula 1-1 and two of $R_{5a}$ to $R_{5e}$ are each a group represented by Formula 1-1; two of $R_{2a}$ to $R_{2d}$ are each a group represented by Formula 1-1, two of $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula 1-1; two of $R_{2a}$ to $R_{2d}$ are each a group represented by Formula 1-1, two of $R_{3a}$ to $R_{3c}$ are each a group represented by Formula 1-1 and two of $R_{5f}$ to $R_{5j}$ are each a group represented by Formula 1-1; two of $R_{2a}$ to $R_{2d}$ are each a group represented by Formula 1-1, one of $R_{3a}$ to $R_{3c}$ is a group represented by Formula 1-1 and three of $R_{5a}$ to $R_{5e}$ are each a

group represented by Formula 1-1; two of $R_{2a}$ to $R_{2d}$ are each a group represented by Formula 1-1, one of $R_{3a}$ to $R_{3c}$ is a group represented by Formula 1-1, two of $R_{5a}$ to $R_{5e}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, one of $R_{3a}$ to $R_{3c}$ is a group represented by Formula 1-1, one of $R_{5a}$ to $R_{5e}$ is a group represented by Formula 1-1 and two of $R_{5f}$ to $R_{5j}$ are each a group represented by Formula 1-1; two of $R_{2a}$ to $R_{2d}$ are each a group represented by Formula 1-1, one of $R_{3a}$ to $R_{3c}$ is a group represented by Formula 1-1 and three of $R_{5f}$ to $R_{5j}$ are each a group represented by Formula 1-1; two of $R_{2a}$ to $R_{2d}$ are each a group represented by Formula 1-1 and four of $R_{5a}$ to $R_{5e}$ are each a group represented by Formula 1-1; two of $R_{2a}$ to $R_{2d}$ are each a group represented by Formula 1-1, three of $R_{5a}$ to $R_{5e}$ are each a group represented by Formula 1-1 and one of $R_{5f}$ to $R_{5j}$ is a group represented by Formula 1-1; two of $R_{2a}$ to $R_{2d}$ are each a group represented by Formula 1-1, two of $R_{5a}$ to $R_{5e}$ are each a group represented by Formula 1-1 and two of $R_{5f}$ to $R_{5j}$ are each a group represented by Formula 1-1; two of $R_{2a}$ to $R_{2d}$ are each a group represented by Formula 1-1, one of $R_{5a}$ to $R_{5e}$ is a group represented by Formula 1-1 and three of $R_{5f}$ to $R_{5j}$ are each a group represented by Formula 1-1; two of $R_{2a}$ to $R_{2d}$ are each a group represented by Formula 1-1 and four of $R_{5f}$ to $R_{5j}$ are each a group represented by Formula 1-1; one of $R_{2a}$ to $R_{2d}$ is a group represented by Formula 1-1, $R_{3a}$ to $R_{3c}$ are each a group represented by Formula 1-1 and two of $R_{5a}$ to $R_{5e}$ are each a group represented by Formula 1-1; one of $R_{2a}$ to $R_{2d}$ is a group represented by Formula 1-1, $R_{3a}$ to $R_{3c}$ are each a group represented by Formula 1-1, one of $R_{5a}$ to $R_{5e}$ is a group represented by Formula 1-1 and one of $R_{5f}$ to $R_{5j}$ is a group represented by Formula 1-1; one of $R_{2a}$ to $R_{2d}$ is a group represented by Formula 1-1, $R_{3a}$ to $R_{3c}$ are each a group represented by Formula 1-1 and two of $R_{5f}$ to $R_{5j}$ are each a group represented by Formula 1-1; one of $R_{2a}$ to $R_{2d}$ is a group represented by Formula 1-1, two of $R_{3a}$ to $R_{3c}$ are each a group represented by Formula 1-1 and three of $R_{5a}$ to $R_{5e}$ are each a group represented by Formula 1-1; one of $R_{2a}$ to $R_{2d}$ is a group represented by Formula 1-1, two of $R_{3a}$ to $R_{3c}$ are each a group represented by Formula 1-1, two of $R_{5a}$ to $R_{5e}$ are each a group represented by Formula 1-1 and one of $R_{5f}$ to $R_{5j}$ is each a group represented by Formula 1-1; one of $R_{2a}$ to $R_{2d}$ is a group represented by Formula 1-1, two of $R_{3a}$ to $R_{3c}$ are each a group represented by Formula 1-1, one of $R_{5a}$ to $R_{5e}$ is a group represented by Formula 1-1 and two of $R_{5f}$ to $R_{5j}$ are each a group represented by Formula 1-1; one of $R_{2a}$ to $R_{2d}$ is a group represented by Formula 1-1, two of $R_{3a}$ to $R_{3c}$ are each a group represented by Formula 1-1 and three of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1 and four of $R_{5a}$ to $R_{5e}$ are each a group represented by Formula 1-1; one of $R_{2a}$ to $R_{2d}$ is a group represented by Formula 1-1, one of $R_{3a}$ to $R_{3c}$ is a group represented by Formula 1-1, three of $R_{5a}$ to $R_{5e}$ are each a group represented by Formula 1-1 and one of $R_{5f}$ to $R_{5j}$ is a group represented by Formula 1-1; one of $R_{2a}$ to $R_{2d}$ is a group represented by Formula 1-1, one of $R_{3a}$ to $R_{3c}$ is a group represented by Formula 1-1, two of $R_{5a}$ to $R_{5e}$ are each a group represented by Formula 1-1 and two of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1, one of $R_{5a}$ to $R_{5e}$ is a group represented by Formula 1-1 and three of $R_{5f}$ to $R_{5j}$ are each a group represented by Formula 1-1; one of $R_{2a}$ to $R_{2d}$ is a group represented by Formula 1-1, one of $R_{3a}$ to $R_{3c}$ is a group represented by Formula 1-1 and four of $R_{5f}$ to $R_{5j}$ are each a group represented by Formula 1-1; one of $R_{2a}$ to $R_{2d}$ is a group represented by Formula 1-1, and $R_{5a}$ to $R_{5e}$ are each a group represented by Formula 1-1; one of $R_{2a}$ to $R_{2d}$ is a group represented by Formula 1-1, and $R_{5f}$ to $R_{5j}$ are each a group represented by Formula 1-1; $R_{3a}$ to $R_{3c}$ are each a group represented by Formula 1-1 and three of $R_{5a}$ to $R_{5e}$ are each a group represented by Formula 1-1; $R_{3a}$ to $R_{3c}$ are each a group represented by Formula 1-1, two of $R_{5a}$ to $R_{5e}$ are each a group represented by Formula 1-1 and one of $R_{5f}$ to $R_{5j}$ is a group represented by Formula 1-1; $R_{3a}$ to $R_{3c}$ are each a group represented by Formula 1-1, one of $R_{5a}$ to $R_{5e}$ is a group represented by Formula 1-1 and two of $R_{5f}$ to $R_{5j}$ are each a group represented by Formula 1-1; $R_{3a}$ to $R_{3c}$ are each a group represented by Formula 1-1 and three of $R_{5f}$ to $R_{5j}$ are each a group represented by Formula 1-1; two of $R_{3a}$ to $R_{3c}$ are each a group represented by Formula 1-1 and four of $R_{5a}$ to $R_{5e}$ are each a group represented by Formula 1-1; two of $R_{3a}$ to $R_{3c}$ are each a group represented by Formula 1-1, three of $R_{5a}$ to $R_{5e}$ are each a group represented by Formula 1-1 and one of $R_{5f}$ to $R_{5j}$ is a group represented by Formula 1-1; two of $R_{3a}$ to $R_{3c}$ are each a group represented by Formula 1-1, two of $R_{5a}$ to $R_{5e}$ are each a group represented by Formula 1-1 and two of $R_{5f}$ to $R_{5j}$ are each a group represented by Formula 1-1; two of $R_{3a}$ to $R_{3c}$ are each a group represented by Formula 1-1, one of $R_{5a}$ to $R_{5e}$ is a group represented by Formula 1-1 and three of $R_{5f}$ to $R_{5j}$ are each a group represented by Formula 1-1; two of $R_{3a}$ to $R_{3c}$ are each a group represented by Formula 1-1 and four of $R_{5f}$ to $R_{5j}$ are each a group represented by Formula 1-1; one of $R_{3a}$ to $R_{3c}$ is a group represented by Formula 1-1 and $R_{5a}$ to $R_{5e}$ are each a group represented by Formula 1-1; one of $R_{3a}$ to $R_{3c}$ is a group represented by Formula 1-1 and $R_{5f}$ to $R_{5j}$ are each a group represented by Formula 1-1; $R_{5a}$ to $R_{5e}$ are each a group represented by Formula 1-1 and one of $R_{5f}$ to $R_{5j}$ is a group represented by Formula 1-1; four of $R_{5a}$ to $R_{5e}$ are each a group represented by Formula 1-1 and two of $R_{5f}$ to $R_{5j}$ are each a group represented by Formula 1-1; three of $R_{5a}$ to $R_{5e}$ are each a group represented

by Formula 1-1 and three of $R_{5f}$ to $R_{5j}$ are each a group represented by Formula 1-1; two of $R_{5a}$ to $R_{5e}$ are each a group represented by Formula 1-1 and four of $R_{5f}$ to $R_{5j}$ are each a group represented by Formula 1-1; or one of $R_{5a}$ to $R_{5e}$ is a group represented by Formula 1-1 and $R_{5f}$ to $R_{5j}$ are each a group represented by Formula 1-1.

**13.** The polycyclic compound of claim 1, wherein the polycyclic compound represented by Formula 1 is one of Compounds 1 to 107:

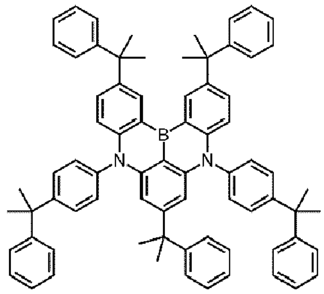

1

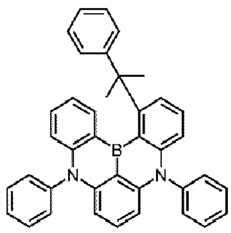

2

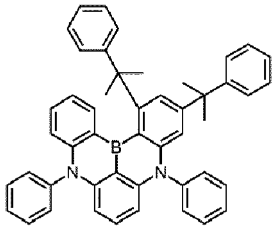

3

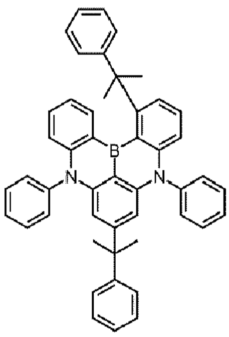

4

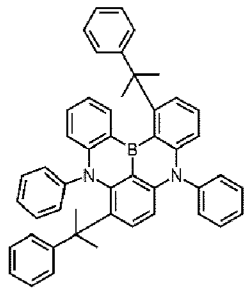

5

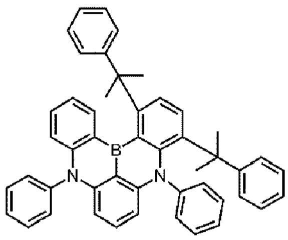

6

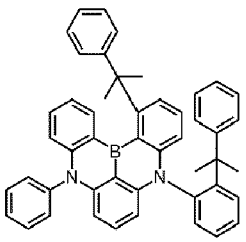

7

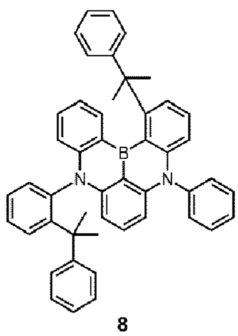

8

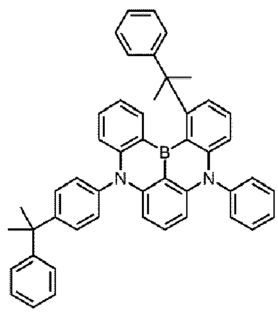

9

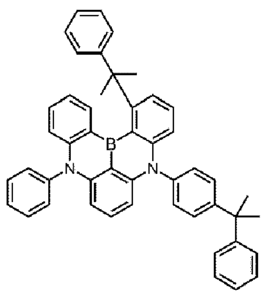

10

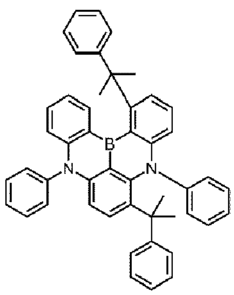

11

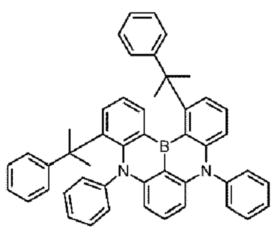

12

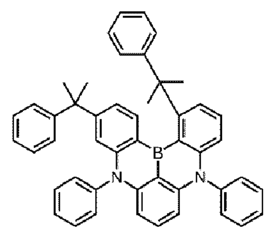

13

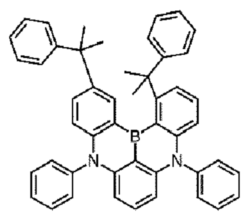

14

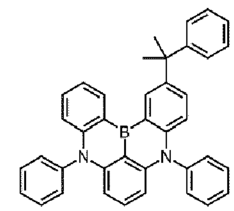

15

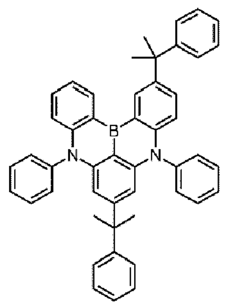

16

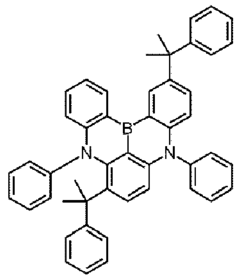

17

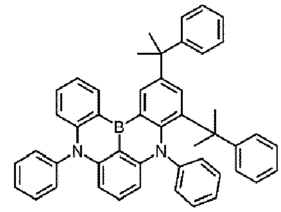

18

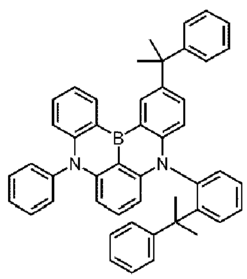

19

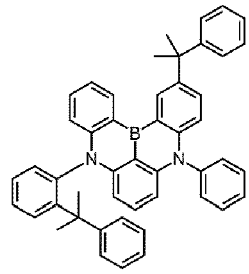

20

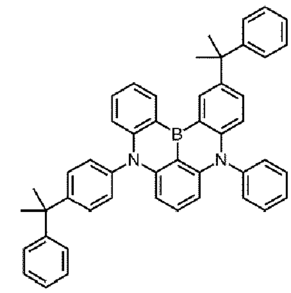

21

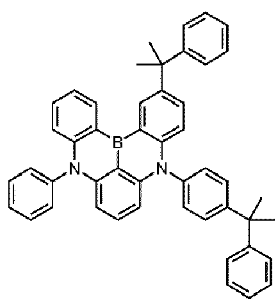

22

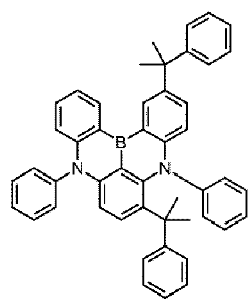

23

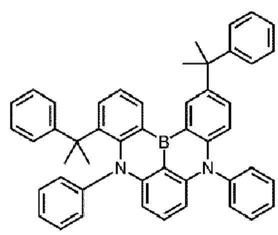

24

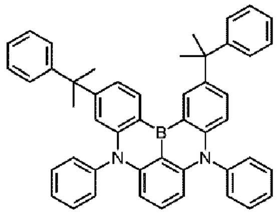

25

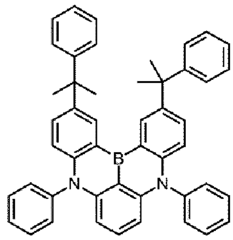

26

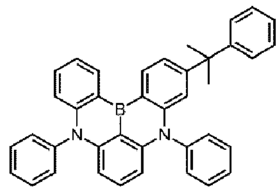

27

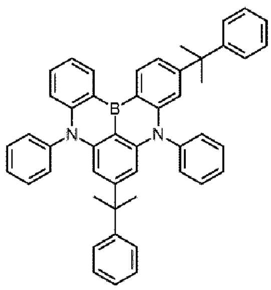

28

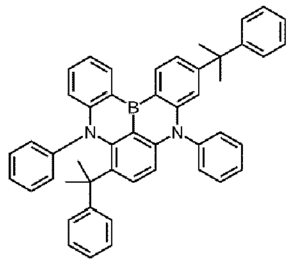

29

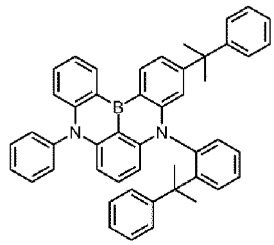

30

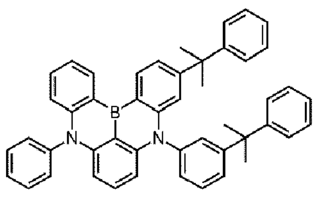

31

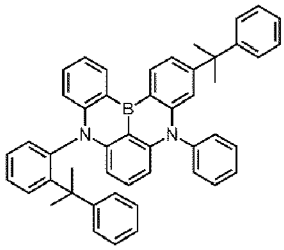

32

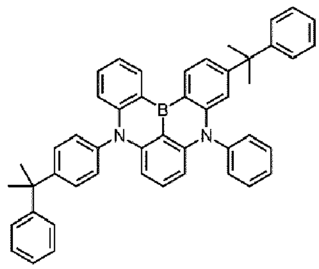

33

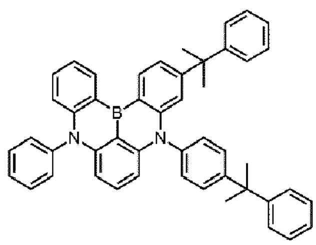

34

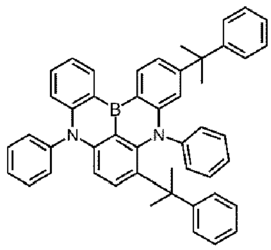

35

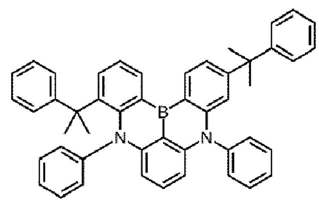

36

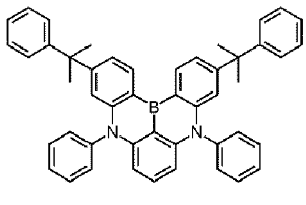

37

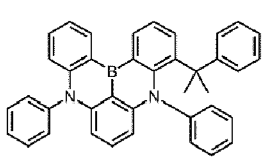

38

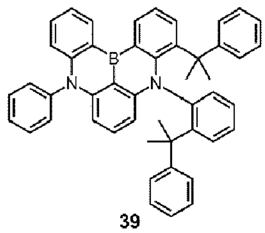

39

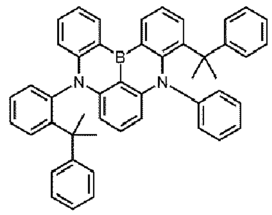

40

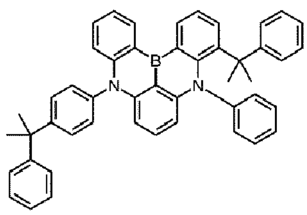

41

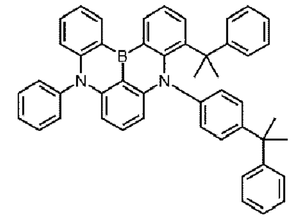

42

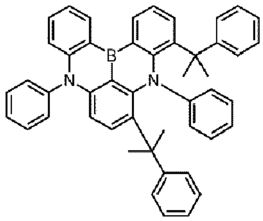

43

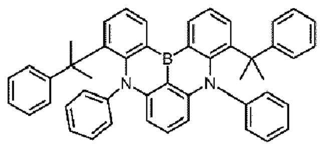

44

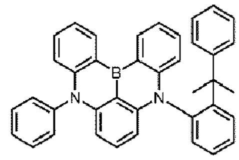

45

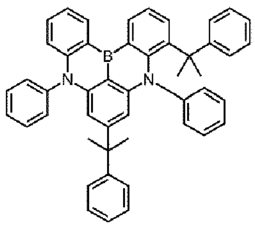

46

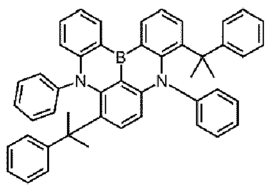

47

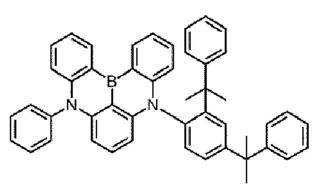

48

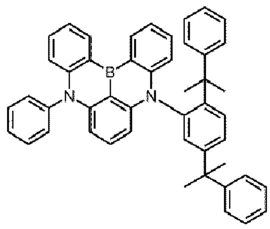

49

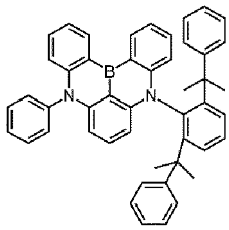

50

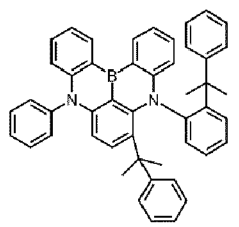

51

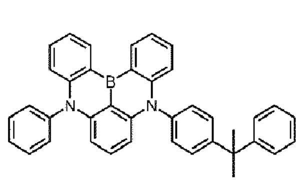

52

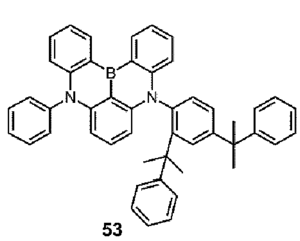

53

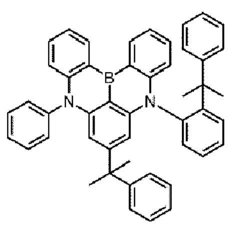

54

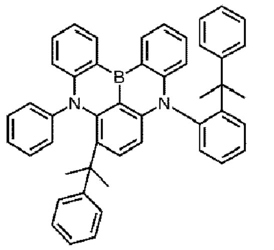

**55**

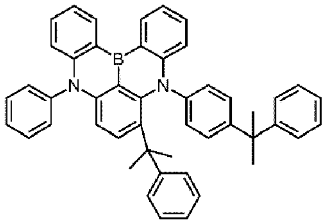

**56**

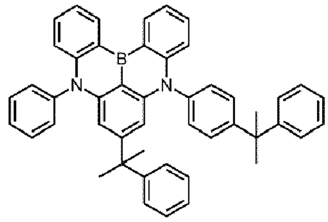

**57**

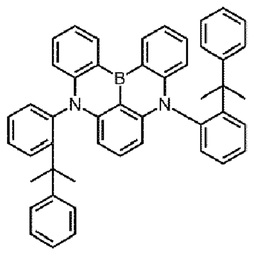

**58**

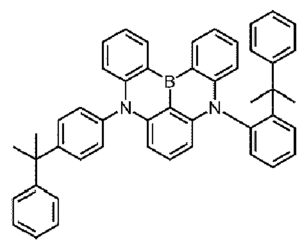

**59**

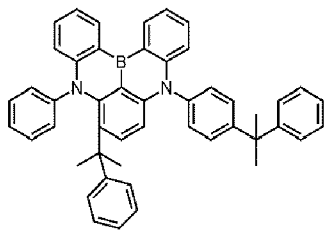

**60**

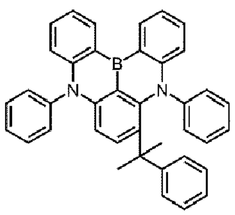

**61**

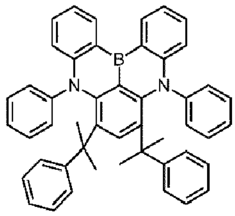

**62**

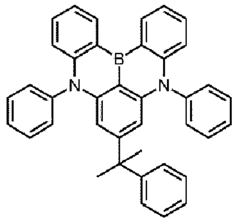

**63**

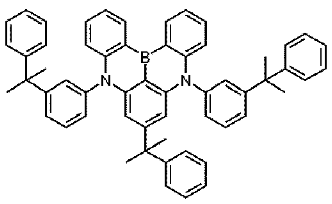

**64**

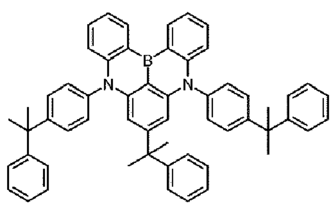

**65**

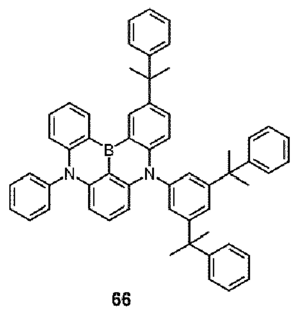

**66**

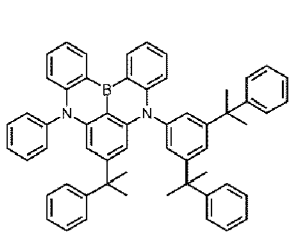

**67**

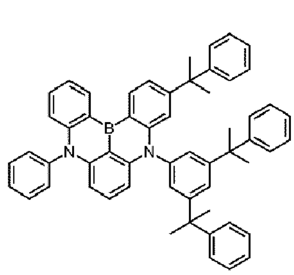

**68**

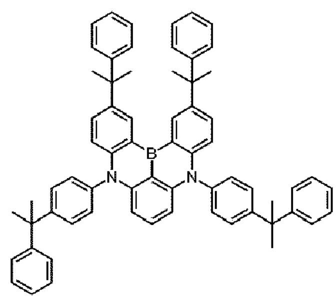

**69**

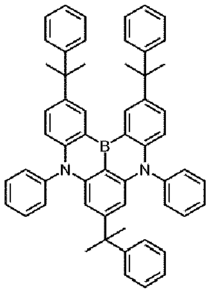

70

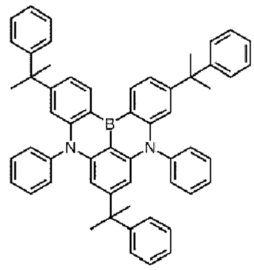

71

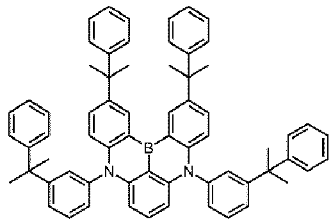

72

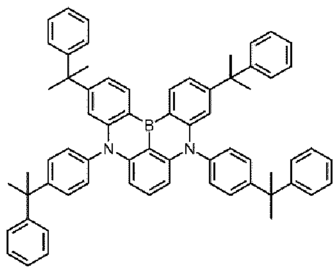

73

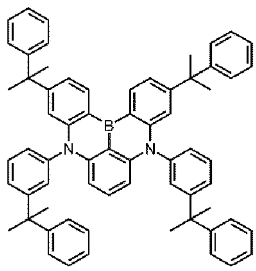

74

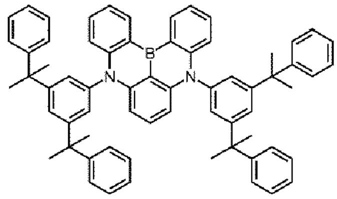

75

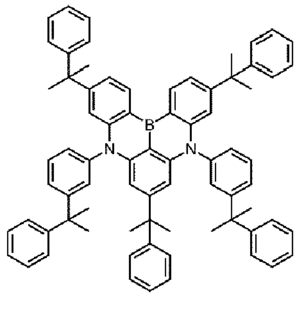

76

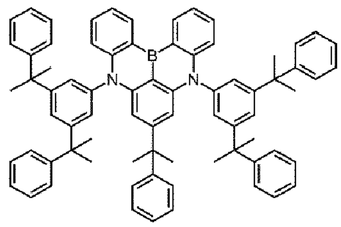

77

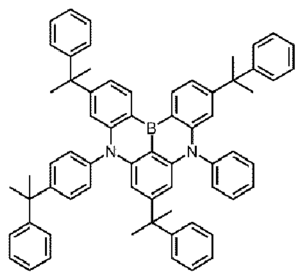

78

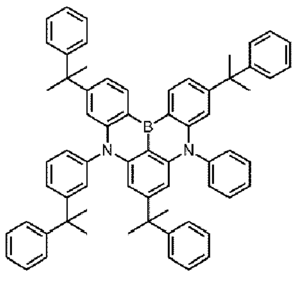

79

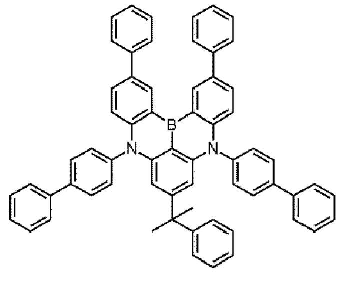

80

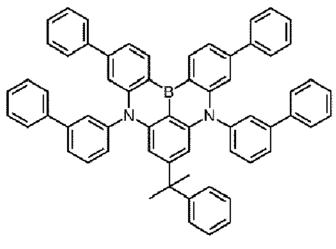

81

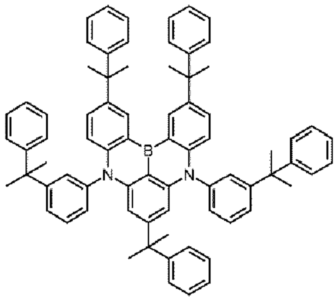
82

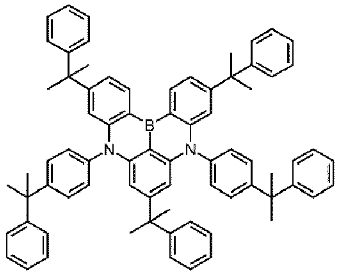
83

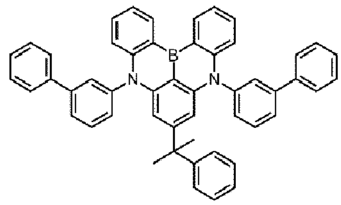
84

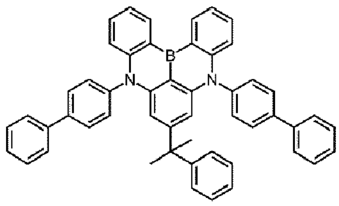
85

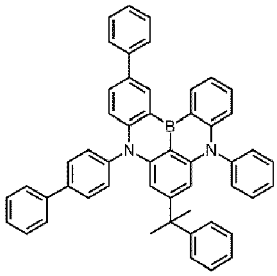
86

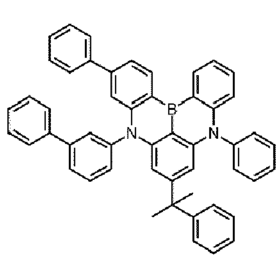
87

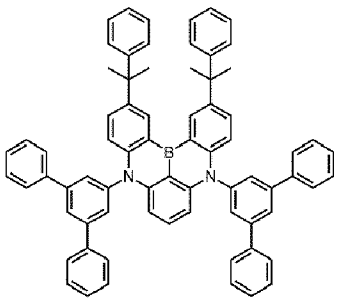
88

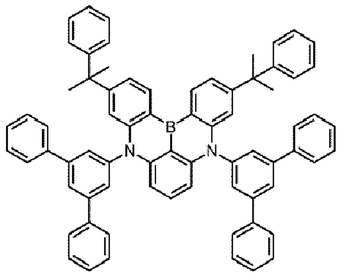
89

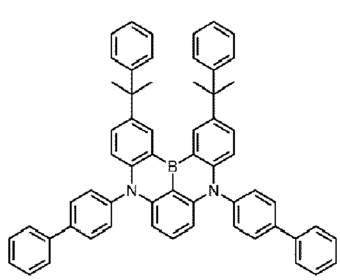
90

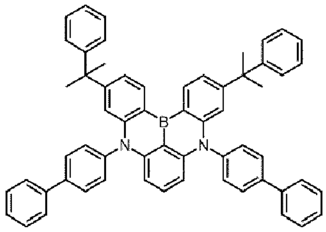
91

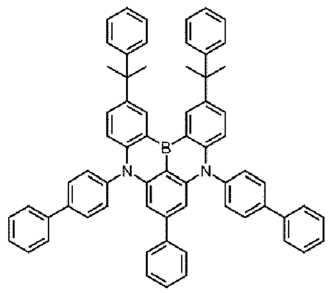
92

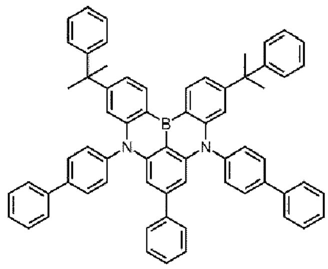
93

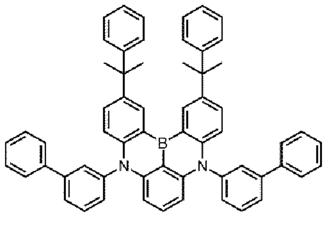

94

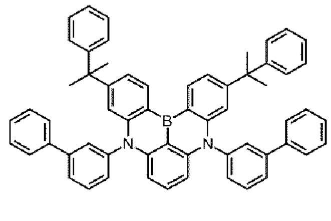

95

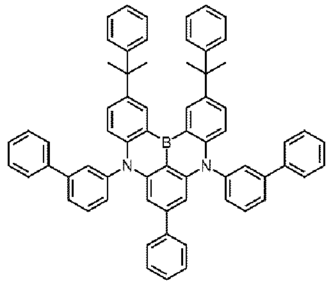

96

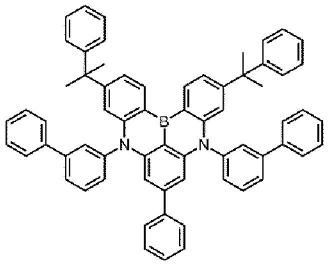

97

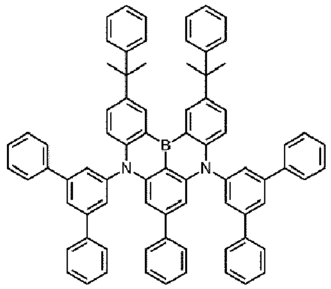

98

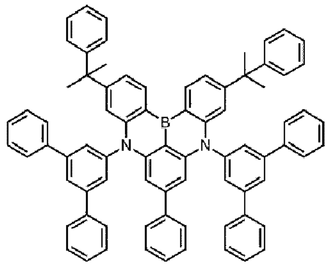

99

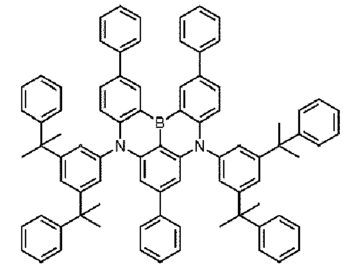

100

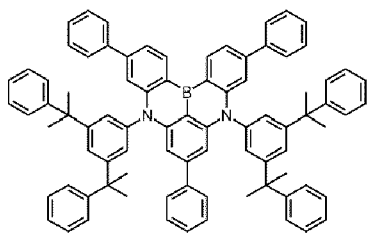

101

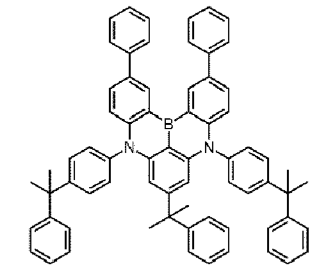

102

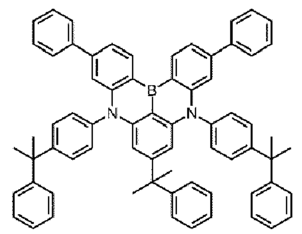

103

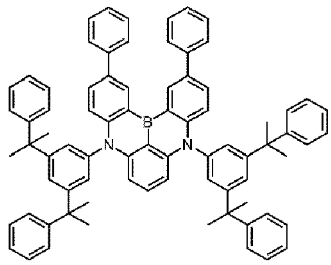

104

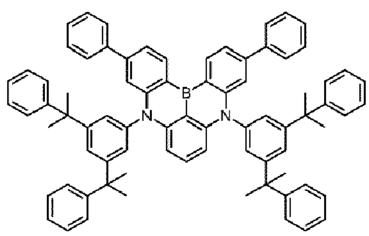

105

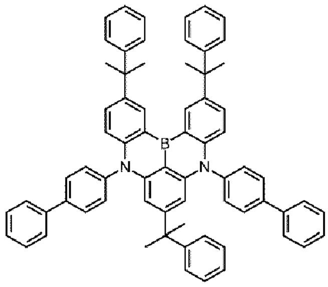

106

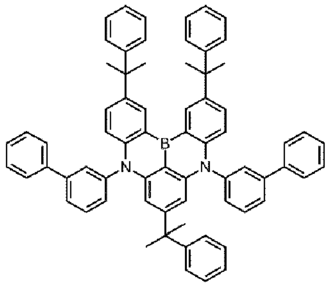

107

**14.** An organic light-emitting device comprising:

a first electrode;
a second electrode; and
an organic layer comprising an emission layer,
wherein the organic layer is located between the first electrode and the second electrode, and
wherein the organic layer comprises at least one polycyclic compound of any of claims 1-13.

**15.** The organic light-emitting device of claim 14, wherein the emission layer comprises the polycyclic compound; preferably wherein the emission layer further comprises:

a host; and
a sensitizer,
wherein the polycyclic compound is a light-emitting dopant, and
wherein an amount of the host in the emission layer is greater than a total combined amount of the light-emitting dopant and the sensitizer in the emission;
preferably wherein the host, the polycyclic compound, and the sensitizer each satisfy Equation 2:

Equation 2

$$[T_1(H) / S_1(H)] \geq [T_1(S) / S_1(S)] \geq [T_1(PC) / S_1(PC)]$$

wherein, in Equation 2,

$T_1(H)$ is a lowest excited triplet energy level of the host,
$S_1(H)$ is a lowest excited singlet energy level of the host;
$T_1(PC)$ is a lowest excited triplet energy level of the polycyclic compound;
$S_1(PC)$ is a lowest excited singlet energy level of the polycyclic compound;
$T_1(S)$ is a lowest excited triplet energy level of the sensitizer; and
$S_1(S)$ is a lowest excited singlet energy level of the sensitizer.

FIG. 1

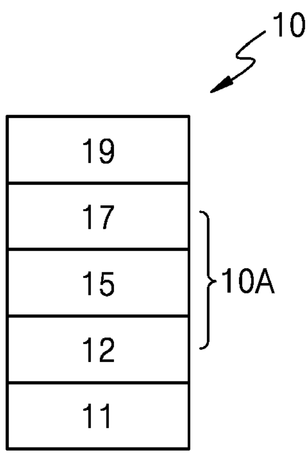

FIG. 2

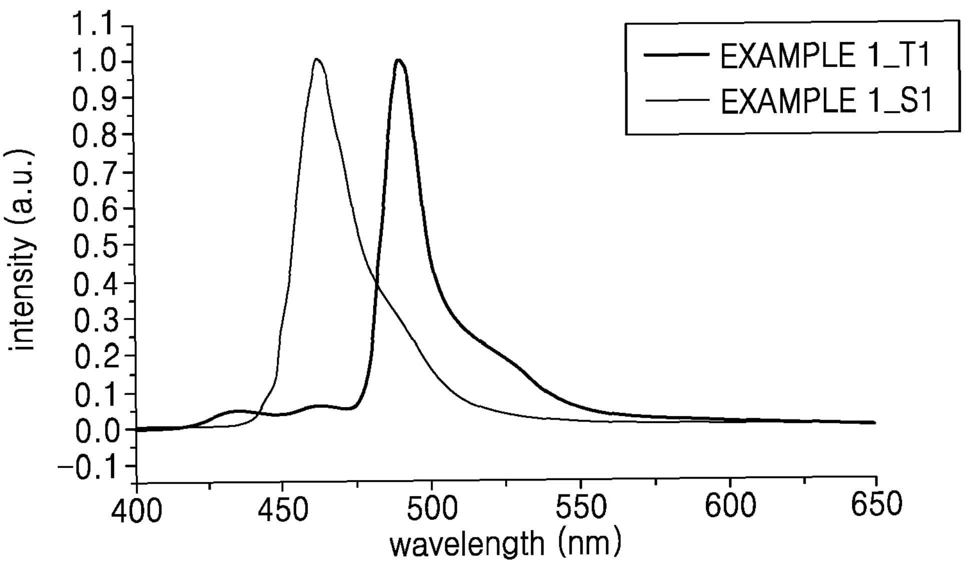
EXAMPLE 1_T1
EXAMPLE 1_S1
intensity (a.u.)
wavelength (nm)
1.1
1.0
0.9
0.8
0.7
0.6
0.5
0.4
0.3
0.2
0.1
0.0
−0.1
400
450
500
550
600
650

FIG. 3

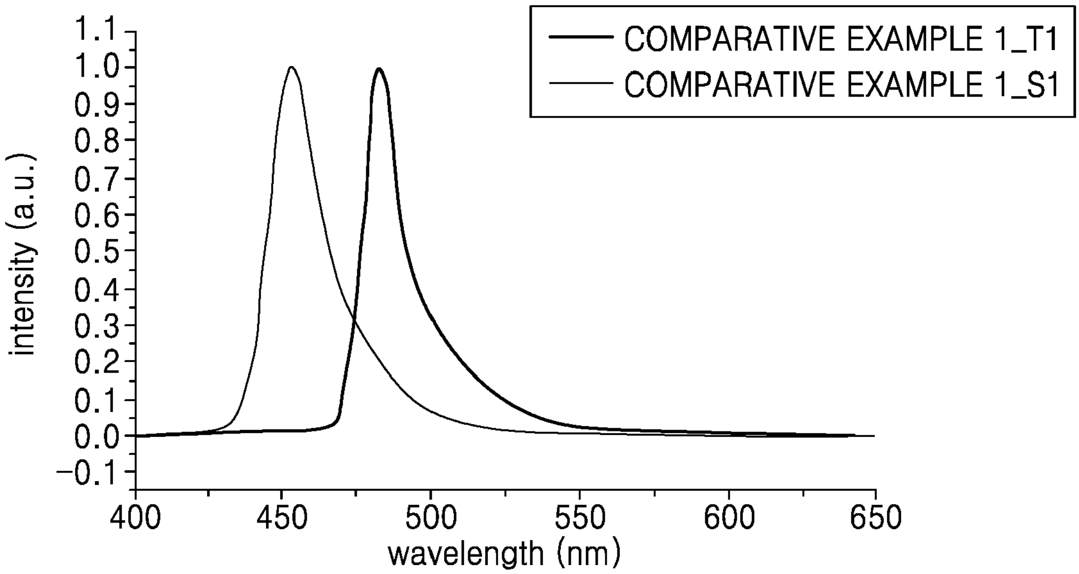
COMPARATIVE EXAMPLE 1_T1
COMPARATIVE EXAMPLE 1_S1
intensity (a.u.)
wavelength (nm)
1.1
1.0
0.9
0.8
0.7
0.6
0.5
0.4
0.3
0.2
0.1
0.0
−0.1
400
450
500
550
600
650

FIG. 4

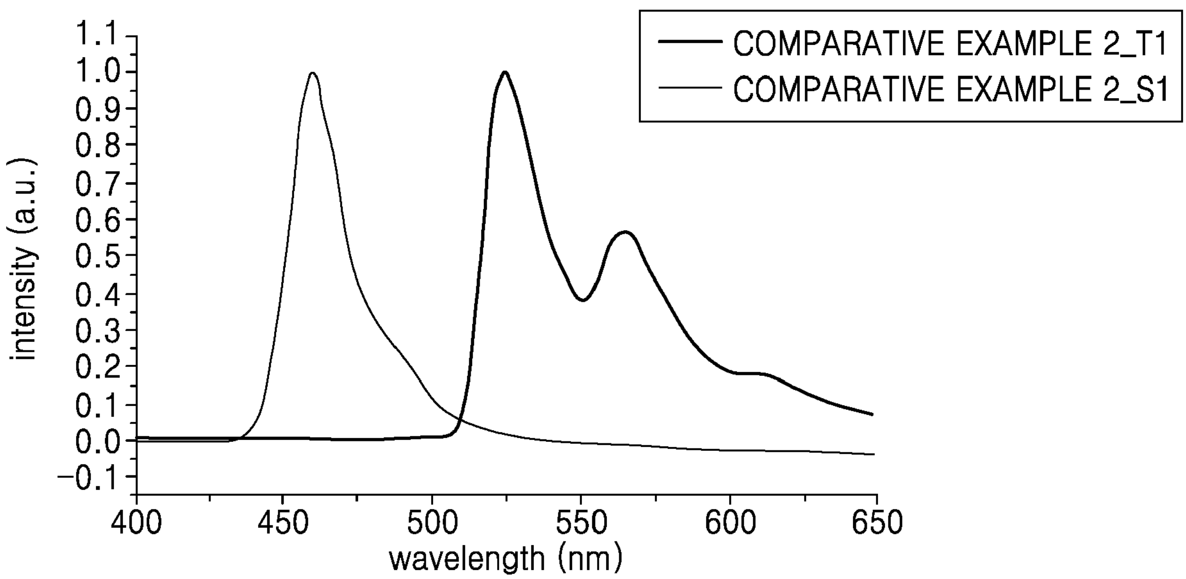
COMPARATIVE EXAMPLE 2_T1
COMPARATIVE EXAMPLE 2_S1
intensity (a.u.)
1.1
1.0
0.9
0.8
0.7
0.6
0.5
0.4
0.3
0.2
0.1
0.0
−0.1
400
450
500
550
600
650
wavelength (nm)

European Patent Office

# EUROPEAN SEARCH REPORT

Application Number
EP 21 19 5091

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | WO 2021/255073 A1 (CYNORA GMBH [DE]) 23 December 2021 (2021-12-23) * pages 64-70 * | 1,14 | INV. C07F5/02 C09K11/06 H01L51/00 |
| E | EP 3 876 296 A1 (SAMSUNG ELECTRONICS CO LTD [KR]) 8 September 2021 (2021-09-08) * page 24 compounds 211,212,215,216, page 23 compound 188, page 22 compound 149, page 21 compound 134 page 21 * | 1,14 | |
| X | EP 3 696 246 A1 (CYNORA GMBH [DE]) 19 August 2020 (2020-08-19) * example 1 page 19 * | 1-15 | |

TECHNICAL FIELDS SEARCHED (IPC)

C07F
H05B
C09K
H01L

1 The present search report has been drawn up for all claims

| Place of search | Date of completion of the search | Examiner |
|---|---|---|
| The Hague | 26 January 2022 | Bourghida, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 19 5091

This annex lists the patent family members relating to the patent documents cited in the above-mentioned European search report. The members are as contained in the European Patent Office EDP file on
The European Patent Office is in no way liable for these particulars which are merely given for the purpose of information.

26-01-2022

| Patent document cited in search report | Publication date | Patent family member(s) | Publication date |
|---|---|---|---|
| WO 2021255073 A1 | 23-12-2021 | NONE | |
| EP 3876296 A1 | 08-09-2021 | CN 113363398 A | 07-09-2021 |
| | | EP 3876296 A1 | 08-09-2021 |
| | | US 2021288259 A1 | 16-09-2021 |
| EP 3696246 A1 | 19-08-2020 | CN 111560030 A | 21-08-2020 |
| | | EP 3696246 A1 | 19-08-2020 |
| | | KR 20200099098 A | 21-08-2020 |
| | | US 2020259097 A1 | 13-08-2020 |

EPO FORM P0459

For more details about this annex : see Official Journal of the European Patent Office, No. 12/82